# EUROPEAN PATENT APPLICATION

(11) **EP 4 369 898 A1**
(43) Date of publication of application: **15.05.2024**
(21) Application number: 23205915.4
(22) Date of filing: 25.10.2023
(51) Int. Cl.: H10K 85/30, H10K 85/60, H10K 85/40

(54) **ORGANIC ELECTROLUMINESCENT MATERIALS AND DEVICES**

(30) Priority: 27.10.2022 US 202263419782 P; 02.11.2022 US 202263421804 P; 13.12.2022 US 202263387166 P; 21.12.2022 US 202263434161 P; 07.02.2023 US 202363483647 P; 14.02.2023 US 202363484757 P; 14.02.2023 US 202363484786 P; 27.02.2023 US 202363487055 P; 14.03.2023 US 202363490065 P; 13.04.2023 US 202363459091 P; 17.05.2023 US 202318319182; 20.10.2023 US 202318491013
(71) Applicant: Universal Display Corporation, Ewing, NJ 08618 (US)
(72) Inventor: FLEETHAM, Tyler, Ewing, 08618 (US); THOMPSON, Nicholas J., Ewing, 08618 (US); LIN, Chun, Ewing, 08618 (US); FELDMAN, Jerald, Ewing, 08618 (US)
(74) Representative: Maiwald GmbH

(57) **Abstract**

Provided is an organic light emitting device (OLED) comprising: an anode; a hole transporting layer; an emissive region; an electron transporting layer; and a cathode; wherein the emissive region comprises: a first compound; a second compound; and a third compound; wherein the first compound is a sensitizer that transfers energy to the second compound; wherein the second compound is an acceptor that is an emitter; wherein the third compound is a first host, and at least one of the first compound and the second compound is doped in the third compound; wherein at least two of the first, second, and the third compounds comprises same or different substituent R*; wherein R* is selected from the group consisting of: 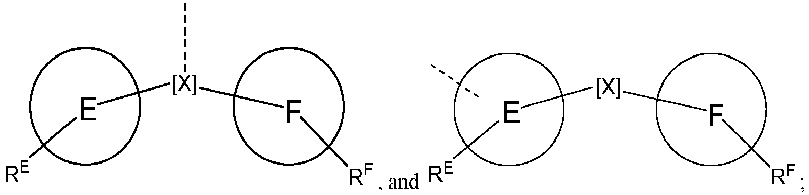 wherein [X], moieties E and F, R^{E}, and R^{F} are defined herein. Also provided are related formulations, related premixed coevaporation sources, related consumer products and related method of making those OLED devices.

## Description

### CROSS-REFERENCE TO RELATED APPLICATIONS

This application is a continuation-in-part of co-pending U.S. patent Application No. 18/319,182, filed May 17, 2023. This application also claims priority under 35 U.S.C. § 119(e) to U.S. Provisional Applications No. 63/419,782, filed on October 27, 2022, No. 63/421,804, filed November 2, 2022, No. 63/387,166, filed December 13, 2022, No. 63/483,647, filed February 7, 2023, No. 63/487,055, filed February 27, 2023, No. 63/459,091, filed April 13, 2023, No. 63/434,161, filed December 21, 2022, No. 63/484,757, filed February 14, 2023, No. 63/484,786, filed February 14, 2023, and No. 63/490,065, filed March 14, 2023, the entire contents of all the above referenced applications are incorporated herein by reference.

### FIELD

The present disclosure generally relates to novel formulations and OLED devices together with methods of making and using the OLED devices.

### BACKGROUND

Opto-electronic devices that make use of organic materials are becoming increasingly desirable for various reasons. Many of the materials used to make such devices are relatively inexpensive, so organic opto-electronic devices have the potential for cost advantages over inorganic devices. In addition, the inherent properties of organic materials, such as their flexibility, may make them well suited for particular applications such as fabrication on a flexible substrate. Examples of organic opto-electronic devices include organic light emitting diodes/devices (OLEDs), organic phototransistors, organic photovoltaic cells, organic scintillators, and organic photodetectors. For OLEDs, the organic materials may have performance advantages over conventional materials.

OLEDs make use of thin organic films that emit light when voltage is applied across the device. OLEDs are becoming an increasingly interesting technology for use in applications such as displays, illumination, and backlighting.

One application for emissive molecules is a full color display. Industry standards for such a display call for pixels adapted to emit particular colors, referred to as "saturated" colors. In particular, these standards call for saturated red, green, and blue pixels. Alternatively, the OLED can be designed to emit white light. In conventional liquid crystal displays emission from a white backlight is filtered using absorption filters to produce red, green and blue emission. The same technique can also be used with OLEDs. The white OLED can be either a single emissive layer (EML) device or a stack structure. Color may be measured using CIE coordinates, which are well known to the art.

### SUMMARY

In one aspect, the present disclosure provides an organic light emitting device (OLED) comprising: an anode; a hole transporting layer; an emissive region; an electron transporting layer; and a cathode; wherein the emissive region comprises: a first compound; a second compound; and a third compound; wherein the first compound is a sensitizer that transfers energy to the second compound; wherein the second compound is an acceptor that is an emitter; wherein the third compound is a first host, and at least one of the first compound and the second compound is doped in the third compound; wherein at least two of the first, second, and the third compounds comprises same or different substituent R*; wherein R* is selected from the group consisting of: 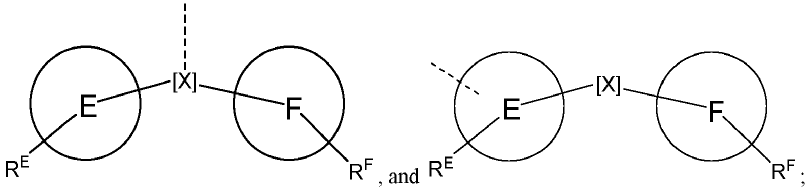 wherein
[X] is a chemical moiety comprises at least one six-membered carbocyclic, a silyl group, a germyl group, or heterocyclic ring;
moieties E and F are each independently a monocyclic ring, or a polycyclic fused ring system; wherein the monocyclic ring and each ring of the polycyclic fused ring system are independently a 5-membered or 6-membered carbocyclic or heterocyclic ring;
R^{E}, and R^{F} each independently represent mono to the maximum allowable substitution, or no substitution; wherein each R^{E}, and R^{F} is independently a hydrogen or a substituent selected from the group consisting of deuterium, halogen, alkyl, cycloalkyl, heteroalkyl, heterocycloalkyl, boryl, arylalkyl, alkoxy, aryloxy, amino, silyl, germyl, alkenyl, cycloalkenyl, heteroalkenyl, alkynyl, aryl, heteroaryl, acyl, carboxylic acid, ether, ester, nitrile, isonitrile, sulfanyl, sulfinyl, sulfonyl, phosphino, selenyl, and combinations thereof;
any adjacent substituents are optionally joined or fused into a ring.

In another aspect, the present disclosure also provides a formulation comprising: a first compound; a second compound; and a third compound; wherein the first compound is a sensitizer that transfers energy to the second compound in an OLED at room temperature; wherein the second compound is an acceptor that is an emitter in said OLED at room temperature; wherein the third compound is a first host in said OLED at room temperature; wherein at least two of the first, second, and the third compounds comprises same or different substituent R*;
wherein R* is selected from the group consisting of: 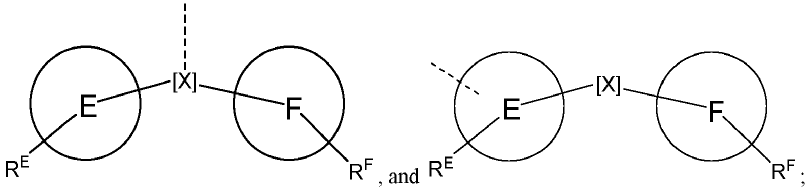
wherein
[X] is a chemical moiety comprises at least one six-membered carbocyclic, a silyl group, a germyl group, or heterocyclic ring;
moieties E and F are each independently a monocyclic ring, or a polycyclic fused ring system; wherein the monocyclic ring and each ring of the polycyclic fused ring system are independently a 5-membered or 6-membered carbocyclic or heterocyclic ring;
R^{E}, and R^{F} each independently represent mono to the maximum allowable substitution, or no substitution;
wherein each R^{E}, and R^{F} is independently a hydrogen, or a substituent selected from the group consisting of the general substituents as defined herein;
any adjacent substituents are optionally joined or fused into a ring; and
wherein the formulation comprises at least two of the first, the second, and the third compounds.

In yet another aspect, the present disclosure further provides a chemical structure/assembly selected from the group consisting of a monomer, a polymer, a macromolecule, and a supramolecule, wherein the chemical structure/assembly comprises at least two of the following components:
a first compound, a monovalent or polyvalent variant thereof;
a second compound, a monovalent or polyvalent variant thereof; and
a third compound, a monovalent or polyvalent variant thereof;
wherein the first compound is a sensitizer that transfers energy to the second compound in an OLED at room temperature;
wherein the second compound is an acceptor that is an emitter in said OLED at room temperature;
wherein the third compound is a first host in said OLED at room temperature.

In yet another aspect, the present disclosure also provides a premixed co-evaporation source that is a mixture of a first compound and a second compound;
wherein the co-evaporation source is a co-evaporation source for vacuum deposition process or OVJP process;
wherein the first compound and the second compound are differently selected from the group consisting of:
   (1) a compound being a sensitizer that transfers energy to an acceptor that is an emitter in an OLED at room temperature;
   (2) a compound being an acceptor that is the emitter in said OLED at room temperature;
   (3) a compound being a host in said OLED at room temperature;
wherein the first compound has an evaporation temperature T1 of 150 to 350 °C;
wherein the second compound has an evaporation temperature T2 of 150 to 350 °C;
wherein absolute value of T 1-T2 is less than 20 °C;
wherein the first compound has a concentration C1 in said mixture and a concentration C2 in a film formed by evaporating the mixture in a vacuum deposition tool at a constant pressure between 1×10⁻⁶ Torr to 1×10⁻⁹ Torr, at a 2Å/sec deposition rate on a surface positioned at a predefined distance away from the mixture being evaporated; and
wherein absolute value of (C1-C2)/C1 is less than 5%.

In yet another aspect, the present disclosure further provides a method for fabricating an organic light emitting device, the method comprising:
providing a substrate having a first electrode disposed thereon;
depositing a first organic layer over the first electrode by evaporating a pre-mixed co-evaporation source that is a mixture of a first compound and a second compound in a high vacuum deposition tool with a chamber base pressure between 1×10⁻⁶ Torr to 1×10⁻⁹ Torr; and
depositing a second electrode over the first organic layer,
wherein the first compound and the second compound are differently selected from the group consisting of:
   (1) a compound being a sensitizer that transfers energy to an acceptor that is an emitter in an OLED at room temperature;
   (2) a compound being an acceptor that is the emitter in said OLED at room temperature;
   (3) a compound being a host in said OLED at room temperature;
wherein the first compound has an evaporation temperature T1 of 150 to 350 °C;
wherein the second compound has an evaporation temperature T2 of 150 to 350 °C;
wherein absolute value of T 1-T2 is less than 20 °C;
wherein the first compound has a concentration C1 in said mixture and a concentration C2 in a film formed by evaporating the mixture in a vacuum deposition tool at a constant pressure between 1×10⁻⁶ Torr to 1×10⁻⁹ Torr, at a 2Å/sec deposition rate on a surface positioned at a predefined distance away from the mixture being evaporated; and
wherein absolute value of (C1-C2)/C1 is less than 5%.

### BRIEF DESCRIPTION OF THE DRAWINGS

FIG. 1 shows an organic light emitting device.
FIG. 2 shows an inverted organic light emitting device that does not have a separate electron transport layer.
FIG. 3 shows a graph of modeled P-polarized photoluminescence as a function of angle for emitters with different vertical dipole ratio (VDR) values.

### DETAILED DESCRIPTION

### A. Terminology

Unless otherwise specified, the below terms used herein are defined as follows:

As used herein, "top" means furthest away from the substrate, while "bottom" means closest to the substrate. Where a first layer is described as "disposed over" a second layer, the first layer is disposed further away from substrate. There may be other layers between the first and second layer, unless it is specified that the first layer is "in contact with" the second layer. For example, a cathode may be described as "disposed over" an anode, even though there are various organic layers in between.

As used herein, "solution processable" means capable of being dissolved, dispersed, or transported in and/or deposited from a liquid medium, either in solution or suspension form.

As used herein, and as would be generally understood by one skilled in the art, a first "Highest Occupied Molecular Orbital" (HOMO) or "Lowest Unoccupied Molecular Orbital" (LUMO) energy level is "greater than" or "higher than" a second HOMO or LUMO energy level if the first energy level is closer to the vacuum energy level. Since ionization potentials (IP) are measured as a negative energy relative to a vacuum level, a higher HOMO energy level corresponds to an IP having a smaller absolute value (an IP that is less negative). Similarly, a higher LUMO energy level corresponds to an electron affinity (EA) having a smaller absolute value (an EA that is less negative). On a conventional energy level diagram, with the vacuum level at the top, the LUMO energy level of a material is higher than the HOMO energy level of the same material. A "higher" HOMO or LUMO energy level appears closer to the top of such a diagram than a "lower" HOMO or LUMO energy level.

As used herein, and as would be generally understood by one skilled in the art, a first work function is "greater than" or "higher than" a second work function if the first work function has a higher absolute value. Because work functions are generally measured as negative numbers relative to vacuum level, this means that a "higher" work function is more negative. On a conventional energy level diagram, with the vacuum level at the top, a "higher" work function is illustrated as further away from the vacuum level in the downward direction. Thus, the definitions of HOMO and LUMO energy levels follow a different convention than work functions.

The terms "halo," "halogen," and "halide" are used interchangeably and refer to fluorine, chlorine, bromine, and iodine.

The term "acyl" refers to a substituted carbonyl group (-C(O)-Rₛ).

The term "ester" refers to a substituted oxycarbonyl (-O-C(O)-Rₛ or -C(O)-O-Rₛ) group.

The term "ether" refers to an -ORₛ group.

The terms "sulfanyl" or "thio-ether" are used interchangeably and refer to a -SRₛ group.

The term "selenyl" refers to a -SeRₛ group.

The term "sulfinyl" refers to a -S(O)-Rₛ group.

The term "sulfonyl" refers to a -SO₂-Rₛ group.

The term "phosphino" refers to a group containing at least one phosphorus atom used to be bonded to the relevant molecule, common examples, but not limited to, such as a -P(Rₛ)₂ group or a -PO(Rₛ)₂ group, wherein each Rₛ can be same or different.

The term "silyl" refers to a group containing at least one silicon atom used to be bonded to the relevant molecule, common examples such as, but not limited to, a -Si(Rₛ)₃ group, wherein each Rₛ can be same or different.

The term "germyl" refers to a group containing at least one germanium atom used to be bonded to the relevant molecule, common examples such as, but not limited to, a -Ge(Rₛ)₃ group, wherein each Rₛ can be same or different.

The term "boryl" refers to a group containing at least one boron atom used to be bonded to the relevant molecule, common examples such as, but not limited to, a -B(Rₛ)₂ group or its Lewis adduct -B(Rₛ)₃ group, wherein Rₛ can be same or different.

In each of the above, Rₛ can be hydrogen, or the general substituents as defined in this application. Preferred Rₛ is selected from the group consisting of deuterium, halogen, alkyl, cycloalkyl, heteroalkyl, heterocycloalkyl, arylalkyl, alkoxy, aryloxy, amino, silyl, alkenyl, cycloalkenyl, heteroalkenyl, alkynyl, aryl, heteroaryl, and combination thereof. More preferably Rₛ is selected from the group consisting of alkyl, cycloalkyl, aryl, heteroaryl, and combination thereof.

The term "alkyl" refers to and includes both straight and branched chain alkyl groups. Preferred alkyl groups are those containing from one to fifteen carbon atoms, preferably one to nine carbon atoms, and includes methyl, ethyl, propyl, 1-methylethyl, butyl, 1-methylpropyl, 2-methylpropyl, pentyl, 1-methylbutyl, 2-methylbutyl, 3-methylbutyl, 1,1-dimethylpropyl, 1,2-dimethylpropyl, 2,2-dimethylpropyl, and the like. Additionally, the alkyl group can be further substituted.

The term "cycloalkyl" refers to and includes monocyclic, polycyclic, and spiro alkyl groups. Preferred cycloalkyl groups are those containing 3 to 12 ring carbon atoms and includes cyclopropyl, cyclopentyl, cyclohexyl, bicyclo[3.1.1]heptyl, spiro[4.5]decyl, spiro[5.5]undecyl, adamantyl, and the like. Additionally, the cycloalkyl group can be further substituted.

The terms "heteroalkyl" or "heterocycloalkyl" refer to an alkyl or a cycloalkyl group, respectively, having at least one carbon atom replaced by a heteroatom. Optionally the at least one heteroatom is selected from O, S, N, P, B, Si, Ge and Se, preferably, O, S or N. Additionally, the heteroalkyl or heterocycloalkyl group can be further substituted.

The term "alkenyl" refers to and includes both straight and branched chain alkene groups. Alkenyl groups are essentially alkyl groups that include at least one carbon-carbon double bond in the alkyl chain. Cycloalkenyl groups are essentially cycloalkyl groups that include at least one carbon-carbon double bond in the cycloalkyl ring. The term "heteroalkenyl" as used herein refers to an alkenyl group having at least one carbon atom replaced by a heteroatom. Optionally the at least one heteroatom is selected from O, S, N, P, B, Si, Ge, and Se, preferably, O, S, or N. Preferred alkenyl, cycloalkenyl, or heteroalkenyl groups are those containing two to fifteen carbon atoms. Additionally, the alkenyl, cycloalkenyl, or heteroalkenyl group can be further substituted.

The term "alkynyl" refers to and includes both straight and branched chain alkyne groups. Alkynyl groups are essentially alkyl groups that include at least one carbon-carbon triple bond in the alkyl chain. Preferred alkynyl groups are those containing two to fifteen carbon atoms. Additionally, the alkynyl group can be further substituted.

The terms "aralkyl" or "arylalkyl" are used interchangeably and refer to an alkyl group that is substituted with an aryl group. Additionally, the aralkyl group can be further substituted.

The term "heterocyclic group" refers to and includes aromatic and non-aromatic cyclic groups containing at least one heteroatom. Optionally the at least one heteroatom is selected from O, S, Se, N, P, B, Si, Ge, and Se, preferably, O, S, N, or B. Hetero-aromatic cyclic groups may be used interchangeably with heteroaryl. Preferred hetero-non-aromatic cyclic groups are those containing 3 to 10 ring atoms, preferably those containing 3 to 7 ring atoms, which includes at least one hetero atom, and includes cyclic amines such as morpholino, piperidino, pyrrolidino, and the like, and cyclic ethers/thio-ethers, such as tetrahydrofuran, tetrahydropyran, tetrahydrothiophene, and the like. Additionally, the heterocyclic group can be further substituted or fused.

The term "aryl" refers to and includes both single-ring and polycyclic aromatic hydrocarbyl groups. The polycyclic rings may have two or more rings in which two carbons are common to two adjoining rings (the rings are "fused"). Preferred aryl groups are those containing six to thirty carbon atoms, preferably six to twenty-four carbon atoms, six to eighteen carbon atoms, and more preferably six to twelve carbon atoms. Especially preferred is an aryl group having six carbons, ten carbons, twelve carbons, fourteen carbons, or eighteen carbons. Suitable aryl groups include phenyl, biphenyl, triphenyl, triphenylene, tetraphenylene, naphthalene, anthracene, phenalene, phenanthrene, pyrene, chrysene, perylene, and azulene, preferably phenyl, biphenyl, triphenyl, triphenylene, and naphthalene. Additionally, the aryl group can be further substituted or fused such as, but not limited to, fluorene.

The term "heteroaryl" refers to and includes both single-ring aromatic groups and polycyclic aromatic ring systems that include at least one heteroatom. The heteroatoms include, but are not limited to O, S, Se, N, P, B, Si, Ge, and Se. In many instances, O, S, N, or B are the preferred heteroatoms. Hetero-single ring aromatic systems are preferably single rings with 5 or 6 ring atoms, and the ring can have from one to six heteroatoms. The hetero-polycyclic ring systems can have two or more aromatic rings in which two atoms are common to two adjoining rings (the rings are "fused") wherein at least one of the rings is a heteroaryl. The hetero-polycyclic aromatic ring systems can have from one to six heteroatoms per ring of the polycyclic aromatic ring system. Preferred heteroaryl groups are those containing three to thirty carbon atoms, preferably three to twenty-four carbon atoms, three to eighteen carbon atoms, and more preferably three to twelve carbon atoms. Suitable heteroaryl groups include dibenzothiophene, dibenzofuran, dibenzoselenophene, furan, thiophene, benzofuran, benzothiophene, benzoselenophene, carbazole, indolocarbazole, pyridylindole, pyrrolodipyridine, pyrazole, imidazole, triazole, oxazole, thiazole, oxadiazole, oxatriazole, dioxazole, thiadiazole, pyridine, pyridazine, pyrimidine, pyrazine, triazine, oxazine, oxathiazine, oxadiazine, indole, benzimidazole, indazole, indoxazine, benzoxazole, benzisoxazole, benzothiazole, quinoline, isoquinoline, cinnoline, quinazoline, quinoxaline, naphthyridine, phthalazine, pteridine, xanthene, acridine, phenazine, phenothiazine, phenoxazine, benzofuropyridine, furodipyridine, benzothienopyridine, thienodipyridine, benzoselenophenopyridine, and selenophenodipyridine, preferably dibenzothiophene, dibenzofuran, dibenzoselenophene, carbazole, indolocarbazole, imidazole, pyridine, triazine, benzimidazole, 1,2-azaborine, 1,3-azaborine, 1,4-azaborine, borazine, and aza-analogs thereof. Additionally, the heteroaryl group can be further substituted or fused.

Of the aryl and heteroaryl groups listed above, the groups of triphenylene, naphthalene, anthracene, dibenzothiophene, dibenzofuran, dibenzoselenophene, carbazole, indolocarbazole, imidazole, pyridine, pyrazine, pyrimidine, triazine, and benzimidazole, and the respective aza-analogs of each thereof are of particular interest.

In many instances, the general substituents are selected from the group consisting of deuterium, halogen, alkyl, cycloalkyl, heteroalkyl, heterocycloalkyl, arylalkyl, alkoxy, aryloxy, amino, silyl, germyl, boryl, alkenyl, cycloalkenyl, heteroalkenyl, alkynyl, aryl, heteroaryl, acyl, carboxylic acid, ether, ester, nitrile, isonitrile, sulfanyl, selenyl, sulfinyl, sulfonyl, phosphino, and combinations thereof.

In some instances, the preferred general substituents are selected from the group consisting of deuterium, fluorine, alkyl, cycloalkyl, heteroalkyl, alkoxy, aryloxy, amino, silyl, germyl, boryl, alkenyl, cycloalkenyl, heteroalkenyl, aryl, heteroaryl, nitrile, isonitrile, sulfanyl, and combinations thereof.

In some instances, the more preferred general substituents are selected from the group consisting of deuterium, fluorine, alkyl, cycloalkyl, alkoxy, aryloxy, amino, silyl, aryl, heteroaryl, nitrile, sulfanyl, and combinations thereof.

In some instances, the more preferred general substituents are selected from the group consisting of deuterium, fluorine, alkyl, cycloalkyl, silyl, aryl, heteroaryl, nitrile, and combinations thereof.

In yet other instances, the most preferred general substituents are selected from the group consisting of deuterium, alkyl, cycloalkyl, aryl, heteroaryl, and combinations thereof.

The terms "substituted", and "substitution" refer to a substituent other than H that is bonded to the relevant position, e.g., a carbon or nitrogen. For example, when R¹ represents mono-substitution, then one R¹ must be other than H (i.e., a substitution). Similarly, when R¹ represents di-substitution, then two of R¹ must be other than H. Similarly, when R¹ represents zero or no substitution, R¹, for example, can be a hydrogen for available valencies of ring atoms, as in carbon atoms for benzene and the nitrogen atom in pyrrole, or simply represents nothing for ring atoms with fully filled valencies, e.g., the nitrogen atom in pyridine. The maximum number of substitutions possible in a ring structure will depend on the total number of available valencies in the ring atoms.

As used herein, "combinations thereof' indicates that one or more members of the applicable list are combined to form a known or chemically stable arrangement that one of ordinary skill in the art can envision from the applicable list. For example, an alkyl and deuterium can be combined to form a partial or fully deuterated alkyl group; a halogen and alkyl can be combined to form a halogenated alkyl substituent; and a halogen, alkyl, and aryl can be combined to form a halogenated arylalkyl. In one instance, the term substitution includes a combination of two to four of the listed groups. In another instance, the term substitution includes a combination of two to three groups. In yet another instance, the term substitution includes a combination of two groups. Preferred combinations of substituent groups are those that contain up to fifty atoms that are not hydrogen or deuterium, or those which include up to forty atoms that are not hydrogen or deuterium, or those that include up to thirty atoms that are not hydrogen or deuterium. In many instances, a preferred combination of substituent groups will include up to twenty atoms that are not hydrogen or deuterium.

The "aza" designation in the fragments described herein, i.e., aza-dibenzofuran, aza-dibenzothiophene, etc. means that one or more of the C-H groups in the respective aromatic ring can be replaced by a nitrogen atom, for example, but not limited to, azatriphenylene encompasses both dibenzo[*f,h*]quinoxaline and dibenzo[*f,h*]quinoline. One of ordinary skill in the art can readily envision other nitrogen analogs of the aza-derivatives described above, and all such analogs are intended to be encompassed by the terms as set forth herein.

As used herein, "deuterium" refers to an isotope of hydrogen. Deuterated compounds can be readily prepared using methods known in the art. For example, U.S. Pat. No. 8,557,400, Patent Pub. No. WO 2006/095951, and U.S. Pat. Application Pub. No. US 2011/0037057, which are hereby incorporated by reference in their entireties, describe the making of deuterium-substituted organometallic complexes. Further reference is made to Ming Yan, et al., Tetrahedron 2015, 71, 1425-30 and Atzrodt et al., Angew. Chem. Int. Ed. (Reviews) 2007, 46, 7744-65, which are incorporated by reference in their entireties, describe the deuteration of the methylene hydrogens in benzyl amines and efficient pathways to replace aromatic ring hydrogens with deuterium, respectively.

As used herein, any specifically listed substituent such as, but not limited to, methyl, phenyl, pyridyl, etc. includes undeuterated, partially deuterated, and fully deuterated versions thereof. Similarly, classes of substituents such as, but not limited to, alkyl, aryl, cycloalkyl, heteroaryl, etc. also include undeuterated, partially deuterated, and fully deuterated versions thereof. A chemical structure without further specified H or D should be considered to include undeuterated, partially deuterated, and fully deuterated versions thereof. Some common smallest partially or fully deuterated group such as, but not limited to, CD₃, CD₂C(CH₃)₃, C(CD₃)₃, and C₆D₅.

It is to be understood that when a molecular fragment is described as being a substituent or otherwise attached to another moiety, its name may be written as if it were a fragment (e.g., phenyl, phenylene, naphthyl, dibenzofuryl) or as if it were the whole molecule (e.g., benzene, naphthalene, dibenzofuran). As used herein, these different ways of designating a substituent or attached fragment are considered to be equivalent.

In some instances, a pair of substituents in the molecule can be optionally joined or fused into a ring. The preferred ring is a five to nine-membered carbocyclic or heterocyclic ring, includes both instances where the portion of the ring formed by the pair of substituents is saturated and where the portion of the ring formed by the pair of substituents is unsaturated. In yet other instances, a pair of adjacent substituents can be optionally joined or fused into a ring. As used herein, "adjacent" means that the two substituents involved can be on the same ring next to each other, or on two neighboring rings having the two closest available substitutable positions, such as 2, 2' positions in a biphenyl, or 1, 8 position in a naphthalene.

Layers, materials, regions, and devices may be described herein in reference to the color of light they emit. In general, as used herein, an emissive region that is described as producing a specific color of light may include one or more emissive layers disposed over each other in a stack.

As used herein, a "red" layer, material, region, or device refers to one that emits light in the range of about 580-700nm or having a highest peak in its emission spectrum in that region. Similarly, a "green" layer, material, region, or device refers to one that emits or has an emission spectrum with a peak wavelength in the range of about 500-600nm; a "blue" layer, material, or device refers to one that emits or has an emission spectrum with a peak wavelength in the range of about 400-500nm; and a "yellow" layer, material, region, or device refers to one that has an emission spectrum with a peak wavelength in the range of about 540-600nm. In some arrangements, separate regions, layers, materials, regions, or devices may provide separate "deep blue" and a "light blue" light. As used herein, in arrangements that provide separate "light blue" and "deep blue", the "deep blue" component refers to one having a peak emission wavelength that is at least about 4nm less than the peak emission wavelength of the "light blue" component. Typically, a "light blue" component has a peak emission wavelength in the range of about 465-500nm, and a "deep blue" component has a peak emission wavelength in the range of about 400-470nm, though these ranges may vary for some configurations. Similarly, a color altering layer refers to a layer that converts or modifies another color of light to light having a wavelength as specified for that color. For example, a "red" color filter refers to a filter that results in light having a wavelength in the range of about 580-700nm. In general, there are two classes of color altering layers: color filters that modify a spectrum by removing unwanted wavelengths of light, and color changing layers that convert photons of higher energy to lower energy. A component "of a color" refers to a component that, when activated or used, produces or otherwise emits light having a particular color as previously described. For example, a "first emissive region of a first color" and a "second emissive region of a second color different than the first color" describes two emissive regions that, when activated within a device, emit two different colors as previously described.

As used herein, emissive materials, layers, and regions may be distinguished from one another and from other structures based upon light initially generated by the material, layer or region, as opposed to light eventually emitted by the same or a different structure. The initial light generation typically is the result of an energy level change resulting in emission of a photon. For example, an organic emissive material may initially generate blue light, which may be converted by a color filter, quantum dot or other structure to red or green light, such that a complete emissive stack or sub-pixel emits the red or green light. In this case the initial emissive material or layer may be referred to as a "blue" component, even though the sub-pixel is a "red" or "green" component.

In some cases, it may be preferable to describe the color of a component such as an emissive region, sub-pixel, color altering layer, or the like, in terms of 1931 CIE coordinates. For example, a yellow emissive material may have multiple peak emission wavelengths, one in or near an edge of the "green" region, and one within or near an edge of the "red" region as previously described. Accordingly, as used herein, each color term also corresponds to a shape in the 1931 CIE coordinate color space. The shape in 1931 CIE color space is constructed by following the locus between two color points and any additional interior points. For example, interior shape parameters for red, green, blue, and yellow may be defined as shown below:

| Color | CIE Shape Parameters |
|---|---|
| Central Red | Locus: [0.6270,0.3725];[0.7347,0.2653]; |
| | Interior: [0.5086,0.2657] |
| Central Green | Locus: [0.0326,0.3530];[0.3731,0.6245]; |
| | Interior: [0.2268,0.3321 |
| Central Blue | Locus: [0.1746,0.0052];[0.0326,0.3530]; |
| | Interior: [0.2268,0.3321] |
| Central Yellow | Locus: [0.373 1,0.6245];[0.6270,0.3725]; |
| | Interior: [0.3 700,0.4087];[0.2886,0.4572] |

More details on OLEDs, and the definitions described above, can be found in US Pat. No. 7,279,704, which is incorporated herein by reference in its entirety.

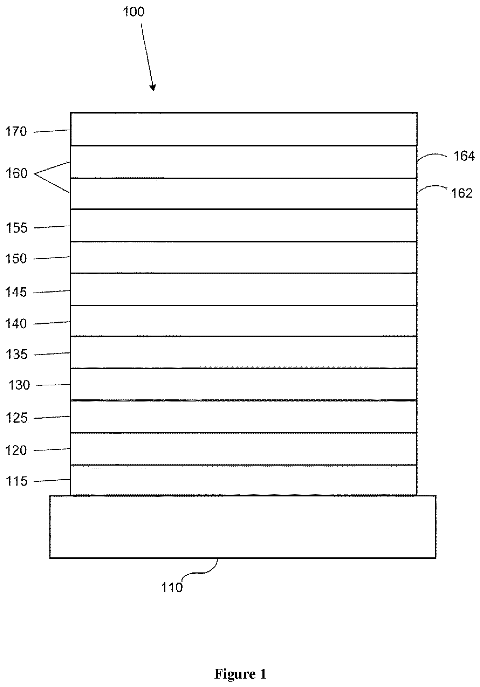

As disclosed herein, emissive layers or materials, such as emissive layer 135 and emissive layer 220 shown in FIGS. 1-2, respectively, may include quantum dots. An "emissive layer" or "emissive material" as disclosed herein may include an organic emissive material and/or an emissive material that contains quantum dots or equivalent structures, unless indicated to the contrary explicitly or by context according to the understanding of one of skill in the art. In general, an emissive layer includes emissive material within a host matrix. Such an emissive layer may include only a quantum dot material which converts light emitted by a separate emissive material or other emitter, or it may also include the separate emissive material or other emitter, or it may emit light itself directly from the application of an electric current. Similarly, a color altering layer, color filter, upconversion, or downconversion layer or structure may include a material containing quantum dots, though such layer may not be considered an "emissive layer" as disclosed herein. In general, an "emissive layer" or material is one that emits an initial light based on an injected electrical charge, where the initial light may be altered by another layer such as a color filter or other color altering layer that does not itself emit an initial light within the device, but may re-emit altered light of a different spectra content based upon absorption of the initial light emitted by the emissive layer and downconversion to a lower energy light emission. In some embodiments disclosed herein, the color altering layer, color filter, upconversion, and/or downconversion layer may be disposed outside of an OLED device, such as above or below an electrode of the OLED device.

Unless otherwise specified, any of the layers of the various embodiments may be deposited by any suitable method. For the organic layers, preferred methods include thermal evaporation, ink-jet, such as described in U.S. Pat. Nos. 6,013,982 and 6,087,196, which are incorporated by reference in their entireties, organic vapor phase deposition (OVPD), such as described in U.S. Pat. No. 6,337,102 to Forrest et al., which is incorporated by reference in its entirety, and deposition by organic vapor jet printing (OVJP, also referred to as organic vapor jet deposition (OVJD)), such as described in U.S. Pat. No. 7,431,968, which is incorporated by reference in its entirety. Other suitable deposition methods include spin coating and other solution based processes. Solution based processes are preferably carried out in nitrogen or an inert atmosphere. For the other layers, preferred methods include thermal evaporation. Preferred patterning methods include deposition through a mask, cold welding such as described in U.S. Pat. Nos. 6,294,398 and 6,468,819, which are incorporated by reference in their entireties, and patterning associated with some of the deposition methods such as ink-jet and OVJD. Other methods may also be used. The materials to be deposited may be modified to make them compatible with a particular deposition method. For example, substituents such as alkyl and aryl groups, branched or unbranched, and preferably containing at least 3 carbons, may be used in small molecules to enhance their ability to undergo solution processing. Substituents having 20 carbons or more may be used, and 3-20 carbons is a preferred range. Materials with asymmetric structures may have better solution processibility than those having symmetric structures, because asymmetric materials may have a lower tendency to recrystallize. Dendrimer substituents may be used to enhance the ability of small molecules to undergo solution processing.

Devices fabricated in accordance with embodiments of the present disclosure may further optionally comprise a barrier layer. One purpose of the barrier layer is to protect the electrodes and organic layers from damaging exposure to harmful species in the environment including moisture, vapor and/or gases, etc. The barrier layer may be deposited over, under or next to a substrate, an electrode, or over any other parts of a device including an edge. The barrier layer may comprise a single layer, or multiple layers. The barrier layer may be formed by various known chemical vapor deposition techniques and may include compositions having a single phase as well as compositions having multiple phases. Any suitable material or combination of materials may be used for the barrier layer. The barrier layer may incorporate an inorganic or an organic compound or both. The preferred barrier layer comprises a mixture of a polymeric material and a non-polymeric material as described in U.S. Pat. No. 7,968,146, PCT Pat. Application Nos. PCT/US2007/023098 and PCT/US2009/042829, which are herein incorporated by reference in their entireties. To be considered a "mixture", the aforesaid polymeric and non-polymeric materials comprising the barrier layer should be deposited under the same reaction conditions and/or at the same time. The weight ratio of polymeric to non-polymeric material may be in the range of 95:5 to 5:95. The polymeric material and the non-polymeric material may be created from the same precursor material. In one example, the mixture of a polymeric material and a non-polymeric material consists essentially of polymeric silicon and inorganic silicon.

It is believed that the internal quantum efficiency (IQE) of fluorescent OLEDs can exceed the 25% spin statistics limit through delayed fluorescence. As used herein, there are two types of delayed fluorescence, i.e., P-type delayed fluorescence and E-type delayed fluorescence. P-type delayed fluorescence is generated from triplet-triplet annihilation (TTA).

On the other hand, E-type delayed fluorescence does not rely on the collision of two triplets, but rather on the thermal population between the triplet states and the singlet excited states. Compounds that are capable of generating E-type delayed fluorescence are required to have very small singlet-triplet gaps. Thermal energy can activate the transition from the triplet state back to the singlet state. This type of delayed fluorescence is also known as thermally activated delayed fluorescence (TADF). A distinctive feature of TADF is that the delayed component increases as temperature rises due to the increased thermal energy. If the reverse intersystem crossing rate is fast enough to minimize the non-radiative decay from the triplet state, the fraction of back populated singlet excited states can potentially reach 75%. The total singlet fraction can be 100%, far exceeding the spin statistics limit for electrically generated excitons.

E-type delayed fluorescence characteristics can be found in an exciplex system or in a single compound. Without being bound by theory, it is believed that E-type delayed fluorescence requires the luminescent material to have a small singlet-triplet energy gap (ΔES-T). Organic, non-metal containing, donor-acceptor luminescent materials may be able to achieve this. The emission in these materials is often characterized as a donor-acceptor charge-transfer (CT) type emission. The spatial separation of the HOMO and LUMO in these donor-acceptor type compounds often results in small ΔES-T. These states may involve CT states. Often, donor-acceptor luminescent materials are constructed by connecting an electron donor moiety such as amino- or carbazole-derivatives and an electron acceptor moiety such as N-containing six-membered aromatic ring.

Devices fabricated in accordance with embodiments of the disclosure can be incorporated into a wide variety of electronic component modules (or units) that can be incorporated into a variety of electronic products or intermediate components. Examples of such electronic products or intermediate components include display screens, lighting devices such as discrete light source devices or lighting panels, etc. that can be utilized by the end-user product manufacturers. Such electronic component modules can optionally include the driving electronics and/or power source(s). Devices fabricated in accordance with embodiments of the disclosure can be incorporated into a wide variety of consumer products that have one or more of the electronic component modules (or units) incorporated therein. A consumer product comprising an OLED that includes the compound of the present disclosure in the organic layer in the OLED is disclosed. Such consumer products would include any kind of products that include one or more light source(s) and/or one or more of some type of visual displays. Some examples of such consumer products include a flat panel display, a curved display, a computer monitor, a medical monitor, a television, a billboard, a light for interior or exterior illumination and/or signaling, a heads-up display, a fully or partially transparent display, a flexible display, a rollable display, a foldable display, a stretchable display, a laser printer, a telephone, a cell phone, tablet, a phablet, a personal digital assistant (PDA), a wearable device, a laptop computer, a digital camera, a camcorder, a viewfinder, a micro-display that is less than 2 inches diagonal, a 3-D display, a virtual reality or augmented reality display, a vehicle, a video walls comprising multiple displays tiled together, a theater or stadium screen, and a sign. Various control mechanisms may be used to control devices fabricated in accordance with the present disclosure, including passive matrix and active matrix. Many of the devices are intended for use in a temperature range comfortable to humans, such as 18 C to 30 C, and more preferably at room temperature (20-25 C), but could be used outside this temperature range, for example, from -40 C to 80 C.

The materials and structures described herein may have applications in devices other than OLEDs. For example, other optoelectronic devices such as organic solar cells and organic photodetectors may employ the materials and structures. More generally, organic devices, such as organic transistors, may employ the materials and structures.

In general parlance in the art, a "sub-pixel" may refer to the emissive region, which may be a single-layer EML, a stacked device, or the like, in conjunction with any color altering layer that is used to modify the color emitted by the emissive region.

As used herein, the "emissive region" of a sub-pixel refers to any and all emissive layers, regions, and devices that are used initially to generate light for the sub-pixel. A sub-pixel also may include additional layers disposed in a stack with the emissive region that affect the color ultimately produced by the sub-pixel, such as color altering layers disclosed herein, though such color altering layers typically are not considered "emissive layers" as disclosed herein. An unfiltered sub-pixel is one that excludes a color modifying component such as a color altering layer, but may include one or more emissive regions, layers, or devices.

In some configurations, an "emissive region" may include emissive materials that emit light of multiple colors. For example, a yellow emissive region may include multiple materials that emit red and green light when each material is used in an OLED device alone. When used in a yellow device, the individual materials typically are not arranged such that they can be individually activated or addressed. That is, the "yellow" OLED stack containing the materials cannot be driven to produce red, green, or yellow light; rather, the stack can be driven as a whole to produce yellow light. Such an emissive region may be referred to as a yellow emissive region even though, at the level of individual emitters, the stack does not directly produce yellow light. As described in further detail below, the individual emissive materials used in an emissive region (if more than one), may be placed in the same emissive layer within the device, or in multiple emissive layers within an OLED device comprising an emissive region. As described in further detail below, embodiments disclosed herein may allow for OLED devices such as displays that include a limited number of colors of emissive regions, while including more colors of sub-pixels or other OLED devices than the number of colors of emissive regions. For example, a device as disclosed herein may include only blue and yellow emissive regions. Additional colors of sub-pixels may be achieved by the use of color altering layers, such as color altering layers disposed in a stack with yellow or blue emissive regions, or more generally through the use of color altering layers, electrodes or other structures that form a microcavity as disclosed herein, or any other suitable configuration. In some cases, the general color provided by a sub-pixel may be the same as the color provided by the emissive region in the stack that defines the sub-pixel, such as where a deep blue color altering layer is disposed in a stack with a light blue emissive region to produce a deep blue sub-pixel. Similarly, the color provided by a sub-pixel may be different than the color provided by an emissive region in the stack that defines the sub-pixel, such as where a green color altering layer is disposed in a stack with a yellow emissive region to product a green sub-pixel.

In some configurations, emissive regions and/or emissive layers may span multiple sub-pixels, such as where additional layers and circuitry are fabricated to allow portions of an emissive region or layer to be separately addressable.

An emissive region as disclosed herein may be distinguished from an emissive "layer" as typically referred to in the art and as used herein. In some cases, a single emissive region may include multiple layers, such as where a yellow emissive region is fabricated by sequentially red and green emissive layers to form the yellow emissive region. As previously described, when such layers occur in an emissive region as disclosed herein, the layers are not individually addressable within a single emissive stack; rather, the layers are activated or driven concurrently to produce the desired color of light for the emissive region. In other configurations, an emissive region may include a single emissive layer of a single color, or multiple emissive layers of the same color, in which case the color of such an emissive layer will be the same as, or in the same region of the spectrum as, the color of the emissive region in which the emissive layer is disposed.

### B. The OLEDs and the Devices of the Present Disclosure

In one aspect, the present disclosure also provides an organic light emitting device (OLED) comprising:
an anode;
a hole transporting layer;
an emissive region;
an electron transporting layer; and
a cathode; wherein the emissive region comprises:
   a first compound;
   a second compound; and
   a third compound;
wherein the first compound is a sensitizer that transfers energy to the second compound;
wherein the second compound is an acceptor that is an emitter;
wherein the third compound is a first host, and at least one of the first compound and the second compound is doped in the third compound;
wherein at least two of the first, second, and the third compounds comprises same or different substituent R*;
wherein R* is selected from the group consisting of: 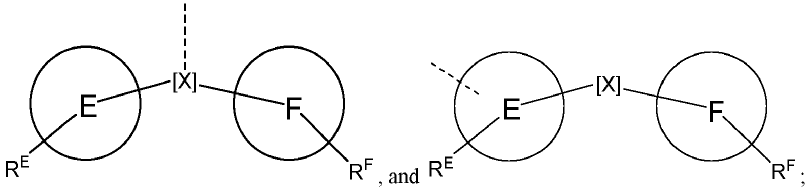
wherein
[X] is a chemical moiety comprises at least one six-membered carbocyclic, a silyl group, a germyl group, or heterocyclic ring;
moieties E and F are each independently a monocyclic ring, or a polycyclic fused ring system; wherein the monocyclic ring and each ring of the polycyclic fused ring system are independently a 5-membered or 6-membered carbocyclic or heterocyclic ring;
R^{E}, and R^{F} each independently represent mono to the maximum allowable substitution, or no substitution;
wherein each R^{E}, and R^{F} is independently a hydrogen, or a substituent selected from the group consisting of the general substituents as defined herein; an
any adjacent substituents are optionally joined or fused into a ring.

In some embodiments, the above layers are arranged sequentially as recited. More particularly, the anode; the hole transporting layer; the emissive region; the electron transporting layer; and the cathode of the OLEDs of the present disclosure are sequentially arranged as recited. Still though, other layers may be placed in between these layers so long as the identified layers are in the order as recited. It should be understood that when a compound is doped in another compound, it means the two compounds are mixed with each other.

In some embodiments, the first compound is capable of functioning as a phosphorescent emitter in an OLED at room temperature but not necessarily in the disclosed OLED. In some embodiments, the first compound is capable of functioning as a TADF emitter in an OLED at room temperature.

In some embodiments, the first compound forms an exciplex with the third compound in the OLED of the present disclosure at room temperature.

In some embodiments, the second compound is a delayed-fluorescent compound functioning as a TADF emitter in the OLED of the present disclosure at room temperature. In some embodiments, the second compound is a fluorescent compound functioning as an emitter in the OLED of the present disclosure at room temperature. In some embodiments, the second compound is the primary emitter in the OLED of the present disclosure.

In some embodiments, the first compound and the second compound comprise the same R*. In some embodiments, the first compound and the third compound comprise the same R*. In some embodiments, the second compound and the third compound comprise the same R*.

In some embodiments, the first compound and the second compound comprise different R*. In some embodiments, the first compound and the third compound comprise different R*. In some embodiments, the second compound and the third compound comprise different R*.

In some embodiments, the first compound, the second compound, and the third compound comprise R*, each R* can be the same or different. In some embodiments, at least one of the first compound, or the second compound comprises at least 2 R*. In some embodiments, both the first compound and the second compound comprise at least 2 R*.

In some embodiments, the at least two of the first, second, and the third compounds comprising R* are mixed in one layer.

In some embodiments, the first compound comprises R*; wherein the center of mass of the spin density of the lowest triplet excited state in the first compound is located at position M^{TS}; and wherein R* is directly joined to the rest of the first compound at one of the 10 atoms in the compound closest to M^{TS}.

In some embodiments, the first compound comprises R*; wherein the center of mass of the spin density of the lowest triplet excited state in the first compound is located at position M^{TS}; wherein the center of mass of R* is located at a position M^{R}; and wherein the distance from M^{TS} to M^{R} is less than 2.0 nm. In some embodiments, the distance from M^{TS} to M^{R} is less than 1.5 nm. In some embodiments, the distance from M^{TS} to M^{R} is less than 1.0 nm.

In some embodiments, the second compound comprises R*; wherein the center of mass of the spin density of the lowest triplet excited state in the second compound is located at position M^{TA}; and wherein R* is directly joined to the rest of the second compound at one of the 10 atoms in the compound closest to M^{TA}.

In some embodiments, the second compound comprises R*; wherein the center of mass of the spin density of the lowest triplet excited state in the second compound is located at position M^{TA}; wherein the center of mass of R* is located at a position M^{R}; and wherein the distance from M^{TA} to M^{R} is less than 2.0 nm. In some embodiments, the distance from M^{TA} to M^{R} is less than 1.5 nm. In some embodiments, the distance from M^{TA} to M^{R} is less than 1.0 nm.

In some embodiments, the second compound comprises R*; wherein the center of mass of the HOMO in the second compound is located at position M^{HA}; and wherein R* is directly joined to the rest of the second compound at one of the 10 atoms in the compound closest to M^{HA}.

In some embodiments, the second compound comprises R*; wherein the center of mass of HOMO in the second compound is located at position M^{HA}; wherein the center of mass of R* is located at a position M^{R}; and wherein the distance from M^{HA} to M^{R} is less than 2.0 nm. In some embodiments, the distance from M^{HA} to M^{R} is less than 1.5 nm. In some embodiments, the distance from M^{HA} to M^{R} is less than 1.0 nm.

In some embodiments, the second compound comprises R*; wherein the center of mass of the LUMO in the second compound is located at position M^{LA}; and wherein R* is directly joined to the rest of the second compound at one of the 10 atoms in the compound closest to M^{LA}.

In some embodiments, the second compound comprises R*; wherein the center of mass of LUMO in the second compound is located at position M^{LA}; wherein the center of mass of R* is located at a position M^{R}; and wherein the distance from M^{LA} to M^{R} is less than 2.0 nm. In some embodiments, the distance from M^{LA} to M^{R} is less than 1.5 nm. In some embodiments, the distance from M^{LA} to M^{R} is less than 1.0 nm.

In some embodiments, the second compound comprises R*; wherein the center of mass of the second compound is located at position M^{2c}; and wherein R* is directly joined to the second compound at one of the 10 atoms in the compound farthest from to M^{2c}.

It should be understood that the above mentioned parameters such as the center of mass of the spin density of the lowest triplet excited state of a compound, the center of mass of HOMO of a compound, the center of mass of the LUMO of a compound, the center mass of the compound, and the center of mass of R* together with all the identified distances and above can be obtained through DFT calculations. DFT calculations can also be used for the 10 atoms closest to the relevant positions as identified above.

It should be understood that these compounds related calculations obtained with the DFT functional set and basis set as identified herein are theoretical. Computational composite protocols, such as Gaussian with the CEP-31G basis set used herein, rely on the assumption that electronic effects are additive and, therefore, larger basis sets can be used to extrapolate to the complete basis set (CBS) limit. However, when the goal of a study is to understand variations in HOMO, LUMO, S₁, T₁, bond dissociation energies, etc. over a series of structurally-related compounds, the additive effects are expected to be similar. Accordingly, while absolute errors from using the B3LYP may be significant compared to other computational methods, the relative differences between the HOMO, LUMO, S₁, T₁, and bond dissociation energy values calculated with B3LYP protocol are expected to reproduce experiment quite well. *See, e.g.,* Hong et al., Chem. Mater. 2016, 28, 5791-98, 5792-93 and Supplemental Information (discussing the reliability of DFT calculations in the context of OLED materials). Moreover, with respect to iridium or platinum complexes that are useful in the OLED art, the data obtained from DFT calculations correlates very well to actual experimental data. *See* Tavasli et al., J. Mater. Chem. 2012, 22, 6419-29, 6422 (Table 3) (showing DFT calculations closely correlating with actual data for a variety of emissive complexes); Morello, G.R., J. Mol. Model. 2017, 23:174 (studying of a variety of DFT functional sets and basis sets and concluding the combination of B3LYP and CEP-31G is particularly accurate for emissive complexes).

In some embodiments, [X] is a chemical moiety comprises at least 6 carbon atoms. In some embodiments, [X] is a chemical moiety comprises at least 7, 8, 9, 10, 11, 12, 15, 18, 21, or 24 carbon atoms.

In some embodiments, [X] comprises at least one 6-membered aromatic ring.

In some embodiments, [X] is selected from the group consisting of a substituted or unsubstituted monocyclic ring, a substituted or unsubstituted polycyclic fused ring system, SiR^{P}, SiR^{P}R^{Q}, GeR^{P}, GeR^{P}R^{Q}, BR^{P}, BR^{P}R^{Q}, CR^{P}R^{Q}, NR^{P}, and PR^{P} wherein R^{P} comprises a 6-membered carbocyclic or heterocyclic ring, and R^{Q} is a hydrogen or a substituent selected from the group consisting of the general substituents as defined herein.

In some embodiments, each of R^{P} and R^{Q} comprises a 6-membered carbocyclic or heterocyclic ring.

In some embodiments, each of the monocyclic ring, R^{P}, and R^{Q} is independently selected from the group consisting of phenyl, pyridine, pyrimidine, pyrazine, pyridazine, and triazine; the monocyclic ring can be further substituted; R^{P} and R^{Q} can be further substituted or fused; wherein each of the polycyclic fused ring system is selected from the group consisting of triphenylene, carbazole, indolocarbazole, dibenzothiophene, dibenzofuran, dibenzoselenophene, 5λ²-benzo[d]benzo[4,5]imidazo[3,2-a]imidazole, 5,9-dioxa-13b-boranaphtho[3,2,1-de]anthracene, and aza variants thereof.

In some embodiments, R* is partially or fully deuterated.

In some embodiments, the first compound is partially or fully deuterated.

In some embodiments, the second compound is partially or fully deuterated.

In some embodiments, the third compound is partially or fully deuterated.

In some embodiments, R* is selected from the group consisting of: 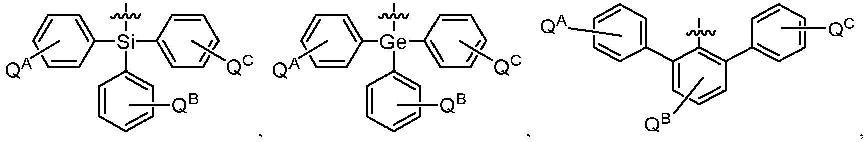 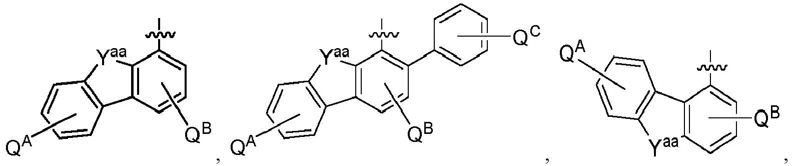 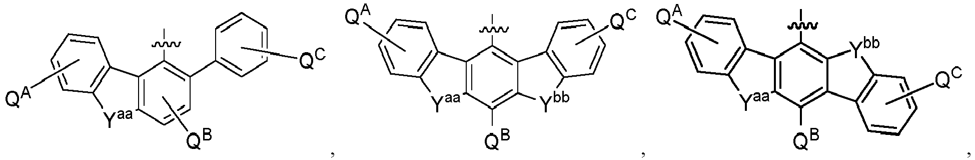 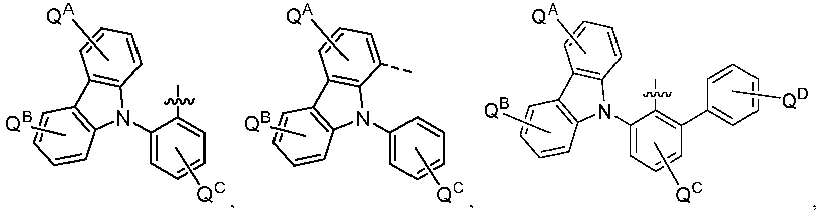 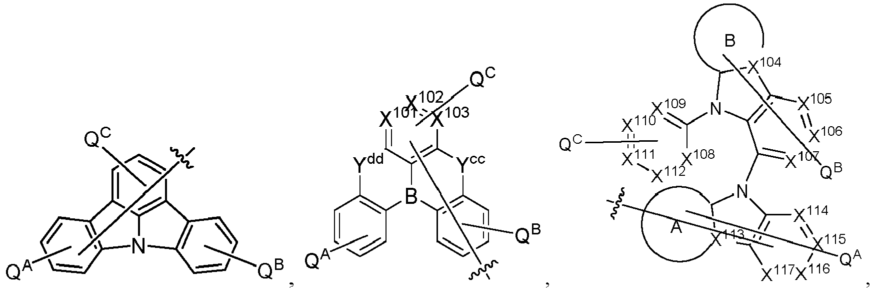 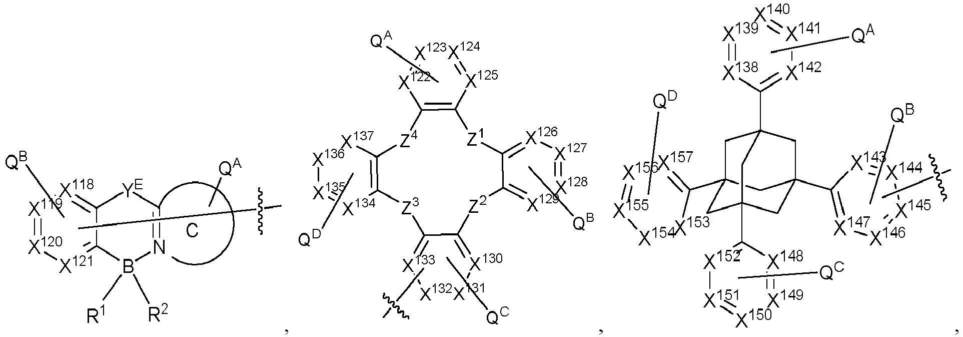 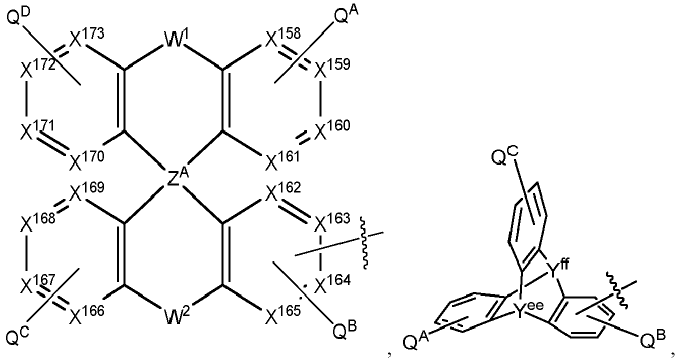 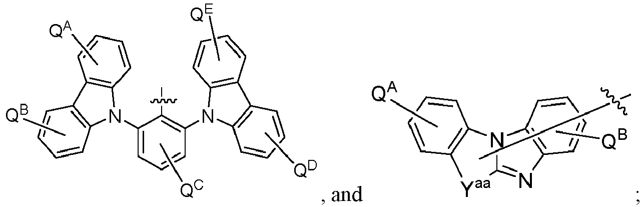
wherein rings A, B, and C are each independently a 5-membered or 6-membered carbocyclic or heterocyclic ring;
Z¹ to Z⁴ are each independently a direct bond or selected from the group consisting of O, S, Se, NR, BR, BRR', PR, CR, C=X, CRR', SO, SO₂, SiRR', GeRR', P(O)R, aryl, hetero aryl, alkyl, hetero cycloalkyl, and cycloalkyl;
each X¹⁰¹-X¹⁷³ is independently C or N;
Z^{A} is selected from the group consisting of C, Si, and Ge;
wherein W¹ and W² are each independently selected from the group consisting of direct bond, O, S, Se, CRR', SiRR', and GeRR';
each Y^{aa} and Y^{bb} is independently selected from the group consisting of O, S, Se, CRR', SiRR', GeRR', NR, BR, and BRR';
each Y^{E}, Y^{cc} and Y^{dd} is independently selected from the group consisting of O, S, Se, CRR', SiRR', GeRR', BR, and BRR';
each Y^{ee} and Y^{ff} is independently selected from the group consisting of CR, SiR, GeR, B, and N;
each Q^{A} to Q^{E} independently represents mono to the maximum allowable substitutions, or no substitution;
each R, R', Q^{A} to Q^{E} is independently hydrogen or a substituent selected from the group consisting of the general substituents as defined herein; any two substituents can be joined or fused into a ring; and
any carbon ring atoms up to maximum total number of three, together with their substituents, in each phenyl ring of any of above structures can be replaced with N.

In some of the above embodiments, the preferred substitution positions are at the ortho positions relative to the existing substituted positions on that ring.

In some embodiments, R* is selected from the group consisting of the following structures (LIST 1): 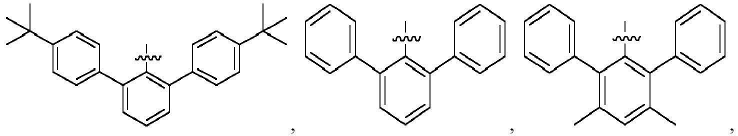 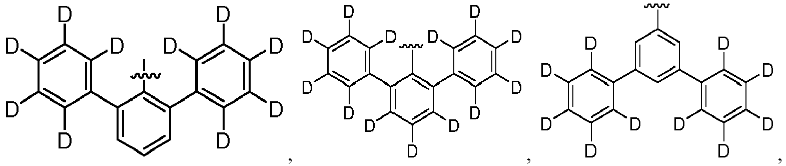 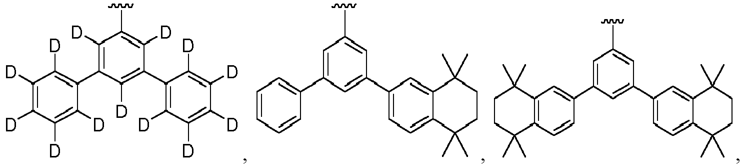 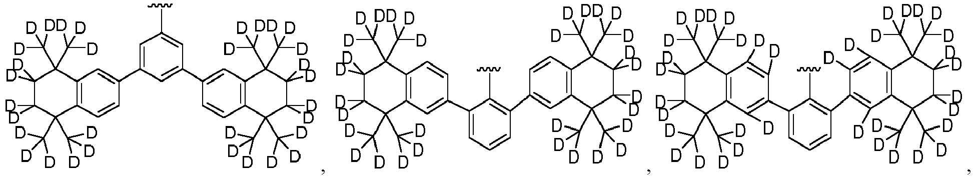 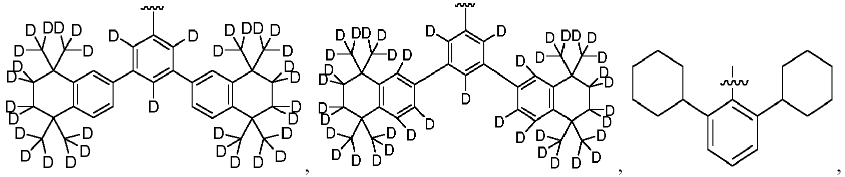 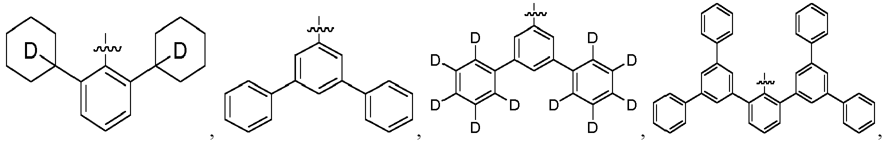 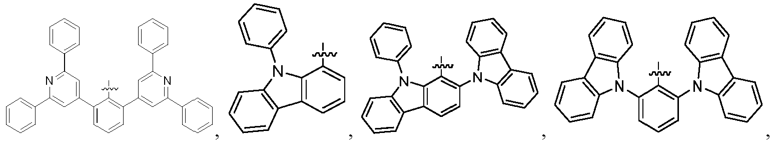 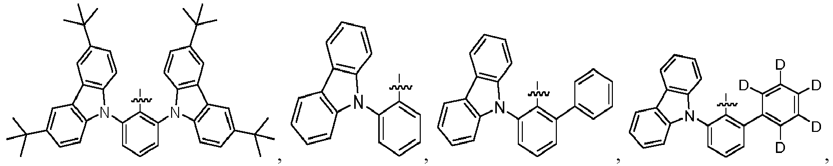 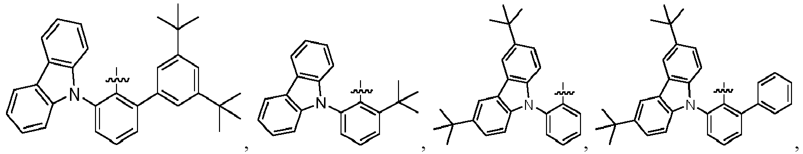 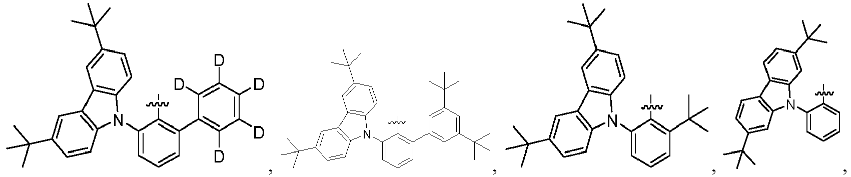 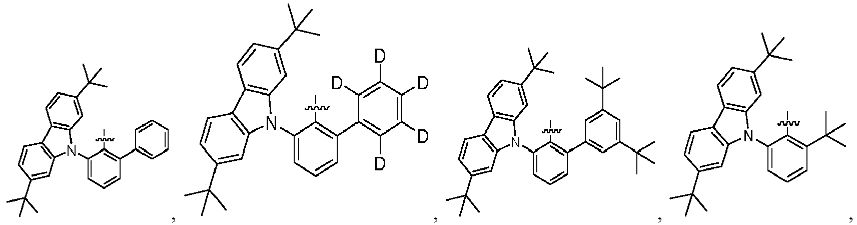 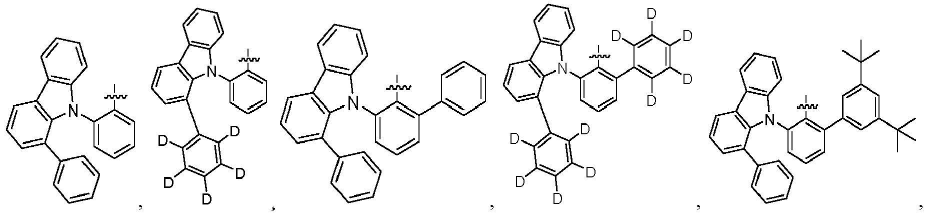 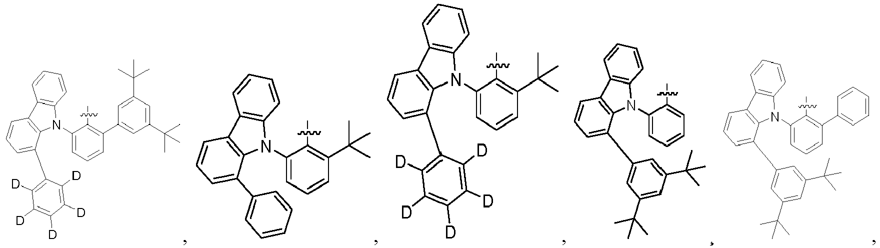 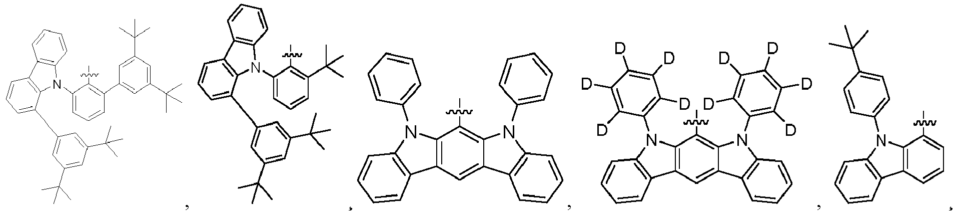 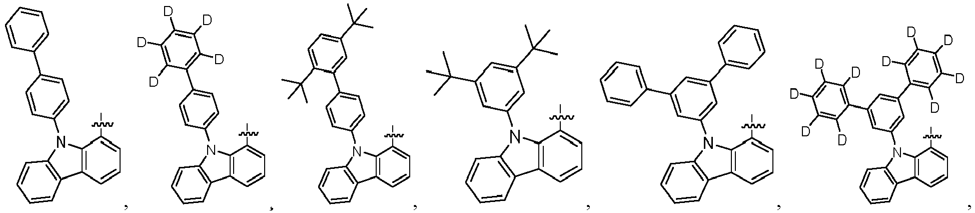 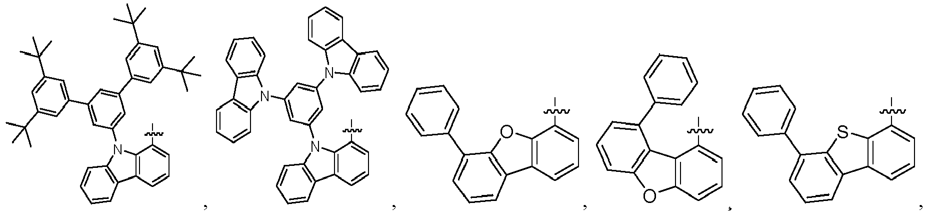 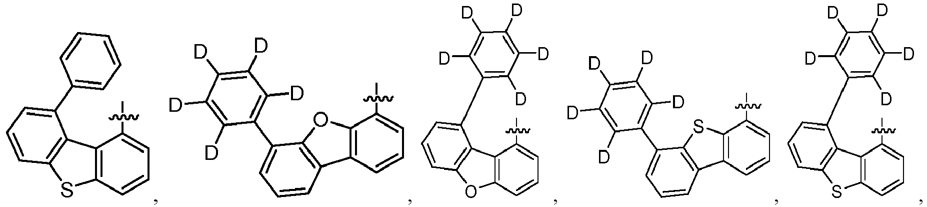 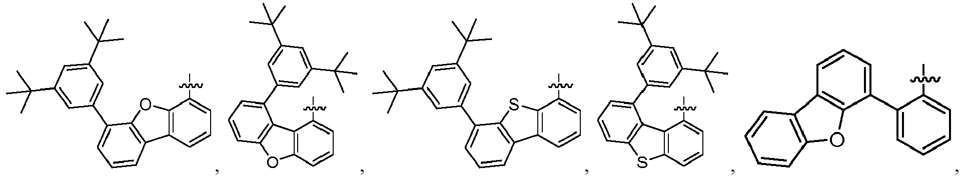 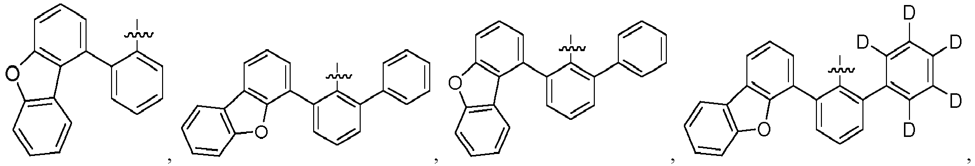 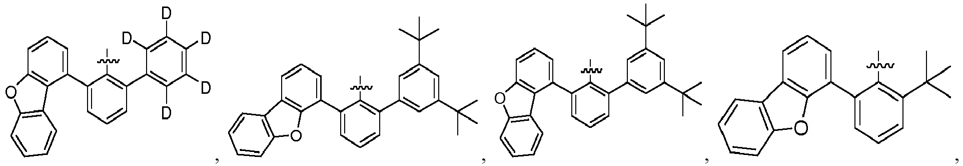 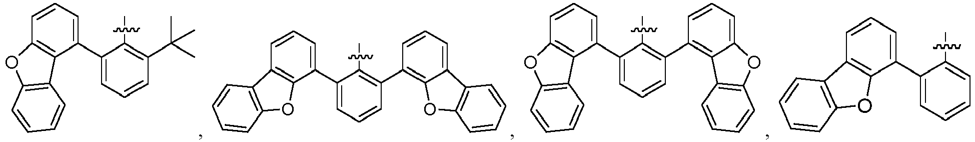 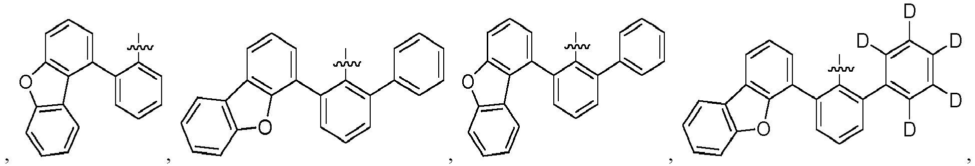 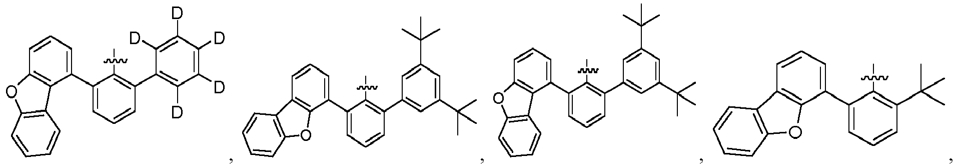 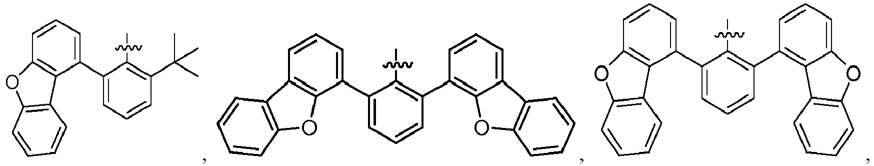 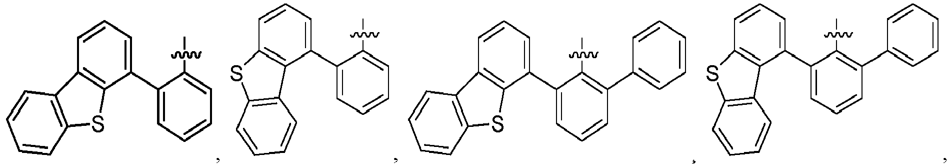 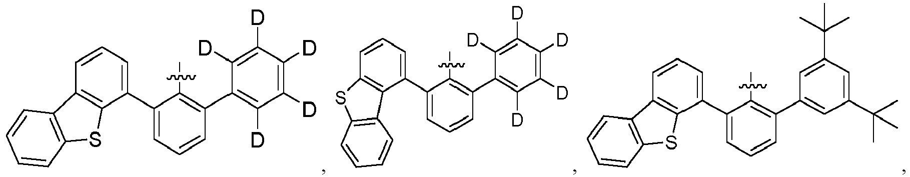 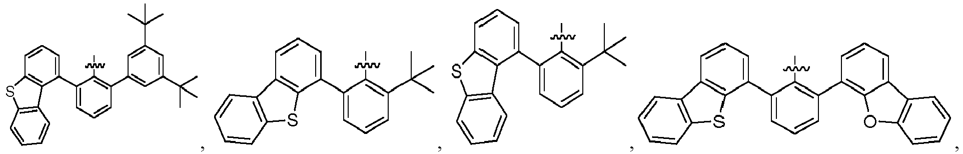 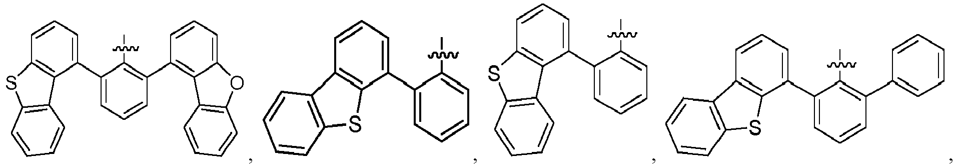 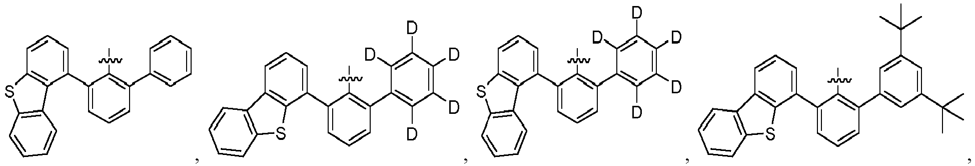 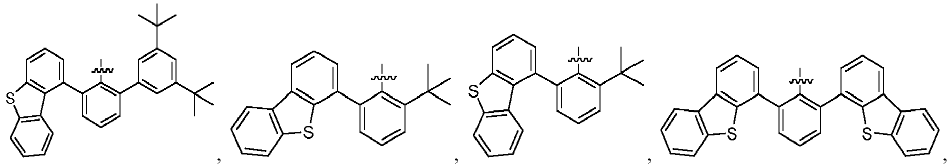 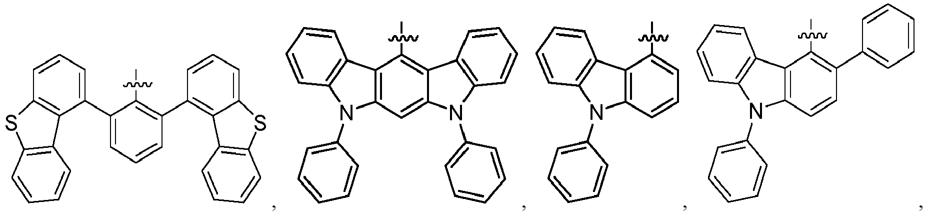 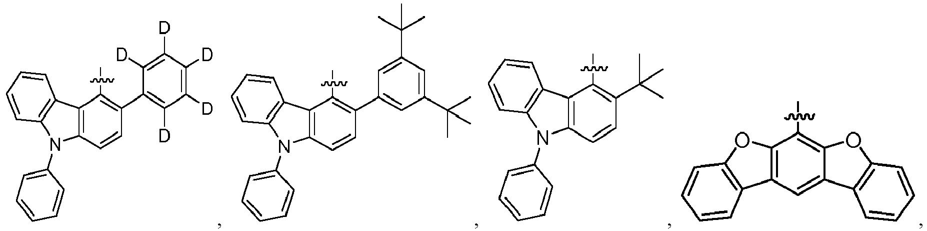 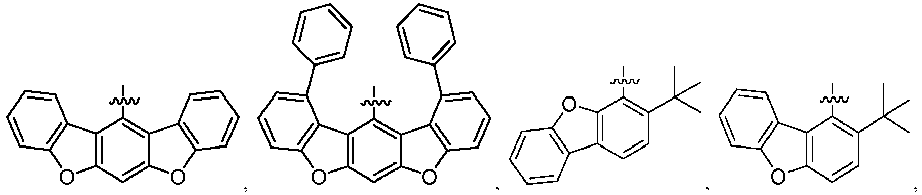 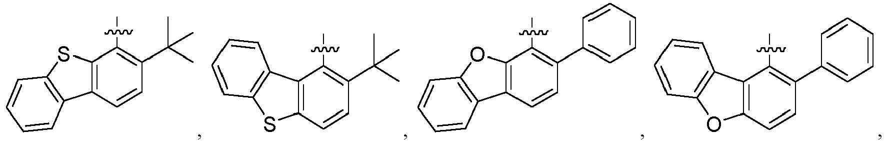 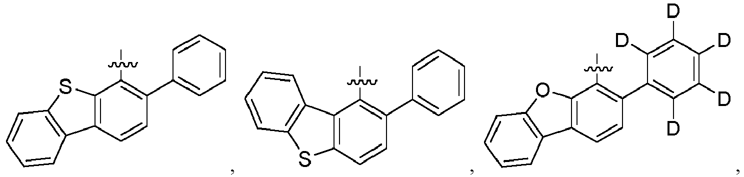 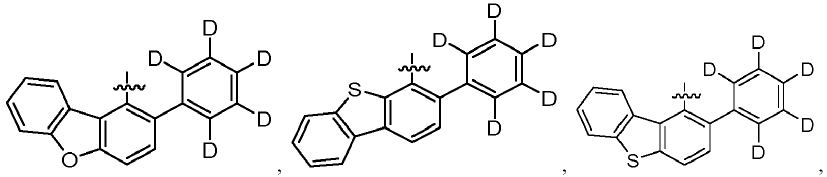 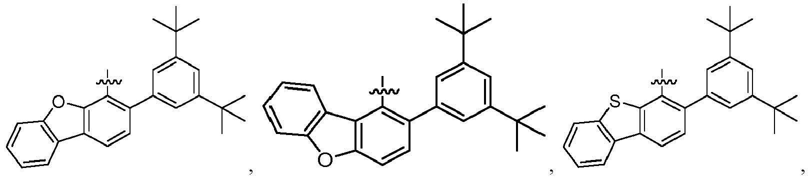 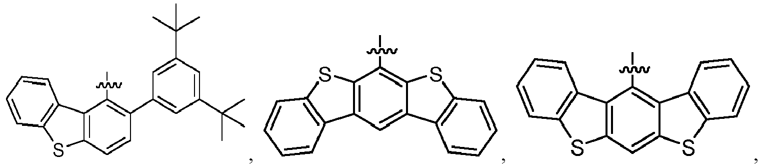 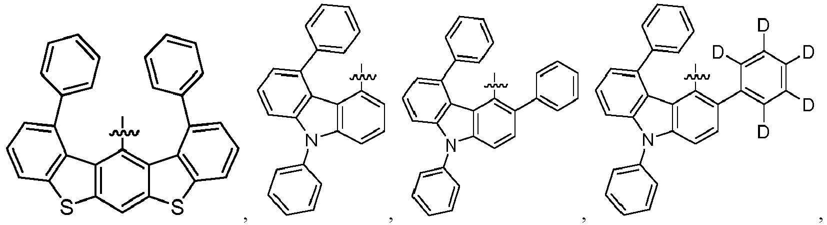 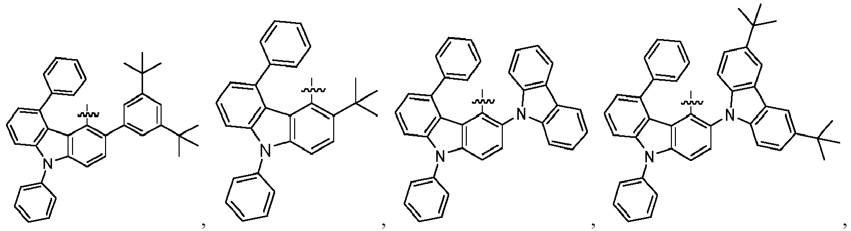 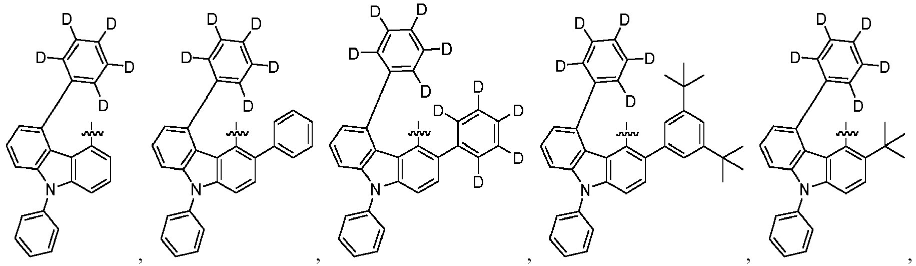 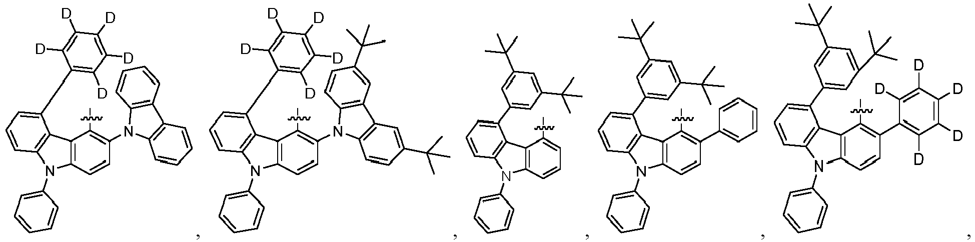 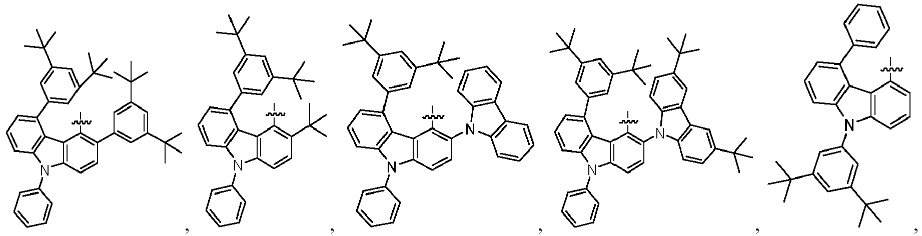 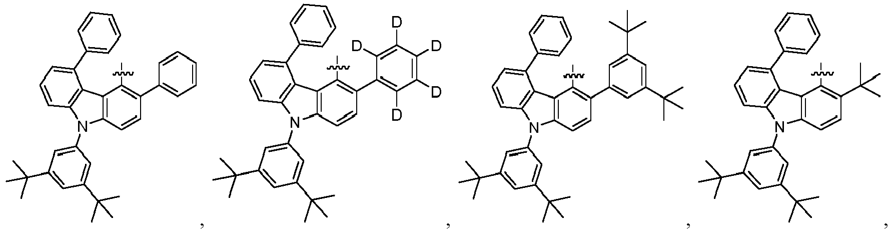 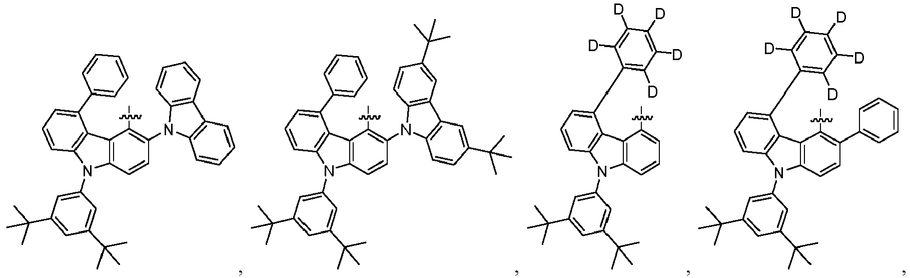 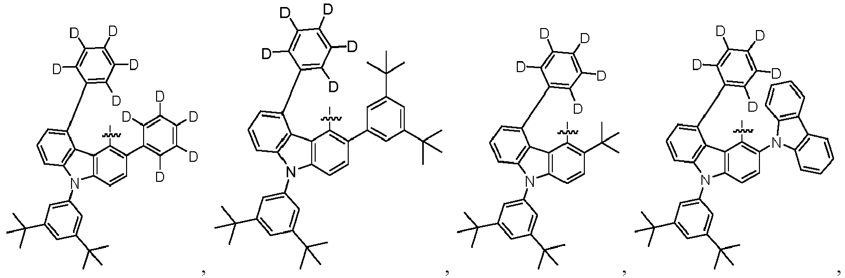 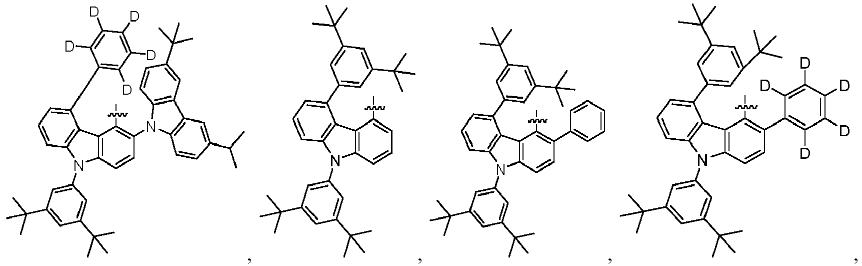 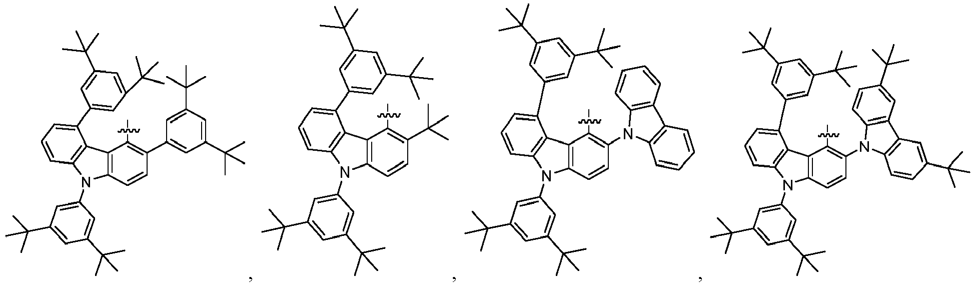 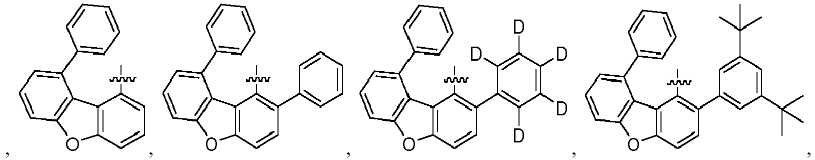 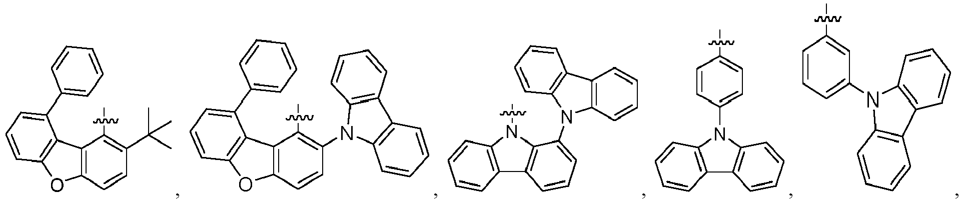 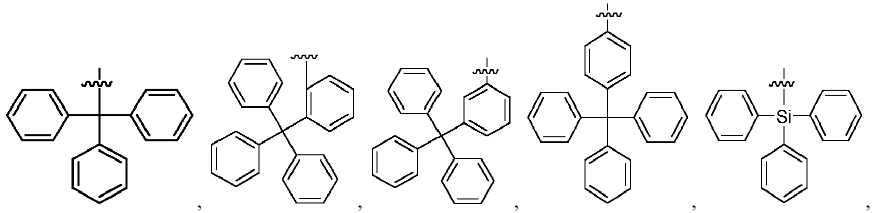 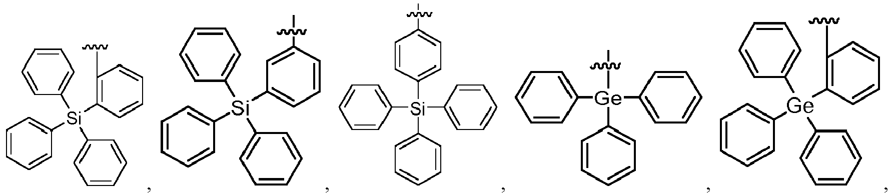 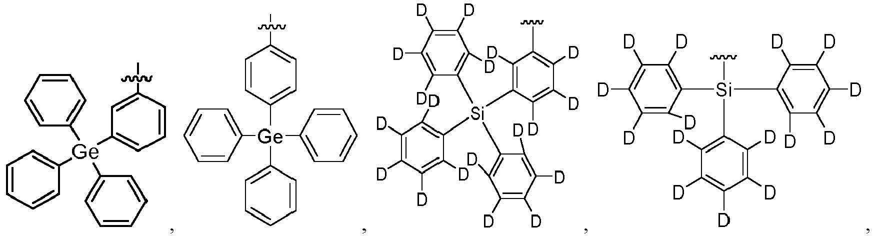 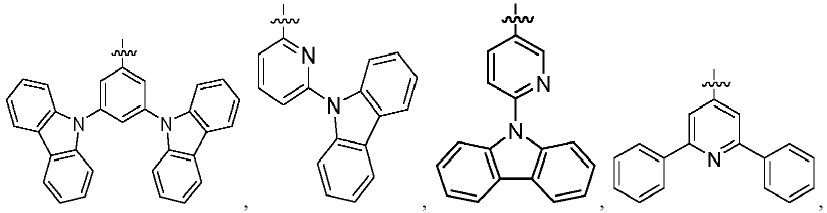 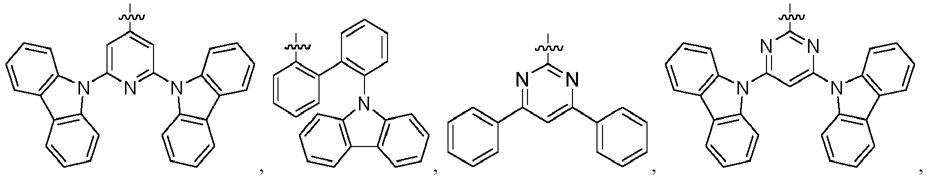 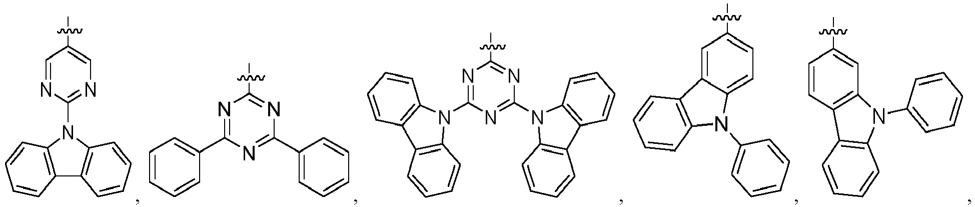 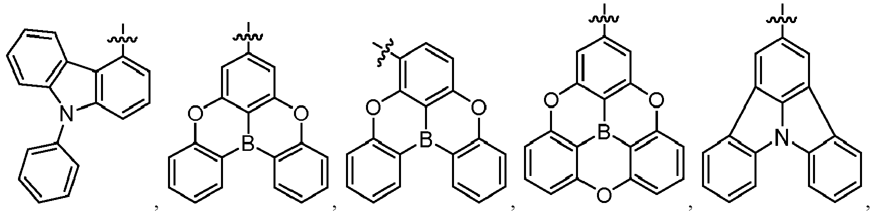 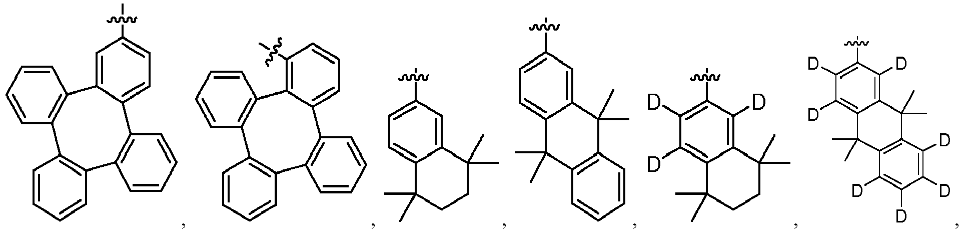 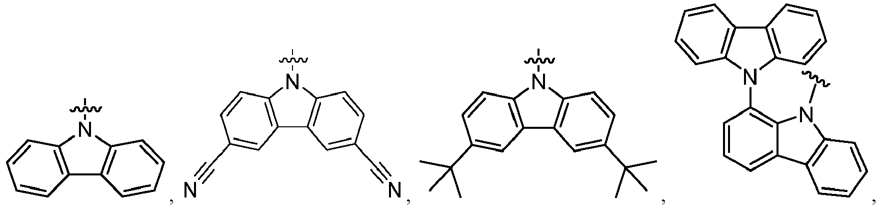 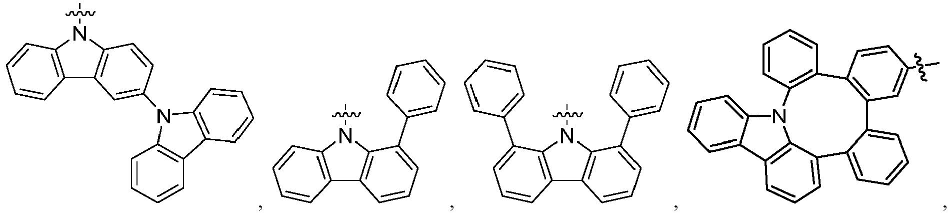 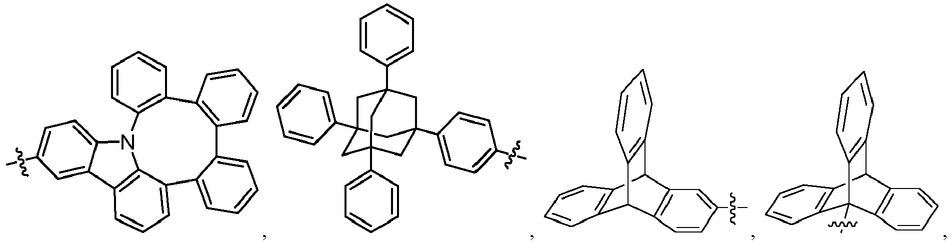 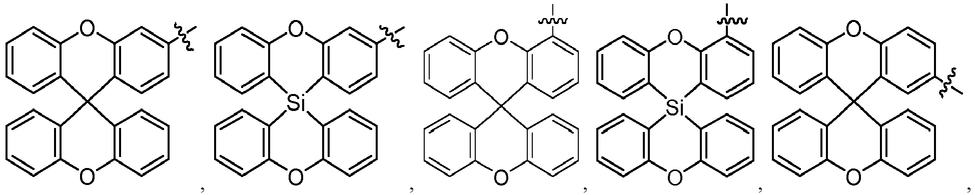 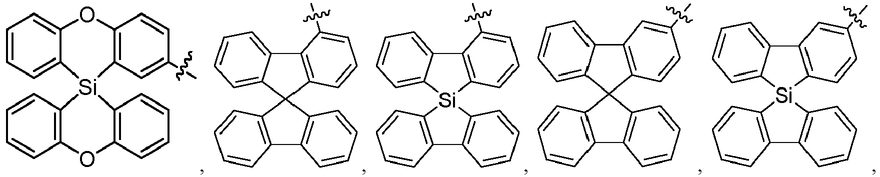 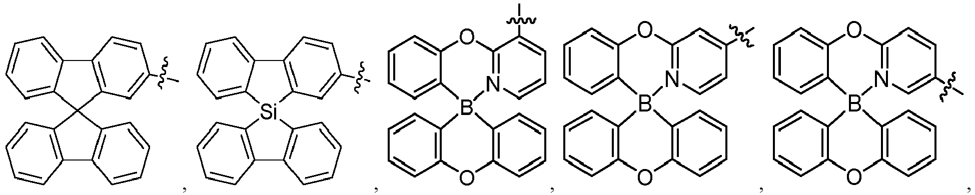 and

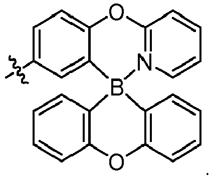

In some embodiments, the first, and second compounds are in a separate layer within the emissive region. For example, the first and third compounds can be in one deposited layer as a mixture, and the second compound can be in another deposited layer. In that example, the two layers can be in either order with respect to the HTL and ETL so that in some embodiments, the layer containing the first and third compounds can be closer to the HTL than the layer containing the second compound. In some other embodiments, the layer containing the first and third compounds can be closer to the ETL than the layer containing the second compound. In some embodiments, the second and third compounds can be in one deposited layer as a mixture, and the first compound can be in another deposited layer. These two layers can be in either order with respect to the HTL and ETL. In some embodiments, the layers containing the first and the second compounds are in contact to each other.

In some embodiments, the first, second, and third compounds are present as a mixture in the emissive region.

In some embodiment, the mixture can be a homogeneous mixture or the compounds in the mixture can be in graded concentrations through the thickness of the layer. The concentration grading can be linear, non-linear, sinusoidal, etc. In addition to the first, second, and third compounds, there can be one or more additional host compounds also mixed into the mixture.

In some embodiments, the emissive region contains *N* layers and *N* > 2.

In some embodiments, the first compound is contained in each of the N layers, the second compound is contained in less than or equal to *N*-1 layers.

In some embodiments, the second compound is contained within less than or equal to N/2 layers.

In some embodiments, the first and second compounds are not in the same layer.

In some embodiments, the layers which contain the second compound comprise a fourth compound which is not contained in layers with the first compound.

In some embodiments, two or more layers contain the second compound; wherein the concentration of the second compound in at least two of the two or more layers are different.

In some embodiments, the OLED emits a luminescent emission comprising an emission component from the S₁ energy of the second compound when a voltage is applied across the OLED. In some embodiments, at least 65% of the emission from the OLED is produced from the second compound with a luminance of at least 10 cd/m². In some embodiments, at least 75% of the emission from the OLED is produced from the second compound with a luminance of at least 10 cd/m². In some embodiments, at least 85% of the emission from the OLED is produced from the second compound with a luminance of at least 10 cd/m². In some embodiments, at least 95% of the emission from the OLED is produced from the second compound with a luminance of at least 10 cd/m².

In some embodiments, T₁ energy of the third compound is higher than those of the first and the second compounds.

In some embodiments, S₁ energy of the second compound is lower than those of the first and the third compounds.

In some embodiments, S₁-T₁ energy gap of the first compound is less than 400 meV. In some embodiments, S₁-T₁ energy gap of the first compound is less than 300 meV. In some embodiments, S₁-T₁ energy gap of the first compound is less than 250 meV. In some embodiments, S₁-T₁ energy gap of the first compound is less than 200 meV. In some embodiments, S₁-T₁ energy gap of the first compound is less than 150 meV. In some embodiments, S₁-T₁ energy gap of the first compound is less than 100 meV.

In some embodiments, S₁-T₁ energy gap of the second compound is less than 400 meV. In some embodiments, S₁-T₁ energy gap of the second compound is less than 300 meV. In some embodiments, S₁-T₁ energy gap of the second compound is less than 250 meV. In some embodiments, S₁-T₁ energy gap of the second compound is less than 200 meV. In some embodiments, S₁-T₁ energy gap of the second compound is less than 150 meV. In some embodiments, S₁-T₁ energy gap of the second compound is less than 100 meV.

In some embodiments, the second compound has a Stokes shift of 30 nm or less. In some embodiments, the second compound has a Stokes shift of 25 nm or less. In some embodiments, the second compound has a Stokes shift of 20 nm or less. In some embodiments, the second compound has a Stokes shift of 15 nm or less. In some embodiments, the second compound has a Stokes shift of 10 nm or less.

In some embodiments, the first compound has an emission maximum of λₘₐₓ₁ in an monochromic OLED having the third compound as the host at room temperature; wherein the second compound has an emission maximum of λₘₐₓ₂ in the monochromic OLED by replacing the first compound with the second compound; wherein Δλ = λₘₐₓ₁ -λₘₐₓ₂; and wherein Δλ is equal to or less than the number selected from the group consisting of 15, 12, 10, 8, 6, 4, 2, 0, -2, -4, -6, -8, and -10 nm.

In some embodiments, Δλ is equal to or less than 5, 4, 3, 2, 1, 0, -1, -2, -3, -4 or -5.

In some embodiments, the first compound is capable of functioning as a phosphorescent emitter in an OLED at room temperature. In some embodiments, the first compound is capable of emitting light from a triplet excited state to a ground singlet state in an OLED at room temperature.

In the embodiments, the first compound is capable of functioning as a phosphorescent emitter in an OLED at room temperature, and the first compound can be a metal coordination complex having a metal-carbon bond, a metal-nitrogen bond, or a metal-oxygen bond. In some embodiments, the metal is selected from the group consisting of Ir, Rh, Re, Ru, Os, Pt, Zn, Zr, Pd, Au, Ag, and Cu. In some embodiments, the metal is Ir. In some embodiments, the metal is Pt. In some embodiments, the first compound has the formula of M(L¹)ₓ(L²)_{y}(L³)_{z};
wherein L¹, L², and L³ can be the same or different;
wherein x is 1, 2, or 3;
wherein y is 0, 1, or 2;
wherein z is 0, 1, or 2;
wherein x+y+z is the oxidation state of the metal M;
wherein L¹ is selected from the group consisting of the structures of LIGAND LIST: 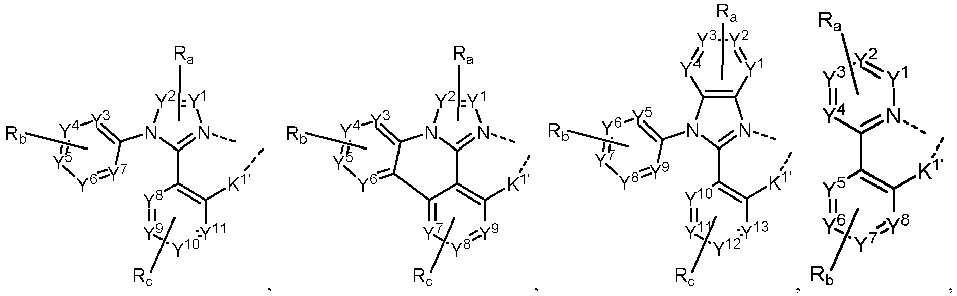 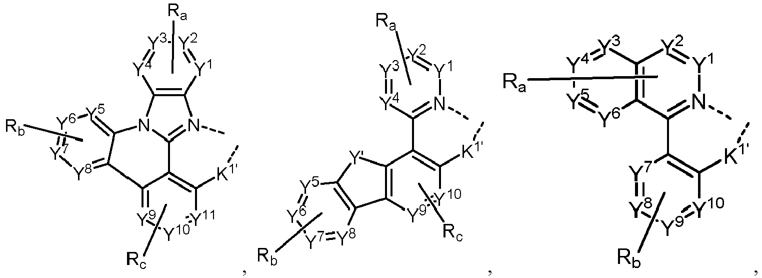 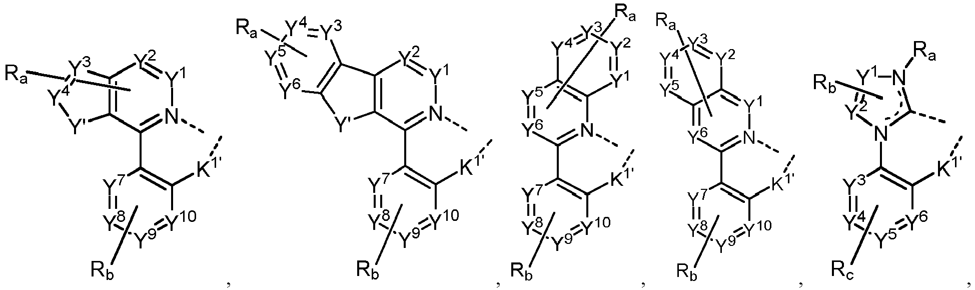 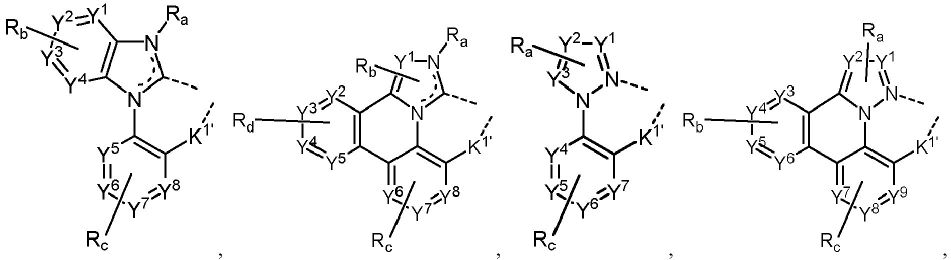 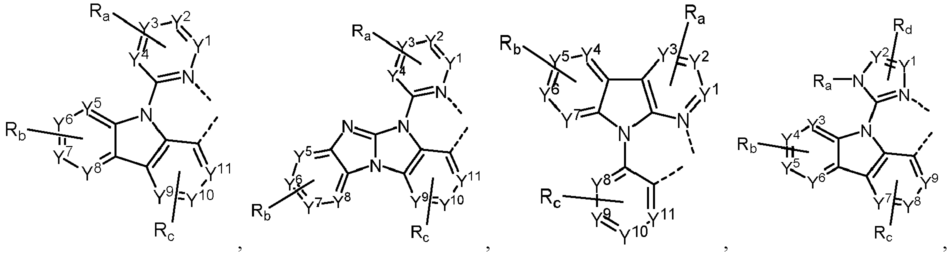 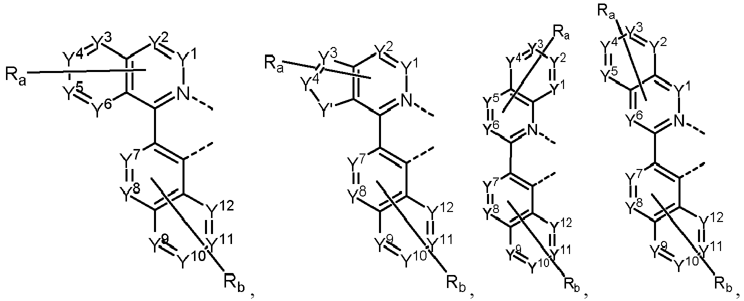 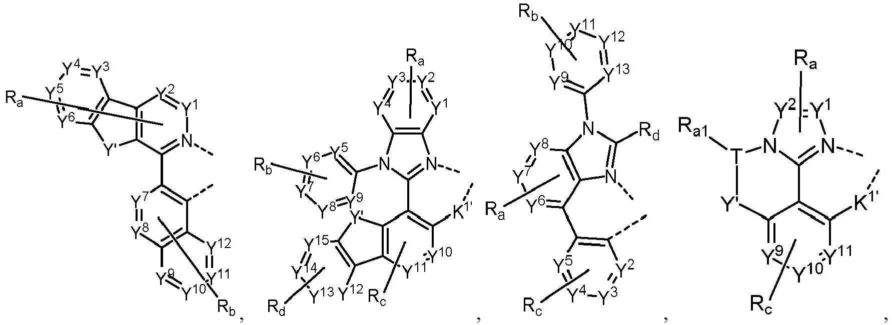 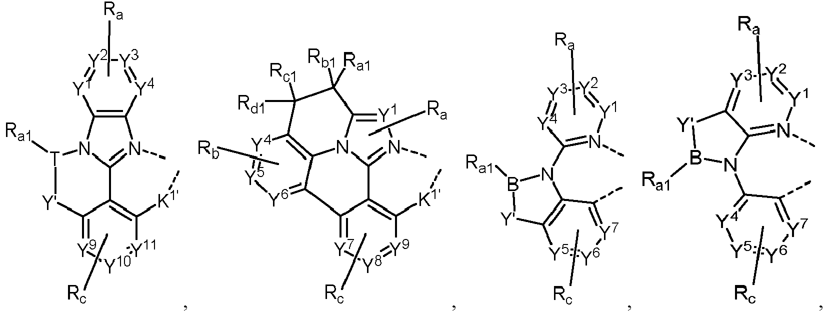 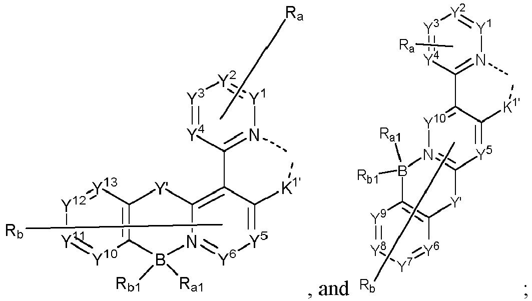
wherein L² and L³ are independently selected from the group consisting of 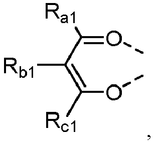 and the structures of LIGAND LIST; wherein:
T is selected from the group consisting of B, Al, Ga, and In;
wherein K^{1'} is a direct bond or is selected from the group consisting of NRₑ, PRₑ, O, S, and Se;
wherein each Y¹ to Y¹³ are independently selected from the group consisting of carbon and nitrogen;
wherein Y' is selected from the group consisting of BRₑ, NRₑ, PRₑ, O, S, Se, C=O, S=O, SO₂, CRₑR_{f}, SiRₑR_{f}, and GeRₑR_{f};
wherein Rₑ and R_{f} can be fused or joined to form a ring;
wherein each Rₐ, R_{b}, R_{c}, and R_{d} can independently represent from mono to the maximum possible number of substitutions, or no substitution;
wherein each Rₐ₁, R_{b1}, R_{c1}, R_{d1}, Rₐ, R_{b}, R_{c}, R_{d}, Rₑ, and R_{f} is independently a hydrogen or a substituent selected from the group consisting of the General Substituents as defined herein; and
wherein any two adjacent substituents of Rₐ₁, R_{b1}, R_{c1}, R_{d1}, Rₐ, R_{b}, R_{c}, and R_{d} can be fused or joined to form a ring or form a multidentate ligand.

In some embodiments, the metal in formula M(L¹)ₓ(L²)_{y}(L³)_{z} is selected from the group consisting of Cu, Ag, or Au.

In some embodiments, the first compound has a formula selected from the group consisting of Ir(L_{A})₃, Ir(L_{A})(L_{B})₂, Ir(L_{A})₂(L_{B}), Ir(L_{A})₂(L_{C}), Ir(L_{A})(L_{B})(L_{C}), and Pt(L_{A})(L_{B});
wherein L_{A}, L_{B}, and L_{C} are different from each other in the Ir compounds;
wherein L_{A} and L_{B} can be the same or different in the Pt compounds; and
wherein L_{A} and L_{B} can be connected to form a tetradentate ligand in the Pt compounds.

In some embodiments, the first compound comprises at least one electron-withdrawing group. In some such embodiments, the electron-withdrawing groups commonly comprise one or more highly electronegative elements including but not limited to fluorine, oxygen, sulfur, nitrogen, chlorine, and bromine. In some such embodiments, the electron-withdrawing group has a Hammett constant larger than 0. In some such embodiments, the electron-withdrawing group has a Hammett constant equal or larger than 0.1, 0.2, 0.3, 0.4, 0.5, 0.6, 0.7, 0.8, 0.9, 1.0, or 1.1.

In some such embodiments, the electron-withdrawn group is selected from the group consisting of the structures in the following LIST EWG 1: F, CF₃, CN, COCH₃, CHO, COCF₃, COOMe, COOCF₃, NO₂, SF₃, SiF₃, PF₄, SF₅, OCF₃, SCF₃, SeCF₃, SOCF₃, SeOCF₃, SO₂F, SO₂CF₃, SeO₂CF₃, OSeO₂CF₃, OCN, SCN, SeCN, NC, ⁺N(R^{k2})₃, (R^{k2})₂CCN, (R^{k2})₂CCF₃, CNC(CF₃)₂, BR^{k3}R^{k2}, substituted or unsubstituted dibenzoborole, 1-substituted carbazole, 1,9-substituted carbazole, substituted or unsubstituted carbazole, substituted or unsubstituted pyridine, substituted or unsubstituted pyrimidine, substituted or unsubstituted pyrazine, substituted or unsubstituted pyridoxine, substituted or unsubstituted triazine, substituted or unsubstituted oxazole, substituted or unsubstituted benzoxazole, substituted or unsubstituted thiazole, substituted or unsubstituted benzothiazole, substituted or unsubstituted imidazole, substituted or unsubstituted benzimidazole, ketone, carboxylic acid, ester, nitrile, isonitrile, sulfinyl, sulfonyl, partially and fully fluorinated alkyl, partially and fully fluorinated aryl, partially and fully fluorinated heteroaryl, cyano-containing alkyl, cyano-containing aryl, cyano-containing heteroaryl, isocyanate, 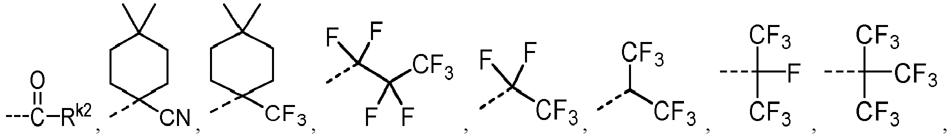 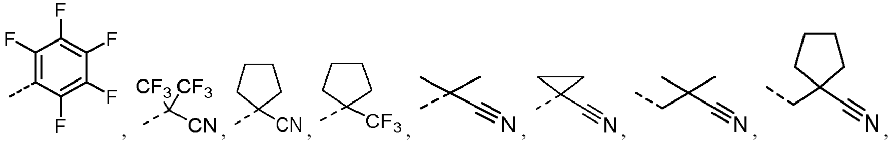 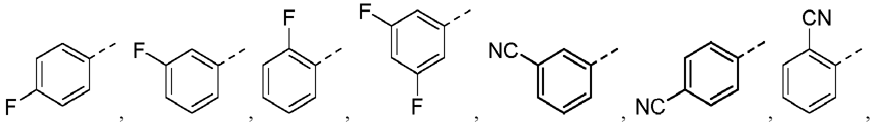 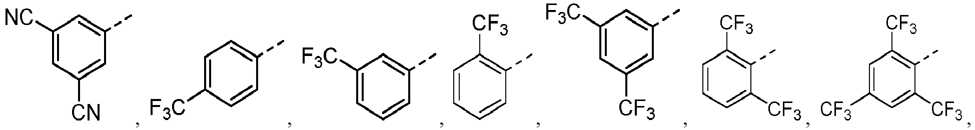 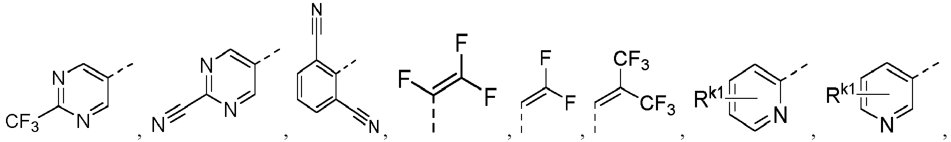 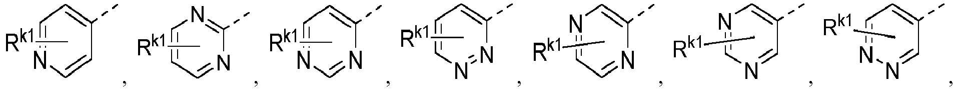 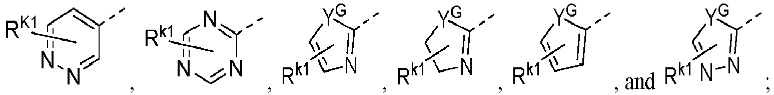
wherein Y^{G} is selected from the group consisting of BRₑ, NRₑ, PRₑ, O, S, Se, C=O, S=O, SO₂, CRₑR_{f}, SiRₑR_{f}, and GeRₑR_{f'}; and
R^{k1} each independently represents mono to the maximum allowable substitutions, or no substitution;
wherein each of R^{k1}, R^{k2}, R^{k3}, Rₑ, and R_{f} is independently a hydrogen, or a substituent selected from the group consisting of the General Substituents defined herein.

In some embodiments of the OLED, the first compound is selected from the group consisting of the compounds of the following LIST 2: 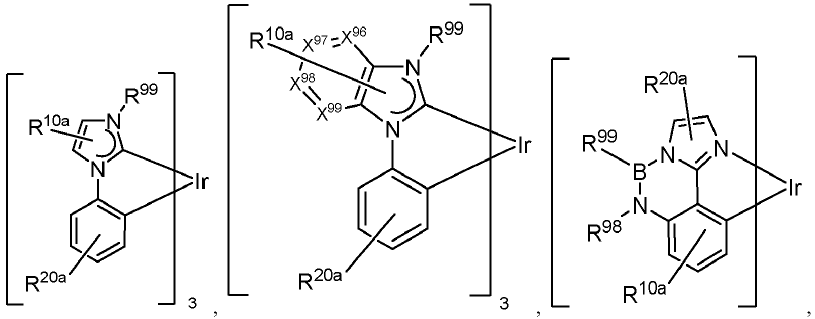 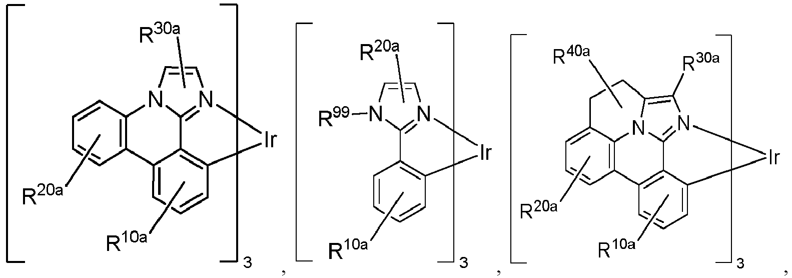 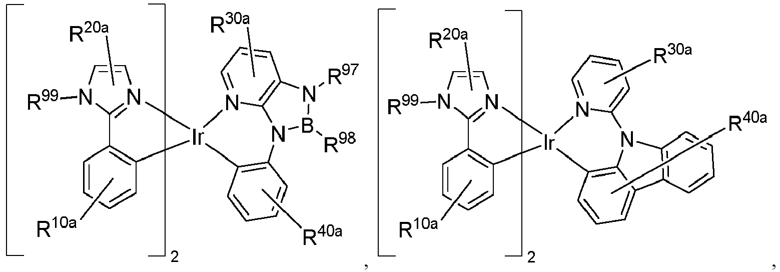 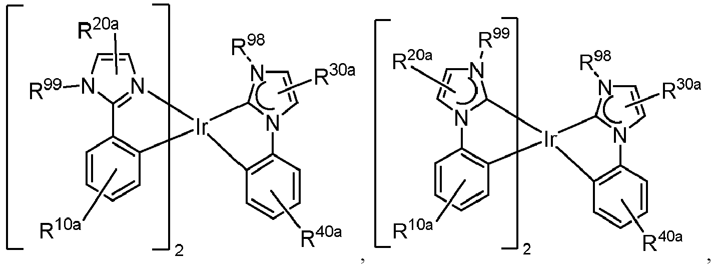 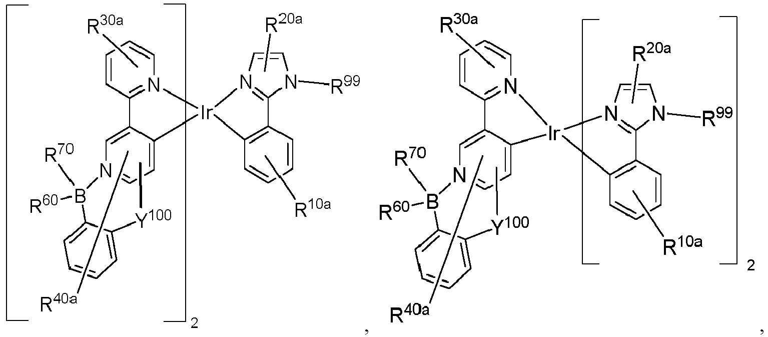 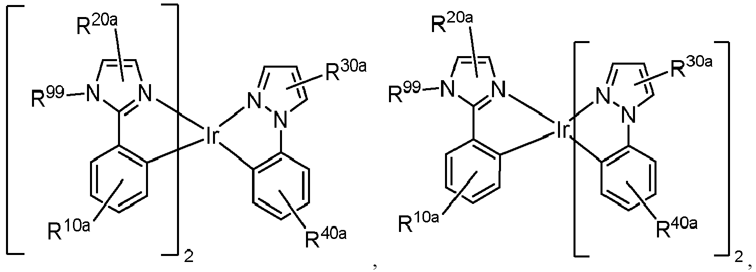 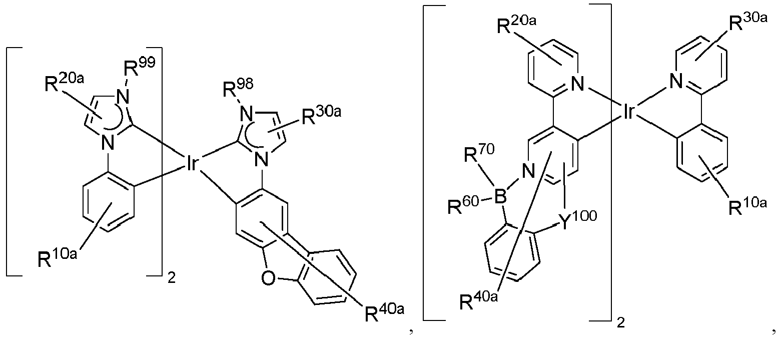 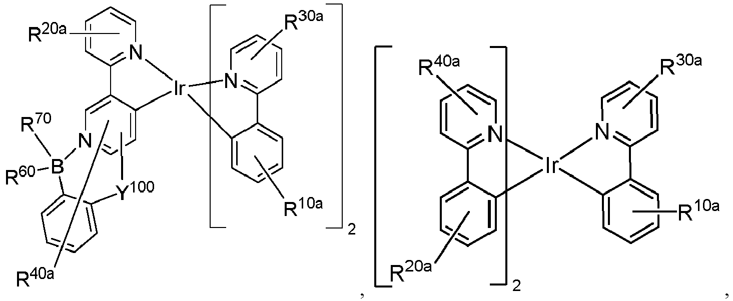 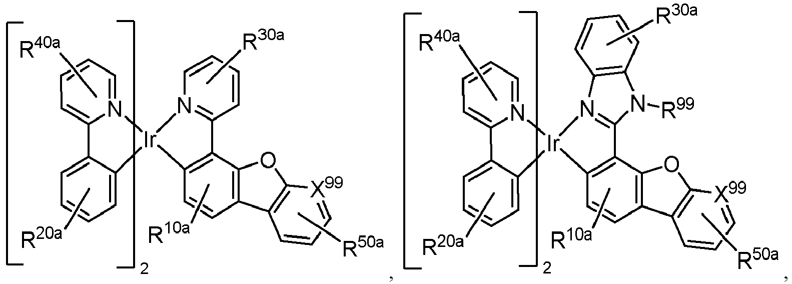 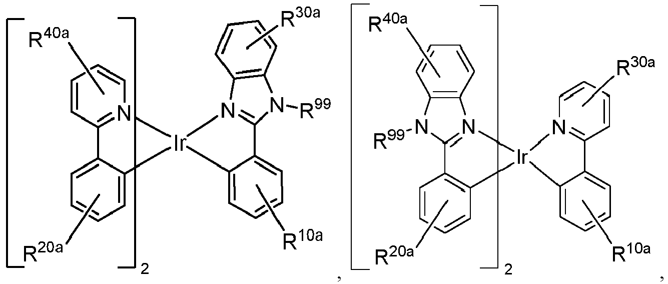 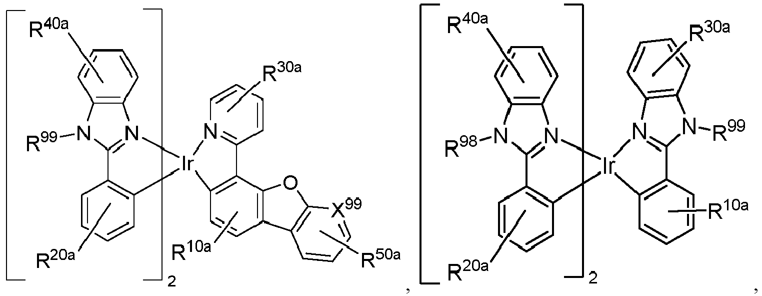 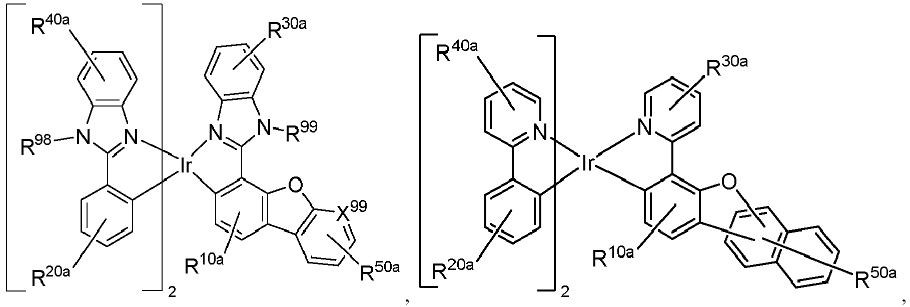 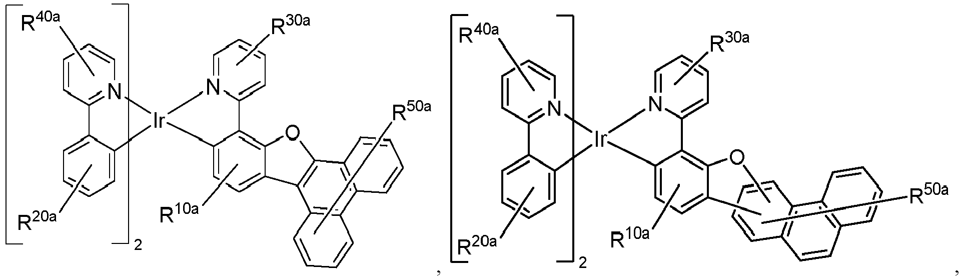 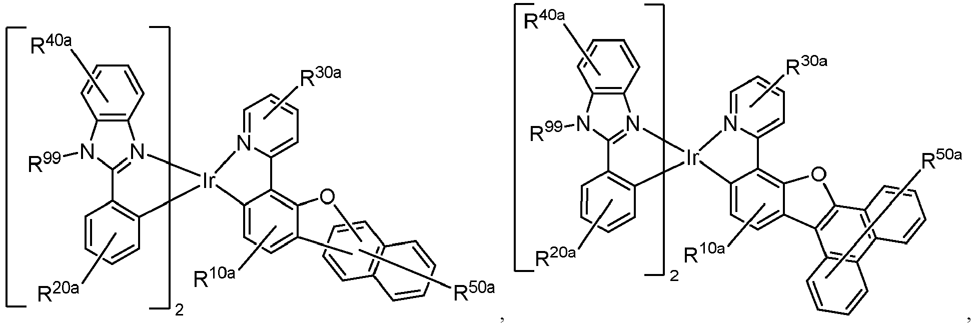 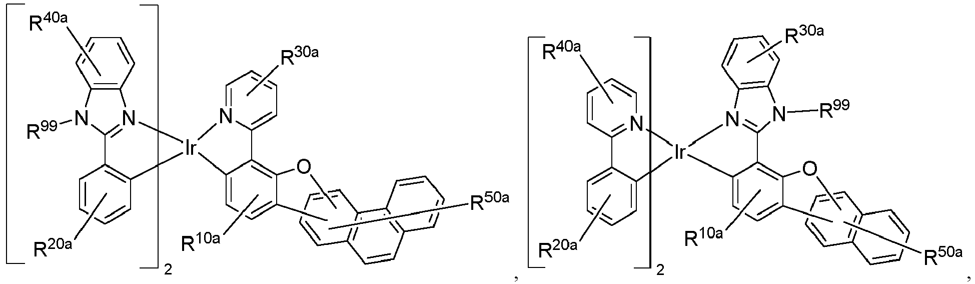 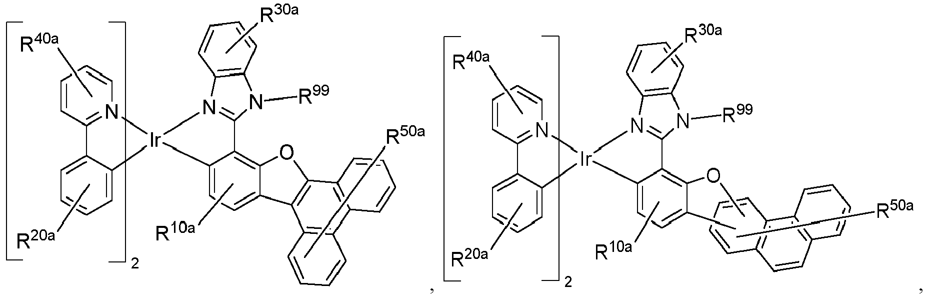 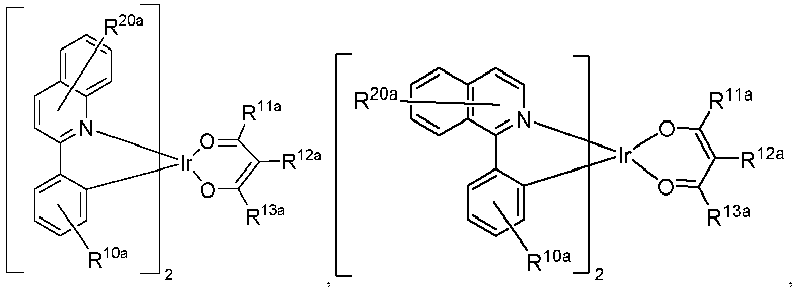 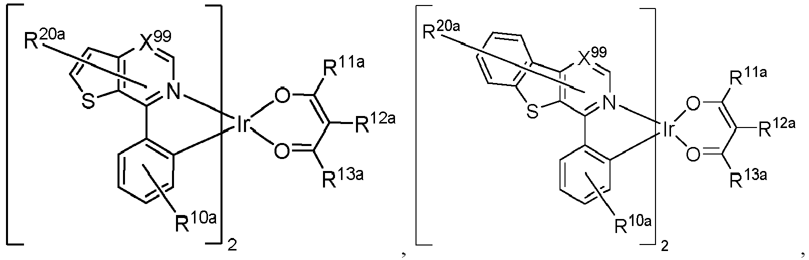 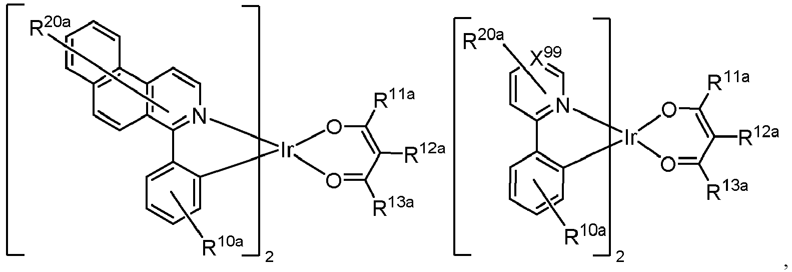 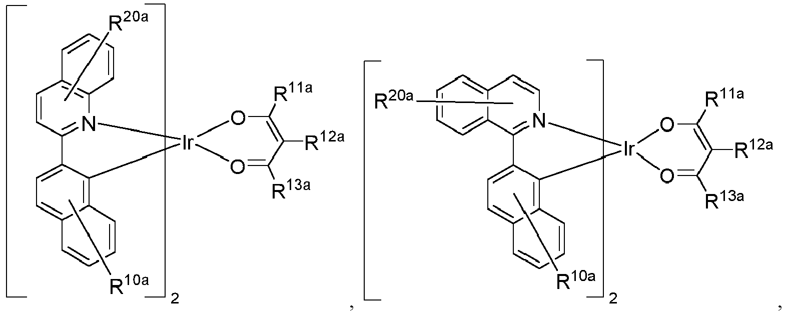 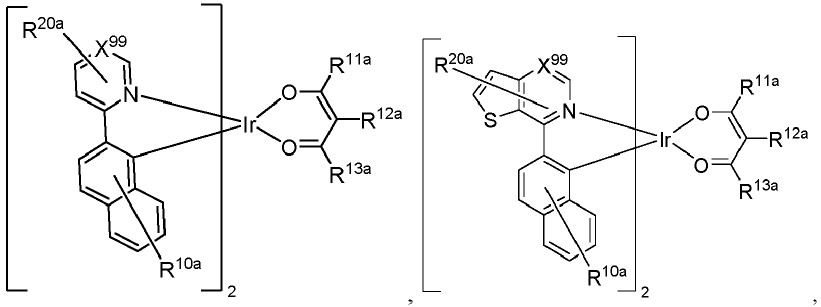 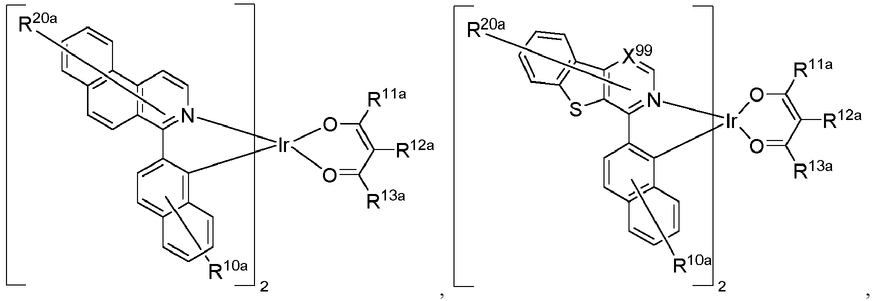 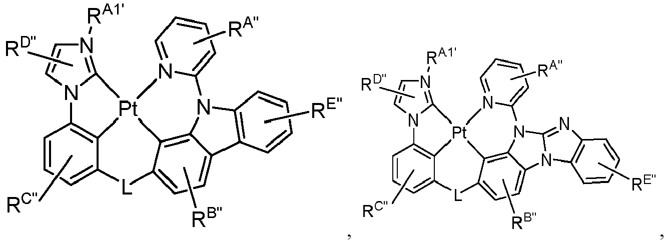 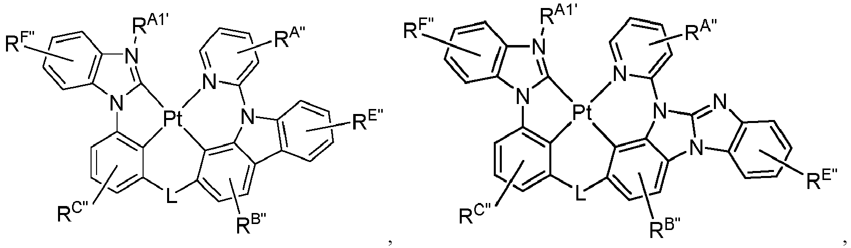 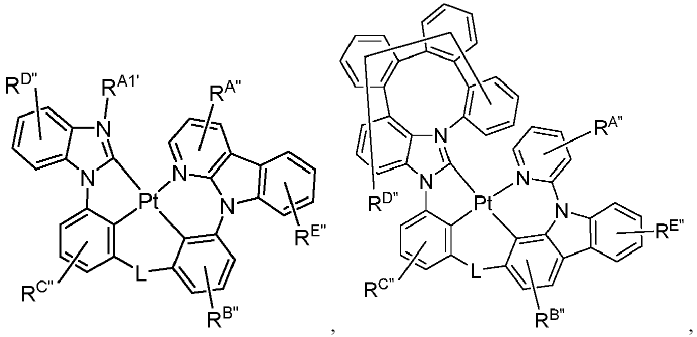 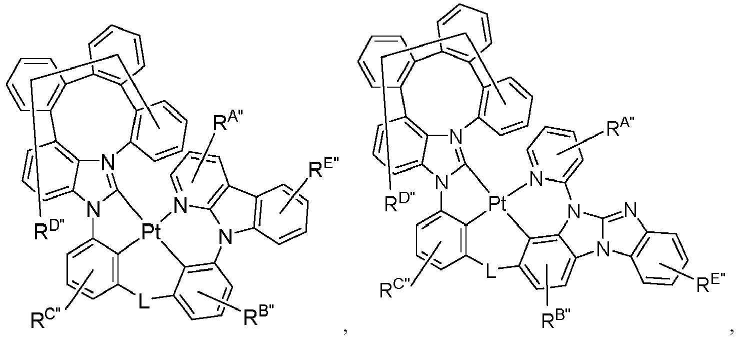 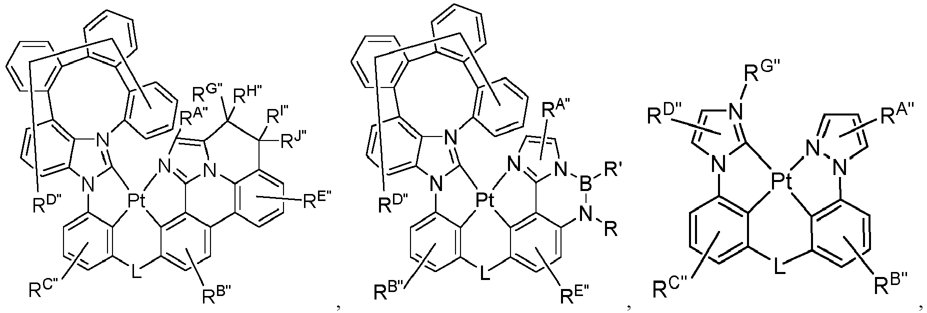 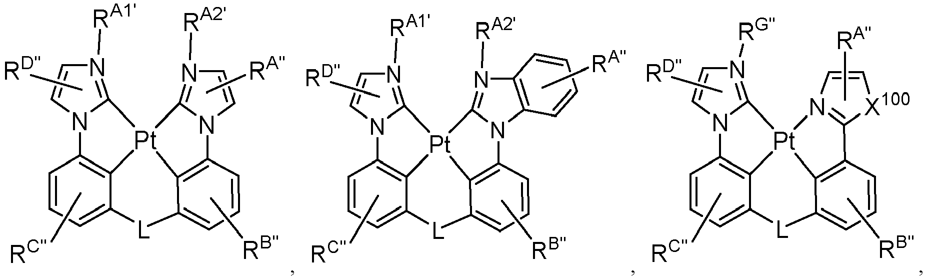 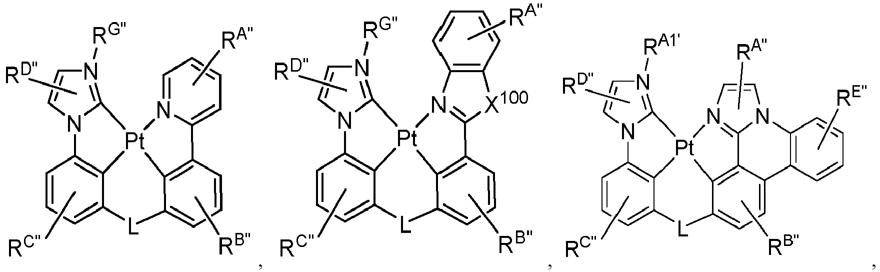 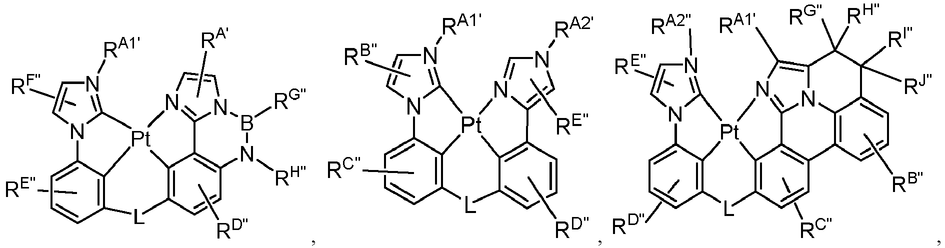 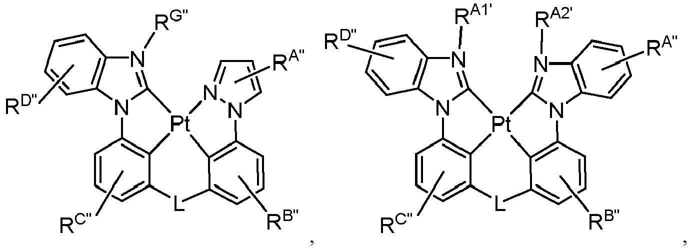 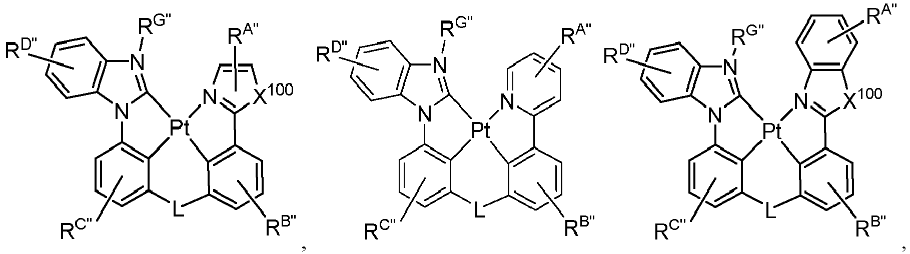 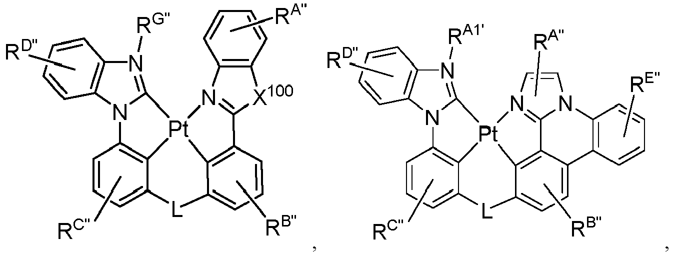 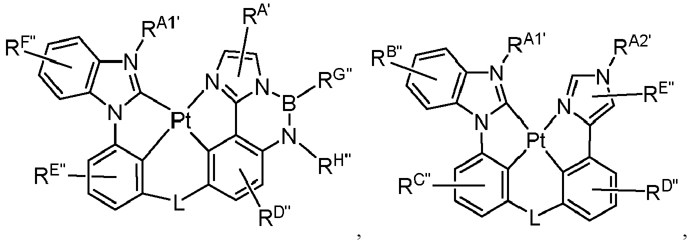 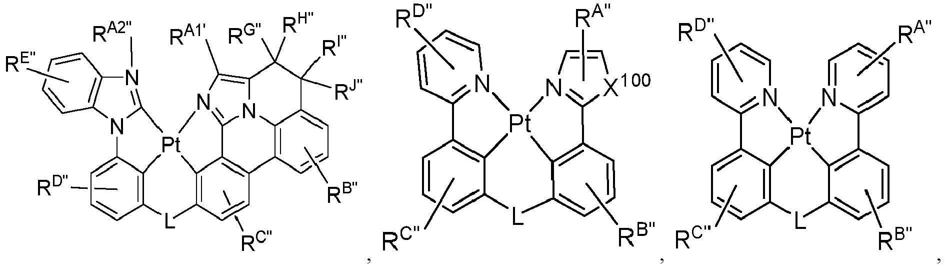 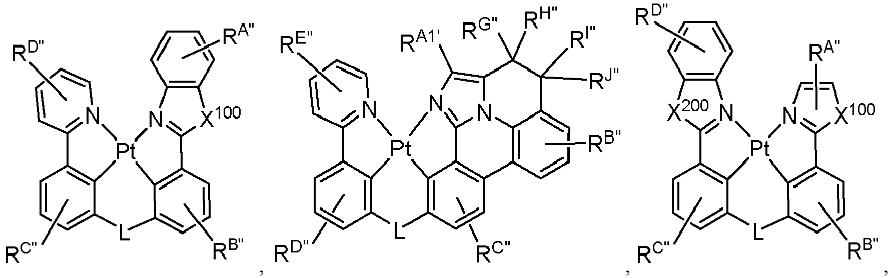 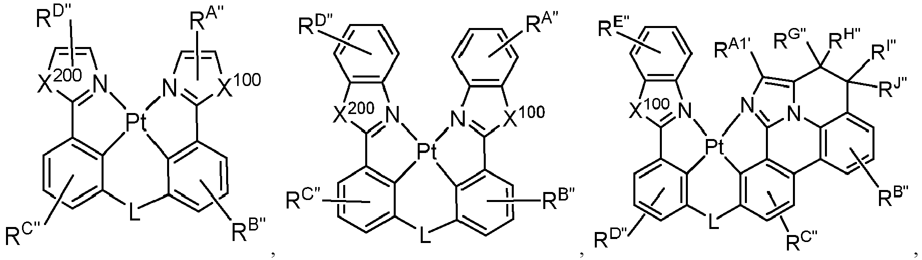 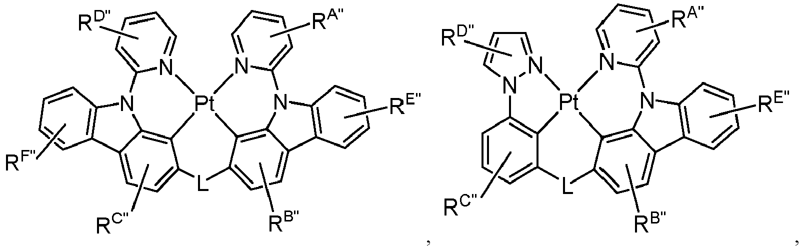 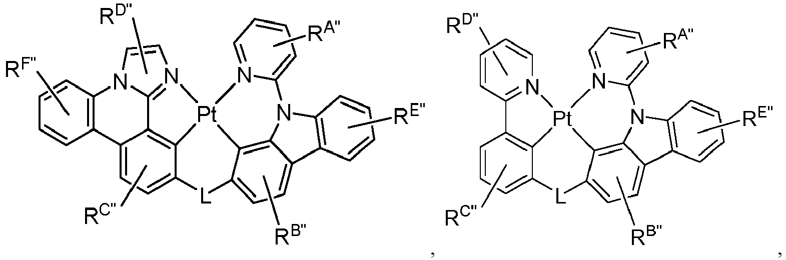 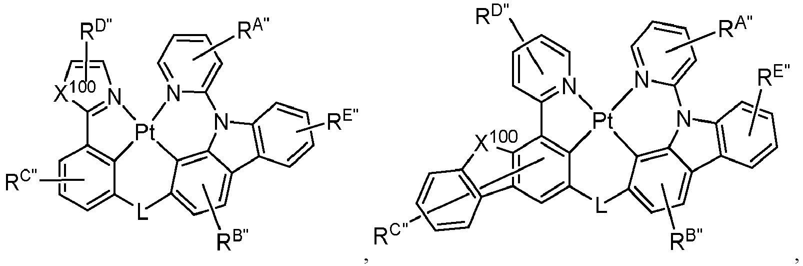 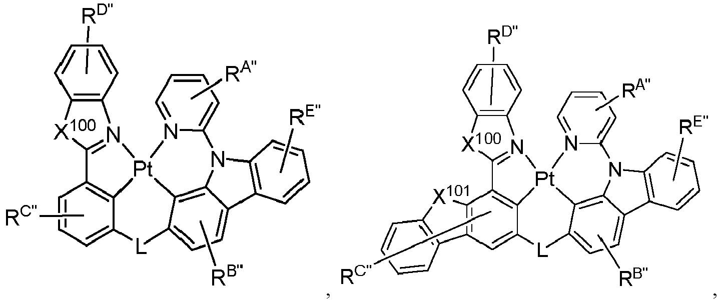 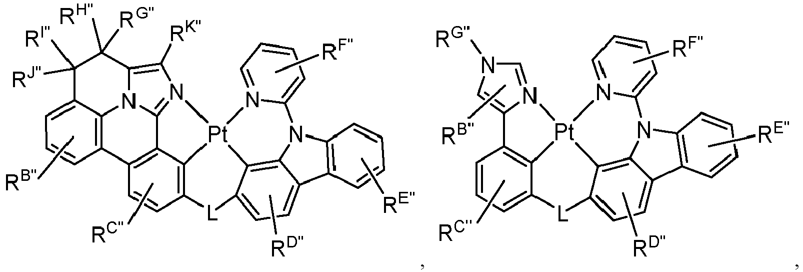 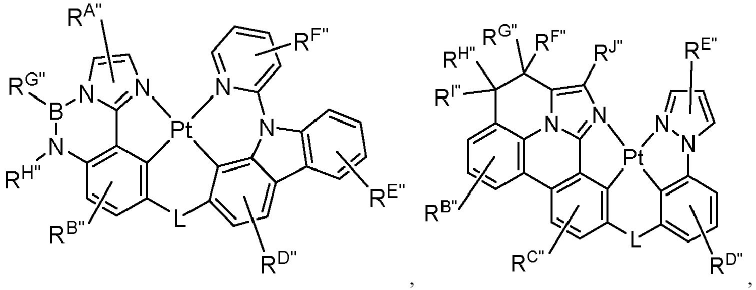 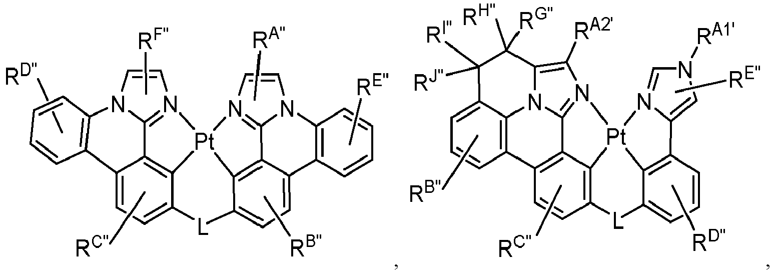 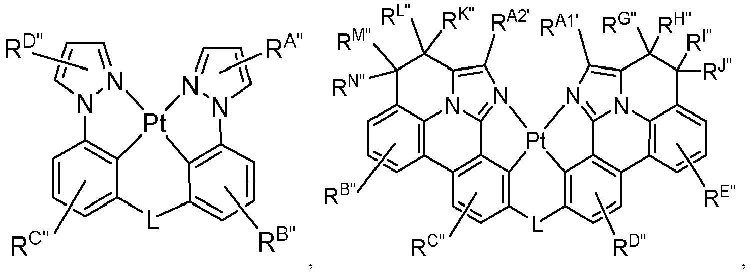 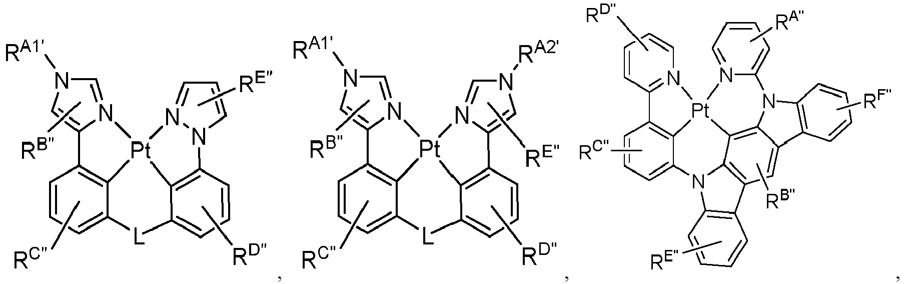 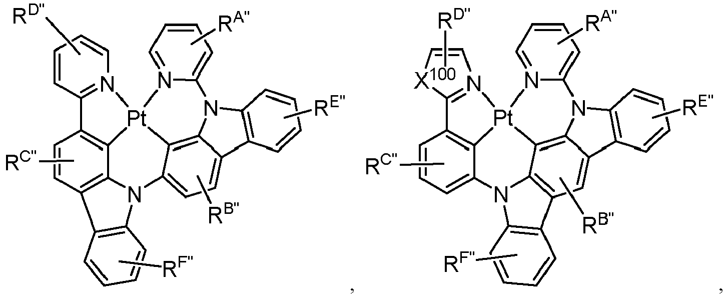 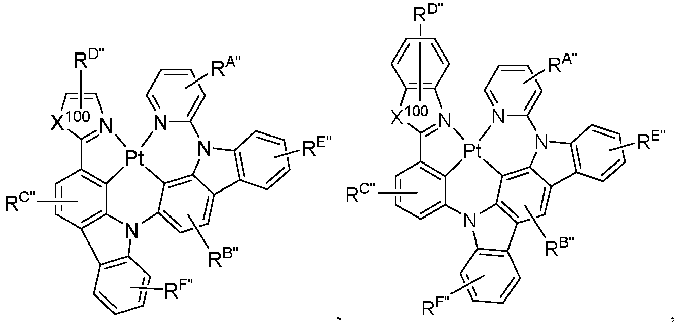 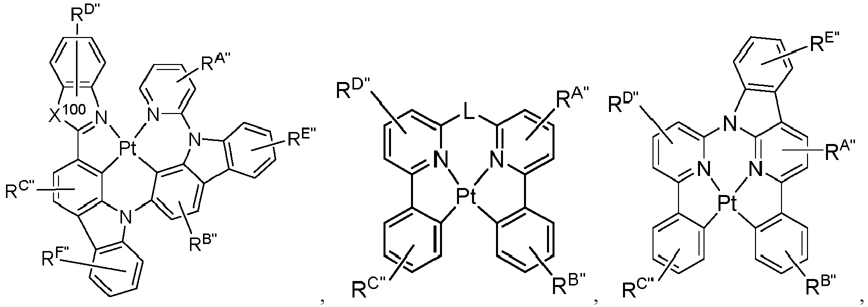 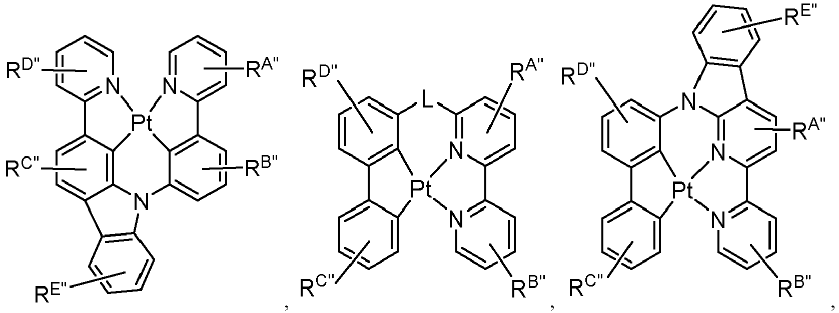 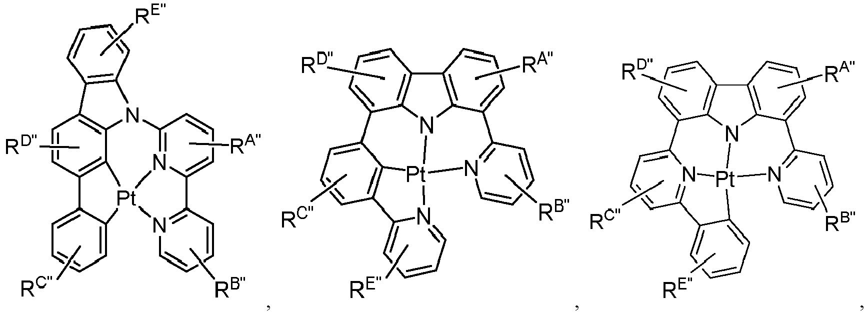 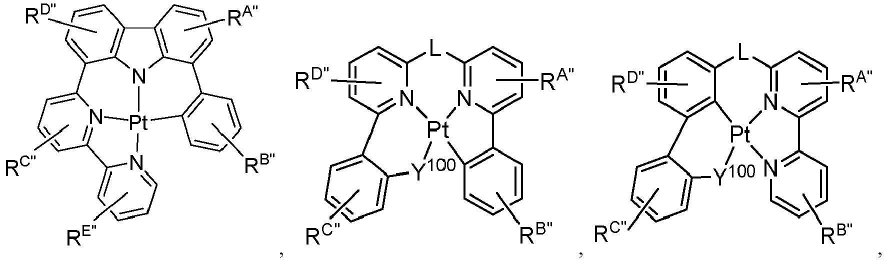 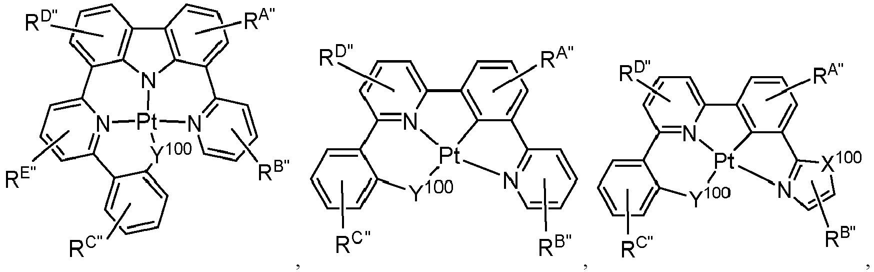 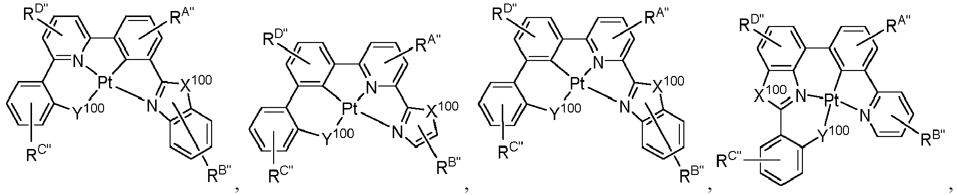 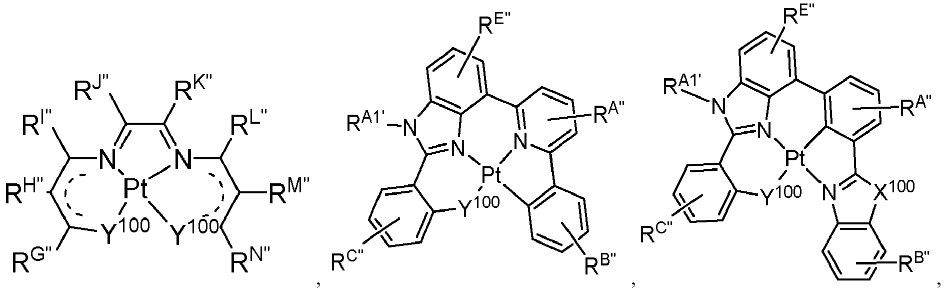 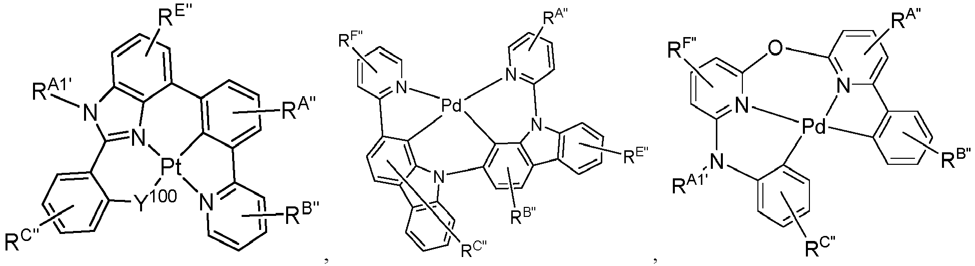 , and 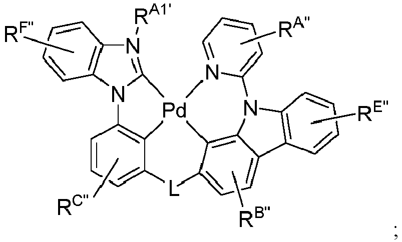
each of X⁹⁶ to X⁹⁹ is independently C or N;
each Y¹⁰⁰ is independently selected from the group consisting of a NR", O, S, and Se;
L is independently selected from the group consisting of a direct bond, BR", BR"R‴, NR", PR", O, S, Se, C=O, C=S, C=Se, C=NR", C=CR"R‴, S=O, SO₂, CR", CR"R‴, SiR"R‴, GeR"R‴, alkyl, cycloalkyl, aryl, heteroaryl, and combinations thereof;
X¹⁰⁰, and X²⁰⁰ for each occurrence is selected from the group consisting of O, S, Se, NR", and CR"R‴;
each R^{10a}, R^{20a}, R^{30a}, R^{40a}, and R^{50a}, R^{A"}, R^{B"}, R^{C"}, R^{D"}, R^{E"}, and R^{F"} independently represents mono-, up to the maximum substitutions, or no substitutions;
each of R, R', R", R‴, R^{10a}, R^{11a}, R^{12a}, R^{13a}, R^{20a}, R^{30a}, R^{40a}, R^{50a}, R⁶⁰, R⁷⁰, R⁹⁷, R⁹⁸, R⁹⁹, R^{A1'}, R^{A2'}, R^{A"}, R^{B"}, R^{C"}, R^{D"}, R^{E"}, R^{F"}, R^{G"}, R^{H"}, R^{I"}, R^{J"}, R^{K"}, R^{L"}, R^{M"}, and R^{N"} is independently a hydrogen or a substituent selected from the group consisting of the general substituents as defined herein; wherein any two substituents can be fused or joined to form into a ring.

In some of the above embodiments, at least one of R, R', R", R‴, R^{10a}, R^{11a}, R^{12a}, R^{13a}, R^{20a}, R^{30a}, R^{40a}, R^{50a}, R⁶⁰, R⁷⁰, R⁹⁷, R⁹⁸, R⁹⁹, R^{A1'}, R^{A2'}, R^{A"}, R^{B"}, R^{C"}, R^{D"}, R^{E"}, R^{F"}, R^{G"}, R^{H"}, R^{I"}, R^{J"} R^{K"}, R^{L"}, R^{M"}, and R^{N"} comprises or is an electron withdrawing group as defined herein.

In some of the above embodiments where the first compound is selected from the group consisting of LIST 2, one or more of R, R', R", R‴, R^{10a}, R^{11a}, R^{12a}, R^{13a}, R^{20a}, R^{30a}, R^{40a}, R^{50a}, R⁶⁰, R⁷⁰, R⁹⁷, R⁹⁸, R⁹⁹, R^{A1'}, R^{A2'}, R^{A"}, R^{B"}, R^{C"}, R^{D"}, R^{E"}, R^{F"}, R^{G"}, R^{H"}, R^{I"}, R^{J"}, R^{K"}, R^{L"}, R^{M"}, and R^{N"} comprises a moiety selected from the group consisting of fully or partially deuterated aryl, fully or partially deuterated alkyl, boryl, silyl, germyl, 2,6-terphenyl, 2-biphenyl, 2-(tert-butyl)phenyl, tetraphenylene, tetrahydronaphthalene, and combinations thereof.

It should be understood that the metal Pt of each of those compounds in LIST 2 can be replaced by Pd, and those derived Pd compounds are also intended to be specifically covered.

In some embodiments, the first compound is selected from the group consisting of: 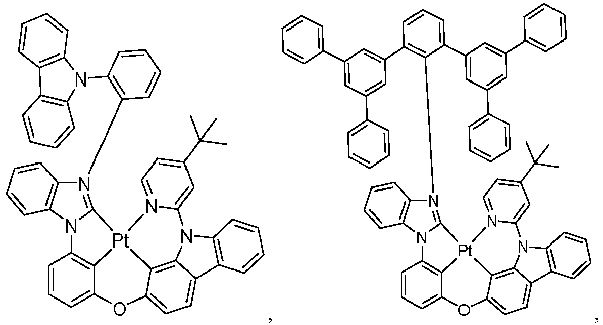 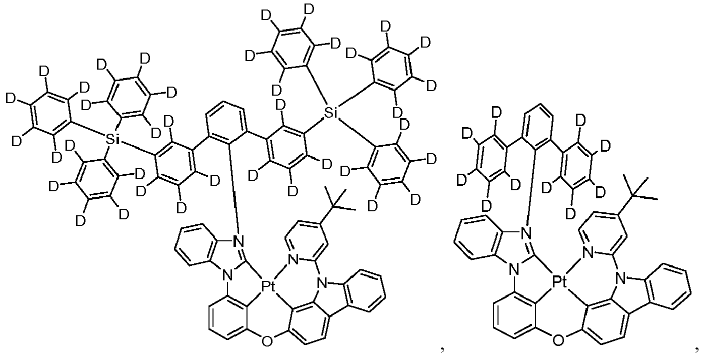 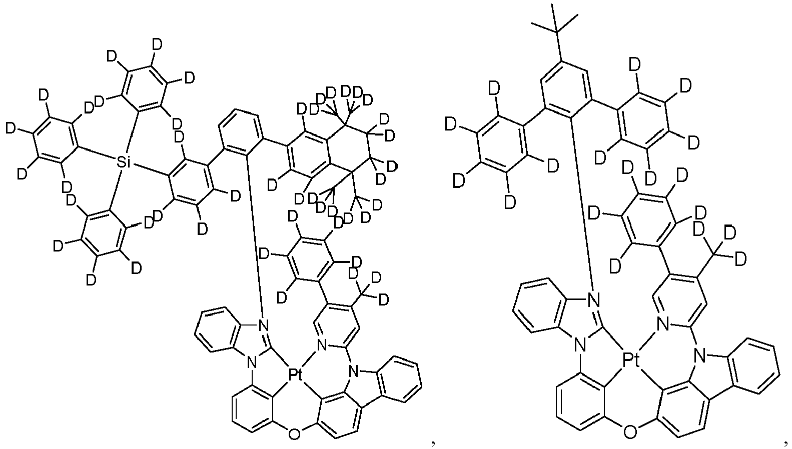 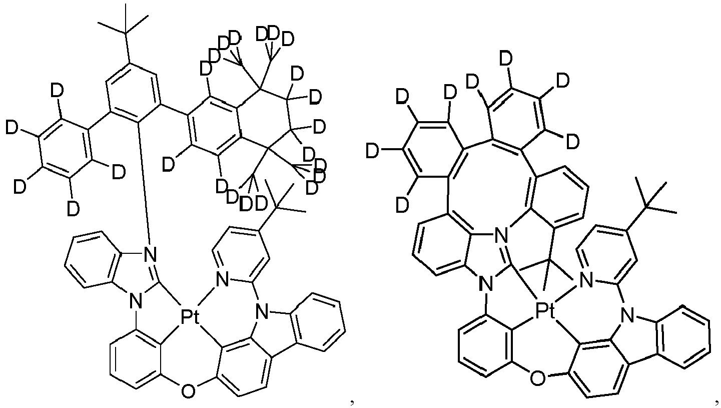 and

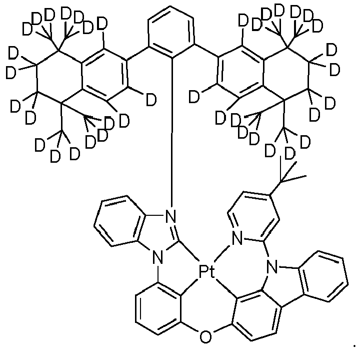

In some embodiments, the first compound is capable of functioning as a phosphorescent emitter, a TADF emitter, or a doublet emitter in an OLED at room temperature. In some embodiments, the second compound is selected from the group consisting of a delayed-fluorescent compound functioning as a TADF emitter in the OLED at room temperature, a fluorescent compound functioning as a fluorescent emitter in the OLED at room temperature. In some embodiments, the fluorescent emitter can be a singlet or doublet emitters. In some of such embodiments, the singlet emitter can also include a TADF emitter, furthermore, a multi-resonant MR-TADF emitter. Description of the delayed fluorescence as used herein can be found in U.S. application publication US20200373510A1, at paragraphs 0083-0084, the entire contents of which are incorporated herein by reference.

In some embodiments of the OLED, the first and second compounds are in separate layers within the emissive region.

In some embodiments, the first and the second compounds are present as a mixture in one or more layers in the emissive region. It should be understood that the mixture in a given layer can be a homogeneous mixture or the compounds in the mixture can be in graded concentrations through the thickness of the given layer. The concentration grading can be linear, non-linear, sinusoidal, etc. When there are more than one layer in the emissive region having a mixture of the sensitizer and the acceptor compounds, the type of mixture (i.e., homogeneous or graded concentration) and the concentration levels of the compounds in the mixture in each of the more than one layer can be the same or different. In addition to the sensitizer and the acceptor compounds, there can be one or more other functional compounds such as, but not limit to, hosts also mixed into the mixture.

In some embodiments, the second compound can be in two or more layers with the same or different concentration. In some embodiments, when two or more layers contain the second compound, the concentration of the second compound in at least two of the two or more layers are different. In some embodiments, the concentration of the first compound in the layer containing the first compound is in the range of 1 to 50 %, 10 to 20 %, or 12-15 % by weight. In some embodiments, the concentration of the second compound in the layer containing the second compound is in the range of 0.1 to 10 %, 0.5 to 5 %, or 1 to 3 % by weight.

In some embodiments, the emissive region contains *N* layers where N > 2. In some embodiments, the first compound is present in each of the N layers, and the second compound is contained in fewer than or equal to *N*-1 layers. In some embodiments, the first compound is present in each of the *N* layers, and the second compound is contained in fewer than or equal to *N*/2 layers. In some embodiments, the second compound is present in each of the *N* layers, and the first compound is contained in fewer than or equal to *N*-1 layers. In some embodiments, the second compound is present in each of the *N* layers, and the first compound is contained in fewer than or equal to *N*/2 layers.

In some embodiments, the OLED emits a luminescent emission comprising an emission component from the S₁ energy (the first singlet energy) of the second compound when a voltage is applied across the OLED. In some embodiments, at least 65%, 75%, 85%, or 95% of the emission from the OLED is produced from the second compound with a luminance of at least 10 cd/m². In some embodiments, S₁ energy of the second compound is lower than that of the first compound.

In some embodiments, a T₁ energy (the first triplet energy) of the host compound is greater than or equal to the T₁ energies of the first compound and the second compound, and the T₁ energy of the first compound is greater than or equal to the S₁ energy (the first singlet energy) of the second compound. In some embodiments, S₁-T₁ energy gap of the first compound, and/or the second compound, and/or first host compound, and/or second host compound is less than 400, 300, 250, 200, 150, 100, or 50 meV. In some embodiments, the absolute energy difference between the HOMO of the first compound and the HOMO of the second compound is less than 0.6, 0.5, 0.4, 0.3, or 0.2 eV. In some embodiments, the absolute energy difference between the LUMO of the first compound and the LUMO of the second compound is less than 0.6, 0.5, 0.4, 0.3, or 0.2 eV.

In some embodiments where the first compound provides unicolored sensitization (i.e., minimal loss in energy upon energy transfer to the second compound), the second compound has a Stokes shift of 30, 25, 20, 15, or 10 nm or less. An example would be a broad blue phosphor sensitizing a narrow blue emitting acceptor.

In some embodiments where the first compound provides a down conversion process (e.g., a blue emitter being used to sensitize a green emitter, or a green emitter being used to sensitize a red emitter), the second compound has a Stokes shift of 30, 40, 60, 80, or 100 nm or more.

In some embodiments, the difference between λmax of the emission spectrum of the first compound and λmax of the absorption spectrum of the second compound is 50, 40, 30, or 20 nm or less. In some embodiments, the spectral overlap of the light absorbing area of the second compound and the light emitting area of the first compound relative to the light emitting area of the first compound, is greater than 5%, 10%, 15%, 20%, 30%, 40%, 50%, or more.

One way to quantify the qualitative relationship between a sensitizer compound (a compound to be used as the sensitizer in the emissive region of the OLED of the present disclosure) and an acceptor compound (a compound to be used as the acceptor in the emissive region of the OLED of the present disclosure) is by determining a value Δλ = λₘₐₓ₁ - λₘₐₓ₂, where λₘₐₓ₁ and λₘₐₓ₂ are defined as follows, λₘₐₓ₁ is the emission maximum of the sensitizer compound at room temperature when the sensitizer compound is used as the sole emitter in a first monochromic OLED (an OLED that emits only one color) that has a first host. λₘₐₓ₂ is the emission maximum of the acceptor compound at room temperature when the acceptor compound is used as the sole emitter in a second monochromic OLED that has the same first host.

In some embodiments of the OLED of the present disclosure where the first compound provides unicolored sensitization (i.e., minimal loss in energy upon energy transfer to the second compound), Δλ (determined as described above) is equal to or less than the number selected from the group consisting of 15, 12, 10, 8, 6, 4, 2, 0, -2, -4, -6, -8, and -10 nm.

In some embodiments, a spectral overlap integral of the first compound and the second compound is at least 10¹⁴ nm^{4*}L/cm*mol. In some embodiments, a spectral overlap integral of the first compound and the second compound is at least 5 × 10¹⁴ nm^{4*}L/cm*mol. In some embodiments, a spectral overlap integral of the first compound and the second compound is at least 10¹⁵ nm^{4*}L/cm*mol.

As used herein, "spectral overlap integral" is determined by multiplying the second compound extinction spectrum by the first compound emission spectrum normalized with respect to the area under the curve. The higher the spectral overlap, the better the Förster Resonance Energy Transfer (FRET) efficiency. The rate of FRET is proportional to the spectral overlap integral. Therefore, a high spectral overlap can help improve the FRET efficiency and reduce the exciton lifetime in an OLED.

In some embodiments, the second compound and the first compound are selected in order to increase the spectral overlap. Increasing the spectral overlap can be achieved in several ways, for example, increasing the oscillator strength of the second compound, minimizing the distance between the first compound peak emission intensity and the second compound absorption peak, and narrowing the line shape of the first compound emission or the second compound absorption. In some embodiments, the oscillator strength of the second compound is greater than or equal to 0.1.

In some embodiments where the emission of the second compound is redshifted by the sensitization, the absolute value of Δλ is equal to or greater than the number selected from the group consisting of 20, 30, 40, 60, 80, 100 nm.

In some embodiments, the sensitizer (the first compound) and/or the acceptor (the second compound) can be a phosphorescent or fluorescent emitter. Phosphorescence generally refers to emission of a photon with a change in electron spin quantum number, i.e., the initial and final states of the emission have different electron spin quantum numbers, such as from T1 to S0 state. Ir and Pt complexes currently widely used in the OLED belong to phosphorescent emitters. In some embodiments, if an exciplex formation involves a triplet emitter, such exciplex can also emit phosphorescent light. On the other hand, fluorescent emitters generally refer to emission of a photon without a change in electron spin quantum number, such as from S1 to S0 state, or from D1 to D0 state. Fluorescent emitters can be delayed fluorescent or non-delayed fluorescent emitters. Depending on the spin state, fluorescent emitter can be a singlet emitter or a doublet emitter, or other multiplet emitter. It is believed that the internal quantum efficiency (IQE) of fluorescent OLEDs can exceed the 25% spin statistics limit through delayed fluorescence. There are two types of delayed fluorescence, i.e., P-type and E-type delayed fluorescence. P-type delayed fluorescence is generated from triplet-triplet annihilation (TTA). On the other hand, E-type delayed fluorescence does not rely on the collision of two triplets, but rather on the thermal population between the triplet states and the singlet excited states. Thermal energy can activate the transition from the triplet state back to the singlet state. This type of delayed fluorescence is also known as thermally activated delayed fluorescence (TADF). E-type delayed fluorescence characteristics can be found in an exciplex system or in a single compound. Without being bound by theory, it is believed that TADF requires a compound or an exciplex having a small singlet-triplet energy gap (ΔE_{S-T}) less than or equal to 400, 350, 300, 250, 200, 150, 100, or 50 meV. There are two major types of TADF emitters, one is called donor-acceptor type TADF, the other one is called multiple resonance (MR) TADF. Often, donor-acceptor single compounds are constructed by connecting an electron donor moiety such as amino- or carbazole-derivatives and an electron acceptor moiety such as N-containing six-membered aromatic rings or cyanosubstituted aromatic rings. Donor-acceptor exciplex can be formed between a hole transporting compound and an electron transporting compound. The examples for MR-TADF include highly conjugated fused ring systems. In some embodiments, MR-TADF materials comprising boron, carbon, and nitrogen atoms. They may comprise other atoms as well, for example oxygen. In some embodiments, the reverse intersystem crossing time from T1 to S1 of the delayed fluorescent emission at 293K is less than or equal to 10 microseconds. In some embodiments, such time can be greater than 10 microseconds and less than 100 microseconds.

In some embodiments, at least one of the following conditions is true:
(1) the first compound is capable of functioning as a TADF emitter in an OLED at room temperature.
(2) the second compound is a delayed-fluorescent compound functioning as a TADF emitter in said OLED at room temperature.

In some embodiments, the TADF emitter comprises at least one donor group and at least one acceptor group. In some embodiments, the TADF emitter is a metal complex. In some embodiments, the TADF emitter is a non-metal complex. In some embodiments, the TADF emitter is a boron-containing compound. In some embodiments, the TADF emitter is a Cu, Zn, Zr, Ag, or Au complex.

In some embodiments of the OLED, the TADF emitter has the formula of M(L⁵)(L⁶), wherein M is Cu, Ag, or Au, L⁵ and L⁶ are different, and L⁵ and L⁶ are independently selected from the group consisting of: 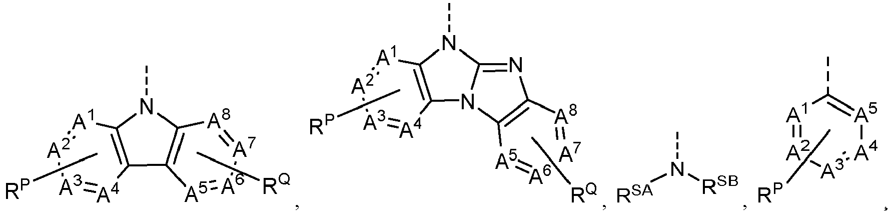 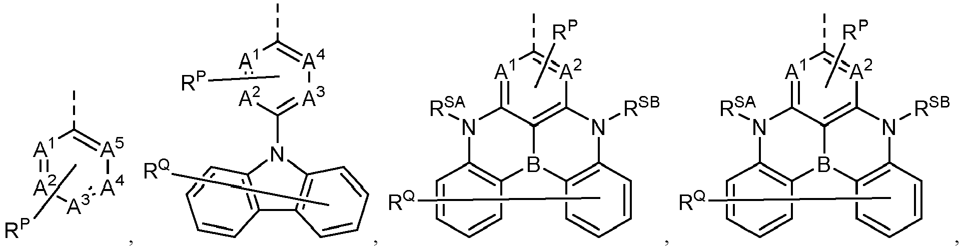 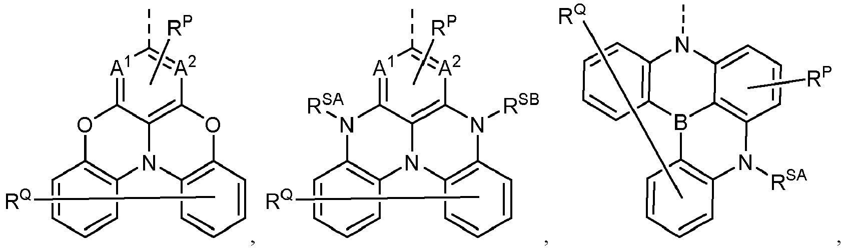 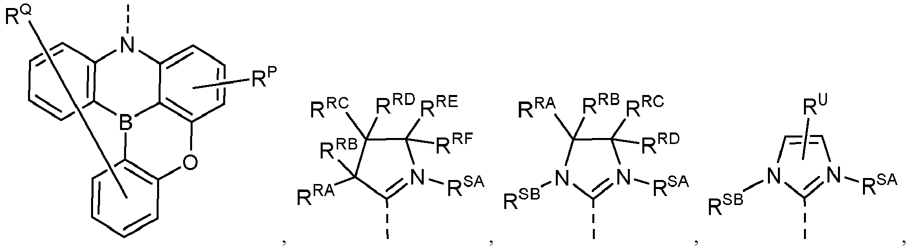 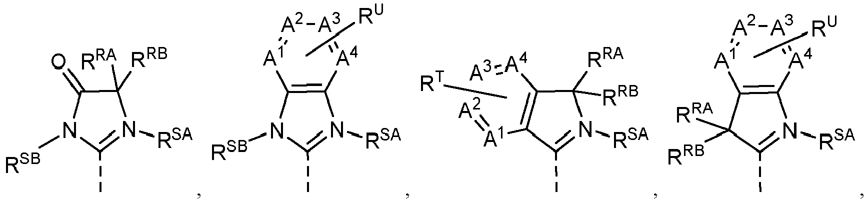 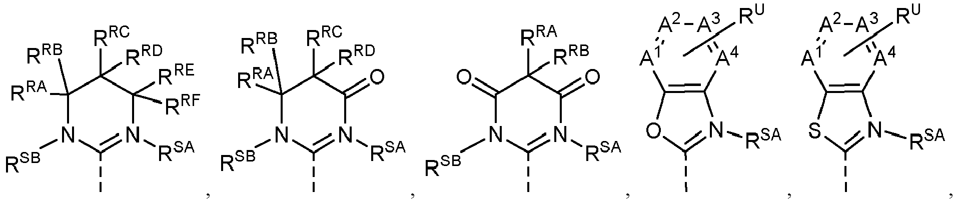 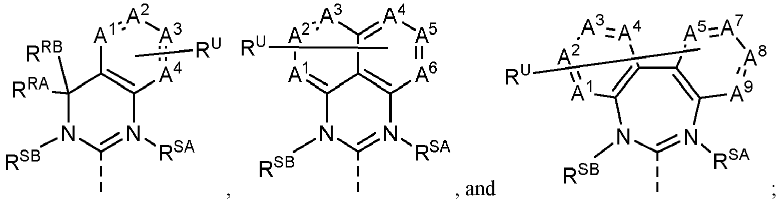
wherein A¹ - A⁹ are each independently selected from C or N;
each R^{P}, R^{Q}, and R^{U} independently represents mono-, up to the maximum substitutions, or no substitutions; wherein each R^{P}, R^{P}, R^{U}, R^{SA}, R^{SB}, R^{RA}, R^{RB}, R^{RC}, R^{RD}, R^{RE}, and R^{RF} is independently a hydrogen or a substituent selected from the group consisting of the general substituents as defined herein; any two substituents can be joined or fused to form a ring.

In some embodiments of the OLED, the TADF emitter may be one of the following: 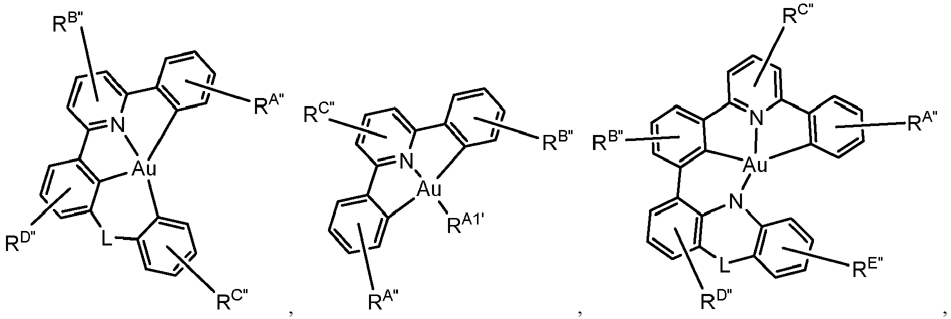 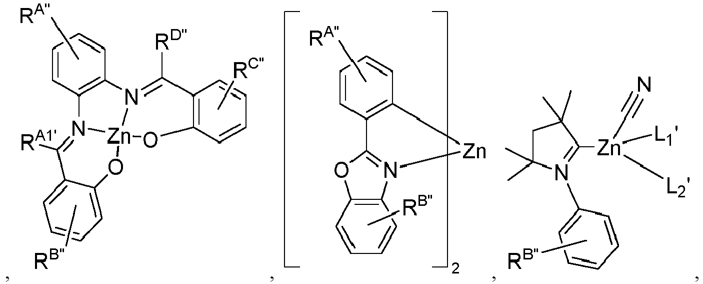 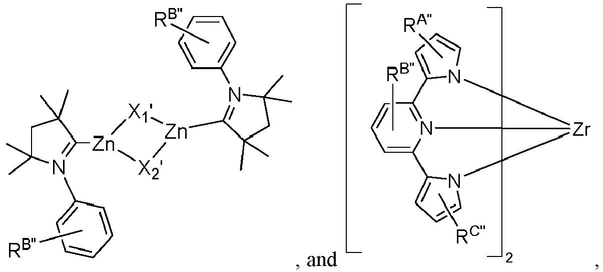
wherein each R^{A"}, R^{B"}, R^{C"}, R^{D"}, R^{E"}, and R^{F"} can independently represent from mono to the maximum possible number of substitutions, or no substitution;
each R", R‴, R^{A1}, R^{A"}, R^{B"}, R^{C"}, R^{D"}, R^{E"}, and R^{F"} is independently a hydrogen or a substituent selected from the group consisting of the general substituents as defined herein; wherein any two substituents can be fused or joined to form into a ring.
wherein L is independently selected from the group consisting of a direct bond, BR", BR"R‴, NR", PR", O, S, Se, C=O, C=S, C=Se, C=NR", C=CR"R‴, S=O, SO₂, CR", CR"R‴, SiR"R‴, GeR"R‴, alkyl, cycloalkyl, aryl, heteroaryl, and combinations thereof;
wherein each of L₁^{'} and L₂^{'} is a monodentate anionic ligand,
wherein each of X₁' and X₂' is a halide; and
wherein any two substituents can be fused or joined to form a ring.

In some embodiments of the OLED, the TADF emitter is selected from the group consisting of the structures in the following TADF LIST: 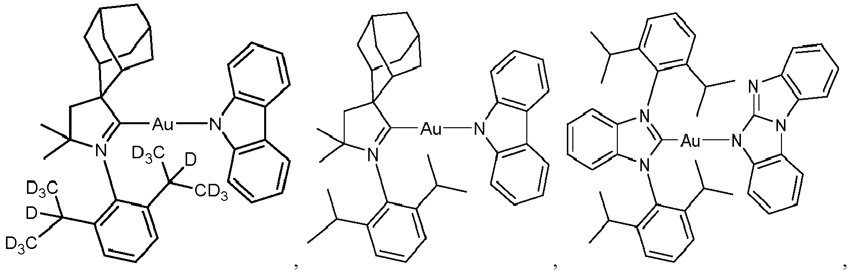 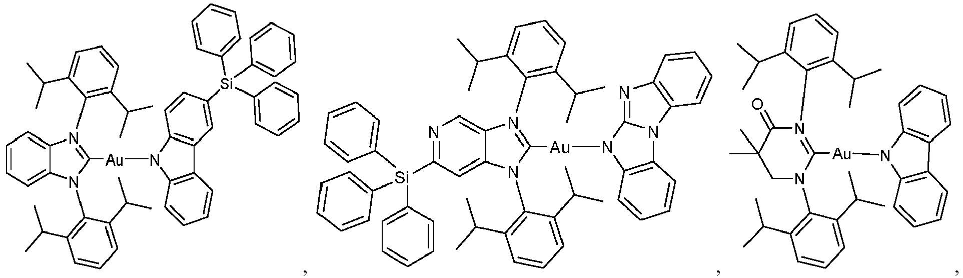 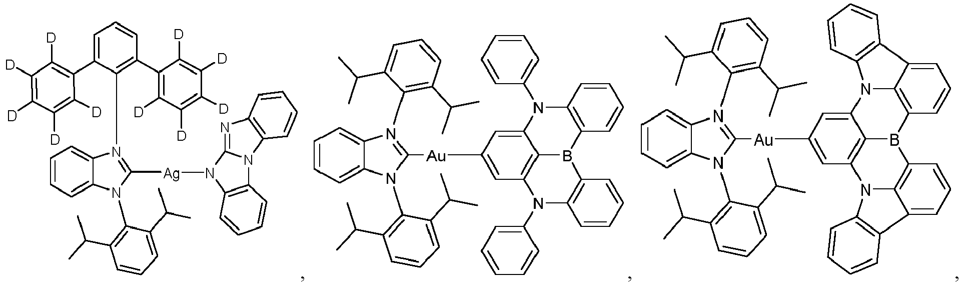 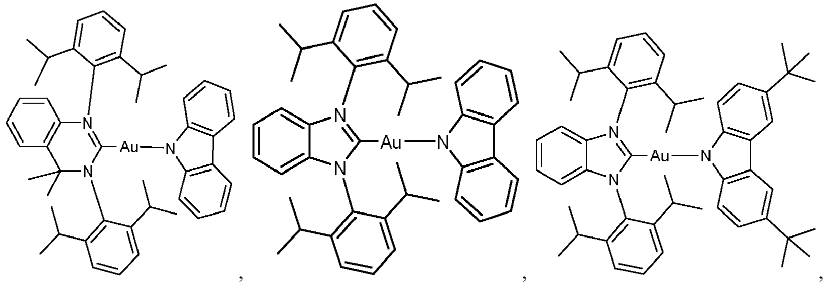 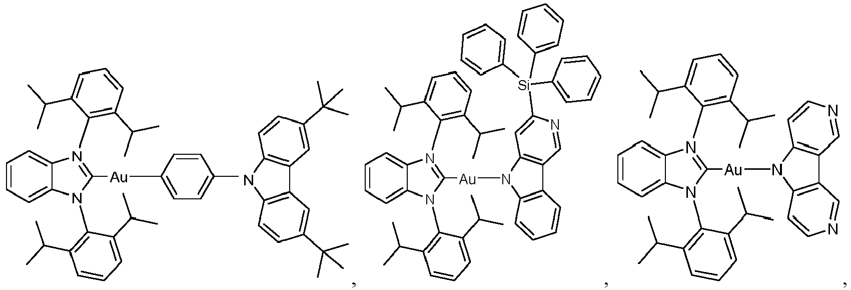 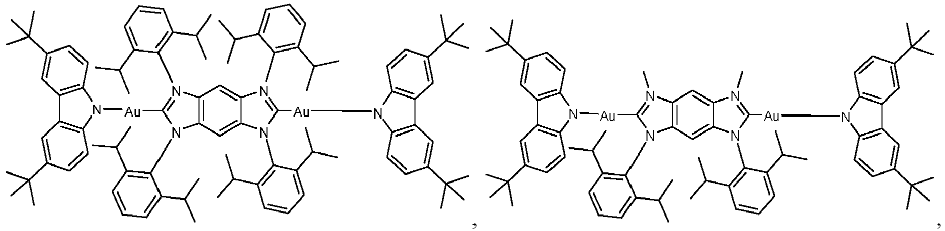 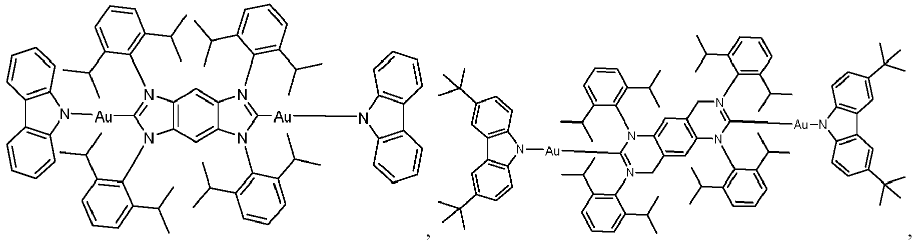 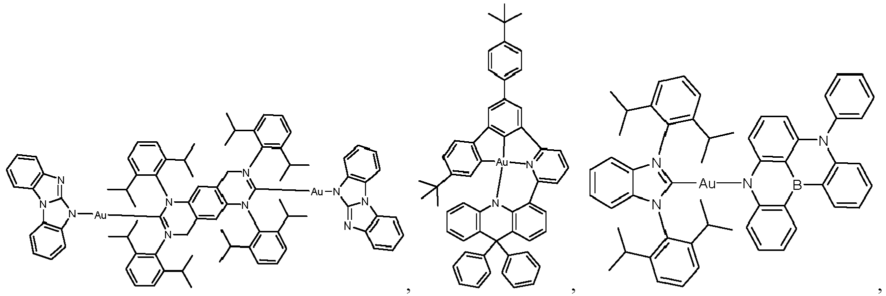 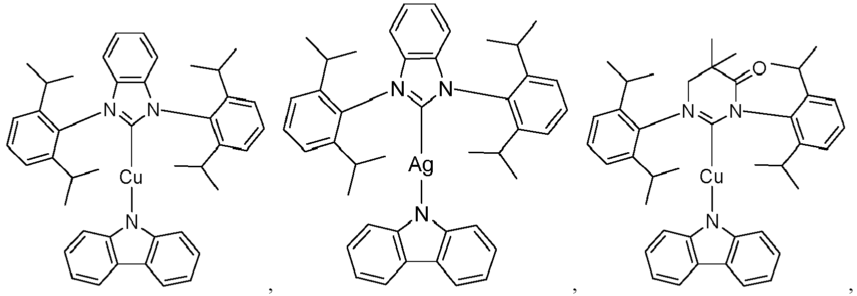 and

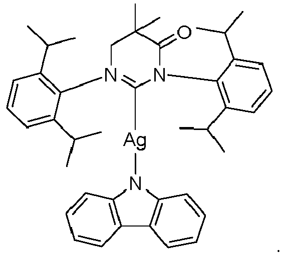

In some embodiments of the OLED, the TADF emitter comprises a boron atom. In some embodiments of the OLED, the TADF emitter comprises at least one of the donor moieties selected from the group consisting of: 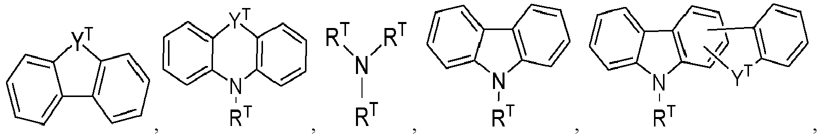 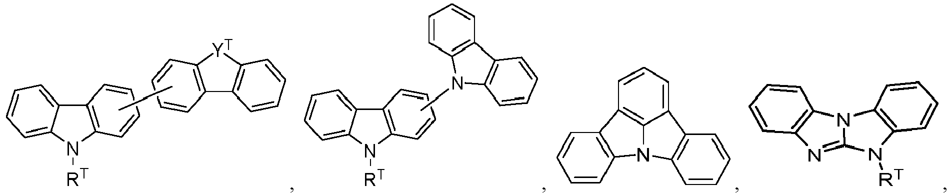 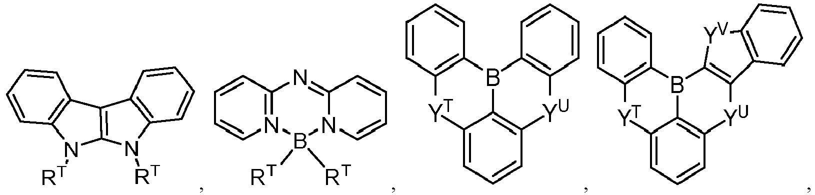 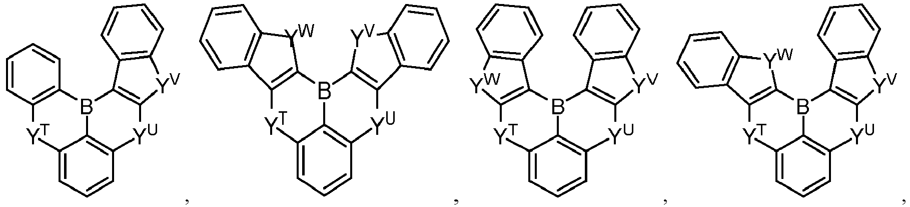 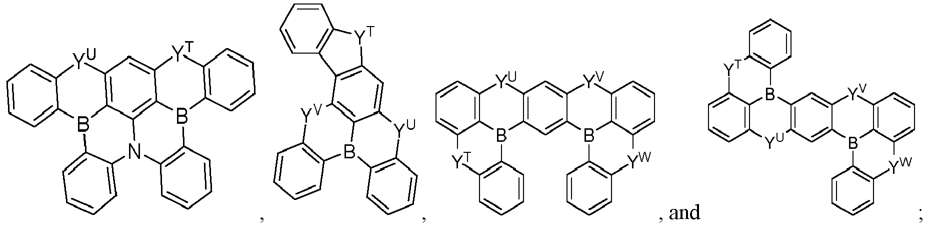
wherein Y^{T}, Y^{U}, Y^{V}, and Y^{W} are each independently selected from the group consisting of BR, NR, PR, O, S, Se, C=O, S=O, SO₂, BRR', CRR', SiRR', and GeRR';
wherein each R^{T} can be the same or different and each R^{T} is independently a donor, an acceptor group, an organic linker bonded to a donor, an organic linker bonded to an acceptor group, or a terminal group selected from the group consisting of alkyl, cycloalkyl, heteroalkyl, heterocycloalkyl, arylalkyl, aryl, heteroaryl, and combinations thereof; and
R, and R' are each independently a hydrogen or a substituent selected from the group consisting of the general substituents as defined herein.

In some of the above embodiments, any carbon ring atoms up to maximum of a total number of three, together with their substituents, in each phenyl ring of any of above structures can be replaced with N.

In some embodiments, the TADF emitter comprises at least one of the acceptor moieties selected from the group consisting of nitrile, isonitrile, borane, fluoride, pyridine, pyrimidine, pyrazine, triazine, aza-carbazole, aza-dibenzothiophene, aza-dibenzofuran, aza-dibenzoselenophene, aza-triphenylene, imidazole, pyrazole, oxazole, thiazole, isoxazole, isothiazole, triazole, thiadiazole, and oxadiazole. In some embodiments, the acceptor moieties and the donor moieties as described herein can be connected directly, through a conjugated linker, or a nonconjugated linker, such as a sp3 carbon or silicon atom.

In some embodiments, the acceptor is a fluorescent compound functioning as an emitter in the OLED at room temperature. In some embodiments, the fluorescent compound comprises at least one of the chemical moieties selected from the group consisting of: 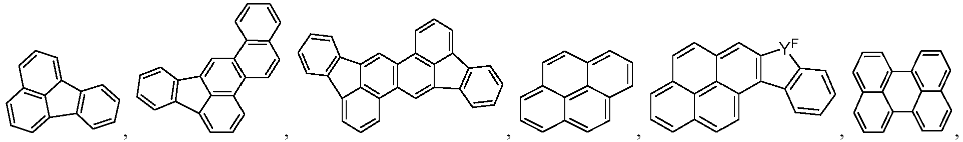 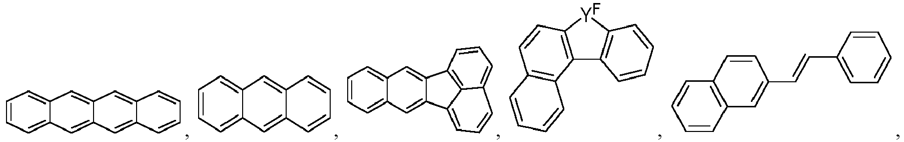 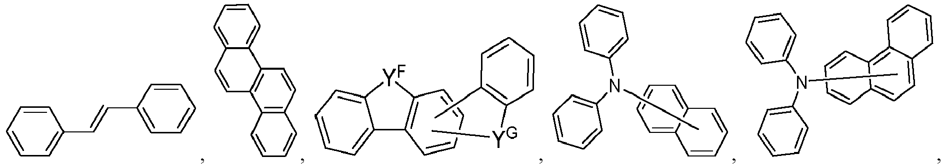 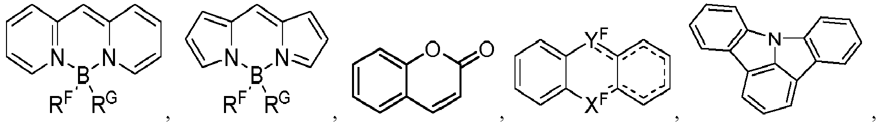 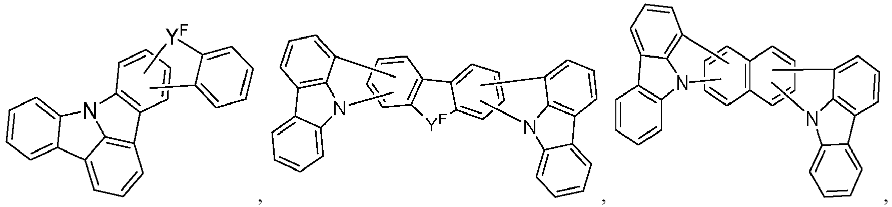 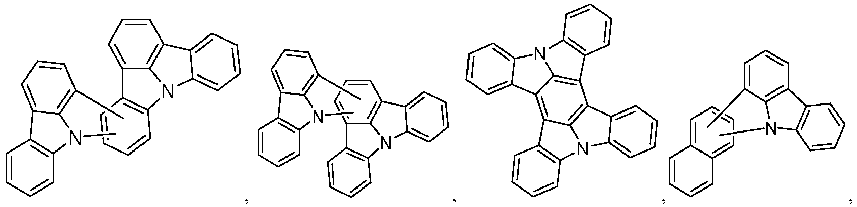 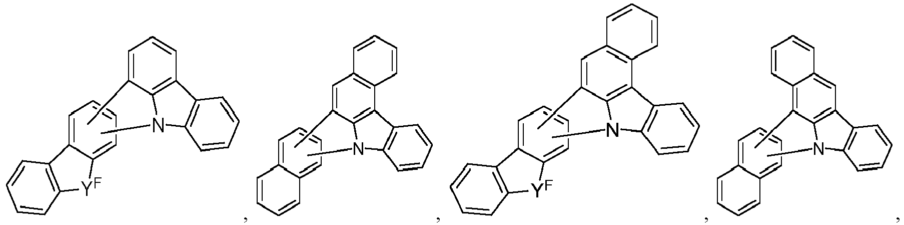 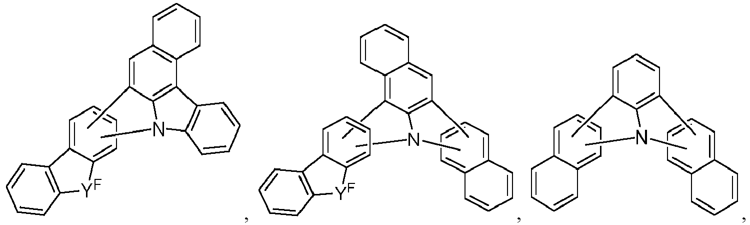 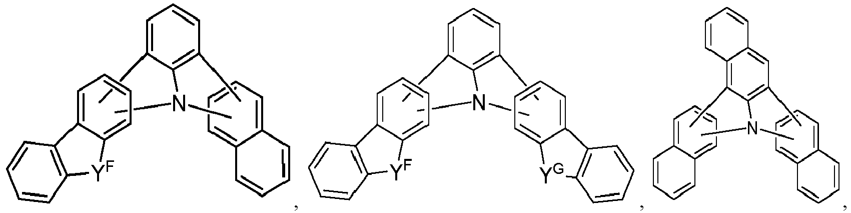 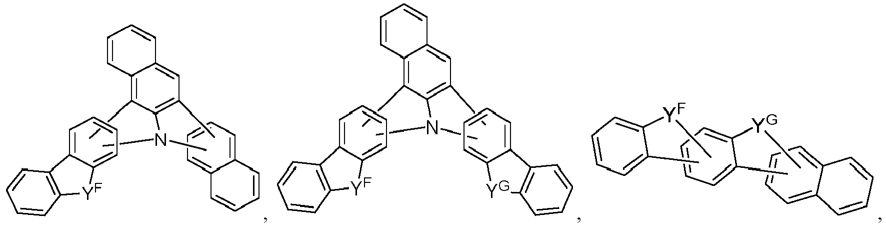 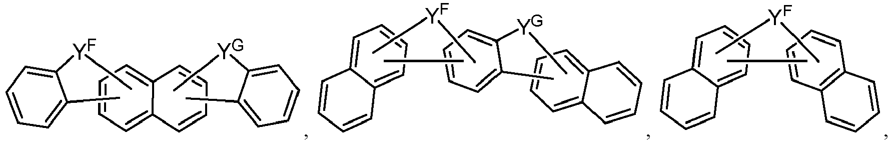 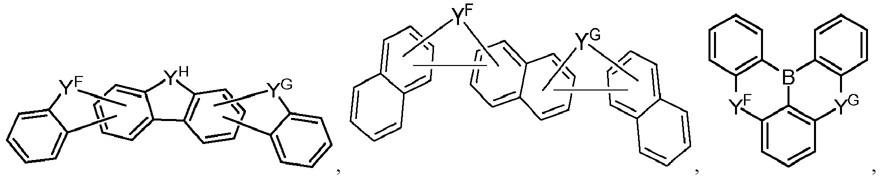 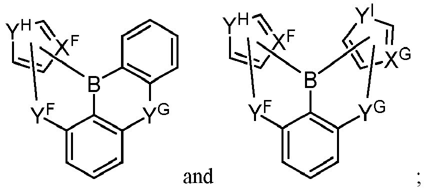
wherein Y^{F}, Y^{G}, Y^{H}, and Y^{I} are each independently selected from the group consisting of BR, NR, PR, O, S, Se, C=O, S=O, SOz, BRR', CRR', SiRR', and GeRR';
wherein X^{F} and X^{G} are each independently selected from the group consisting of C and N; and
wherein R^{F}, R^{G}, R, and R' are each independently a hydrogen or a substituent selected from the group consisting of the General Substituents as defined herein.

In some of the above embodiments, any carbon ring atoms up to maximum of a total number of three, together with their substituents, in each phenyl ring of any of above structures can be replaced with N.

In some embodiments, the second compound is selected from the group consisting of: 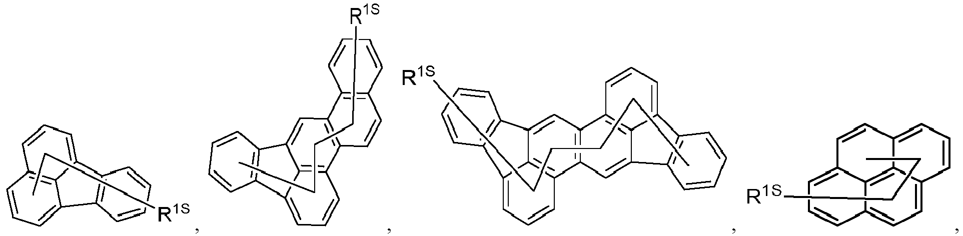 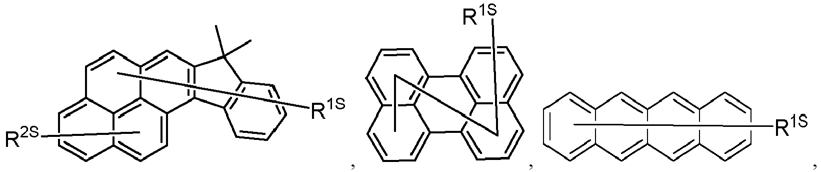 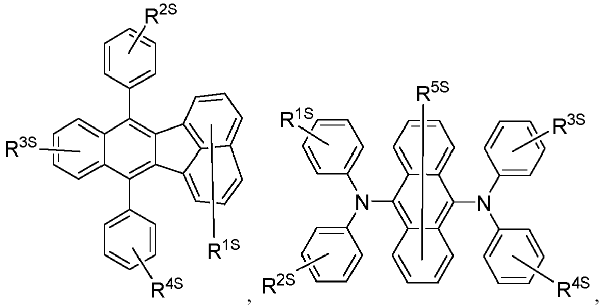 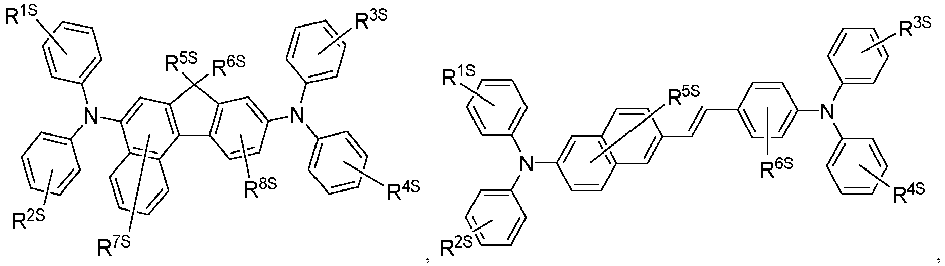 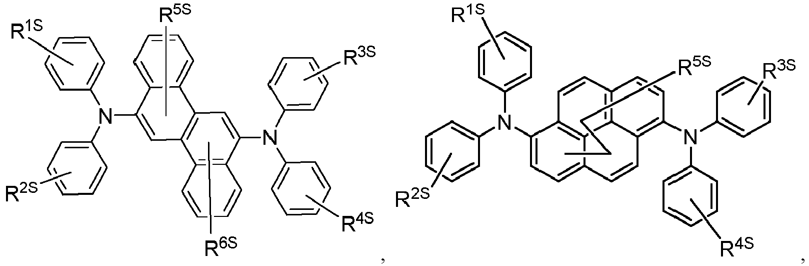 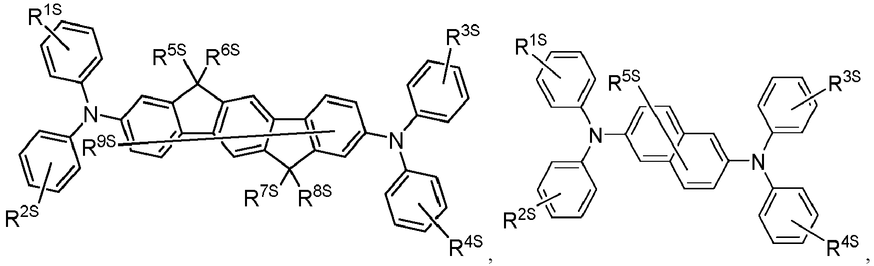 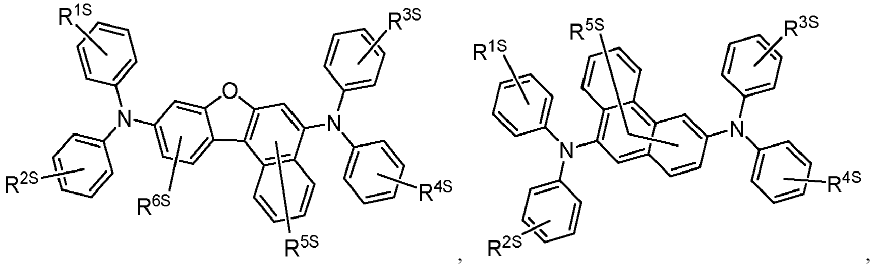 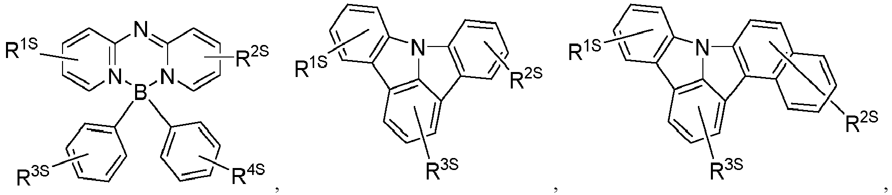 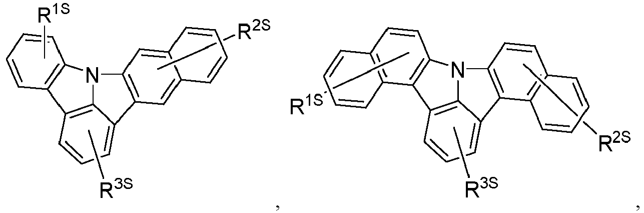 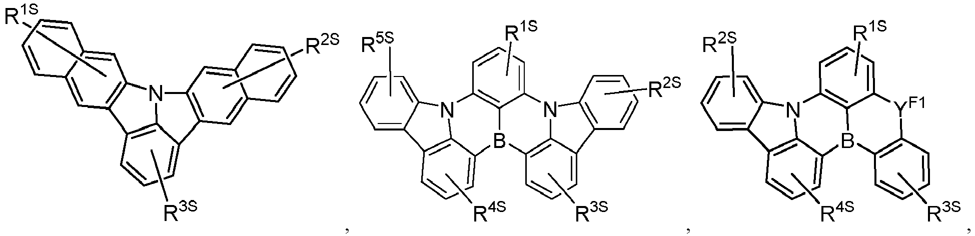 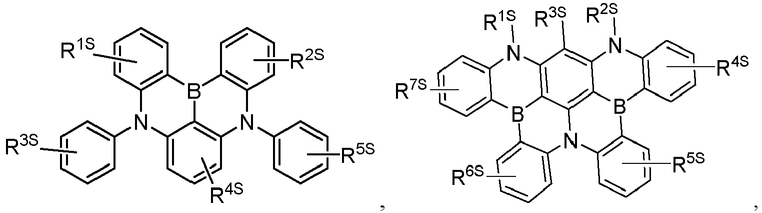 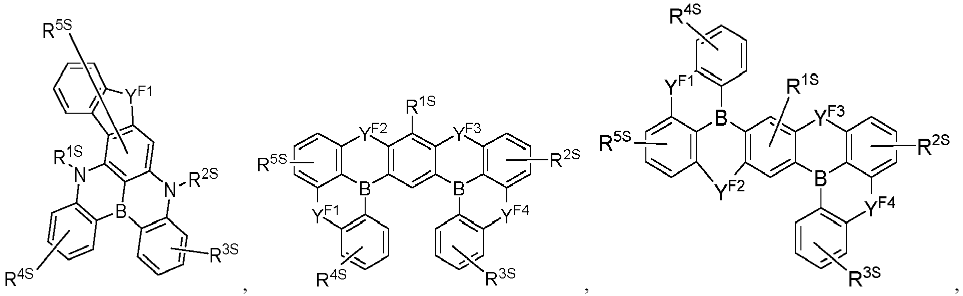 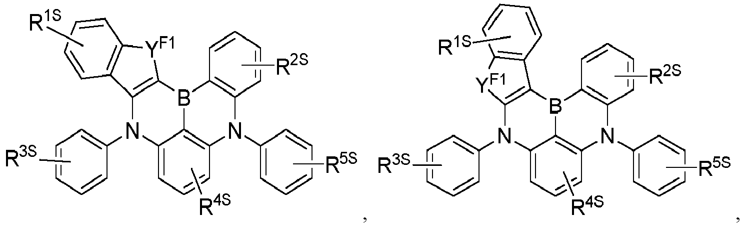 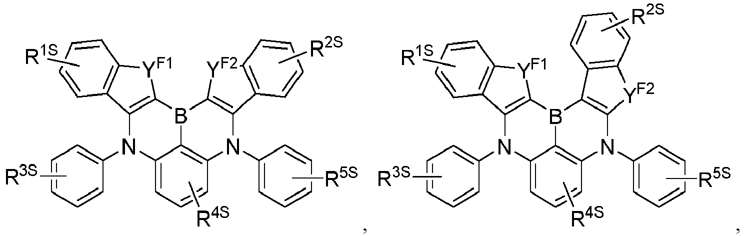 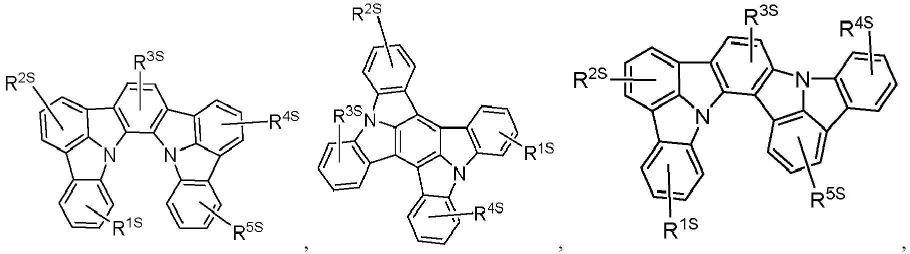 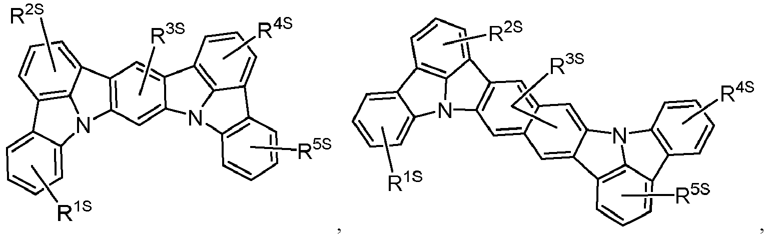 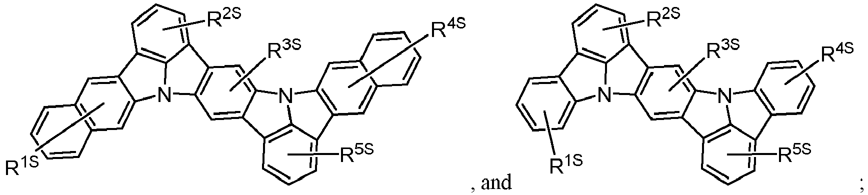
wherein Y^{F1} to Y^{F4} are each independently selected from O, S, and NR^{F1};
wherein R^{F1} and R^{1S} to R^{9S} each independently represents from mono to maximum possible number of substitutions, or no substitution; and
wherein R^{F1} and R^{1S} to R^{9S} are each independently a hydrogen or a substituent selected from the group consisting of the general substituents as defined herein, any two substituents can be joined or fused to form a ring.

In some embodiments, the second compound is selected from the group consisting of: 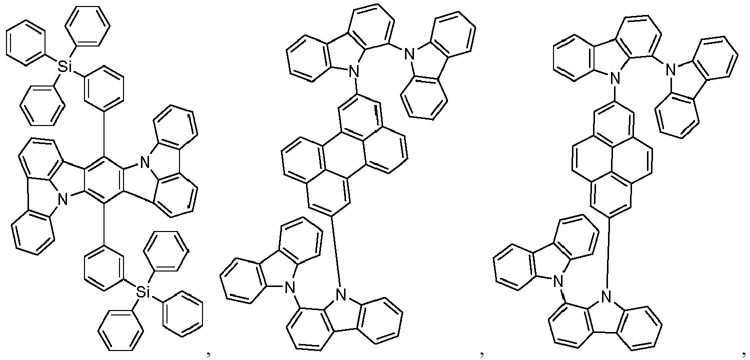 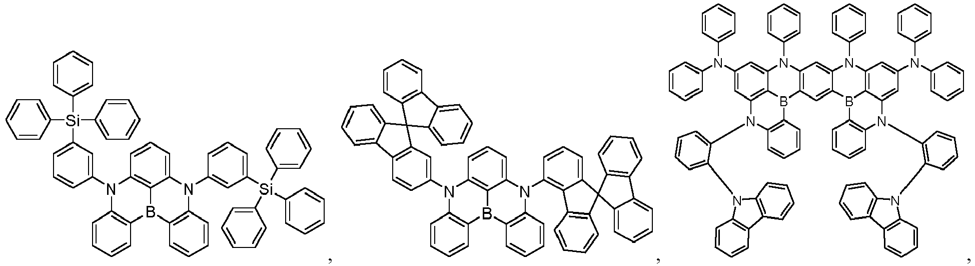 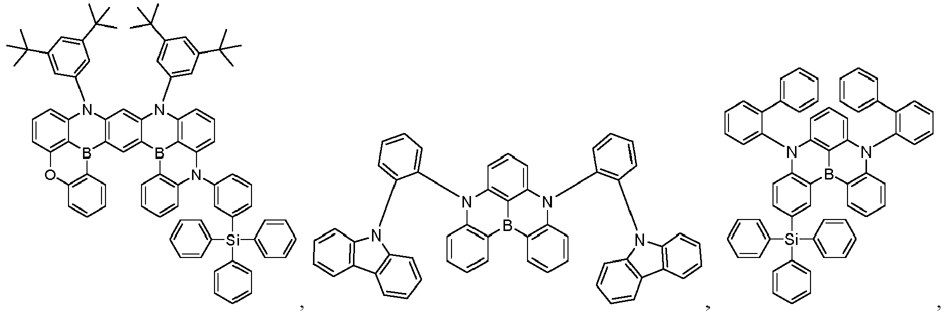 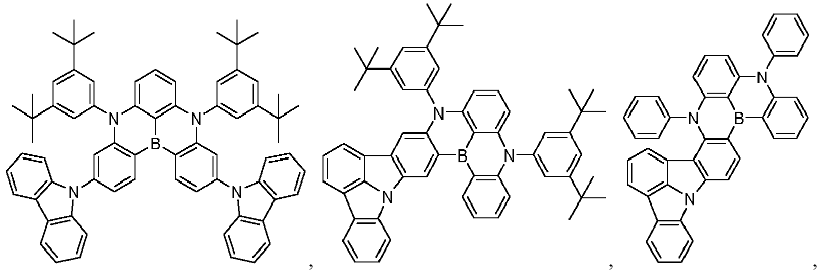 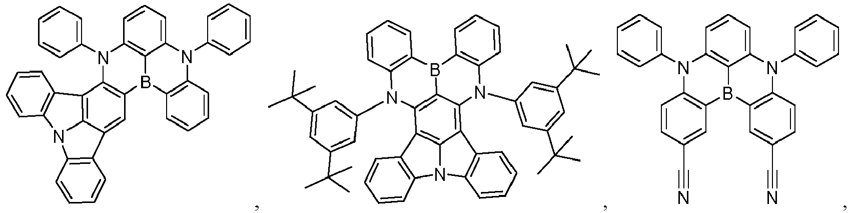 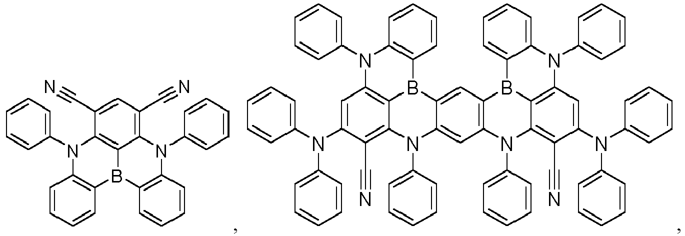 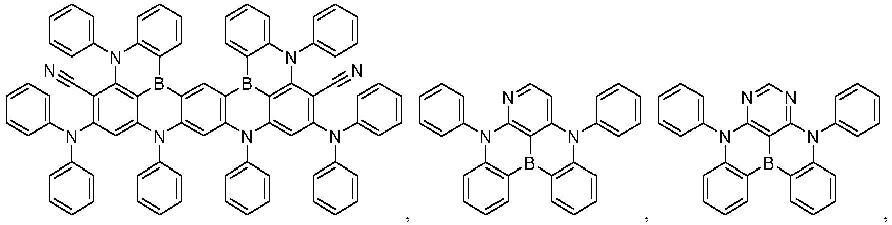 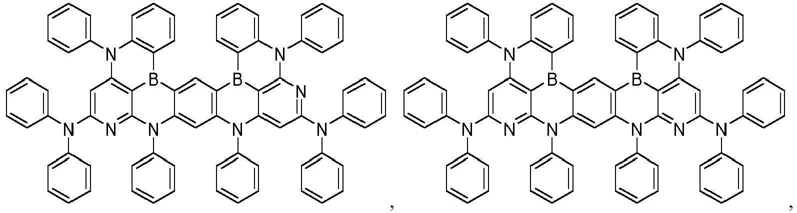 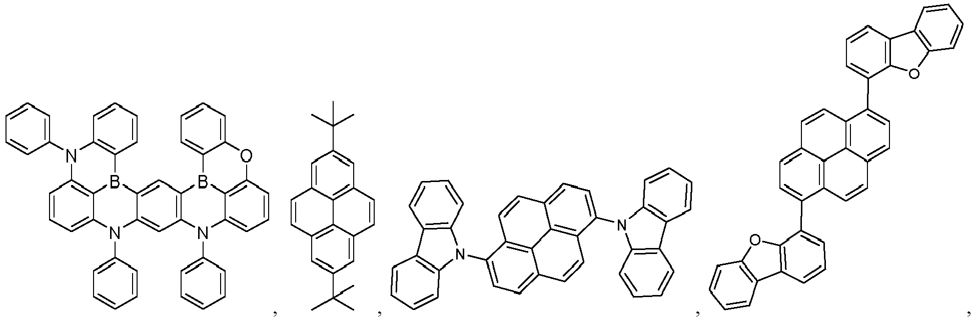 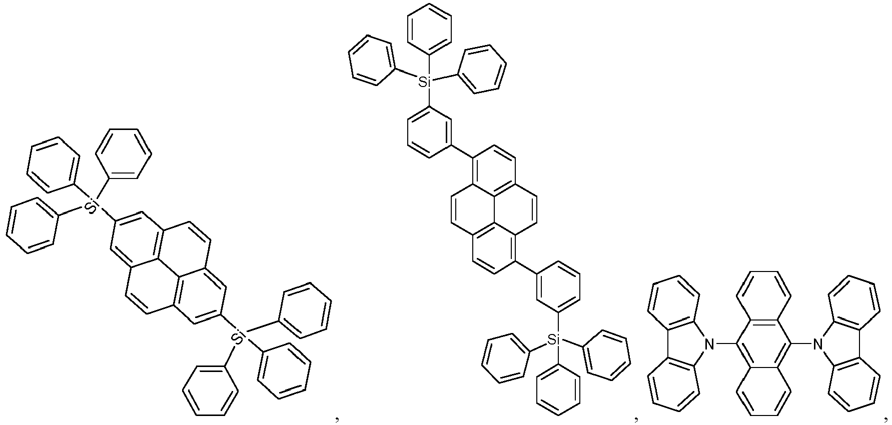 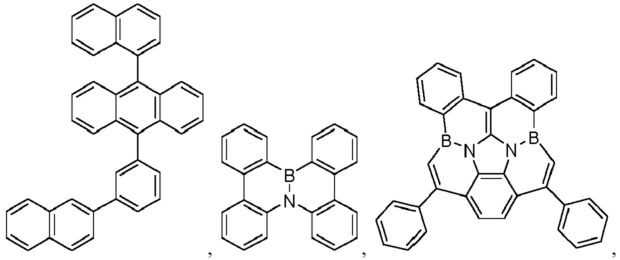 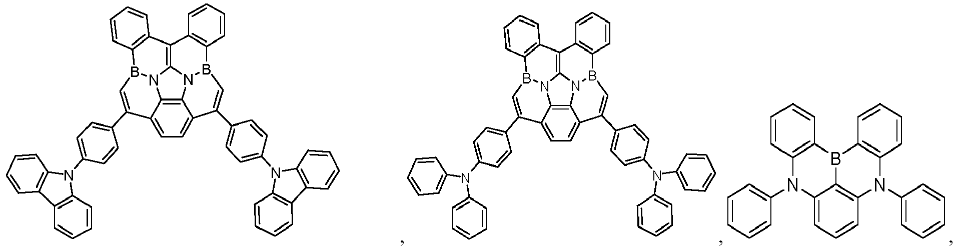 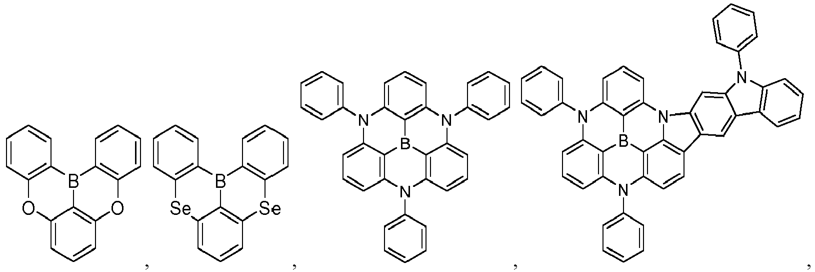 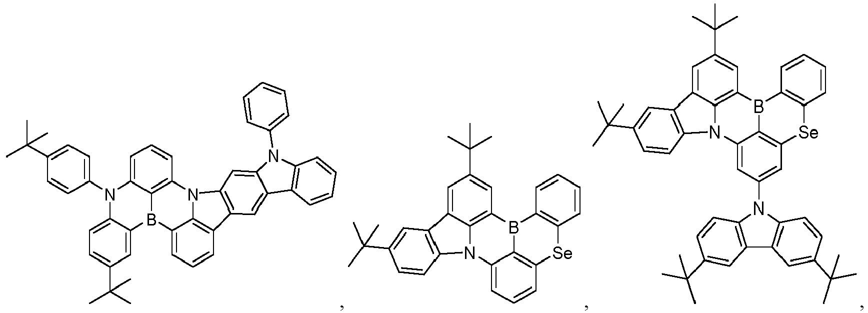 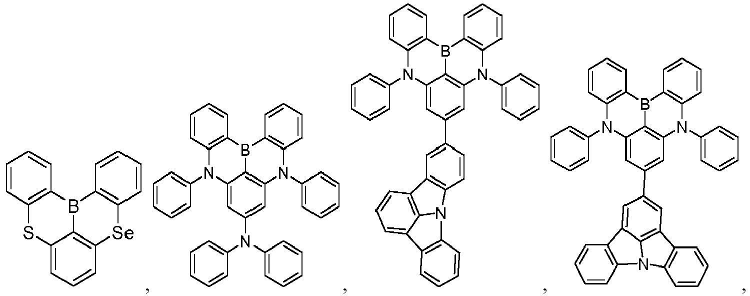 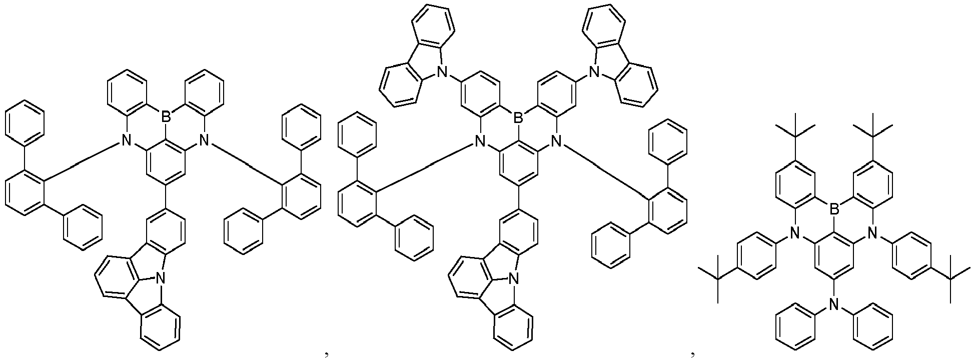 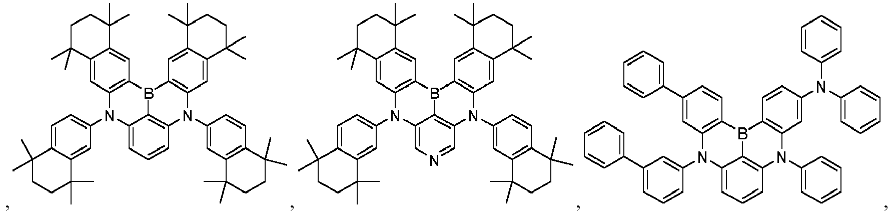 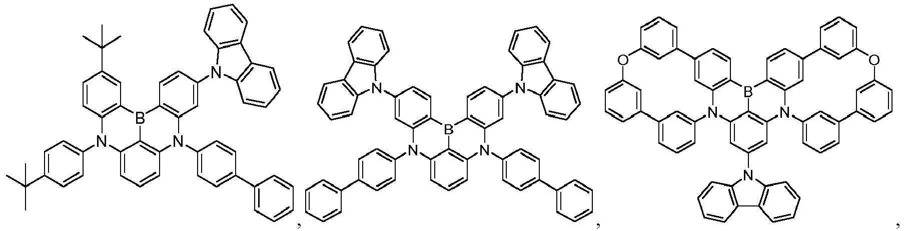 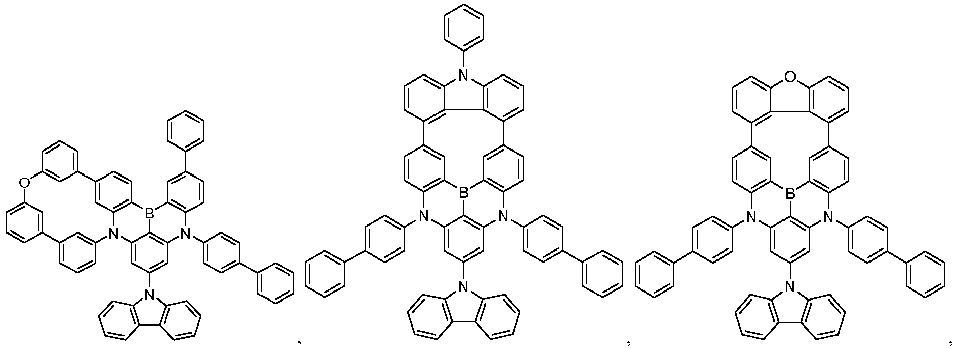 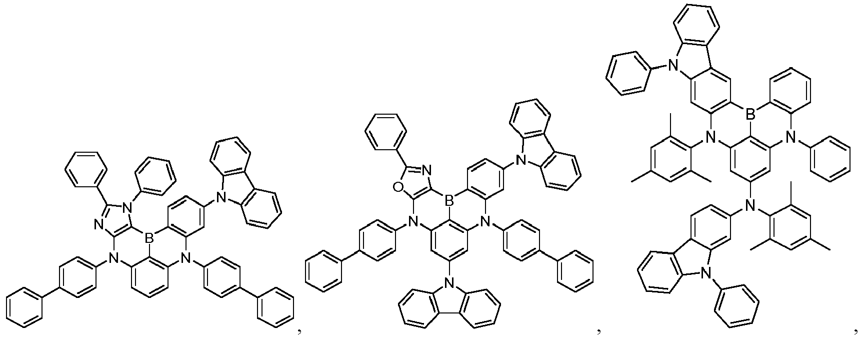 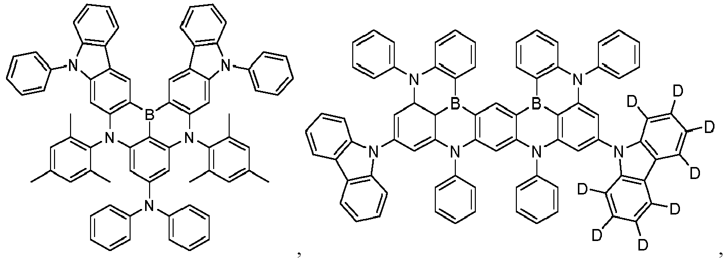 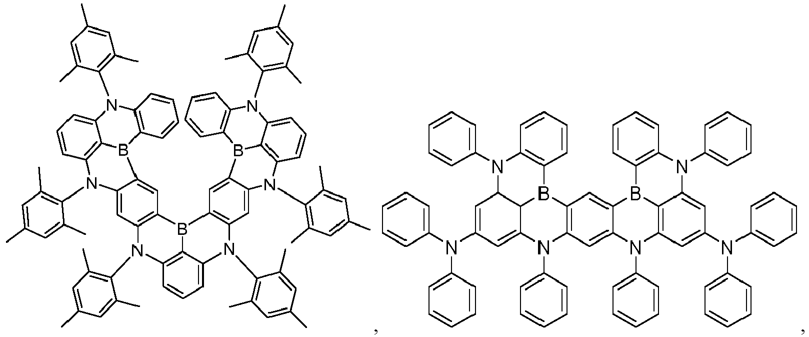 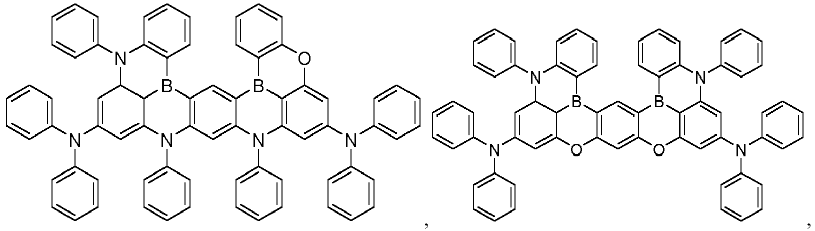 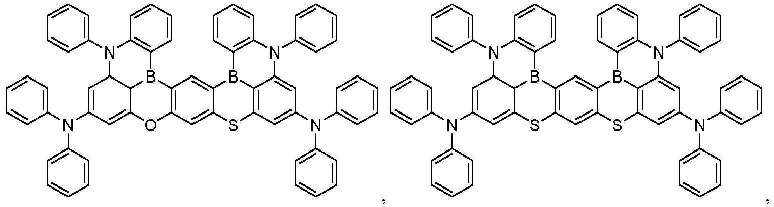 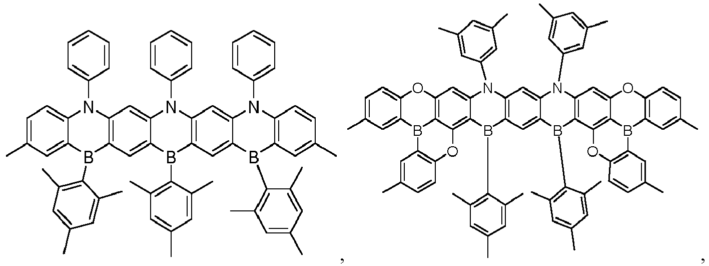 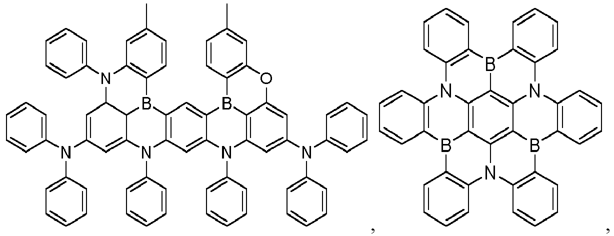 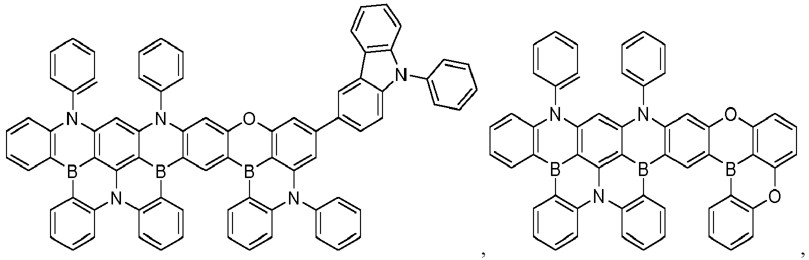 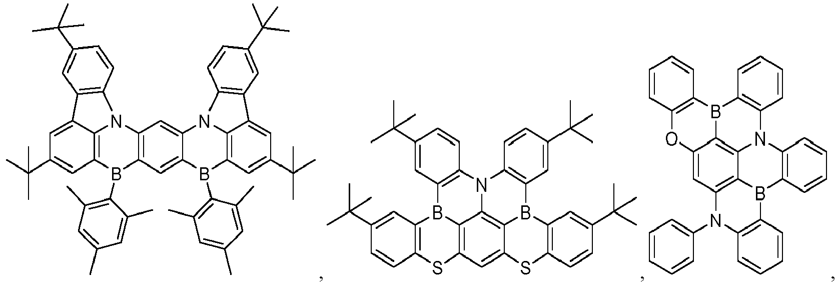 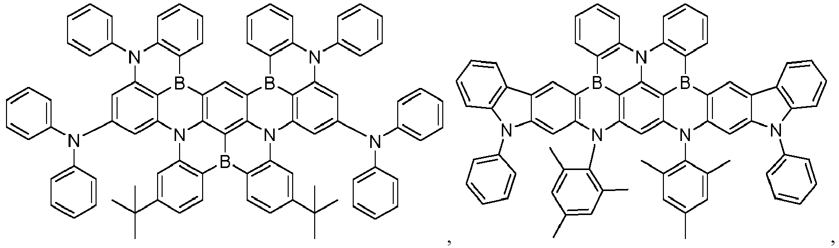 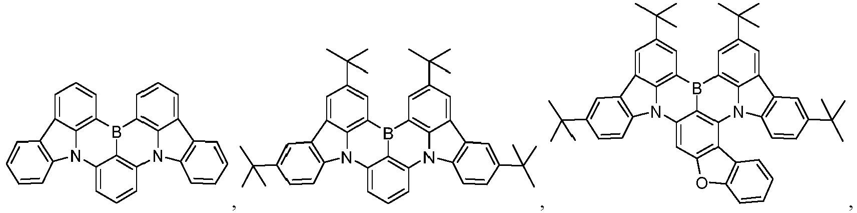 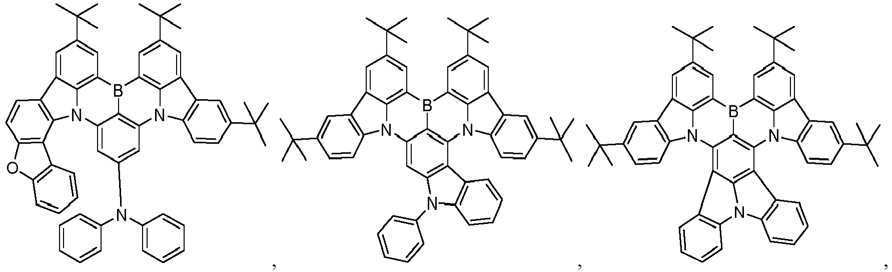 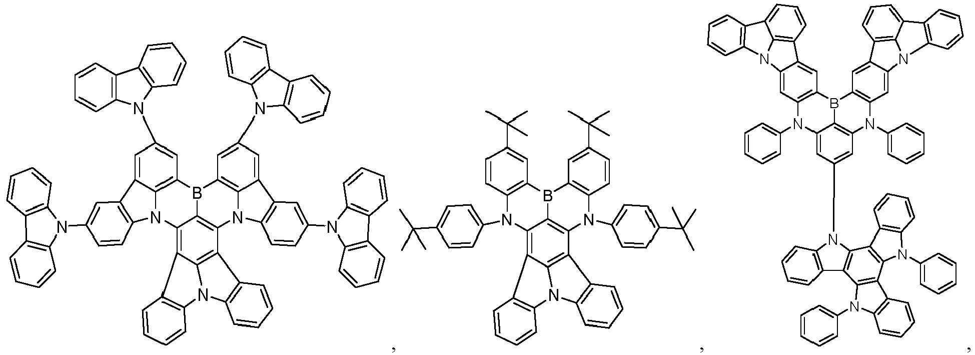 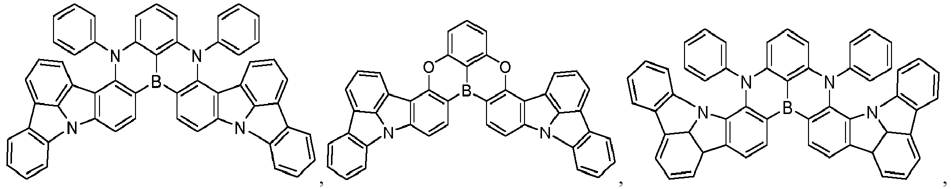 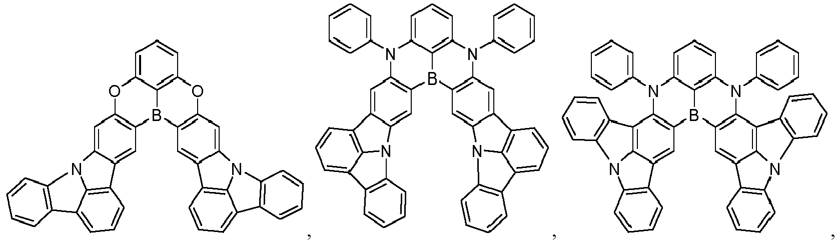 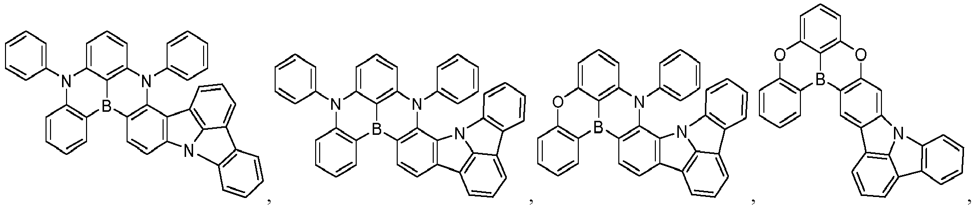 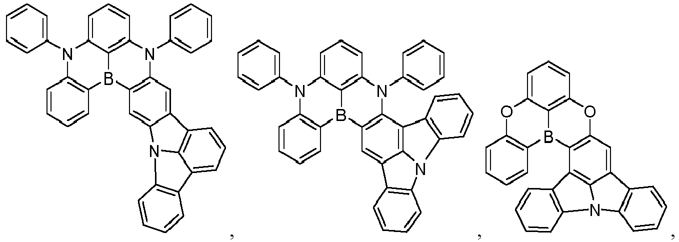 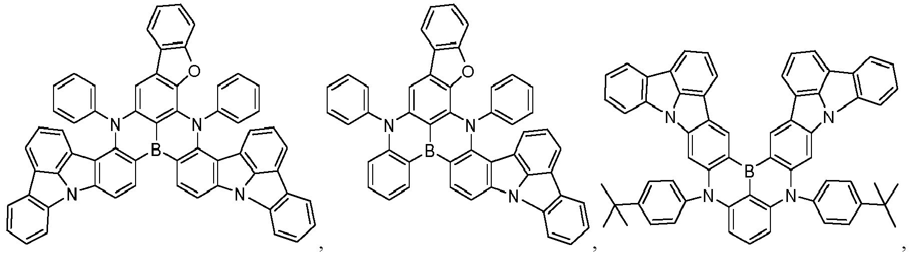 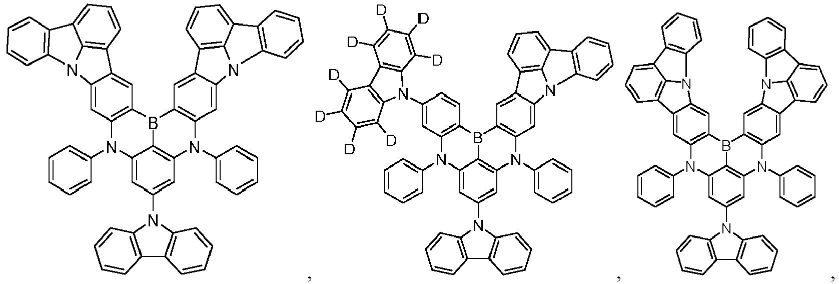 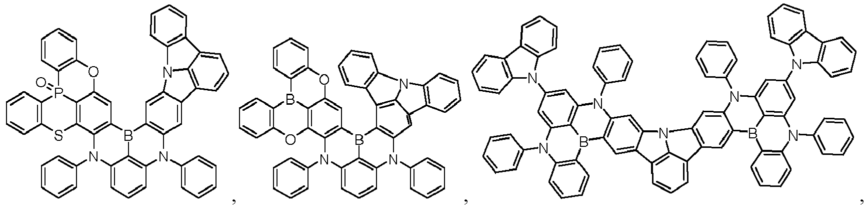 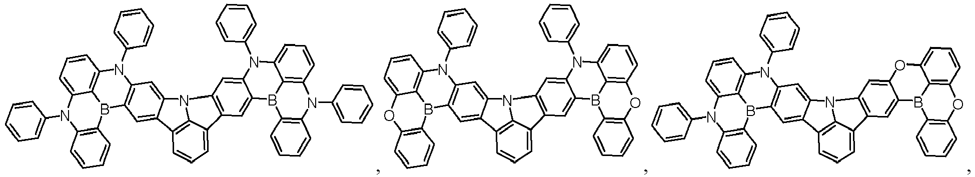 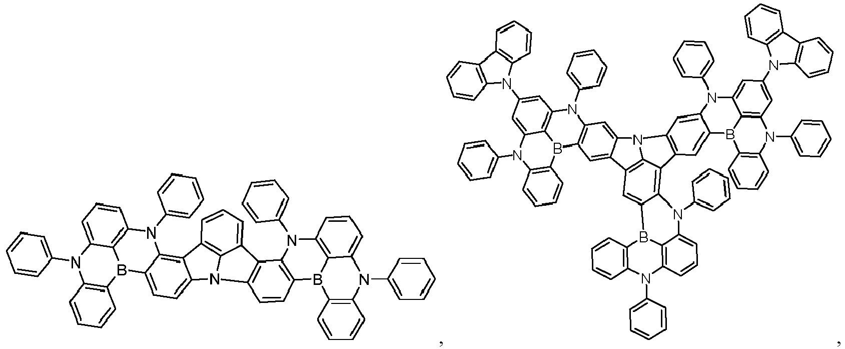 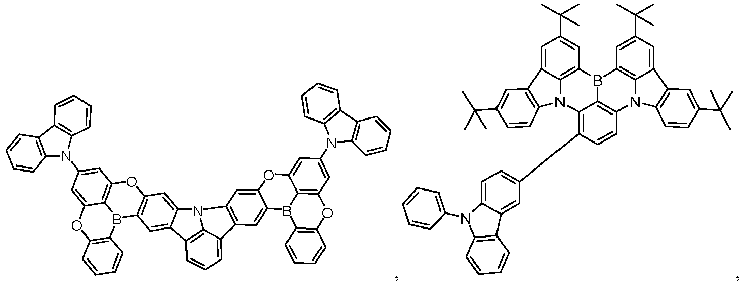 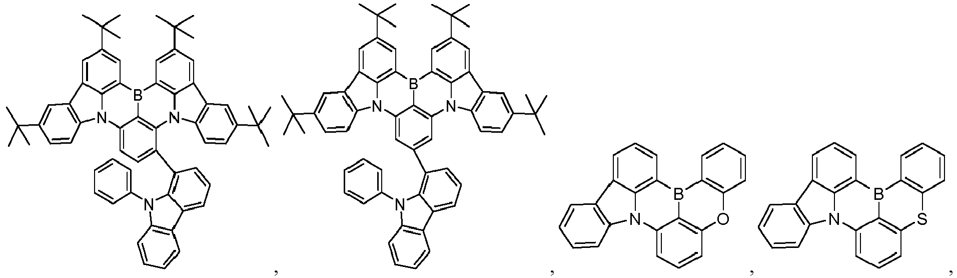 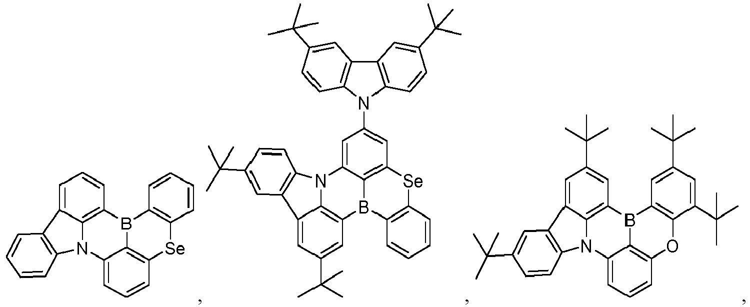 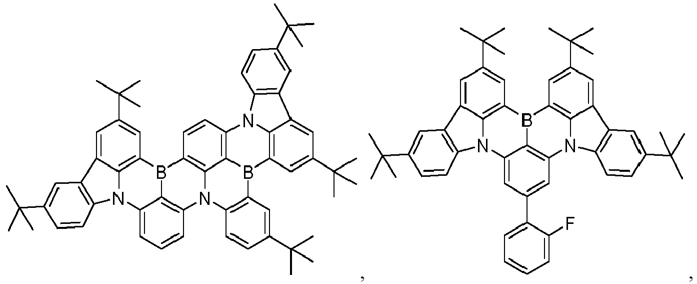 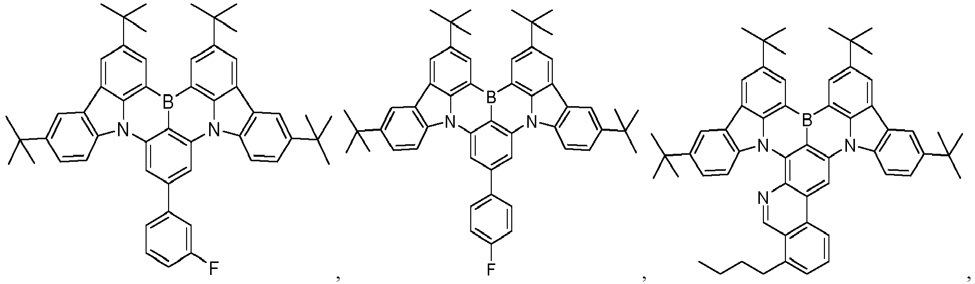 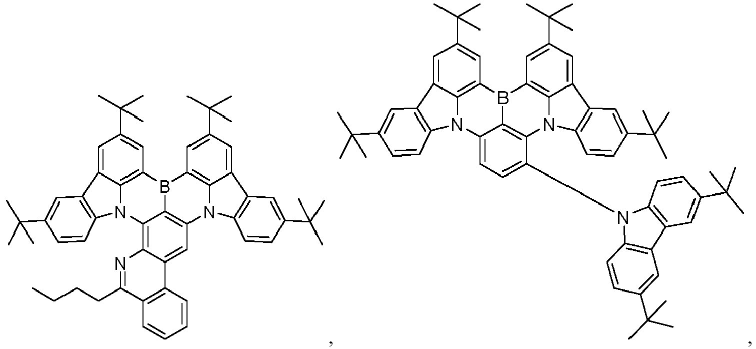 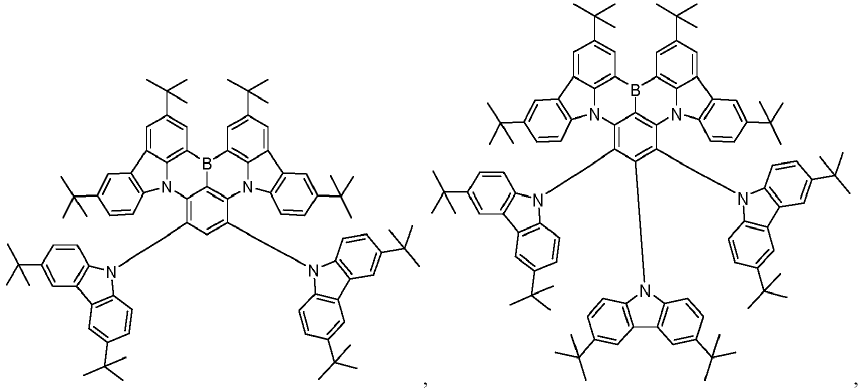 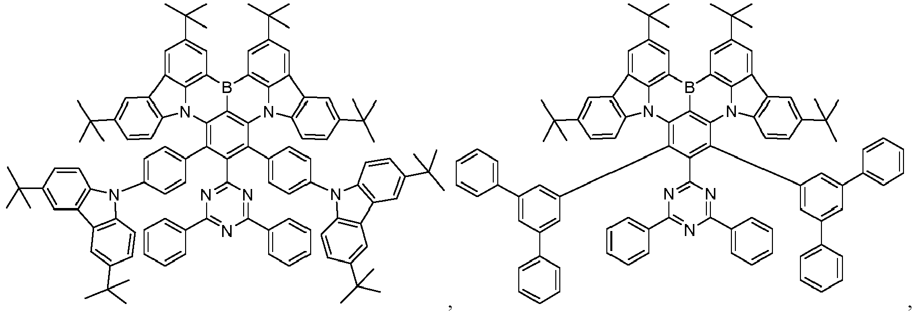 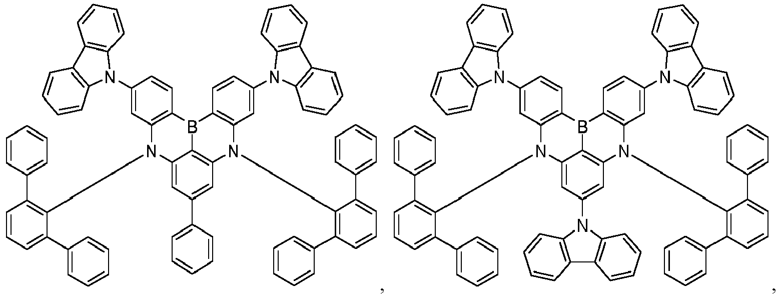 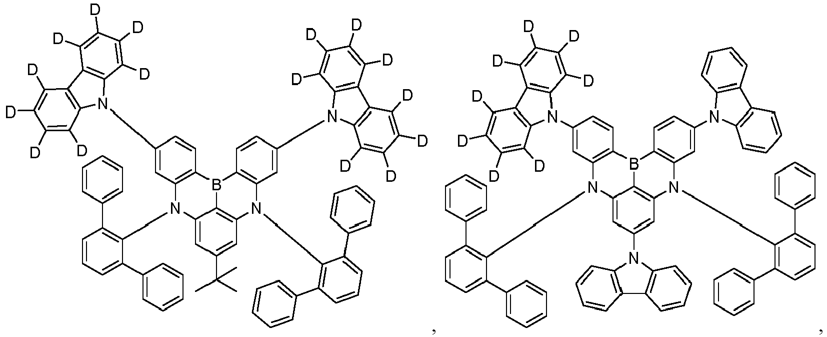 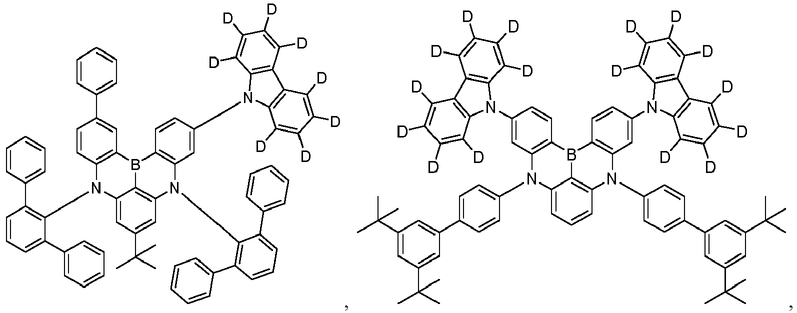 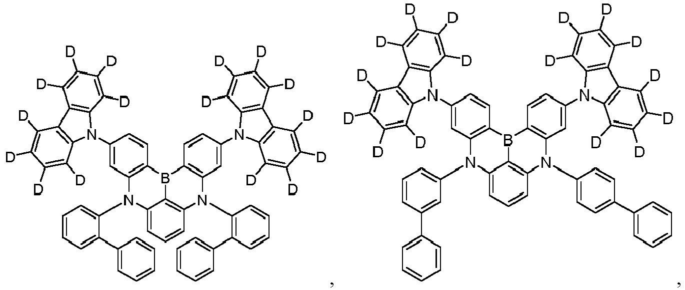 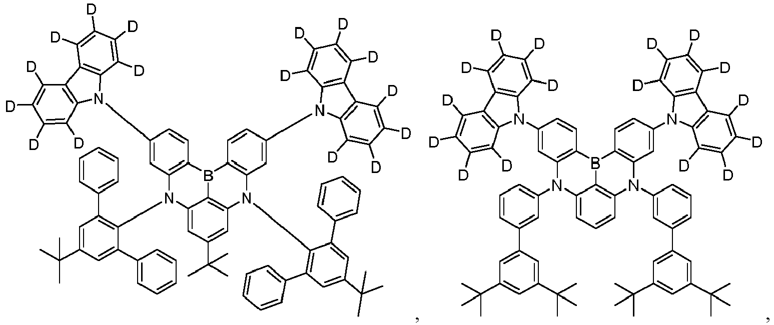 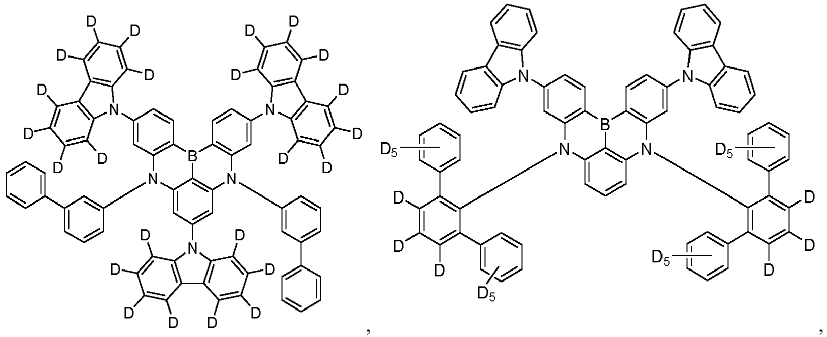 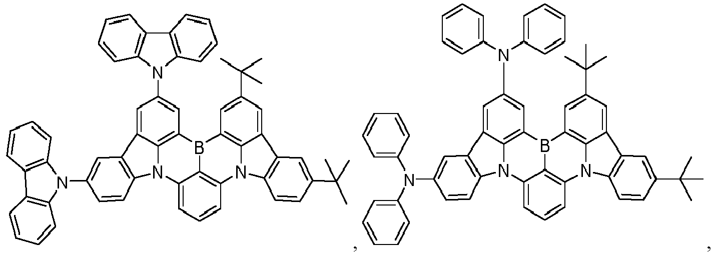 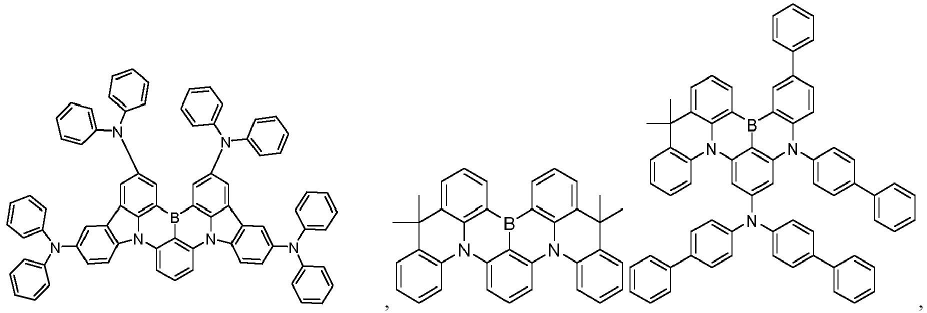 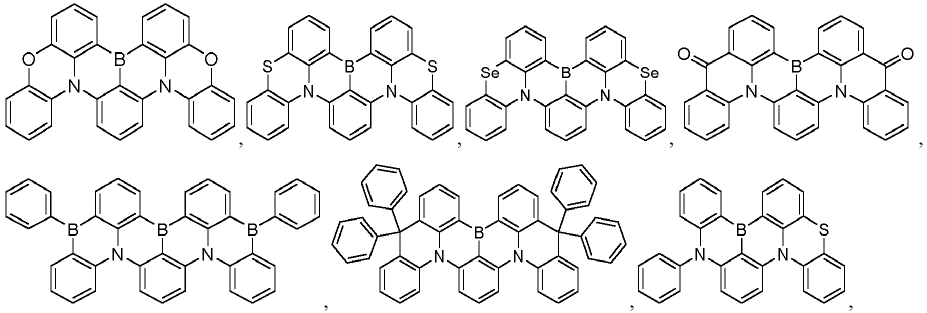 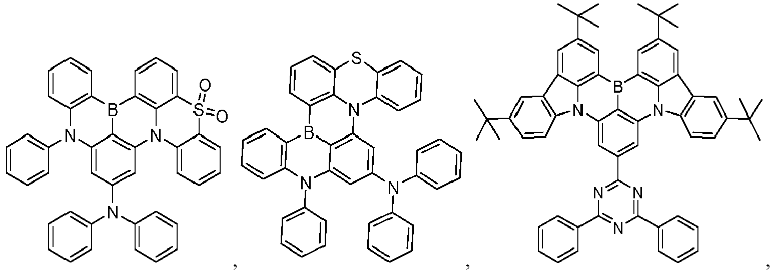 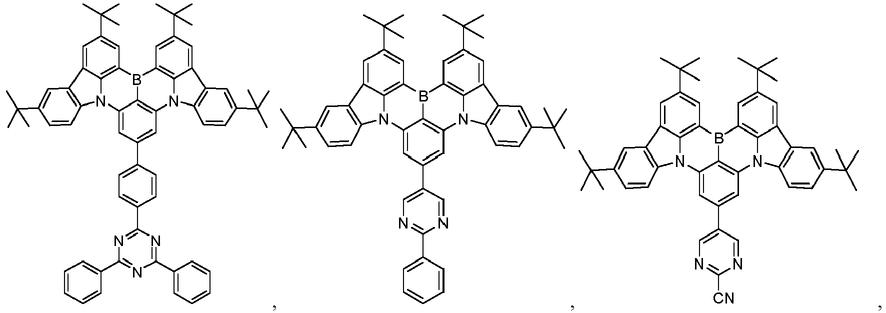 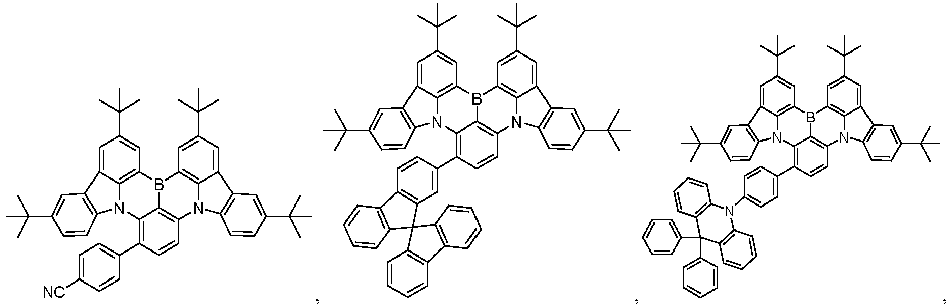 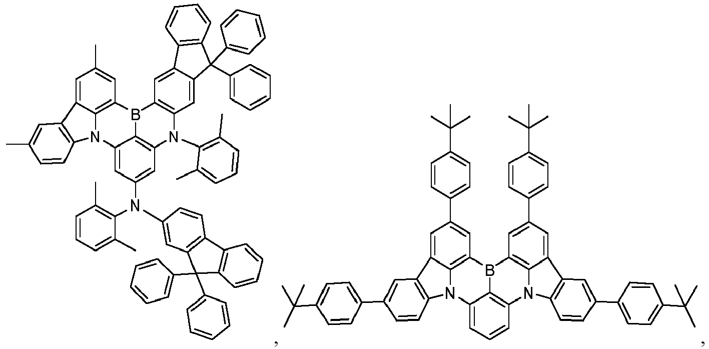 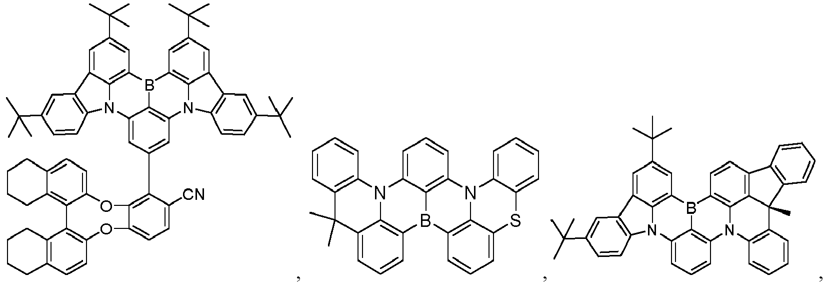 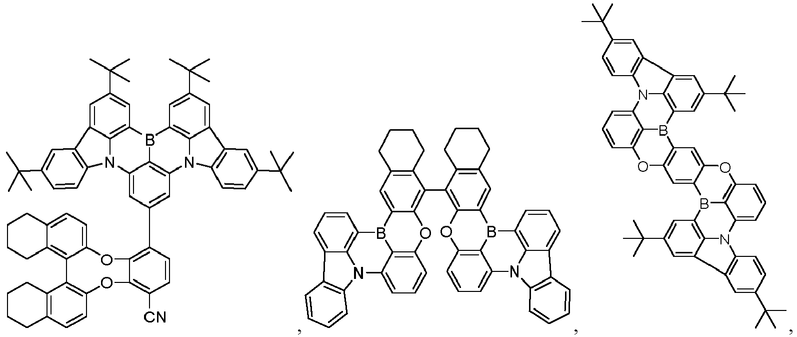 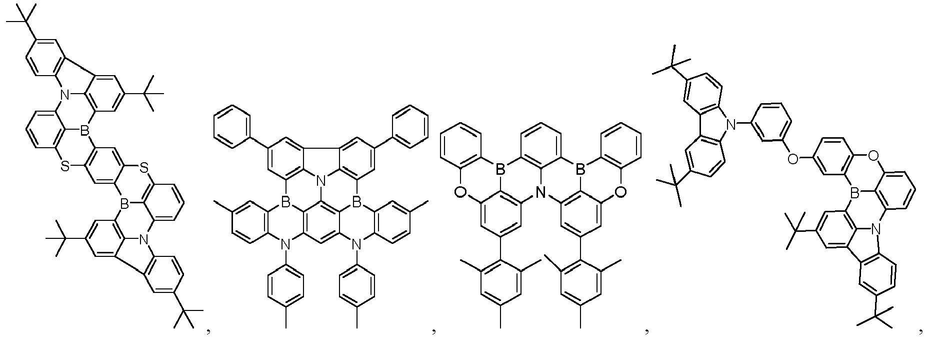 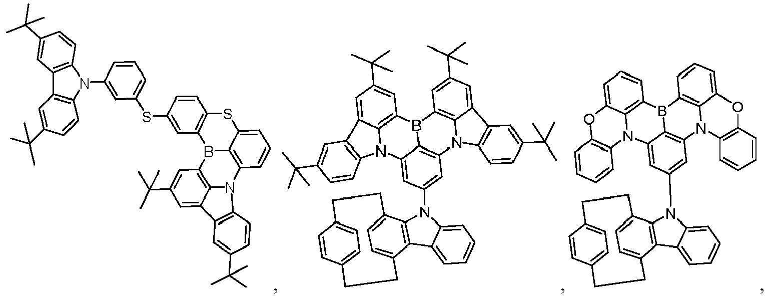 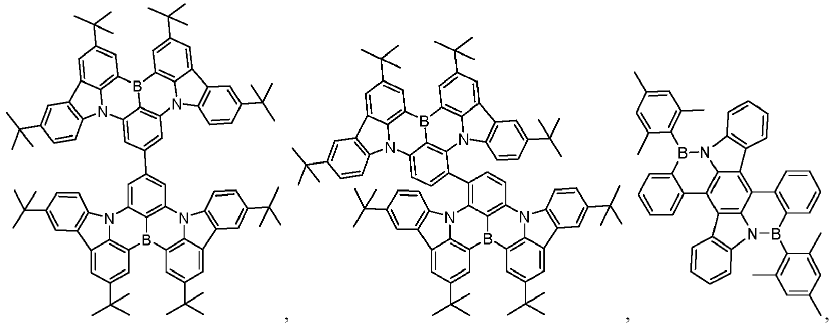 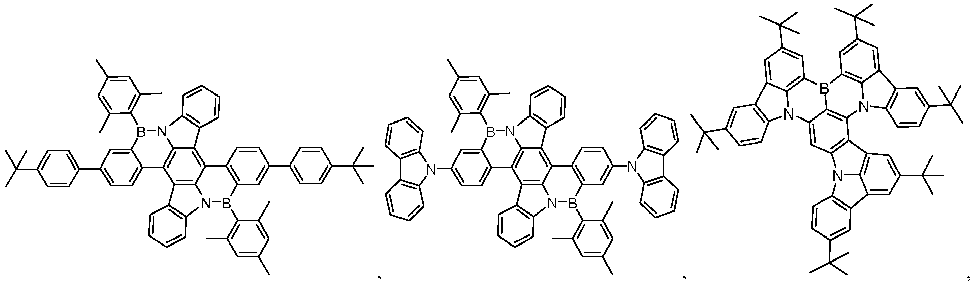 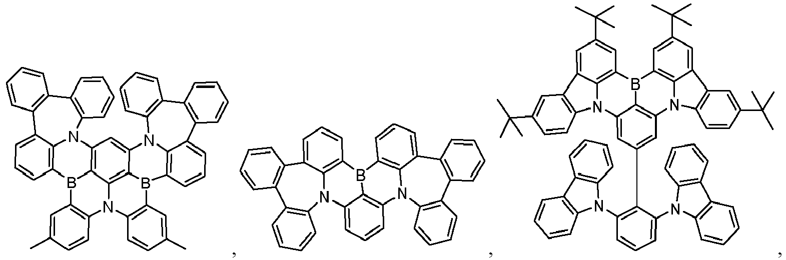 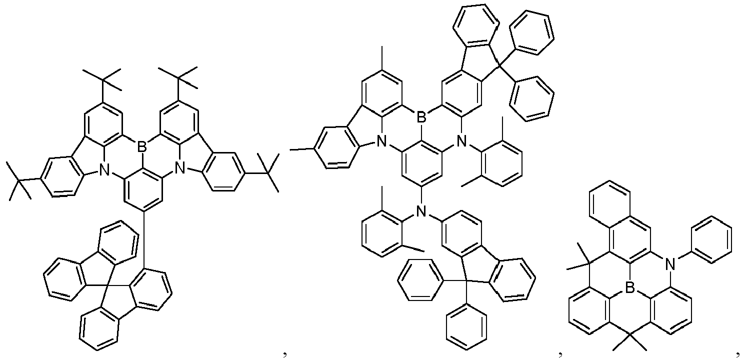 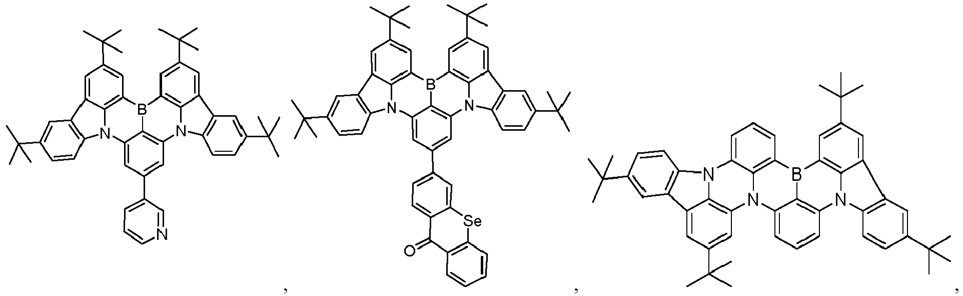 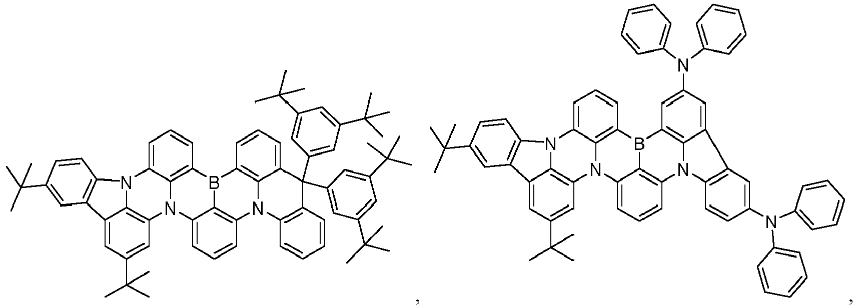 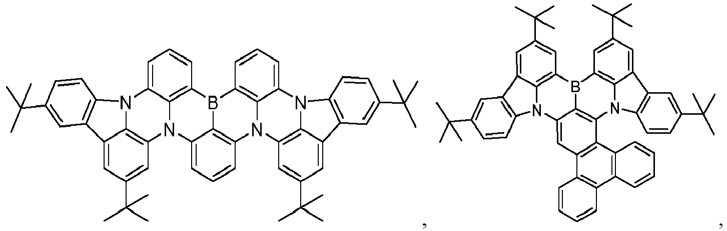 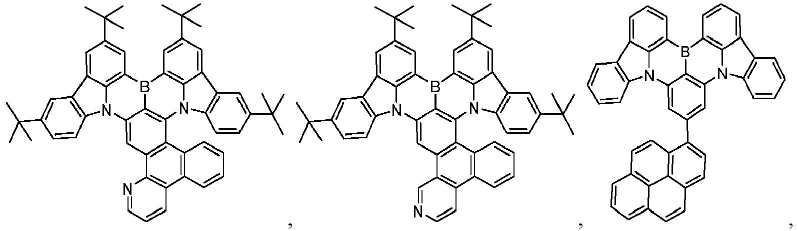 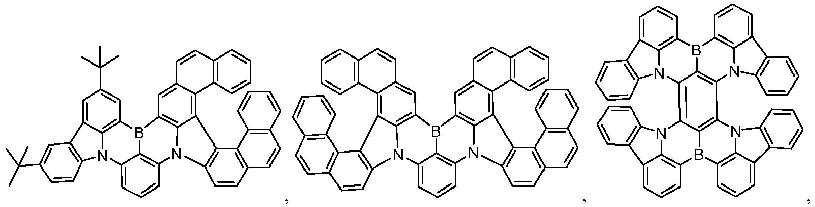 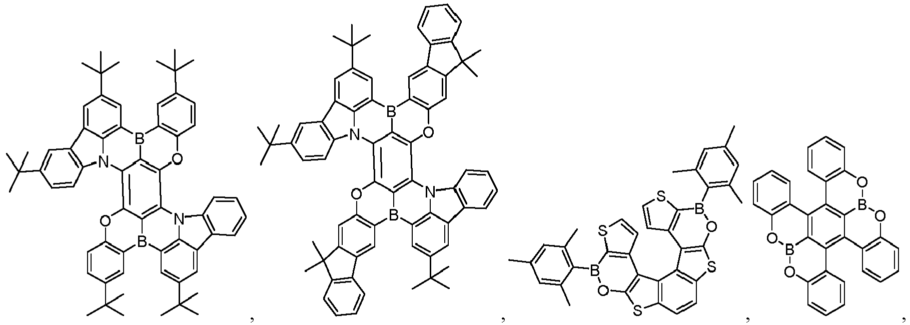 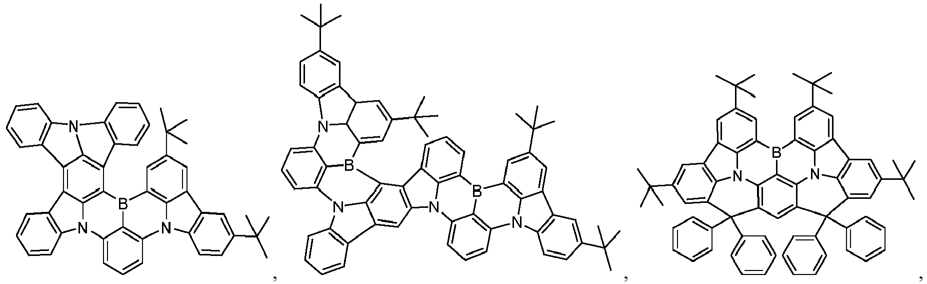 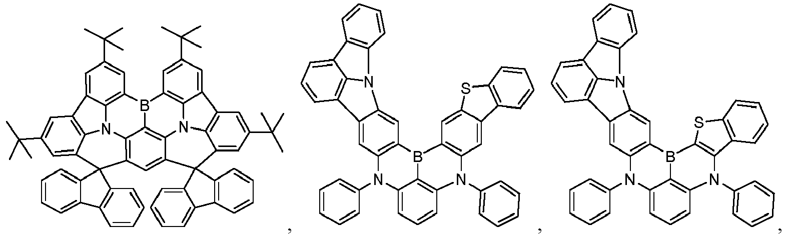 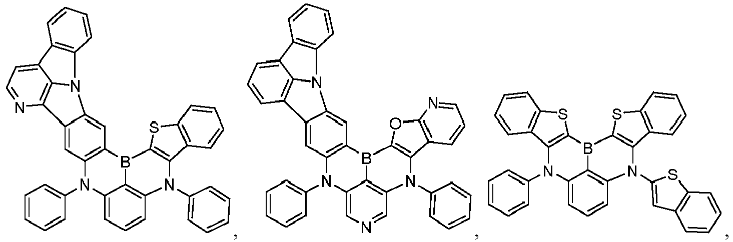 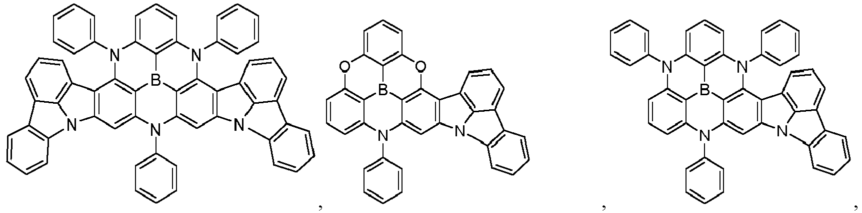 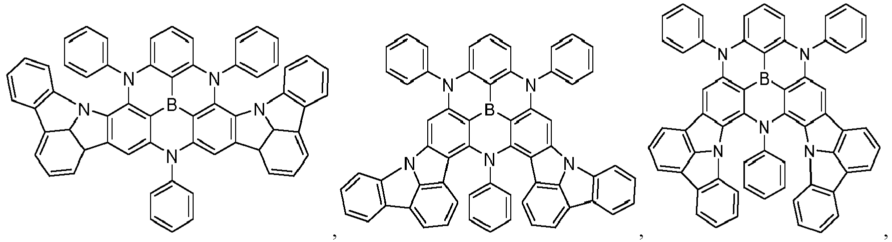 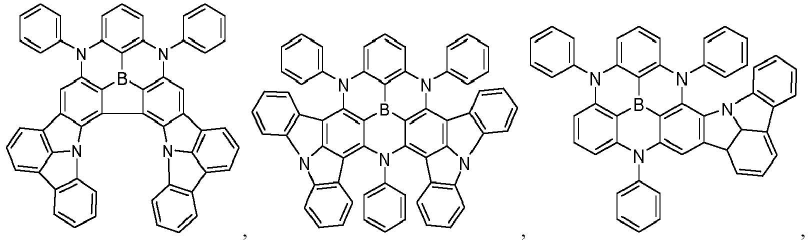 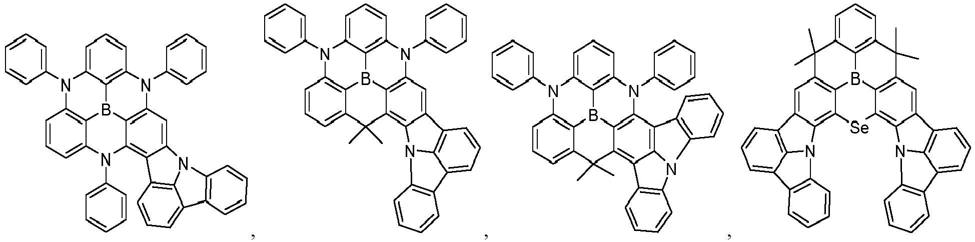 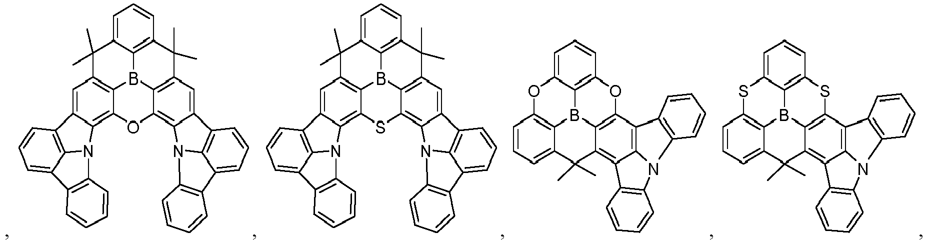 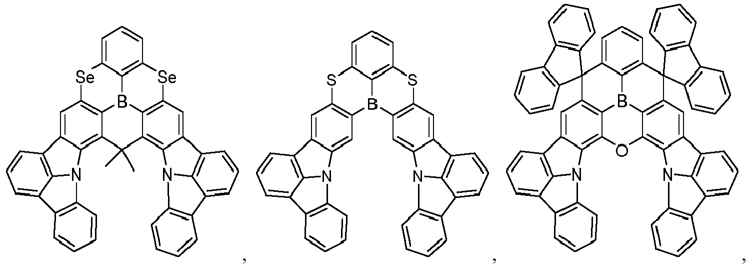 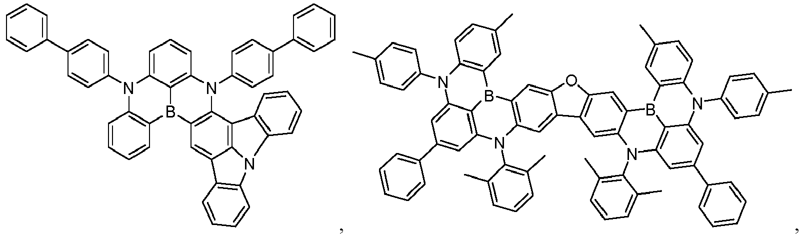 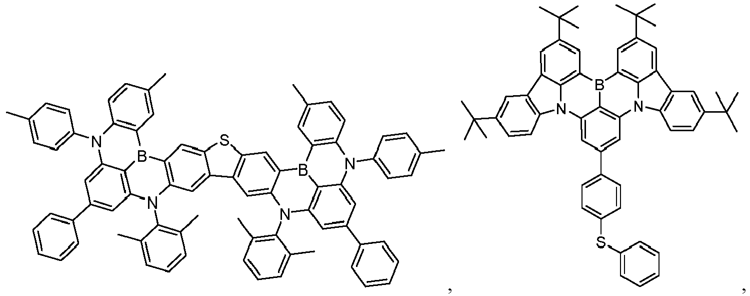 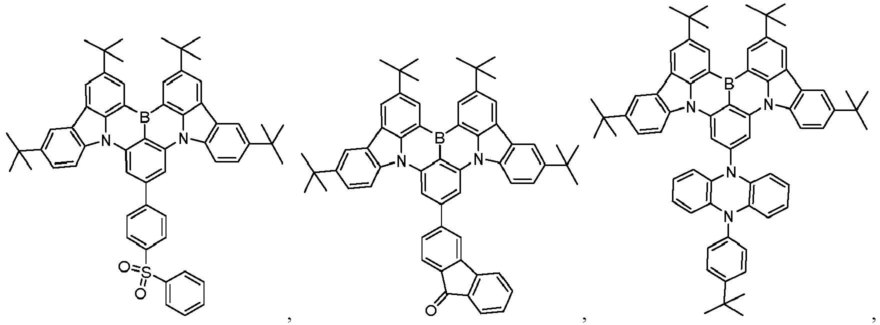 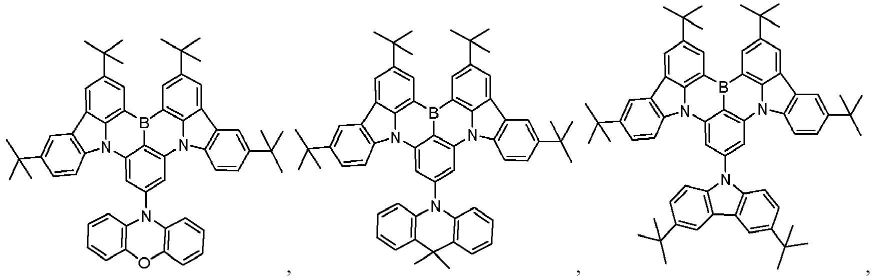 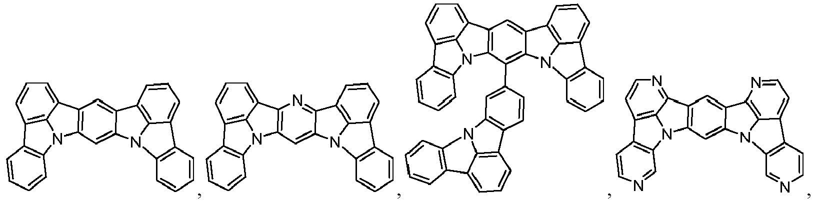 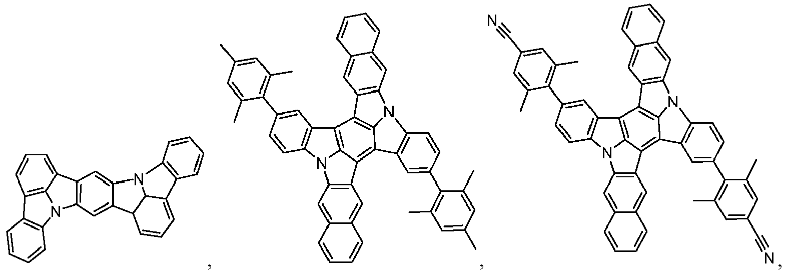 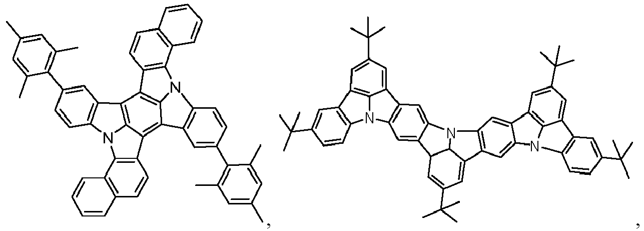 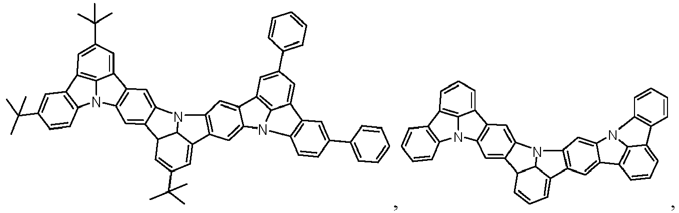 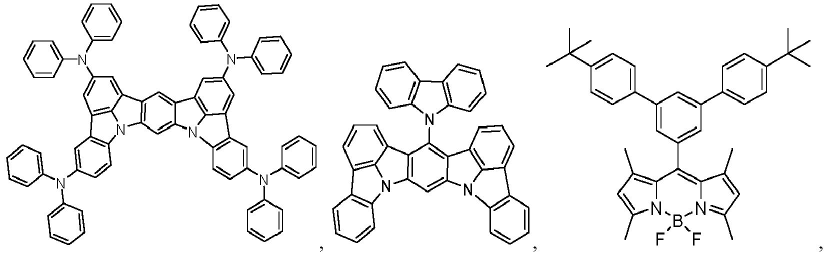 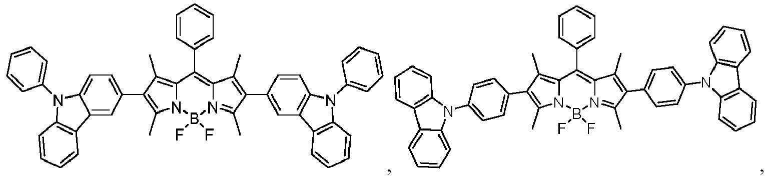 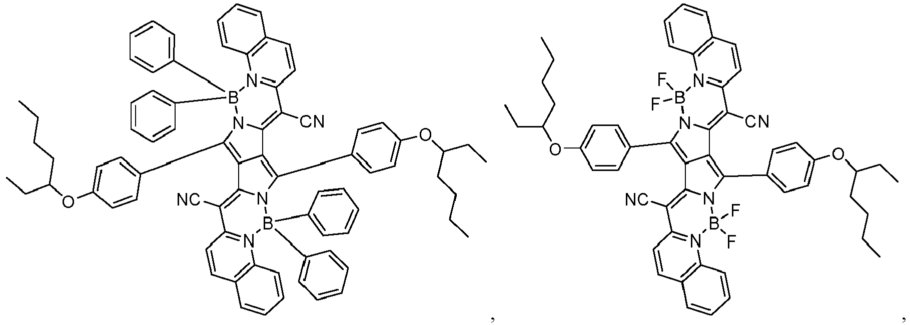 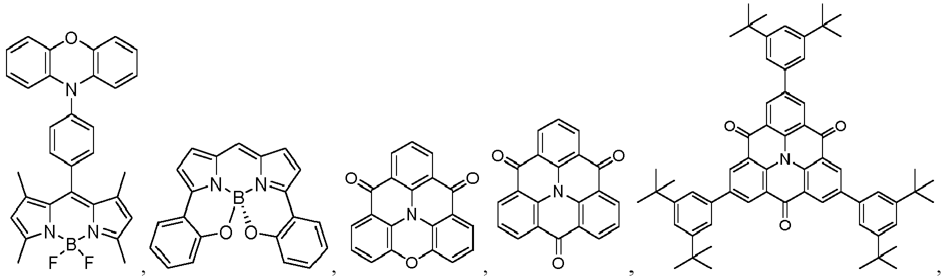 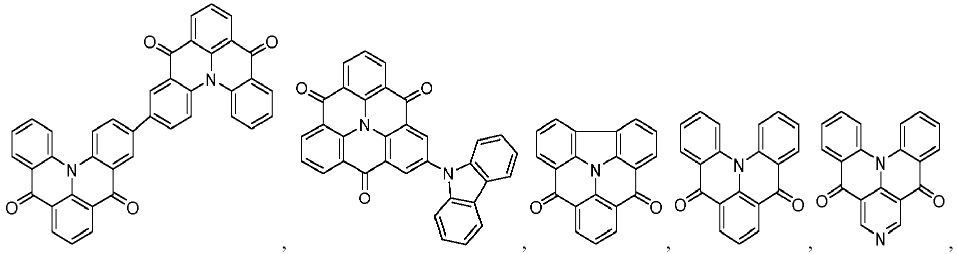 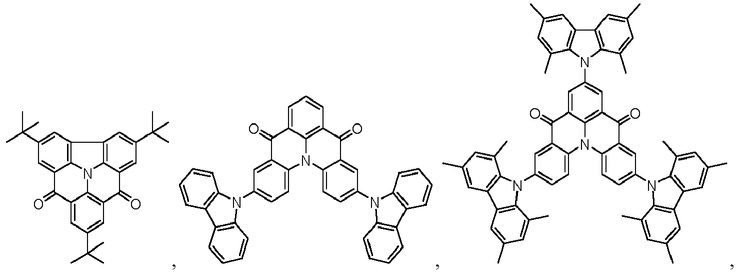 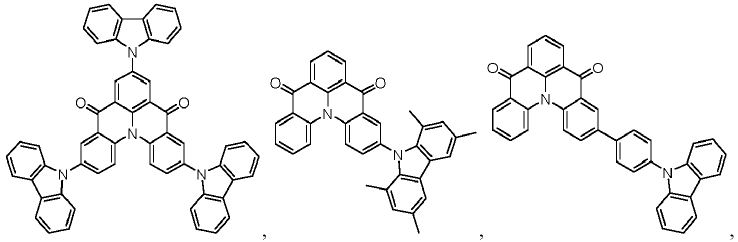 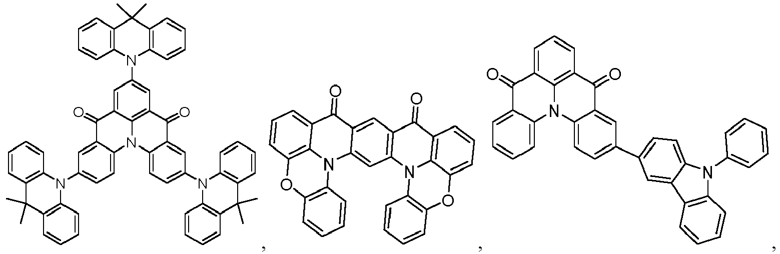 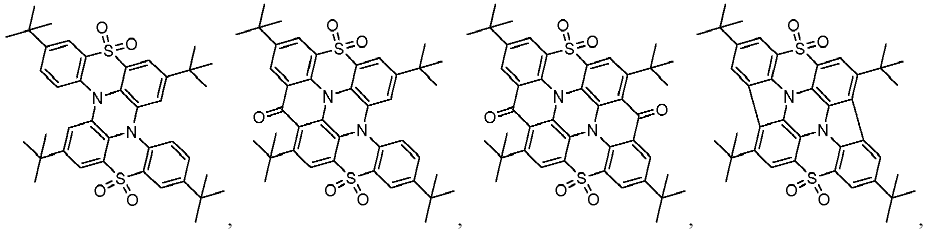 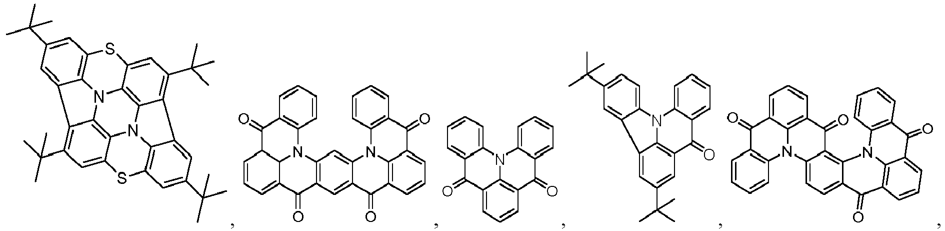 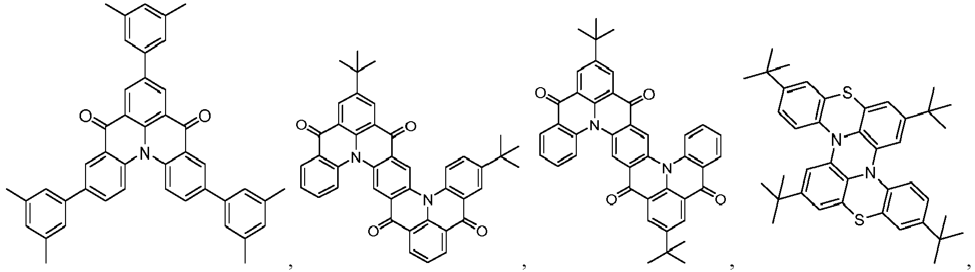 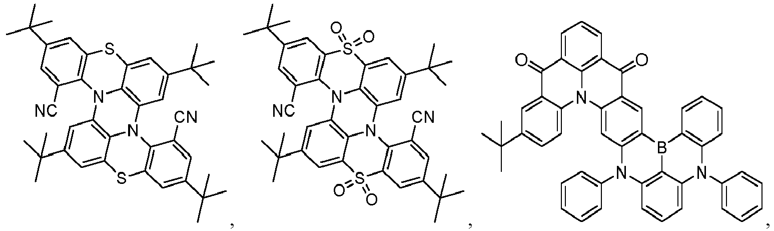 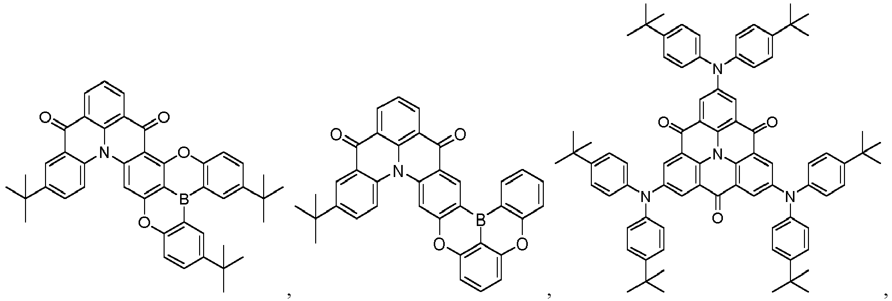 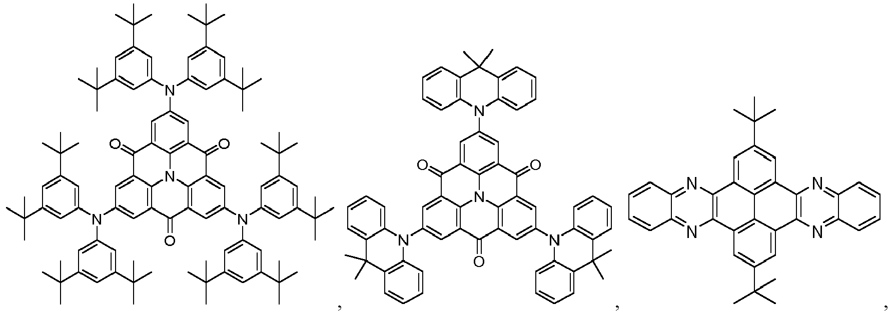 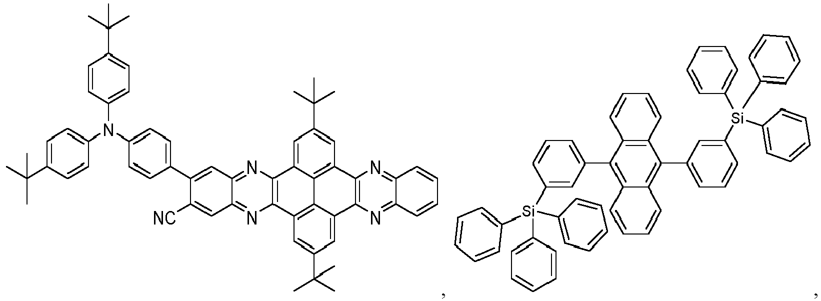 aza-substituted variants thereof, fully or partially deuterated variants thereof, and combinations thereof.

In some of the above embodiments, any carbon ring atoms up to maximum of a total number of three, together with their substituents, in each phenyl ring of any of above structures can be replaced with N.

In some embodiments, the second compound comprises a fused ring system having at least five to fifteen 5-membered and/or 6-membered aromatic rings. In some embodiments, the second compound has a first group and a second group with the first group not overlapping with the second group; wherein at least 80% of the singlet excited state population of the lowest singlet excitation state are localized in the first group; and wherein at least 80%, 85%, 90%, or 95% of the triplet excited state population of the lowest triplet excitation state are localized in the second group.

In some embodiments, the second compound comprises a fused ring system having at least five 5-membered and/or 6-membered aromatic rings. In some embodiments, the second compound comprises a fused ring system having at least six 5-membered and/or 6-membered aromatic rings. In some embodiments, the second compound comprises a fused ring system having at least seven 5-membered and/or 6-membered aromatic rings. In some embodiments, the second compound comprises a fused ring system having at least eight 5-membered and/or 6-membered aromatic rings. In some embodiments, the second compound comprises a fused ring system having at least nine 5-membered and/or 6-membered aromatic rings. In some embodiments, the second compound comprises a fused ring system having at least ten 5-membered and/or 6-membered aromatic rings.

In some embodiments, the second compound has a first group and a second group with the first group not overlapping with the second group; wherein at least 80% of the singlet excited state population of the lowest singlet excitation state are localized in the first group; and wherein at least 80% of the triplet excited state population of the lowest triplet excitation state are localized in the second group. In some embodiments, at least 85% of the singlet excited state population of the lowest singlet excitation state are localized in the first group; and wherein at least 85% of the triplet excited state population of the lowest triplet excitation state are localized in the second group. at least 90% of the singlet excited state population of the lowest singlet excitation state are localized in the first group; and wherein at least 90% of the triplet excited state population of the lowest triplet excitation state are localized in the second group. at least 95% of the singlet excited state population of the lowest singlet excitation state are localized in the first group; and wherein at least 95% of the triplet excited state population of the lowest triplet excitation state are localized in the second group.

In some embodiments, the third compound comprises at least one chemical group selected from the group consisting of triphenylene, carbazole, indolocarbazole, dibenzothiophene, dibenzofuran, dibenzoselenophene, 5λ²-benzo[d]benzo[4,5]imidazo[3,2-a]imidazole, 5,9-dioxa-13b-boranaphtho[3,2,1-de]anthracene, triazine, boryl, silyl, aza-triphenylene, aza-carbazole, aza-indolocarbazole, aza-dibenzothiophene, aza-dibenzofuran, aza-dibenzoselenophene, aza-5λ²-benzo[d]benzo[4,5]imidazo[3,2-a]imidazole, and aza-(5,9-dioxa-13b-boranaphtho[3,2,1-de]anthracene).

In some embodiments, the first compound (the sensitizer) forms an exciplex with the third compound (the first host) in the OLED at room temperature. In some embodiments, the first host has a LUMO energy that is lower than the LUMO energies of the sensitizer compound and the acceptor compound (the second compound) in the emissive region. In some embodiments, the first host has a HOMO energy that is lower than the HOMO energies of the sensitizer compound and the acceptor compound in the emissive region. In some embodiments, the first host has a HOMO energy that is higher than the HOMO energies of the sensitizer compound and the acceptor compound in the emissive region. In some embodiments, the first host has a HOMO energy that is higher than the HOMO energy of at least one of the sensitizer compound and the acceptor compound in the emissive region.

In some embodiments, the emissive region further comprises a second host. In some embodiments, the first host forms an exciplex with the second host in the OLED at room temperature. In some embodiments, the S₁-T₁ energy gap in the exciplex formed by the first host and the second host is less than 0.4, 0.3, 0.2, or 0.1 eV. In some embodiments, the T₁ energy of exciplex is greater than 2.5, 2.6, 2.7, or 2.8 eV. In some embodiments, the concentrations of the first and second hosts in the layer or layers containing the first and second host are greater than the concentrations of the sensitizer compound and the acceptor compound in the layer or layers containing the sensitizer compound and the acceptor compound. In some embodiments, the concentrations of the first and second hosts in the layer or layers containing the first and second host are greater than the concentrations of the acceptor compound in the layer or layers containing the sensitizer compound and the acceptor compound.

In some embodiments, the S₁ energy of the first host is greater than that of the acceptor compound. In some embodiments, T₁ energy of the first host is greater than that of the sensitizer compound. In some embodiments, the sensitizer compound has a HOMO energy that is greater than that of the acceptor compound. In some embodiments, the second host has a HOMO level that is shallower than that of the acceptor compound. In some embodiments, the HOMO level of the acceptor compound is deeper than at least one selected from the sensitizer compound and the first host.

In some embodiments, the first host and/or the second host comprises at least one chemical group selected from the group consisting of triphenylene, carbazole, indolocarbazole, dibenzothiophene, dibenzofuran, dibenzoselenophene, 5λ²-benzo[d]benzo[4,5]imidazo[3,2-a]imidazole, 5,9-dioxa-13b-boranaphtho[3,2,1-de]anthracene, triazine, boryl, silyl, nitrile, aza-triphenylene, aza-carbazole, aza-indolocarbazole, aza-dibenzothiophene, aza-dibenzofuran, aza-dibenzoselenophene, aza-5λ²-benzo[d]benzo[4,5]imidazo[3,2-a]imidazole, and aza-(5,9-dioxa-13b-boranaphtho[3,2,1-de]anthracene). In some embodiments the first host and the second host are both organic compounds. In some embodiments, at least one of the first host and the second host is a metal complex.

In some embodiments, the second host may also comprise R* selected from the group consisting of: 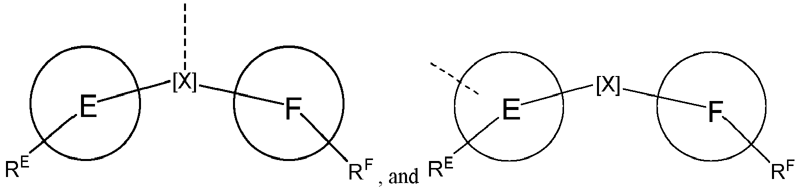 as defined herein.

It should be understood that all the embodiments of R* of the present disclosure can be equally applied to the second host having the R* group.

In some embodiments, the third compound (the first host) and/or the second host may be selected from the group consisting of the following structures (LIST 3): 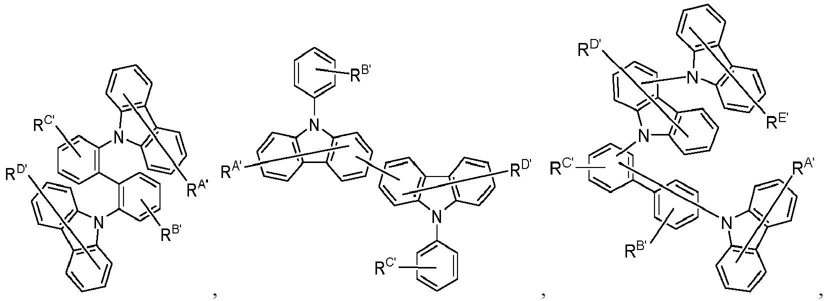 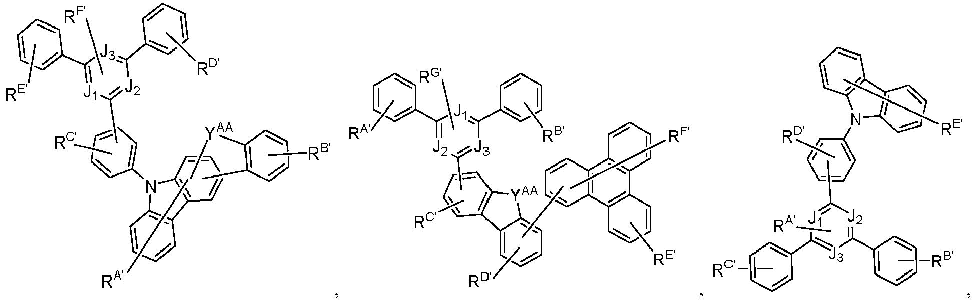 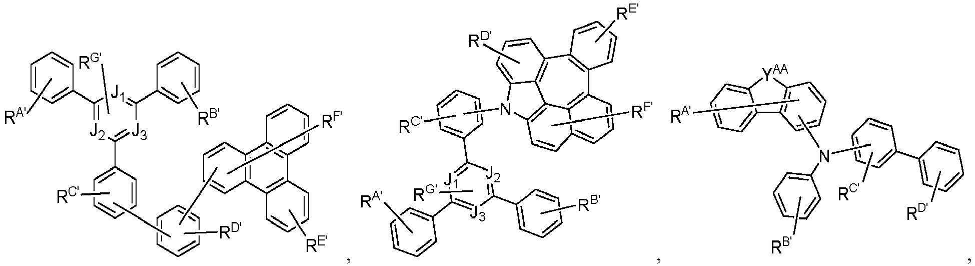 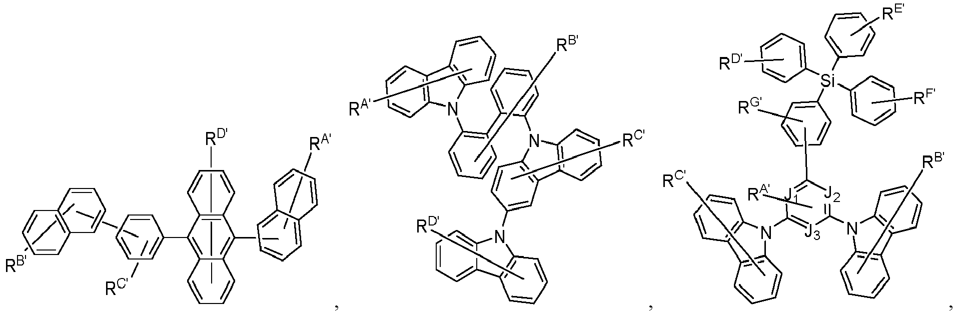 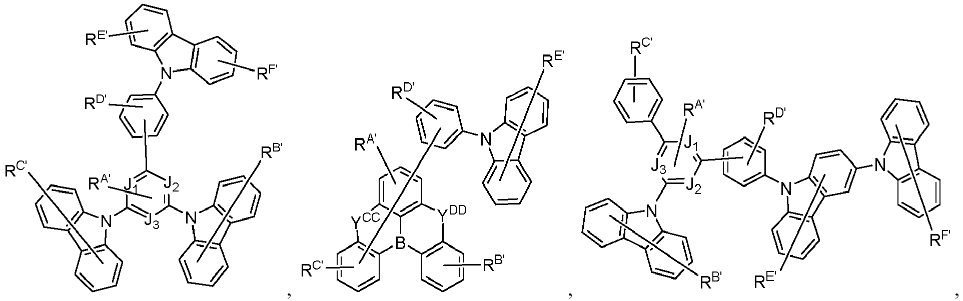 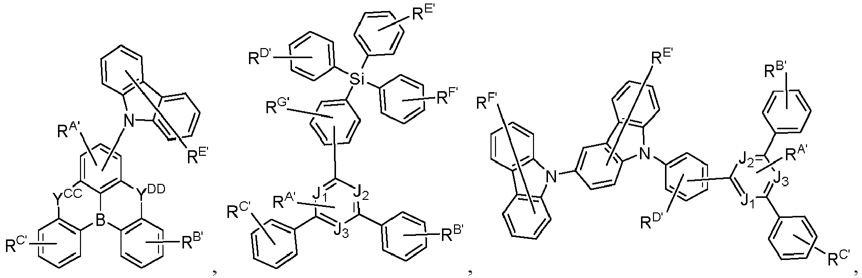 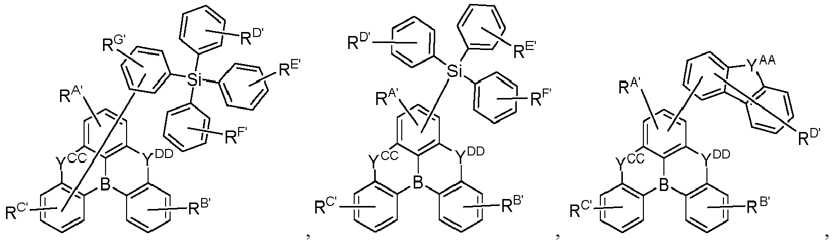 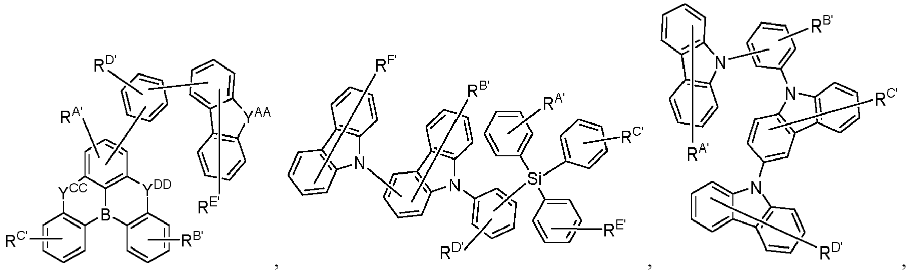 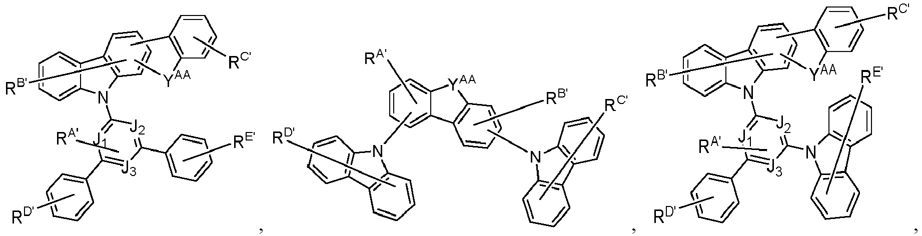 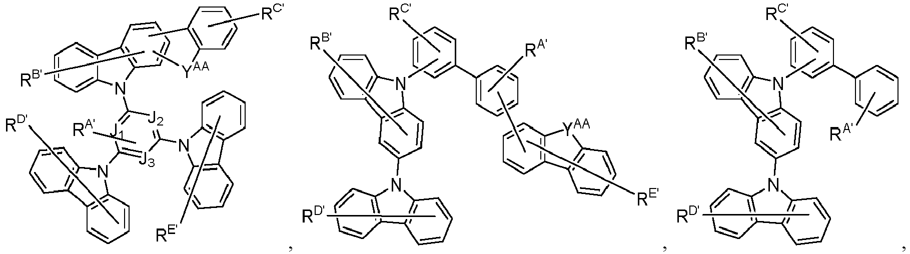 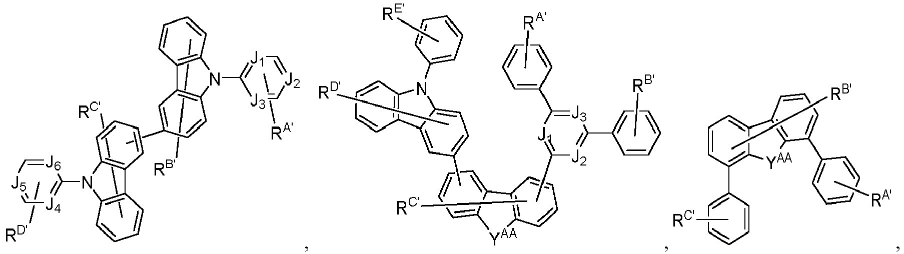 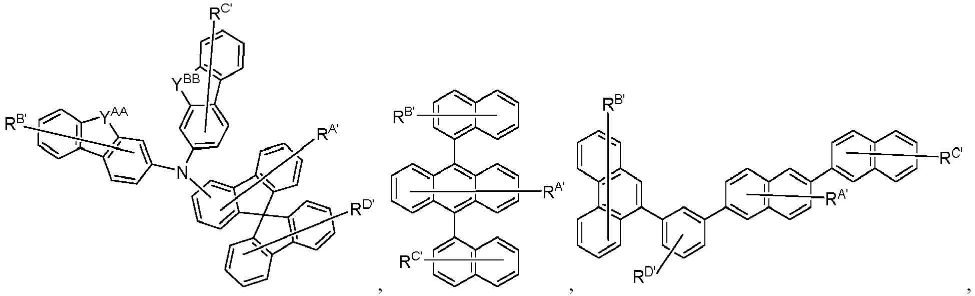 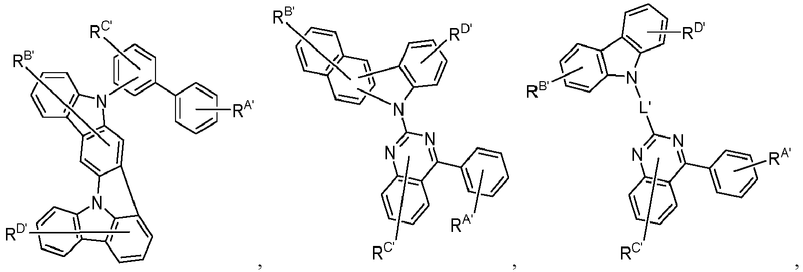 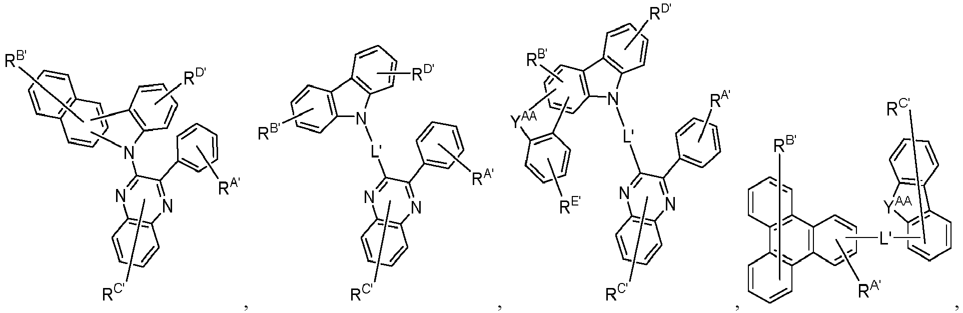 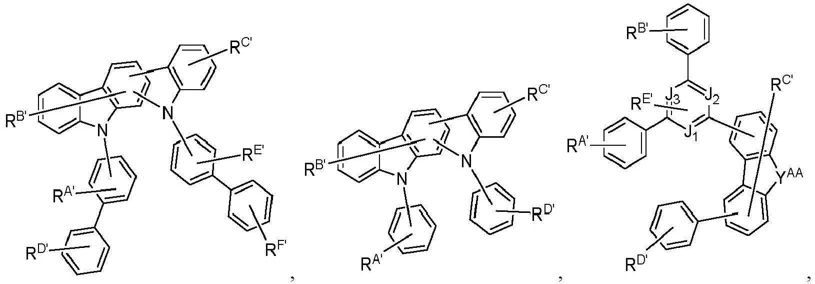 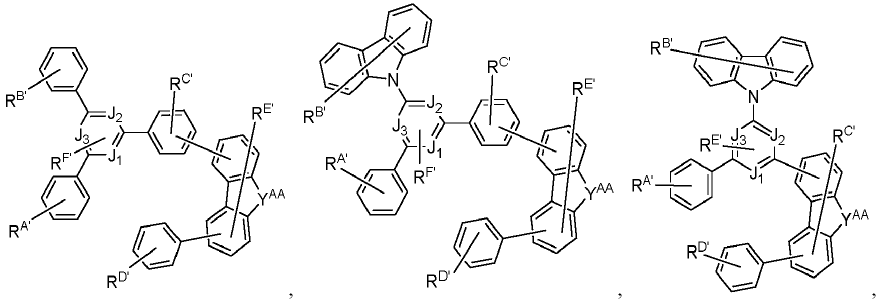 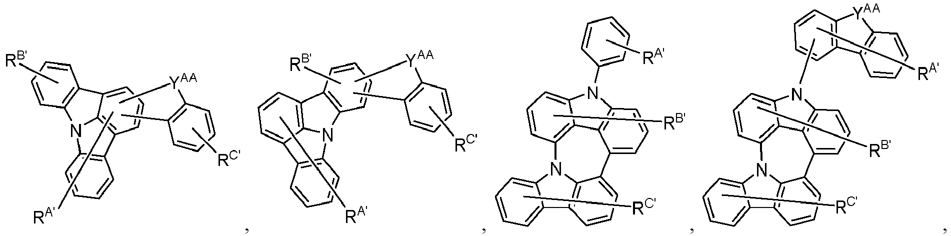 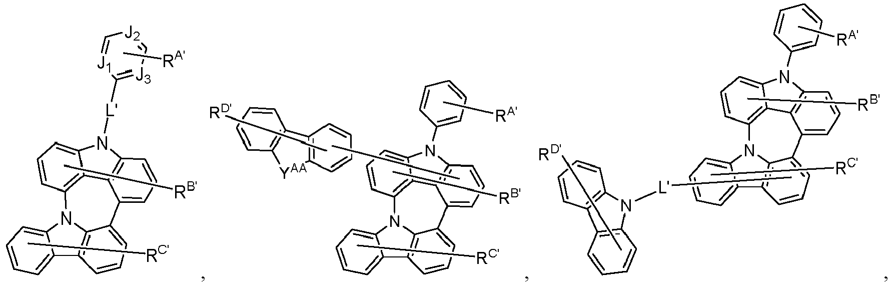 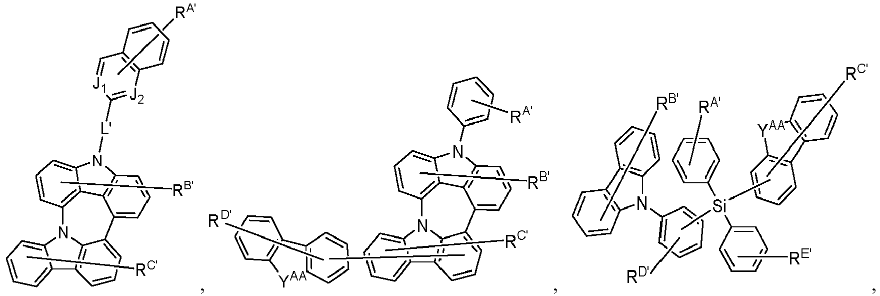 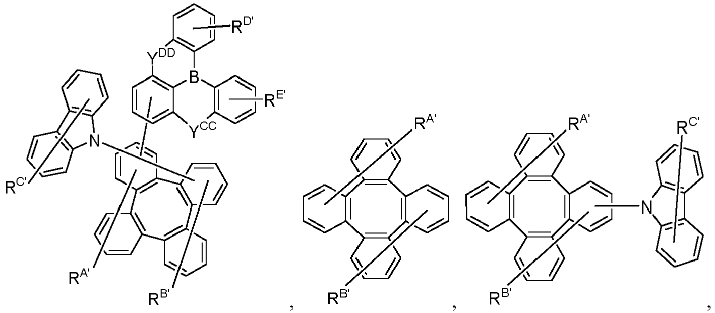 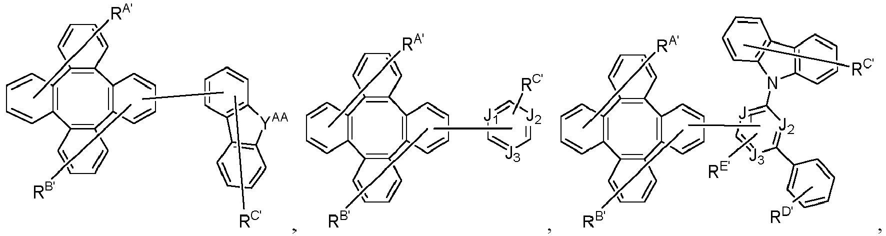 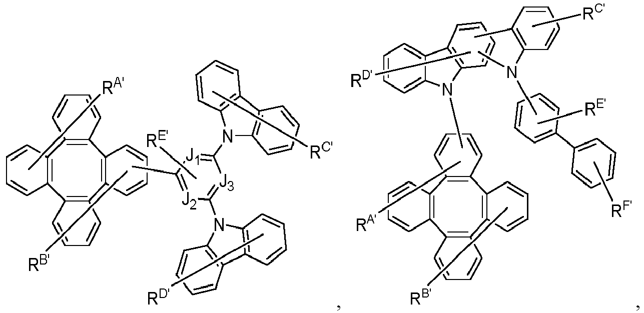 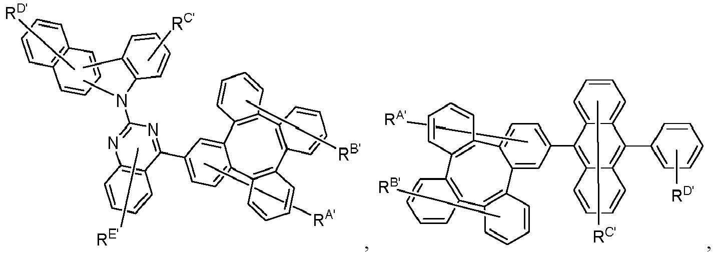 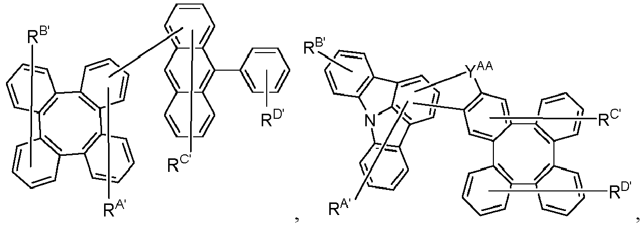 and 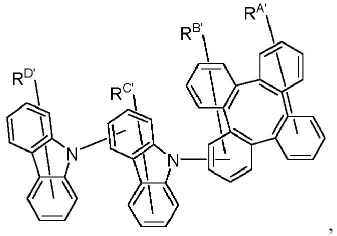 wherein:
each of J₁ to J₆ is independently C or N;
L' is a direct bond or an organic linker;
each Y^{AA}, Y^{BB}, Y^{CC}, and Y^{DD} is independently selected from the group consisting of absent a bond, direct bond, O, S, Se, CRR', SiRR', GeRR', NR, BR, BRR';
each of R^{A'}, R^{B'}, R^{C'}, R^{D'}, R^{E'}, R^{F'}, and R^{G'} independently represents mono, up to the maximum substitutions, or no substitutions;
each R, R', R^{A'}, R^{B'}, R^{C'}, R^{D'}, R^{E'}, R^{F'}, and R^{G'} is independently a hydrogen or a substituent selected from the group consisting of the general substituents as defined herein; any two substituents can be joined or fused to form a ring;
and where possible, each unsubstituted aromatic carbon atom is optionally replaced with N to form an aza-substituted ring.

In some embodiments at least one of J₁ to J₃ is N. In some embodiments, at least two of J₁ to J₃ are N. In some embodiments, all three of J₁ to J₃ are N. In some embodiments, each Y^{CC} and Y^{DD} are preferably O, S, and SiRR', or even more preferably O, or S. In some embodiments, at least one unsubstituted aromatic carbon atom is replaced with N to form an aza-ring.

In some embodiments, the third compound and/or the second host may be selected from the group consisting of:

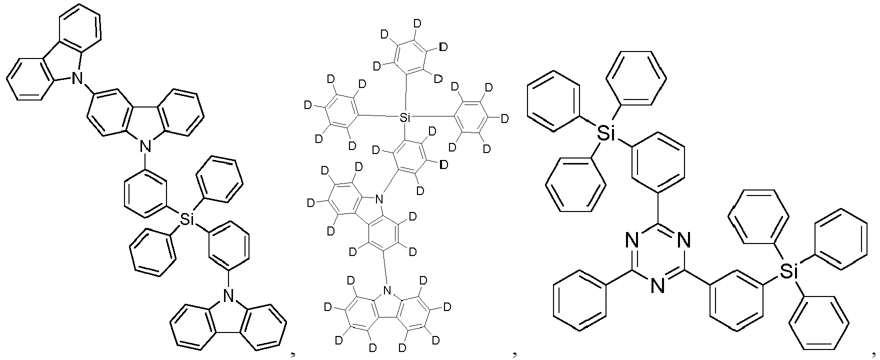

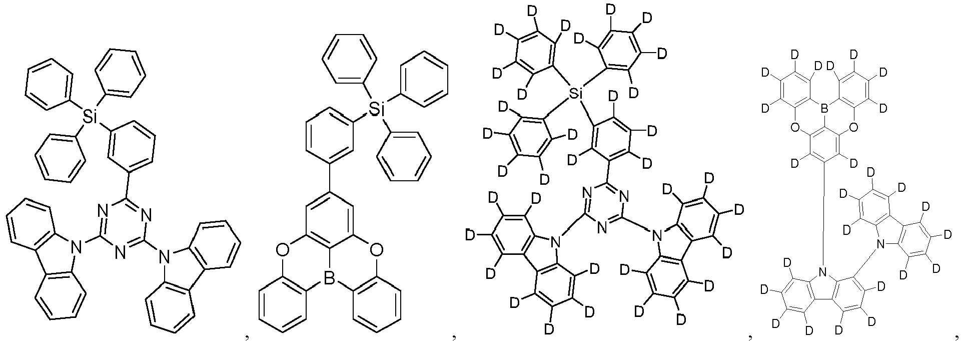

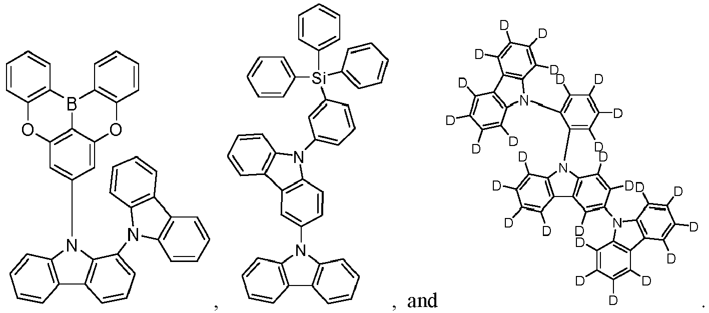

In some embodiments, the HOMO level of the second compound is deeper than at least one selected from the first compound and the third compound.

In some embodiments, the distance between the center of mass of the second compound and the first compound is at least 0.7 5nm. In some embodiments, the distance between the center of mass of the second compound and the first compound is at least 1.0 nm. In some embodiments, the distance between the center of mass of the second compound and the first compound is at least 1.5 nm. In some embodiments, the distance between the center of mass of the second compound and the first compound is at least 2.0 nm.

In some embodiments, the first compound and the second compound both has a VDR value equal or less than 0.33. In some embodiments, the first compound and the second compound both has a VDR value equal or less than 0.30. In some embodiments, the first compound and the second compound both has a VDR value equal or less than 0.25. In some embodiments, the first compound and the second compound both has a VDR value equal or less than 0.2. In some embodiments, the first compound and the second compound both has a VDR value equal or less than 0.15. In some embodiments, the first compound and the second compound both has a VDR value equal or less than 0.10.

In some embodiments, the first compound and the second compound both has a VDR value equal or greater than 0.4. In some embodiments, the first compound and the second compound both has a VDR value equal or greater than 0.5. In some embodiments, the first compound and the second compound both has a VDR value equal or greater than 0.6. In some embodiments, the first compound and the second compound both has a VDR value equal or greater than 0.7.

In some embodiments, the second compound has a VDR great than 0.5 and the 1st compound has a VDR smaller than the second compound. In some embodiments, the second compound has a VDR great than 0.3 and the 1st compound has a VDR smaller than the second compound. In some embodiments, the second compound has a VDR great than 0.1 and the 1st compound has a VDR smaller than the second compound.

In some embodiments, the second compound has a VDR value equal or less than 0.33; and at least one of the first and third compounds has a VDR value larger than 0.33.

In some embodiments, the second compound has a VDR value equal or greater than 0.33; and at least one of the first and third compounds has a VDR value less than 0.33.

In some embodiments, the emissive region further comprises a second host. In some embodiments, the second host has a HOMO level that is shallower than that of the second compound.

In some embodiments, the first compound can be in a layer separate from the second compound in the emissive region or the first compound can be in a layer mixed with the second compound,
wherein the concentration of the first compound in the layer containing the first compound is in the range of 1 to 50 % by weight. In some embodiments, the concentration of the first compound in the layer containing the first compound is in the range of 5 to 40 % by weight. the concentration of the first compound in the layer containing the first compound is in the range of 10 to 20 % by weight. the concentration of the first compound in the layer containing the first compound is in the range of 12 to 15 % by weight.

In some embodiments, the second compound can be in a layer separate from the first compound in the emissive region or the second compound can be in a layer mixed with the first compound,
wherein the concentration of the second compound in the layer containing the second compound is in the range of 0.1 to 10 % by weight. In some embodiments, the concentration of the second compound in the layer containing the second compound is in the range of 0.5 to 5 % by weight. the concentration of the second compound in the layer containing the second compound is in the range of 1 to 3 % by weight.

In some embodiments, the OLED emits a luminescent radiation at room temperature when a voltage is applied across the device; wherein the luminescent radiation comprises a first radiation component contributed from the second compound with an emission λₘₐₓ of 340 to 500 nm.

In some embodiments, the OLED emits a luminescent radiation at room temperature when a voltage is applied across the device; wherein the luminescent radiation comprises a first radiation component contributed from the second compound with an emission λₘₐₓ of 500 to 600 nm.

In some embodiments, the OLED emits a luminescent radiation at room temperature when a voltage is applied across the device; wherein the luminescent radiation comprises a first radiation component contributed from the second compound with an emission λₘₐₓ of 600 to 900 nm.

In some embodiments, the OLED emits a luminescent radiation at room temperature when a voltage is applied across the device; wherein the luminescent radiation comprises a first radiation component contributed from the second compound with a FWHM of 50 nm or less. In some embodiments, the FWHM is 40 nm or less. In some embodiments, the FWHM is 35 nm or less. In some embodiments, the FWHM is 30 nm or less. In some embodiments, the FWHM is 25 nm or less. In some embodiments, the FWHM is 20 nm or less. In some embodiments, the FWHM is 15 nm or less. In some embodiments, the FWHM is 10 nm or less. In some embodiments, the FWHM is 5 nm or less.

In some embodiments, the OLED emits a luminescent radiation at room temperature when a voltage is applied across the device; wherein the luminescent radiation comprises a first radiation component contributed from the second compound with a 10% onset of the emission peak is less than 465 nm. In some embodiments, the luminescent radiation comprises a first radiation component contributed from the second compound with a 10% onset of the emission peak is less than 460 nm. In some embodiments, the luminescent radiation comprises a first radiation component contributed from the second compound with a 10% onset of the emission peak is less than 455 nm. In some embodiments, the luminescent radiation comprises a first radiation component contributed from the second compound with a 10% onset of the emission peak is less than 450 nm.

To reduce the amount of Dexter energy transfer between the sensitizer compound and the acceptor compound, it would be preferable to have a large distance between the center of mass of the sensitizer compound and the center of mass of the closest neighboring acceptor compound in the emissive region. Therefore, in some embodiments, the distance between the center of mass of the acceptor compound and the center of mass of the sensitizer compound is at least 2, 1.5, 1.0, or 0.75 nm.

Preferred acceptor/sensitizer VDR combination (A): In some embodiments, it is preferable for the VDR of the acceptor to be less than 0.33 in order to reduce the coupling of the transition dipole moment of the emitting acceptor to the plasmon modes, compared to an isotropic emitter, in order to achieve a higher outcoupling efficiency. In some cases, when the VDR of the acceptor is less than 0.33, it would be preferable for the VDR of the sensitizer to be less than 0.33 in order to improve the coupling of the transition dipole moments of the sensitizer and acceptor to optimize the Forster energy transfer rate. Accordingly, in some embodiments of the inventive OLED, the acceptor compound in the inventive OLED exhibits a VDR value equal to or less than 0.33, 0.30, 0.25, 0.2, 0.15, 0.10, 0.08, or 0.05 when the VDR is measured with an emissive thin film test sample that has the acceptor compound as the only emitter; and the sensitizer compound in the inventive OLED exhibits a VDR value equal to or less than 0.33, 0.30, 0.25, 0.2, 0.15, 0.10, 0.08, or 0.05 when the VDR is measured with an emissive thin film test sample that has the sensitizer compound as the only emitter.

Preferred acceptor/sensitizer VDR combination (B): In some embodiments, it is preferable for the VDR of the acceptor to be less than 0.33 in order to reduce the coupling of the transition dipole moment of the emitting acceptor to the plasmon modes compared to an isotropic emitter in order to achieve a higher outcoupling efficiency. In some cases, when the VDR of the acceptor is less than 0.33, it would be preferable to minimize the intermolecular interactions between the sensitizer and acceptor to decrease the degree of Dexter quenching. By changing the molecular geometry of the sensitizer to reduce the intermolecular interactions, it may be preferable to have a sensitizer with a VDR greater than 0.33. Accordingly, in some embodiments of the inventive OLED, the acceptor compound in the inventive OLED exhibits a VDR value equal to or less than 0.33, 0.30, 0.25, 0.2, 0.15, 0.10, 0.08, or 0.05 when the VDR is measured with an emissive thin film test sample that has the acceptor compound as the only emitter; and the sensitizer compound in the inventive OLED exhibits a VDR value larger than 0.33, 0.4, 0.5, 0.6, or 0.7 when the VDR is measured with an emissive thin film test sample that has the sensitizer compound as the only emitter.

Preferred acceptor/sensitizer VDR combination (C): In some embodiments, it is preferable for the VDR of the acceptor to be greater than 0.33 in order to increase the coupling of the transition dipole moment of the acceptor to the plasmon modes compared to an isotropic emitter in order to decrease the transient lifetime of the excited states in the emissive layer. In some cases, the increased coupling to the plasmon modes can be paired with an enhancement layer in a plasmonic OLED device to improve efficiency and extend operational lifetime. In some cases, when the VDR of the acceptor is greater than 0.33, it would be preferable to minimize the intermolecular interactions between the sensitizer and acceptor to decrease the degree of Dexter quenching. By changing the molecular geometry of the sensitizer to reduce the intermolecular interactions, it may be preferable to have a sensitizer with a VDR less than 0.33. Accordingly, in some embodiments of the inventive OLED, the acceptor compound in the inventive OLED exhibits a VDR value larger than 0.33, 0.4, 0.5, 0.6, or 0.7 when the VDR is measured with an emissive thin film test sample that has the acceptor compound as the only emitter; and the sensitizer compound in the inventive OLED exhibits a VDR value equal to or less than 0.33, 0.30, 0.25, 0.2, 0.15, 0.10, 0.08, or 0.05 when the VDR is measured with an emissive thin film test sample that has the sensitizer compound as the only emitter.

Preferred acceptor/sensitizer VDR combination (D): In some embodiments, it is preferable for the VDR of the acceptor to be greater than 0.33 in order to increase the coupling of the transition dipole moment of the acceptor to the plasmon modes compared to an isotropic emitter in order to decrease the transient lifetime of the excited states in the emissive layer. In some cases, the increased coupling to the plasmon modes can be paired with an enhancement layer in a plasmonic OLED device to improve efficiency and extend operational lifetime. In some cases, when the VDR of the acceptor is greater than 0.33, it would be preferable for the VDR of the sensitizer to be greater than 0.33 in order to improve the coupling of the transition dipole moments of the sensitizer and acceptor to optimize the Forster energy transfer rate. Accordingly, in some embodiments of the inventive OLED, the acceptor compound in the inventive OLED exhibits a VDR value larger than 0.33, 0.4, 0.5, 0.6, or 0.7 when the VDR is measured with an emissive thin film test sample that has the acceptor compound as the only emitter; and the sensitizer compound in the inventive OLED exhibits a VDR value larger than 0.33, 0.4, 0.5, 0.6, or 0.7 when the VDR is measured with an emissive thin film test sample that has the sensitizer compound as the only emitter.

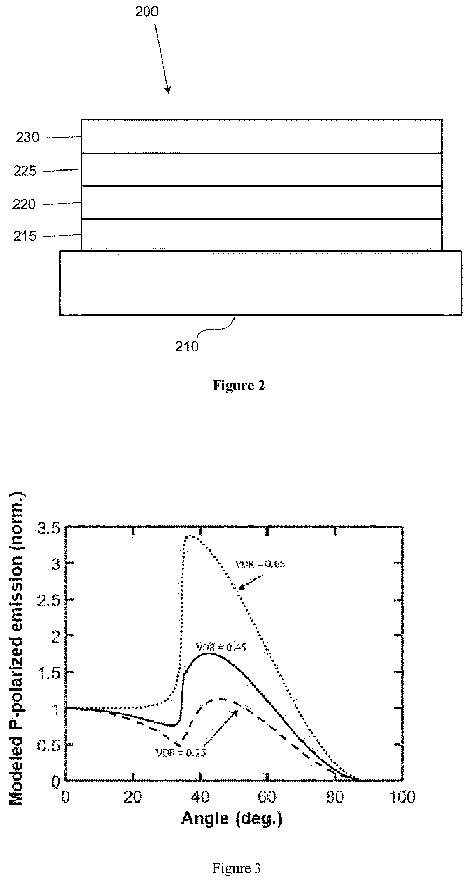

VDR is the ensemble average fraction of vertically oriented molecular dipoles of the light-emitting compound in a thin film sample of an emissive layer, where the orientation "vertical" is relative to the plane of the surface of the substrate (i.e., normal to the surface of the substrate plane) on which the thin film sample is formed. A similar concept is horizontal dipole ratio (HDR) which is the ensemble average fraction of horizontally oriented molecular dipoles of the light-emitting compound in a thin film sample of an emissive layer, where the orientation "horizontal" is relative to the plane of the surface of the substrate (i.e., parallel to the surface of the substrate plane) on which the thin film sample is formed. By definition, VDR+HDR = 1. VDR can be measured by angle dependent, polarization dependent, photoluminescence measurements. By comparing the measured emission pattern of a photoexcited thin film test sample, as a function of polarization, to the computationally modeled pattern, one can determine VDR of the thin film test sample emission layer. For example, a modelled data of p-polarized emission is shown in FIG. 3. The modelled p-polarized angle photoluminescence (PL) is plotted for emitters with different VDRs. A peak in the modelled PL is observed in the p-polarized PL around the angle of 45 degrees with the peak PL being greater when the VDR of the emitter is higher.

To measure VDR values of the thin film test samples, a thin film test sample can be formed with the acceptor compound or the sensitizer compound (depending on whether the VDR of the acceptor compound or the sensitizer compound is being measured) as the only emitter in the thin film and a Reference Host Compound A as the host. Preferably, the Reference Host Compound A is 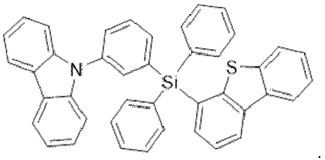 The thin film test sample is formed by thermally evaporating the emitter compound and the host compound on a substrate. For example, the emitter compound and the host compound can be co-evaporated. In some embodiments, the doping level of the emitter compounds in the host can be from 0.1 wt. % to 50 wt. %. In some embodiments, the doping level of the emitter compounds in the host can be from 3 wt. % to 20 wt. % for blue emitters. In some embodiments, the doping level of the emitter compounds in the host can be from 1 wt. % to 15 wt. % for red and green emitters. The thickness of the thermally evaporated thin film test sample can have a thickness of from 50 to 1000 Å.

In some embodiments, the OLED of the present disclosure can comprise a sensitizer, an acceptor, and one or more hosts in the emissive region, and the preferred acceptor/sensitizer VDR combinations (A) - (D) mentioned above are still applicable. In these embodiments, the VDR values for the acceptor compound can be measured with a thin film test sample formed of the one or more hosts and the acceptor, where the acceptor is the only emitter in the thin film test sample. Similarly, the VDR values for the sensitizer compound can be measured with a thin film test sample formed of the one or more hosts and the sensitizer, where the sensitizer is the only emitter in the thin film test sample.

In the example used to generate FIG. 3, a 30 nm thick film of material with a refractive index of 1.75 and the emission is monitored in a semi-infinite medium with a refractive index of 1.75. Each curve is normalized to a photoluminescence intensity of 1 at an angle of zero degrees, which is perpendicular to the surface of the film. As the VDR of the emitter is varied, the peak around 45 degrees increases greatly. When using a software to fit the VDR of experimental data, the modeled VDR would be varied until the difference between the modeled data and the experimental data is minimized.

Because the VDR represents the average dipole orientation of the light-emitting compound in the thin film sample, even if there are additional emission capable compounds in the emissive layer, if they are not contributing to the light emission, the VDR measurement does not reflect their VDR. Further, by inclusion of a host material that interacts with the light-emitting compound, the VDR of the light-emitting compound can be modified. Thus, a light-emitting compound in a thin film sample with host material A will exhibit one measured VDR value and that same light-emitting compound in a thin film sample with host material B will exhibit a different measured VDR value. Further, in some embodiments, exciplex or excimers are desirable which form emissive states between two neighboring molecules. These emissive states may have a VDR that is different than that if only one of the components of the exciplex or excimer were emitting or present in the sample.

In some embodiments, the OLED is a plasmonic OLED. In some embodiments, the OLED is a waveguided OLED.

In some embodiments, the emissive region can further include a second host. In some embodiments, the second host comprises a moiety selected from the group consisting of bicarbazole, indolocarbazole, triazine, pyrimidine, pyridine, and boryl. In some embodiments, the second host has a HOMO level that is shallower than that of the acceptor compound.

In some embodiments, the OLED emits a white light at room temperature when a voltage is applied across the device.

In some embodiments, the OLED emits a luminescent radiation at room temperature when a voltage is applied across the device; wherein the luminescent first radiation component contributed from the acceptor compound with an emission λₘₐₓ₁ being independently selected from the group consisting of larger than 340 nm to equal or less than 500 nm, larger than 500 nm to equal or less than 600 nm, and larger than 600 nm to equal or less than 900 nm. In some embodiments, the first radiation component has FWHM of 50, 40, 35, 30, 25, 20, 15, 10, or 5 nm or less. In some embodiments, the first radiation component has a 10% onset of the emission peak is less than 465, 460, 455, or 450 nm.

In some embodiments, the sensitizer compound is partially or fully deuterated. In some embodiments, the acceptor compound is partially or fully deuterated. In some embodiments, the first host is partially or fully deuterated. In some embodiments, the second host is partially or fully deuterated.

In some embodiments, the first compound (the sensitizer) and/or the second compound (the acceptor) each independently comprises at least one substituent having a spherocity greater than or equal to 0.45, 0.55, 0.65, 0.75, or 0.80. The spherocity is a measurement of the three-dimensionality of bulky groups. Spherocity is defined as the ratio between the principal moments of inertia (PMI). Specifically, spherocity is the ratio of three times PMI1 over the sum of PMI1, PMI2, and PMI3, where PMI1 is the smallest principal moment of inertia, PMI2 is the second smallest principal moment of inertia, and PMI3 is the largest principal moment of inertia. The spherocity of the lowest energy conformer of a structure after optimization of the ground state with density functional theory may be calculated. More detailed information can be found in paragraphs [0054] to [0059] of US application No. 18/062,110 filed December 6, 2022, the contents of which are incorporated herein by reference. In some embodiments, the first compound and/or the second compound each independently comprises at least one substituent having a Van der Waals volume greater than 153, 206, 259, 290, or 329 Å³. In some embodiments, the first compound and/or the second compound each independently comprises at least one substituent having a molecular weight greater than 167, 187, 259, 303, or 305 amu.

In some embodiments, one of the first and second hosts is a hole transporting host, the other one of the first and second host is an electron transporting host. In some embodiments, the first host is a hole transporting host; and wherein the first host comprises at least one chemical group selected from the group consisting of amino, carbazole, indolocarbazole, dibenzothiophene, dibenzofuran, dibenzoselenophene, and 5λ²-benzo[d]benzo[4,5]imidazo[3,2-a]imidazole. In some embodiments, the first host is an electron transporting host; and wherein the first host comprises at least one chemical group selected from the group consisting of pyridine, pyrimidine, pyrazine, pyridazine, triazine, imidazole, aza-triphenylene, aza-carbazole, aza-dibenzothiophene, aza-dibenzofuran, aza-dibenzoselenophene, 5,9-dioxa-13b-boranaphtho[3,2,1-de]anthracene, boryl, nitrile, aza-5λ²-benzo[d]benzo[4,5]imidazo[3,2-a]imidazole, and aza-(5,9-dioxa-13b-boranaphtho[3,2,1-de]anthracene). In some embodiments, one of the first and second hosts is a bipolar host comprising both hole transporting and electron transporting moieties.

In some embodiments, the OLED further comprises a color conversion layer or a color filter.

In some embodiments, a formulation can comprises at least two different compounds of the following compounds: a sensitizer compound, an acceptor compound and a host.

In some embodiments, a chemical structure selected from the group consisting of a monomer, a polymer, a macromolecule, and a supramolecule, wherein the chemical structure comprises at least two of the following components: a sensitizer compound, an acceptor compound and a host.

It should be understood that embodiments of all the compounds and devices described herein may be interchangeable if those embodiments are also applicable under different aspects of the entire disclosure.

In some embodiments, each of the sensitizer compound, the acceptor compound, the host compound described herein can be at least 10% deuterated, at least 20% deuterated, at least 30% deuterated, at least 40% deuterated, at least 50% deuterated, at least 60% deuterated, at least 70% deuterated, at least 80% deuterated, at least 90% deuterated, at least 95% deuterated, at least 99% deuterated, or 100% deuterated. As used herein, percent deuteration has its ordinary meaning and includes the percent of possible hydrogen atoms (e.g., positions that are hydrogen or deuterium) that are replaced by deuterium atoms.

In another aspect, the present disclosure provides a consumer product comprising an OLED as defined herein.

In some embodiments, the consumer product is selected from the group consisting of a flat panel display, a computer monitor, a medical monitor, a television, a billboard, a light for interior or exterior illumination and/or signaling, a heads-up display, a fully or partially transparent display, a flexible display, a laser printer, a telephone, a cell phone, tablet, a phablet, a personal digital assistant (PDA), a wearable device, a laptop computer, a digital camera, a camcorder, a viewfinder, a micro-display that is less than 2 inches diagonal, a 3-D display, a virtual reality or augmented reality display, a vehicle, a video wall comprising multiple displays tiled together, a theater or stadium screen, a light therapy device, and a sign.

### C. The Formulation, the Chemical Structure/Assembly and the Premixed Co-Evaporation Source of the Present Disclosure

In yet another aspect, the present disclosure provides a formulation comprising:
a first compound;
a second compound; and
a third compound;
wherein the first compound is a sensitizer that transfers energy to the second compound in an OLED at room temperature;
wherein the second compound is an acceptor that is an emitter in said OLED at room temperature;
wherein the third compound is a first host in said OLED at room temperature;
wherein at least two of the first, second, and the third compounds comprises same or different substituent R*;
wherein R* is selected from the group consisting of: 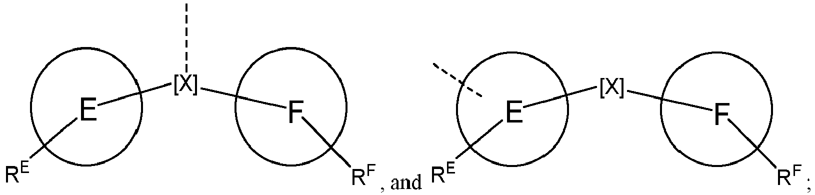
wherein
[X] is a chemical moiety comprises at least one six-membered carbocyclic, a silyl group, a germyl group, or heterocyclic ring;
moieties E and F are each independently a monocyclic ring, or a polycyclic fused ring system; wherein the monocyclic ring and each ring of the polycyclic fused ring system are independently a 5-membered or 6-membered carbocyclic or heterocyclic ring;
R^{E}, and R^{F} each independently represent mono to the maximum allowable substitution, or no substitution; wherein each R^{E}, and R^{F} is independently a hydrogen, or a substituent selected from the group consisting of the general substituents as defined herein;
any adjacent substituents are optionally joined or fused into a ring; and
wherein the formulation comprises at least two of the first, the second, and the third compounds.

In yet another aspect, the present disclosure also provides a chemical structure selected from the group consisting of a monomer, a polymer, a macromolecule, and a supramolecule, wherein the chemical structure comprises at least two of the following components:
a first compound, a monovalent or polyvalent variant thereof;
a second compound, a monovalent or polyvalent variant thereof; and
a third compound, a monovalent or polyvalent variant thereof;
wherein the first compound is a sensitizer that transfers energy to the second compound in an OLED at room temperature;
wherein the second compound is an acceptor that is an emitter in said OLED at room temperature;
wherein the third compound is a first host in said OLED at room temperature.

In some embodiments of the chemical structure, at least two of the first, second, and the third compounds comprises same or different substituent R*;
wherein R* is selected from the group consisting of: 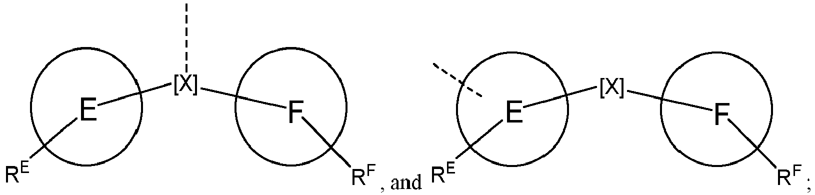
wherein
[X] is a chemical moiety comprises at least one six-membered carbocyclic, a silyl group, a germyl group, or heterocyclic ring;
moieties E and F are each independently a monocyclic ring, or a polycyclic fused ring system; wherein the monocyclic ring and each ring of the polycyclic fused ring system are independently a 5-membered or 6-membered carbocyclic or heterocyclic ring;
R^{E}, and R^{F} each independently represent mono to the maximum allowable substitution, or no substitution;
wherein each R^{E}, and R^{F} is independently a hydrogen, or a substituent selected from the group consisting of the general substituents as defined herein;
any adjacent substituents are optionally joined or fused into a ring.

In yet another aspect, the present disclosure further provides a premixed co-evaporation source that is a mixture of a first compound and a second compound;
wherein the co-evaporation source is a co-evaporation source for vacuum deposition process or OVJP process;
wherein the first compound and the second compound are differently selected from the group consisting of:
   (1) a compound being a sensitizer that transfers energy to an acceptor that is an emitter in an OLED at room temperature;
   (2) a compound being an acceptor that is the emitter in said OLED at room temperature;
   (3) a compound being a host in said OLED at room temperature;
wherein the first compound has an evaporation temperature T1 of 150 to 350 °C;
wherein the second compound has an evaporation temperature T2 of 150 to 350 °C;
wherein absolute value of T 1-T2 is less than 20 °C;
wherein the first compound has a concentration C1 in said mixture and a concentration C2 in a film formed by evaporating the mixture in a vacuum deposition tool at a constant pressure between 1×10⁻⁶ Torr to 1×10⁻⁹ Torr, at a 2A/sec deposition rate on a surface positioned at a predefined distance away from the mixture being evaporated; and
wherein absolute value of (C1-C2)/C1 is less than 5%.

In some embodiments, the premixed co-evaporation source in claim Fehler! Verweisquelle konnte nicht gefunden werden., wherein the first compound and the second compound comprise same or different substituent R*;
wherein R* is selected from the group consisting of: 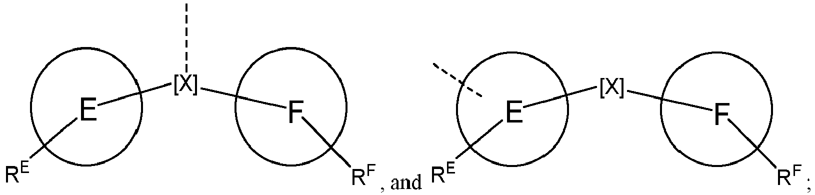
wherein
[X] is a chemical moiety comprises at least one six-membered carbocyclic, a silyl group, a germyl group, or heterocyclic ring;
moieties E and F are each independently a monocyclic ring, or a polycyclic fused ring system; wherein the monocyclic ring and each ring of the polycyclic fused ring system are independently a 5-membered or 6-membered carbocyclic or heterocyclic ring;
R^{E}, and R^{F} each independently represent mono to the maximum allowable substitution, or no substitution;
wherein each R^{E}, and R^{F} is independently a hydrogen, or a substituent selected from the group consisting of the general substituents as defined herein;
any adjacent substituents are optionally joined or fused into a ring.

In some embodiments of the premixed co-evaporation source, the first compound is a compound being capable of functioning as a phosphorescent emitter in an OLED at room temperature; wherein the second compound is a delayed-fluorescent compound functioning as a TADF emitter in the OLED at room temperature.

In some embodiments of the premixed co-evaporation source, the first compound is a compound being capable of functioning as a phosphorescent emitter in an OLED at room temperature; wherein the second compound is a fluorescent compound functioning as a fluorescent emitter in the OLED at room temperature.

In some embodiments of the premixed co-evaporation source, the first compound is capable of functioning as a TADF emitter in an organic light emitting device at room temperature; wherein the second compound is a fluorescent compound functioning as a fluorescent emitter in the OLED at room temperature.

In some embodiments of the premixed co-evaporation source, the mixture further comprises a third compound;
wherein the third compound is different from the first and the second compound, and is selected from the same group;
wherein the third compound has an evaporation temperature T3 of 150 to 350 °C, and wherein absolute value of T 1-T3 is less than 20 °C.

In some embodiments of the premixed co-evaporation source, the first compound has evaporation temperature T₁ of 200 to 350 °C and the second compound has evaporation temperature T₂ of 200 to 350 °C.

In some embodiments of the premixed co-evaporation source, absolute value of (C₁-C₂)/C₁ is less than 3%.

In some embodiments of the premixed co-evaporation source, the first compound has a vapor pressure of P₁ at T₁ at 1 atm, and the second compound has a vapor pressure of P₂ at T₂ at 1 atm; and wherein the ratio of P₁/P₂ is within the range of 0.90:1 to 1.10:1.

In some embodiments of the premixed co-evaporation source, the first compound has a first mass loss rate and the second compound has a second mass loss rate, wherein the ratio between the first mass loss rate and the second mass loss rate is within the range of 0.90:1 to 1.10: 1. In some embodiments, the ratio between the first mass loss rate and the second mass loss rate is within the range of 0.95:1 to 1.05:1. In some embodiments, the ratio between the first mass loss rate and the second mass loss rate is within the range of 0.97:1 to 1.03:1.

In some embodiments of the premixed co-evaporation source, the first compound and the second compound each has a purity in excess of 99 % as determined by high pressure liquid chromatography.

In some embodiments of the premixed co-evaporation source, the composition is in liquid form at a temperature less than the lesser of T₁ and T₂.

### D. Methods of Making the OLEDs of the Present Disclosure

In yet another aspect, the present disclosure also provides a method for fabricating an organic light emitting device, the method comprising:
providing a substrate having a first electrode disposed thereon;
depositing a first organic layer over the first electrode by evaporating a pre-mixed co-evaporation source that is a mixture of a first compound and a second compound in a high vacuum deposition tool with a chamber base pressure between 1×10⁻⁶ Torr to 1×10⁻⁹ Torr; and
depositing a second electrode over the first organic layer,
wherein the first compound and the second compound are differently selected from the group consisting of:
   (1) a compound being a sensitizer that transfers energy to an acceptor that is an emitter in an OLED at room temperature;
   (2) a compound being an acceptor that is the emitter in said OLED at room temperature;
   (3) a compound being a host in said OLED at room temperature;
wherein the first compound has an evaporation temperature T1 of 150 to 350 °C;
wherein the second compound has an evaporation temperature T2 of 150 to 350 °C;
wherein absolute value of T1-T2 is less than 20 °C;
wherein the first compound has a concentration C1 in said mixture and a concentration C2 in a film formed by evaporating the mixture in a vacuum deposition tool at a constant pressure between 1×10⁻⁶ Torr to 1×10⁻⁹ Torr, at a 2Å/sec deposition rate on a surface positioned at a predefined distance away from the mixture being evaporated; and
wherein absolute value of (C1-C2)/C1 is less than 5%.

In some embodiments of the method, the first compound and the second compound comprise same or different substituent R*;
wherein R* is selected from the group consisting of: 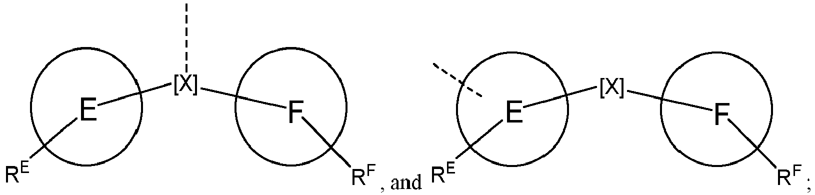
wherein
[X] is a chemical moiety comprises at least one six-membered carbocyclic silyl group, a germyl group, or heterocyclic ring;
moieties E and F are each independently a monocyclic ring, or a polycyclic fused ring system; wherein the monocyclic ring and each ring of the polycyclic fused ring system are independently a 5-membered or 6-membered carbocyclic or heterocyclic ring;
R^{E}, and R^{F} each independently represent mono to the maximum allowable substitution, or no substitution; wherein each R^{E}, and R^{F} is independently a hydrogen, or a substituent selected from the group consisting of the general substituents as defined herein;
any adjacent substituents are optionally joined or fused into a ring.

### E. Other Aspects of the OLEDs of the Present Disclosure

In some embodiments, the OLED may further comprise an additional host, wherein the additional host comprises a triphenylene containing benzo-fused thiophene or benzo-fused furan, wherein any substituent in the host is an unfused substituent independently selected from the group consisting of CₙH₂ₙ₊₁, OCₙH₂ₙ₊₁, OAr₁, N(CₙH₂ₙ₊₁)₂, N(Ar₁)(Ar₂), CH=CH-CₙH₂ₙ₊₁, C=CCₙH₂ₙ₊₁, Ar₁, Ar₁-Ar₂, CₙH₂ₙ-Ar₁, or no substitution, wherein n is an integer from 1 to 10; and wherein Ar₁ and Ar₂ are independently selected from the group consisting of benzene, biphenyl, naphthalene, triphenylene, carbazole, and heteroaromatic analogs thereof.

In some embodiments, the additional host comprises at least one chemical group selected from the group consisting of triphenylene, carbazole, indolocarbazole, dibenzothiophene, dibenzofuran, dibenzoselenophene, 5λ2-benzo[d]benzo[4,5]imidazo[3,2-a]imidazole, 5,9-dioxa-13b-boranaphtho[3,2,1-de]anthracene, triazine, boryl, silyl, aza-triphenylene, aza-carbazole, aza-indolocarbazole, aza-dibenzothiophene, aza-dibenzofuran, aza-dibenzoselenophene, aza-5λ2-benzo[d]benzo[4,5]imidazo[3,2-a]imidazole, and aza-(5,9-dioxa-13b-boranaphtho[3,2,1-de]anthracene).

In some embodiments, the additional host may be selected from the HOST Group 1 consisting of: 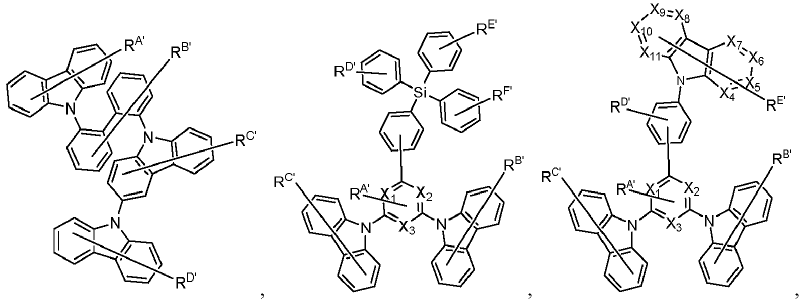 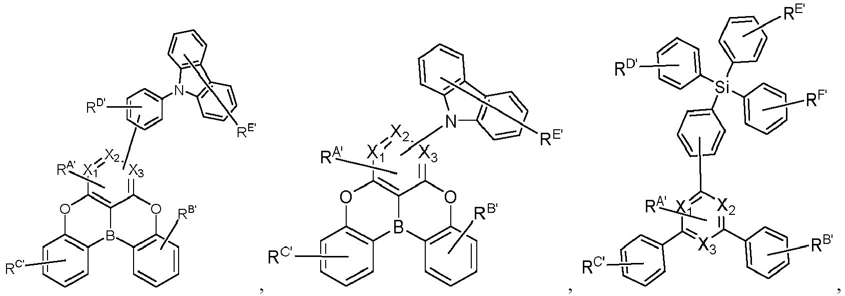 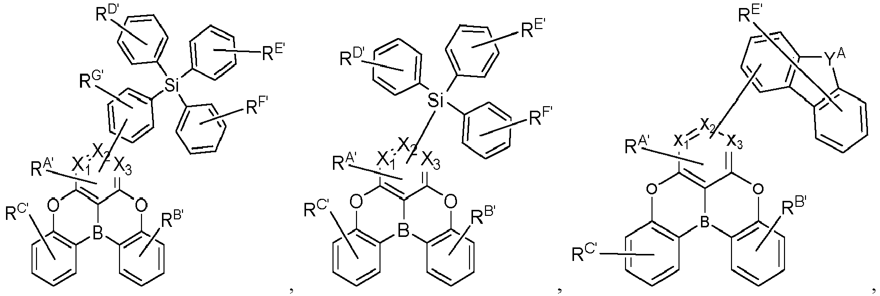 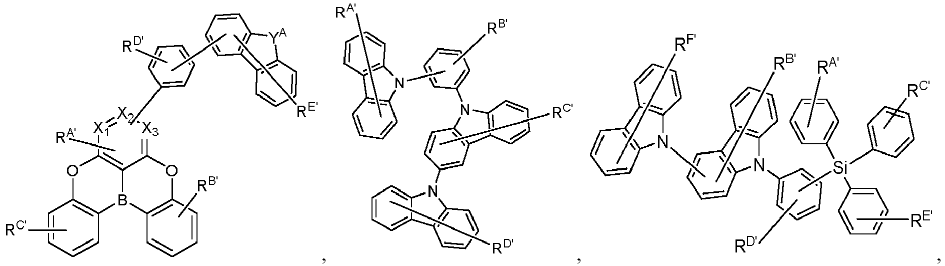 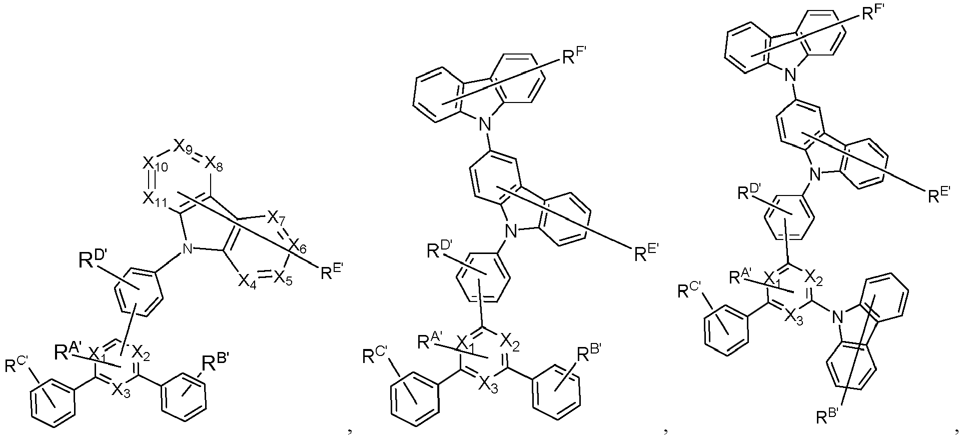 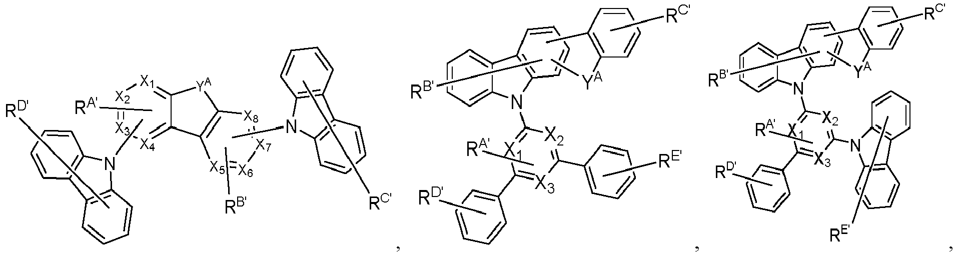 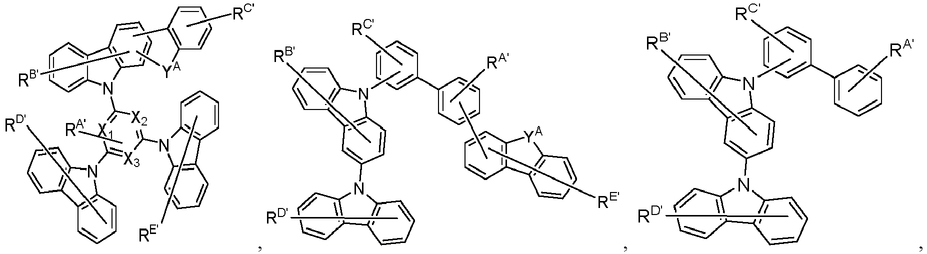 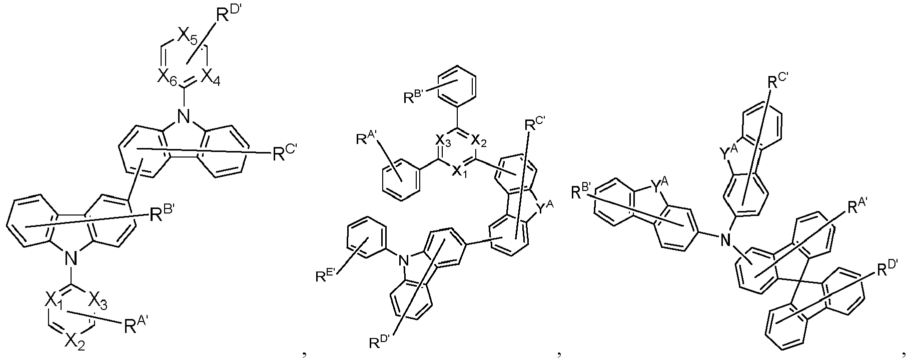 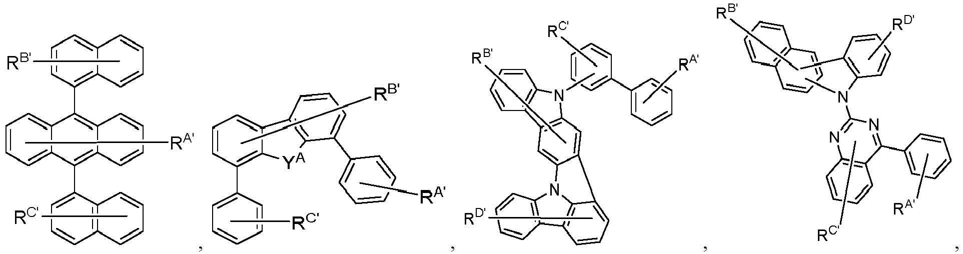 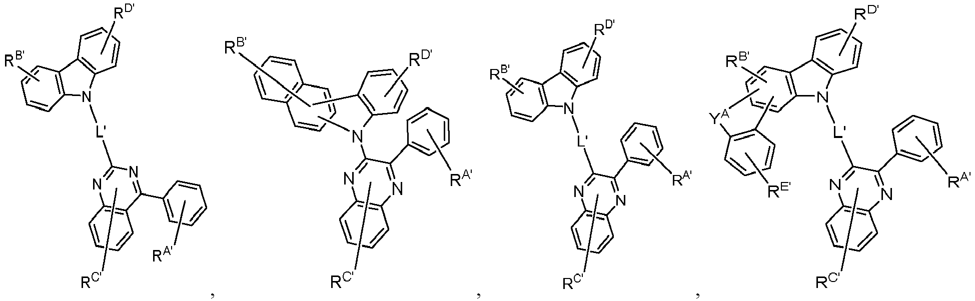 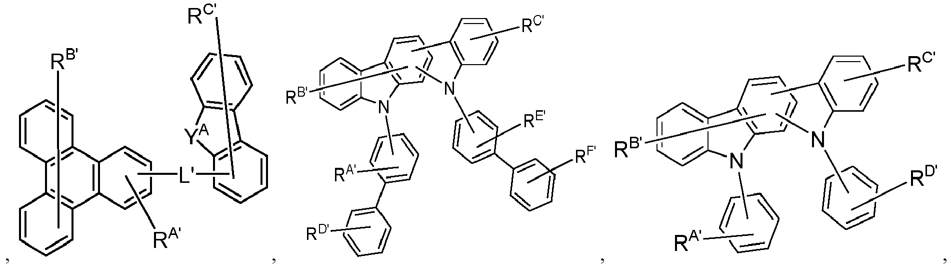 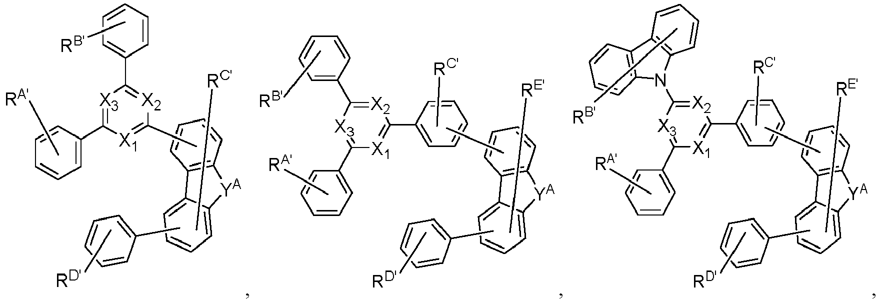 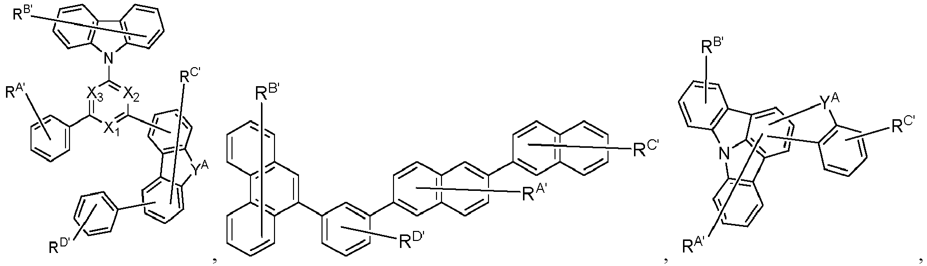 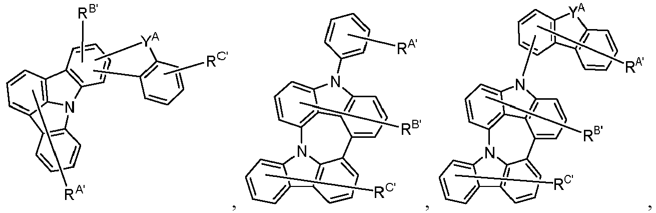 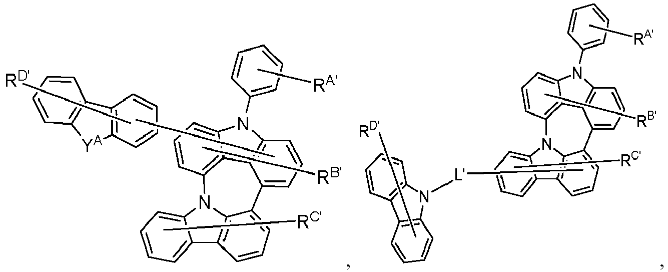 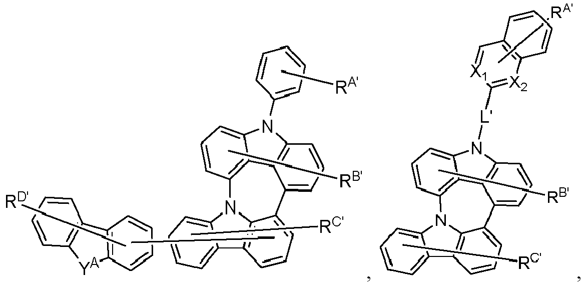 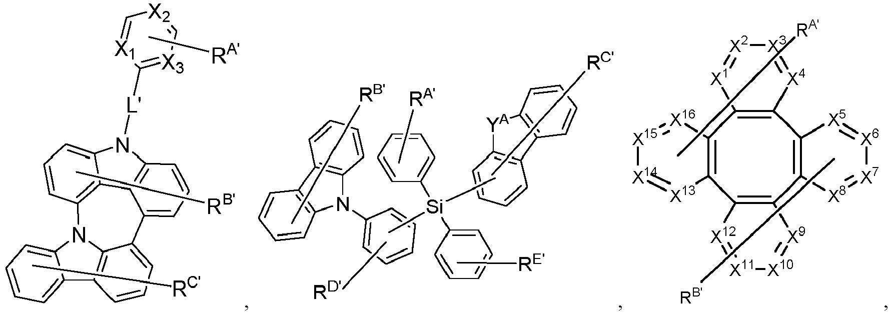 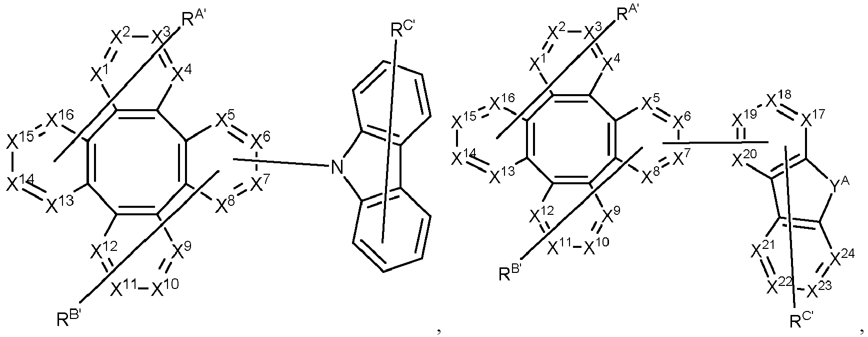 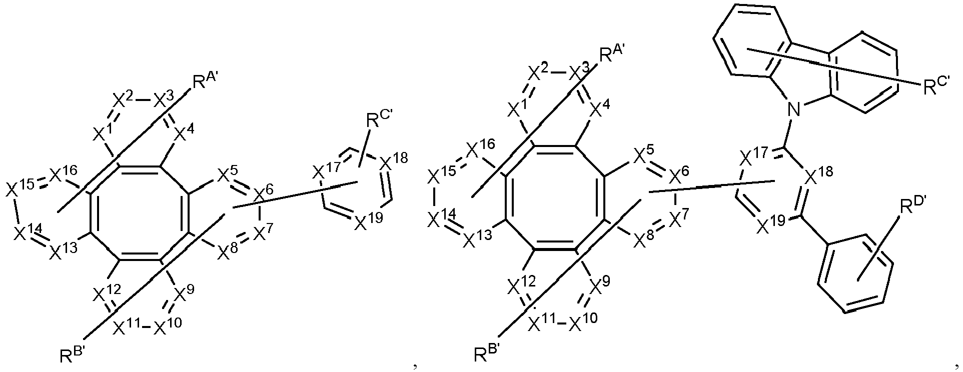 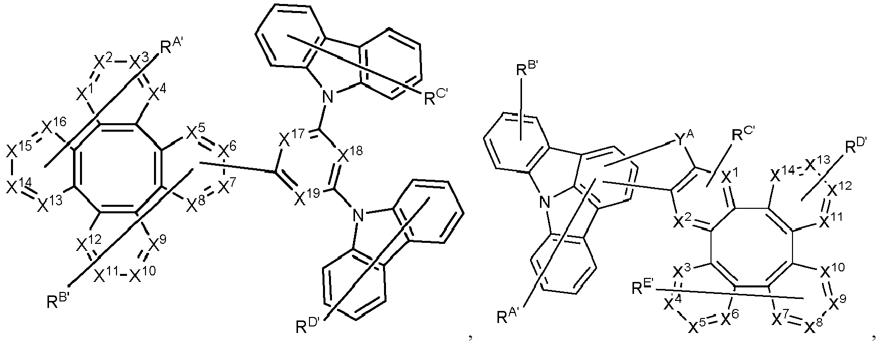 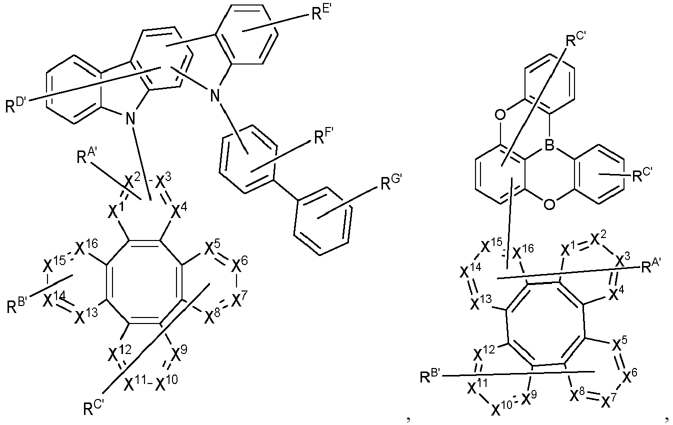 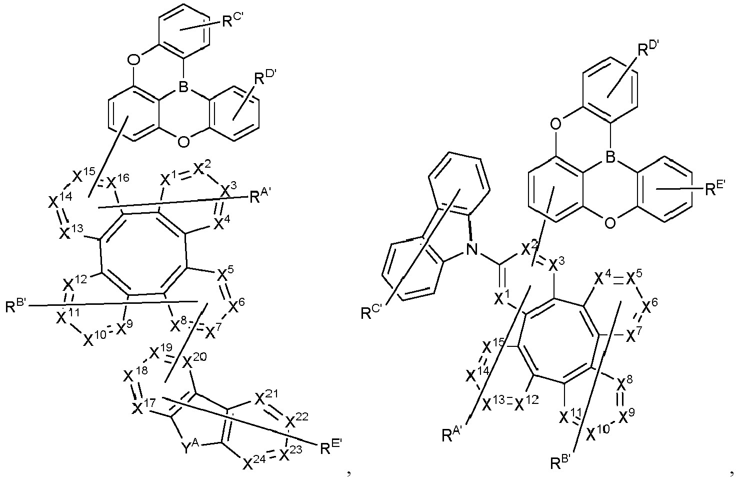 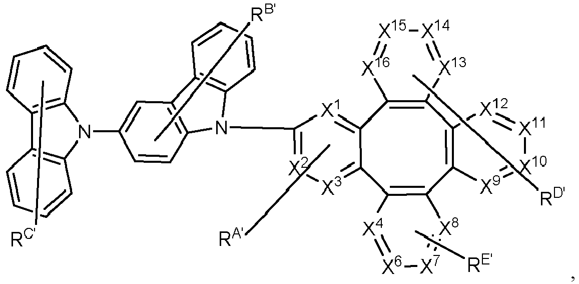 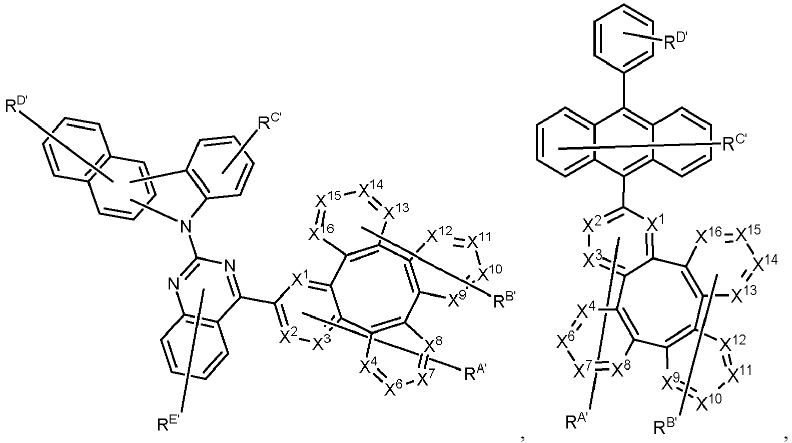 and 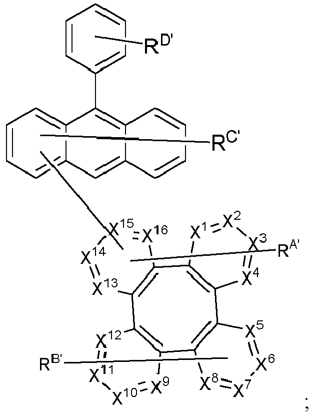 wherein:
each of X¹ to X²⁴ is independently C or N;
L' is a direct bond or an organic linker;
each Y^{A} is independently selected from the group consisting of absent a bond, O, S, Se, CRR', SiRR', GeRR', NR, BR, BRR';
each of R^{A'}, R^{B'}, R^{C'}, R^{D'}, R^{E'}, R^{F'}, and R^{G'} independently represents mono, up to the maximum substitutions, or no substitutions;
each R, R', R^{A'}, R^{B'}, R^{C'}, R^{D'}, R^{E'}, R^{F'}, and R^{G'} is independently a hydrogen or a substituent selected from the group consisting of deuterium, halogen, alkyl, cycloalkyl, heteroalkyl, heterocycloalkyl, arylalkyl, alkoxy, aryloxy, amino, silyl, germyl, selenyl, alkenyl, cycloalkenyl, heteroalkenyl, alkynyl, aryl, heteroaryl, acyl, carboxylic acid, ether, ester, nitrile, isonitrile, sulfanyl, sulfinyl, sulfonyl, phosphino, boryl, and combinations thereof; wherein the organic layer further comprises a host,
two adjacent of R^{A'}, R^{E'}, R^{C'}, R^{D'}, R^{E'}, R^{F'}, and R^{G'} are optionally joined or fused to form a ring.

In some embodiments, the additional host may be selected from the HOST Group 2 consisting of: 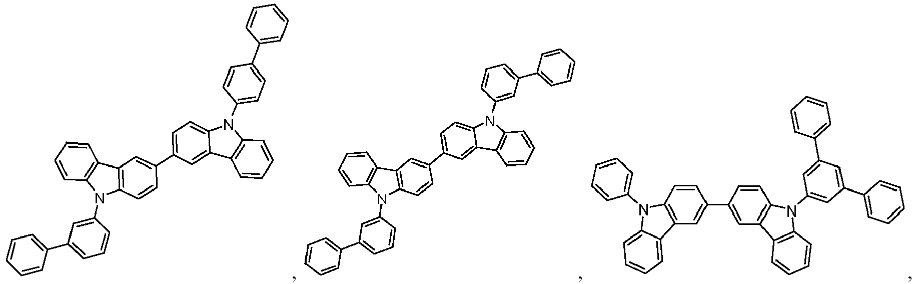 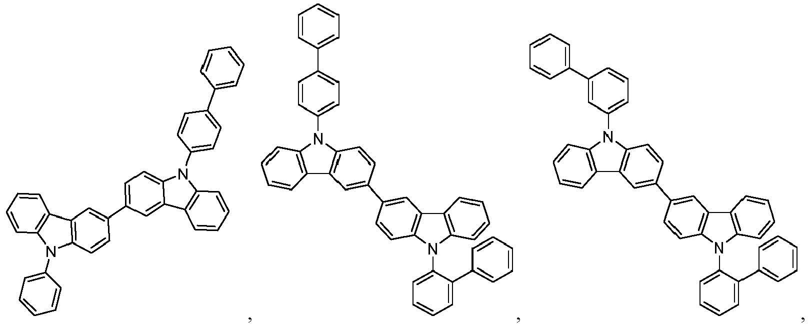 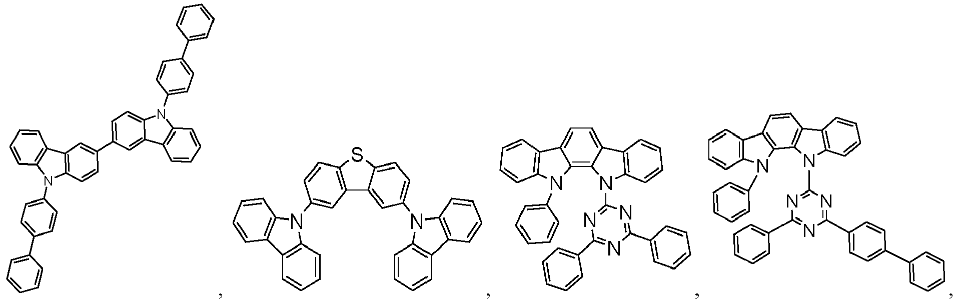 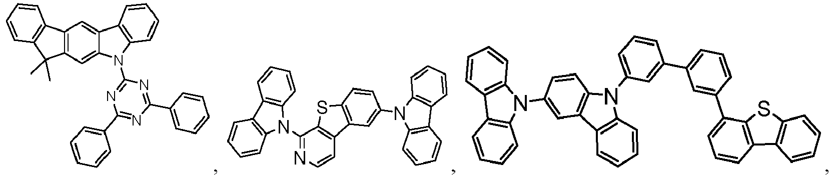 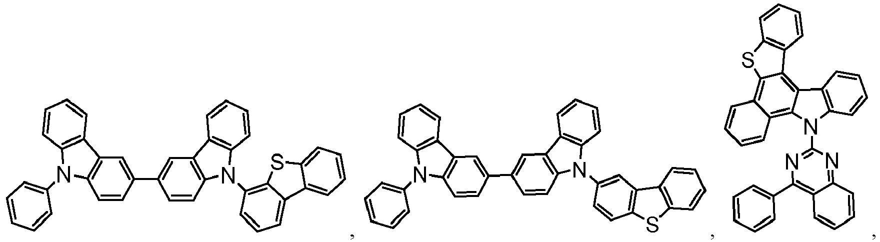 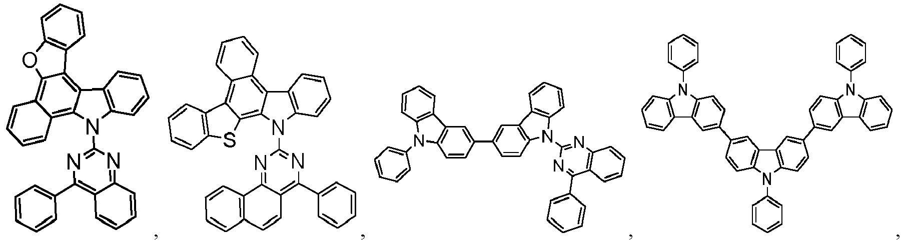 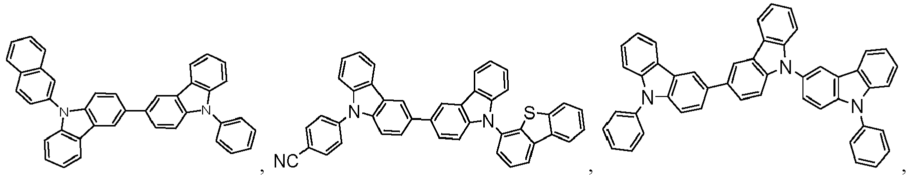 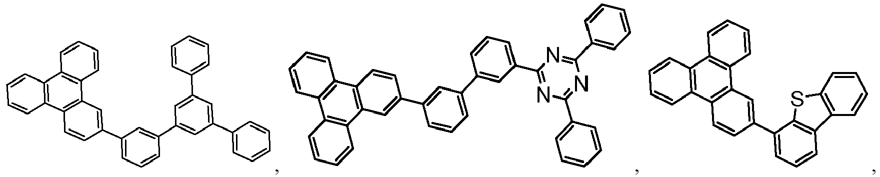 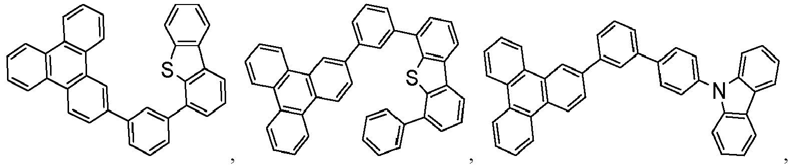 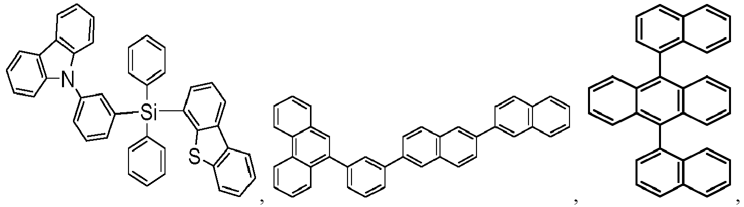 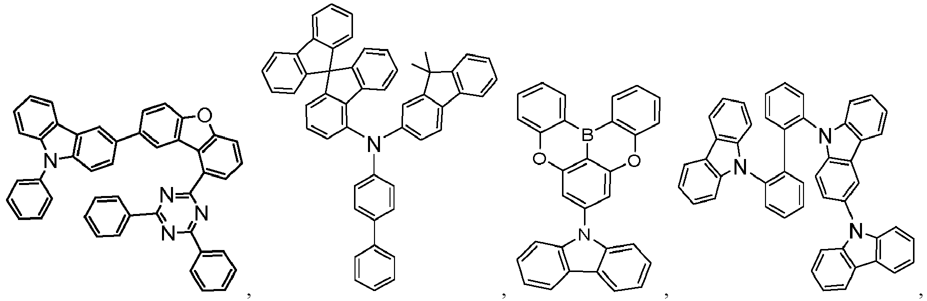 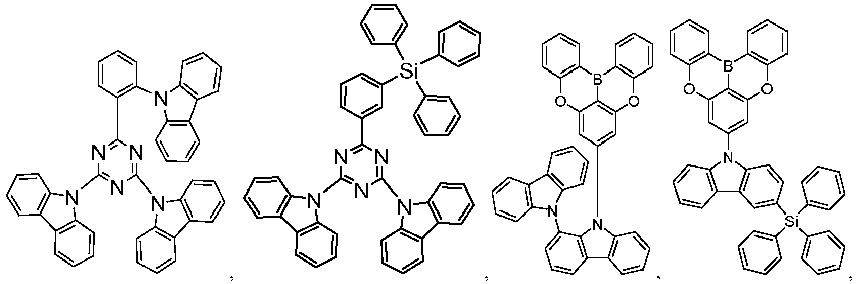 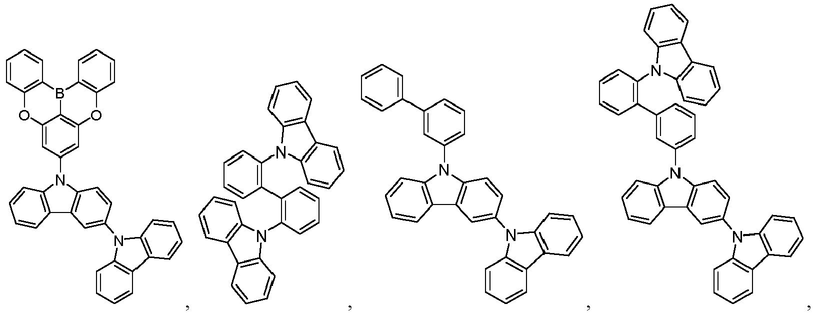 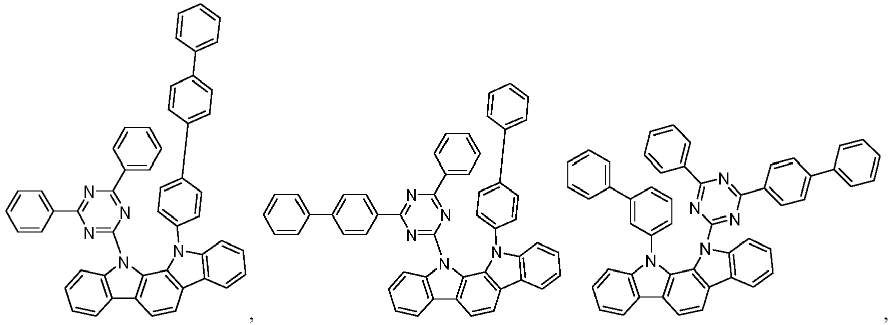 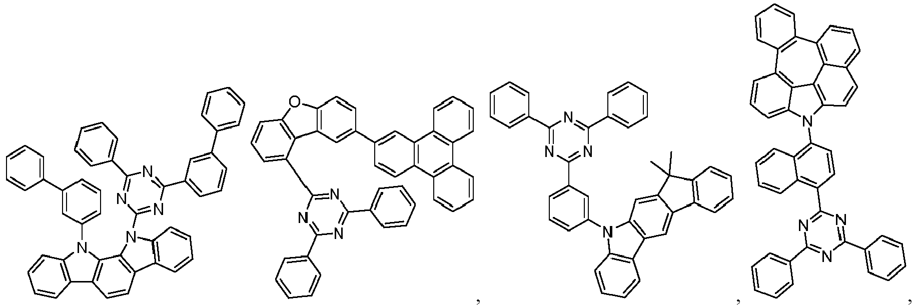 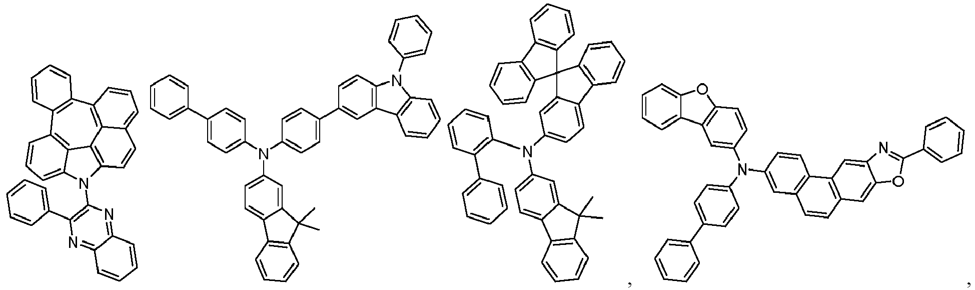 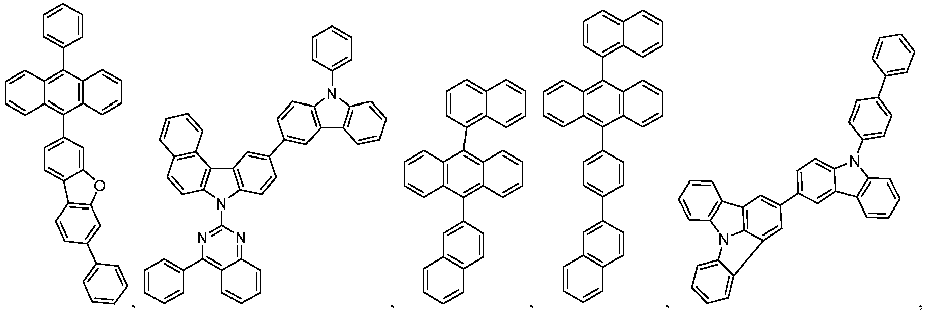 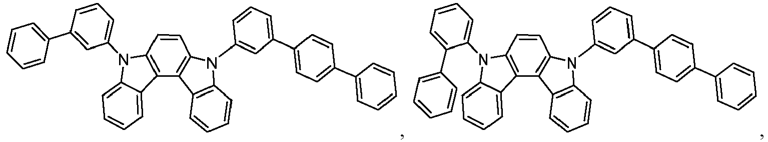 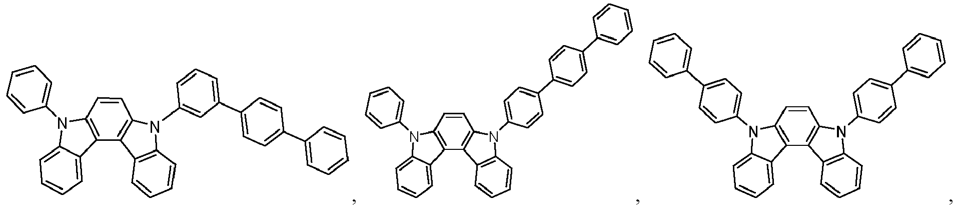 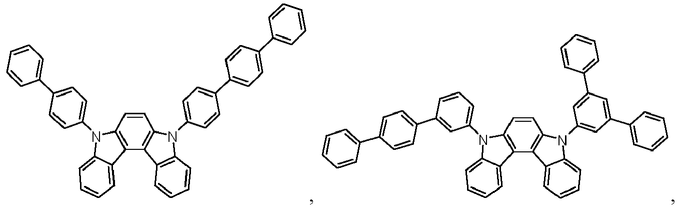 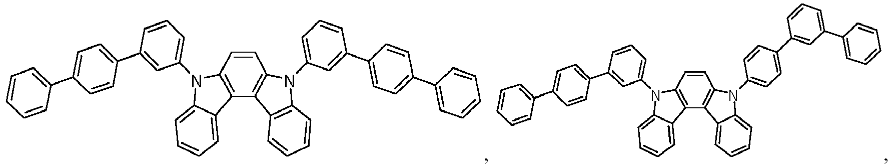 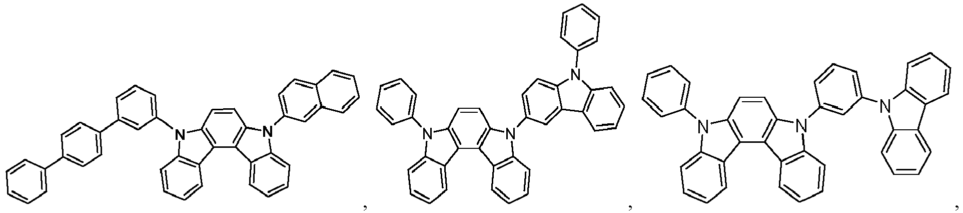 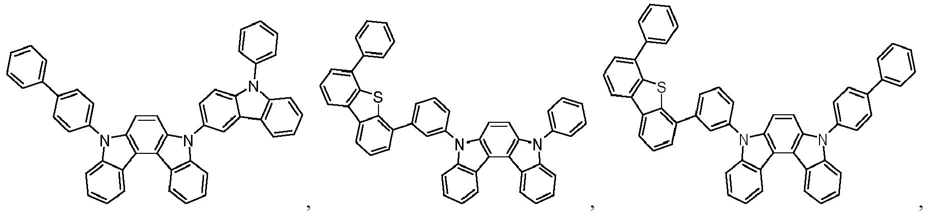 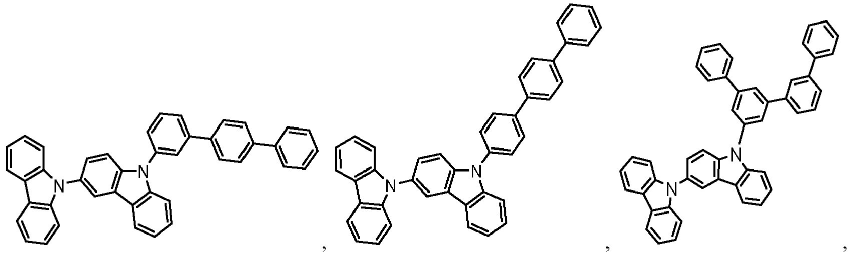 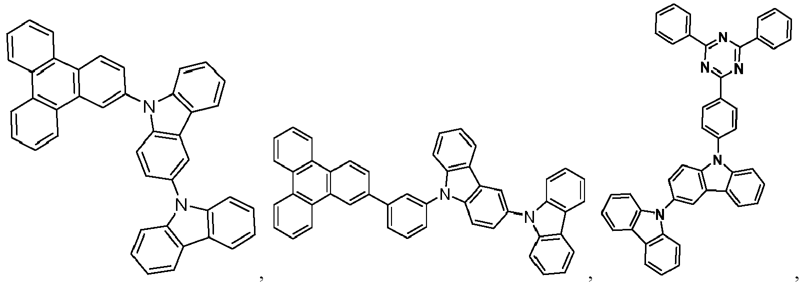 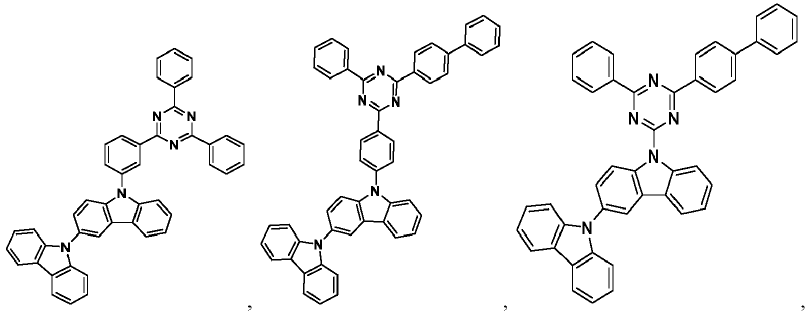 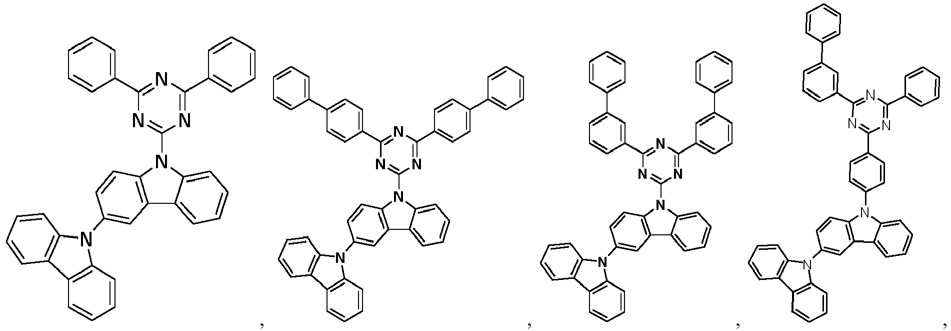 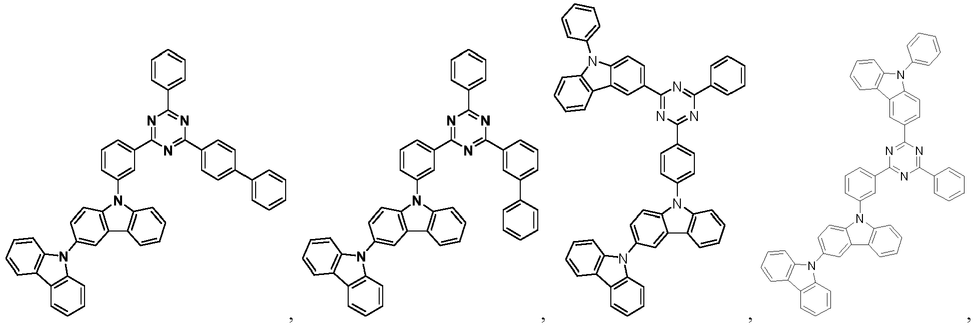 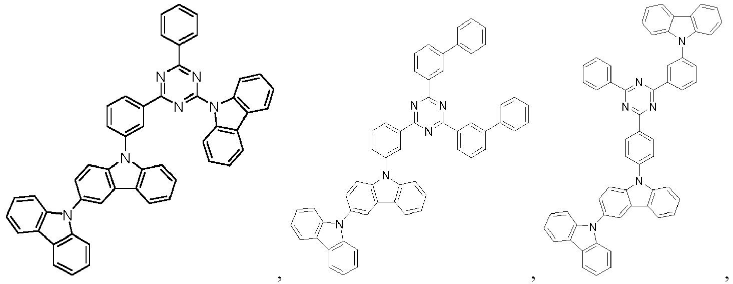 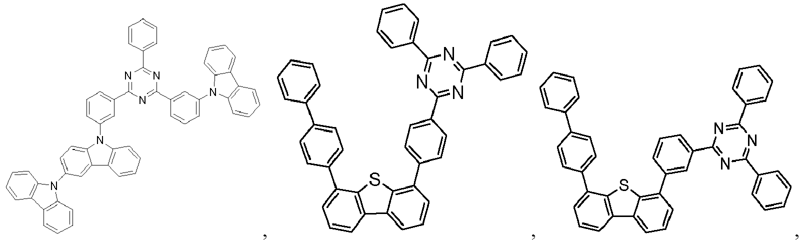 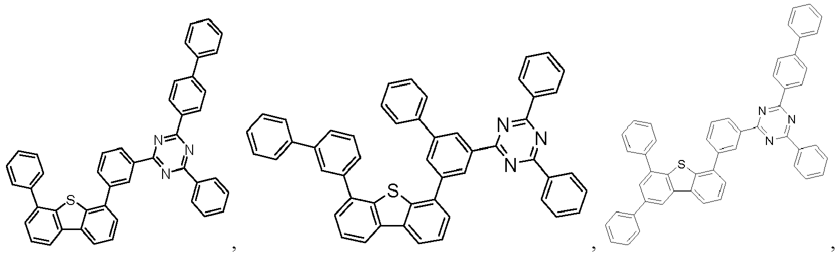 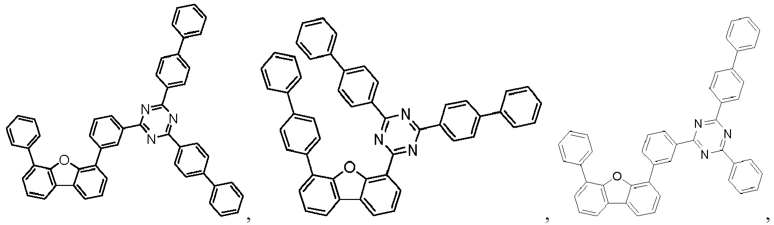 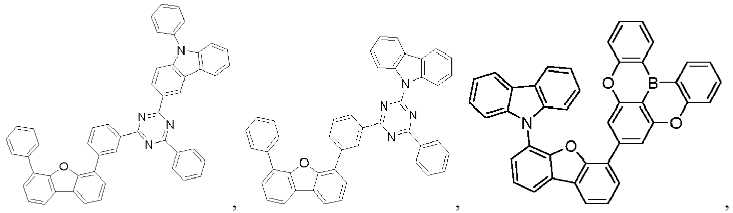 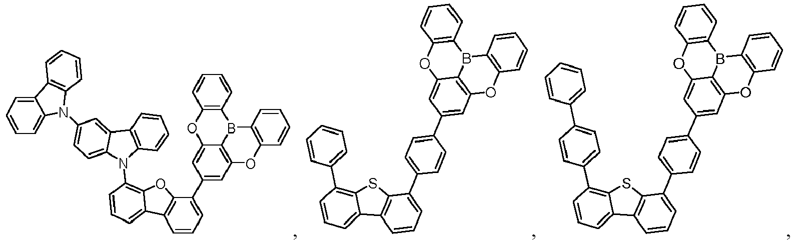 and 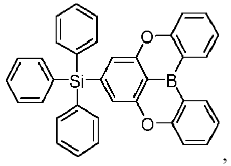 aza-substituted variants thereof, fully or partially deuterated variants thereof, and combinations thereof.
In some embodiments, the additional host comprises a metal complex.

In yet another aspect, the OLED of the present disclosure may also comprise an emissive region containing a formulation as disclosed in the above compounds section of the present disclosure.

In some embodiments, at least one of the anode, the cathode, or a new layer disposed over the organic emissive layer functions as an enhancement layer. The enhancement layer comprises a plasmonic material exhibiting surface plasmon resonance that non-radiatively couples to the emitter material and transfers excited state energy from the emitter material to non-radiative mode of surface plasmon polariton. The enhancement layer is provided no more than a threshold distance away from the organic emissive layer, wherein the emitter material has a total non-radiative decay rate constant and a total radiative decay rate constant due to the presence of the enhancement layer and the threshold distance is where the total non-radiative decay rate constant is equal to the total radiative decay rate constant. In some embodiments, the OLED further comprises an outcoupling layer. In some embodiments, the outcoupling layer is disposed over the enhancement layer on the opposite side of the organic emissive layer. In some embodiments, the outcoupling layer is disposed on opposite side of the emissive layer from the enhancement layer but still outcouples energy from the surface plasmon mode of the enhancement layer. The outcoupling layer scatters the energy from the surface plasmon polaritons. In some embodiments this energy is scattered as photons to free space. In other embodiments, the energy is scattered from the surface plasmon mode into other modes of the device such as but not limited to the organic waveguide mode, the substrate mode, or another waveguiding mode. If energy is scattered to the non-free space mode of the OLED other outcoupling schemes could be incorporated to extract that energy to free space. In some embodiments, one or more intervening layer can be disposed between the enhancement layer and the outcoupling layer. The examples for intervening layer(s) can be dielectric materials, including organic, inorganic, perovskites, oxides, and may include stacks and/or mixtures of these materials.

The enhancement layer modifies the effective properties of the medium in which the emitter material resides resulting in any or all of the following: a decreased rate of emission, a modification of emission line-shape, a change in emission intensity with angle, a change in the stability of the emitter material, a change in the efficiency of the OLED, and reduced efficiency roll-off of the OLED device. Placement of the enhancement layer on the cathode side, anode side, or on both sides results in OLED devices which take advantage of any of the above-mentioned effects. In addition to the specific functional layers mentioned herein and illustrated in the various OLED examples shown in the figures, the OLEDs according to the present disclosure may include any of the other functional layers often found in OLEDs.

The enhancement layer can be comprised of plasmonic materials, optically active metamaterials, or hyperbolic metamaterials. As used herein, a plasmonic material is a material in which the real part of the dielectric constant crosses zero in the visible or ultraviolet region of the electromagnetic spectrum. In some embodiments, the plasmonic material includes at least one metal. In such embodiments the metal may include at least one of Ag, Al, Au, Ir, Pt, Ni, Cu, W, Ta, Fe, Cr, Mg, Ga, Rh, Ti, Ru, Pd, In, Bi, Ca alloys or mixtures of these materials, and stacks of these materials. In general, a metamaterial is a medium composed of different materials where the medium as a whole acts differently than the sum of its material parts. In particular, we define optically active metamaterials as materials which have both negative permittivity and negative permeability. Hyperbolic metamaterials, on the other hand, are anisotropic media in which the permittivity or permeability are of different sign for different spatial directions. Optically active metamaterials and hyperbolic metamaterials are strictly distinguished from many other photonic structures such as Distributed Bragg Reflectors ("DBRs") in that the medium should appear uniform in the direction of propagation on the length scale of the wavelength of light. Using terminology that one skilled in the art can understand: the dielectric constant of the metamaterials in the direction of propagation can be described with the effective medium approximation. Plasmonic materials and metamaterials provide methods for controlling the propagation of light that can enhance OLED performance in a number of ways.

In some embodiments, the enhancement layer is provided as a planar layer. In other embodiments, the enhancement layer has wavelength-sized features that are arranged periodically, quasi-periodically, or randomly, or sub-wavelength-sized features that are arranged periodically, quasi-periodically, or randomly. In some embodiments, the wavelength-sized features and the sub-wavelength-sized features have sharp edges.

In some embodiments, the outcoupling layer has wavelength-sized features that are arranged periodically, quasi-periodically, or randomly, or sub-wavelength-sized features that are arranged periodically, quasi-periodically, or randomly. In some embodiments, the outcoupling layer may be composed of a plurality of nanoparticles and in other embodiments the outcoupling layer is composed of a plurality of nanoparticles disposed over a material. In these embodiments the outcoupling may be tunable by at least one of varying a size of the plurality of nanoparticles, varying a shape of the plurality of nanoparticles, changing a material of the plurality of nanoparticles, adjusting a thickness of the material, changing the refractive index of the material or an additional layer disposed on the plurality of nanoparticles, varying a thickness of the enhancement layer, and/or varying the material of the enhancement layer. The plurality of nanoparticles of the device may be formed from at least one of metal, dielectric material, semiconductor materials, an alloy of metal, a mixture of dielectric materials, a stack or layering of one or more materials, and/or a core of one type of material and that is coated with a shell of a different type of material. In some embodiments, the outcoupling layer is composed of at least metal nanoparticles wherein the metal is selected from the group consisting of Ag, Al, Au, Ir, Pt, Ni, Cu, W, Ta, Fe, Cr, Mg, Ga, Rh, Ti, Ru, Pd, In, Bi, Ca, alloys or mixtures of these materials, and stacks of these materials. The plurality of nanoparticles may have additional layer disposed over them. In some embodiments, the polarization of the emission can be tuned using the outcoupling layer. Varying the dimensionality and periodicity of the outcoupling layer can select a type of polarization that is preferentially outcoupled to air. In some embodiments the outcoupling layer also acts as an electrode of the device.

In yet another aspect, the present disclosure also provides a consumer product comprising an organic light-emitting device (OLED) having an anode; a cathode; and an organic layer disposed between the anode and the cathode, wherein the organic layer may comprise a compound as disclosed in the above compounds section of the present disclosure.

In some embodiments, the consumer product comprises an OLED having an anode; a cathode; and an organic layer disposed between the anode and the cathode, wherein the organic layer may comprise a formulation as described herein.

In some embodiments, the consumer product can be one of a flat panel display, a computer monitor, a medical monitor, a television, a billboard, a light for interior or exterior illumination and/or signaling, a heads-up display, a fully or partially transparent display, a flexible display, a laser printer, a telephone, a cell phone, tablet, a phablet, a personal digital assistant (PDA), a wearable device, a laptop computer, a digital camera, a camcorder, a viewfinder, a micro-display that is less than 2 inches diagonal, a 3-D display, a virtual reality or augmented reality display, a vehicle, a video wall comprising multiple displays tiled together, a theater or stadium screen, a light therapy device, and a sign.

Generally, an OLED comprises at least one organic layer disposed between and electrically connected to an anode and a cathode. When a current is applied, the anode injects holes, and the cathode injects electrons into the organic layer(s). The injected holes and electrons each migrate toward the oppositely charged electrode. When an electron and hole localize on the same molecule, an "exciton," which is a localized electron-hole pair having an excited energy state, is formed. Light is emitted when the exciton relaxes via a photoemissive mechanism. In some cases, the exciton may be localized on an excimer or an exciplex. Non-radiative mechanisms, such as thermal relaxation, may also occur, but are generally considered undesirable.

Several OLED materials and configurations are described in U.S. Pat. Nos. 5,844,363, 6,303,238, and 5,707,745, which are incorporated herein by reference in their entirety.

The initial OLEDs used emissive molecules that emitted light from their singlet states ("fluorescence") as disclosed, for example, in U.S. Pat. No. 4,769,292, which is incorporated by reference in its entirety. Fluorescent emission generally occurs in a time frame of less than 10 nanoseconds.

More recently, OLEDs having emissive materials that emit light from triplet states ("phosphorescence") have been demonstrated. Baldo et al., "Highly Efficient Phosphorescent Emission from Organic Electroluminescent Devices," Nature, vol. 395, 151-154, 1998; ("Baldo-I") and Baldo et al., "Very high-efficiency green organic light-emitting devices based on electrophosphorescence," Appl. Phys. Lett., vol. 75, No. 3, 4-6 (1999) ("Baldo-II"), are incorporated by reference in their entireties. Phosphorescence is described in more detail in U.S. Pat. No. 7,279,704 at cols. 5-6, which are incorporated by reference.

FIG. 1 shows an organic light emitting device 100. The figures are not necessarily drawn to scale. Device 100 may include a substrate 110, an anode 115, a hole injection layer 120, a hole transport layer 125, an electron blocking layer 130, an emissive layer 135, a hole blocking layer 140, an electron transport layer 145, an electron injection layer 150, a protective layer 155, a cathode 160, and a barrier layer 170. Cathode 160 is a compound cathode having a first conductive layer 162 and a second conductive layer 164. Device 100 may be fabricated by depositing the layers described, in order. The properties and functions of these various layers, as well as example materials, are described in more detail in US 7,279,704 at cols. 6-10, which are incorporated by reference.

More examples for each of these layers are available. For example, a flexible and transparent substrate-anode combination is disclosed in U.S. Pat. No. 5,844,363, which is incorporated by reference in its entirety. An example of a p-doped hole transport layer is m-MTDATA doped with F₄-TCNQ at a molar ratio of 50:1, as disclosed in U.S. Patent Application Publication No. 2003/0230980, which is incorporated by reference in its entirety. Examples of emissive and host materials are disclosed in U.S. Pat. No. 6,303,238 to Thompson et al., which is incorporated by reference in its entirety. An example of an n-doped electron transport layer is BPhen doped with Li at a molar ratio of 1:1, as disclosed in U.S. Patent Application Publication No. 2003/0230980, which is incorporated by reference in its entirety. U.S. Pat. Nos. 5,703,436 and 5,707,745, which are incorporated by reference in their entireties, disclose examples of cathodes including compound cathodes having a thin layer of metal such as Mg:Ag with an overlying transparent, electrically-conductive, sputter-deposited ITO layer. The theory and use of blocking layers is described in more detail in U.S. Pat. No. 6,097,147 and U.S. Patent Application Publication No. 2003/0230980, which are incorporated by reference in their entireties. Examples of injection layers are provided in U.S. Patent Application Publication No. 2004/0174116, which is incorporated by reference in its entirety. A description of protective layers may be found in U.S. Patent Application Publication No. 2004/0174116, which is incorporated by reference in its entirety.

FIG. 2 shows an inverted OLED 200. The device includes a substrate 210, a cathode 215, an emissive layer 220, a hole transport layer 225, and an anode 230. Device 200 may be fabricated by depositing the layers described, in order. Because the most common OLED configuration has a cathode disposed over the anode, and device 200 has cathode 215 disposed under anode 230, device 200 may be referred to as an "inverted" OLED. Materials similar to those described with respect to device 100 may be used in the corresponding layers of device 200. FIG. 2 provides one example of how some layers may be omitted from the structure of device 100.

The simple layered structure illustrated in FIGS. 1 and 2 is provided by way of non-limiting example, and it is understood that embodiments of the present disclosure may be used in connection with a wide variety of other structures. The specific materials and structures described are exemplary in nature, and other materials and structures may be used. Functional OLEDs may be achieved by combining the various layers described in different ways, or layers may be omitted entirely, based on design, performance, and cost factors. Other layers not specifically described may also be included. Materials other than those specifically described may be used. Although many of the examples provided herein describe various layers as comprising a single material, it is understood that combinations of materials, such as a mixture of host and dopant, or more generally a mixture, may be used. Also, the layers may have various sublayers. The names given to the various layers herein are not intended to be strictly limiting. For example, in device 200, hole transport layer 225 transports holes and injects holes into emissive layer 220, and may be described as a hole transport layer or a hole injection layer. In one embodiment, an OLED may be described as having an "organic layer" disposed between a cathode and an anode. This organic layer may comprise a single layer, or may further comprise multiple layers of different organic materials as described, for example, with respect to FIGS. 1 and 2.

Structures and materials not specifically described may also be used, such as OLEDs comprised of polymeric materials (PLEDs) such as disclosed in U.S. Pat. No. 5,247,190 to Friend et al., which is incorporated by reference in its entirety. By way of further example, OLEDs having a single organic layer may be used. OLEDs may be stacked, for example as described in U.S. Pat. No. 5,707,745 to Forrest et al, which is incorporated by reference in its entirety. The OLED structure may deviate from the simple layered structure illustrated in FIGS. 1 and 2. For example, the substrate may include an angled reflective surface to improve out-coupling, such as a mesa structure as described in U.S. Pat. No. 6,091,195 to Forrest et al., and/or a pit structure as described in U.S. Pat. No. 5,834,893 to Bulovic et al., which are incorporated by reference in their entireties.

Unless otherwise specified, any of the layers of the various embodiments may be deposited by any suitable method. For the organic layers, preferred methods include thermal evaporation, ink-jet, such as described in U.S. Pat. Nos. 6,013,982 and 6,087,196, which are incorporated by reference in their entireties, organic vapor phase deposition (OVPD), such as described in U.S. Pat. No. 6,337,102 to Forrest et al., which is incorporated by reference in its entirety, and deposition by organic vapor jet printing (OVJP, also referred to as organic vapor jet deposition (OVJD)), such as described in U.S. Pat. No. 7,431,968, which is incorporated by reference in its entirety. Other suitable deposition methods include spin coating and other solution based processes. Solution based processes are preferably carried out in nitrogen or an inert atmosphere. For the other layers, preferred methods include thermal evaporation. Preferred patterning methods include deposition through a mask, cold welding such as described in U.S. Pat. Nos. 6,294,398 and 6,468,819, which are incorporated by reference in their entireties, and patterning associated with some of the deposition methods such as ink-jet and organic vapor jet printing (OVJP). Other methods may also be used. The materials to be deposited may be modified to make them compatible with a particular deposition method. For example, substituents such as alkyl and aryl groups, branched or unbranched, and preferably containing at least 3 carbons, may be used in small molecules to enhance their ability to undergo solution processing. Substituents having 20 carbons or more may be used, and 3-20 carbons are a preferred range. Materials with asymmetric structures may have better solution processability than those having symmetric structures, because asymmetric materials may have a lower tendency to recrystallize. Dendrimer substituents may be used to enhance the ability of small molecules to undergo solution processing.

Devices fabricated in accordance with embodiments of the present disclosure may
further optionally comprise a barrier layer. One purpose of the barrier layer is to protect the electrodes and organic layers from damaging exposure to harmful species in the environment including moisture, vapor and/or gases, etc. The barrier layer may be deposited over, under or next to a substrate, an electrode, or over any other parts of a device including an edge. The barrier layer may comprise a single layer, or multiple layers. The barrier layer may be formed by various known chemical vapor deposition techniques and may include compositions having a single phase as well as compositions having multiple phases. Any suitable material or combination of materials may be used for the barrier layer. The barrier layer may incorporate an inorganic or an organic compound or both. The preferred barrier layer comprises a mixture of a polymeric material and a non-polymeric material as described in U.S. Pat. No. 7,968,146, PCT Pat. Application Nos. PCT/US2007/023098 and PCT/US2009/042829, which are herein incorporated by reference in their entireties. To be considered a "mixture", the aforesaid polymeric and non-polymeric materials comprising the barrier layer should be deposited under the same reaction conditions and/or at the same time. The weight ratio of polymeric to non-polymeric material may be in the range of 95:5 to 5:95. The polymeric material and the non-polymeric material may be created from the same precursor material. In one example, the mixture of a polymeric material and a non-polymeric material consists essentially of polymeric silicon and inorganic silicon.

Devices fabricated in accordance with embodiments of the present disclosure can be incorporated into a wide variety of electronic component modules (or units) that can be incorporated into a variety of electronic products or intermediate components. Examples of such electronic products or intermediate components include display screens, lighting devices such as discrete light source devices or lighting panels, etc. that can be utilized by the end-user product manufacturers. Such electronic component modules can optionally include the driving electronics and/or power source(s). Devices fabricated in accordance with embodiments of the present disclosure can be incorporated into a wide variety of consumer products that have one or more of the electronic component modules (or units) incorporated therein. A consumer product comprising an OLED that includes the compound of the present disclosure in the organic layer in the OLED is disclosed. Such consumer products would include any kind of products that include one or more light source(s) and/or one or more of some type of visual displays. Some examples of such consumer products include flat panel displays, curved displays, computer monitors, medical monitors, televisions, billboards, lights for interior or exterior illumination and/or signaling, heads-up displays, fully or partially transparent displays, flexible displays, rollable displays, foldable displays, stretchable displays, laser printers, telephones, mobile phones, tablets, phablets, personal digital assistants (PDAs), wearable devices, laptop computers, digital cameras, camcorders, viewfinders, micro-displays (displays that are less than 2 inches diagonal), 3-D displays, virtual reality or augmented reality displays, vehicles, video walls comprising multiple displays tiled together, theater or stadium screen, a light therapy device, and a sign. Various control mechanisms may be used to control devices fabricated in accordance with the present disclosure, including passive matrix and active matrix. Many of the devices are intended for use in a temperature range comfortable to humans, such as 18 degrees C. to 30 degrees C., and more preferably at room temperature (20-25 °C), but could be used outside this temperature range, for example, from -40 degree C to + 80 °C.

More details on OLEDs, and the definitions described above, can be found in U.S. Pat. No. 7,279,704, which is incorporated herein by reference in its entirety.

The materials and structures described herein may have applications in devices other than OLEDs. For example, other optoelectronic devices such as organic solar cells and organic photodetectors may employ the materials and structures. More generally, organic devices, such as organic transistors, may employ the materials and structures.

In some embodiments, the OLED has one or more characteristics selected from the group consisting of being flexible, being rollable, being foldable, being stretchable, and being curved. In some embodiments, the OLED is transparent or semi-transparent. In some embodiments, the OLED further comprises a layer comprising carbon nanotubes.

In some embodiments, the OLED further comprises a layer comprising a delayed fluorescent emitter. In some embodiments, the OLED comprises a RGB pixel arrangement or white plus color filter pixel arrangement. In some embodiments, the OLED is a mobile device, a hand held device, or a wearable device. In some embodiments, the OLED is a display panel having less than 10 inch diagonal or 50 square inch area. In some embodiments, the OLED is a display panel having at least 10 inch diagonal or 50 square inch area. In some embodiments, the OLED is a lighting panel.

In some embodiments, the compound can be an emissive dopant. In some embodiments, the compound can produce emissions via phosphorescence, fluorescence, thermally activated delayed fluorescence, i.e., TADF (also referred to as E-type delayed fluorescence; *see, e.g.,* U.S. Application No. 15/700,352, which is hereby incorporated by reference in its entirety), triplet-triplet annihilation, or combinations of these processes. In some embodiments, the emissive dopant can be a racemic mixture, or can be enriched in one enantiomer. In some embodiments, the compound can be homoleptic (each ligand is the same). In some embodiments, the compound can be heteroleptic (at least one ligand is different from others). When there are more than one ligand coordinated to a metal, the ligands can all be the same in some embodiments. In some other embodiments, at least one ligand is different from the other ligands. In some embodiments, every ligand can be different from each other. This is also true in embodiments where a ligand being coordinated to a metal can be linked with other ligands being coordinated to that metal to form a tridentate, tetradentate, pentadentate, or hexadentate ligands. Thus, where the coordinating ligands are being linked together, all of the ligands can be the same in some embodiments, and at least one of the ligands being linked can be different from the other ligand(s) in some other embodiments.

In some embodiments, the compound can be used as a phosphorescent sensitizer in an OLED where one or multiple layers in the OLED contains an acceptor in the form of one or more fluorescent and/or delayed fluorescence emitters. In some embodiments, the compound can be used as one component of an exciplex to be used as a sensitizer. As a phosphorescent sensitizer, the compound must be capable of energy transfer to the acceptor and the acceptor will emit the energy or further transfer energy to a final emitter. The acceptor concentrations can range from 0.001% to 100%. The acceptor could be in either the same layer as the phosphorescent sensitizer or in one or more different layers. In some embodiments, the acceptor is a TADF emitter. In some embodiments, the acceptor is a fluorescent emitter. In some embodiments, the emission can arise from any or all of the sensitizer, acceptor, and final emitter.

According to another aspect, a formulation comprising the compound described herein is also disclosed.

The OLED disclosed herein can be incorporated into one or more of a consumer product, an electronic component module, and a lighting panel. The organic layer can be an emissive layer and the compound can be an emissive dopant in some embodiments, while the compound can be a non-emissive dopant in other embodiments.

In yet another aspect of the present disclosure, a formulation that comprises the novel compound disclosed herein is described. The formulation can include one or more components selected from the group consisting of a solvent, a host, a hole injection material, hole transport material, electron blocking material, hole blocking material, and an electron transport material, disclosed herein.

The present disclosure encompasses any chemical structure comprising the novel compound of the present disclosure, or a monovalent or polyvalent variant thereof. In other words, the inventive compound, or a monovalent or polyvalent variant thereof, can be a part of a larger chemical structure. Such chemical structure can be selected from the group consisting of a monomer, a polymer, a macromolecule, and a supramolecule (also known as supermolecule). As used herein, a "monovalent variant of a compound" refers to a moiety that is identical to the compound except that one hydrogen has been removed and replaced with a bond to the rest of the chemical structure. As used herein, a "polyvalent variant of a compound" refers to a moiety that is identical to the compound except that more than one hydrogen has been removed and replaced with a bond or bonds to the rest of the chemical structure. In the instance of a supramolecule, the inventive compound can also be incorporated into the supramolecule complex without covalent bonds.

### F. Combination of the Compounds of the Present Disclosure with Other Materials

The materials described herein as useful for a particular layer in an organic light emitting device may be used in combination with a wide variety of other materials present in the device. For example, emissive dopants disclosed herein may be used in conjunction with a wide variety of hosts, transport layers, blocking layers, injection layers, electrodes and other layers that may be present. The materials described or referred to below are non-limiting examples of materials that may be useful in combination with the compounds disclosed herein, and one of skill in the art can readily consult the literature to identify other materials that may be useful in combination.

### a) Conductivity Dopants:

A charge transport layer can be doped with conductivity dopants to substantially alter its density of charge carriers, which will in turn alter its conductivity. The conductivity is increased by generating charge carriers in the matrix material, and depending on the type of dopant, a change in the Fermi level of the semiconductor may also be achieved. Hole-transporting layer can be doped by p-type conductivity dopants and n-type conductivity dopants are used in the electron-transporting layer.

Non-limiting examples of the conductivity dopants that may be used in an OLED in combination with materials disclosed herein are exemplified below together with references that disclose those materials: EP01617493, EP01968131, EP2020694, EP2684932, US20050139810, US20070160905, US20090167167, US2010288362, WO06081780, WO2009003455, WO2009008277, WO2009011327, WO2014009310, US2007252140, US2015060804, US20150123047, and US2012146012.

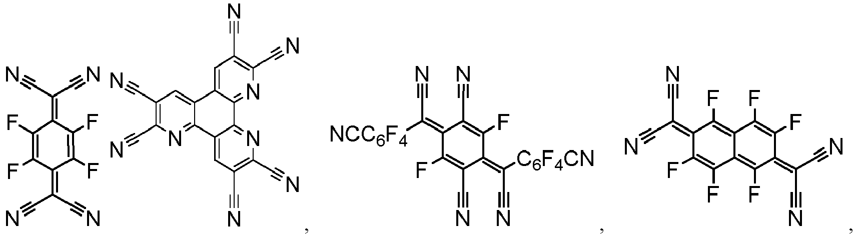

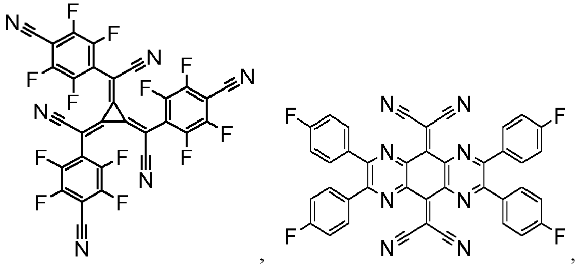

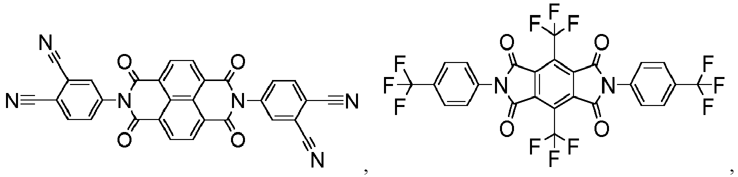

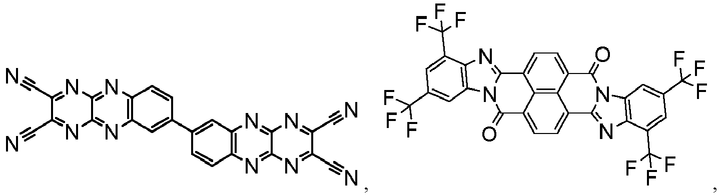

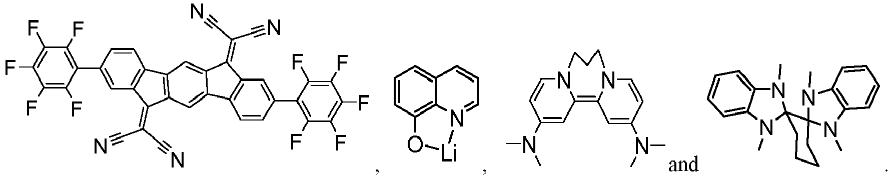

### b) HIL/HTL:

A hole injecting/transporting material to be used in the present disclosure is not particularly limited, and any compound may be used as long as the compound is typically used as a hole injecting/transporting material. Examples of the material include, but are not limited to: a phthalocyanine or porphyrin derivative; an aromatic amine derivative; an indolocarbazole derivative; a polymer containing fluorohydrocarbon; a polymer with conductivity dopants; a conducting polymer, such as PEDOT/PSS; a self-assembly monomer derived from compounds such as phosphonic acid and silane derivatives; a metal oxide derivative, such as MoOₓ; a p-type semiconducting organic compound, such as 1,4,5,8,9,12-Hexaazatriphenylenehexacarbonitrile; a metal complex, and a cross-linkable compounds.

Examples of aromatic amine derivatives used in HIL or HTL include, but not limit to the following general structures:

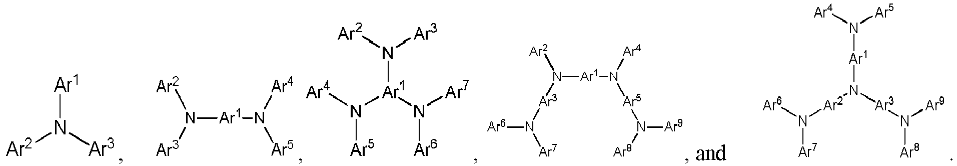

Each of Ar¹ to Ar⁹ is selected from the group consisting of aromatic hydrocarbon cyclic compounds such as benzene, biphenyl, triphenyl, triphenylene, naphthalene, anthracene, phenalene, phenanthrene, fluorene, pyrene, chrysene, perylene, and azulene; the group consisting of aromatic heterocyclic compounds such as dibenzothiophene, dibenzofuran, dibenzoselenophene, furan, thiophene, benzofuran, benzothiophene, benzoselenophene, carbazole, indolocarbazole, pyridylindole, pyrrolodipyridine, pyrazole, imidazole, triazole, oxazole, thiazole, oxadiazole, oxatriazole, dioxazole, thiadiazole, pyridine, pyridazine, pyrimidine, pyrazine, triazine, oxazine, oxathiazine, oxadiazine, indole, benzimidazole, indazole, indoxazine, benzoxazole, benzisoxazole, benzothiazole, quinoline, isoquinoline, cinnoline, quinazoline, quinoxaline, naphthyridine, phthalazine, pteridine, xanthene, acridine, phenazine, phenothiazine, phenoxazine, benzofuropyridine, furodipyridine, benzothienopyridine, thienodipyridine, benzoselenophenopyridine, and selenophenodipyridine; and the group consisting of 2 to 10 cyclic structural units which are groups of the same type or different types selected from the aromatic hydrocarbon cyclic group and the aromatic heterocyclic group and are bonded to each other directly or via at least one of oxygen atom, nitrogen atom, sulfur atom, silicon atom, phosphorus atom, boron atom, chain structural unit and the aliphatic cyclic group. Each Ar may be unsubstituted or may be substituted by a substituent selected from the group consisting of deuterium, halogen, alkyl, cycloalkyl, heteroalkyl, heterocycloalkyl, arylalkyl, alkoxy, aryloxy, amino, silyl, alkenyl, cycloalkenyl, heteroalkenyl, alkynyl, aryl, heteroaryl, acyl, carboxylic acids, ether, ester, nitrile, isonitrile, sulfanyl, sulfinyl, sulfonyl, phosphino, and combinations thereof.

In one aspect, Ar¹ to Ar⁹ is independently selected from the group consisting of: 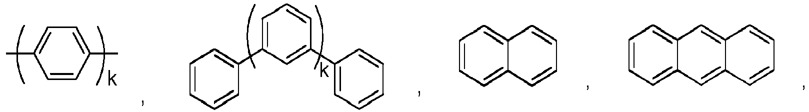 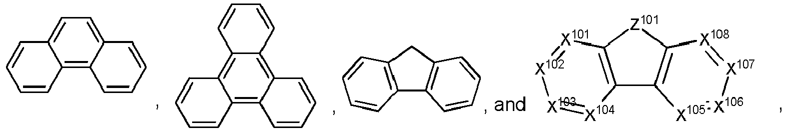 wherein k is an integer from 1 to 20; X¹⁰¹ to X¹⁰⁸ is C (including CH) or N; Z¹⁰¹ is NAr¹, O, or S; Ar¹ has the same group defined above.

Examples of metal complexes used in HIL or HTL include, but are not limited to the following general formula: 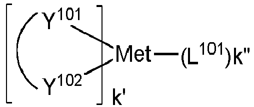 wherein Met is a metal, which can have an atomic weight greater than 40; (Y¹⁰¹-Y¹⁰²) is a bidentate ligand, Y¹⁰¹ and Y¹⁰² are independently selected from C, N, O, P, and S; L¹⁰¹ is an ancillary ligand; k' is an integer value from 1 to the maximum number of ligands that may be attached to the metal; and k'+k" is the maximum number of ligands that may be attached to the metal.

In one aspect, (Y¹⁰¹-Y¹⁰²) is a 2-phenylpyridine derivative. In another aspect, (Y¹⁰¹-Y¹⁰²) is a carbene ligand. In another aspect, Met is selected from Ir, Pt, Os, and Zn. In a further aspect, the metal complex has a smallest oxidation potential in solution vs. Fc⁺/Fc couple less than about 0.6 V.

Non-limiting examples of the HIL and HTL materials that may be used in an OLED in combination with materials disclosed herein are exemplified below together with references that disclose those materials: CN102702075, DE102012005215, EP01624500, EP01698613, EP01806334, EP01930964, EP01972613, EP01997799, EP02011790, EP02055700, EP02055701, EP1725079, EP2085382, EP2660300, EP650955, JP07-073529, JP2005112765, JP2007091719, JP2008021687, JP2014-009196, KR20110088898, KR20130077473, TW201139402, US06517957, US20020158242, US20030162053, US20050123751, US20060182993, US20060240279, US20070145888, US20070181874, US20070278938, US20080014464, US20080091025, US20080106190, US20080124572, US20080145707, US20080220265, US20080233434, US20080303417, US2008107919, US20090115320, US20090167161, US2009066235, US2011007385, US20110163302, US2011240968, US2011278551, US2012205642, US2013241401, US20140117329, US2014183517, US5061569, US5639914, WO05075451, WO07125714, WO08023550, WO08023759, WO2009145016, WO2010061824, WO2011075644, WO2012177006, WO2013018530, WO2013039073, WO2013087142, WO2013118812, WO2013120577, WO2013157367, WO2013175747, WO2014002873, WO2014015935, WO2014015937, WO2014030872, WO2014030921, WO2014034791, WO2014104514, WO2014157018.

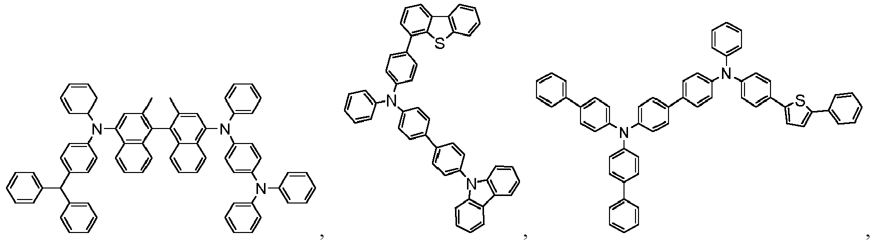

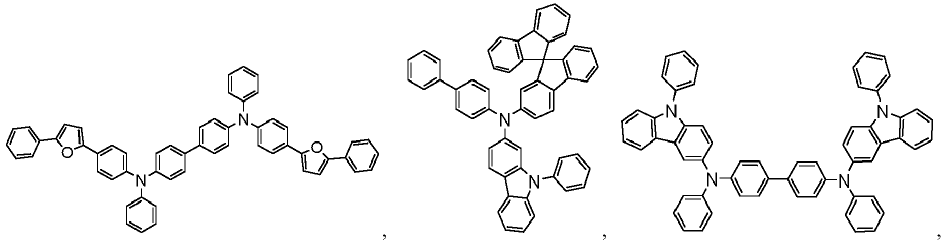

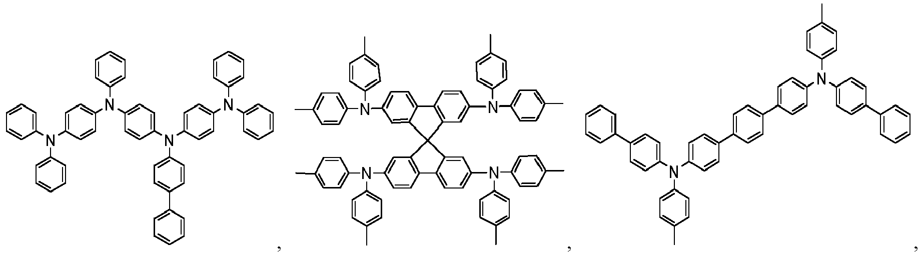

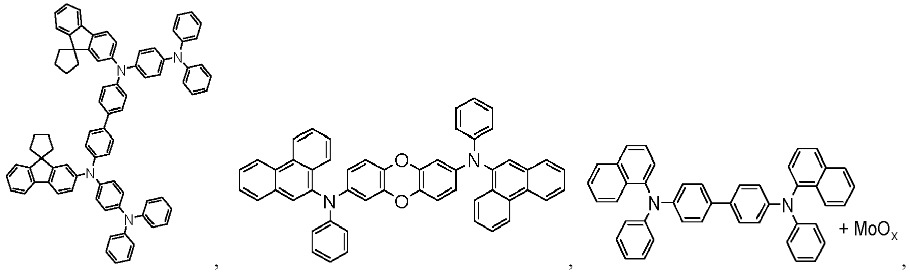

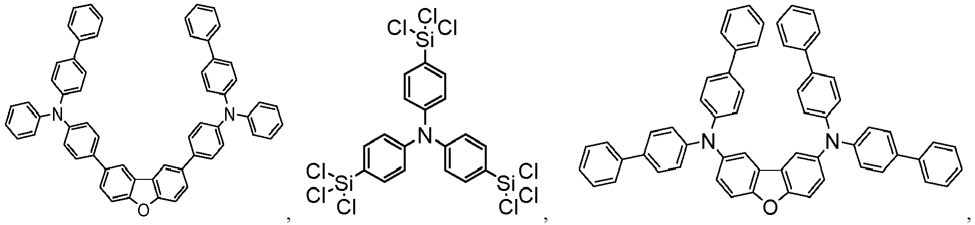

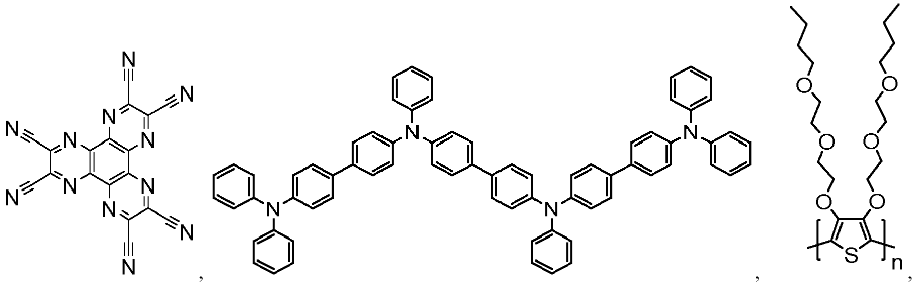

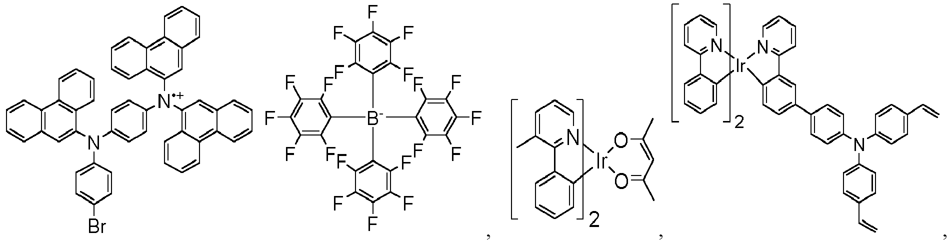

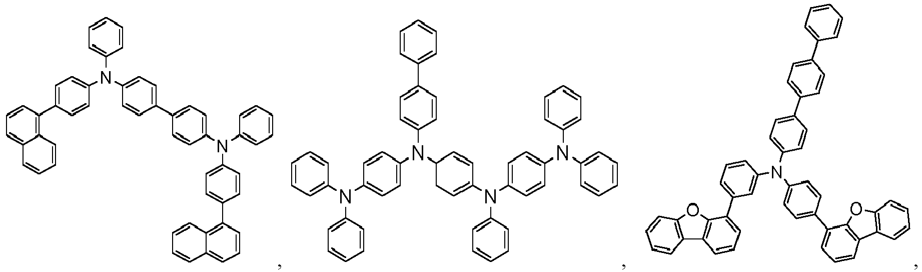

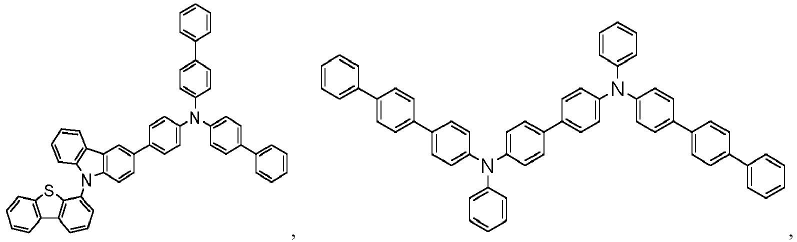

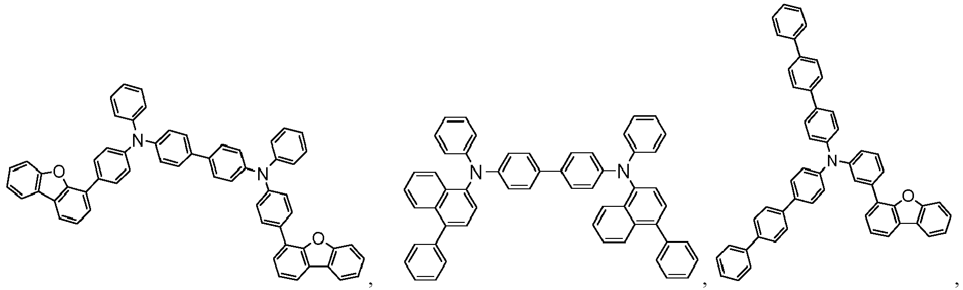

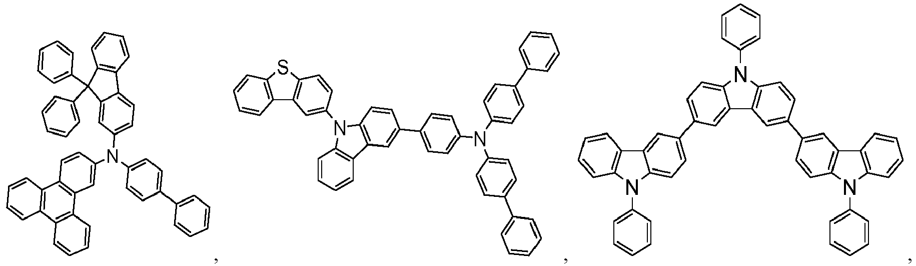

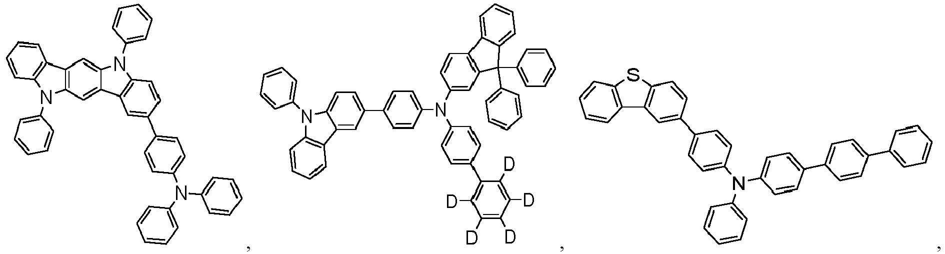

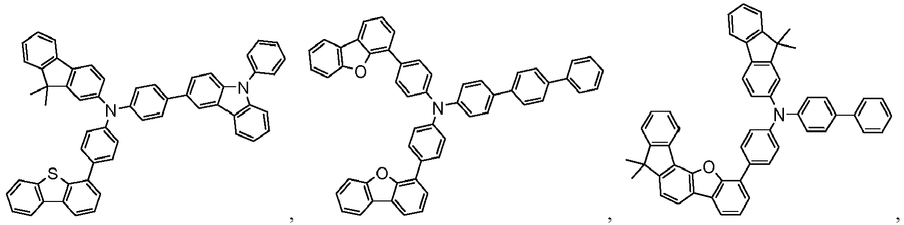

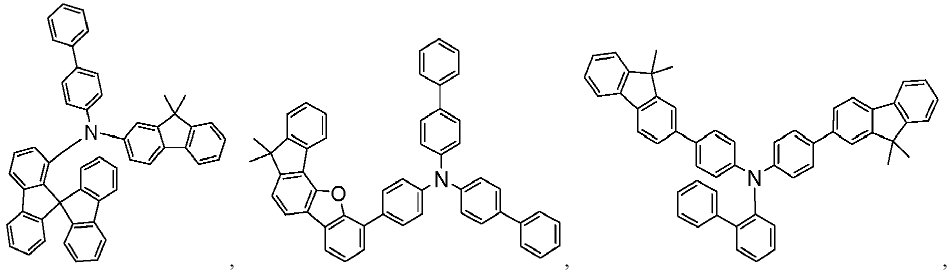

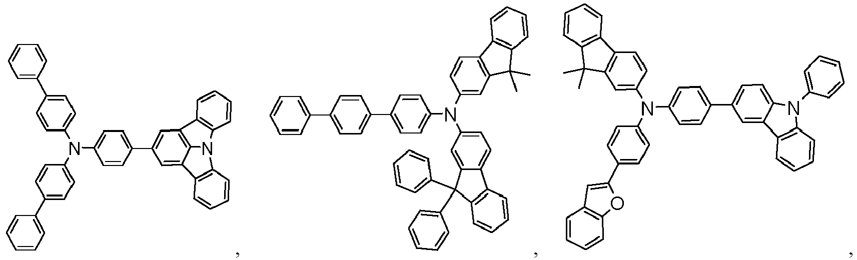

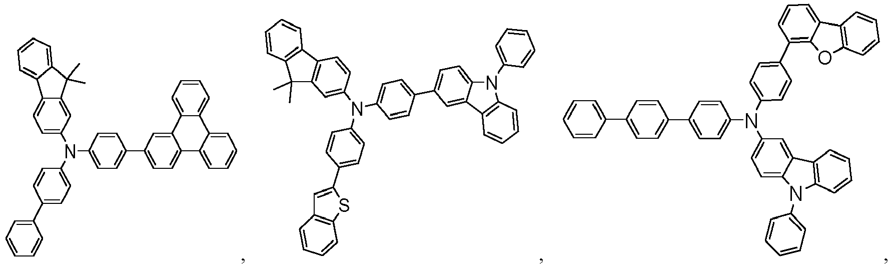

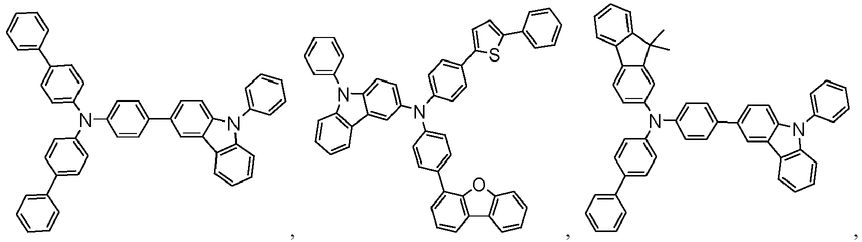

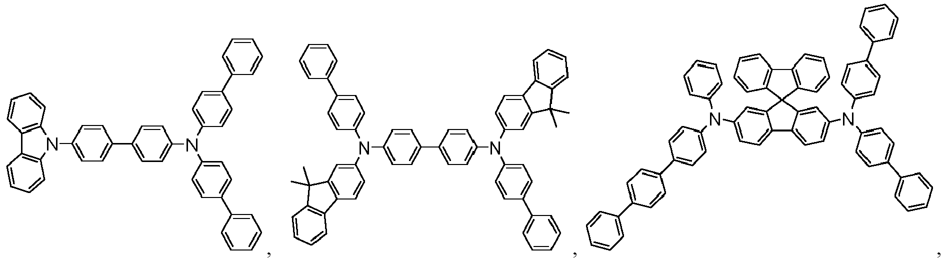

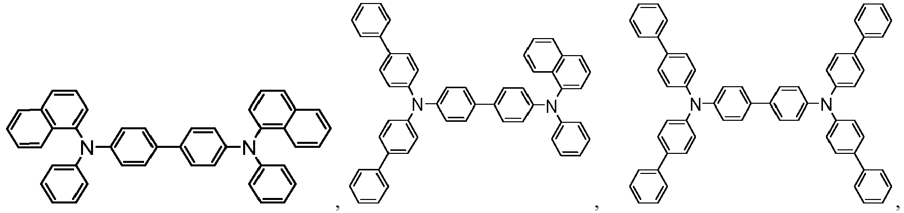

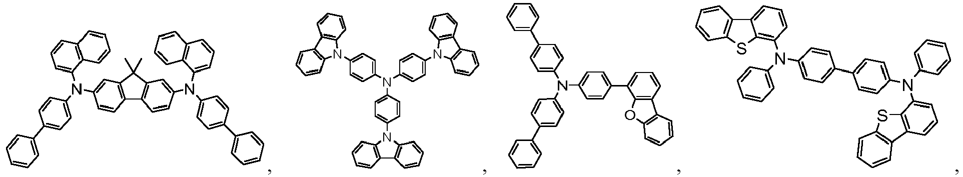

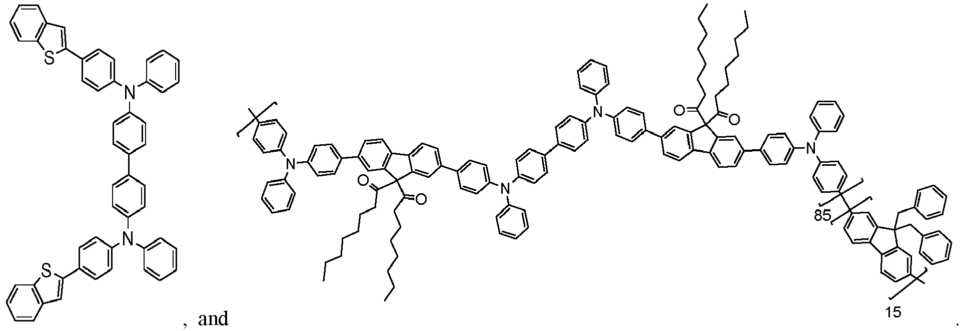

### c) EBL:

An electron blocking layer (EBL) may be used to reduce the number of electrons and/or excitons that leave the emissive layer. The presence of such a blocking layer in a device may result in substantially higher efficiencies, and/or longer lifetime, as compared to a similar device lacking a blocking layer. Also, a blocking layer may be used to confine emission to a desired region of an OLED. In some embodiments, the EBL material has a higher LUMO (closer to the vacuum level) and/or higher triplet energy than the emitter closest to the EBL interface. In some embodiments, the EBL material has a higher LUMO (closer to the vacuum level) and/or higher triplet energy than one or more of the hosts closest to the EBL interface. In one aspect, the compound used in EBL contains the same molecule or the same functional groups used as one of the hosts described below.

### d) Hosts:

The light emitting layer of the organic EL device of the present disclosure preferably contains at least a metal complex as light emitting material, and may contain a host material using the metal complex as a dopant material. Examples of the host material are not particularly limited, and any metal complexes or organic compounds may be used as long as the triplet energy of the host is larger than that of the dopant. Any host material may be used with any dopant so long as the triplet criteria is satisfied.

Examples of metal complexes used as host are preferred to have the following general formula: 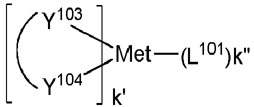 wherein Met is a metal; (Y¹⁰³-Y¹⁰⁴) is a bidentate ligand, Y¹⁰³ and Y¹⁰⁴ are independently selected from C, N, O, P, and S; L¹⁰¹ is another ligand; k' is an integer value from 1 to the maximum number of ligands that may be attached to the metal; and k'+k" is the maximum number of ligands that may be attached to the metal.

In one aspect, the metal complexes are: 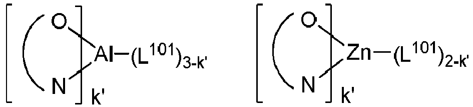 wherein (O-N) is a bidentate ligand, having metal coordinated to atoms O and N.

In another aspect, Met is selected from Ir and Pt. In a further aspect, (Y¹⁰³-Y¹⁰⁴) is a carbene ligand.

In one aspect, the host compound contains at least one of the following groups selected from the group consisting of aromatic hydrocarbon cyclic compounds such as benzene, biphenyl, triphenyl, triphenylene, tetraphenylene, naphthalene, anthracene, phenalene, phenanthrene, fluorene, pyrene, chrysene, perylene, and azulene; the group consisting of aromatic heterocyclic compounds such as dibenzothiophene, dibenzofuran, dibenzoselenophene, furan, thiophene, benzofuran, benzothiophene, benzoselenophene, carbazole, indolocarbazole, pyridylindole, pyrrolodipyridine, pyrazole, imidazole, triazole, oxazole, thiazole, oxadiazole, oxatriazole, dioxazole, thiadiazole, pyridine, pyridazine, pyrimidine, pyrazine, triazine, oxazine, oxathiazine, oxadiazine, indole, benzimidazole, indazole, indoxazine, benzoxazole, benzisoxazole, benzothiazole, quinoline, isoquinoline, cinnoline, quinazoline, quinoxaline, naphthyridine, phthalazine, pteridine, xanthene, acridine, phenazine, phenothiazine, phenoxazine, benzofuropyridine, furodipyridine, benzothienopyridine, thienodipyridine, benzoselenophenopyridine, and selenophenodipyridine; and the group consisting of 2 to 10 cyclic structural units which are groups of the same type or different types selected from the aromatic hydrocarbon cyclic group and the aromatic heterocyclic group and are bonded to each other directly or via at least one of oxygen atom, nitrogen atom, sulfur atom, silicon atom, phosphorus atom, boron atom, chain structural unit and the aliphatic cyclic group. Each option within each group may be unsubstituted or may be substituted by a substituent selected from the group consisting of deuterium, halogen, alkyl, cycloalkyl, heteroalkyl, heterocycloalkyl, arylalkyl, alkoxy, aryloxy, amino, silyl, alkenyl, cycloalkenyl, heteroalkenyl, alkynyl, aryl, heteroaryl, acyl, carboxylic acids, ether, ester, nitrile, isonitrile, sulfanyl, sulfinyl, sulfonyl, phosphino, and combinations thereof.

In one aspect, the host compound contains at least one of the following groups in the molecule: 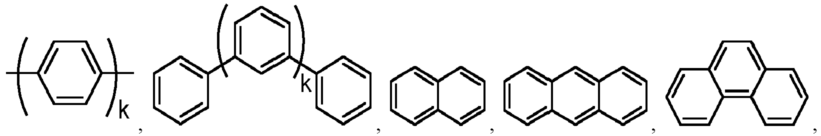 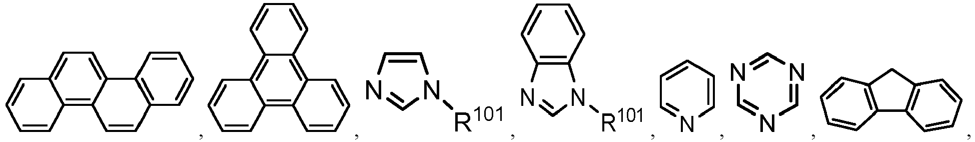 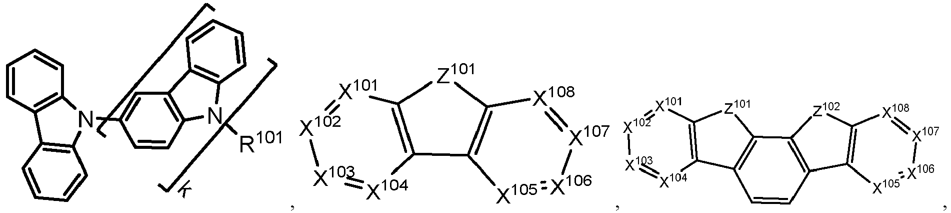 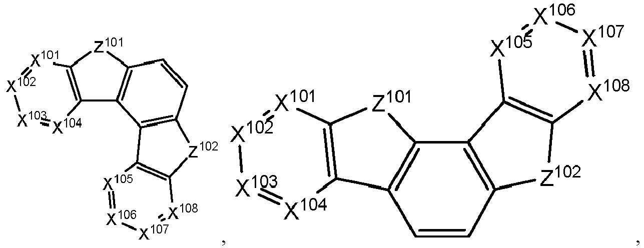 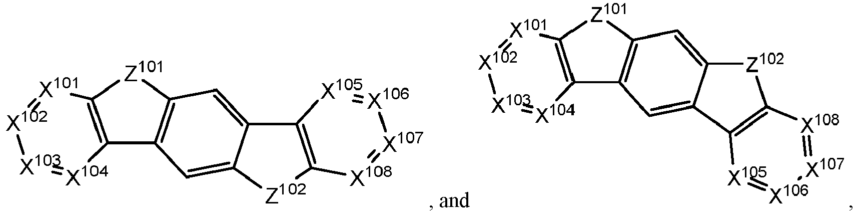 wherein R¹⁰¹ is selected from the group consisting of hydrogen, deuterium, halogen, alkyl, cycloalkyl, heteroalkyl, heterocycloalkyl, arylalkyl, alkoxy, aryloxy, amino, silyl, alkenyl, cycloalkenyl, heteroalkenyl, alkynyl, aryl, heteroaryl, acyl, carboxylic acids, ether, ester, nitrile, isonitrile, sulfanyl, sulfinyl, sulfonyl, phosphino, and combinations thereof, and when it is aryl or heteroaryl, it has the similar definition as Ar's mentioned above. k is an integer from 0 to 20 or 1 to 20. X¹⁰¹ to X¹⁰⁸ are independently selected from C (including CH) or N. Z¹⁰¹ and Z¹⁰² are independently selected from NR¹⁰¹, O, or S.

Non-limiting examples of the host materials that may be used in an OLED in combination with materials disclosed herein are exemplified below together with references that disclose those materials: EP2034538, EP2034538A, EP2757608, JP2007254297, KR20100079458, KR20120088644, KR20120129733, KR20130115564, TW201329200, US20030175553, US20050238919, US20060280965, US20090017330, US20090030202, US20090167162, US20090302743, US20090309488, US20100012931, US20100084966, US20100187984, US2010187984, US2012075273, US2012126221, US2013009543, US2013105787, US2013175519, US2014001446, US20140183503, US20140225088, US2014034914, US7154114, WO2001039234, WO2004093207, WO2005014551, WO2005089025, WO2006072002, WO2006114966, WO2007063754, WO2008056746, WO2009003898, WO2009021126, WO2009063833, WO2009066778, WO2009066779, WO2009086028, WO2010056066, WO2010107244, WO2011081423, WO2011081431, WO2011086863, WO2012128298, WO2012133644, WO2012133649, WO2013024872, WO2013035275, WO2013081315, WO2013191404, WO2014142472, US20170263869, US20160163995, US9466803,

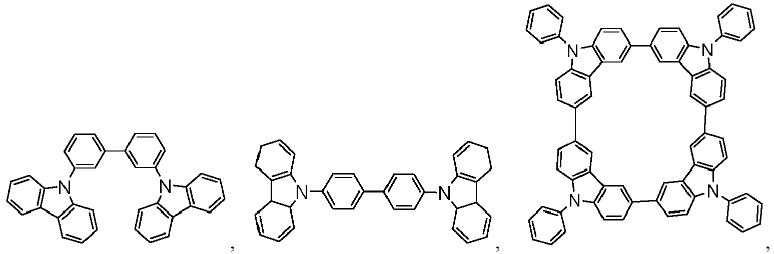

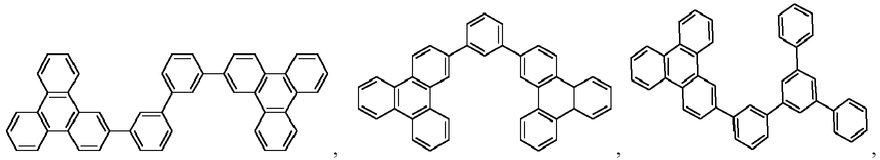

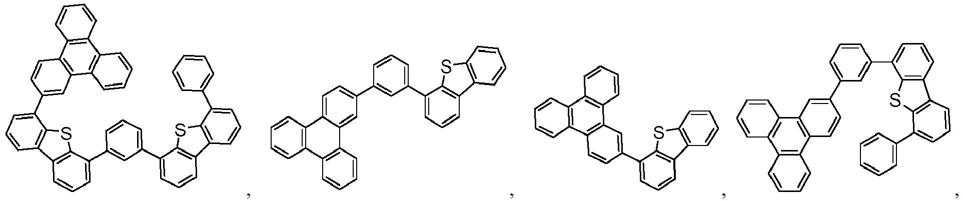

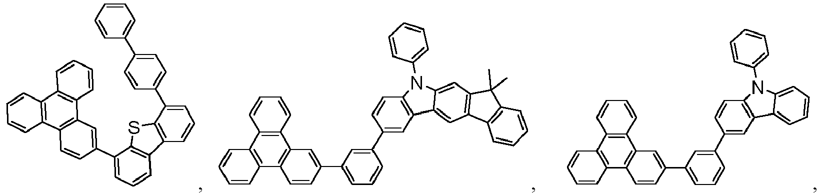

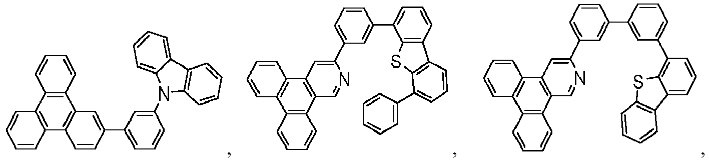

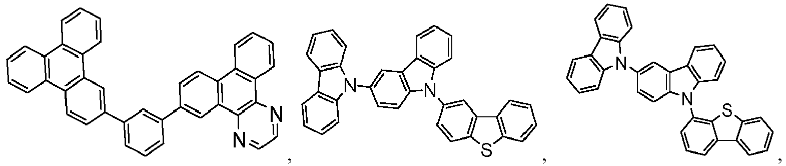

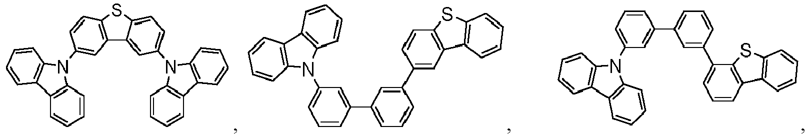

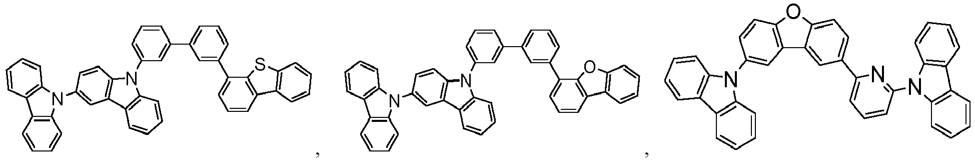

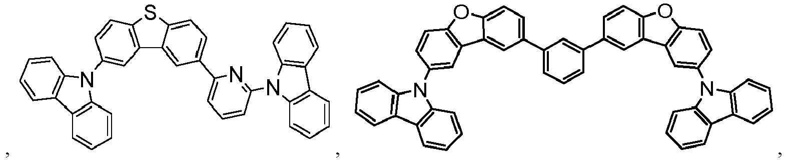

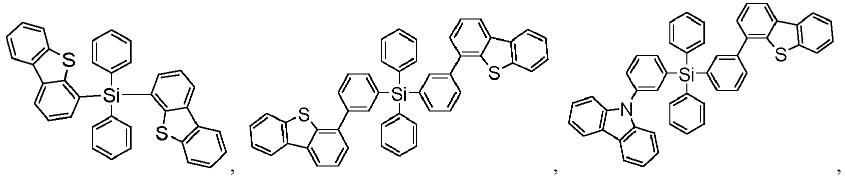

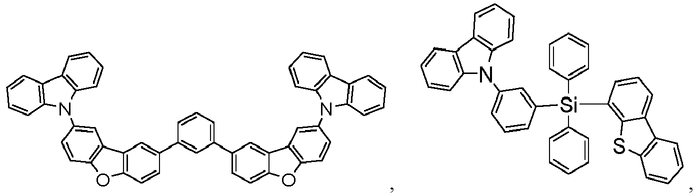

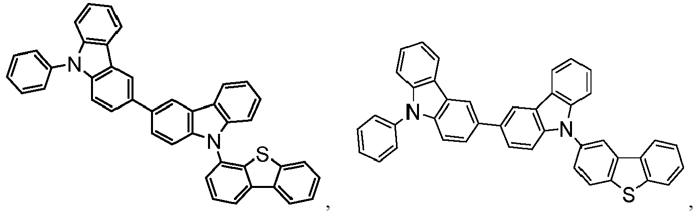

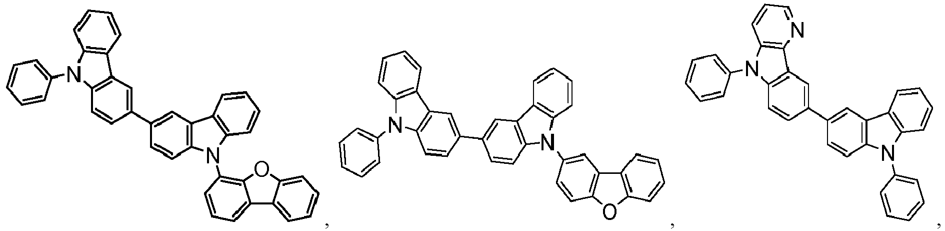

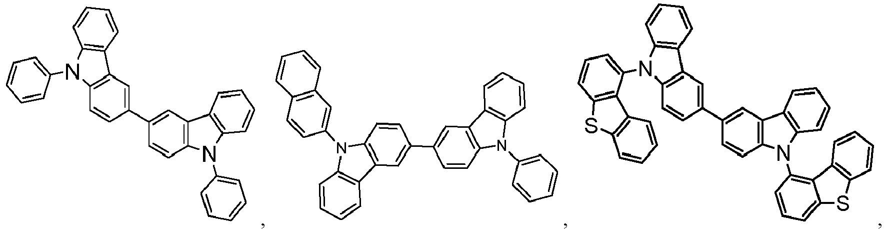

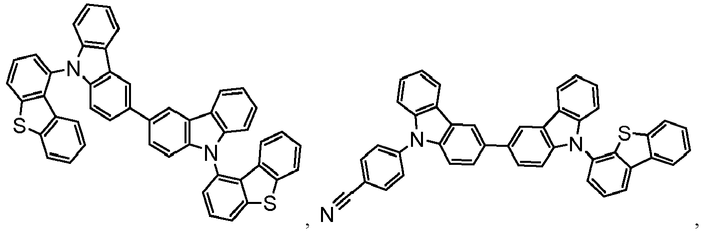

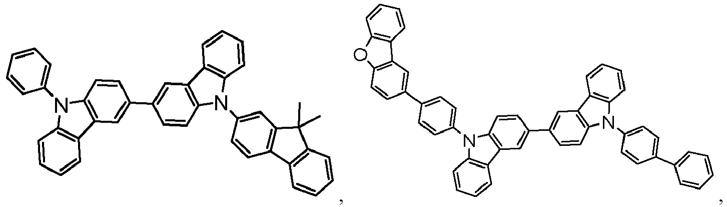

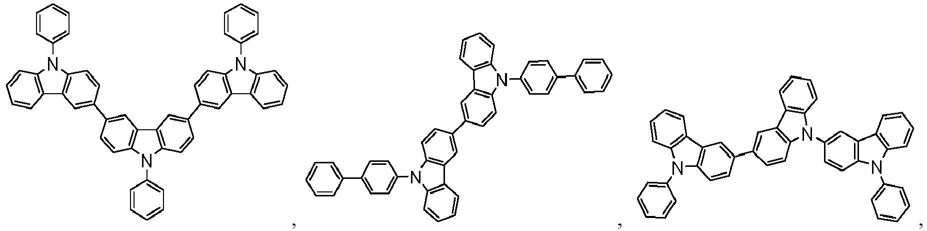

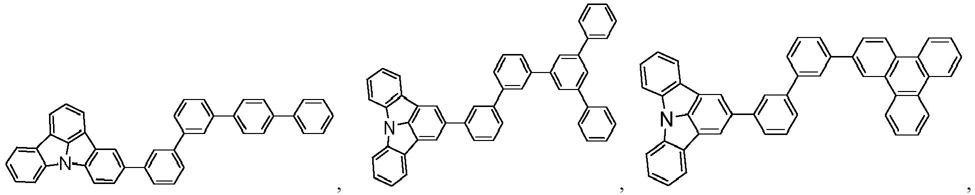

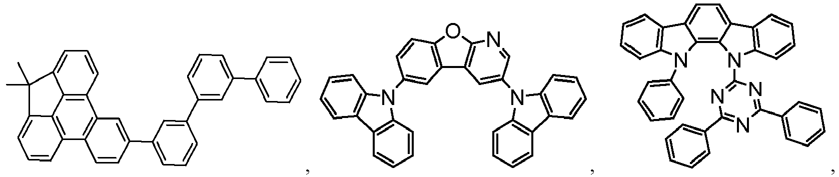

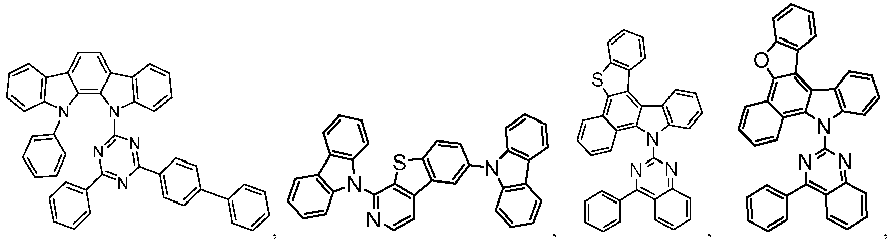

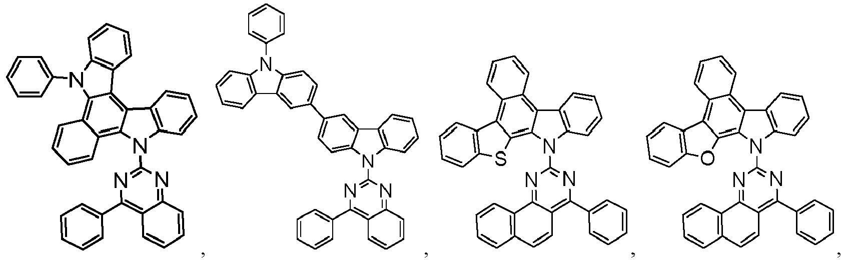

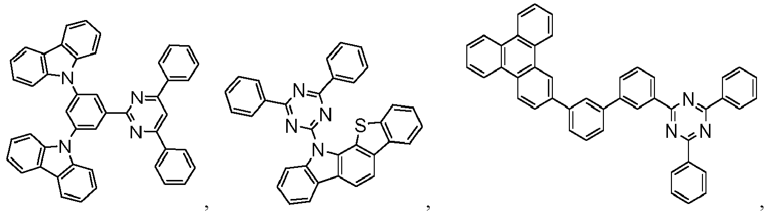

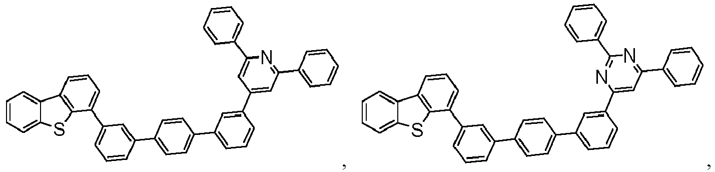

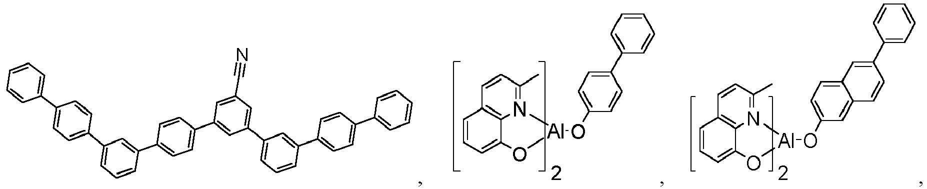

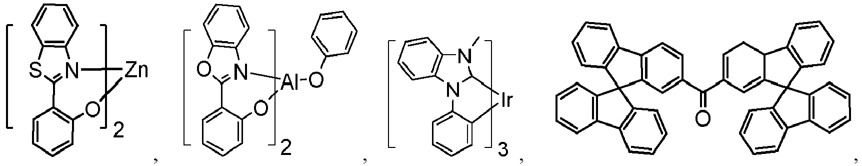

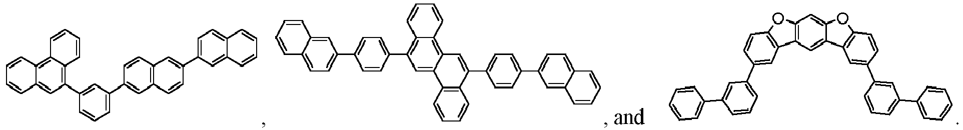

### e) Additional Emitters:

One or more additional emitter dopants may be used in conjunction with the compound of the present disclosure. Examples of the additional emitter dopants are not particularly limited, and any compounds may be used as long as the compounds are typically used as emitter materials. Examples of suitable emitter materials include, but are not limited to, compounds which can produce emissions via phosphorescence, fluorescence, thermally activated delayed fluorescence, i.e., TADF (also referred to as E-type delayed fluorescence), triplet-triplet annihilation, or combinations of these processes.
Non-limiting examples of the emitter materials that may be used in an OLED in combination with materials disclosed herein are exemplified below together with references that disclose those materials: CN103694277, CN1696137, EB01238981, EP01239526, EP01961743, EP1239526, EP1244155, EP1642951, EP1647554, EP1841834, EP1841834B, EP2062907, EP2730583, JP2012074444, JP2013110263, JP4478555, KR1020090133652, KR20120032054, KR20130043460, TW201332980, US06699599, US06916554, US20010019782, US20020034656, US20030068526, US20030072964, US20030138657, US20050123788, US20050244673, US2005123791, US2005260449, US20060008670, US20060065890, US20060127696, US20060134459, US20060134462, US20060202194, US20060251923, US20070034863, US20070087321, US20070103060, US20070111026, US20070190359, US20070231600, US2007034863, US2007104979, US2007104980, US2007138437, US2007224450, US2007278936, US20080020237, US20080233410, US20080261076, US20080297033, US200805851, US2008161567, US2008210930, US20090039776, US20090108737, US20090115322, US20090179555, US2009085476, US2009104472, US20100090591, US20100148663, US20100244004, US20100295032, US2010102716, US2010105902, US2010244004, US2010270916, US20110057559, US20110108822, US20110204333, US2011215710, US2011227049, US2011285275, US2012292601, US20130146848, US2013033172, US2013165653, US2013181190, US2013334521, US20140246656, US2014103305, US6303238, US6413656, US6653654, US6670645, US6687266, US6835469, US6921915, US7279704, US7332232, US7378162, US7534505, US7675228, US7728137, US7740957, US7759489, US7951947, US8067099, US8592586, US8871361, WO06081973, WO06121811, WO07018067, WO07108362, WO07115970, WO07115981, WO08035571, WO2002015645, WO2003040257, WO2005019373, WO2006056418, WO2008054584, WO2008078800, WO2008096609, WO2008101842, WO2009000673, WO2009050281, WO2009100991, WO2010028151, WO2010054731, WO2010086089, WO2010118029, WO2011044988, WO2011051404, WO2011107491, WO2012020327, WO2012163471, WO2013094620, WO2013107487, WO2013174471, WO2014007565, WO2014008982, WO2014023377, WO2014024131, WO2014031977, WO2014038456, WO2014112450.

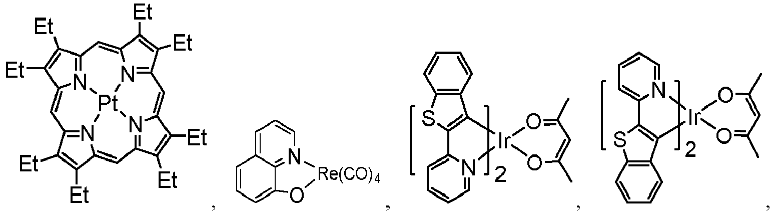

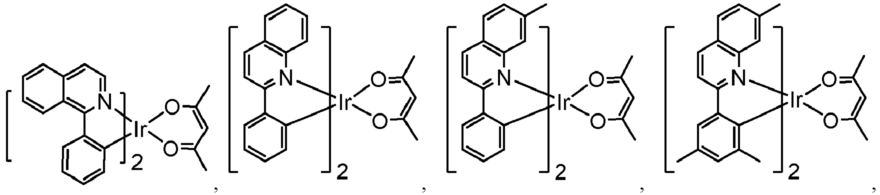

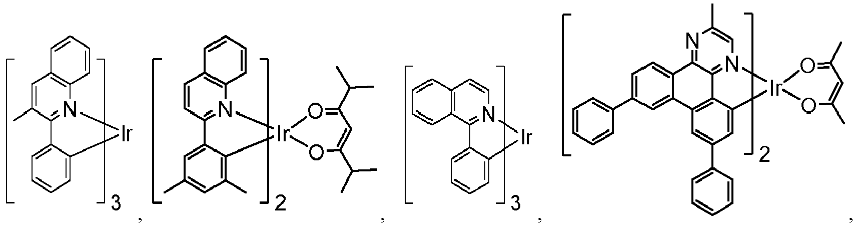

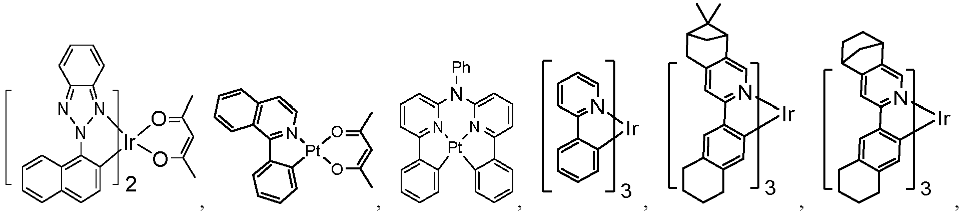

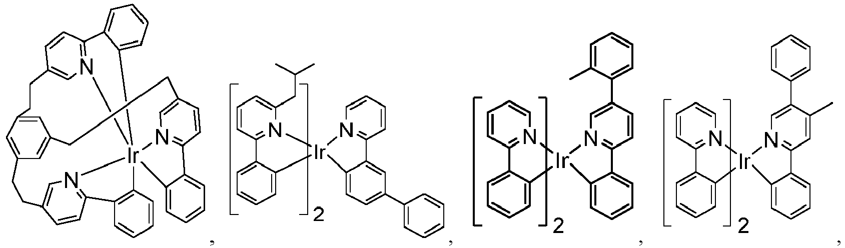

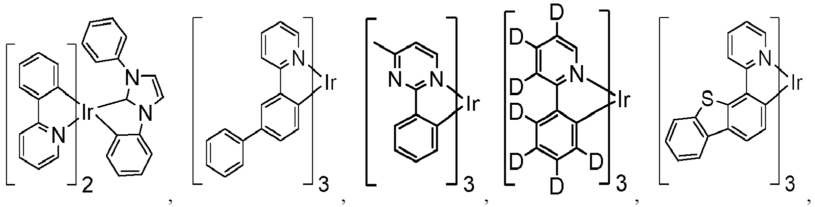

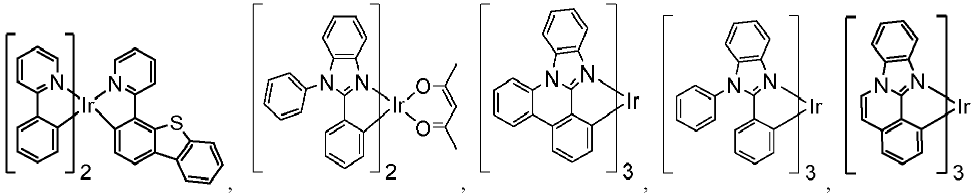

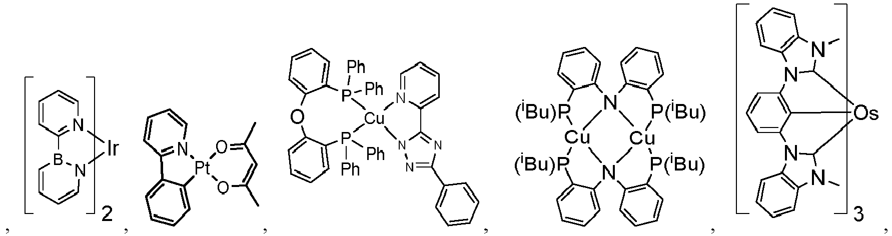

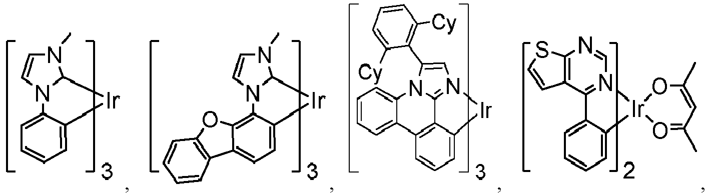

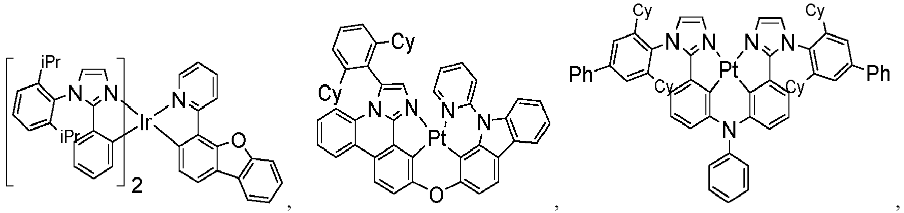

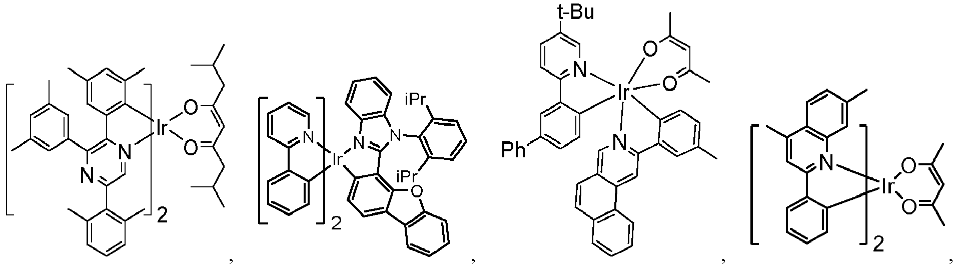

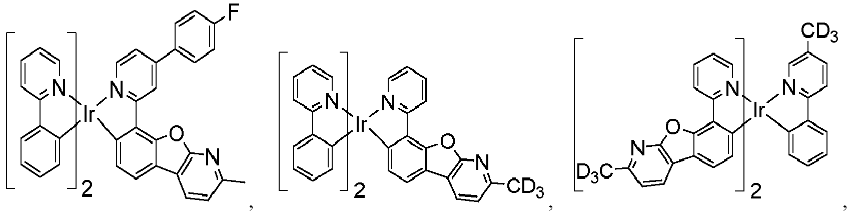

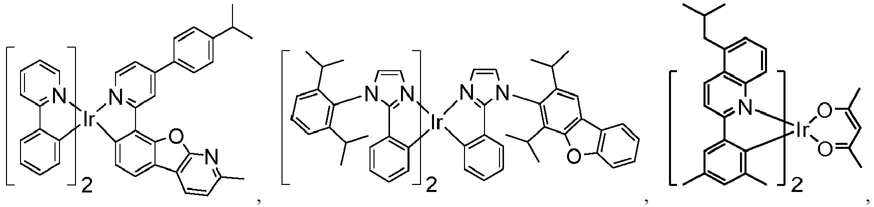

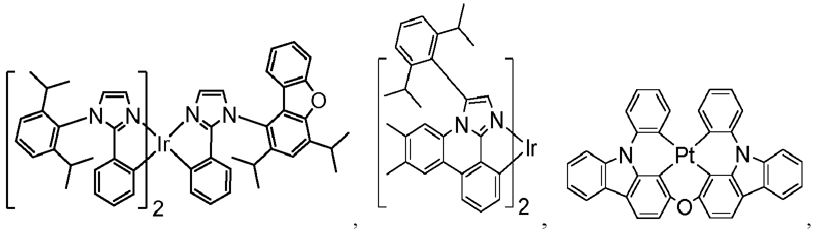

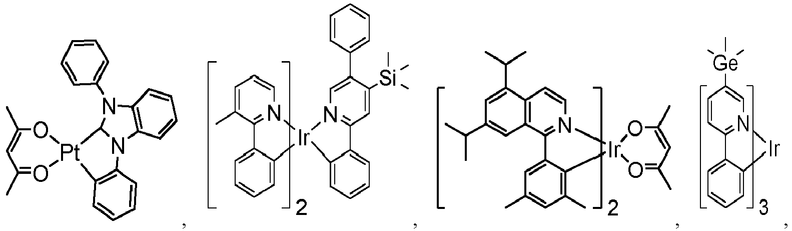

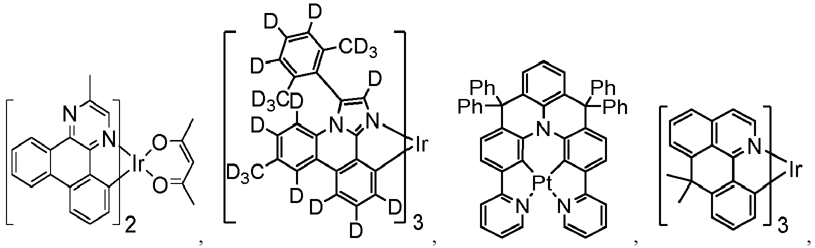

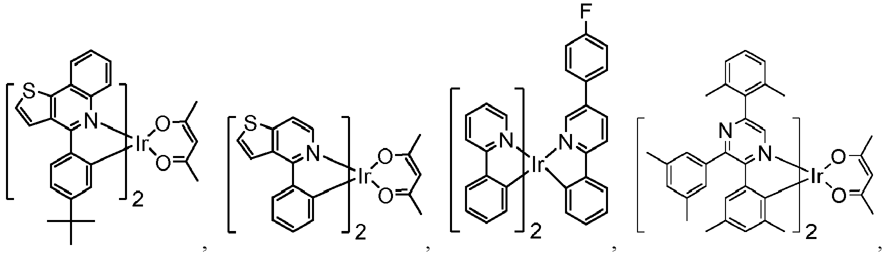

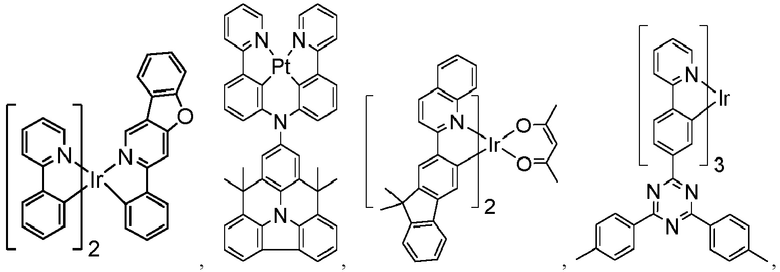

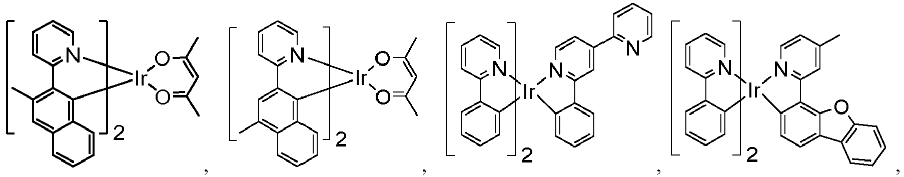

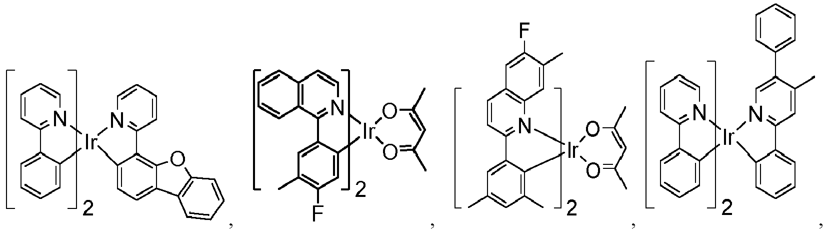

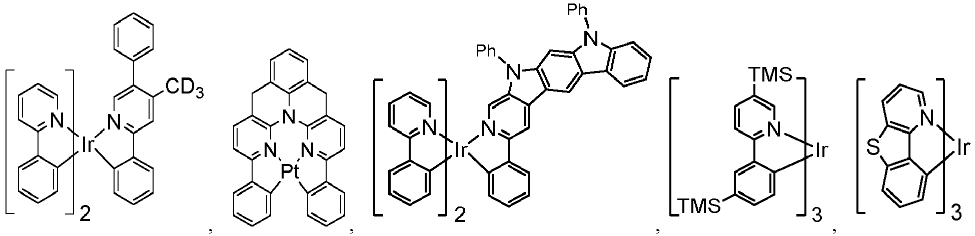

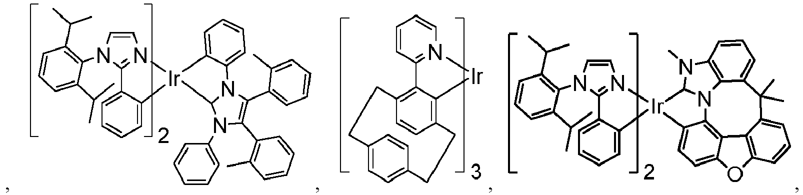

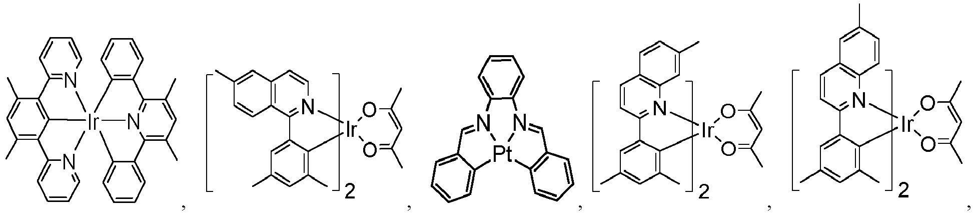

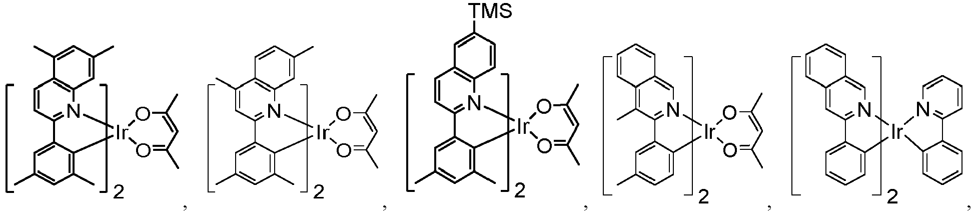

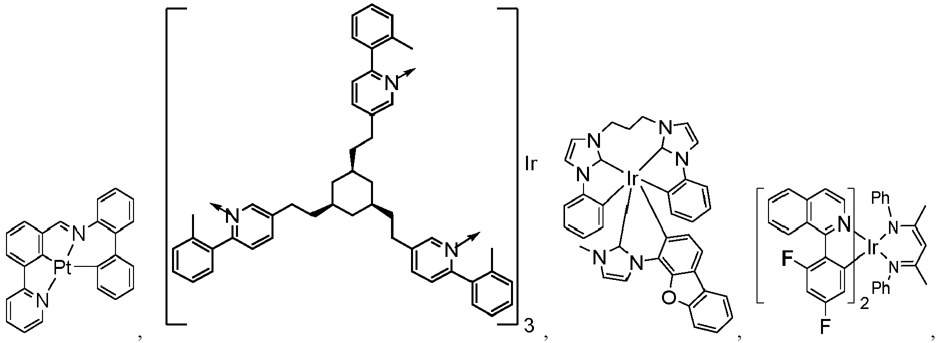

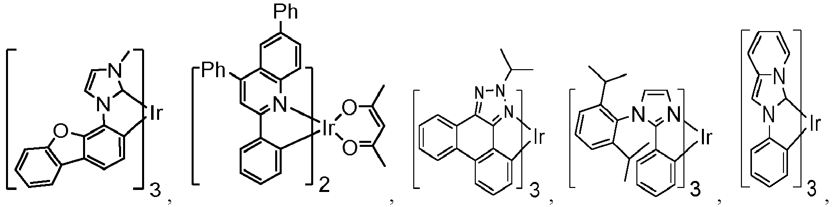

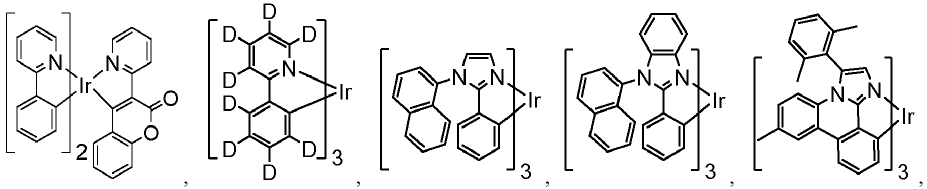

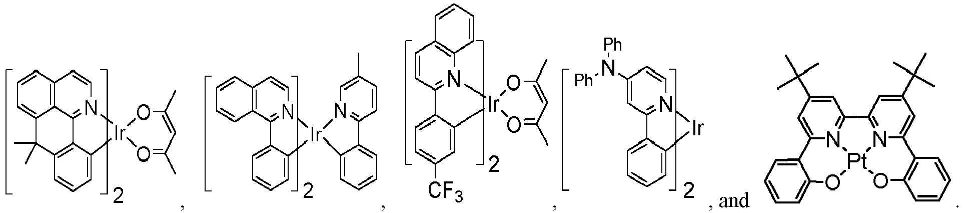

### f) HBL:

A hole blocking layer (HBL) may be used to reduce the number of holes and/or excitons that leave the emissive layer. The presence of such a blocking layer in a device may result in substantially higher efficiencies and/or longer lifetime as compared to a similar device lacking a blocking layer. Also, a blocking layer may be used to confine emission to a desired region of an OLED. In some embodiments, the HBL material has a lower HOMO (further from the vacuum level) and/or higher triplet energy than the emitter closest to the HBL interface. In some embodiments, the HBL material has a lower HOMO (further from the vacuum level) and/or higher triplet energy than one or more of the hosts closest to the HBL interface.

In one aspect, compound used in HBL contains the same molecule or the same functional groups used as host described above.

In another aspect, compound used in HBL contains at least one of the following groups in the molecule: 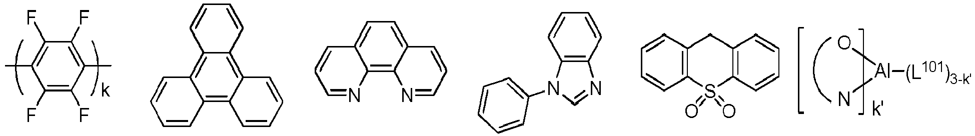 wherein k is an integer from 1 to 20; L¹⁰¹ is another ligand, k' is an integer from 1 to 3.

### g) ETL:

Electron transport layer (ETL) may include a material capable of transporting electrons. Electron transport layer may be intrinsic (undoped), or doped. Doping may be used to enhance conductivity. Examples of the ETL material are not particularly limited, and any metal complexes or organic compounds may be used as long as they are typically used to transport electrons.

In one aspect, compound used in ETL contains at least one of the following groups in the molecule: 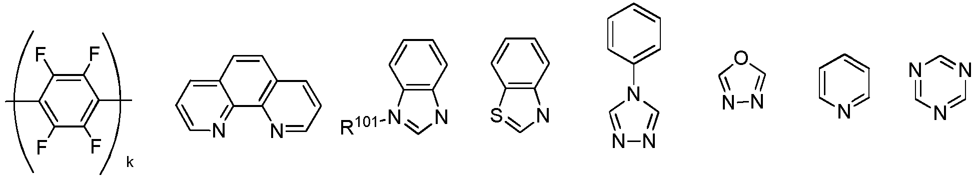 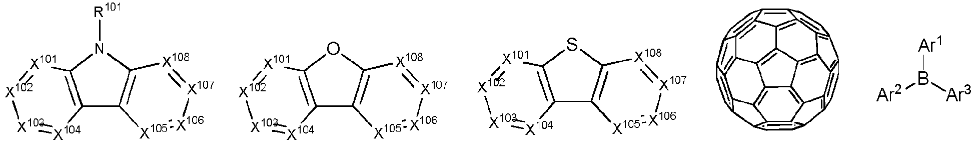 wherein R¹⁰¹ is selected from the group consisting of hydrogen, deuterium, halogen, alkyl, cycloalkyl, heteroalkyl, heterocycloalkyl, arylalkyl, alkoxy, aryloxy, amino, silyl, alkenyl, cycloalkenyl, heteroalkenyl, alkynyl, aryl, heteroaryl, acyl, carboxylic acids, ether, ester, nitrile, isonitrile, sulfanyl, sulfinyl, sulfonyl, phosphino, and combinations thereof, when it is aryl or heteroaryl, it has the similar definition as Ar's mentioned above. Ar¹ to Ar³ has the similar definition as Ar's mentioned above. k is an integer from 1 to 20. X¹⁰¹ to X¹⁰⁸ is selected from C (including CH) or N.

In another aspect, the metal complexes used in ETL contains, but not limit to the following general formula: 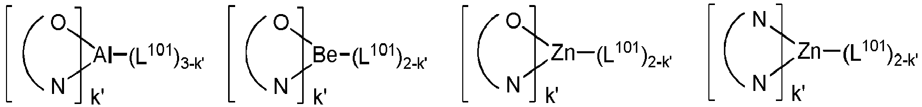 wherein (O-N) or (N-N) is a bidentate ligand, having metal coordinated to atoms O, N or N, N; L¹⁰¹ is another ligand; k' is an integer value from 1 to the maximum number of ligands that may be attached to the metal.

Non-limiting examples of the ETL materials that may be used in an OLED in combination with materials disclosed herein are exemplified below together with references that disclose those materials: CN103508940, EP01602648, EP01734038, EP01956007, JP2004-022334, JP2005149918, JP2005-268199, KR0117693, KR20130108183, US20040036077, US20070104977, US2007018155, US20090101870, US20090115316, US20090140637, US20090179554, US2009218940, US2010108990, US2011156017, US2011210320, US2012193612, US2012214993, US2014014925, US2014014927, US20140284580, US6656612, US8415031, WO2003060956, WO2007111263, WO2009148269, WO2010067894, WO2010072300, WO2011074770, WO2011105373, WO2013079217, WO2013145667, WO2013180376, WO2014104499, WO2014104535,

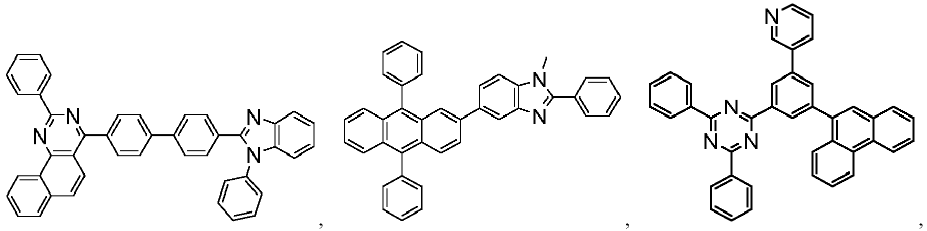

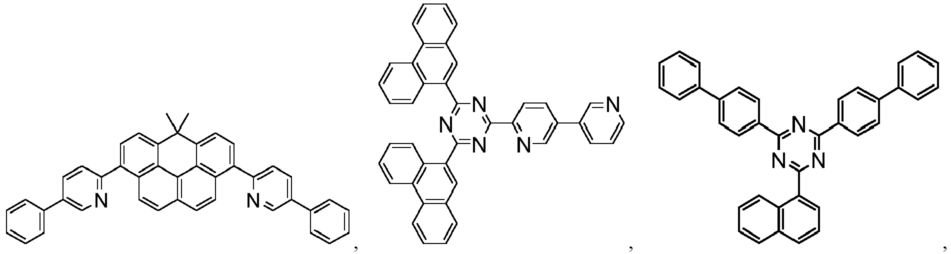

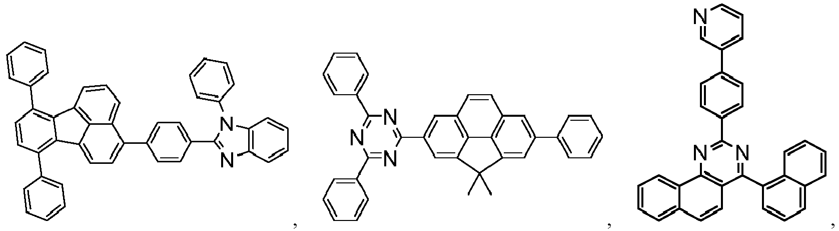

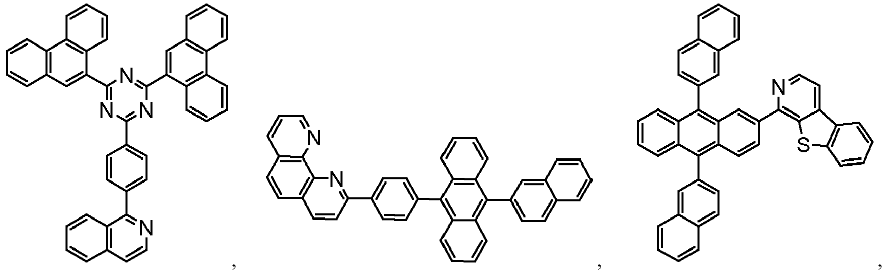

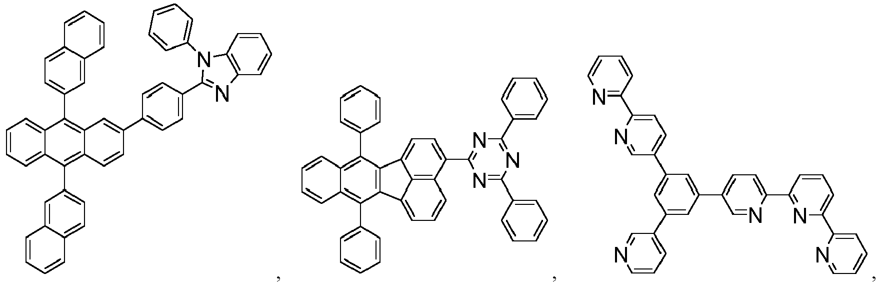

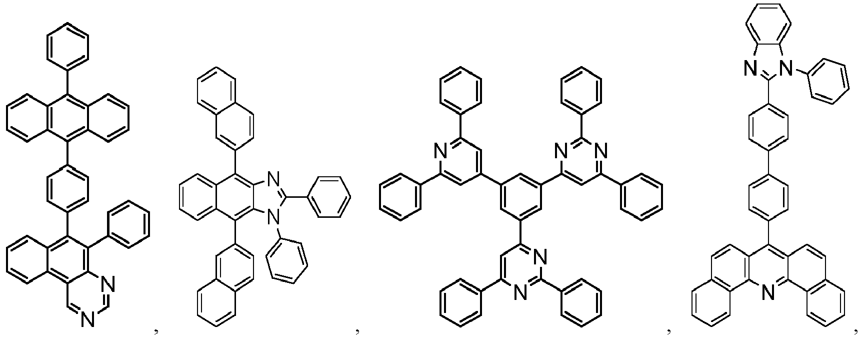

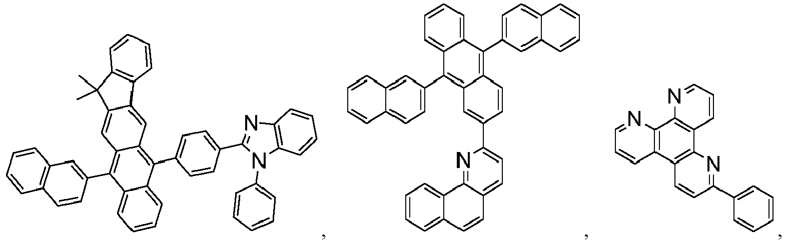

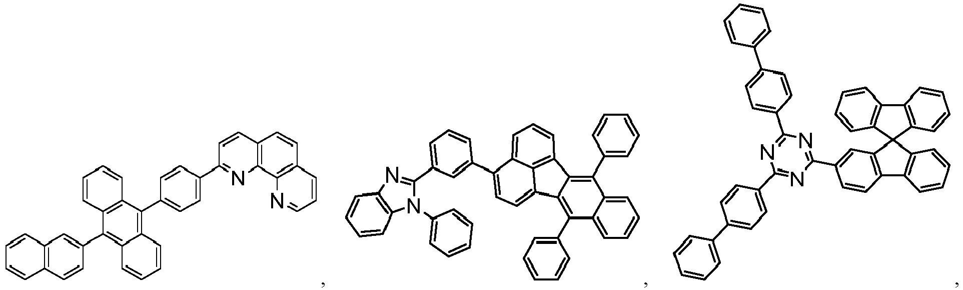

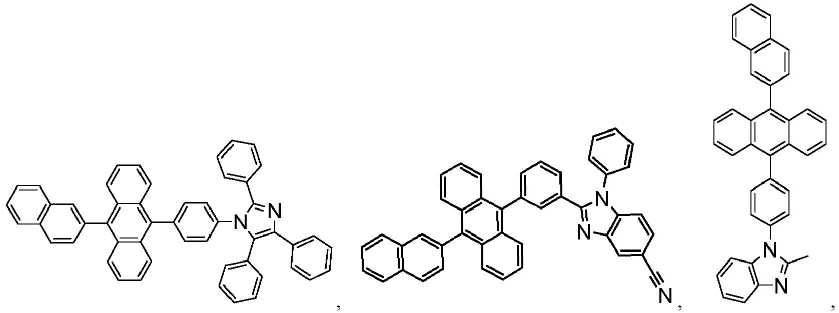

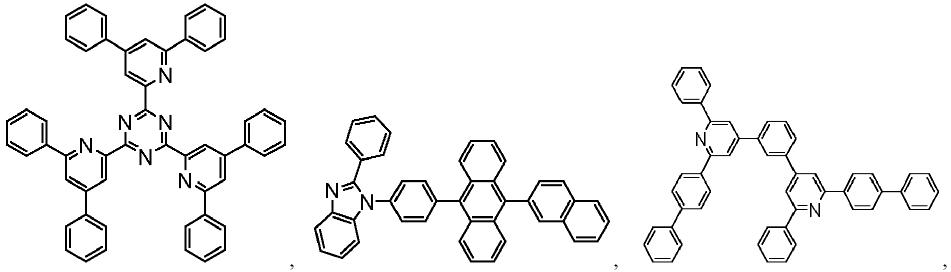

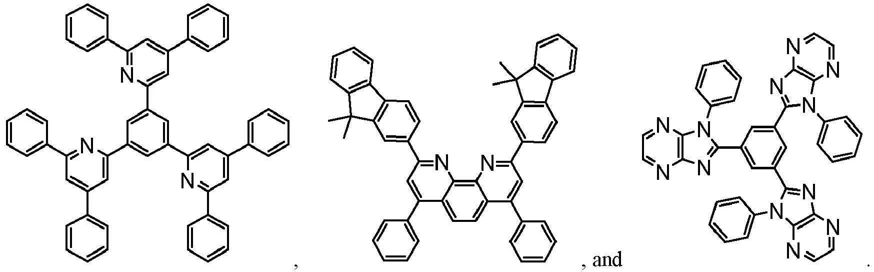

### h) Charge generation layer (CGL)

In tandem or stacked OLEDs, the CGL plays an essential role in the performance, which is composed of an n-doped layer and a p-doped layer for injection of electrons and holes, respectively. Electrons and holes are supplied from the CGL and electrodes. The consumed electrons and holes in the CGL are refilled by the electrons and holes injected from the cathode and anode, respectively; then, the bipolar currents reach a steady state gradually. Typical CGL materials include n and p conductivity dopants used in the transport layers.

In any above-mentioned compounds used in each layer of the OLED device, the hydrogen atoms can be partially or fully deuterated. The minimum amount of hydrogen of the compound being deuterated is selected from the group consisting of 30%, 40%, 50%, 60%, 70%, 80%, 90%, 95%, 99%, and 100%. Thus, any specifically listed substituent such as, but not limited to, methyl, phenyl, pyridyl, etc. may be undeuterated, partially deuterated, and fully deuterated versions thereof. Similarly, classes of substituents such as, but not limited to, alkyl, aryl, cycloalkyl, heteroaryl, etc. also may be undeuterated, partially deuterated, and fully deuterated versions thereof.

It is understood that the various embodiments described herein are by way of example only and are not intended to limit the scope of the invention. For example, many of the materials and structures described herein may be substituted with other materials and structures without deviating from the spirit of the invention. The present invention as claimed may therefore include variations from the particular examples and preferred embodiments described herein, as will be apparent to one of skill in the art. It is understood that various theories as to why the invention works are not intended to be limiting.

### G. Experimental Section

OLED devices were fabricated with the following material set.

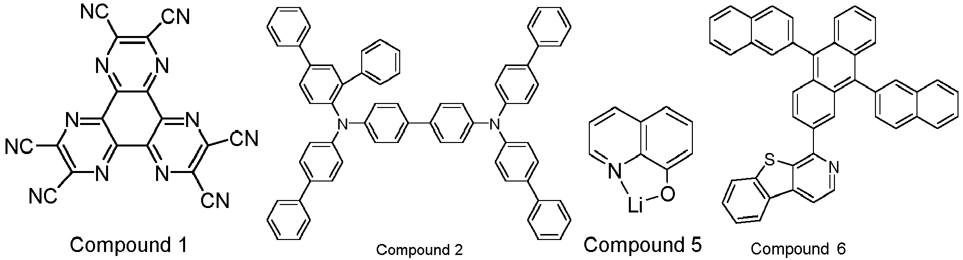

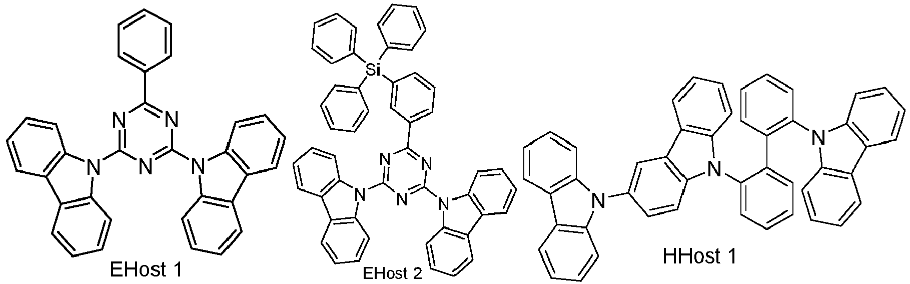

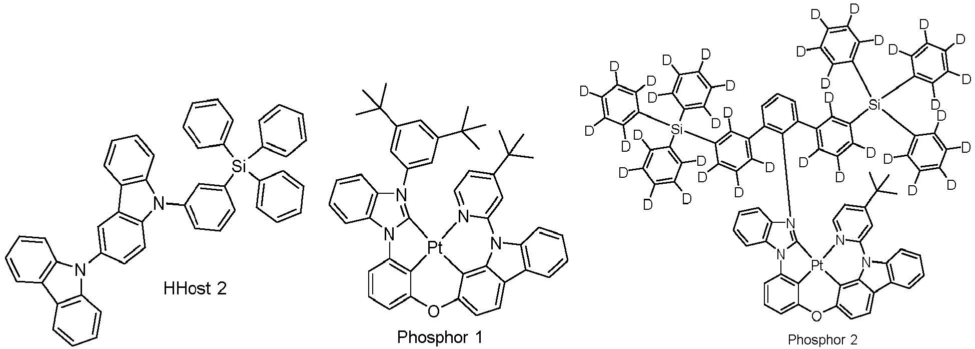

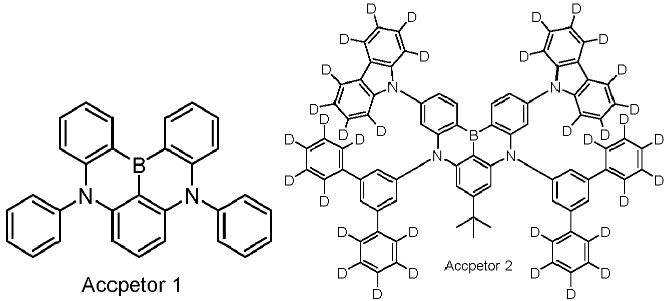

OLEDs were grown on a glass substrate pre-coated with an indium-tin-oxide (ITO) layer having a sheet resistance of 15-Ω/sq. Prior to any organic layer deposition or coating, the substrate was degreased with solvents and then treated with an oxygen plasma for 1.5 minutes with 50W at 100 mTorr and with UV ozone for 5 minutes. The devices were fabricated in high vacuum (< 10⁻⁶ Torr) by thermal evaporation. The anode electrode was 750 Å of indium tin oxide (ITO). All devices were encapsulated with a glass lid sealed with an epoxy resin in a nitrogen glove box (<1ppm of H₂O and O₂,) immediately after fabrication with a moisture getter incorporated inside the package. Doping percentages are in volume percent.

Five devices were grown having organic layers consisting of, sequentially, from the ITO surface, 100 Å of Compound 1 (HIL), 250 Å of Compound 2 (HTL), 50 Å of HHost (EBL), **EML,** 50Å of EHost (BL), 300 Å of Compound 5 doped with 35% of Compound 6 (ETL), 10 Å of Compound 5 (EIL) followed by 1,000 Å of Al (Cathode). Where EHost (EHost 1 or EHost 2) and HHost (HHost 1 or HHost 2) are the same compound as used in the EML for a given device. The composition of the EML is as shown in Table 1.

**TABLE 1: EML composition**

| | EML composition | Contains R* | | | |
|---|---|---|---|---|---|
| | | HHost | EHost | Acceptor | Phosphor |
| Example 1 | HHost 2: 35% EHost 2: 12% Phosphor 2: 1% Acceptor 2 | X | X | X | X |
| Example 2 | HHost 1: 50% EHost 2: 12% Phosphor 2: 1% Acceptor 2 | | X | X | X |
| Example 3 | HHost 1: 50% EHost 1: 12% Phosphor 2: 1% Acceptor 2 | | | X | X |
| Comparison 1 | HHost 1: 50% EHost 1: 12% Phosphor 2: 1% Acceptor 1 | | | | X |
| Comparison 2 | HHost 1: 50% EHost 1: 12% Phosphor 1: 1% Acceptor 1 | | | | |

The emission characteristics, EQE and lifetime are reported in Table 2 where the EQE are taken at 10mA/cm² and LT90 is the time to reduction of brightness to 90% of the initial luminance at a constant current density of 20mA/cm². Both the EQE and lifetime are reported relative to the values for Comparison 2.

**TABLE 2: Device Data**

| Device | CIE | λmax (nm) | Relative EQE | Relative LT90 |
|---|---|---|---|---|
| Example 1 | (0.126, 0.121) | 465 | 2.02 | 5.71 |
| Example 2 | (0.124, 0.129) | 467 | 2.11 | 3.93 |
| Example 3 | (0.124, 0.131) | 467 | 2.18 | 1.93 |
| Comparison 1 | (0.143, 0.146) | 460 | 1.08 | 0.64 |
| Comparison 2 | (0.149, 0.172) | 461 | 1.00 | 1.00 |

The above data shows that the addition of sterically bulky groups, such as triaryl silanes or terphenyl groups, to two or more of the materials in the EML improved both the EQE and lifetime of the sensitized devices. The addition of bulky groups to the phosphor only, in Comparison 1, resulted in a small improvement in EQE but with much worse device lifetime, compared to Comparison 2, which had none of these bulky groups. When pairing the silane groups for Phosphor 2 with the terphenyl groups on Acceptor 2 for Example 3, both the EQE and lifetime had an unexpectedly dramatic improvement of 118% and 93% respectively compared to Comparison 2. Further introducing bulky groups on the EHost, Example 2, and the HHost, Example 1 further improved the lifetime to 3.9x and 5.7x compared to Comparison 2. The doubling of EQE and nearly 1.9-5.7 times higher lifetimes are considered a dramatic change and beyond any values that could be attributed to experimental error and the observed improvements are significant. Based on the fact that the devices have similar structures with the primary difference being the addition of triphenyl silyl or terphenyl groups, the significant performance improvement observed in the above data is unexpected. Without being bound by any theory, this improvement may be attributed to suppressed intermolecular interactions which reduces the degree of dexter energy transfer which can reduce both efficiency and device operational lifetime.

### The invention is further described by the following numbered aspects:

1. An organic light emitting device (OLED) comprising: an anode; a hole transporting layer; an emissive region; an electron transporting layer; and a cathode; wherein the emissive region comprises: a first compound; a second compound; and a third compound; wherein the first compound is a sensitizer that transfers energy to the second compound; wherein the second compound is an acceptor that is an emitter; wherein the third compound is a first host, and at least one of the first compound and the second compound is doped in the third compound; wherein at least two of the first, second, and the third compounds comprises same or different substituent R*; wherein R* is selected from the group consisting of: 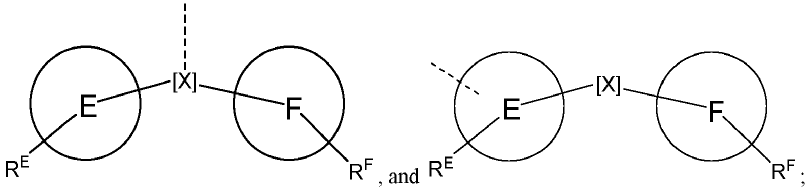 wherein
   [X] is a chemical moiety comprises at least one six-membered carbocyclic, a silyl group, a germyl group, or heterocyclic ring; moieties E and F are each independently a monocyclic ring, or a polycyclic fused ring system; wherein the monocyclic ring and each ring of the polycyclic fused ring system are independently a 5-membered or 6-membered carbocyclic or heterocyclic ring;
   R^{E}, and R^{F} each independently represent mono to the maximum allowable substitution, or no substitution; wherein each R^{E}, and R^{F} is independently a hydrogen or a substituent selected from the group consisting of deuterium, halogen, alkyl, cycloalkyl, heteroalkyl, heterocycloalkyl, boryl, arylalkyl, alkoxy, aryloxy, amino, silyl, germyl, alkenyl, cycloalkenyl, heteroalkenyl, alkynyl, aryl, heteroaryl, acyl, carboxylic acid, ether, ester, nitrile, isonitrile, sulfanyl, sulfinyl, sulfonyl, phosphino, selenyl, and combinations thereof; any adjacent substituents are optionally joined or fused into a ring.
2. The OLED of aspect 1, wherein the first compound is capable of functioning as a phosphorescent emitter or a TADF emitter in an OLED at room temperature; and/or wherein the second compound is a delayed-fluorescent compound functioning as a TADF emitter in said OLED at room temperature or a fluorescent compound functioning as an emitter in said OLED at room temperature; and/or wherein the first compound forms an exciplex with the third compound in said OLED at room temperature.
3. The OLED of aspect 1 or 2, wherein [X] is selected from the group consisting of a substituted or unsubstituted monocyclic ring, a substituted or unsubstituted polycyclic fused ring system, SiR^{P}, SiR^{P}R^{Q}, GeR^{P}, GeR^{P}R^{Q}, BR^{P}, BR^{P}R^{Q}, CR^{P}R^{Q}, NR^{P}, and PR^{P} wherein R^{P} comprises a 6-membered carbocyclic or heterocyclic ring, and R^{Q} is a hydrogen or a substituent selected from the group consisting of deuterium, halogen, alkyl, cycloalkyl, heteroalkyl, heterocycloalkyl, boryl, arylalkyl, alkoxy, aryloxy, amino, silyl, germyl, alkenyl, cycloalkenyl, heteroalkenyl, alkynyl, aryl, heteroaryl, acyl, carboxylic acid, ether, ester, nitrile, isonitrile, sulfanyl, sulfinyl, sulfonyl, phosphino, selenyl, and combinations thereof.
4. The OLED of any one of the previous aspects, wherein the first compound is partially or fully deuterated; and/or wherein the second compound is partially or fully deuterated; and/or wherein the third compound is partially or fully deuterated.
5. The OLED of any one of the previous aspects, wherein R* is selected from the group consisting of: 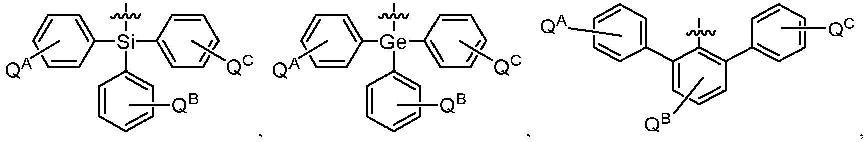 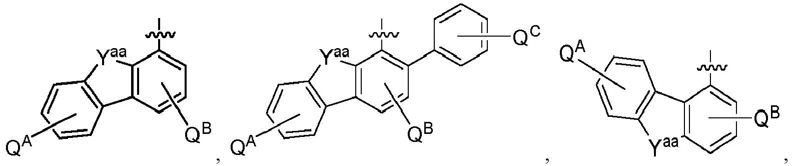 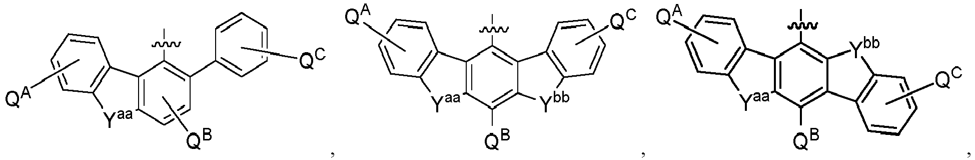 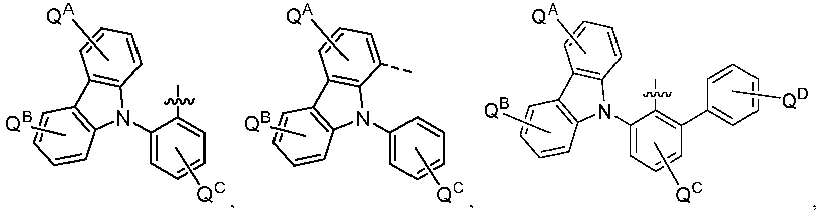 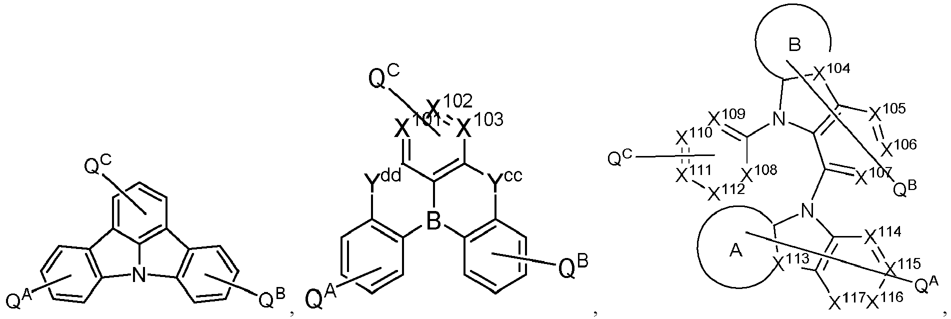 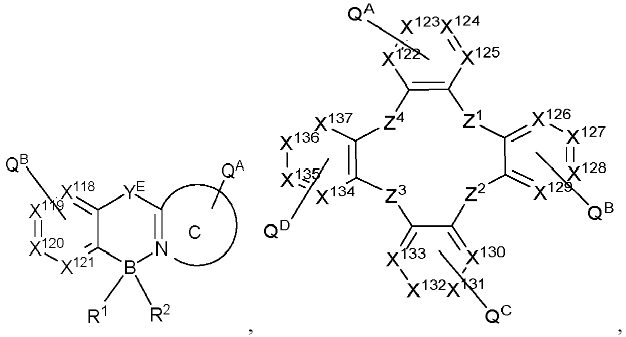 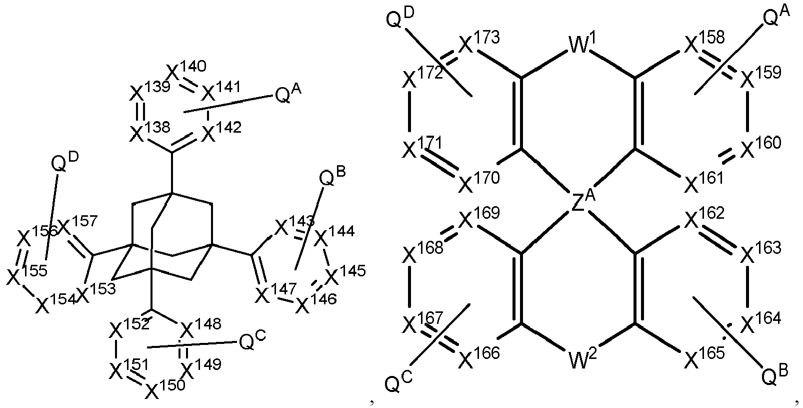 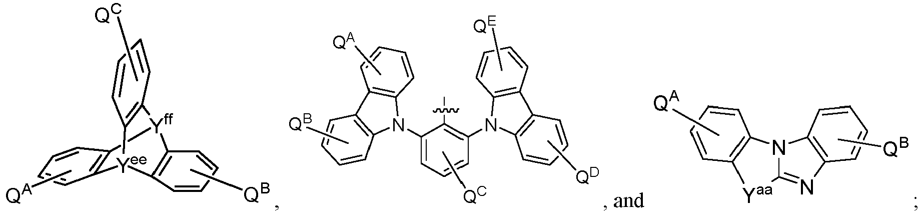
   wherein rings A, B, and C are each independently a 5-membered or 6-membered carbocyclic or heterocyclic ring;
   Z¹ to Z⁴ are each independently a direct bond or selected from the group consisting of O, S, Se, NR, BR, BRR', PR, CR, C=X, CRR', SO, SO₂, SiRR', GeRR', P(O)R, aryl, hetero aryl, alkyl, hetero cycloalkyl, and cycloalkyl;
   each X¹⁰¹-X¹⁷³ is independently C or N; Z^{A} is selected from the group consisting of C, Si, and Ge; wherein W¹ and W² are each independently selected from the group consisting of direct bond, O, S, Se, CRR', SiRR', and GeRR'; each Y^{aa} and Y^{bb} is independently selected from the group consisting of O, S, Se, CRR', SiRR', GeRR', NR, BR, and BRR'; each Y^{E}, Y^{cc} and Y^{dd} is independently selected from the group consisting of O, S, Se, CRR', SiRR', GeRR', BR, and BRR'; each Y^{ee} and Y^{ff} is independently selected from the group consisting of CR, SiR, GeR, B, and N; each Q^{A} to Q^{E} independently represents mono to the maximum allowable substitutions, or no substitution;
   each R, R', Q^{A} to Q^{E} is independently hydrogen or a substituent selected from the group consisting of deuterium, halogen, alkyl, cycloalkyl, heteroalkyl, heterocycloalkyl, arylalkyl, alkoxy, aryloxy, amino, silyl, germyl, boryl, alkenyl, cycloalkenyl, heteroalkenyl, alkynyl, aryl, heteroaryl, acyl, carboxylic acid, ether, ester, nitrile, isonitrile, sulfanyl, sulfinyl, sulfonyl, phosphino, selenyl, and combinations thereof; any two substituents can be joined or fused into a ring; and any carbon ring atoms up to maximum total number of three, together with their substituents, in each phenyl ring of any of above structures can be replaced with N.
6. The OLED of any one of the previous aspects, wherein R* is selected from the group consisting of the structures of LIST 1 as defined herein.
7. The OLED of any one of the previous aspects, wherein the OLED emits a luminescent emission comprising an emission component from the S₁ energy of the second compound when a voltage is applied across the OLED; and/or wherein at least 65% of the emission from the OLED is produced from the second compound with a luminance of at least 10 cd/m².
8. The OLED of any one of the previous aspects, wherein T₁ energy of the third compound is higher than those of the first and the second compounds; and/or wherein S₁ energy of the second compound is lower than those of the first and the third compounds; and/or wherein S₁-T₁ energy gap of the first compound is less than 300 meV; and/or wherein S₁-T₁ energy gap of the second compound is less than 300 meV; and/or wherein the second compound has a Stokes shift of 30 nm or less.
9. The OLED of any one of the previous aspects, wherein the first compound has an emission maximum of λₘₐₓ₁ in an monochromic OLED having the third compound as the host at room temperature; wherein the second compound has an emission maximum of λₘₐₓ₂ in the monochromic OLED by replacing the first compound with the second compound; wherein Dλ = λₘₐₓ₁ - λ ₘₐₓ₂; and wherein Dλ is equal to or less than the number selected from the group consisting of 15, 12, 10, 8, 6, 4, 2, 0, -2, -4, -6, -8, and -10 nm.
10. The OLED of any one of the previous aspects, wherein the first compound has the formula of M(L¹)ₓ(L²)_{y}(L³)_{z}; wherein L¹, L², and L³ can be the same or different; wherein x is 1, 2, or 3; wherein y is 0, 1, or 2; wherein z is 0, 1, or 2; wherein x+y+z is the oxidation state of the metal M; wherein L¹ is selected from the group consisting of: 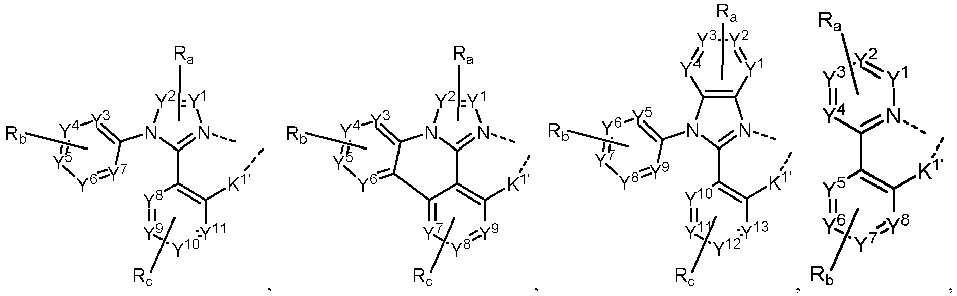 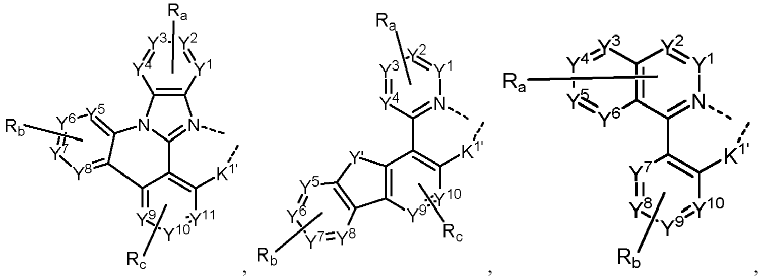 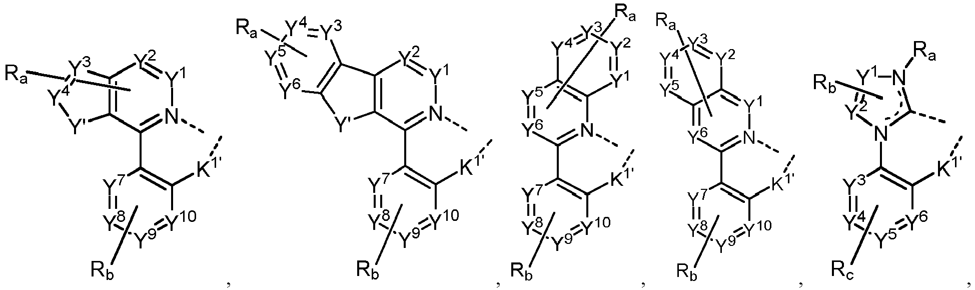 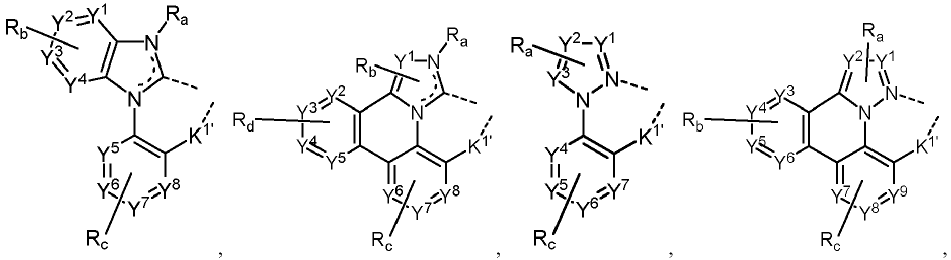 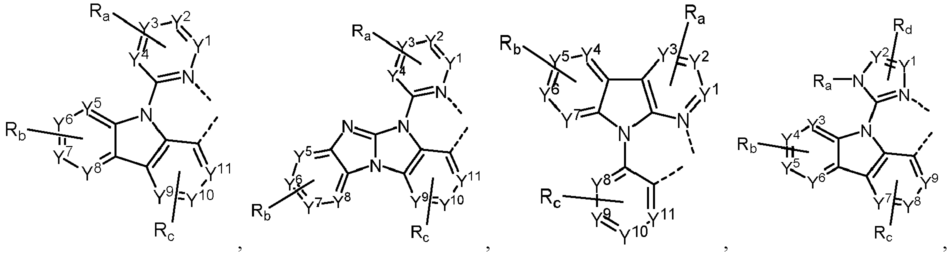 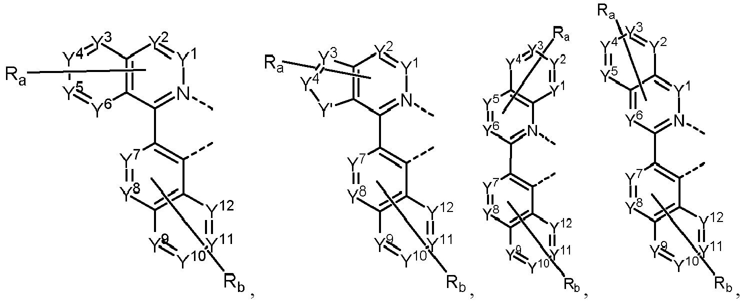 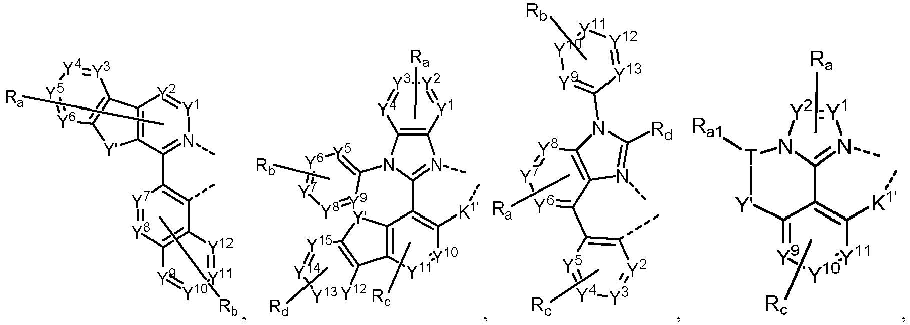 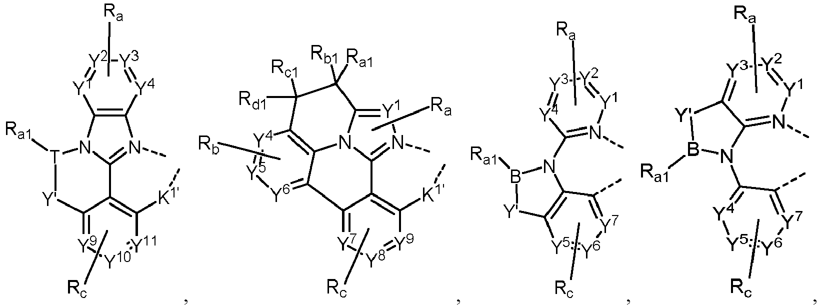 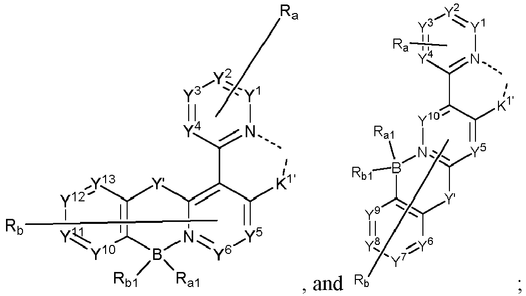
   wherein L² and L³ are independently selected from the group consisting of 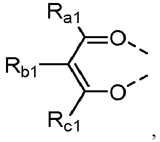 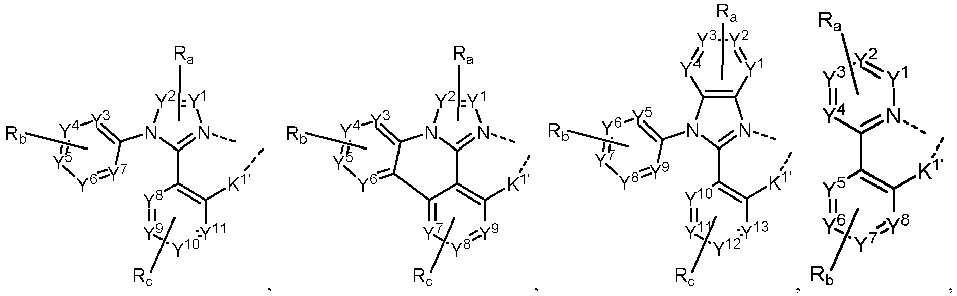 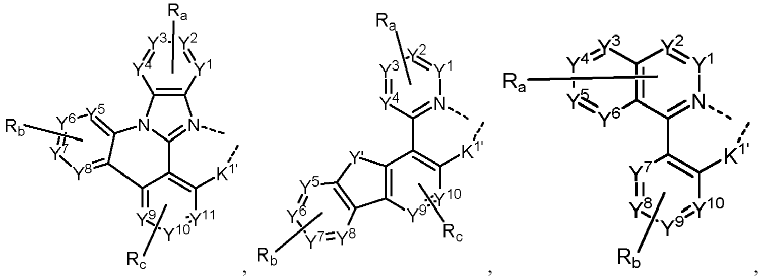 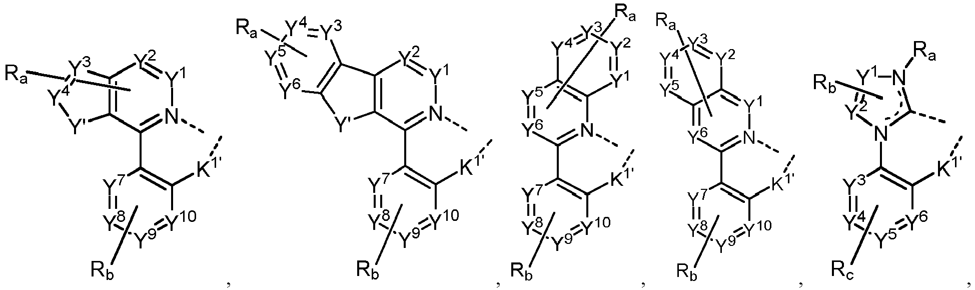 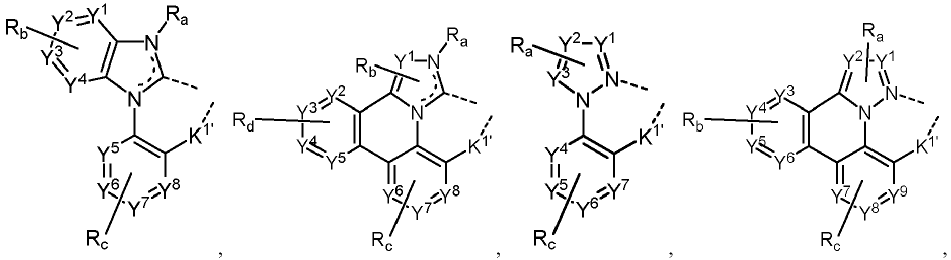 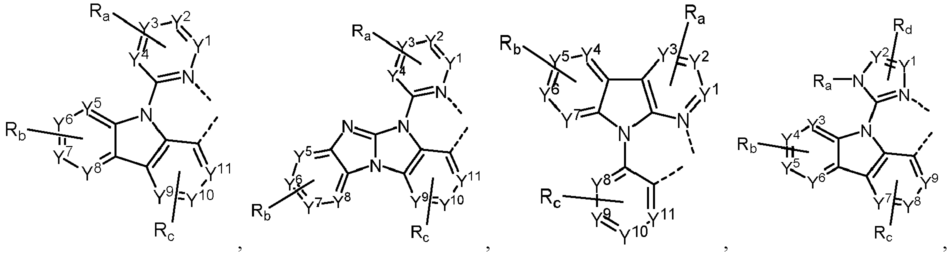 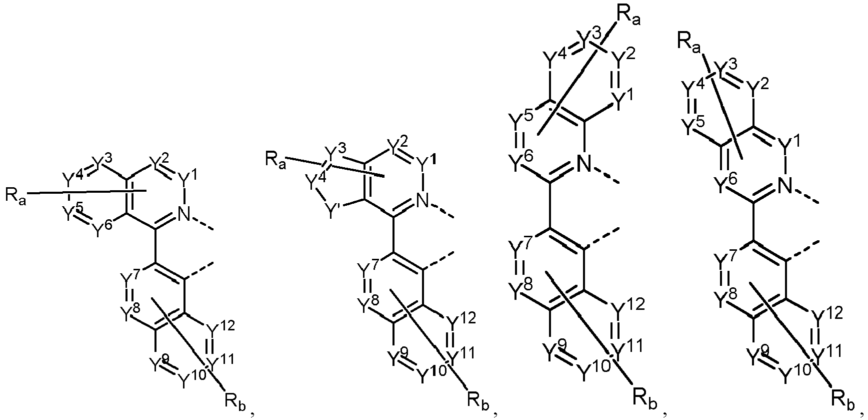 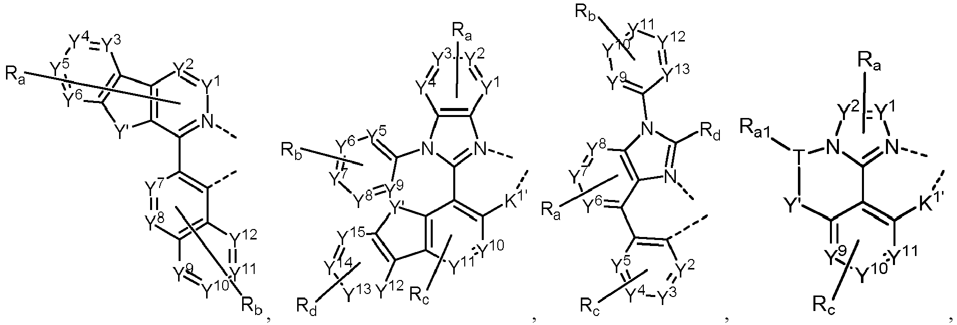 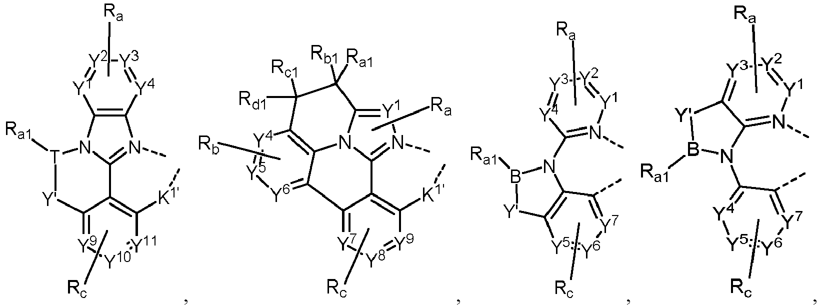 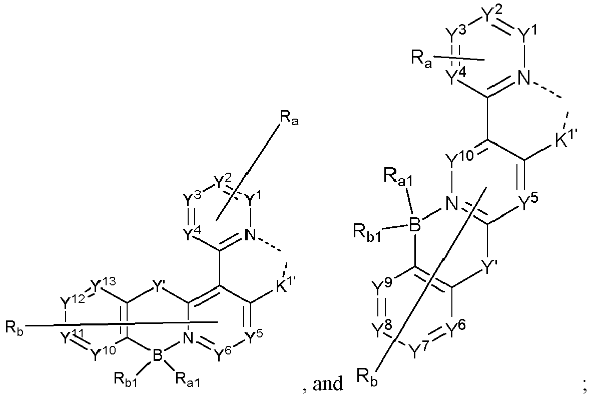
   wherein T is selected from the group consisting of B, Al, Ga, and In; wherein K^{1'} is a direct bond or is selected from the group consisting of NRₑ, PRₑ, O, S, and Se; wherein each Y¹ to Y¹³ are independently selected from the group consisting of carbon and nitrogen; wherein Y' is selected from the group consisting of B Rₑ, N Rₑ, P Rₑ, O, S, Se, C=O, S=O, SO₂, CRₑR_{f}, SiRₑR_{f}, and GeRₑR_{f}; wherein Rₑ and R_{f} can be fused or joined to form a ring; wherein each Rₐ, R_{b}, R_{c}, and R_{d} can independently represent from mono to the maximum possible number of substitutions, or no substitution; wherein each Rₐ₁, R_{b1}, R_{c1}, R_{d1}, Rₐ, R_{b}, R_{c}, R_{d}, Rₑ, and R_{f} is independently a hydrogen or a substituent selected from the group consisting of deuterium, halogen, alkyl, cycloalkyl, heteroalkyl, heterocycloalkyl, boryl, arylalkyl, alkoxy, aryloxy, amino, silyl, germyl, alkenyl, cycloalkenyl, heteroalkenyl, alkynyl, aryl, heteroaryl, acyl, carboxylic acid, ether, ester, nitrile, isonitrile, sulfanyl, sulfinyl, sulfonyl, phosphino, selenyl, and combinations thereof; and wherein any two adjacent substituents of Rₐ₁, R_{b1}, R_{c1}, R_{d1}, Rₐ, R_{b}, R_{c}, and R_{d} can be fused or joined to form a ring or form a multidentate ligand.
11. The OLED of any one of the previous aspects, wherein the first compound is selected from the group consisting of the compounds of LIST 2 defined herein above; wherein
   each of X⁹⁶ to X⁹⁹ is independently C or N; each Y¹⁰⁰ is independently selected from the group consisting of a NR", O, S, and Se; L is independently selected from the group consisting of a direct bond, BR", BR"R'", NR", PR", O, S, Se, C=O, C=S, C=Se, C=NR", C=CR"R‴, S=O, SO₂, CR", CR"R‴, SiR"R‴, GeR"R‴, alkyl, cycloalkyl, aryl, heteroaryl, and combinations thereof; X¹⁰⁰, and X²⁰⁰ for each occurrence is selected from the group consisting of O, S, Se, NR", and CR"R‴; each R^{10a}, R^{20a}, R^{30a}, R^{40a}, and R^{50a}, R^{A"}, R^{B"}, R^{C"}, R^{D"}, R^{E"}, and R^{F"} independently represents mono-, up to the maximum substitutions, or no substitutions; each of R, R', R", R‴, R^{10a}, R^{11a}, R^{12a}, R^{13a}, R^{20a}, R^{30a}, R^{40a}, R^{50a}, R⁶⁰, R⁷⁰, R⁹⁷, R⁹⁸, R⁹¹, R^{A1'} R^{A2'} R^{A"}, R^{E"}, R^{C"}, R^{D"} R^{E"}, R^{F"} R^{G"}, R^{H"} R^{I"}, R^{J"} R^{K"}, R^{L"}, R^{M"}, and R^{N"} is independently a hydrogen or a substituent selected from the group consisting of the general substituents as defined herein; wherein any two substituents can be fused or joined to form into a ring.
12. The OLED of aspect 1, wherein the first compound is selected from the group consisting of: 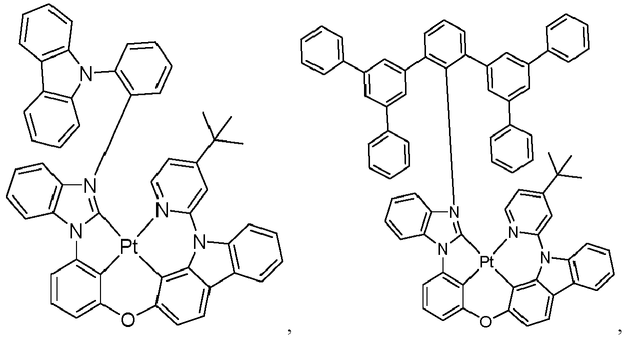 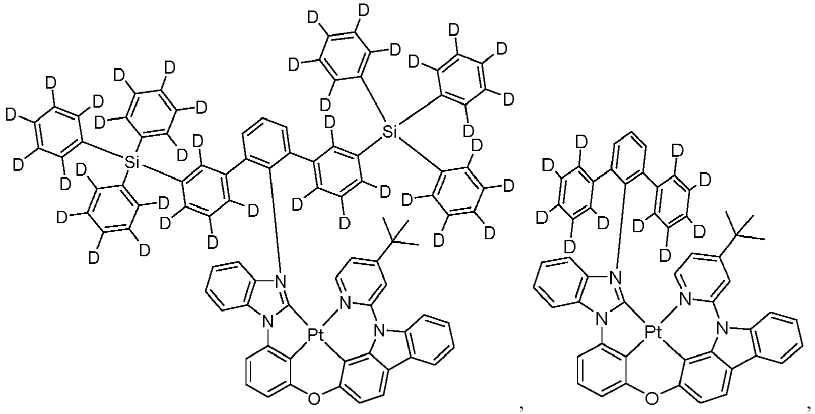 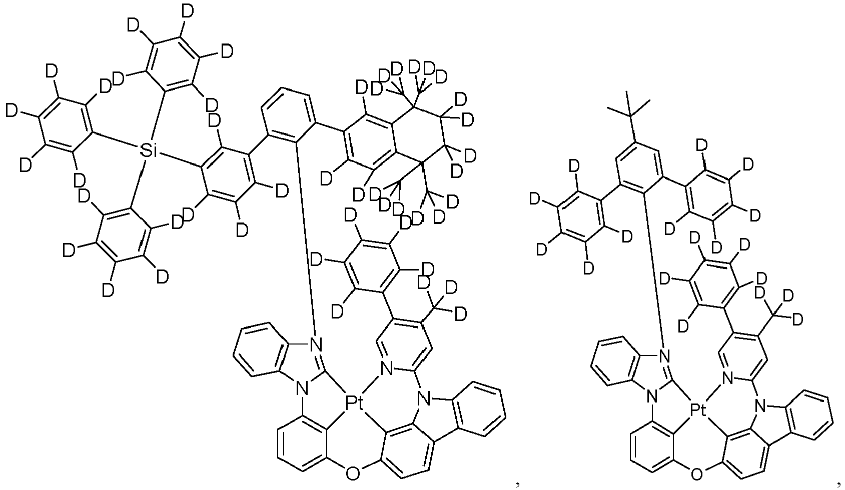 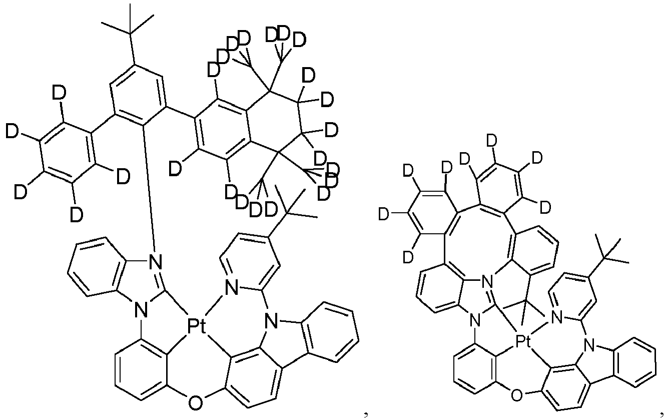 and 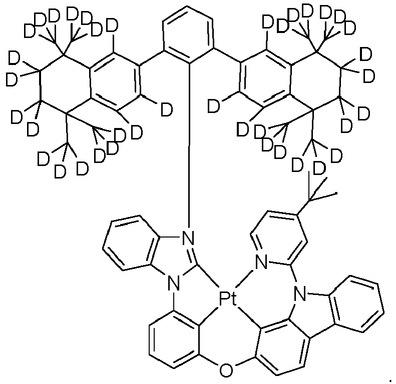
13. The OLED of any one of the previous aspects, wherein the second compound is selected from the group consisting of: 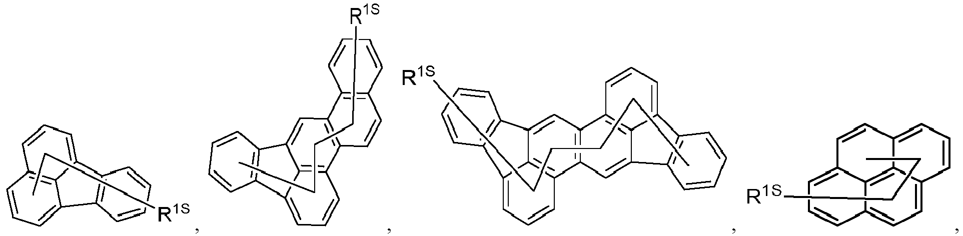 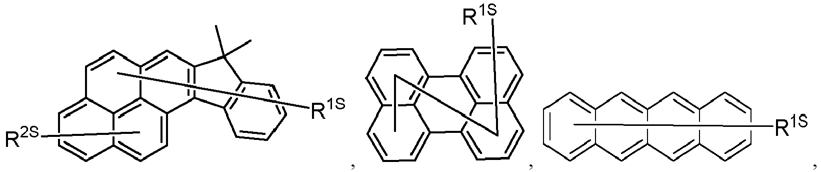 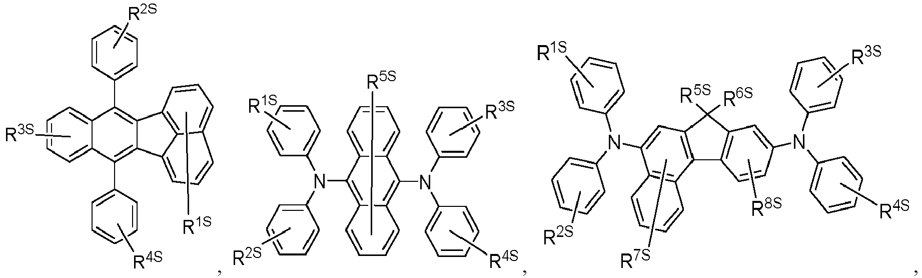 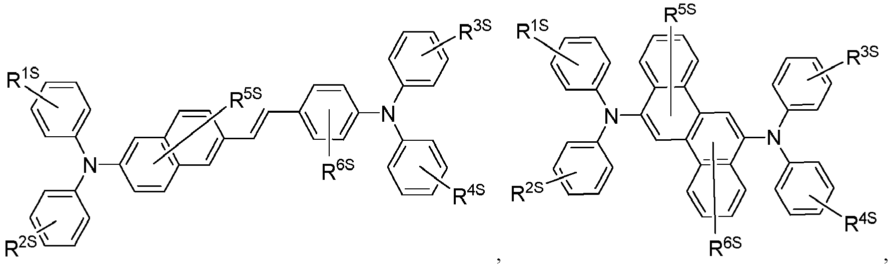 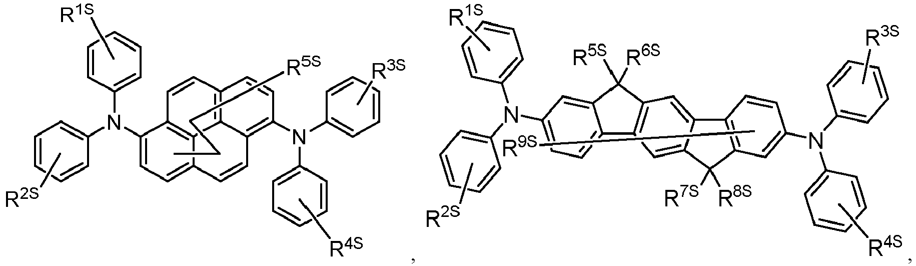 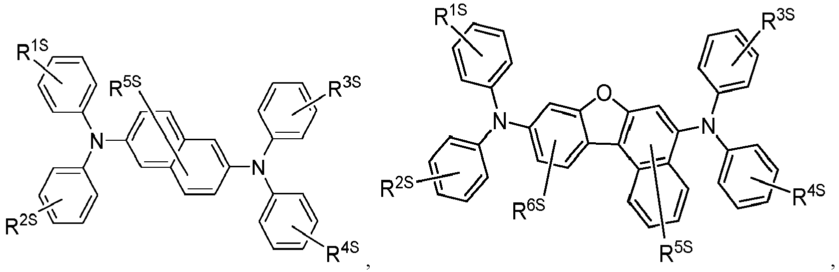 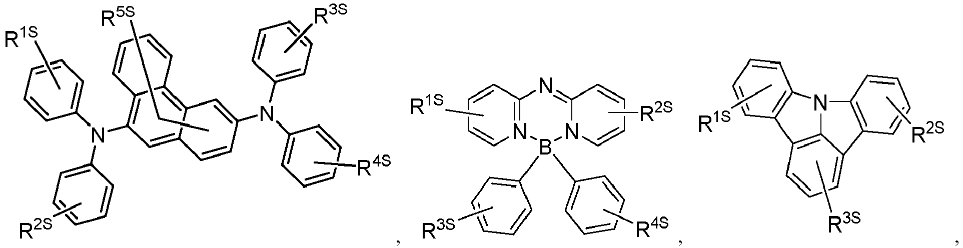 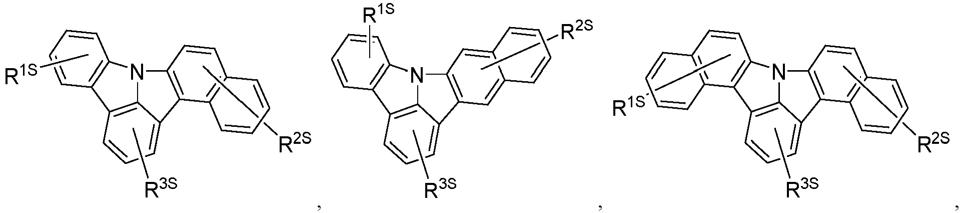 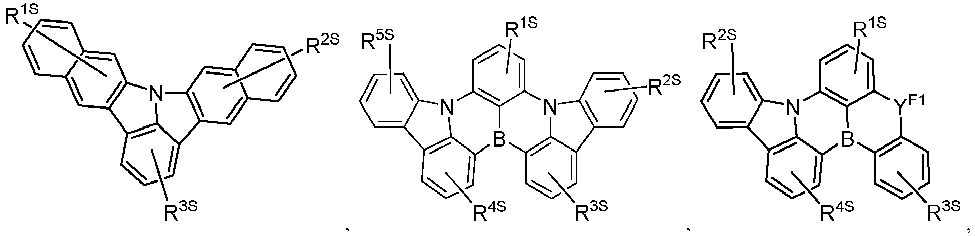 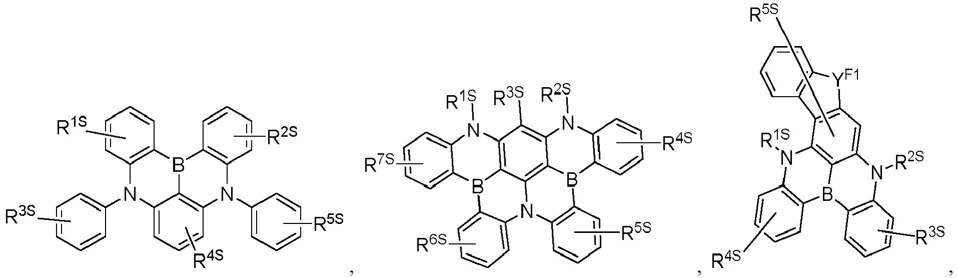 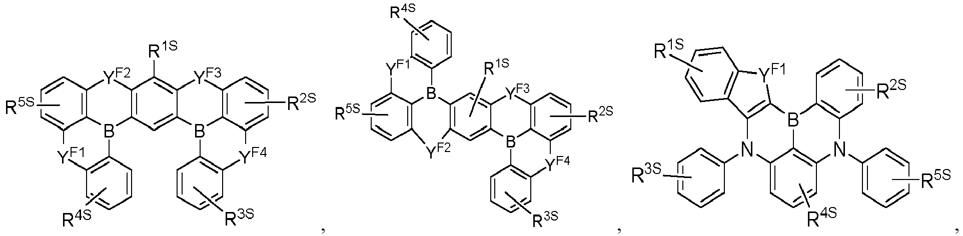 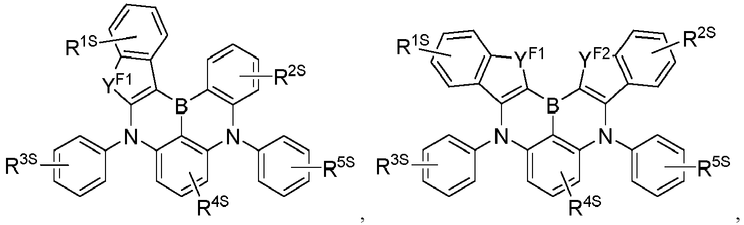 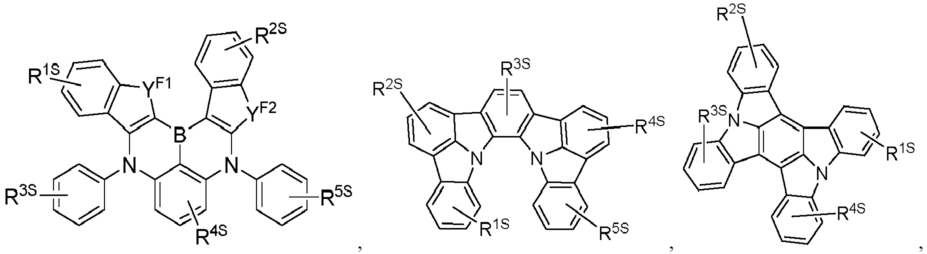 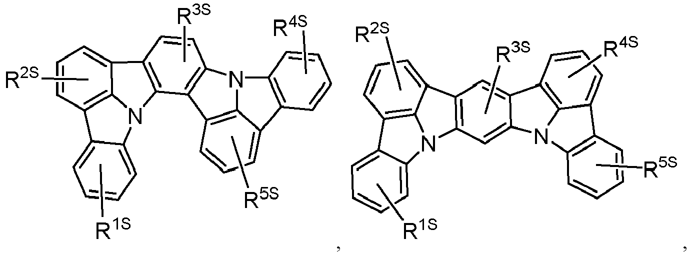 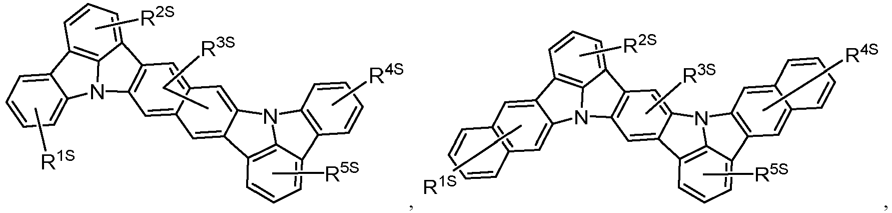 and 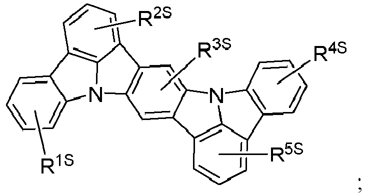
   wherein Y^{F1} to Y^{F4} are each independently selected from O, S, and NR^{F1}
   wherein R^{F1} and R¹ to R⁹ each independently represents from mono to maximum possible number of substitutions, or no substitution; and wherein R^{F1} and R¹ to R⁹ are each independently a hydrogen or a substituent selected from the group consisting of deuterium, halogen, alkyl, cycloalkyl, heteroalkyl, heterocycloalkyl, boryl, arylalkyl, alkoxy, aryloxy, amino, silyl, germyl, alkenyl, cycloalkenyl, heteroalkenyl, alkynyl, aryl, heteroaryl, acyl, carboxylic acid, ether, ester, nitrile, isonitrile, sulfanyl, sulfinyl, sulfonyl, phosphino, selenyl, and combinations thereof.
14. The OLED of any one of the previous aspects, wherein the second compound is selected from the group consisting of: 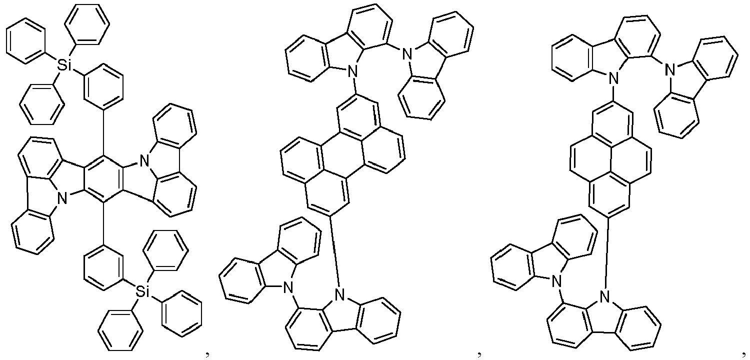 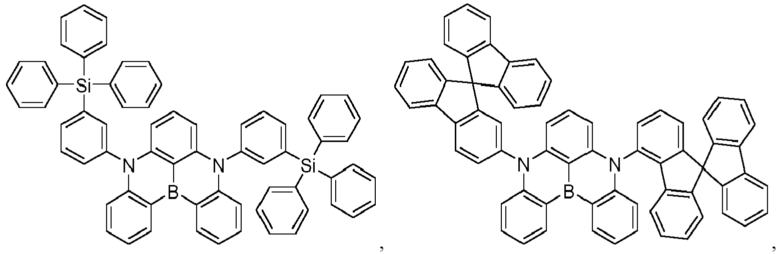 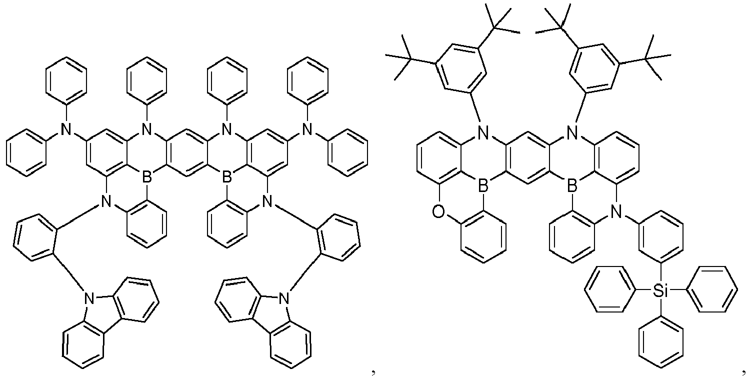 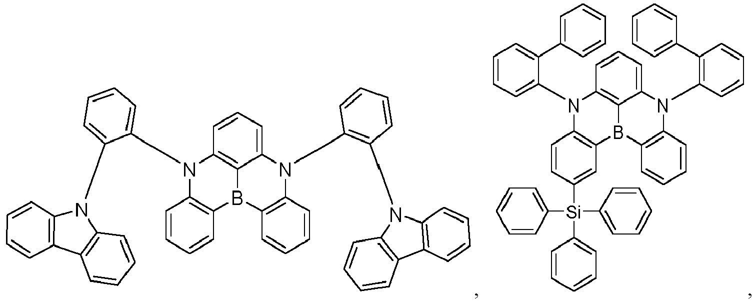 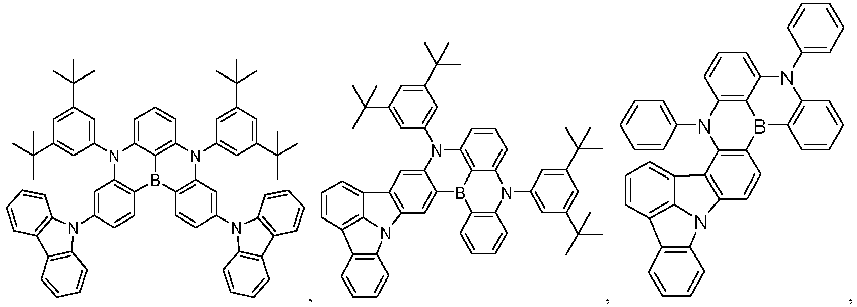 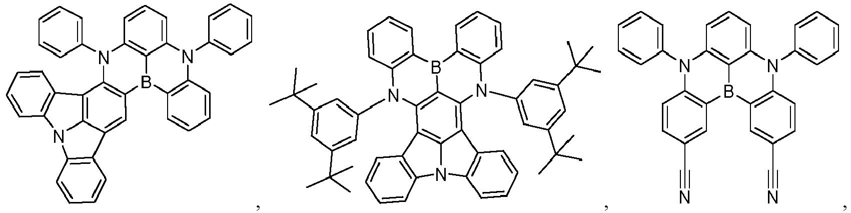 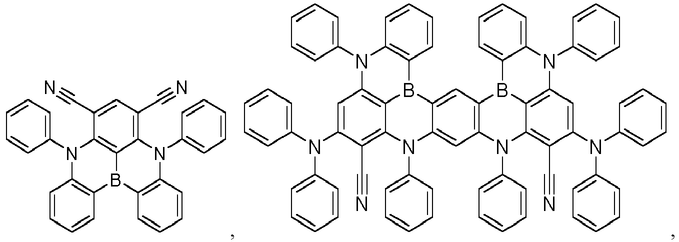 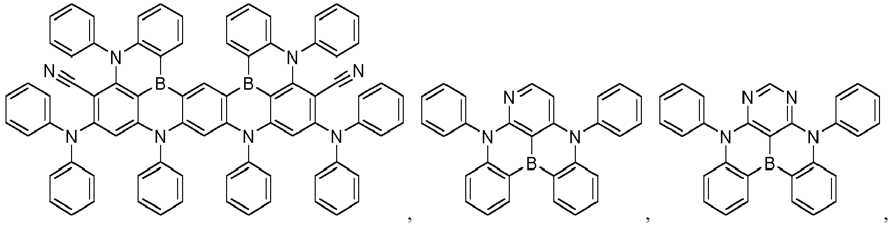 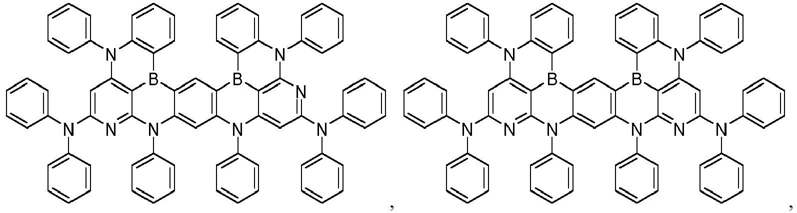 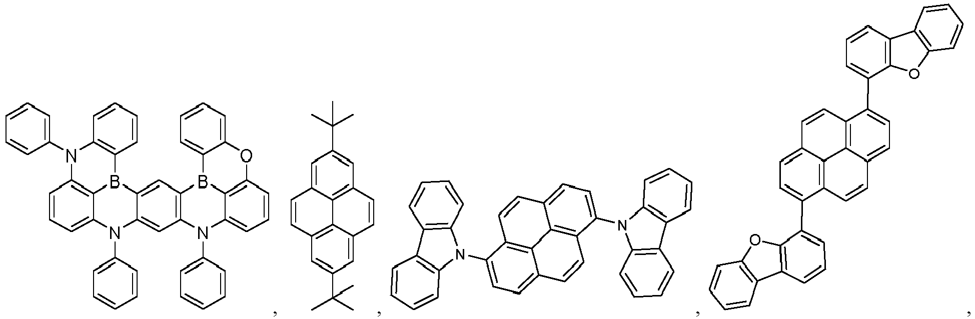 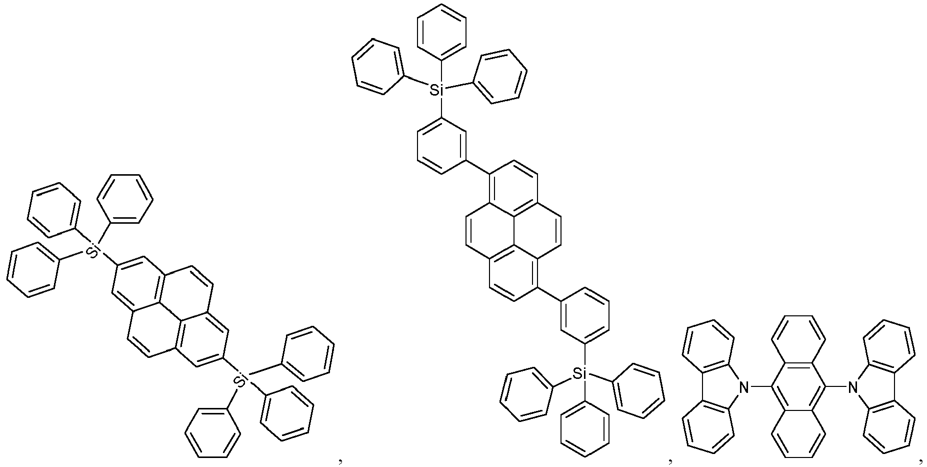 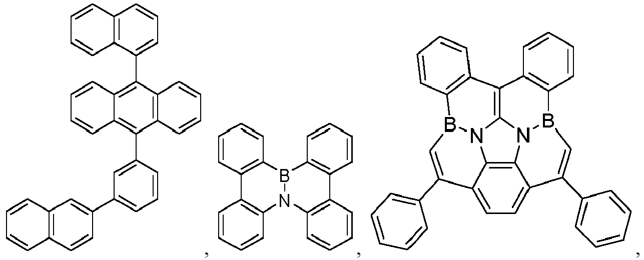 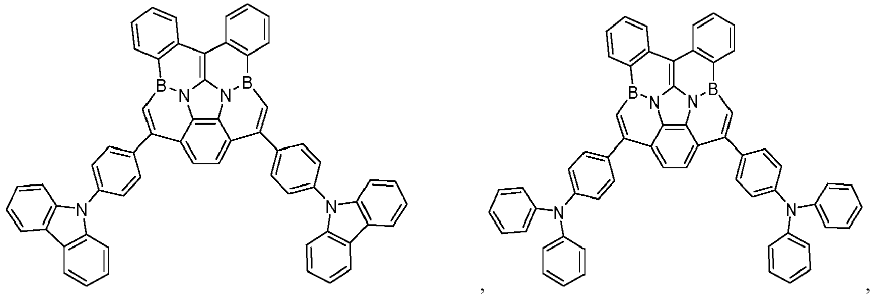 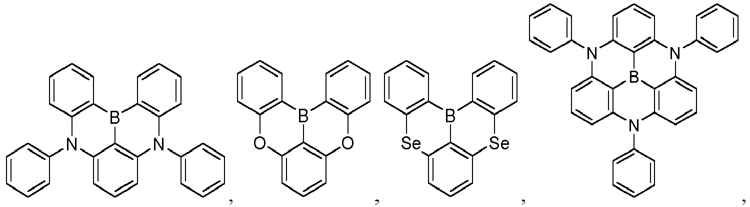 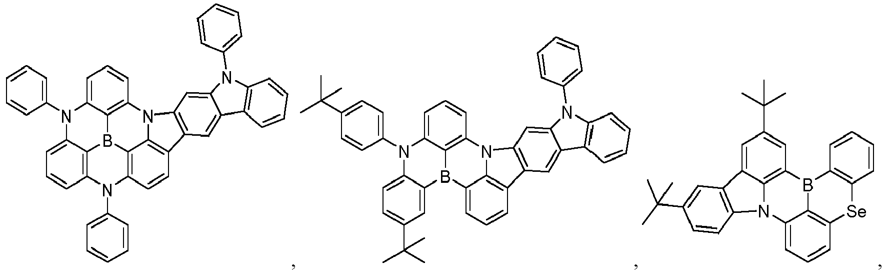 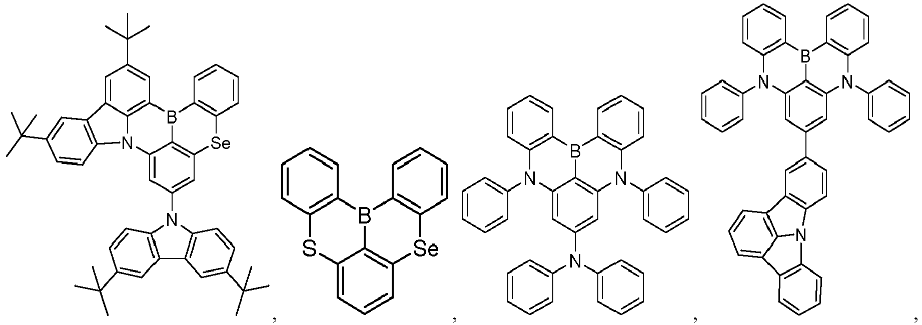 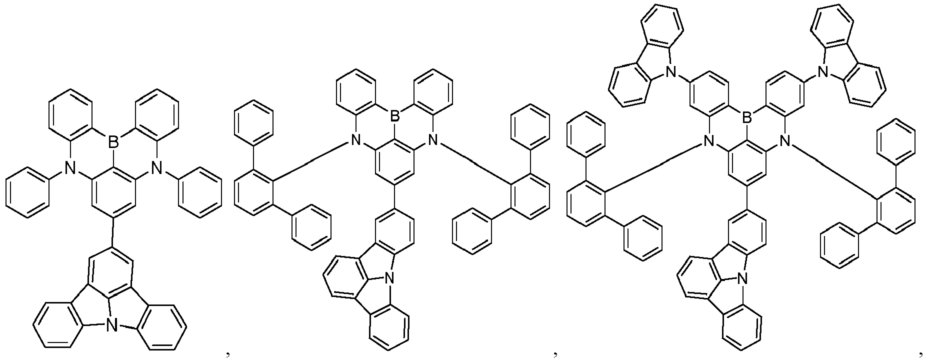 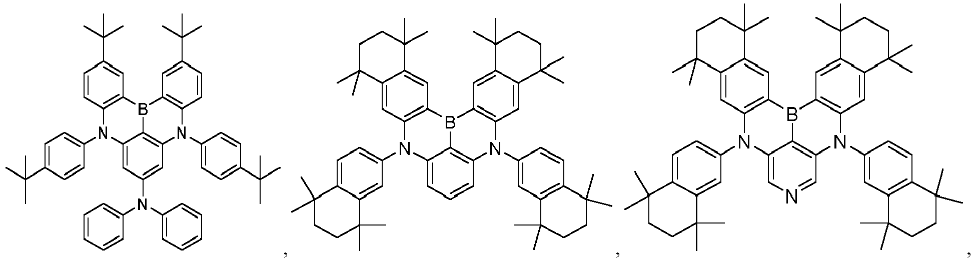 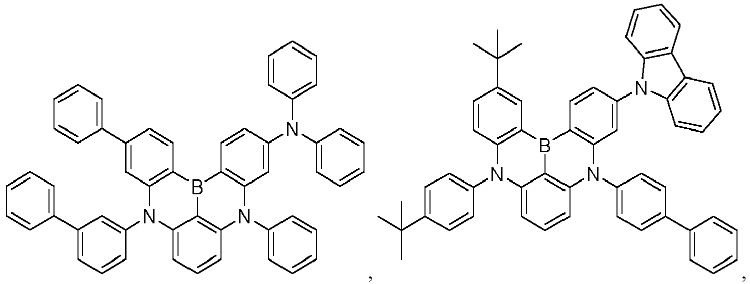 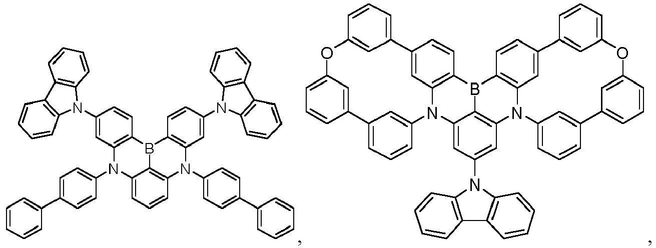 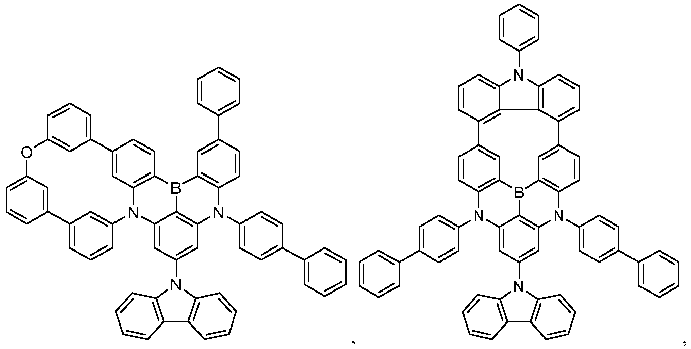 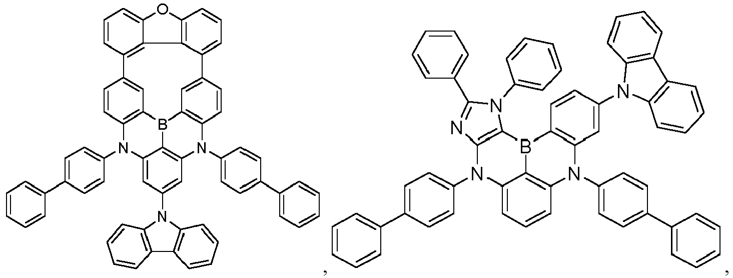 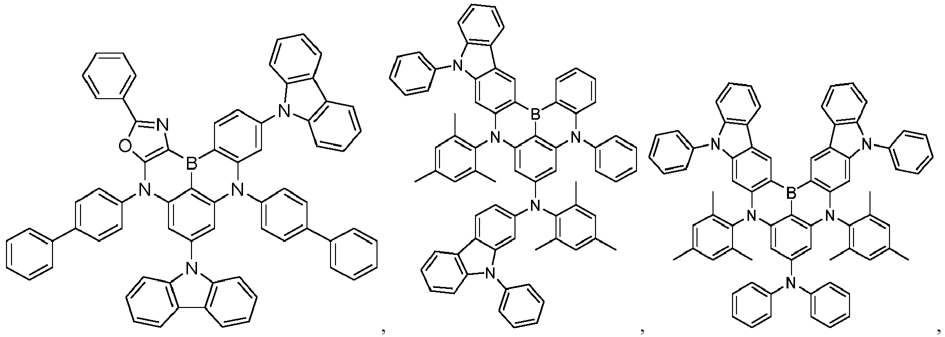 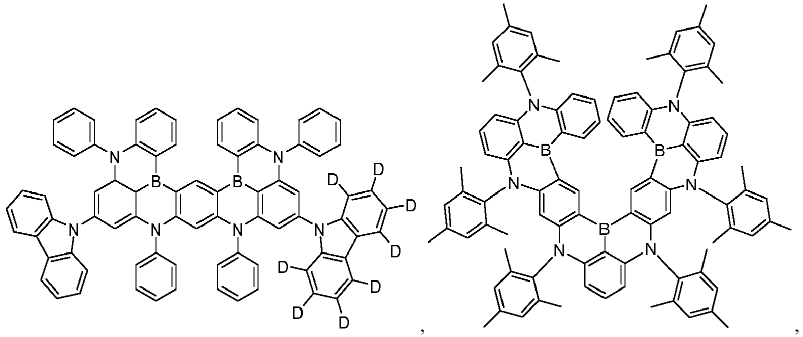 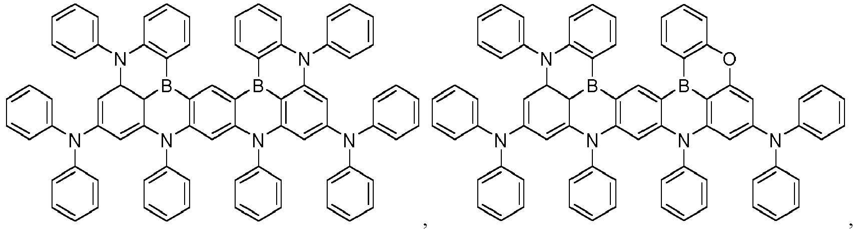 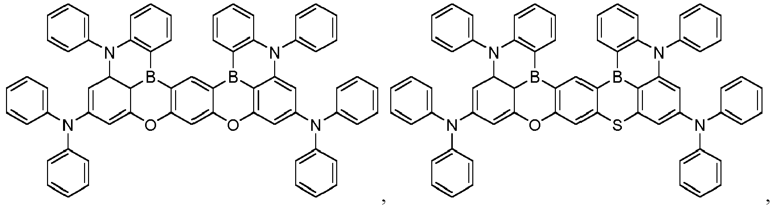 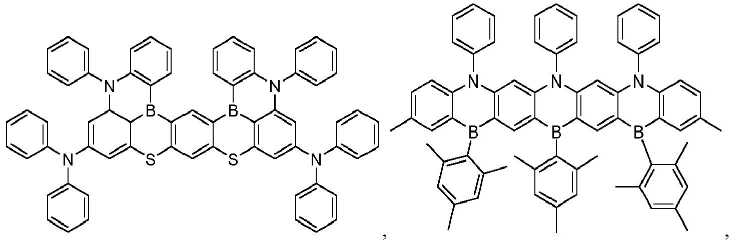 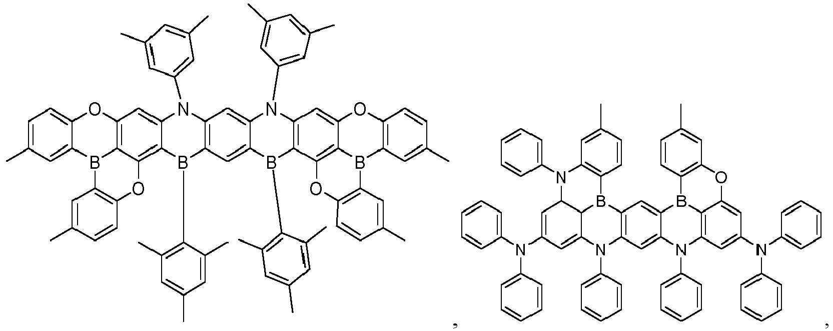 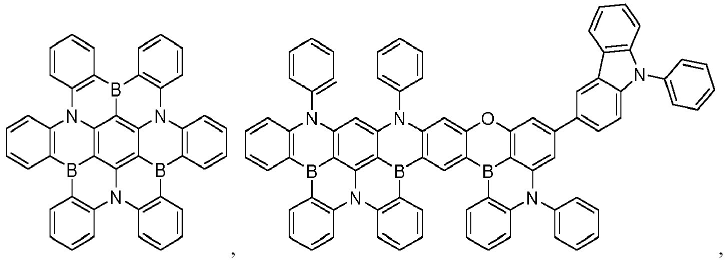 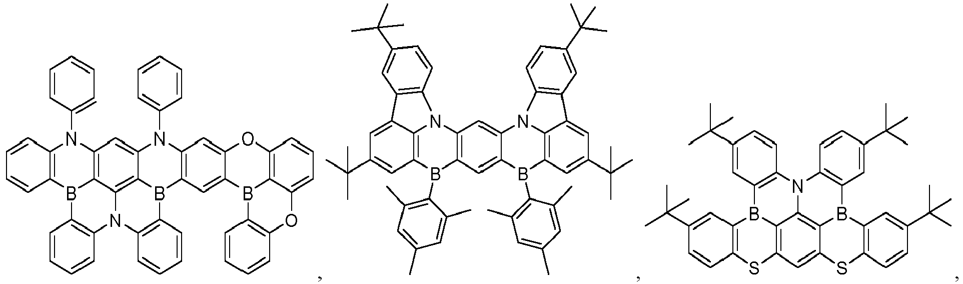 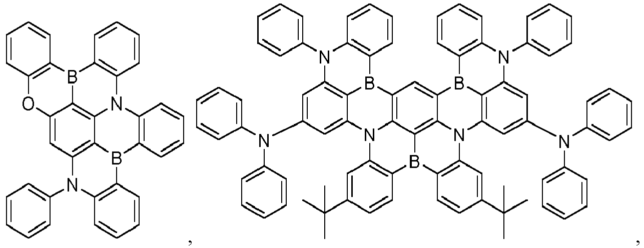 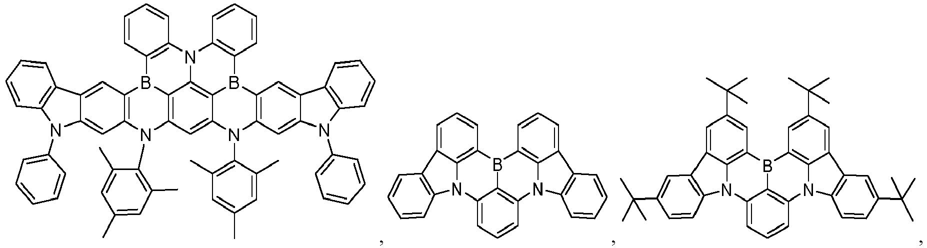 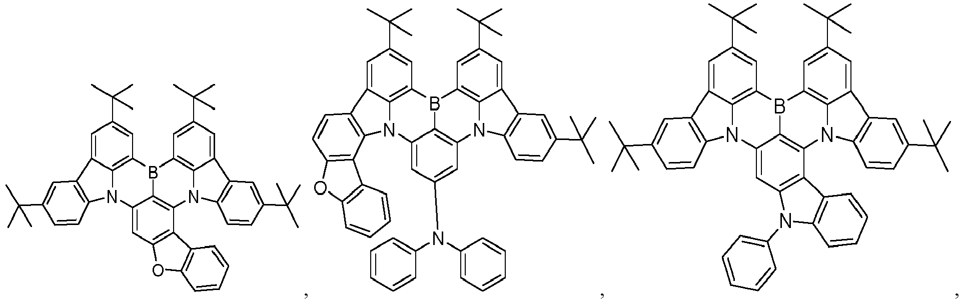 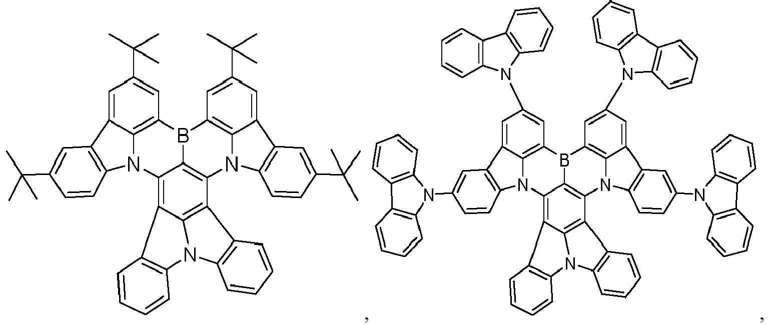 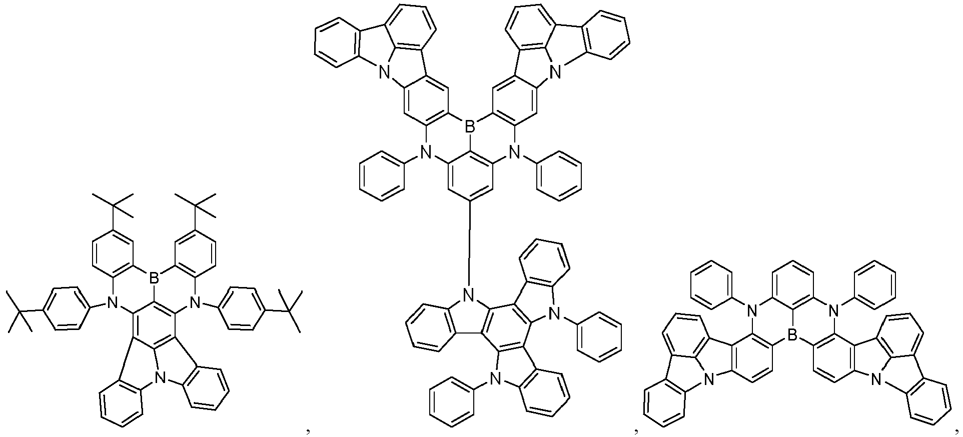 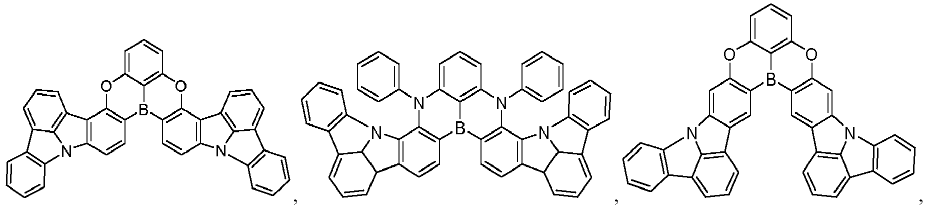 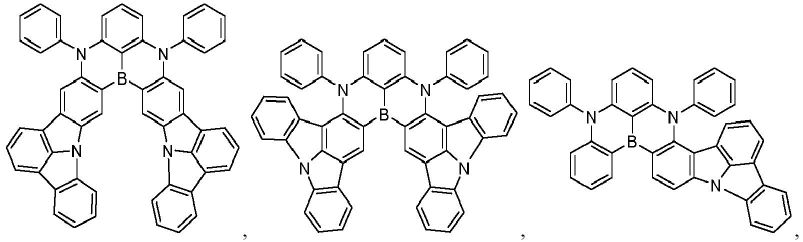 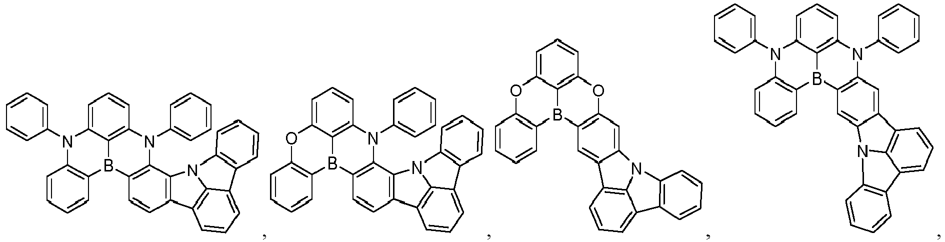 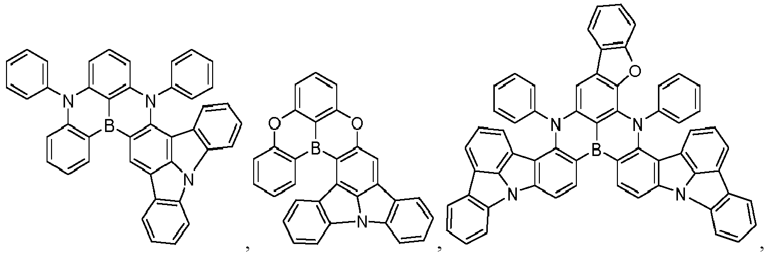 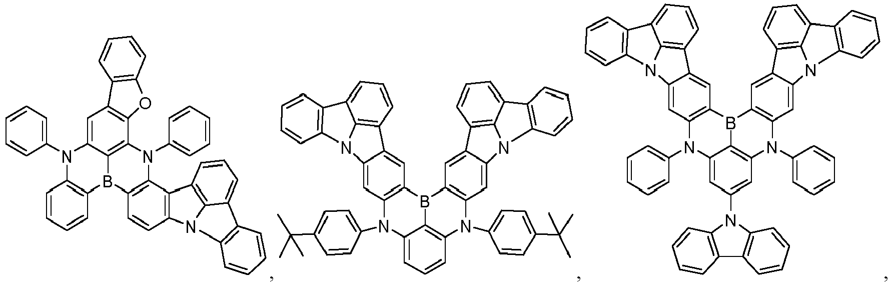 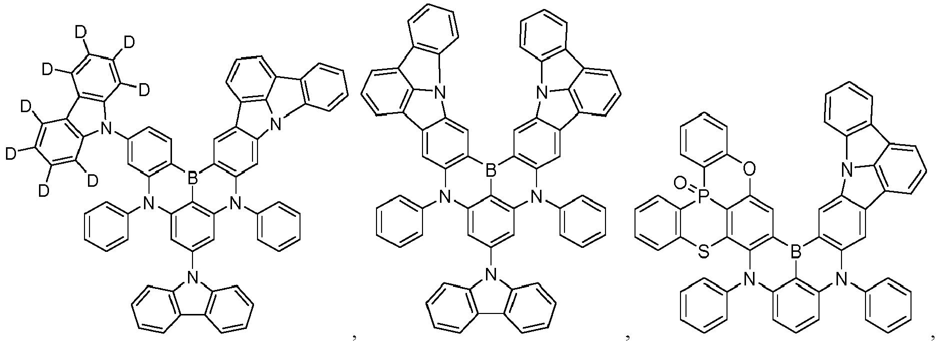 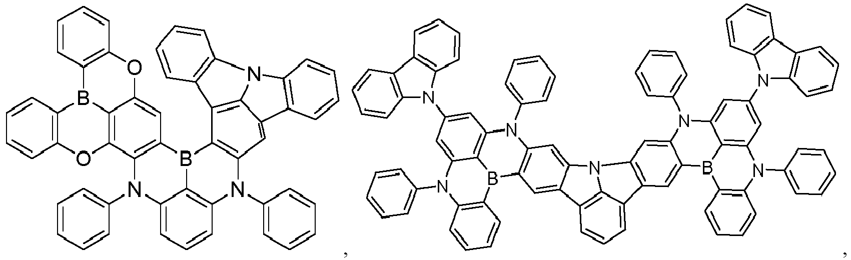 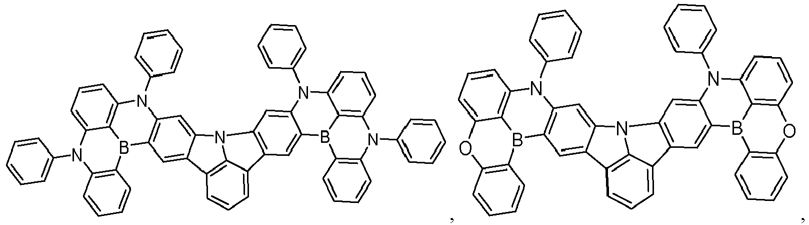 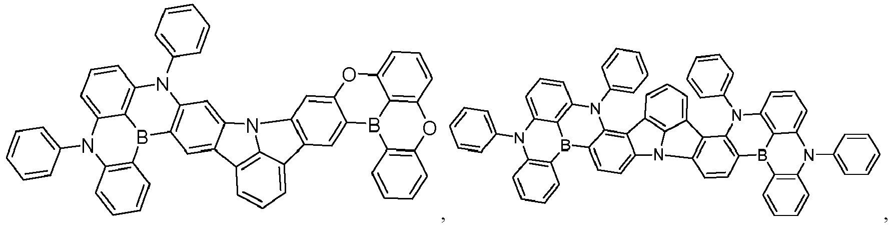 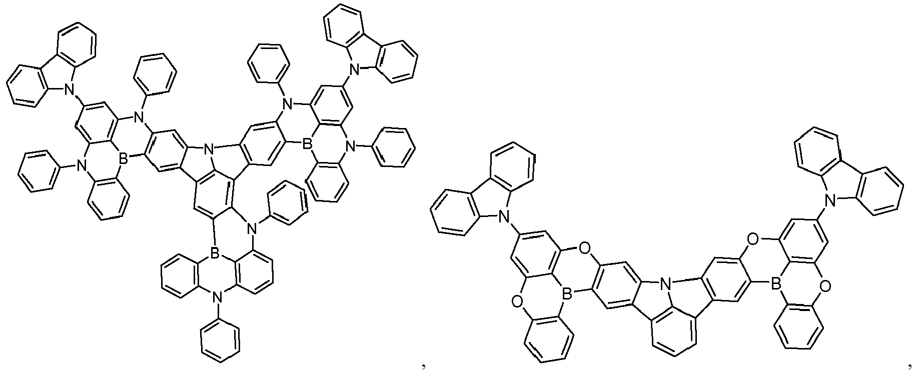 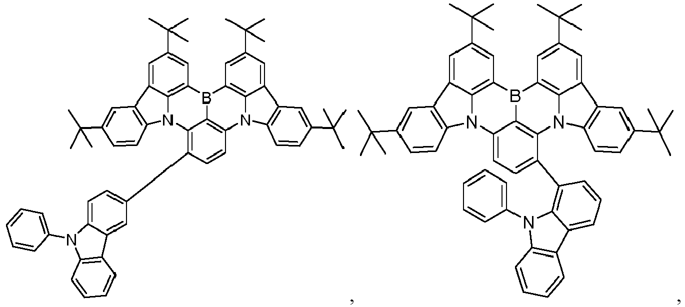 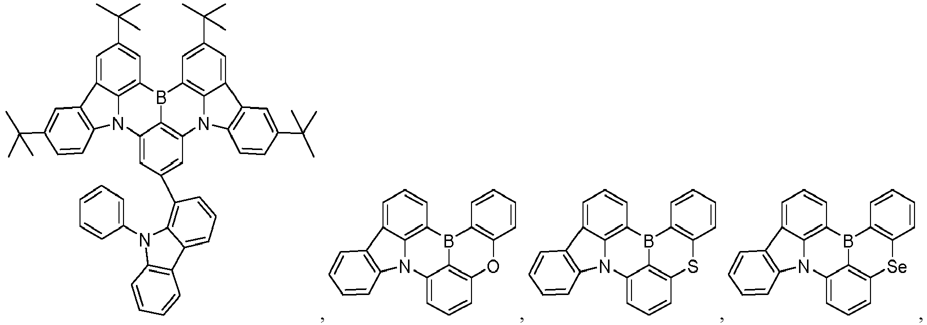 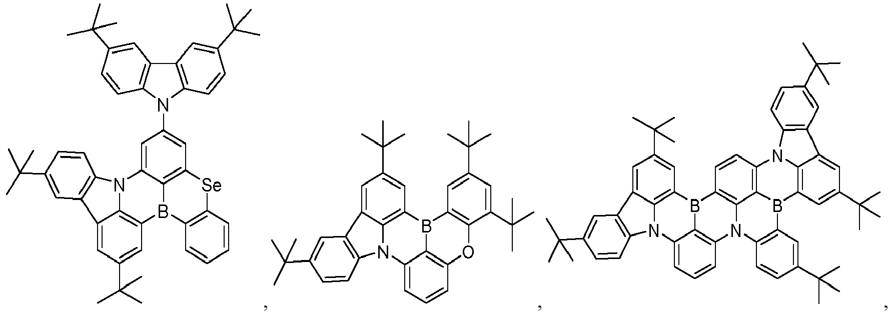 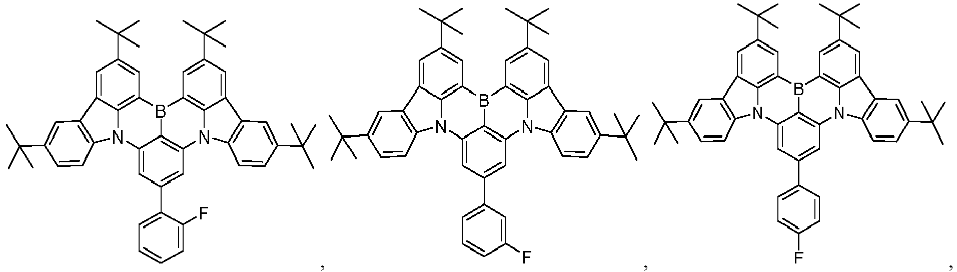 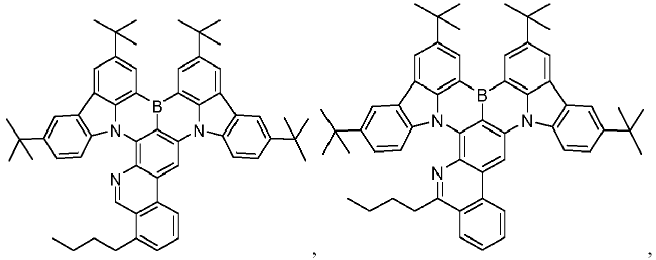 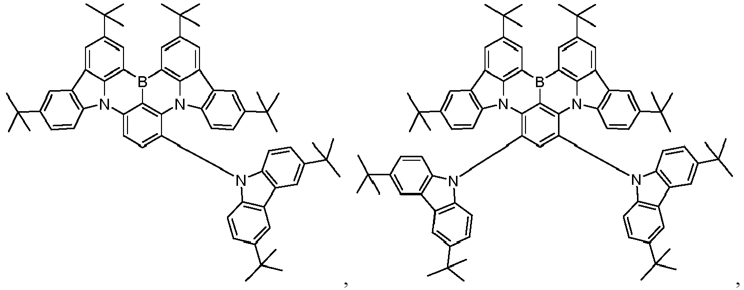 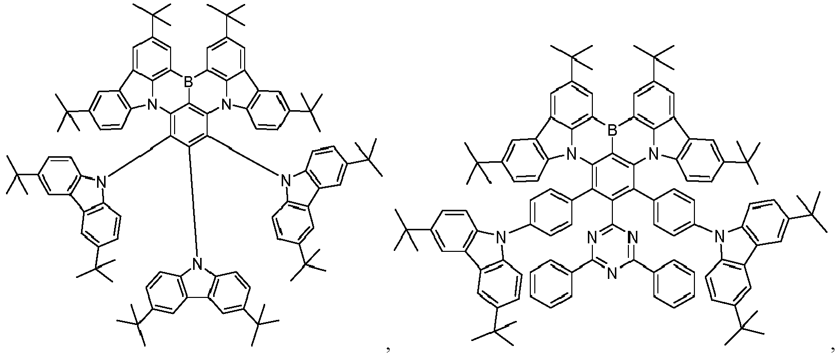 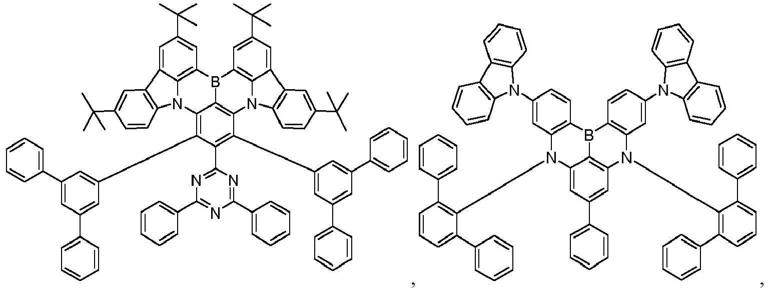 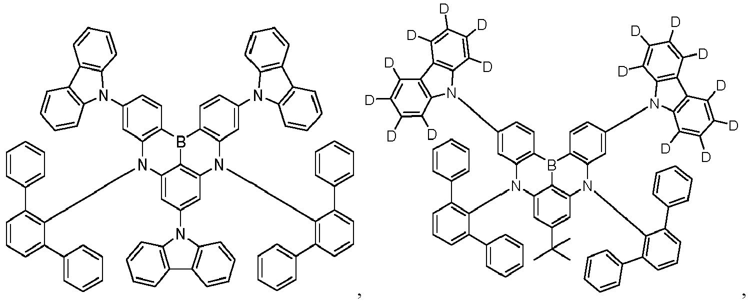 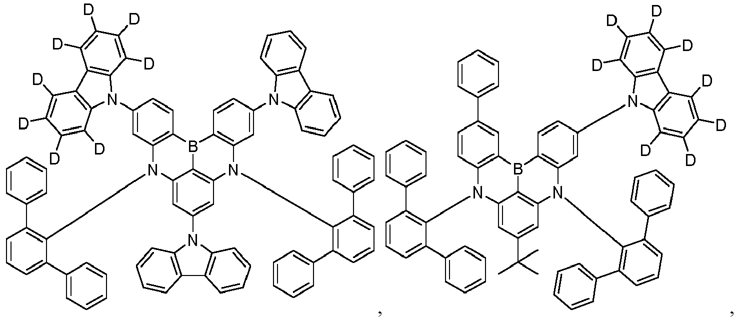 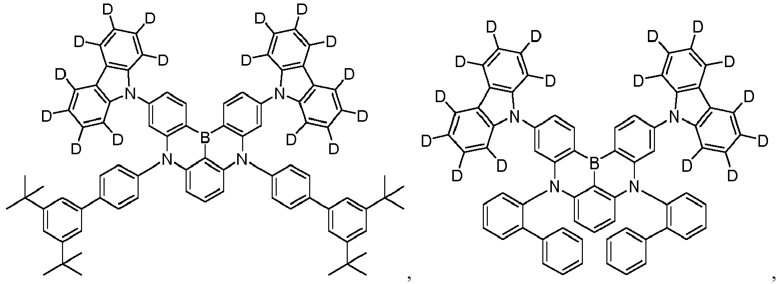 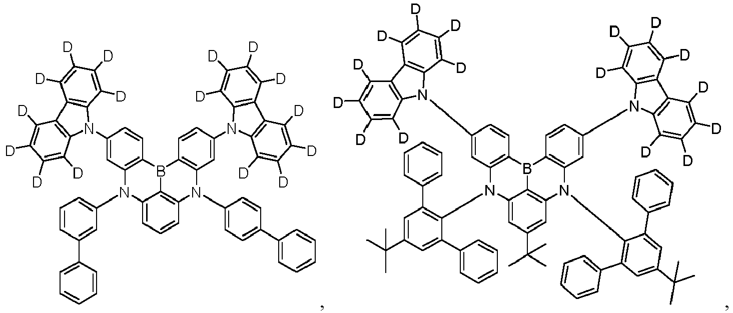 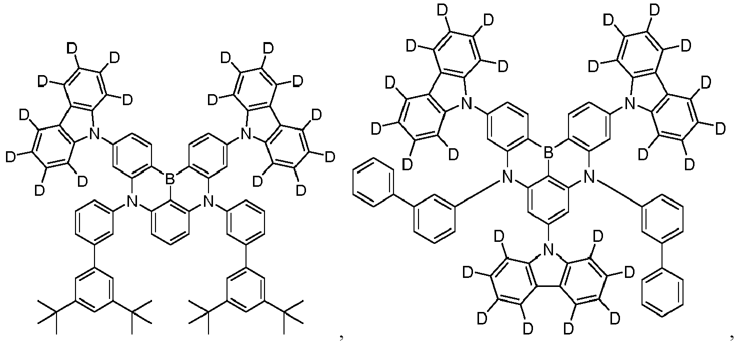 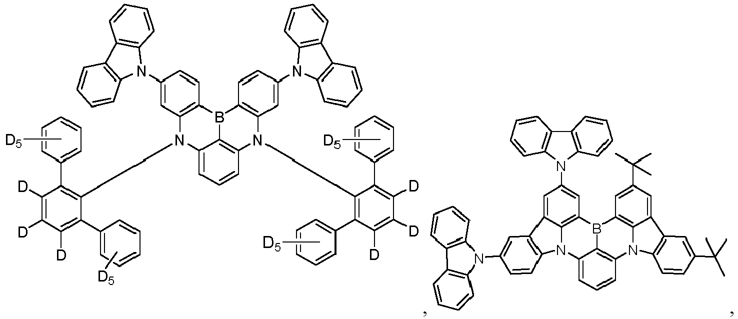 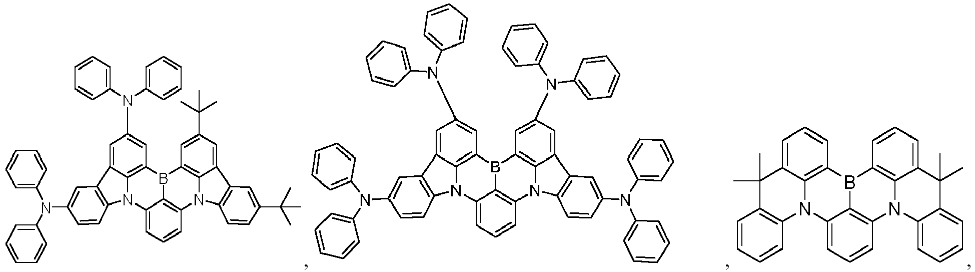 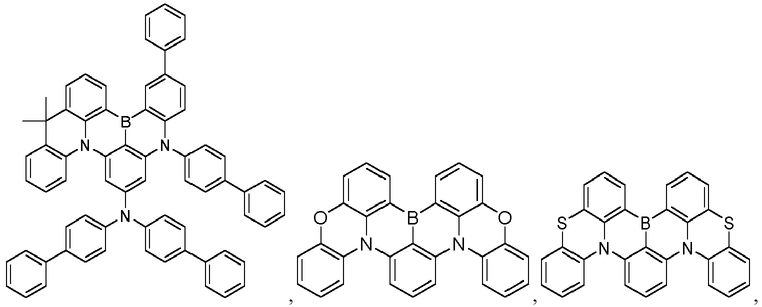 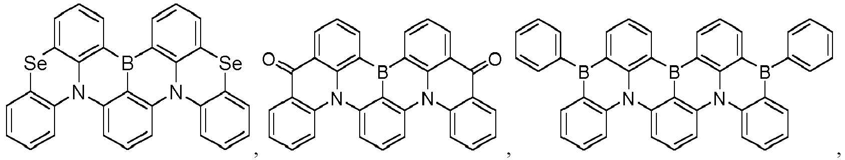 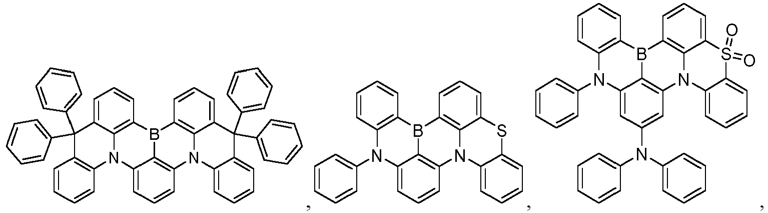 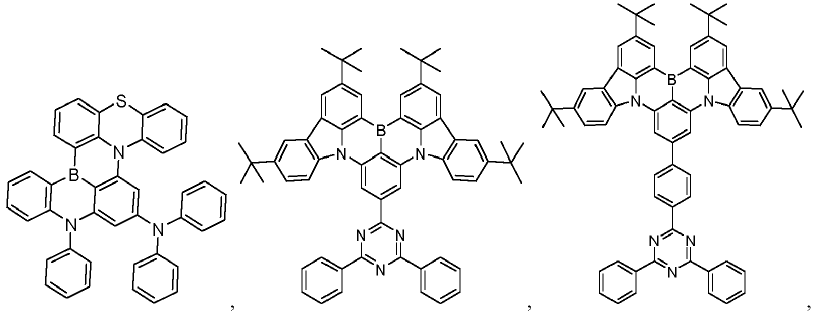 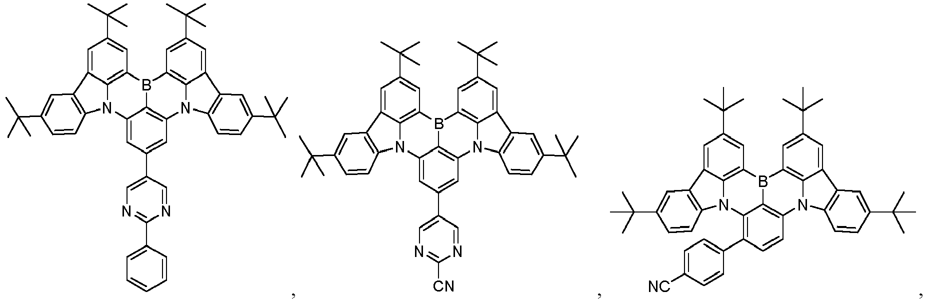 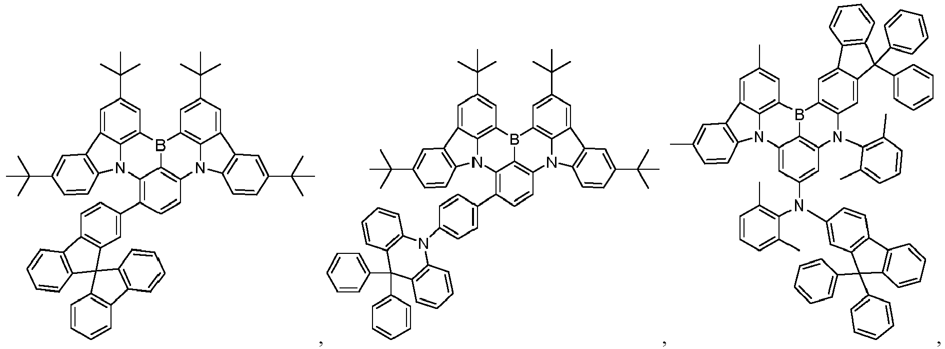 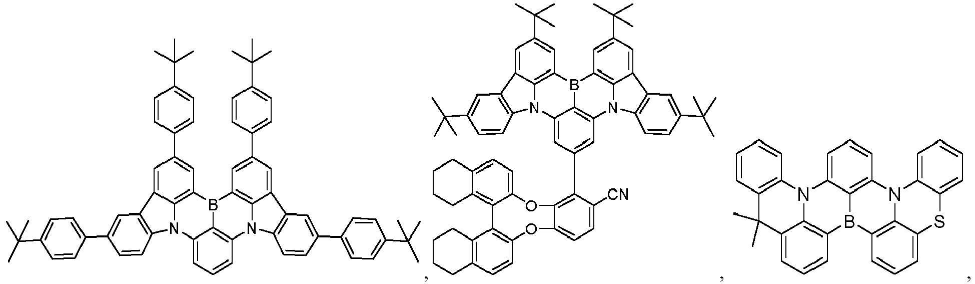 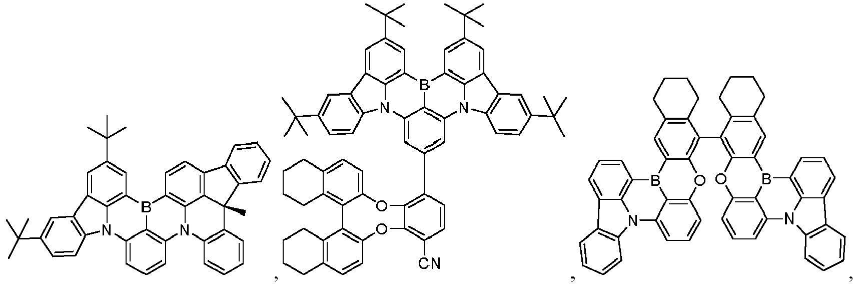 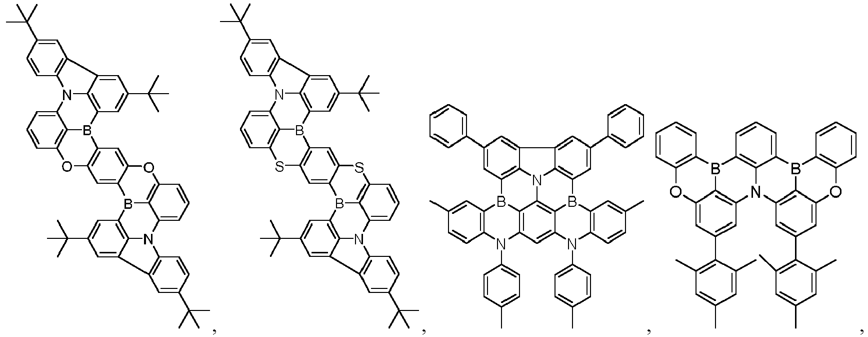 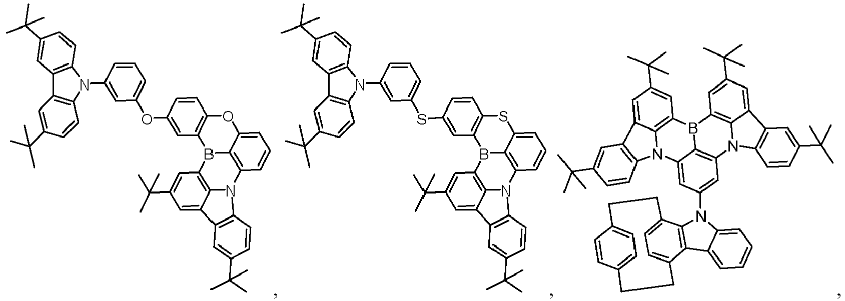 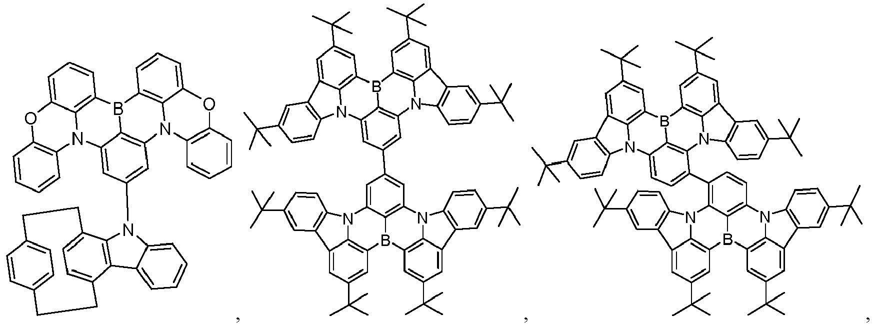 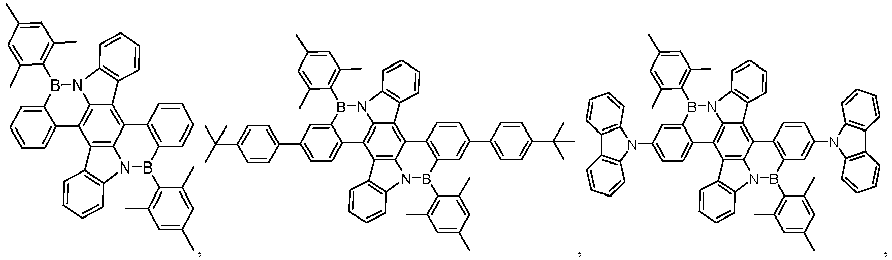 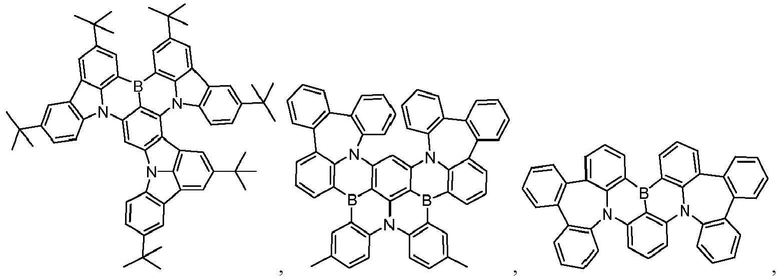 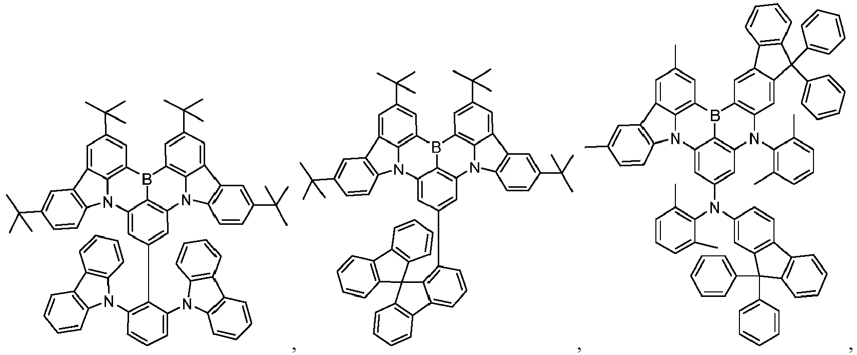 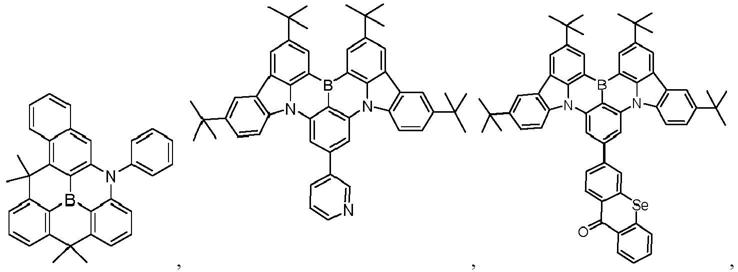 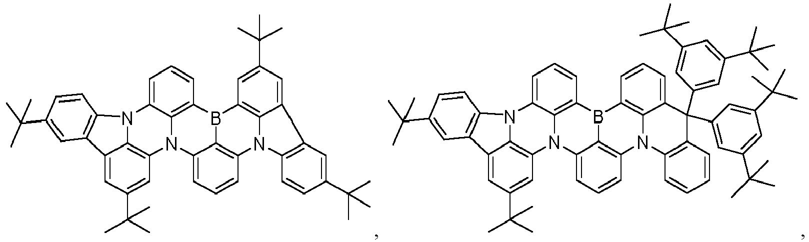 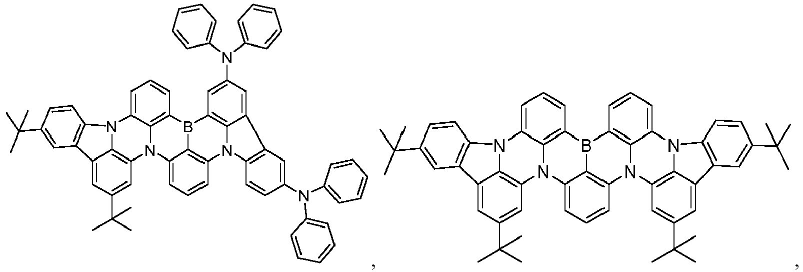 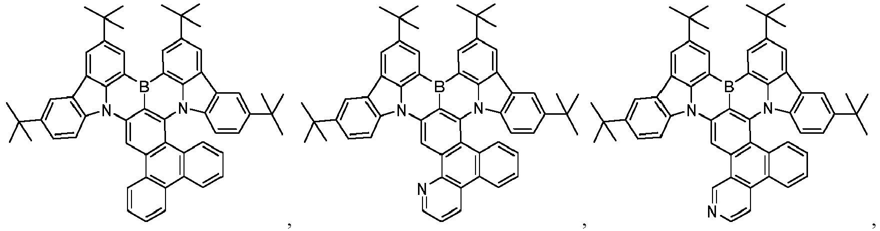 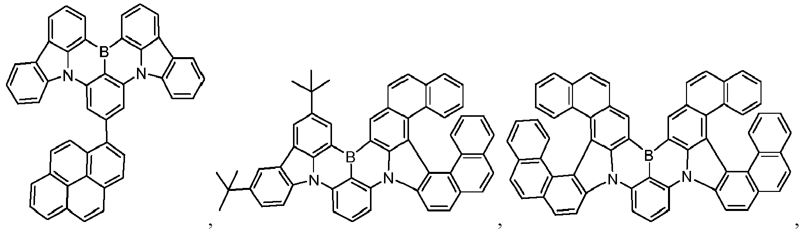 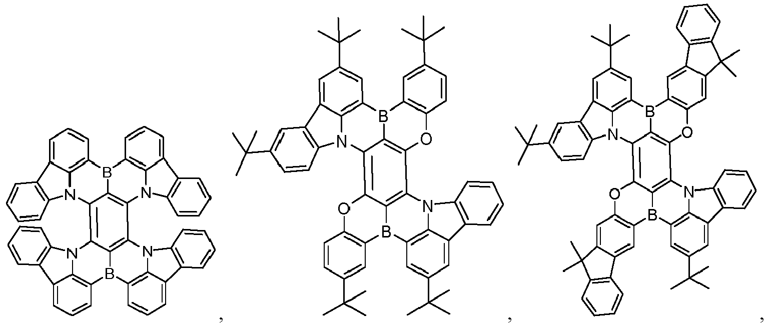 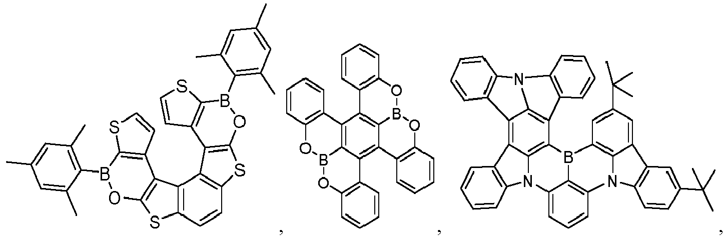 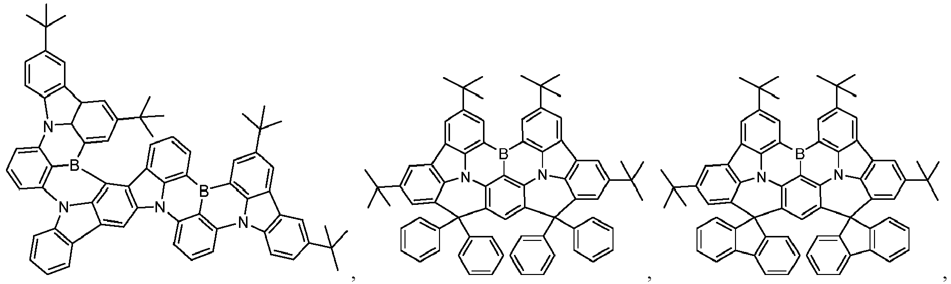 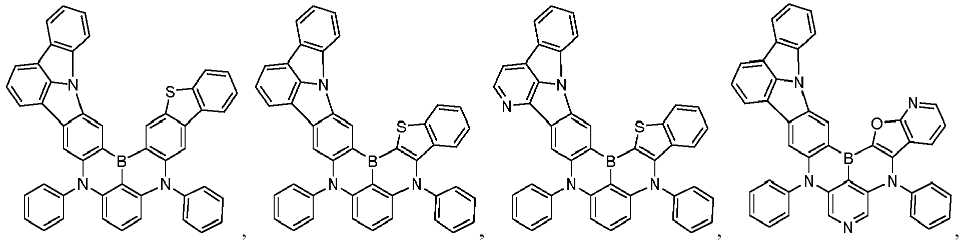 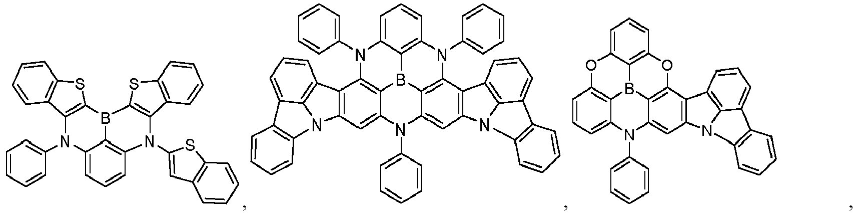 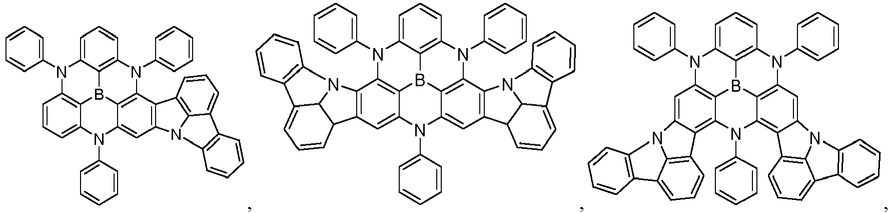 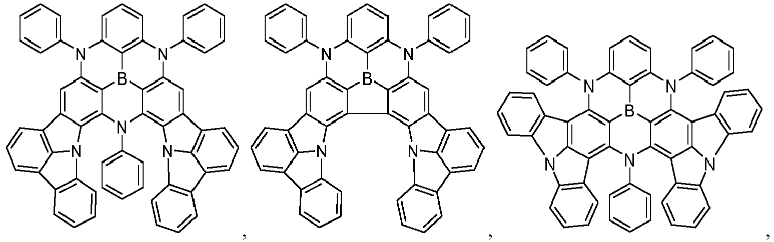 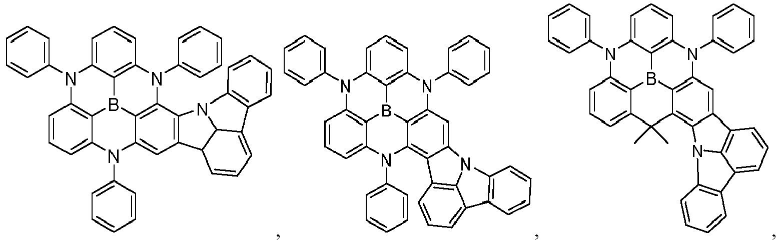 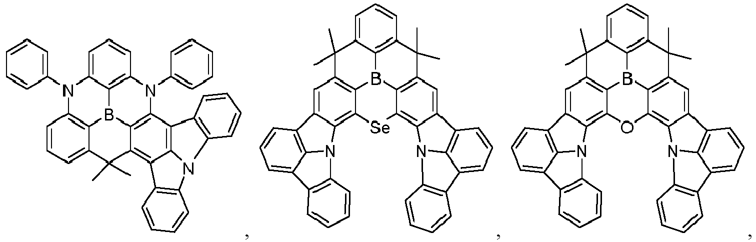 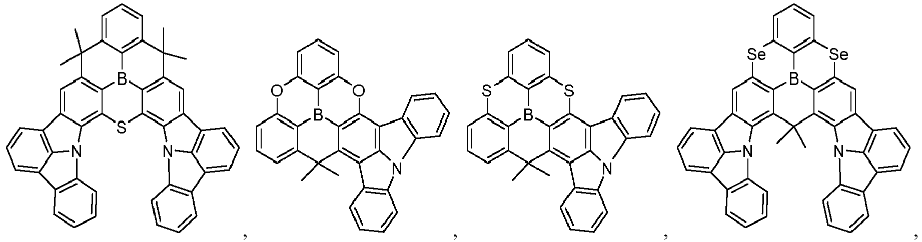 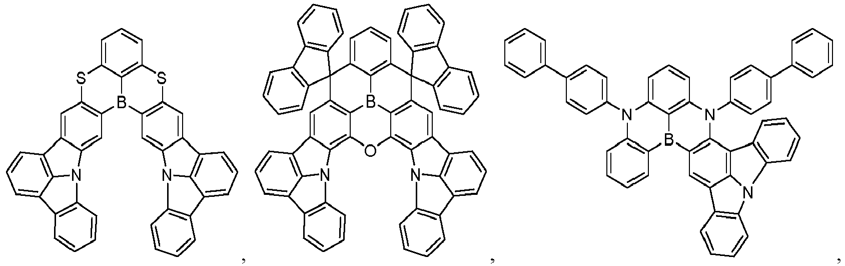 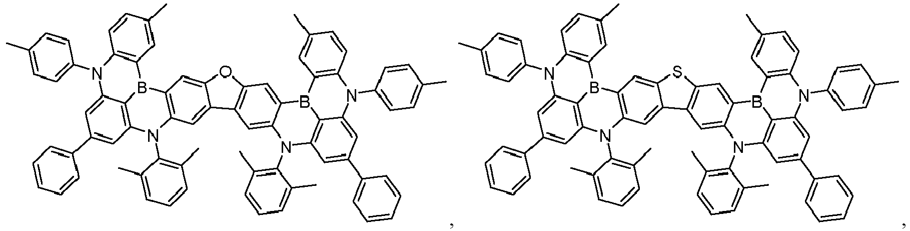 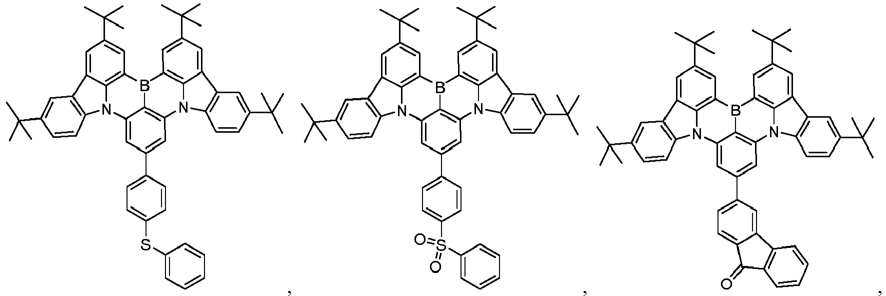 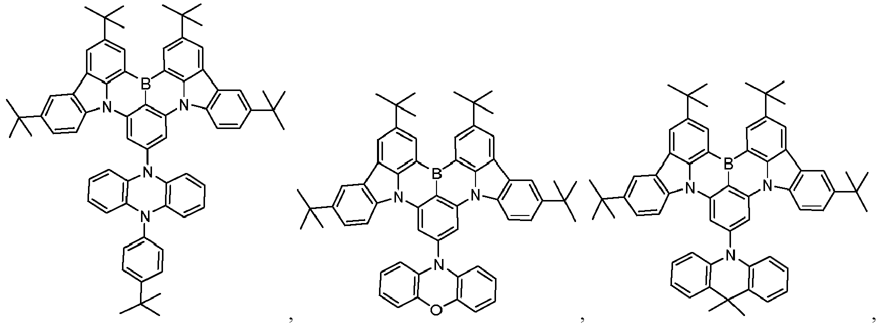 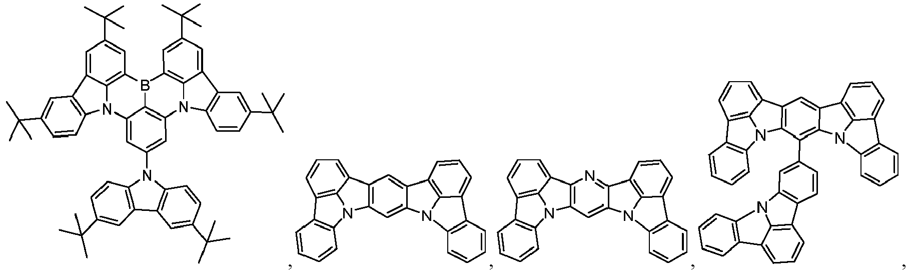 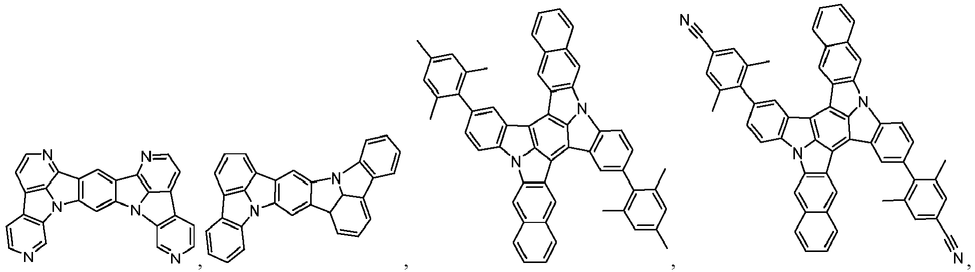 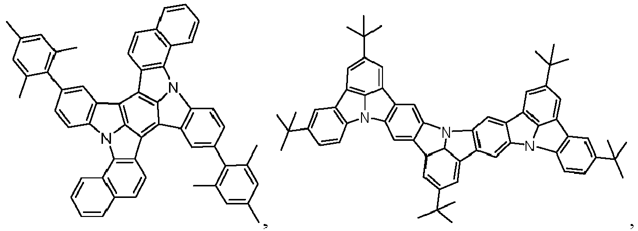 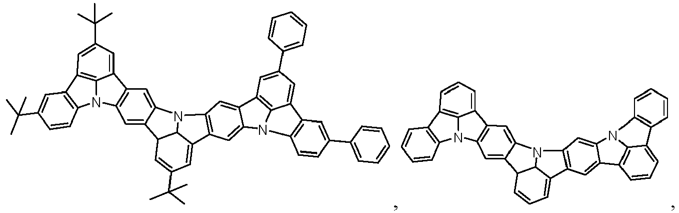 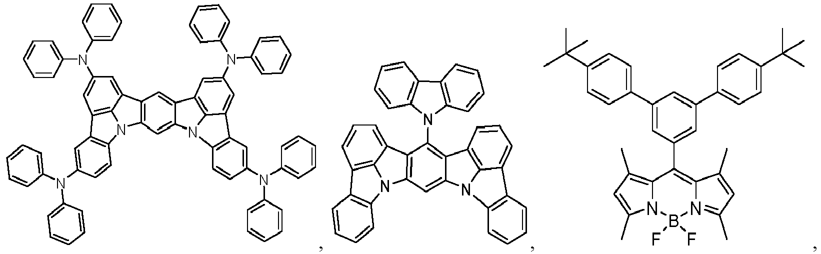 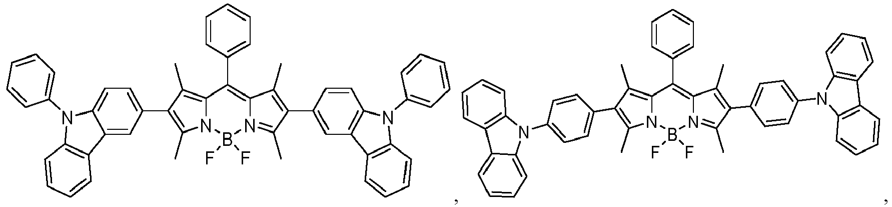 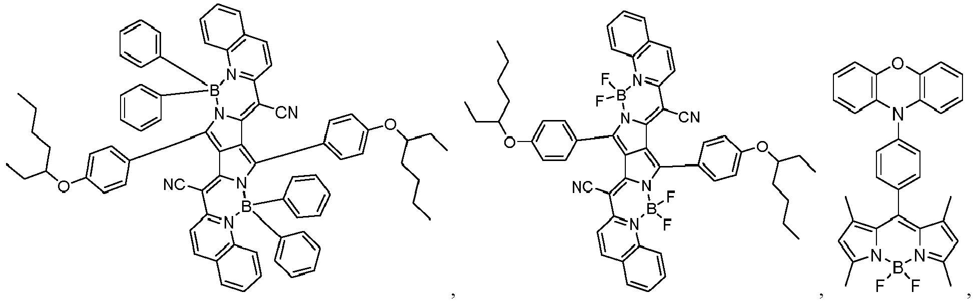 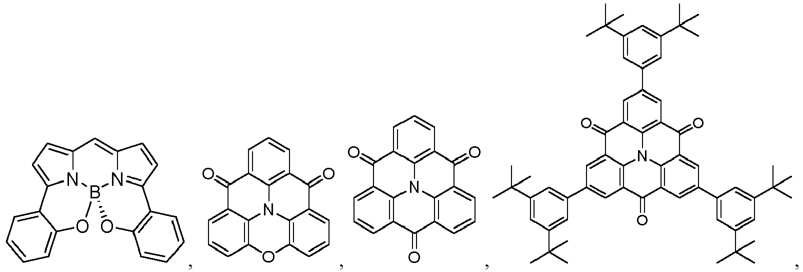 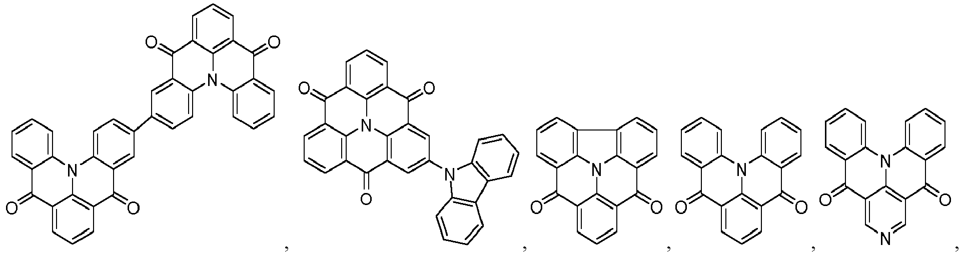 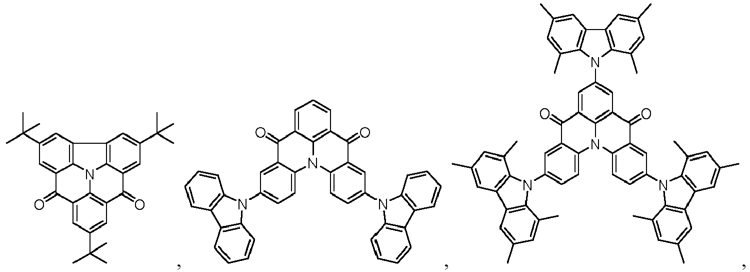 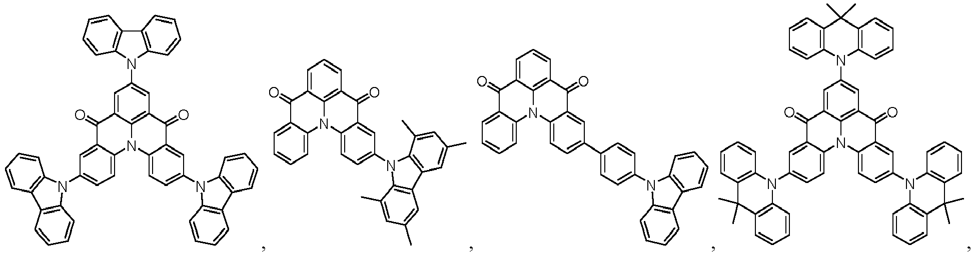 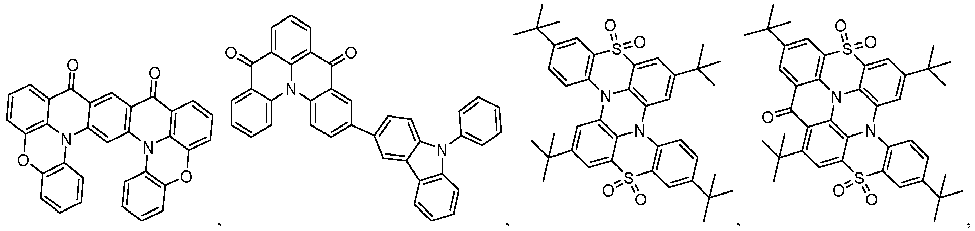 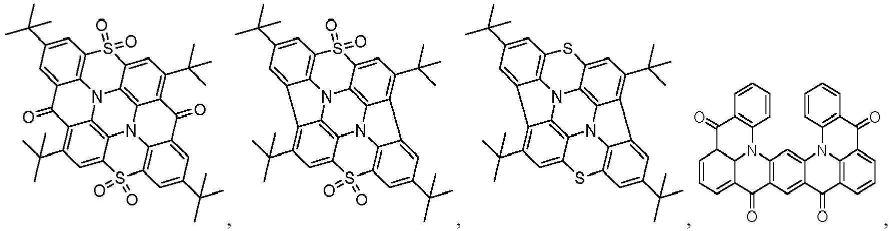 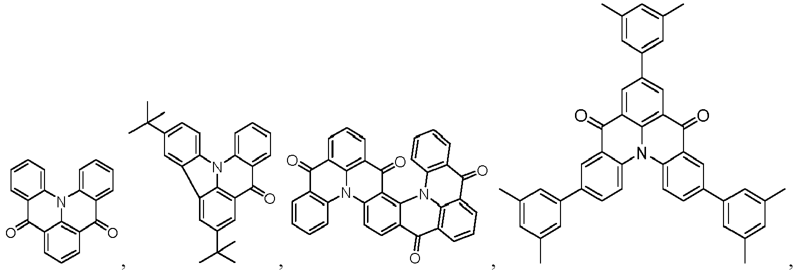 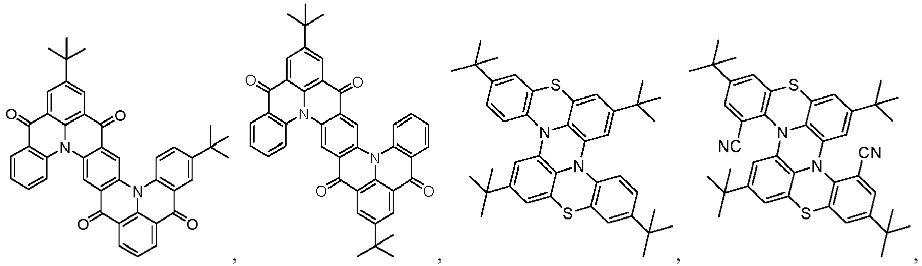 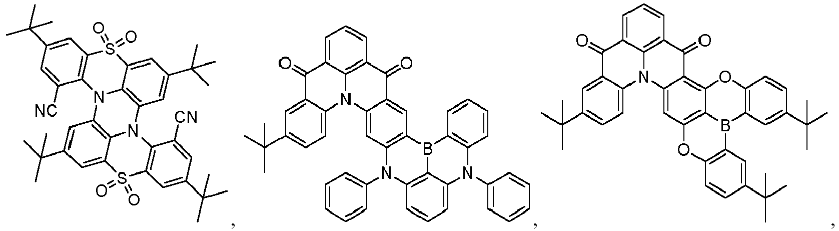 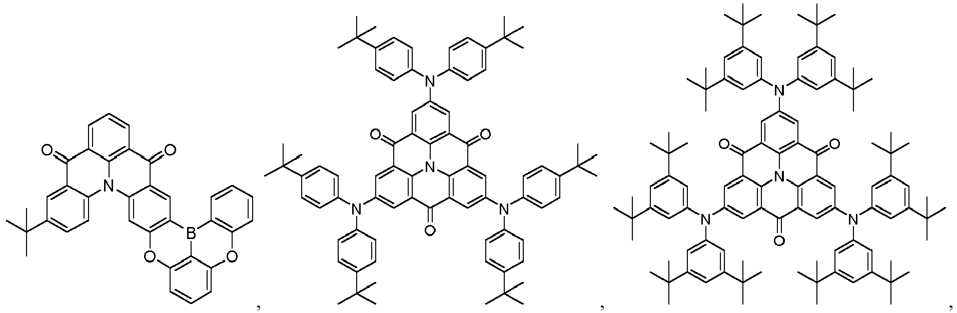 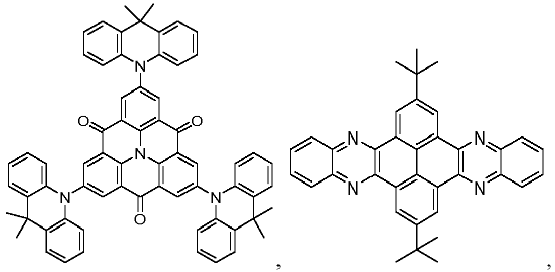 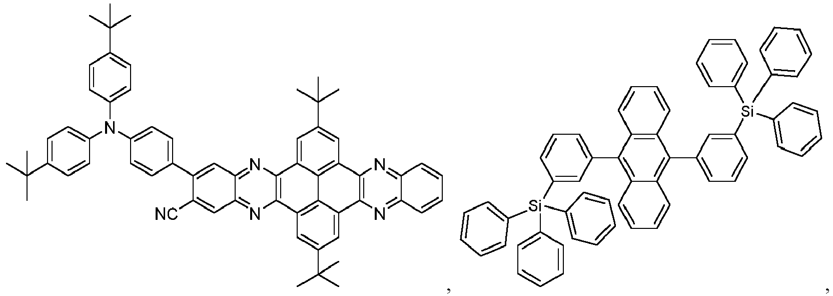 aza-substituted variants thereof, fully or partially deuterated variants thereof, and combinations thereof.
15. The OLED of any one of the previous aspects, wherein the HOMO level of the second compound is deeper than at least one selected from the first compound and the third compound; and/or wherein the emissive region further comprises a second host.
16. The OLED of any one of the previous aspects, wherein the third compound, and/or the second host comprises at least one chemical group selected from the group consisting of triphenylene, carbazole, indolocarbazole, dibenzothiophene, dibenzofuran, dibenzoselenophene, 5λ²-benzo[d]benzo[4,5]imidazo[3,2-a]imidazole, 5,9-dioxa-13b-boranaphtho[3,2,1-de]anthracene, triazine, boryl, silyl, aza-triphenylene, aza-carbazole, aza-indolocarbazole, aza-dibenzothiophene, aza-dibenzofuran, aza-dibenzoselenophene, aza-5λ²-benzo[d]benzo[4,5]imidazo[3,2-a]imidazole, and aza-(5,9-dioxa-13b-boranaphtho[3,2, 1-de]anthracene).
17. The OLED of any one of the previous aspects, wherein the third compound, and/or the second host is selected from the group consisting of 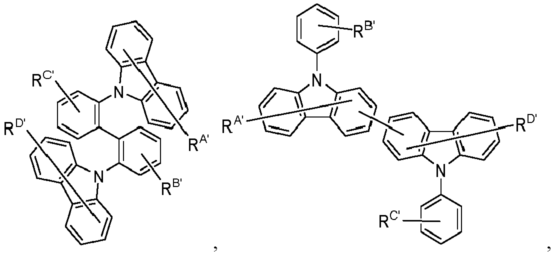 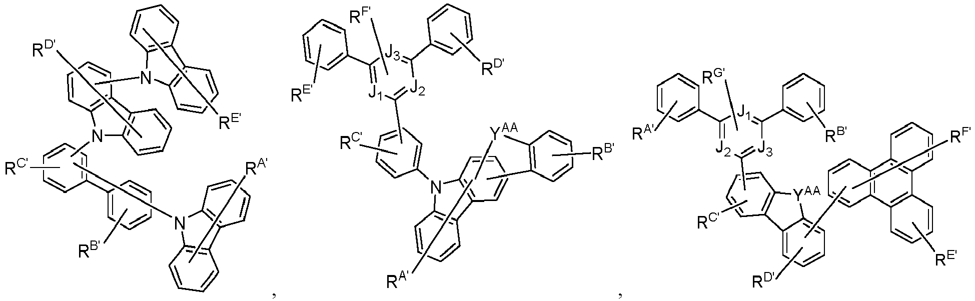 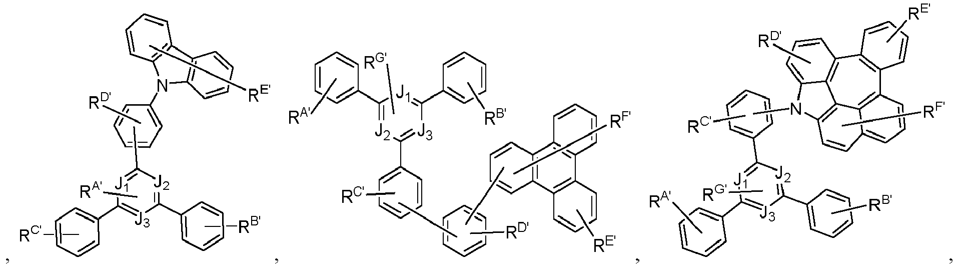 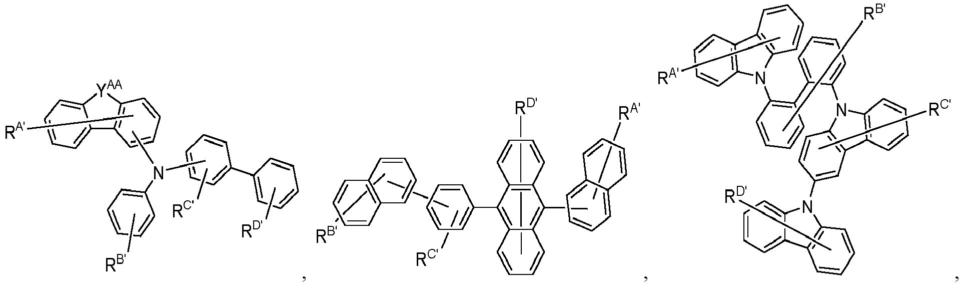 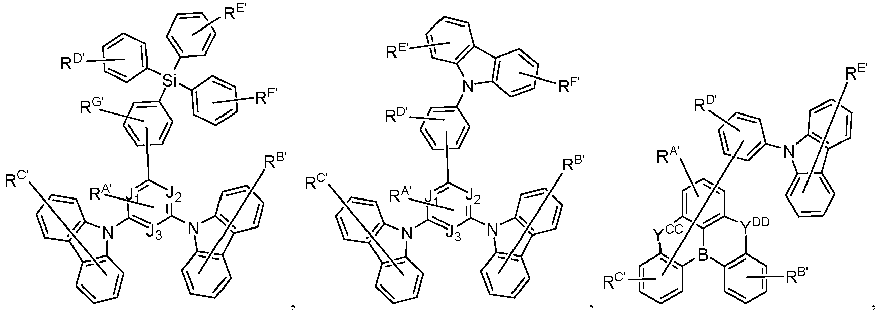 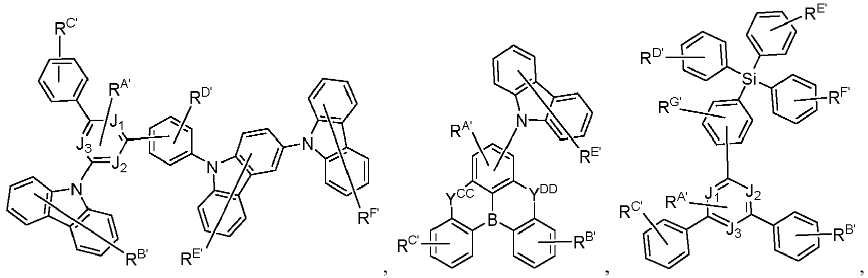 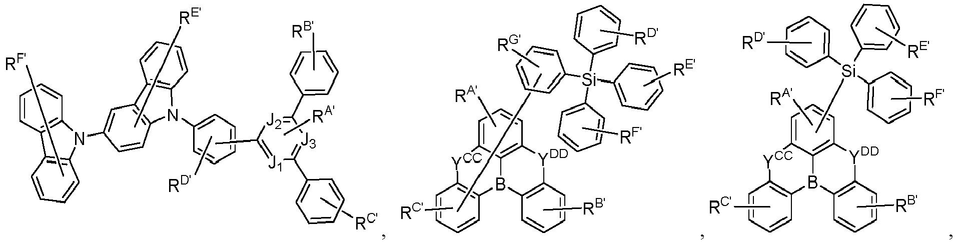 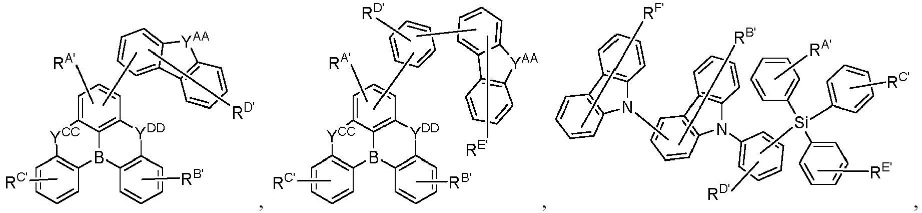 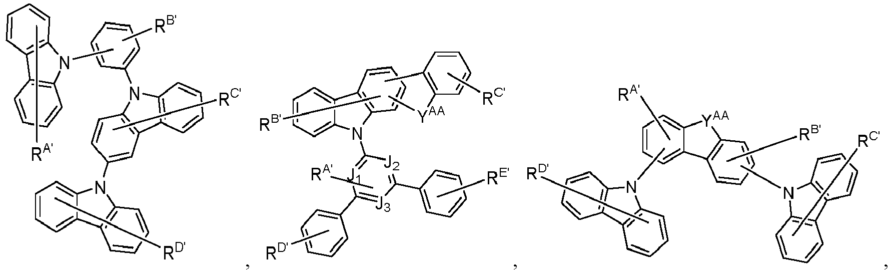 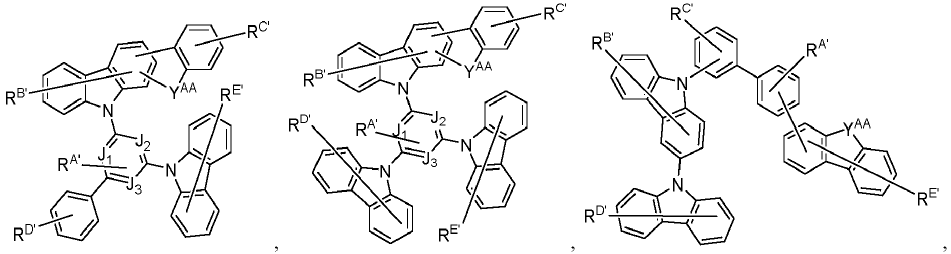 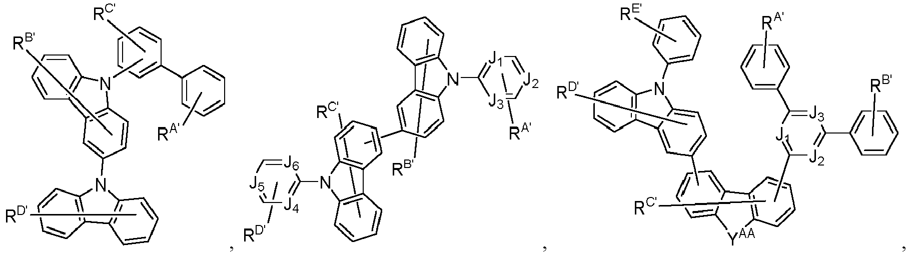 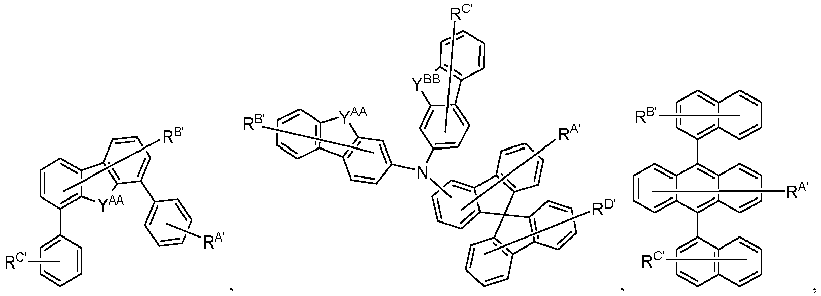 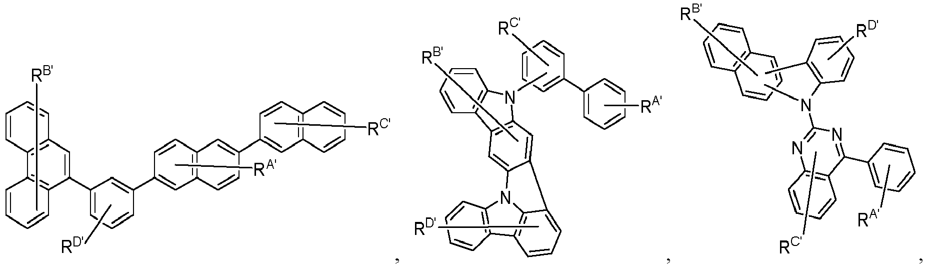 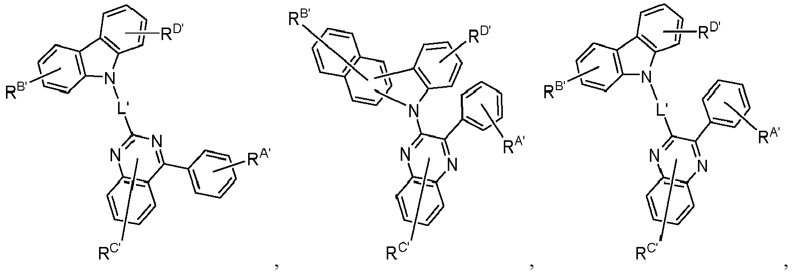 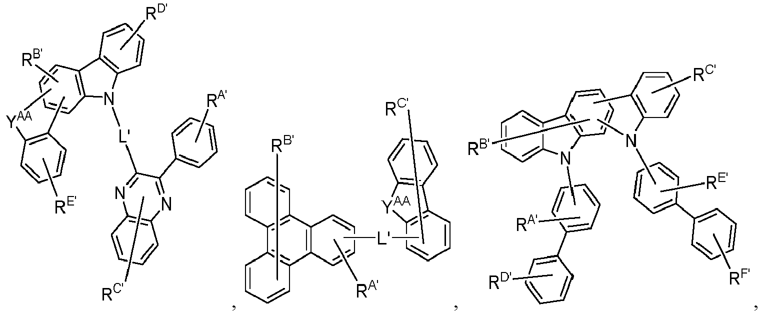 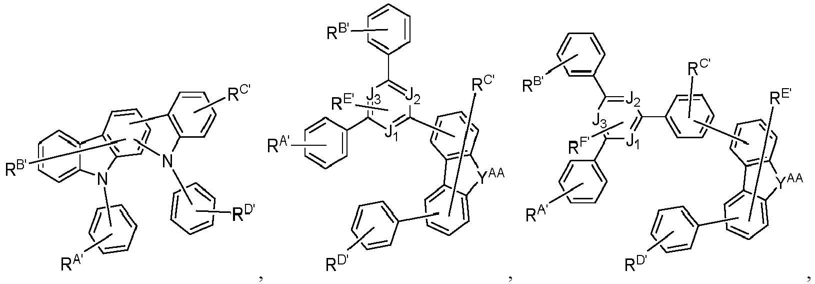 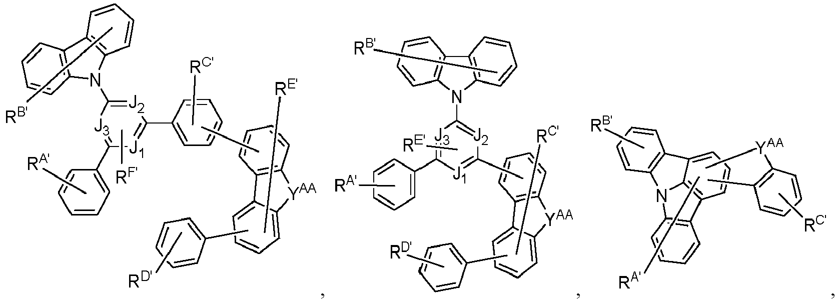 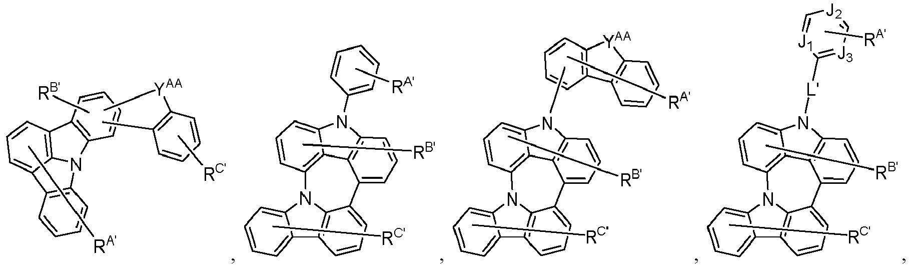 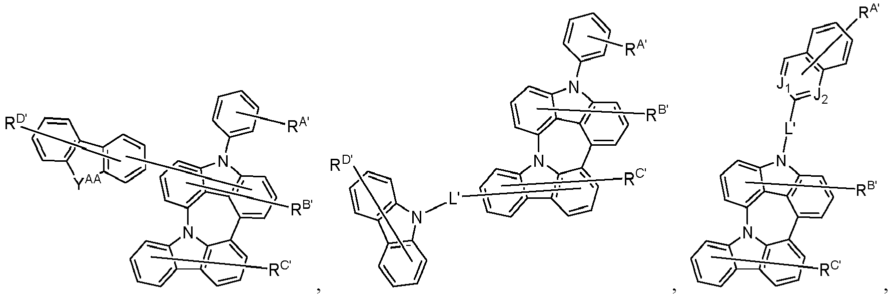 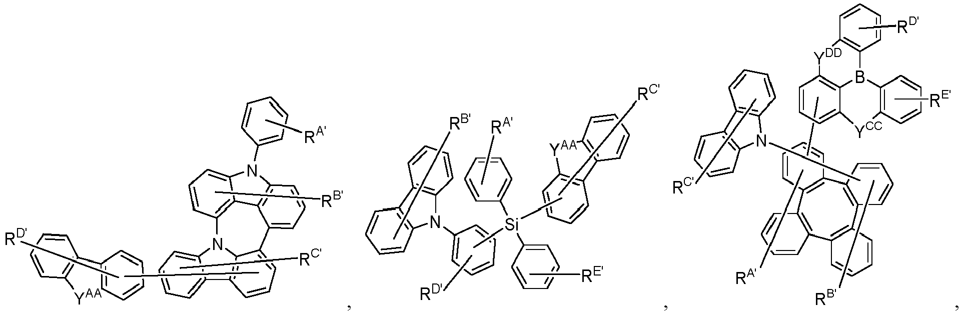 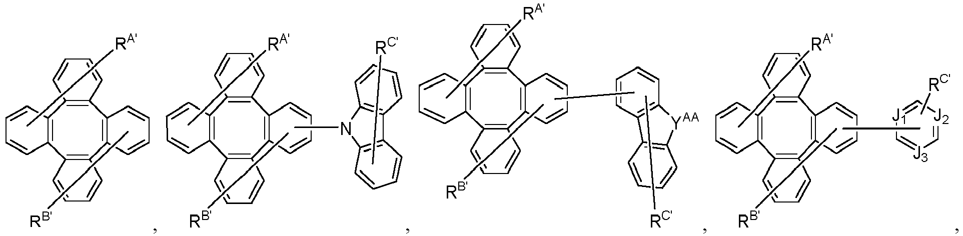 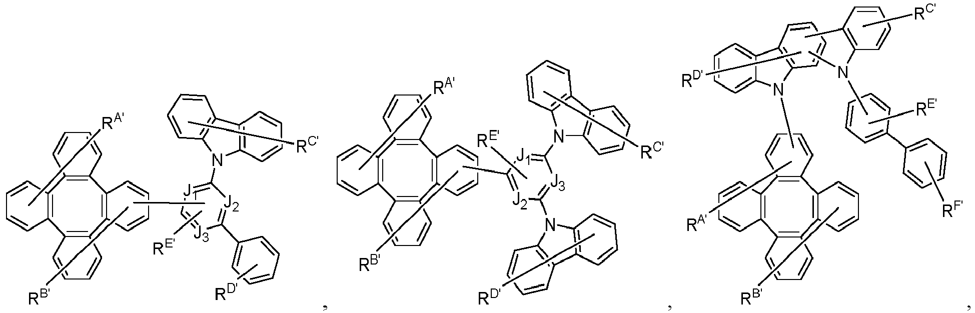 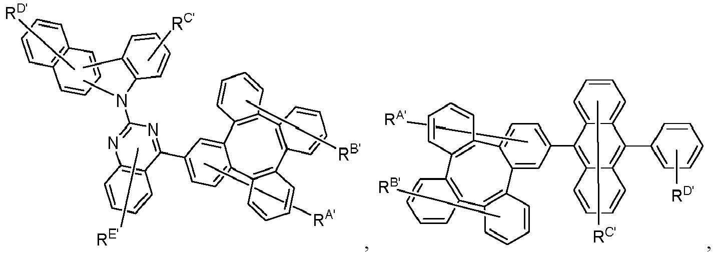 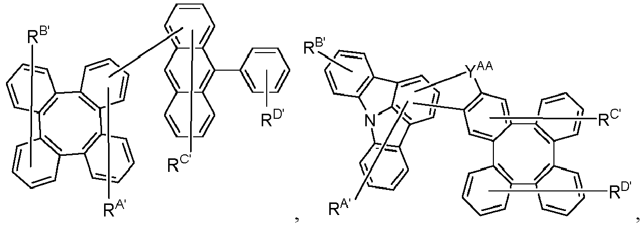 and 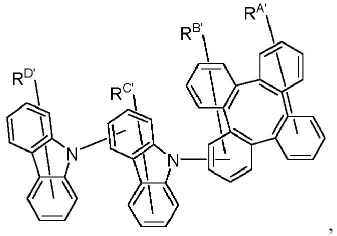 wherein: each of J₁ to J₆ is independently C or N; L' is a direct bond or an organic linker; each Y^{AA}, Y^{BB}, Y^{CC}, and Y^{DD} is independently selected from the group consisting of absent a bond, direct bond, O, S, Se, CRR', SiRR', GeRR', NR, BR, BRR'; each of R^{A'}, R^{B'}, R^{C'}, R^{D'}, R^{E'}, R^{F'}, and R^{G'} independently represents mono, up to the maximum substitutions, or no substitutions; each R, R', R^{A'}, R^{B'}, R^{C'}, R^{D'}, R^{E'}, R^{F'}, and R^{G'} is independently a hydrogen or a substituent selected from the group consisting of the general substituents as defined herein; any two substituents can be joined or fused to form a ring; and where possible, each unsubstituted aromatic carbon atom is optionally replaced with N to form an aza-substituted ring.
18. The OLED of any one of the previous aspects, wherein the third compound, and/or the second host is selected from the group consisting of: 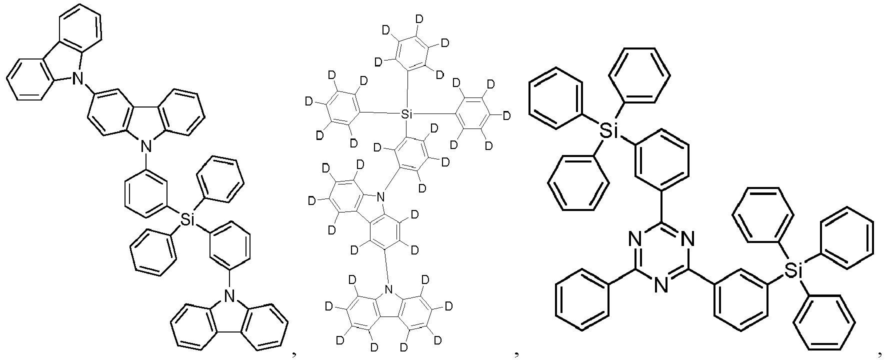 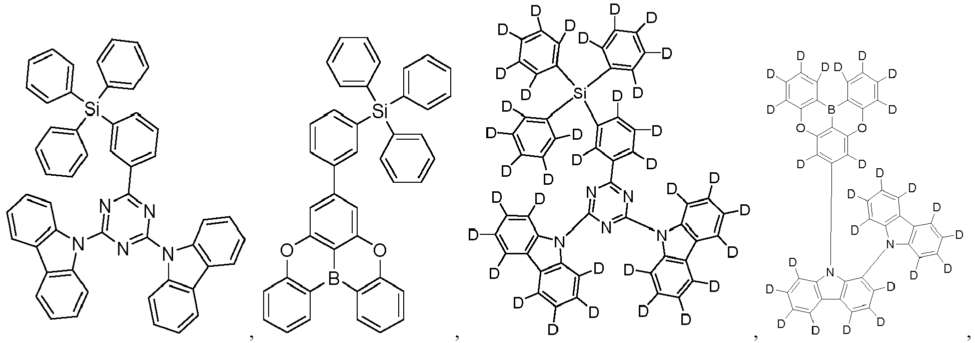 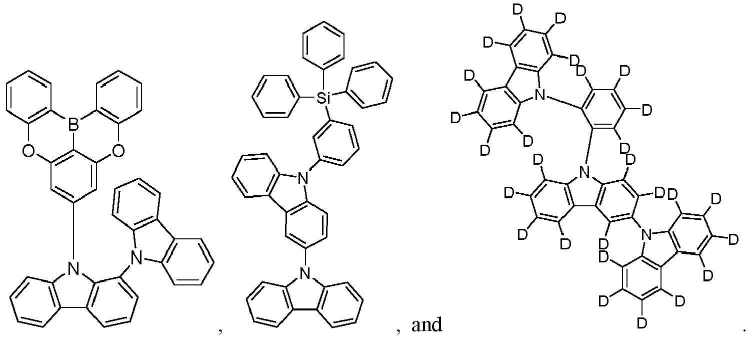
19. The OLED of any one of the previous aspects, wherein the OLED emits a luminescent radiation at room temperature when a voltage is applied across the device; wherein the luminescent radiation comprises a first radiation component contributed from the second compound with an emission λₘₐₓ of 340 to 900 nm; and/or wherein the OLED emits a luminescent radiation at room temperature when a voltage is applied across the device; wherein the luminescent radiation comprises a first radiation component contributed from the second compound with a FWHM of 50 nm or less; and/or wherein the OLED emits a luminescent radiation at room temperature when a voltage is applied across the device; wherein the luminescent radiation comprises a first radiation component contributed from the second compound with a 10% onset of the emission peak is less than 465 nm.
20. A consumer product comprising an OLED according to any one of the previous aspects.

## Claims

1. An organic light emitting device (OLED) comprising:
an anode;
a hole transporting layer;
an emissive region;
an electron transporting layer; and
a cathode;
wherein the emissive region comprises:
a first compound;
a second compound; and
a third compound;
wherein the first compound is a sensitizer that transfers energy to the second compound;
wherein the second compound is an acceptor that is an emitter;
wherein the third compound is a first host, and at least one of the first compound and the second compound is doped in the third compound;
wherein at least two of the first, second, and the third compounds comprises same or different substituent R*;
wherein R* is selected from the group consisting of: 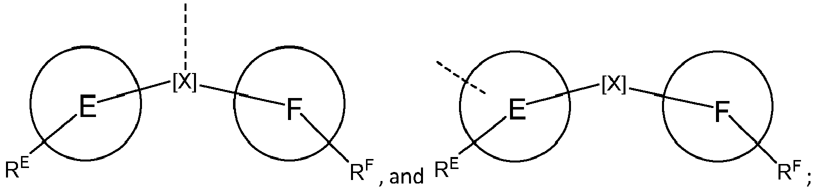
wherein
[X] is a chemical moiety comprises at least one six-membered carbocyclic, a silyl group, a germyl group, or heterocyclic ring;
moieties E and F are each independently a monocyclic ring, or a polycyclic fused ring system; wherein the monocyclic ring and each ring of the polycyclic fused ring system are independently a 5-membered or 6-membered carbocyclic or heterocyclic ring;
R^{E}, and R^{F} each independently represent mono to the maximum allowable substitution, or no substitution;
wherein each R^{E}, and R^{F} is independently a hydrogen or a substituent selected from the group consisting of deuterium, halogen, alkyl, cycloalkyl, heteroalkyl, heterocycloalkyl, boryl, arylalkyl, alkoxy, aryloxy, amino, silyl, germyl, alkenyl, cycloalkenyl, heteroalkenyl, alkynyl, aryl, heteroaryl, acyl, carboxylic acid, ether, ester, nitrile, isonitrile, sulfanyl, sulfinyl, sulfonyl, phosphino, selenyl, and combinations thereof;
any adjacent substituents are optionally joined or fused into a ring.

2. The OLED of claim 1, wherein the first compound is capable of functioning as a phosphorescent emitter or a TADF emitter in an OLED at room temperature; and/or wherein the second compound is a delayed-fluorescent compound functioning as a TADF emitter in said OLED at room temperature or a fluorescent compound functioning as an emitter in said OLED at room temperature; and/or wherein the first compound forms an exciplex with the third compound in said OLED at room temperature; and/or
wherein [X] is selected from the group consisting of a substituted or unsubstituted monocyclic ring, a substituted or unsubstituted polycyclic fused ring system, SiR^{P}, SiR^{P}R^{Q}, GeR^{P}, GeR^{P}R^{Q}, BR^{P}, BR^{P}R^{Q}, CR^{P}R^{Q}, NR^{P}, and PR^{P} wherein R^{P} comprises a 6-membered carbocyclic or heterocyclic ring, and R^{Q} is a hydrogen or a substituent selected from the group consisting of deuterium, halogen, alkyl, cycloalkyl, heteroalkyl, heterocycloalkyl, boryl, arylalkyl, alkoxy, aryloxy, amino, silyl, germyl, alkenyl, cycloalkenyl, heteroalkenyl, alkynyl, aryl, heteroaryl, acyl, carboxylic acid, ether, ester, nitrile, isonitrile, sulfanyl, sulfinyl, sulfonyl, phosphino, selenyl, and combinations thereof; and/or
wherein the first compound is partially or fully deuterated; and/or wherein the second compound is partially or fully deuterated; and/or wherein the third compound is partially or fully deuterated.

3. The OLED of claim 1 or 2, wherein R* is selected from the group consisting of: 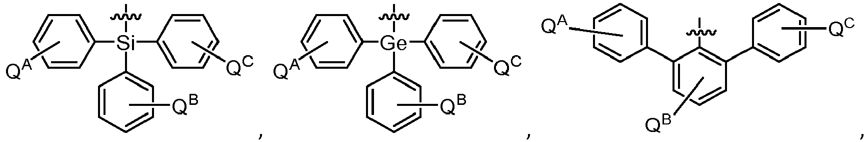 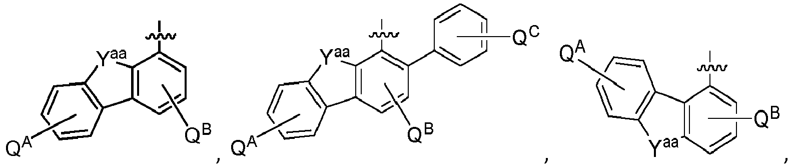 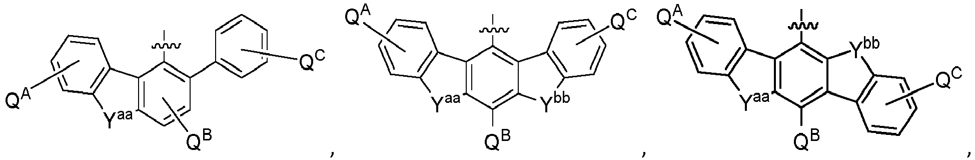 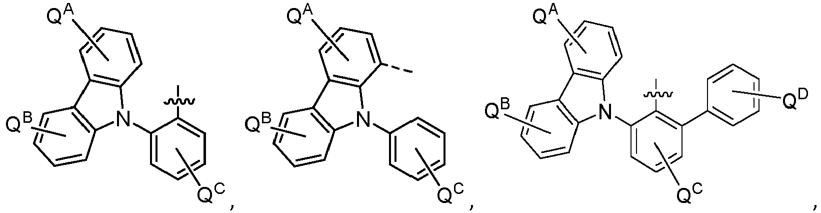 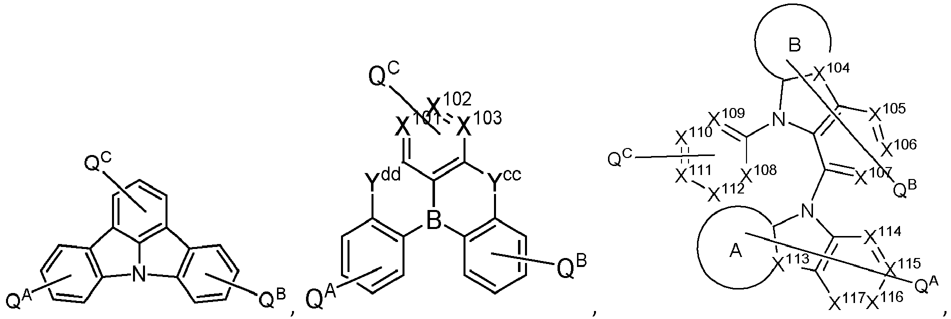 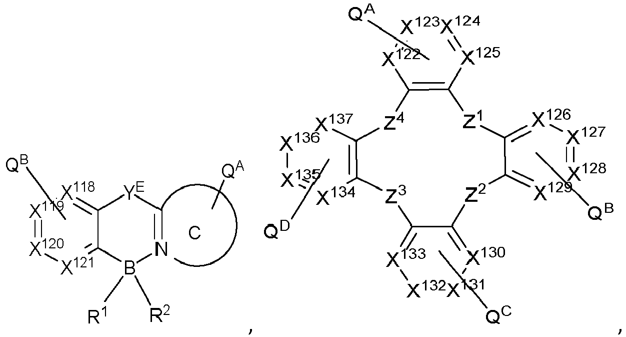 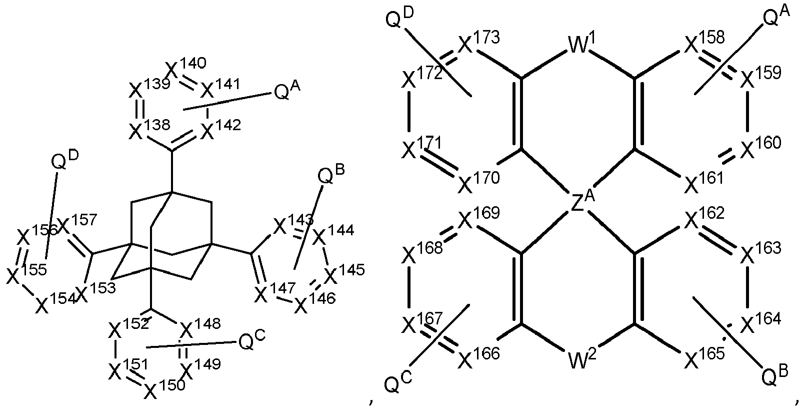 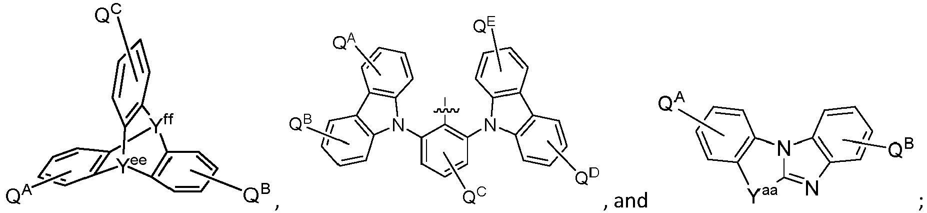
wherein rings A, B, and C are each independently a 5-membered or 6-membered carbocyclic or heterocyclic ring;
Z¹ to Z⁴ are each independently a direct bond or selected from the group consisting of O, S, Se, NR, BR, BRR', PR, CR, C=X, CRR', SO, SO₂, SiRR', GeRR', P(O)R, aryl, hetero aryl, alkyl, hetero cycloalkyl, and cycloalkyl;
each X¹⁰¹-X¹⁷³ is independently C or N;
Z^{A} is selected from the group consisting of C, Si, and Ge;
wherein W¹ and W² are each independently selected from the group consisting of direct bond, O, S, Se, CRR', SiRR', and GeRR';
each Y^{aa} and Y^{bb} is independently selected from the group consisting of O, S, Se, CRR', SiRR', GeRR', NR, BR, and BRR';
each Y^{E}, Y^{cc} and Y^{dd} is independently selected from the group consisting of O, S, Se, CRR', SiRR', GeRR', BR, and BRR';
each Y^{ee} and Y^{ff} is independently selected from the group consisting of CR, SiR, GeR, B, and N;
each Q^{A} to Q^{E} independently represents mono to the maximum allowable substitutions, or no substitution;
each R, R', Q^{A} to Q^{E} is independently hydrogen or a substituent selected from the group consisting of deuterium, halogen, alkyl, cycloalkyl, heteroalkyl, heterocycloalkyl, arylalkyl, alkoxy, aryloxy, amino, silyl, germyl, boryl, alkenyl, cycloalkenyl, heteroalkenyl, alkynyl, aryl, heteroaryl, acyl, carboxylic acid, ether, ester, nitrile, isonitrile, sulfanyl, sulfinyl, sulfonyl, phosphino, selenyl, and combinations thereof; any two substituents can be joined or fused into a ring; and
any carbon ring atoms up to maximum total number of three, together with their substituents, in each phenyl ring of any of above structures can be replaced with N.

4. The OLED of any one of the previous claims, wherein R* is selected from the group consisting of the structures of LIST 1 as defined herein.

5. The OLED of any one of the previous claims, wherein T₁ energy of the third compound is higher than those of the first and the second compounds; and/or wherein S₁ energy of the second compound is lower than those of the first and the third compounds; and/or wherein S₁-T₁ energy gap of the first compound is less than 300 meV; and/or wherein S₁-T₁ energy gap of the second compound is less than 300 meV; and/or wherein the second compound has a Stokes shift of 30 nm or less.

6. The OLED of any one of the previous claims, wherein the first compound has an emission maximum of λmax1 in an monochromic OLED having the third compound as the host at room temperature; wherein the second compound has an emission maximum of λₘₐₓ₂ in the monochromic OLED by replacing the first compound with the second compound; wherein Dλ = λₘₐₓ₁ - λₘₐₓ₂; and wherein Dλ is equal to or less than the number selected from the group consisting of 15, 12, 10, 8, 6, 4, 2, 0, -2, -4, -6, -8, and -10 nm.

7. The OLED of any one of the previous claims, wherein the first compound has the formula of M(L¹)ₓ(L²)_{y}(L³)_{z};
wherein L¹, L², and L³ can be the same or different;
wherein x is 1, 2, or 3;
wherein y is 0, 1, or 2;
wherein z is 0, 1, or 2;
wherein x+y+z is the oxidation state of the metal M;
wherein L¹ is selected from the group consisting of: 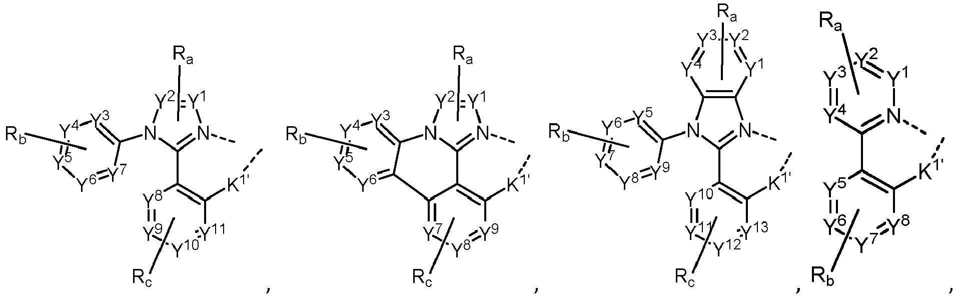 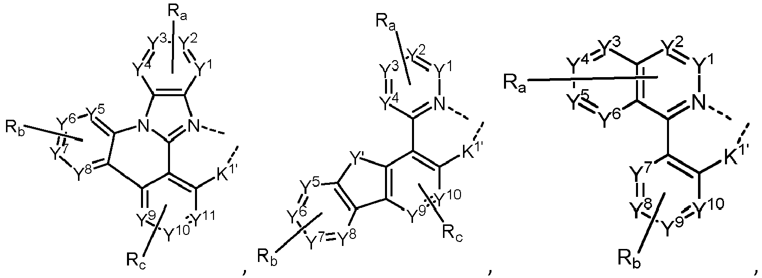 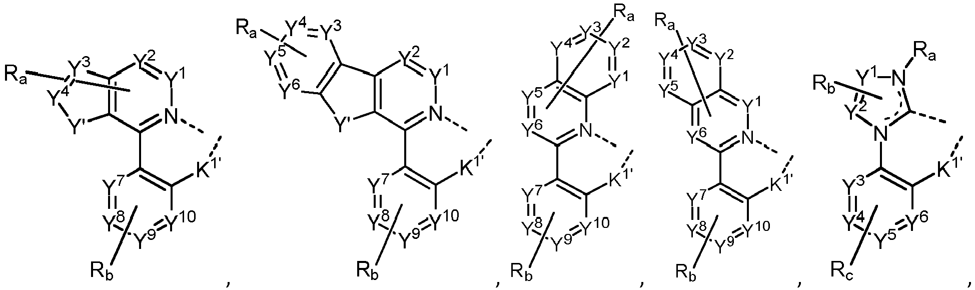 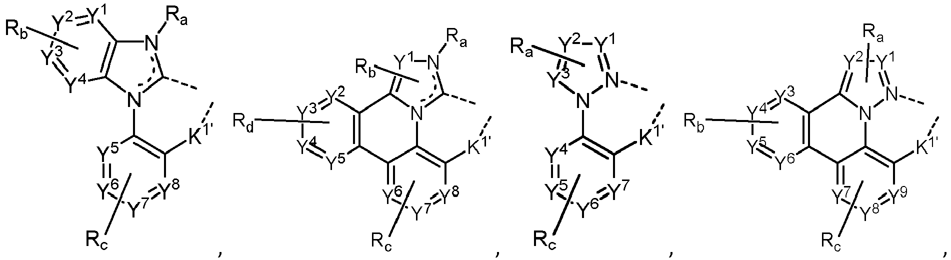 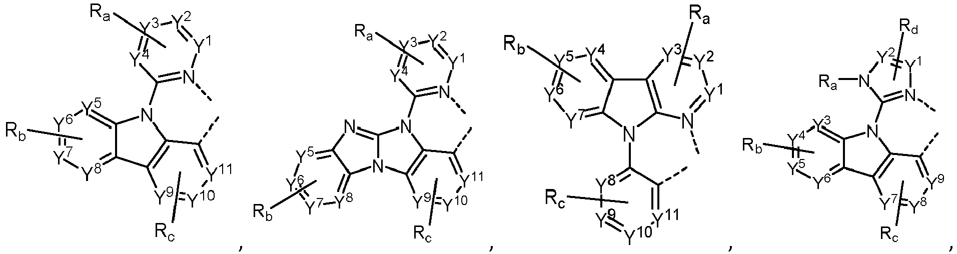 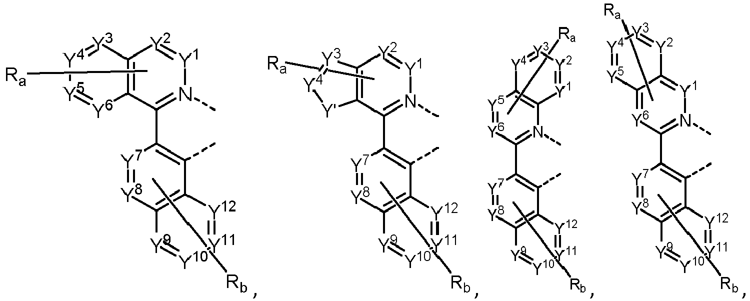 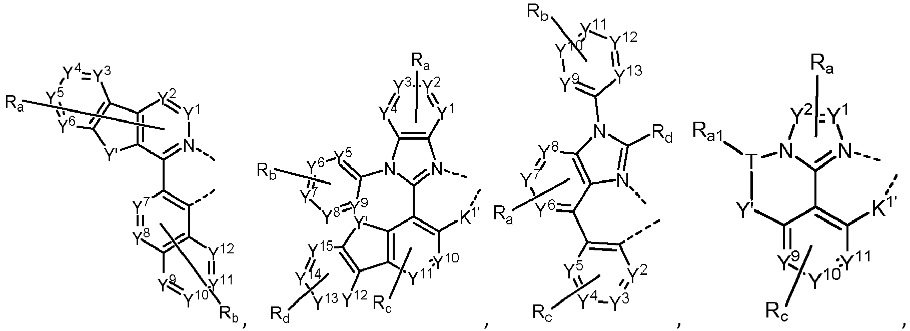 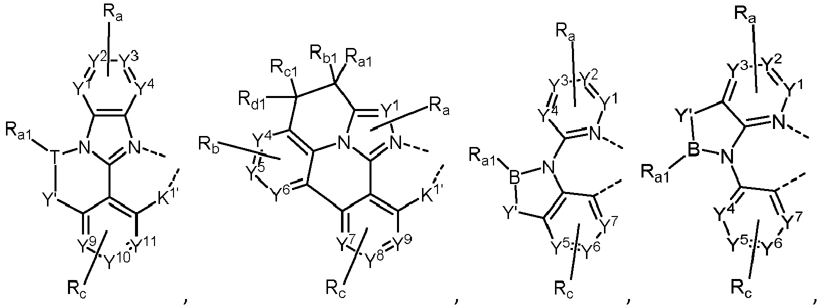 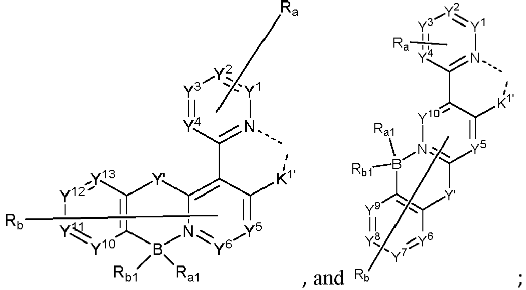
wherein L² and L³ are independently selected from the group consisting of 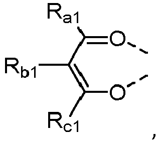 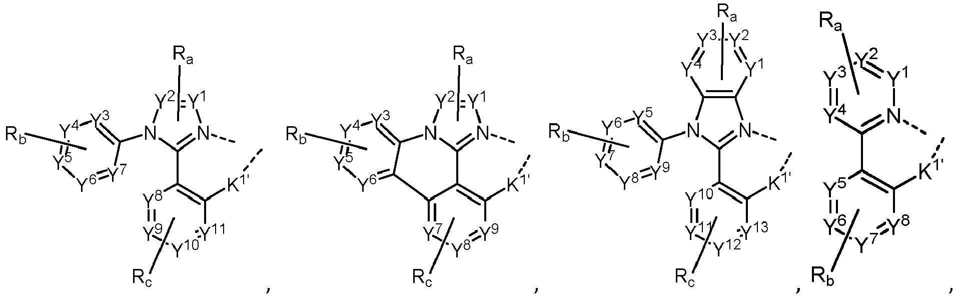 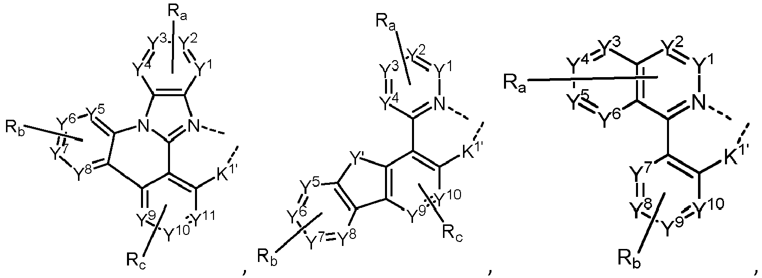 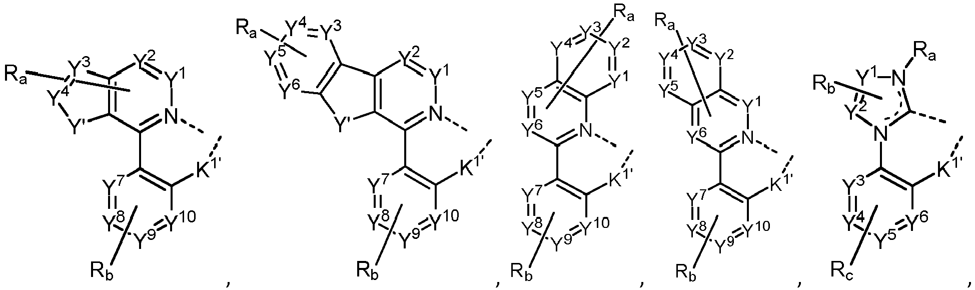 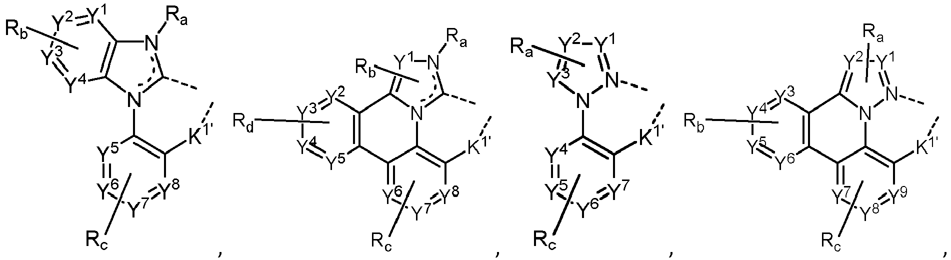 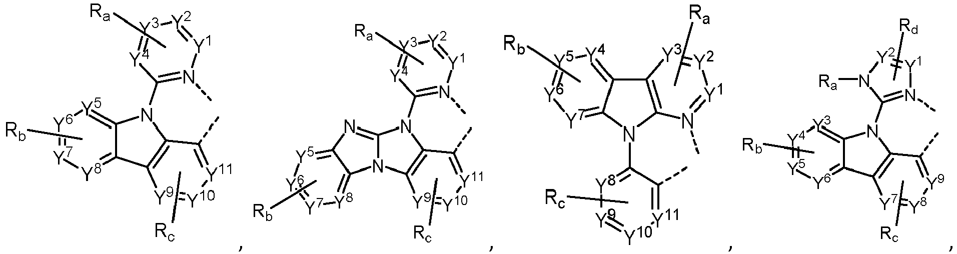 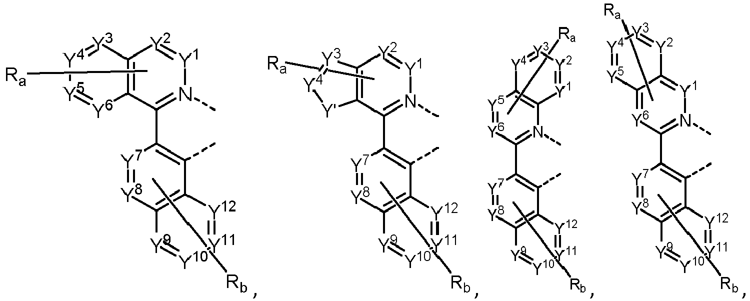 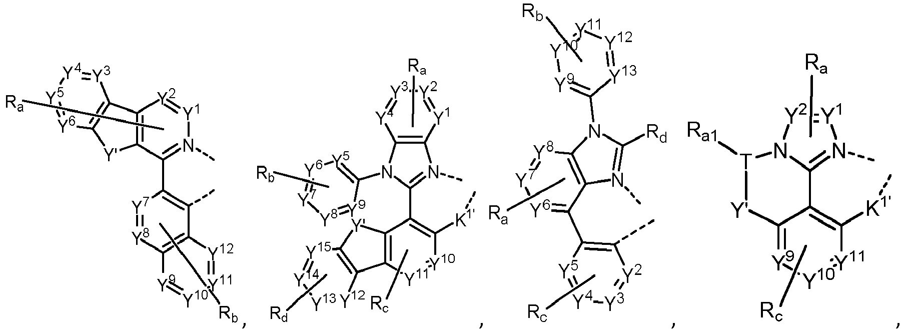 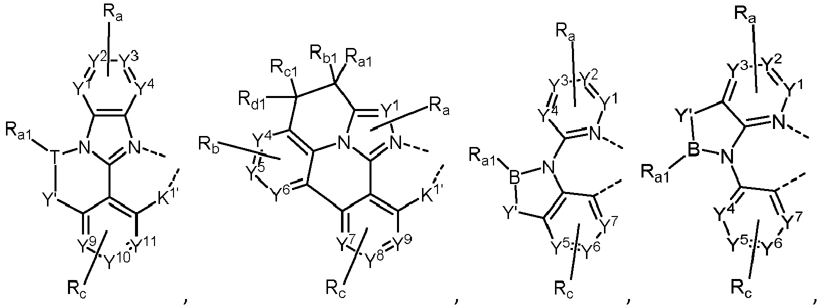 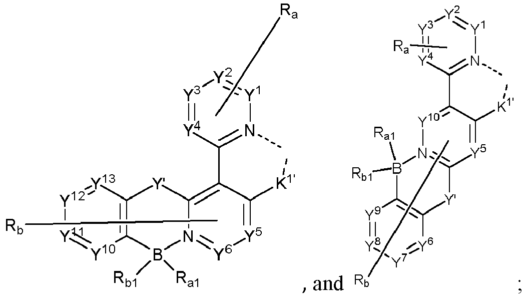
wherein T is selected from the group consisting of B, Al, Ga, and In;
wherein K^{1'} is a direct bond or is selected from the group consisting of NRₑ, PRₑ, O, S, and Se;
wherein each Y¹ to Y¹³ are independently selected from the group consisting of carbon and nitrogen;
wherein Y' is selected from the group consisting of BRₑ, NRₑ, PRₑ, O, S, Se, C=O, S=O, SO2, CReR_{f}, SiRₑR_{f}, and GeRₑR_{f};
wherein Rₑ and R_{f} can be fused or joined to form a ring;
wherein each Rₐ, R_{b}, R_{c}, and R_{d} can independently represent from mono to the maximum possible number of substitutions, or no substitution;
wherein each Rₐ , R_{b1}, R_{c1}, R_{d1}, Rₐ, R_{b}, R_{c}, R_{d}, Rₑ, and R_{f} is independently a hydrogen or a substituent selected from the group consisting of deuterium, halogen, alkyl, cycloalkyl, heteroalkyl, heterocycloalkyl, boryl, arylalkyl, alkoxy, aryloxy, amino, silyl, germyl, alkenyl, cycloalkenyl, heteroalkenyl, alkynyl, aryl, heteroaryl, acyl, carboxylic acid, ether, ester, nitrile, isonitrile, sulfanyl, sulfinyl, sulfonyl, phosphino, selenyl, and combinations thereof; and
wherein any two adjacent substituents of Rₐ₁, R_{b1}, R_{c1}, R_{d1}, Rₐ, R_{b}, R_{c}, and R_{d} can be fused or joined to form a ring or form a multidentate ligand.

8. The OLED of any one of the previous claims, wherein the first compound is selected from the group consisting of: 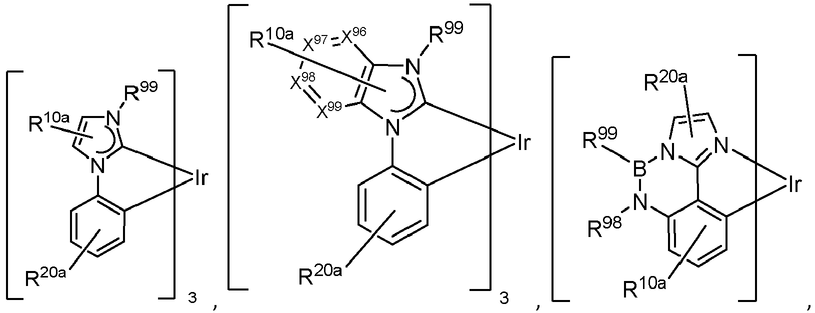 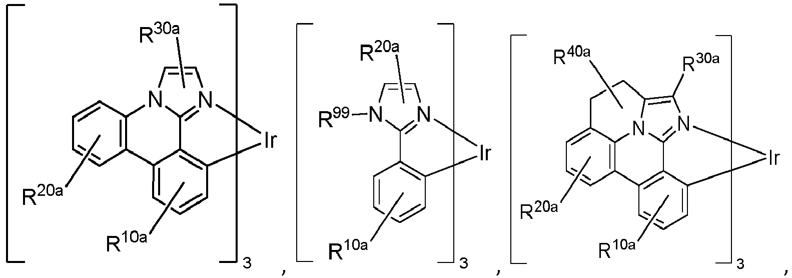 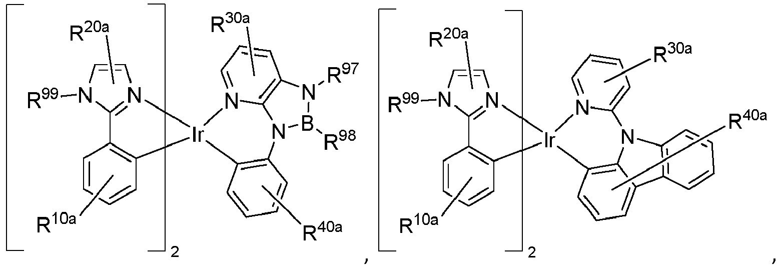 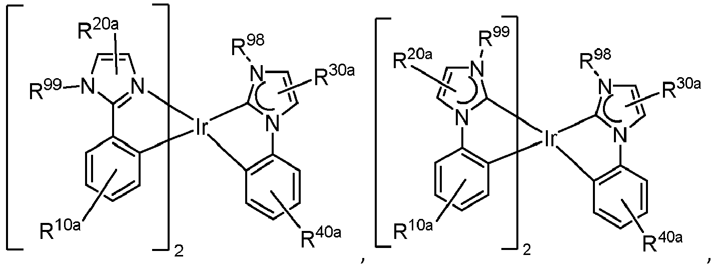 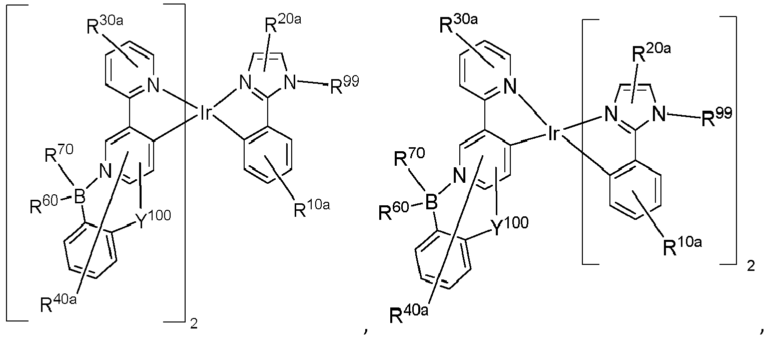 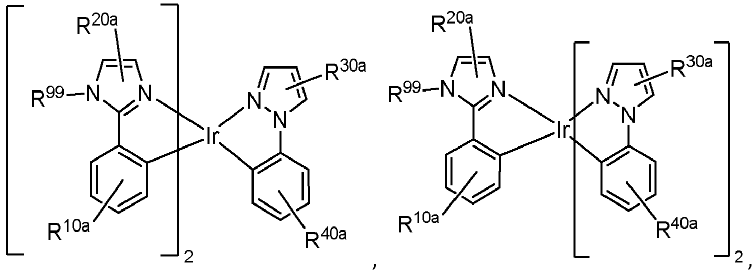 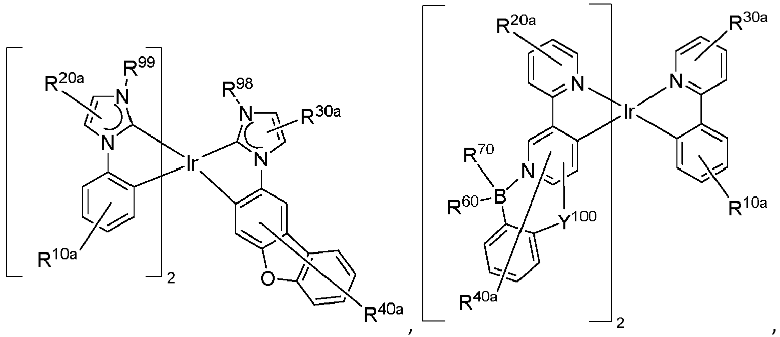 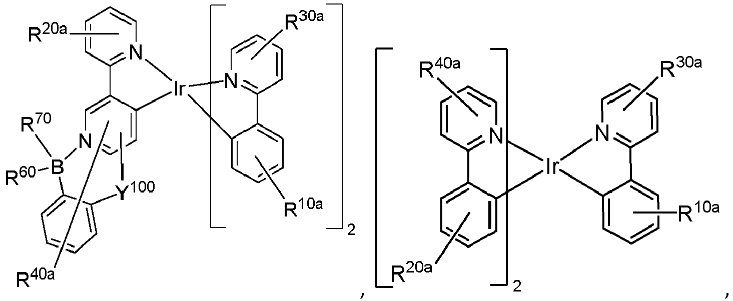 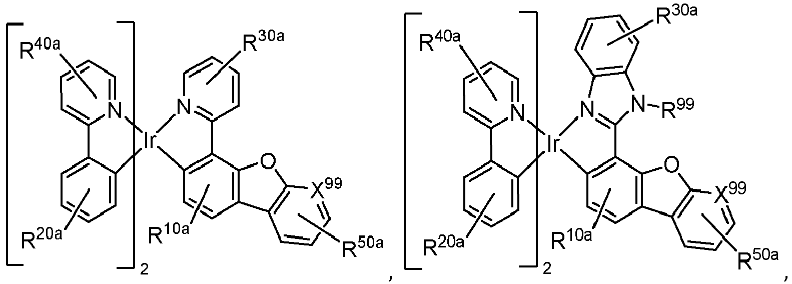 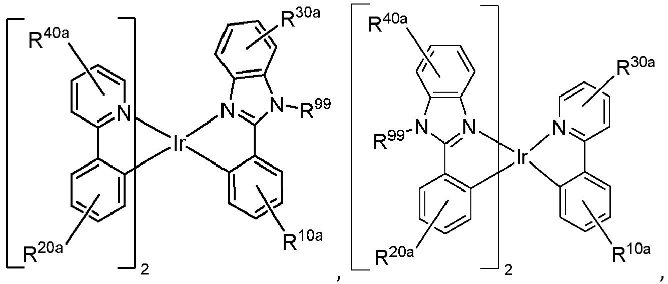 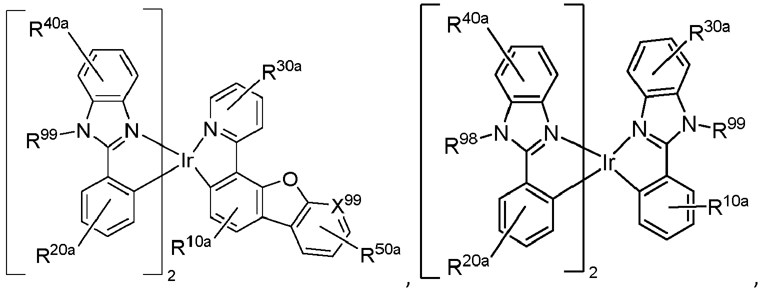 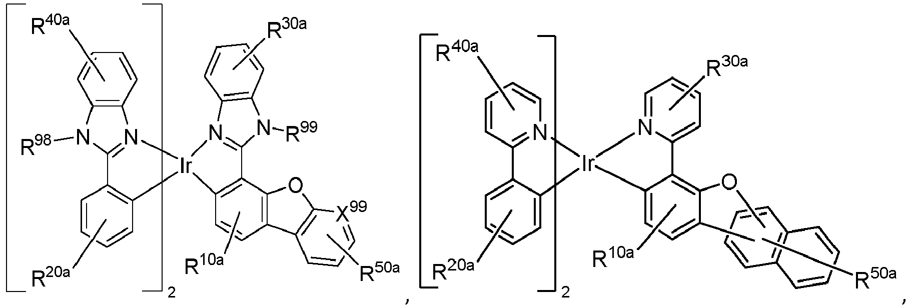 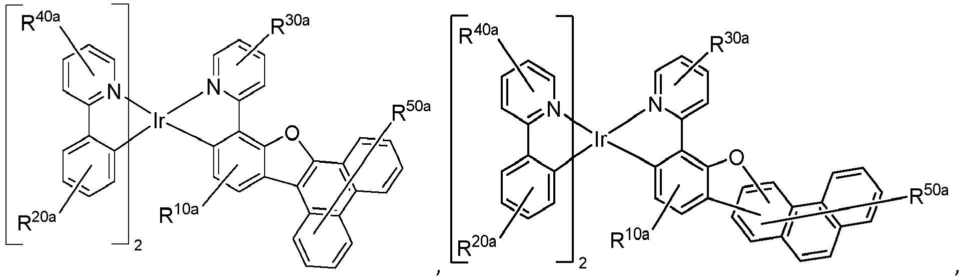 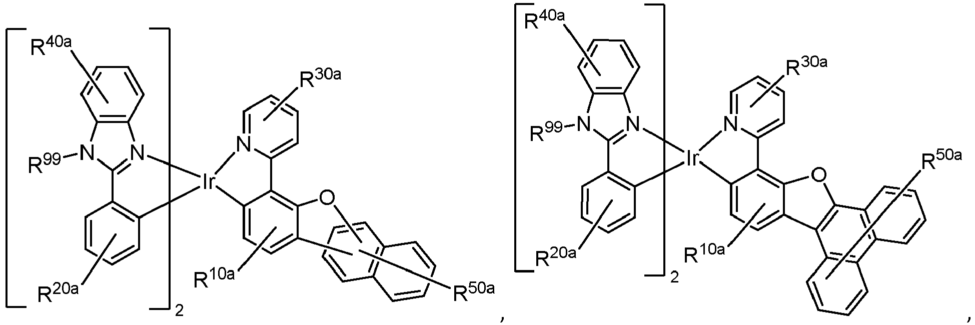 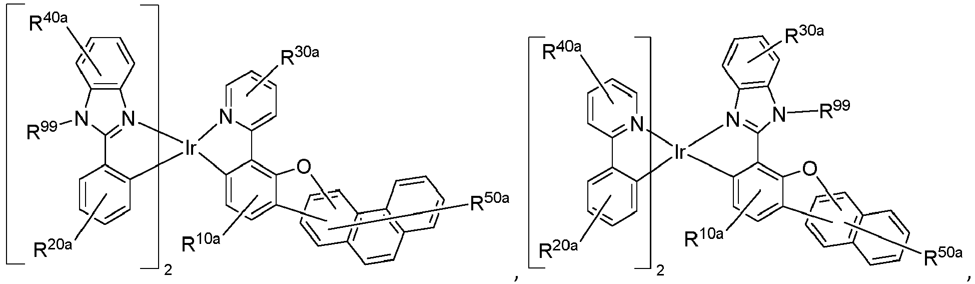 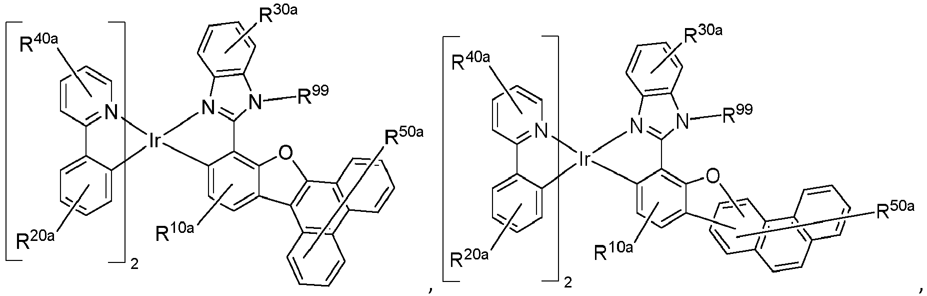 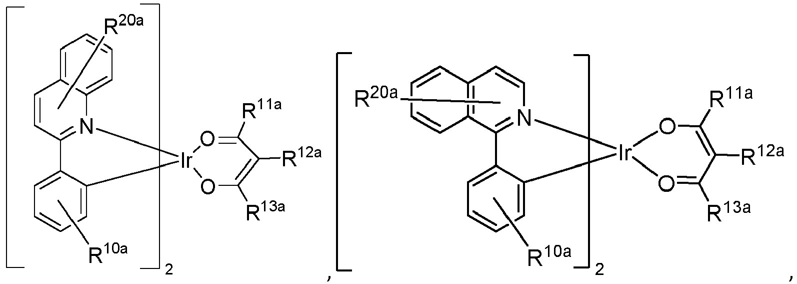 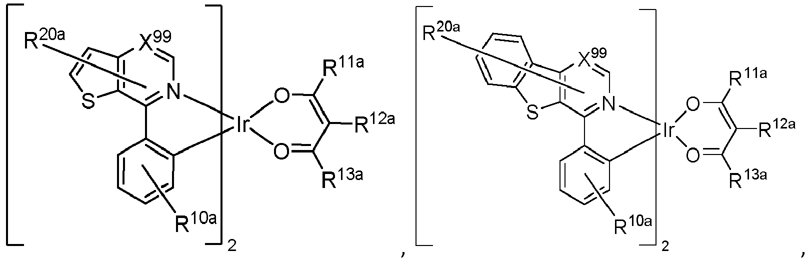 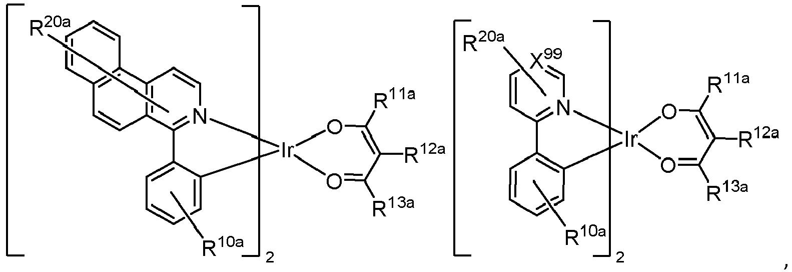 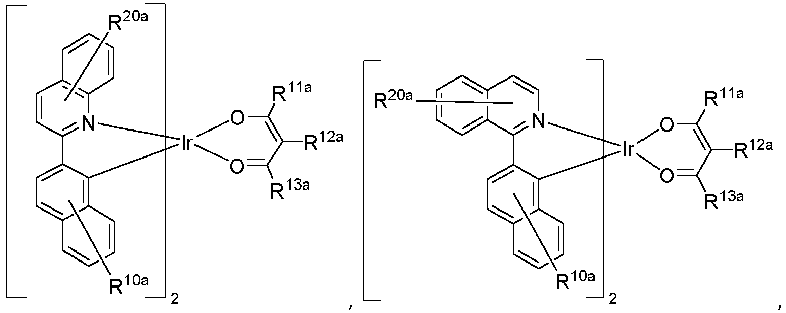 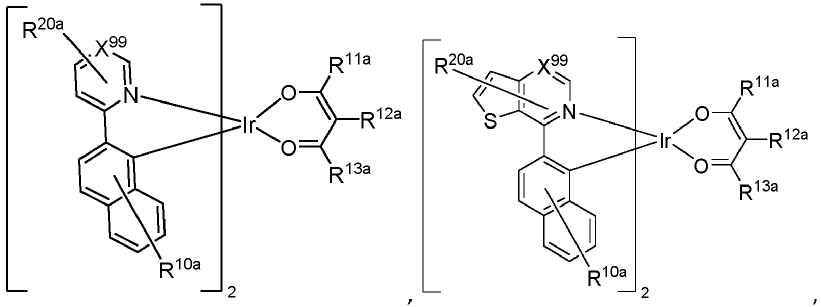 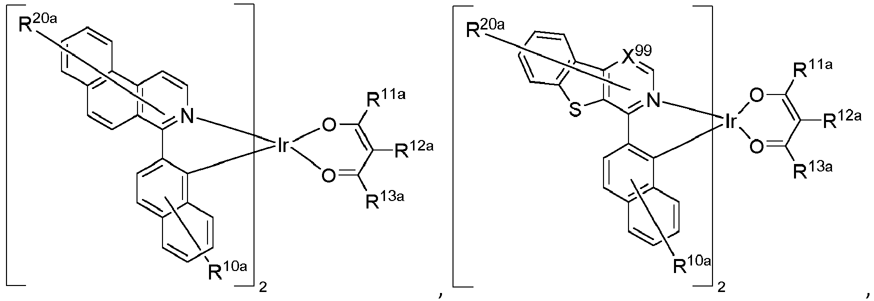 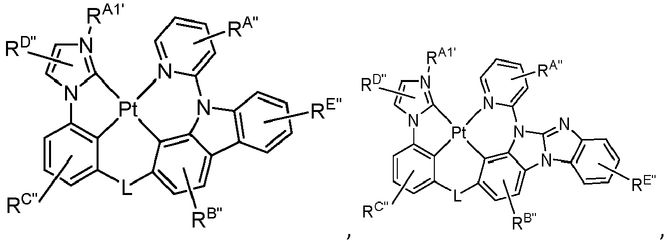 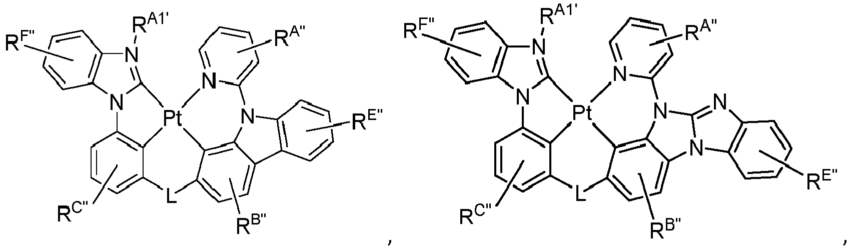 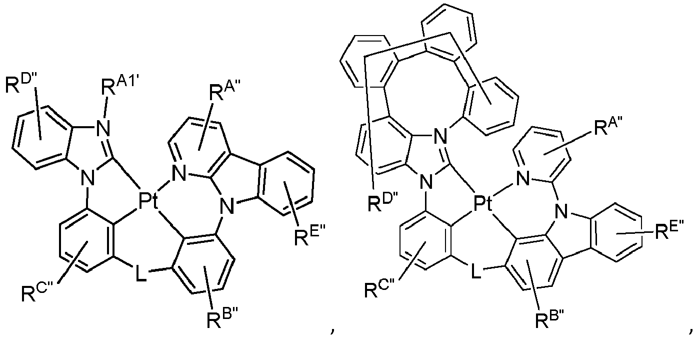 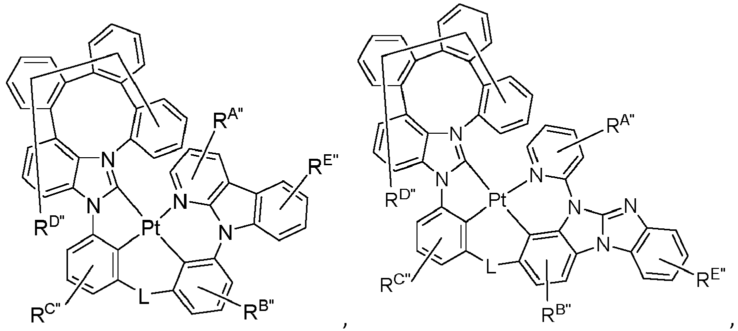 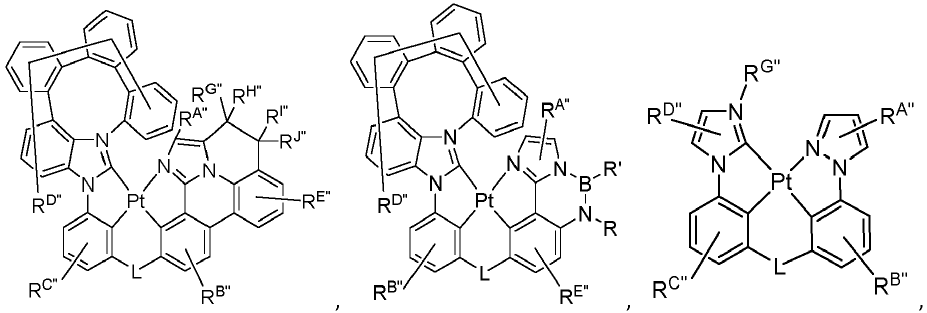 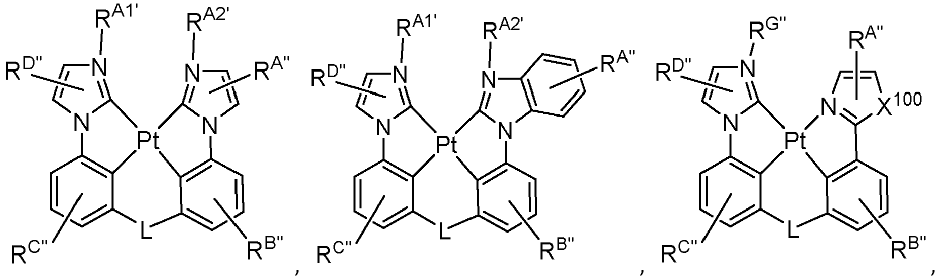 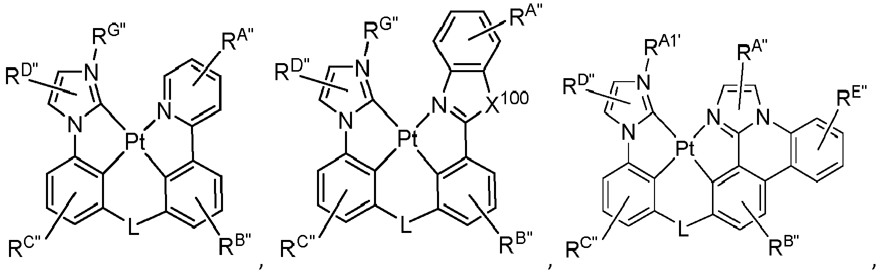 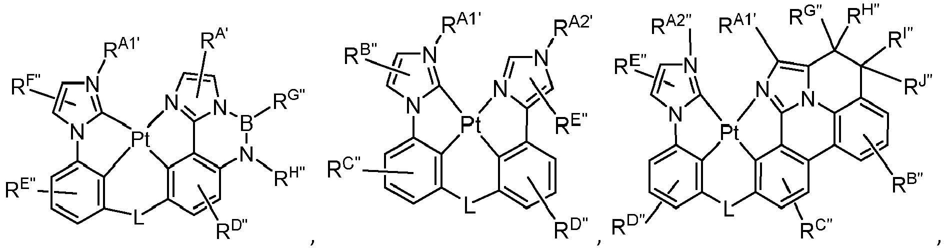 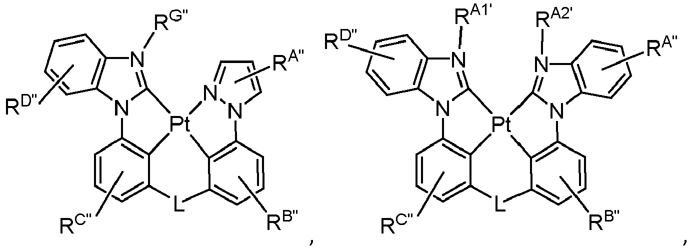 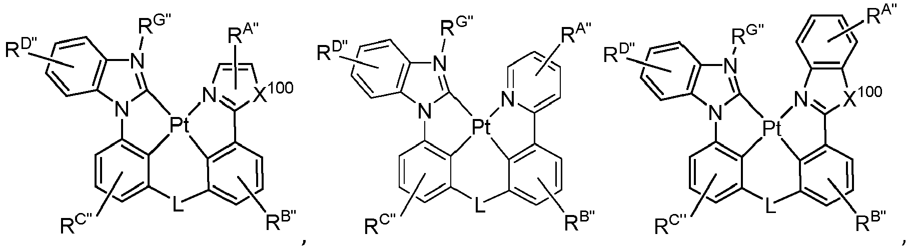 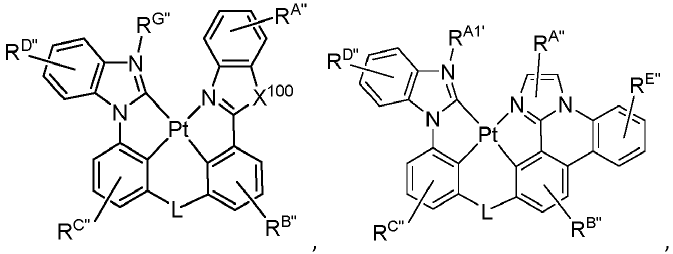 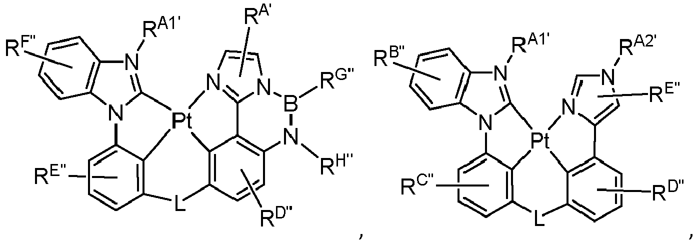 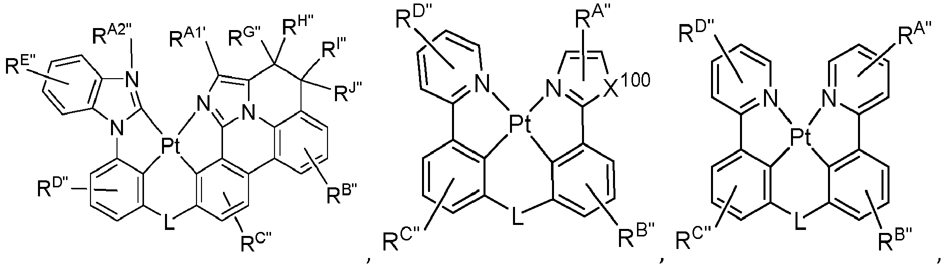 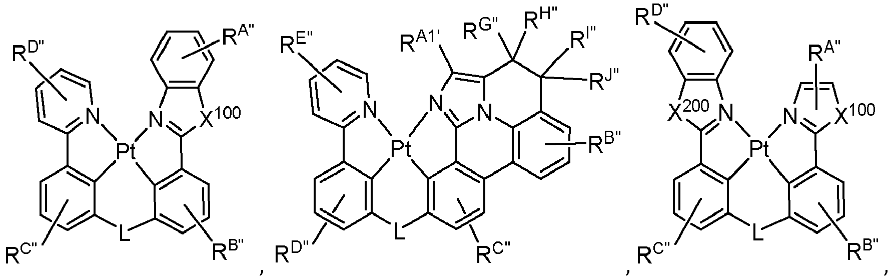 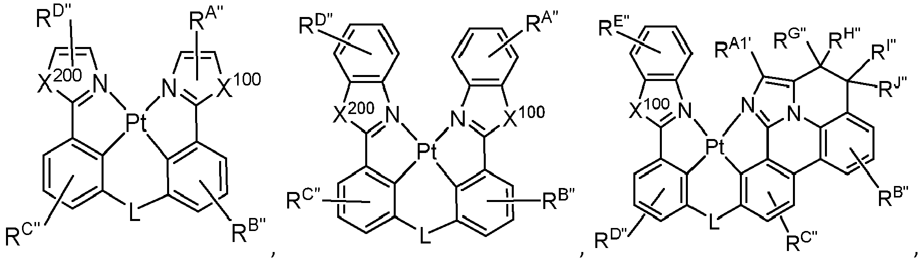 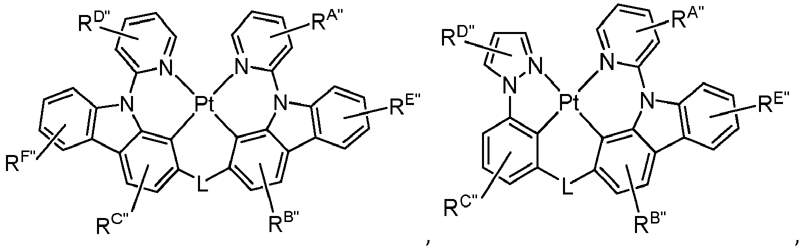 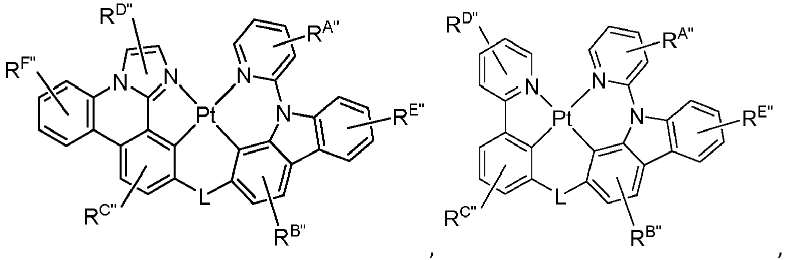 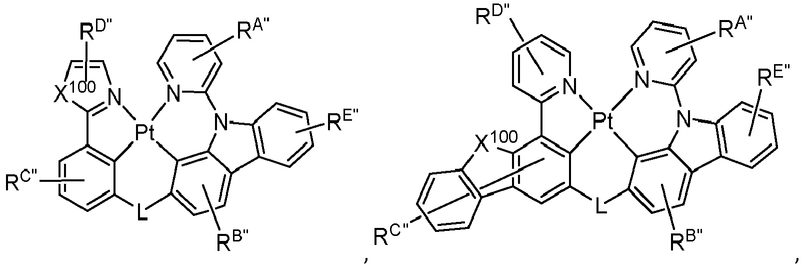 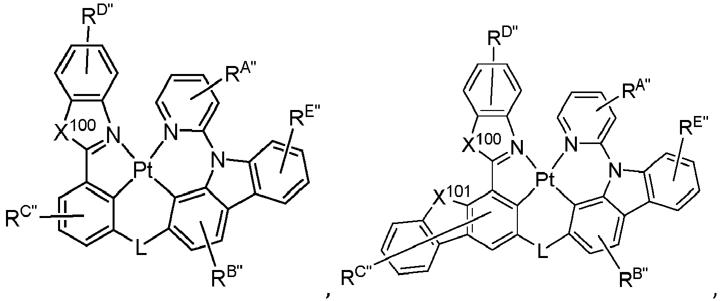 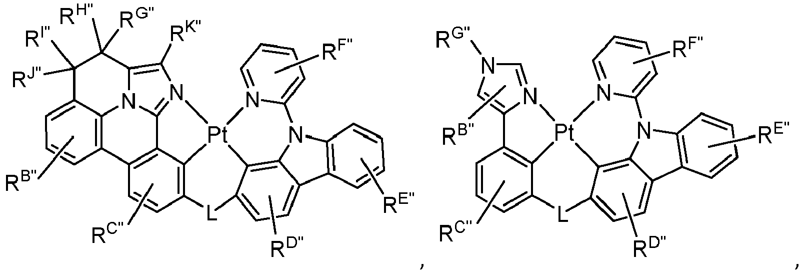 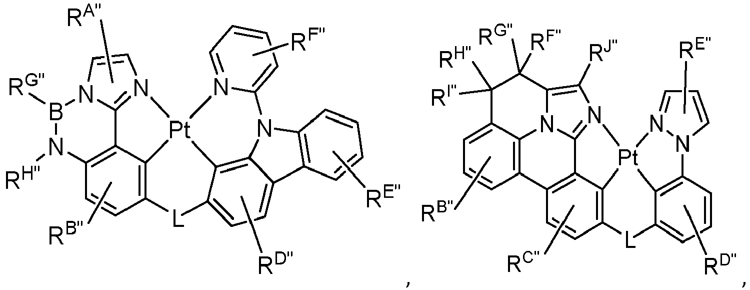 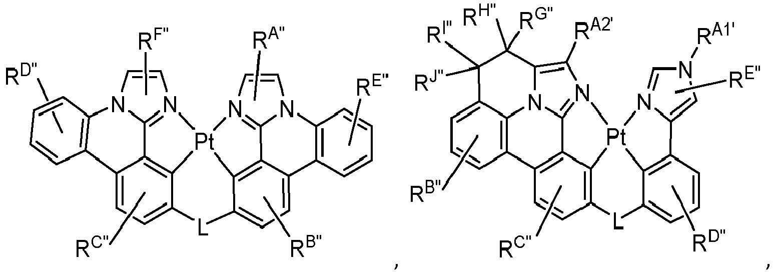 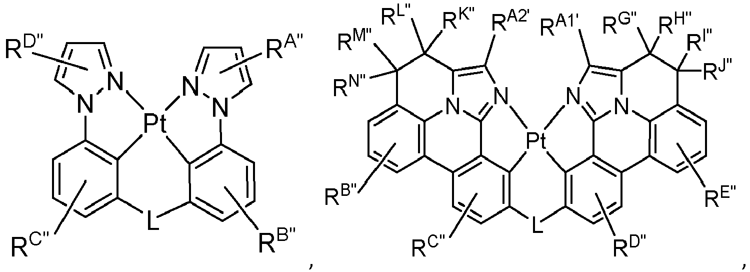 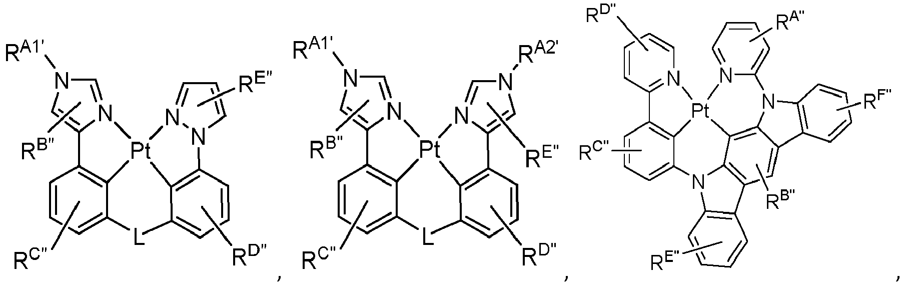 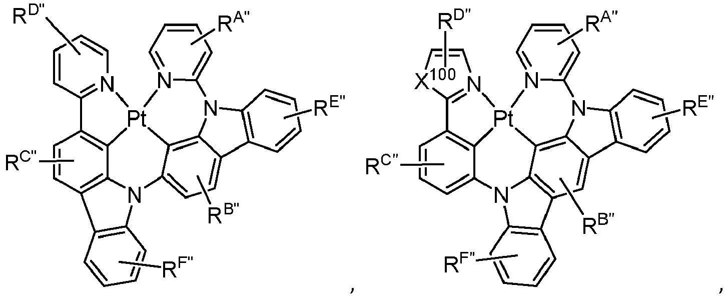 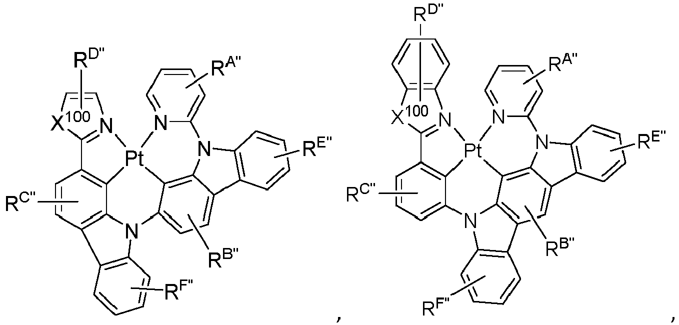 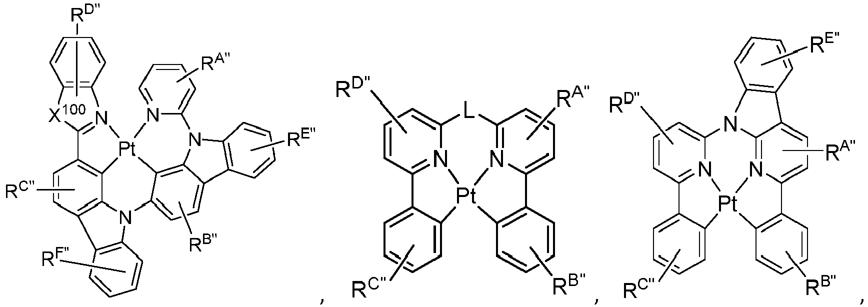 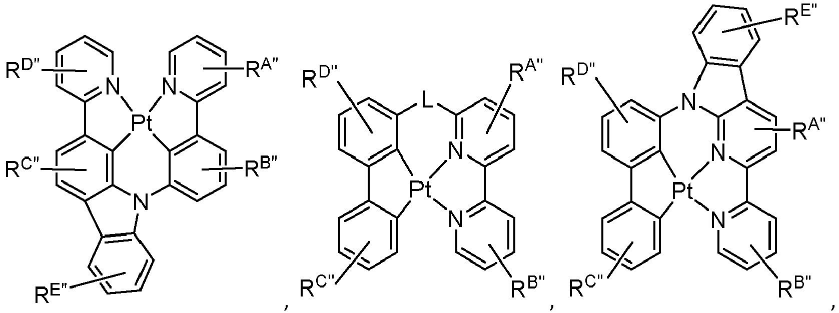 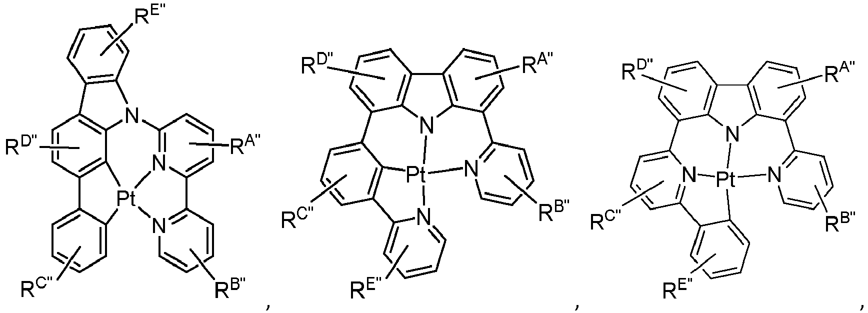 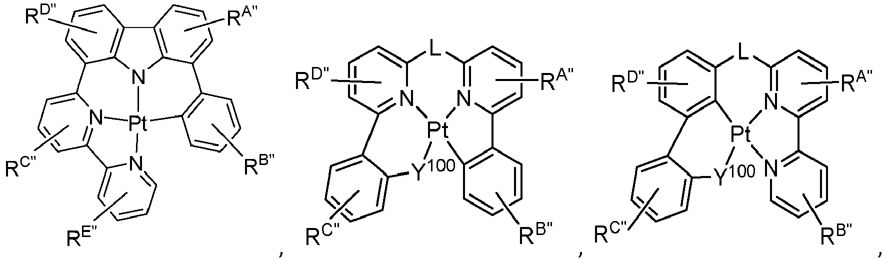 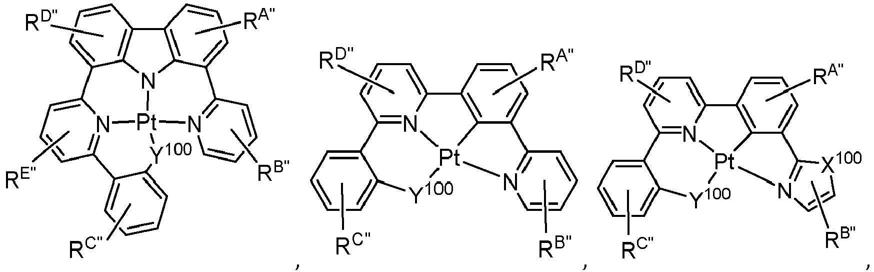 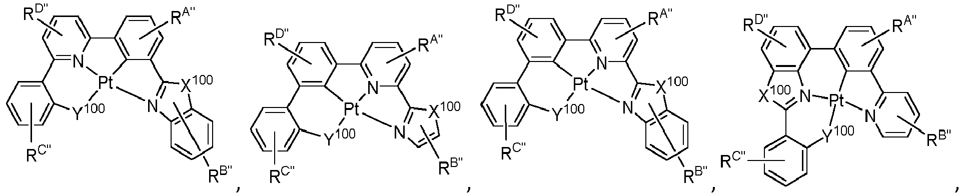 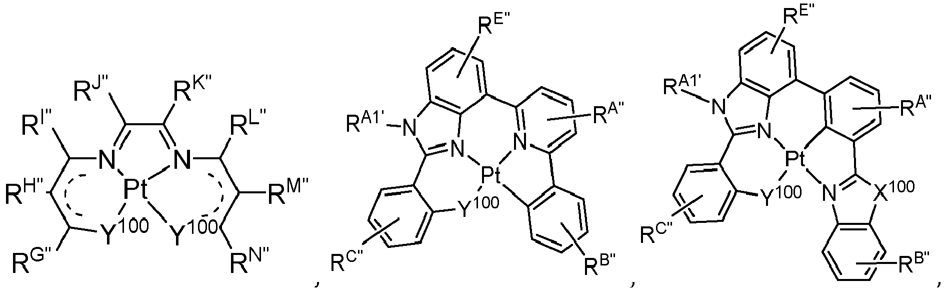 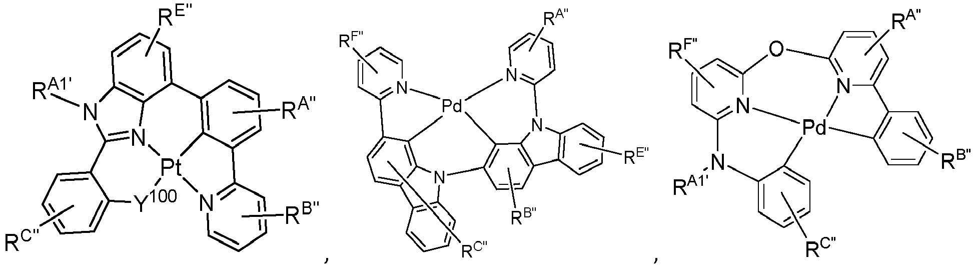 , and 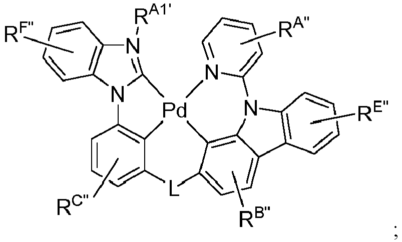
each of X⁹⁶ to X⁹⁹ is independently C or N;
each Y¹⁰⁰ is independently selected from the group consisting of a NR", O, S, and Se;
L is independently selected from the group consisting of a direct bond, BR", BR"R'", NR", PR", O, S, Se, C=O, C=S, C=Se, C=NR", C=CR"R‴, S=O, SO₂, CR", CR"R‴, SiR"R‴, GeR"R‴, alkyl, cycloalkyl, aryl,
heteroaryl, and combinations thereof;
X¹⁰⁰, and X²⁰⁰ for each occurrence is selected from the group consisting of O, S, Se, NR", and CR"R‴;
each R^{10a}, R^{20a}, R^{30a}, R^{40a}, and R^{50a}, R^{A"}, R^{B"}, R^{C"}, R^{D"}, R^{E"}, and R^{F"} independently represents mono-, up to the maximum substitutions, or no substitutions;
each of R, R', R", R‴, R^{10a}, R^{11a}, R^{12a}, R^{13a}, R^{20a}, R^{30a}, R^{40a}, R^{50a}, R⁶⁰, R⁷⁰, R⁹⁷, R⁹⁸, R⁹⁹, R^{A1'}, R^{A2'}, R^{A"}, R^{B"}, R^{C"}, R^{D"}, R^{E"}, R^{F"}, R^{G"}, R^{H"}, R^{I"}, R^{J"}, R^{K"}, R^{L"}, R^{M"}, and R^{N"} is independently a hydrogen or a substituent selected from the group consisting of the general substituents as defined herein; wherein any two substituents can be fused or joined to form into a ring.

9. The OLED of any one of the previous claims, wherein the second compound is selected from the group consisting of: 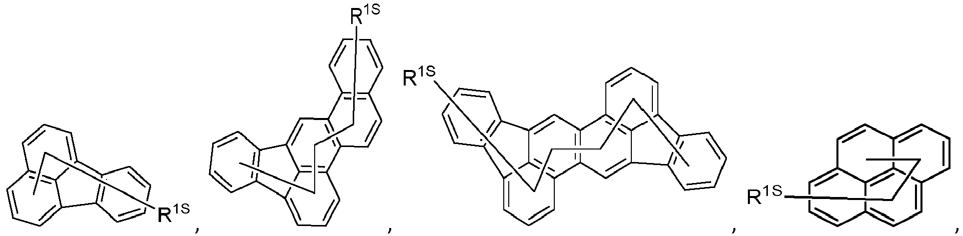 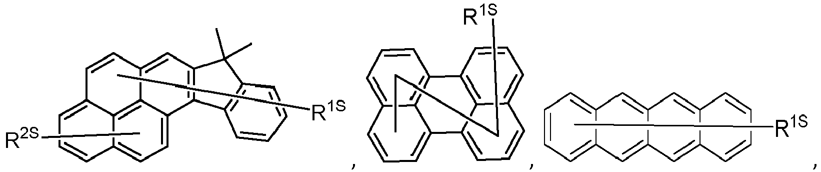 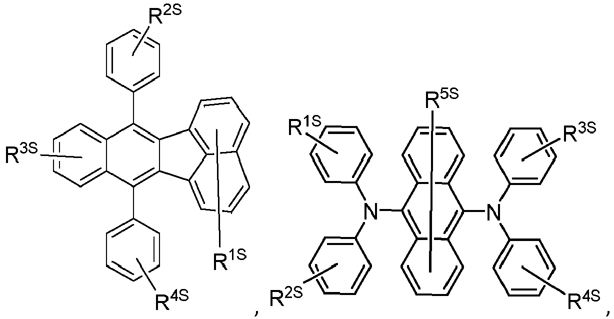 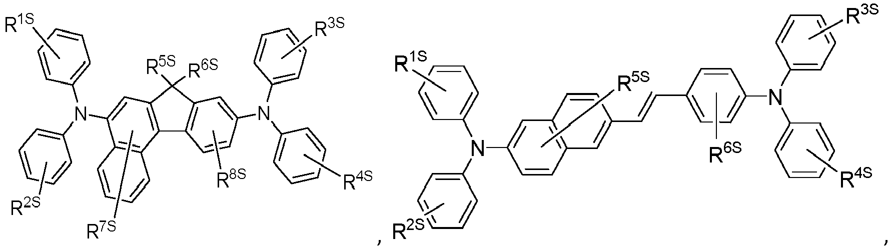 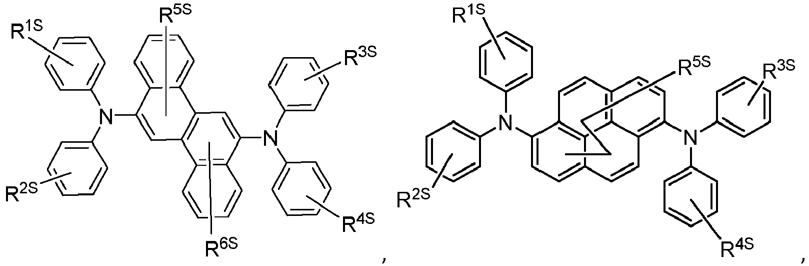 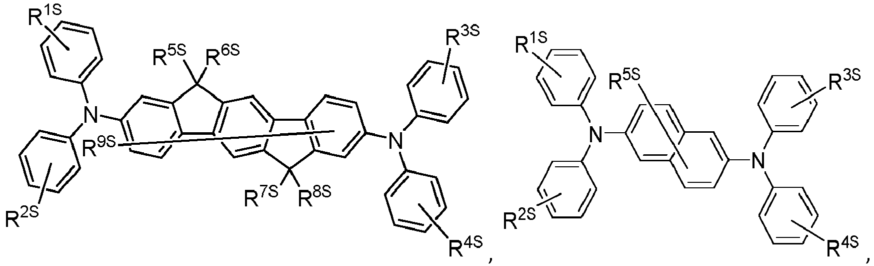 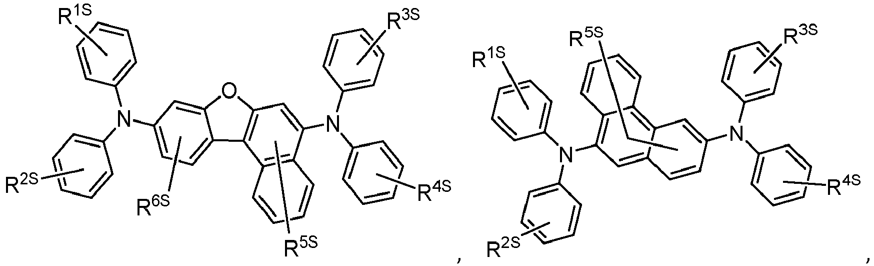 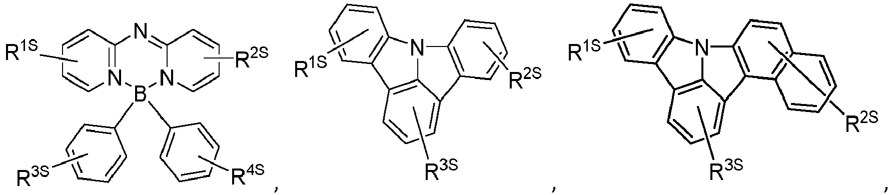 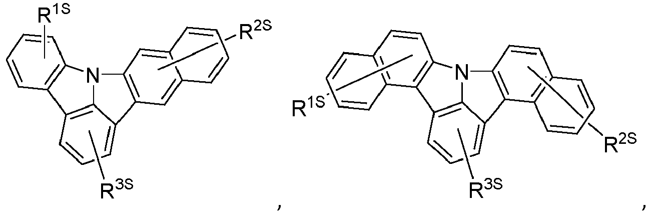 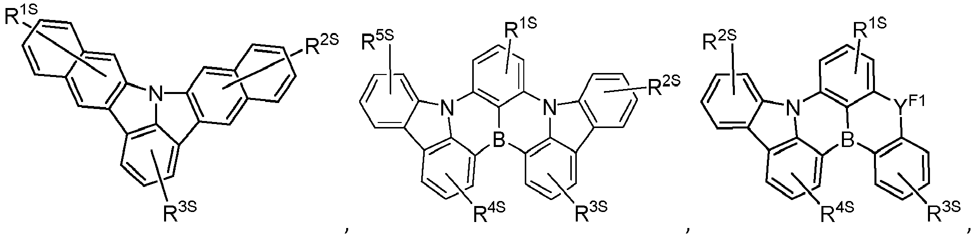 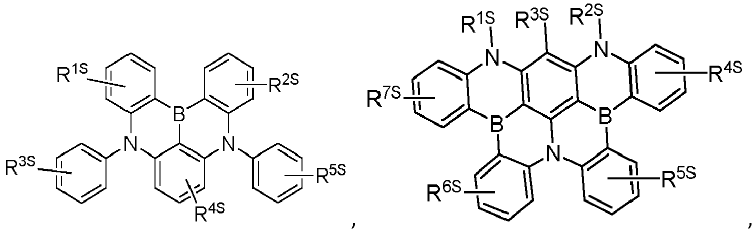 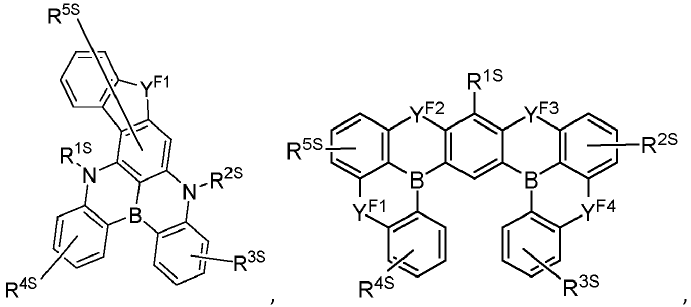 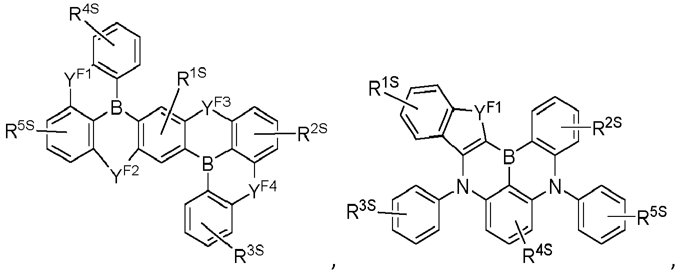 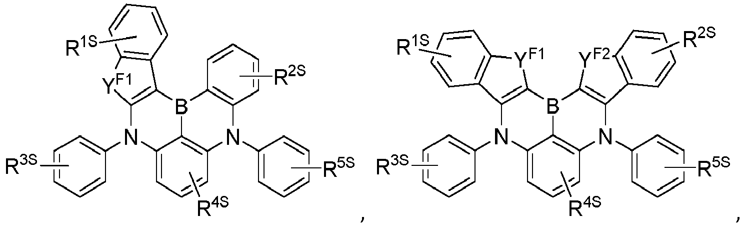 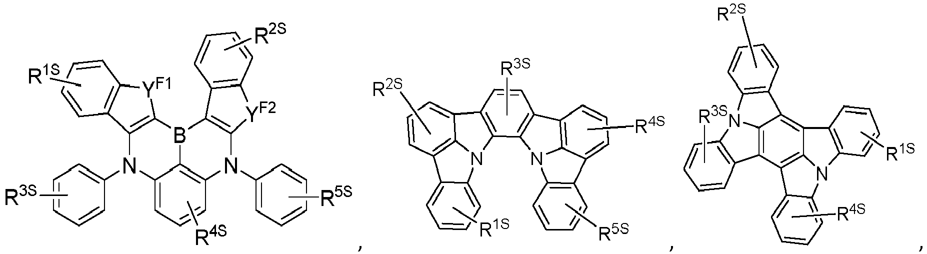 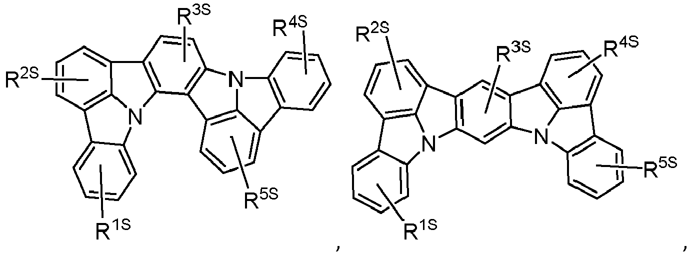 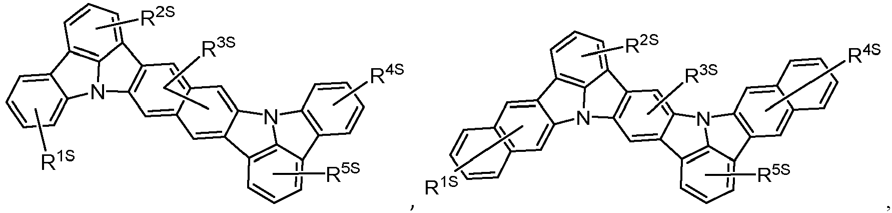 and 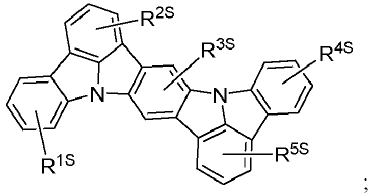
wherein Y^{F1} to Y^{F4} are each independently selected from O, S, and NR^{F1};
wherein R^{F1} and R¹ to R⁹ each independently represents from mono to maximum possible number of substitutions, or no substitution; and
wherein R^{F1} and R¹ to R⁹ are each independently a hydrogen or a substituent selected from the group consisting of deuterium, halogen, alkyl, cycloalkyl, heteroalkyl, heterocycloalkyl, boryl, arylalkyl, alkoxy, aryloxy, amino, silyl, germyl, alkenyl, cycloalkenyl, heteroalkenyl, alkynyl, aryl, heteroaryl, acyl, carboxylic acid, ether, ester, nitrile, isonitrile, sulfanyl, sulfinyl, sulfonyl, phosphino, selenyl, and combinations thereof.

10. The OLED of any one of the previous claims, wherein the second compound is selected from the group consisting of: 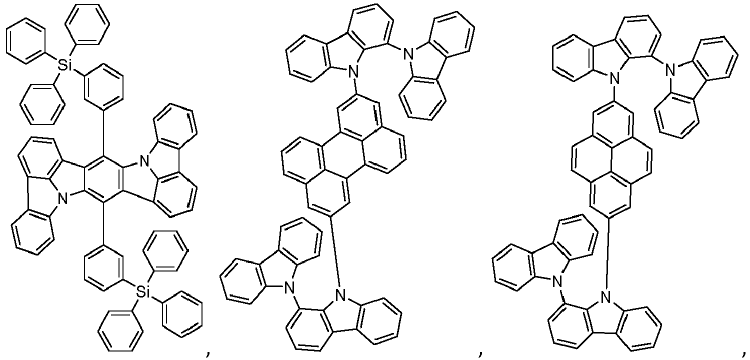 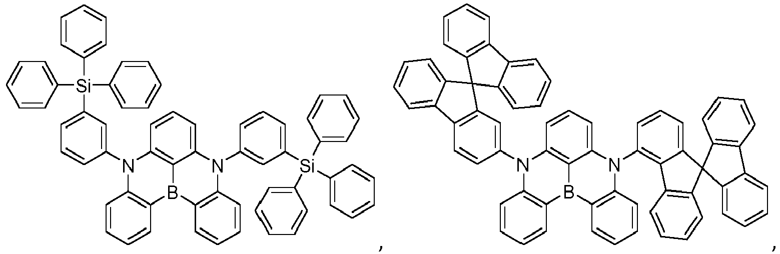 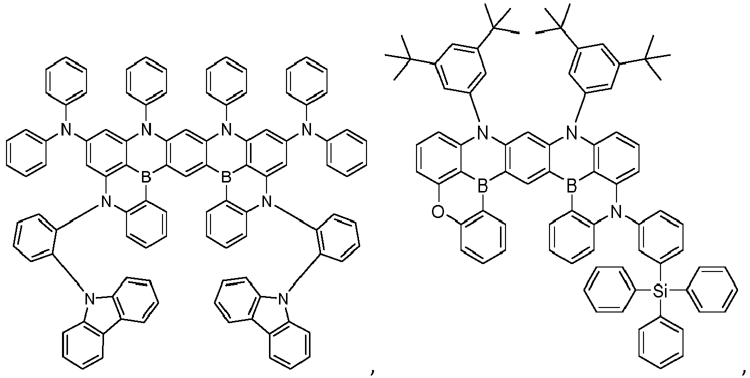 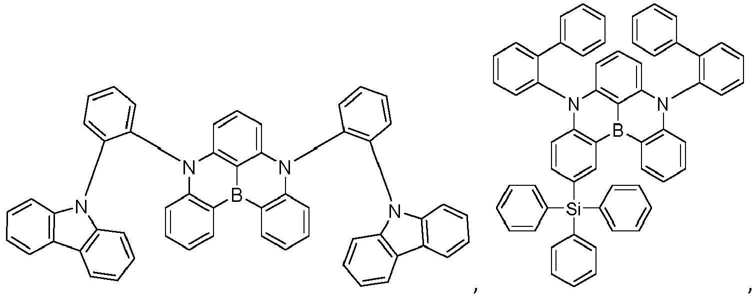 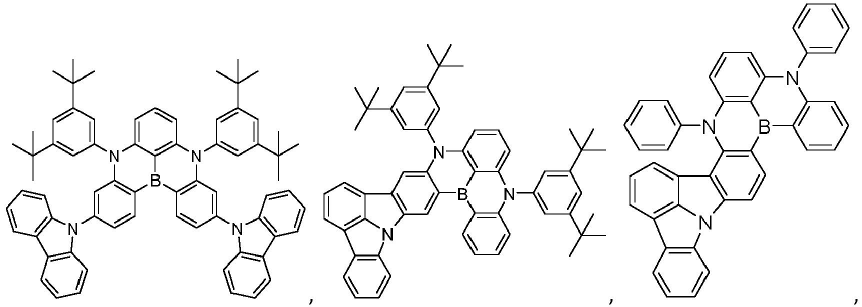 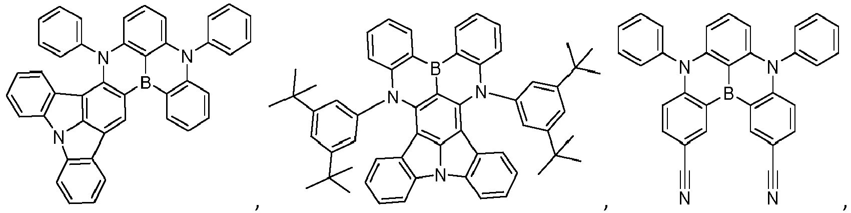 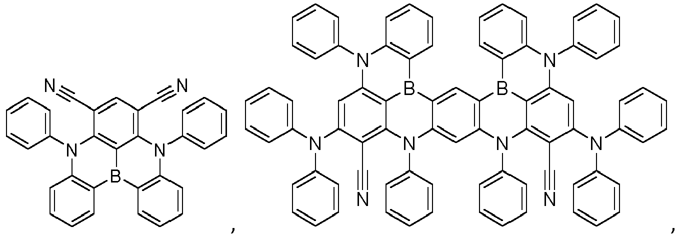 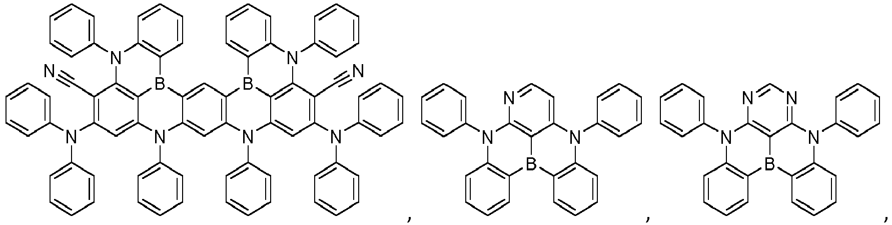 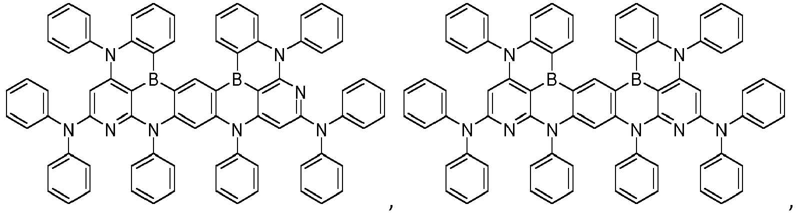 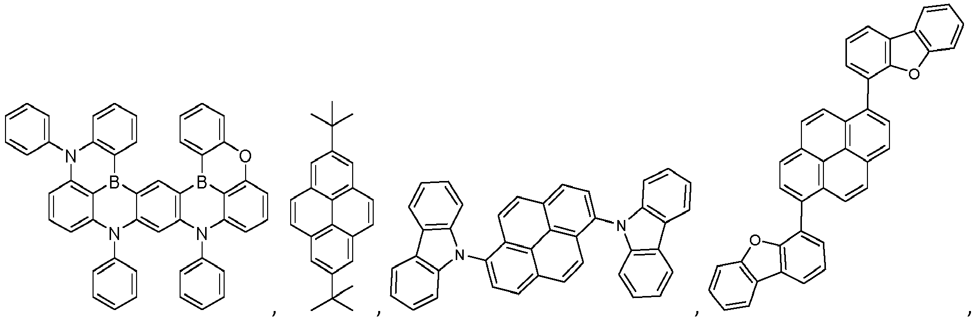 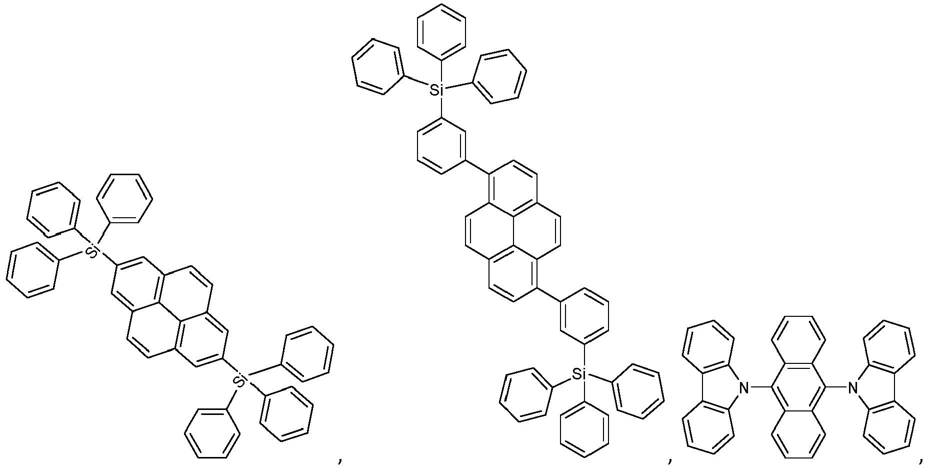 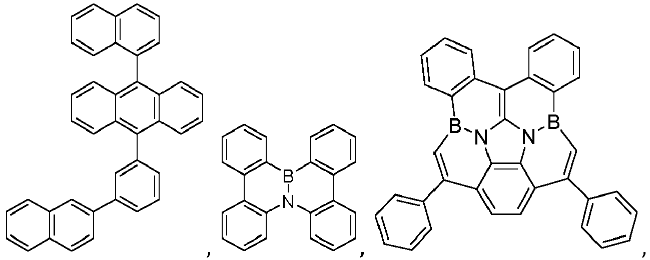 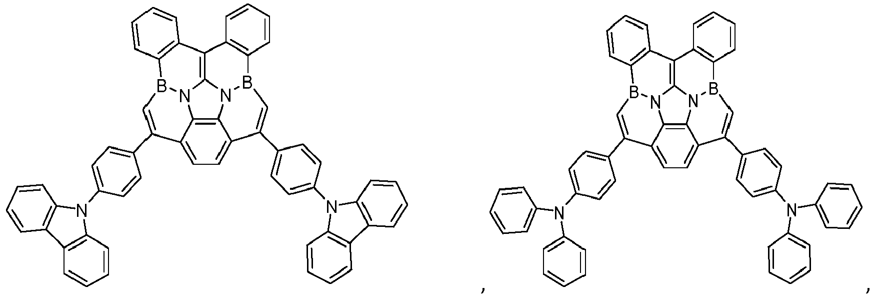 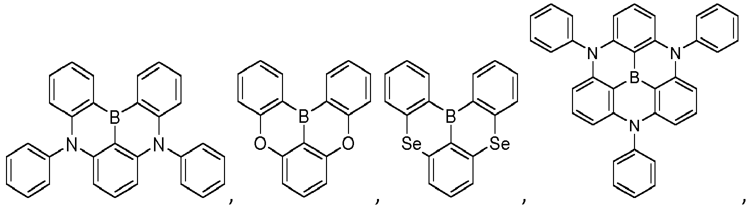 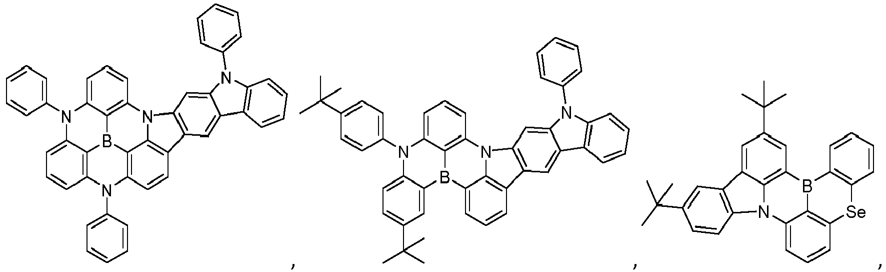 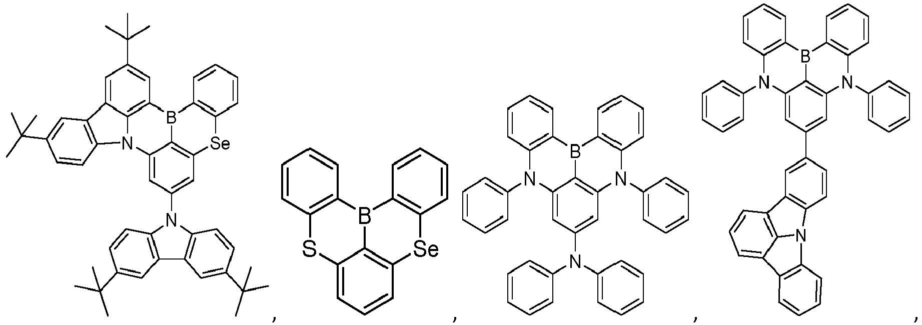 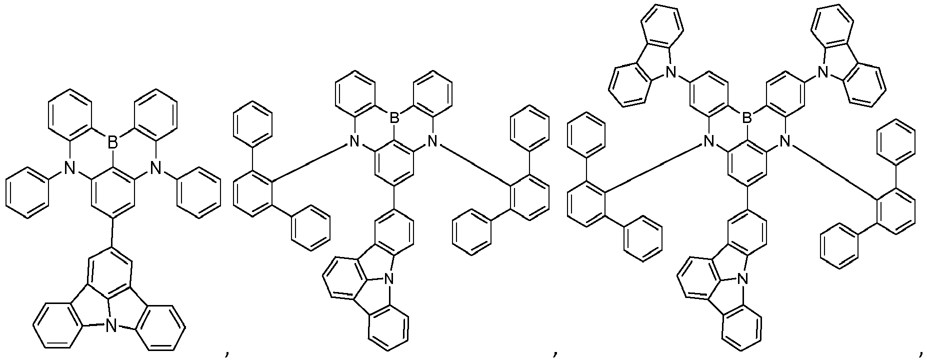 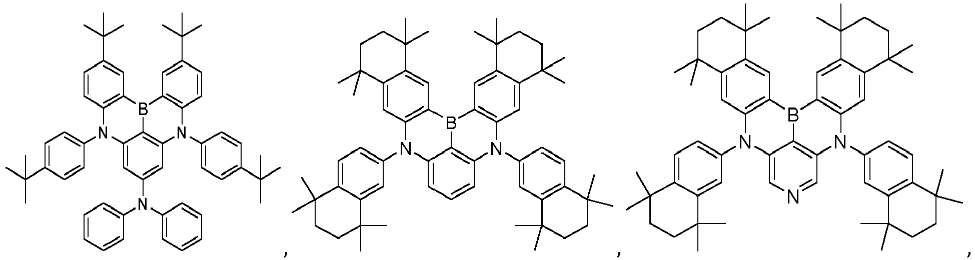 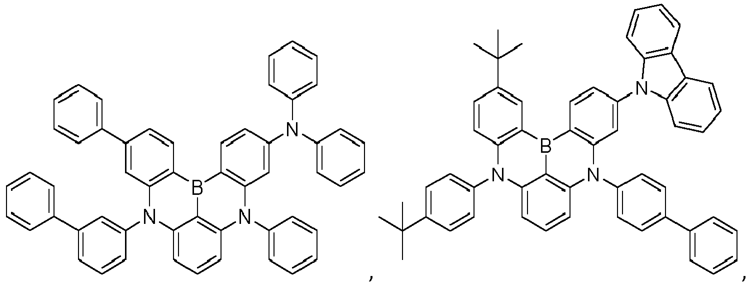 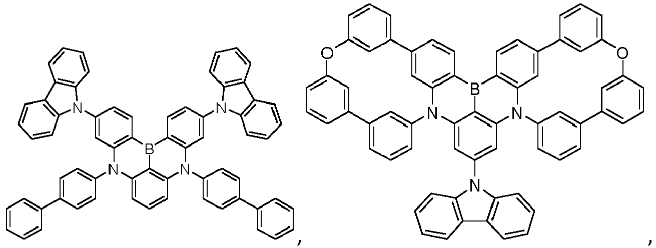 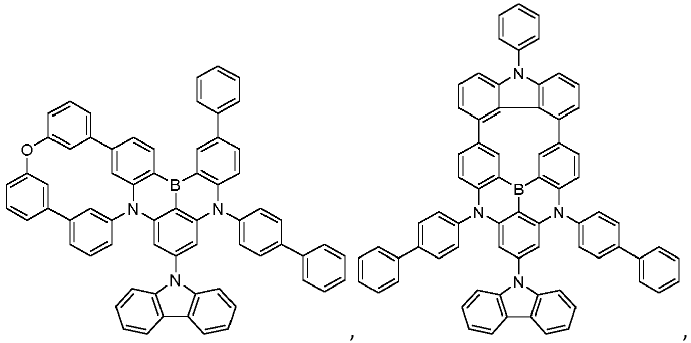 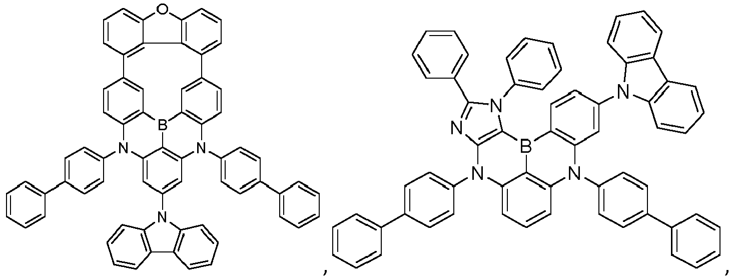 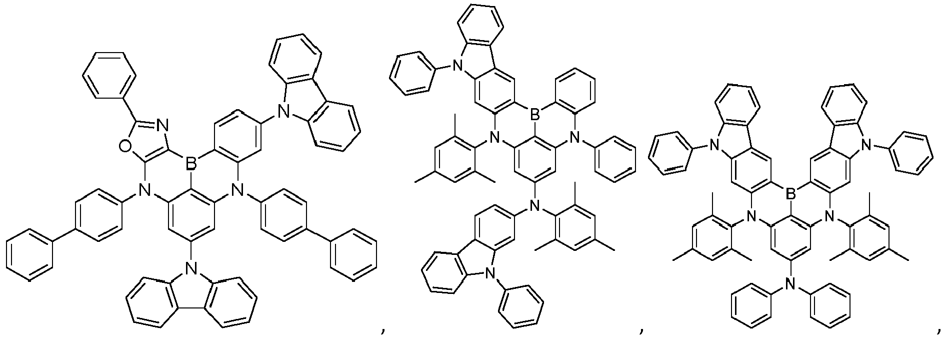 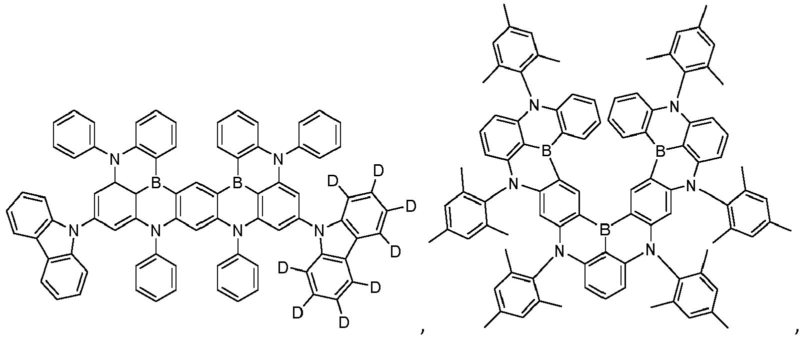 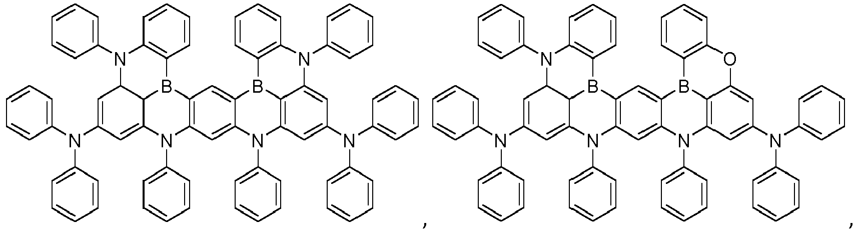 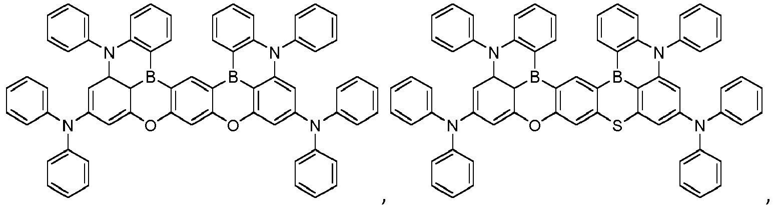 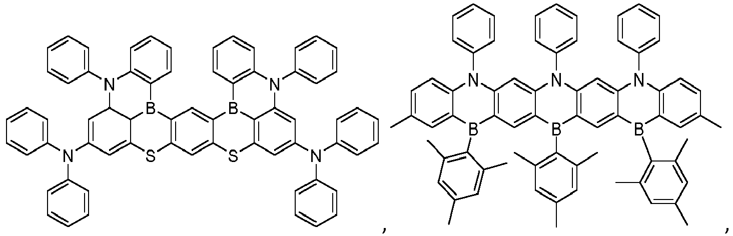 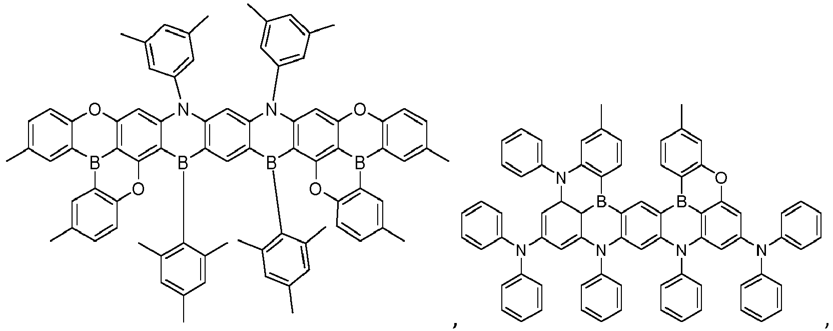 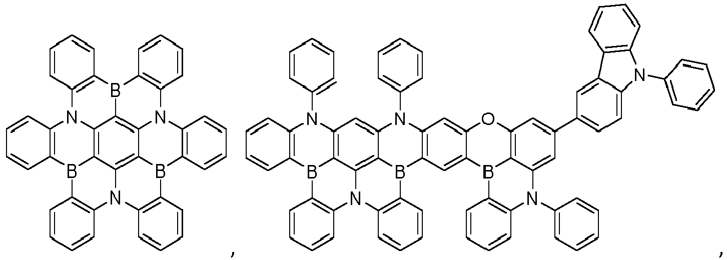 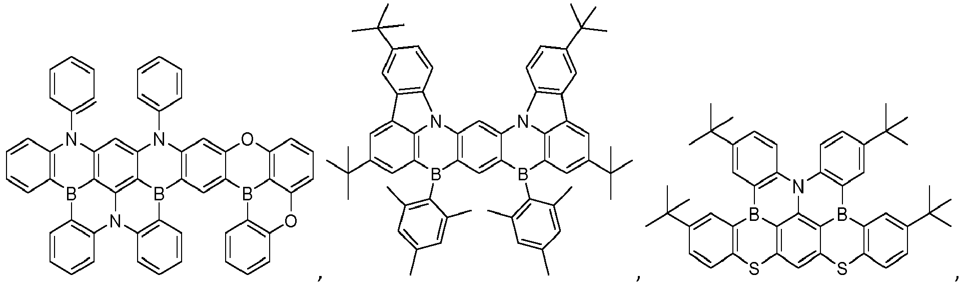 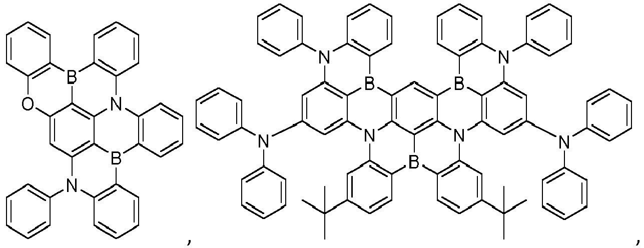 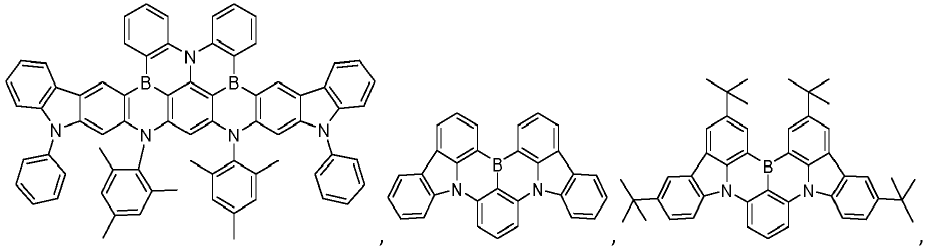 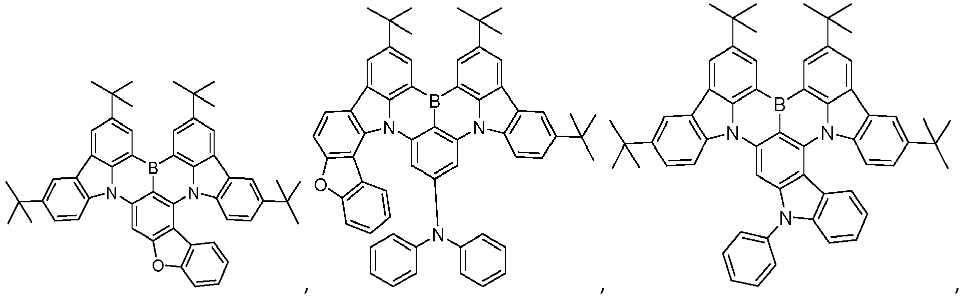 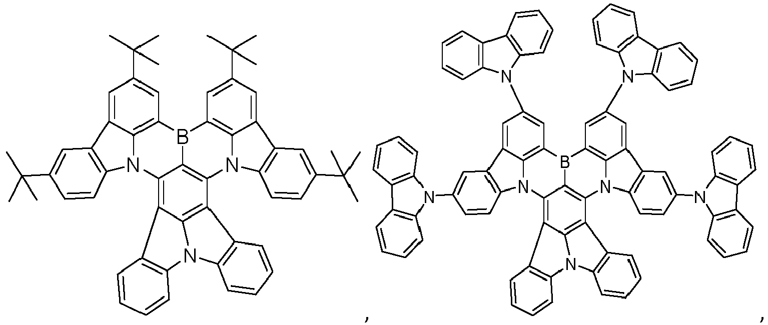 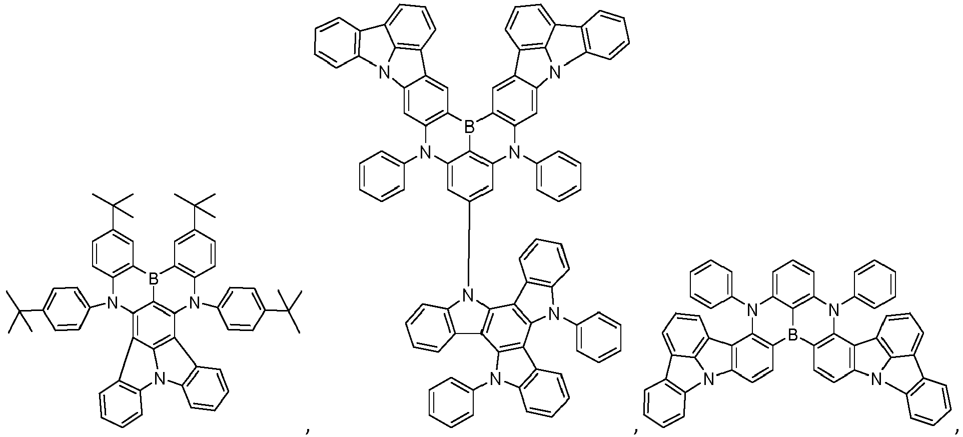 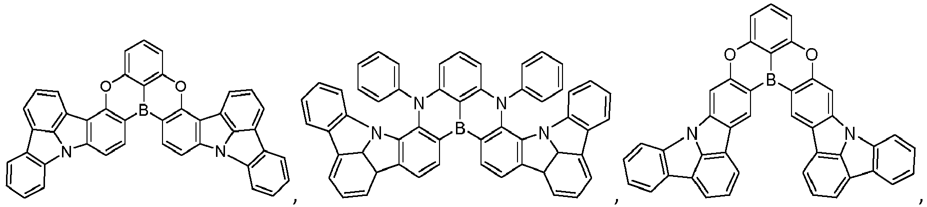 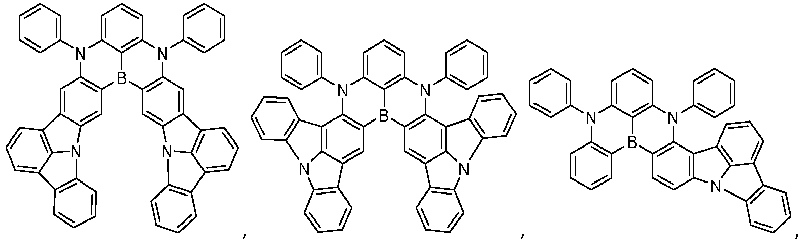 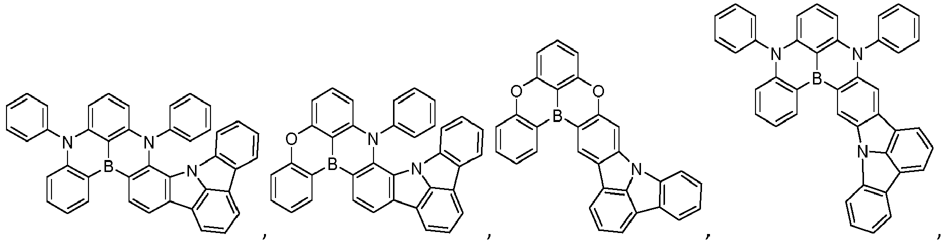 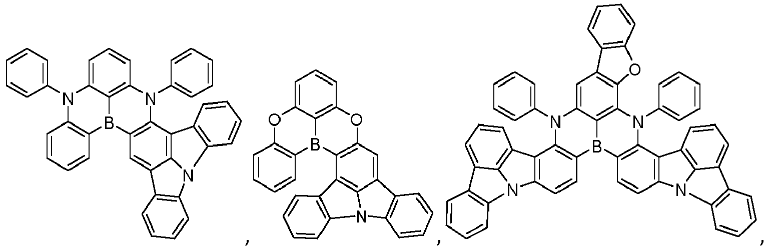 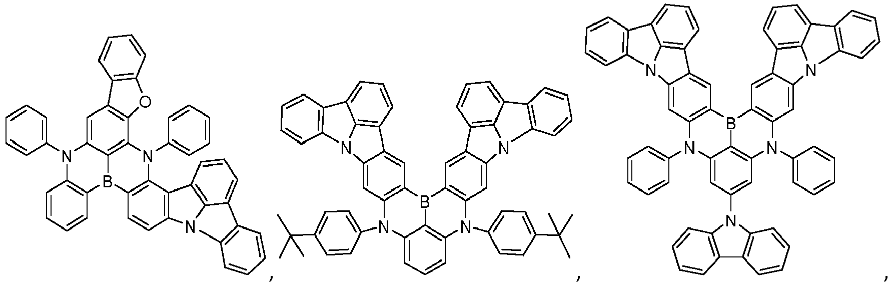 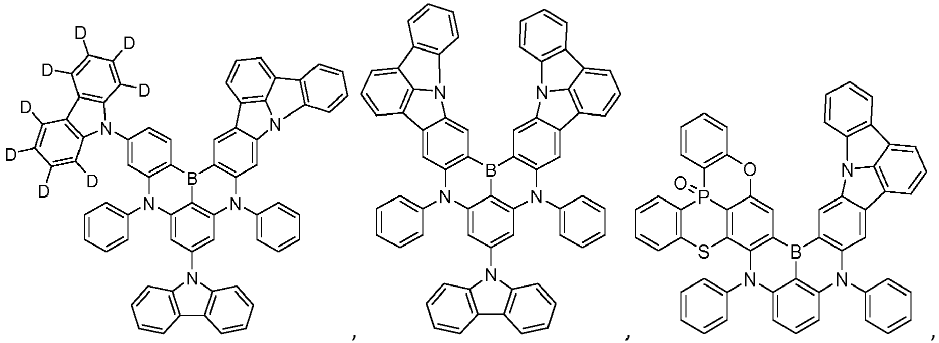 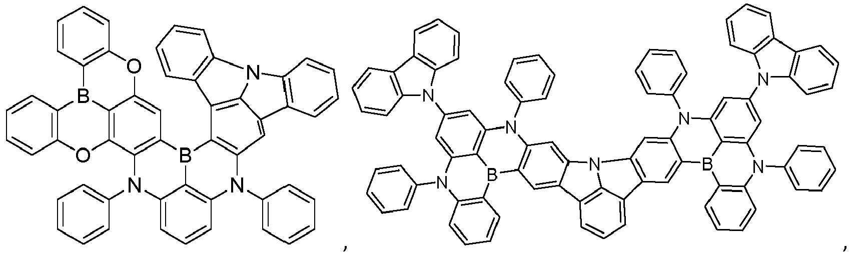 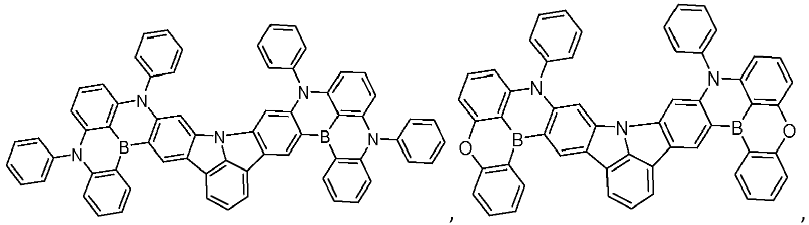 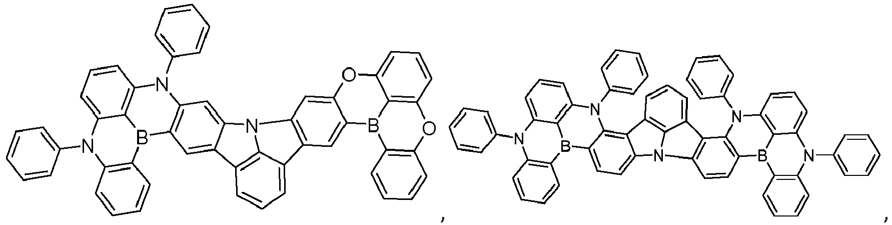 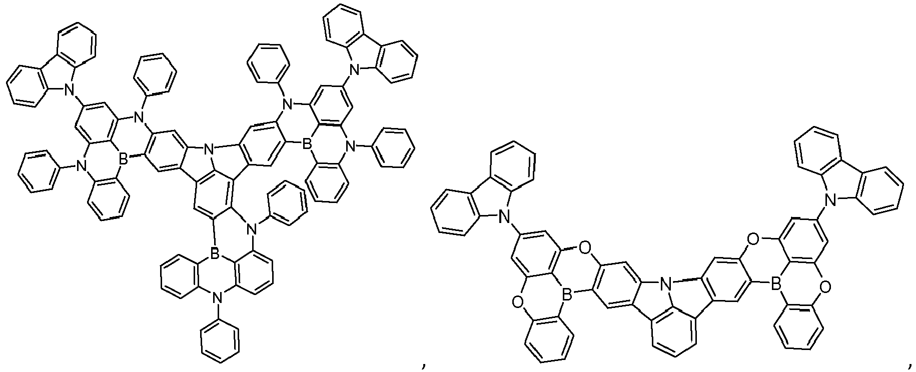 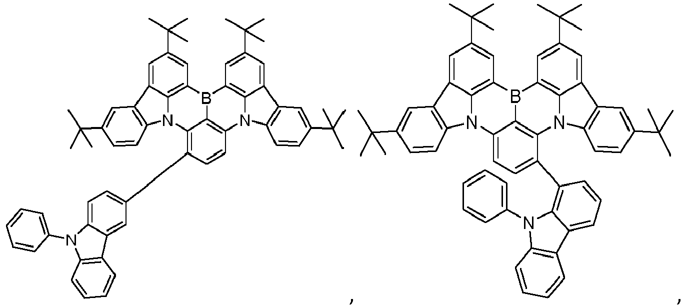 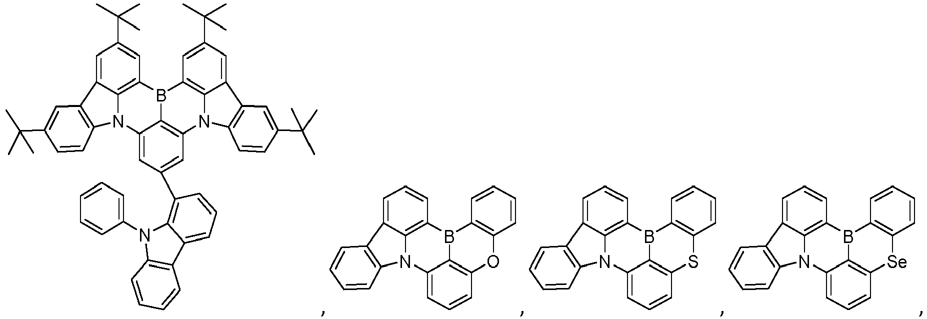 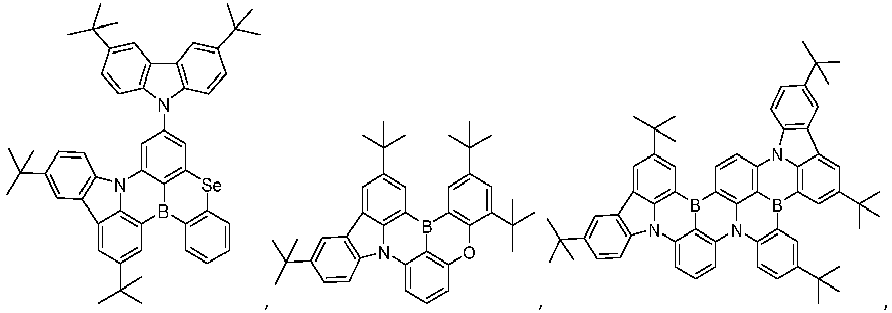 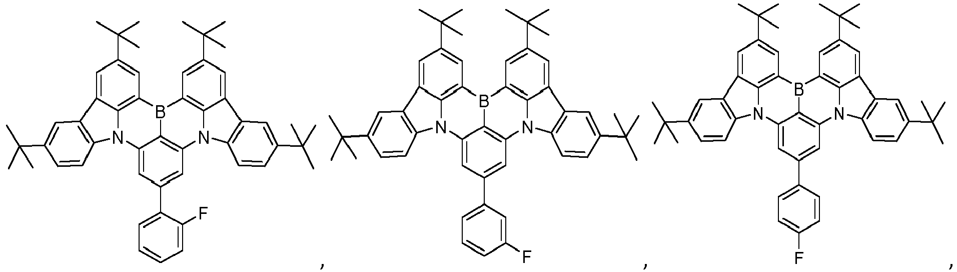 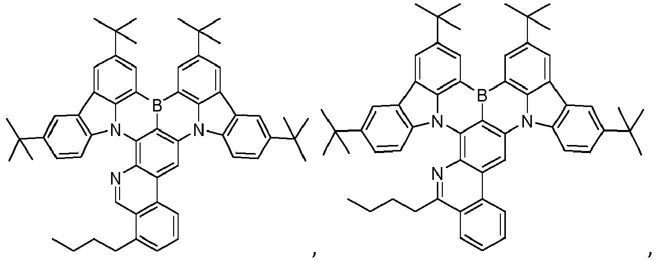 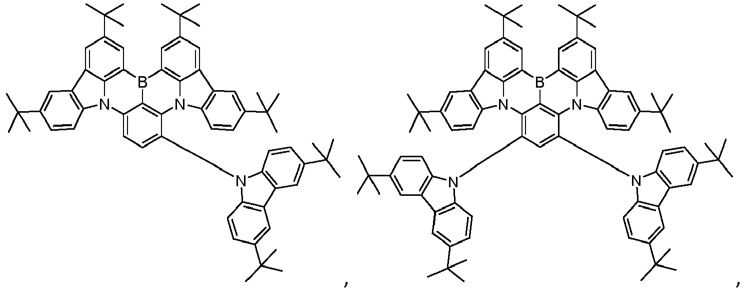 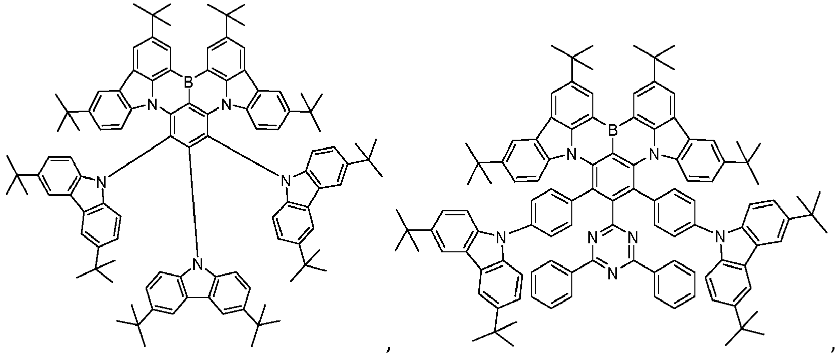 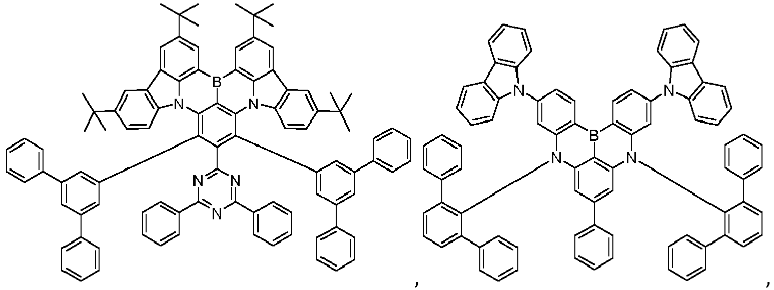 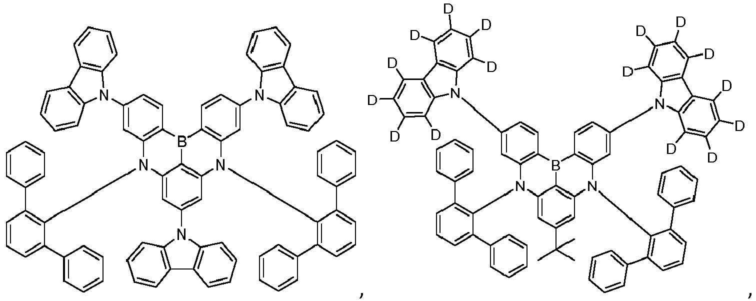 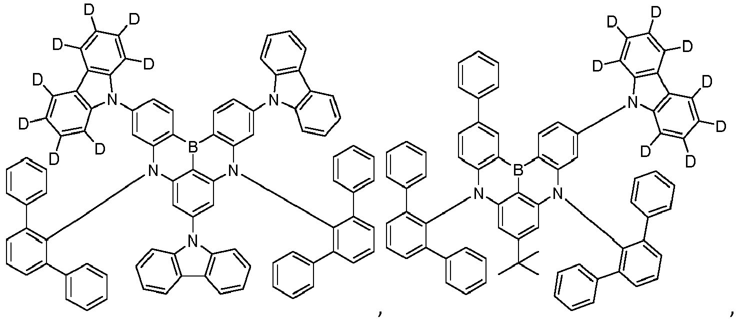 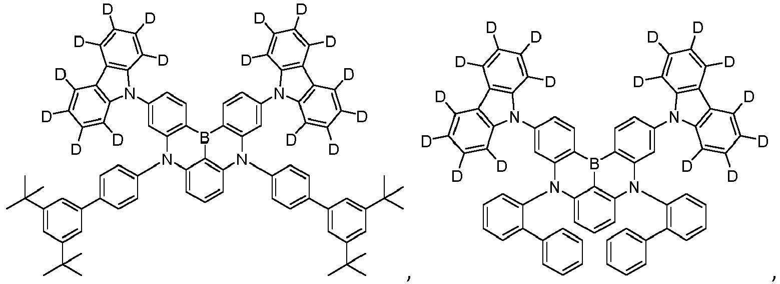 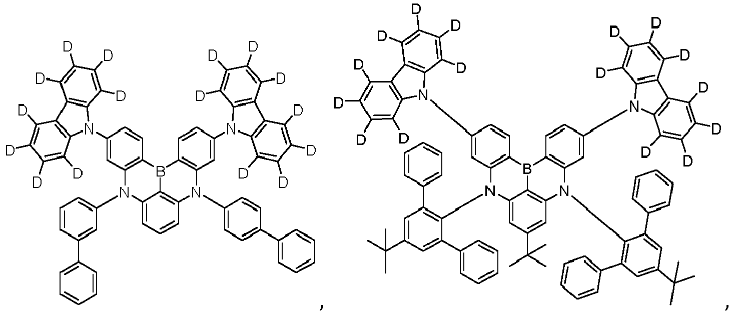 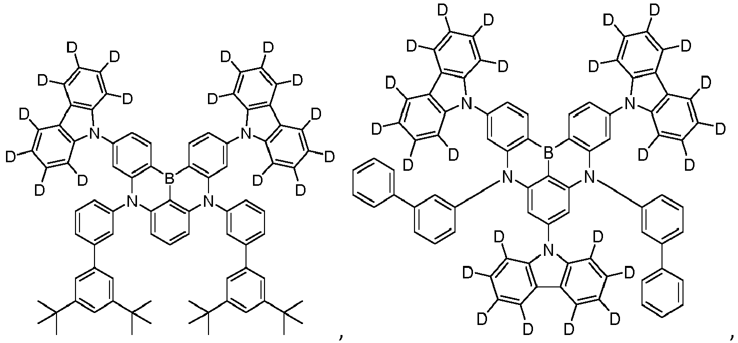 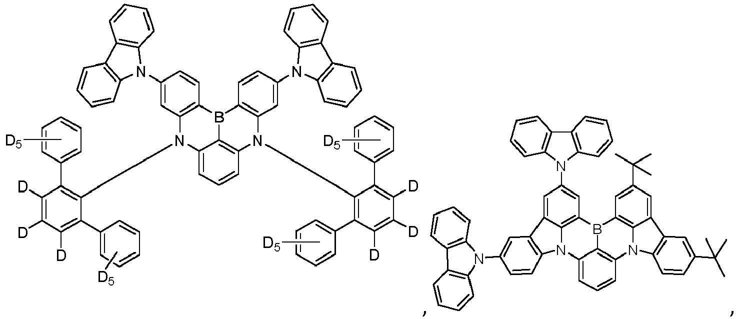 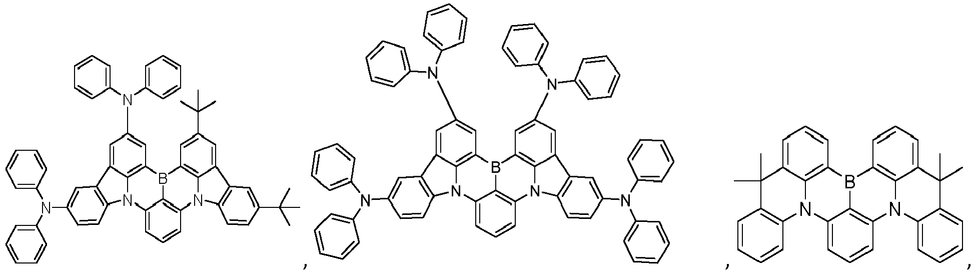 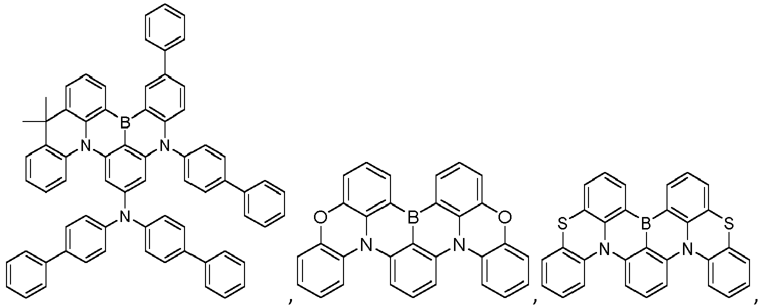 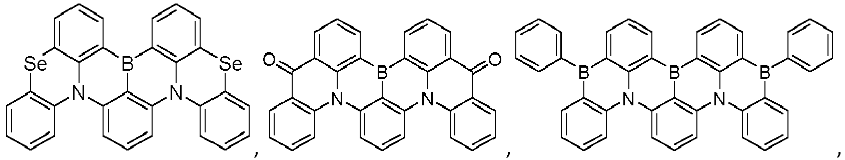 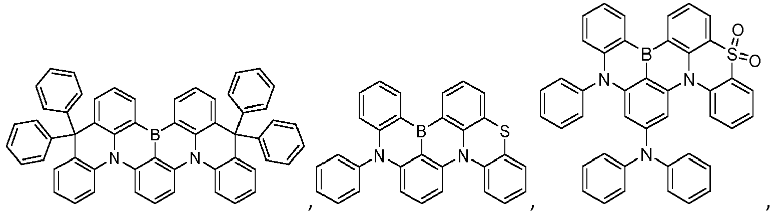 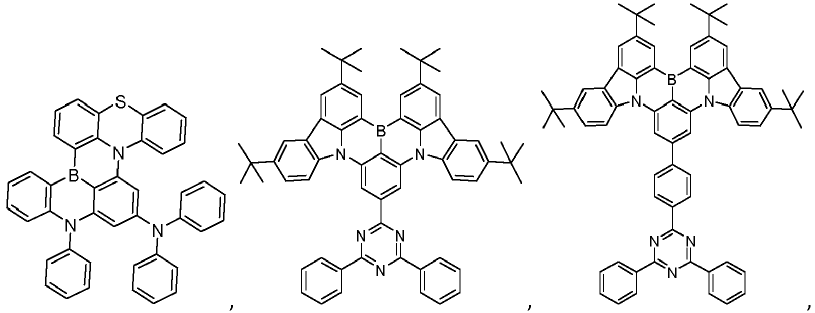 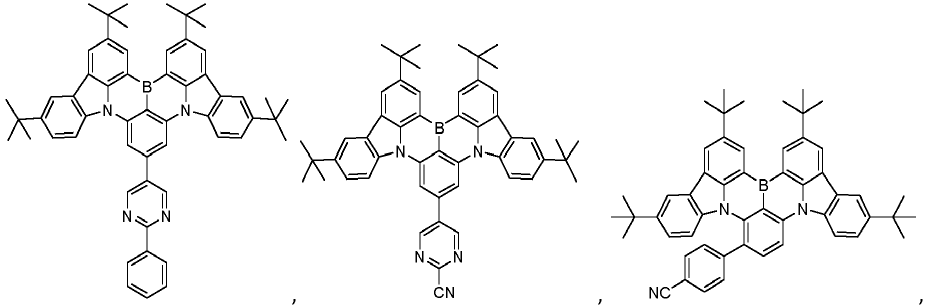 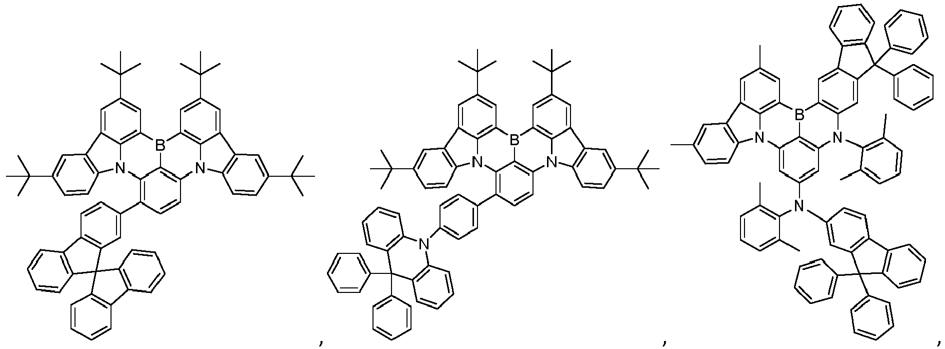 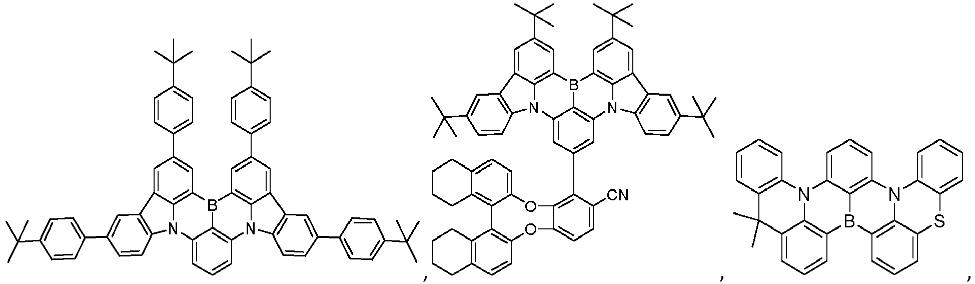 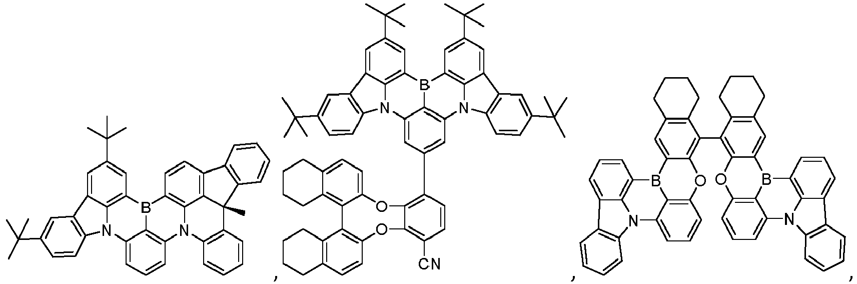 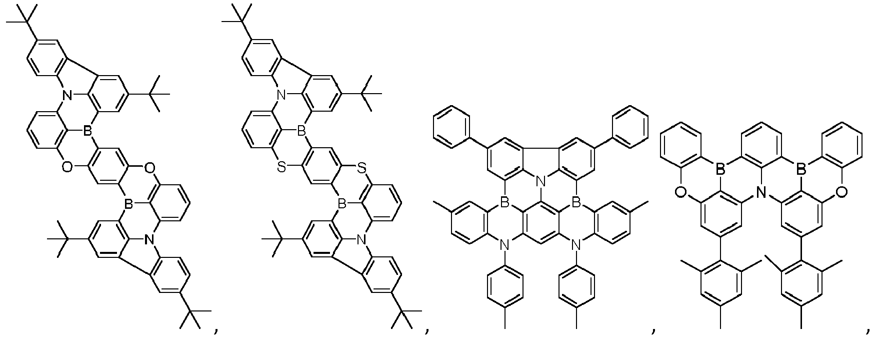 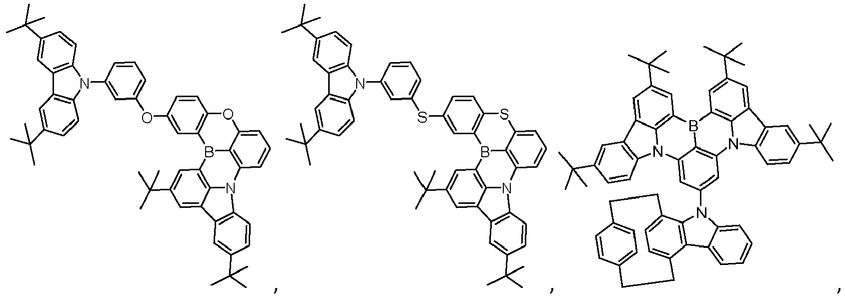 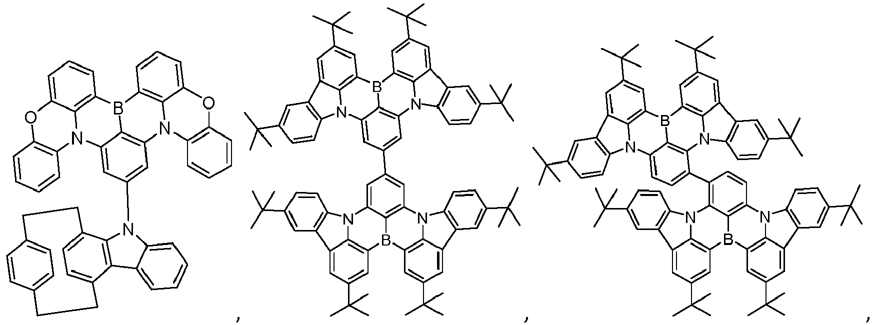 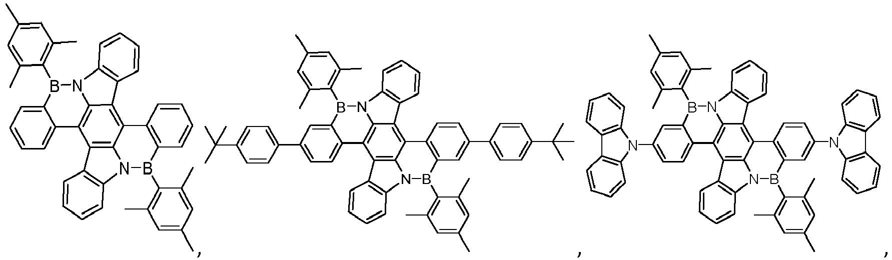 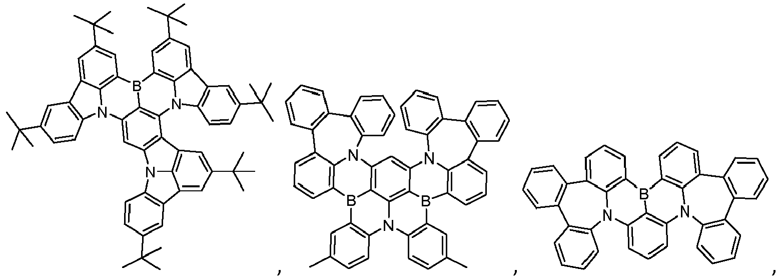 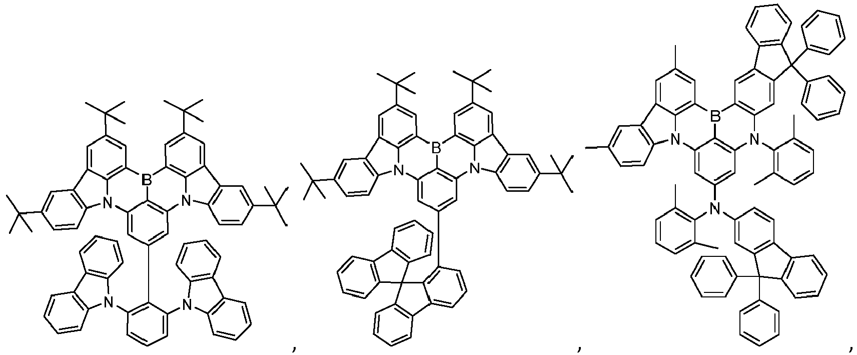 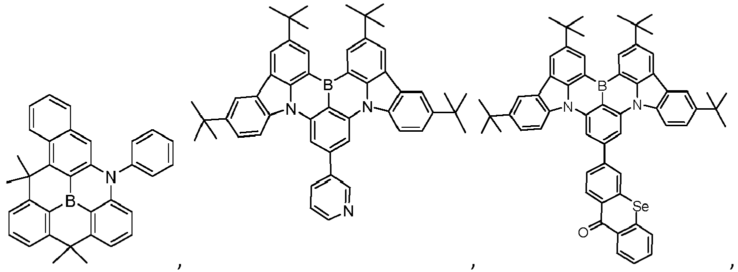 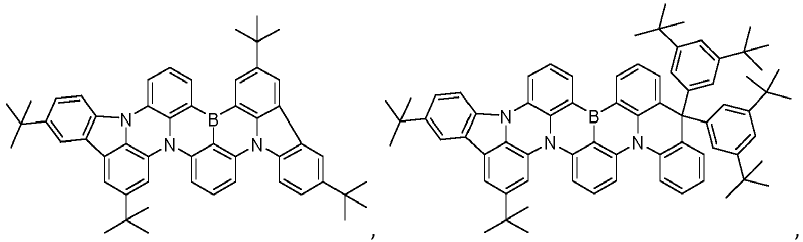 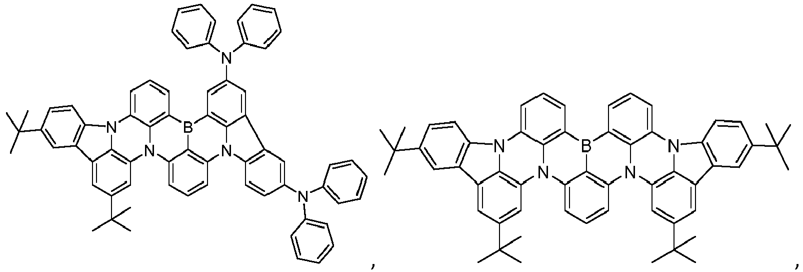 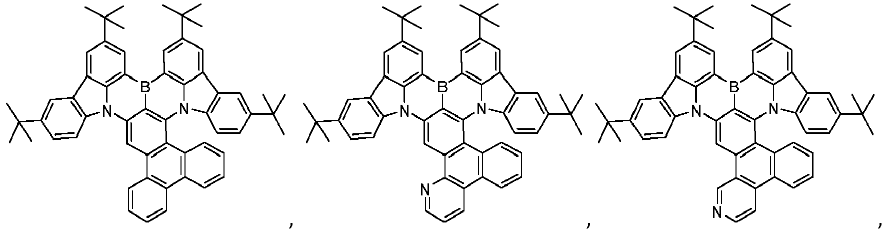 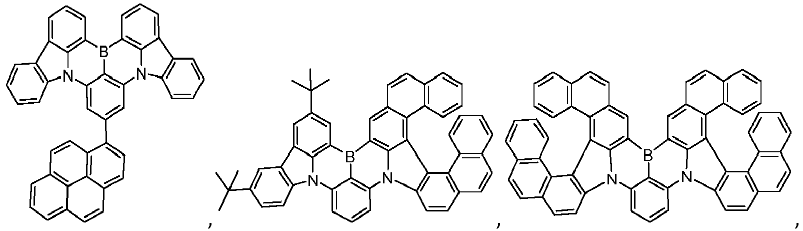 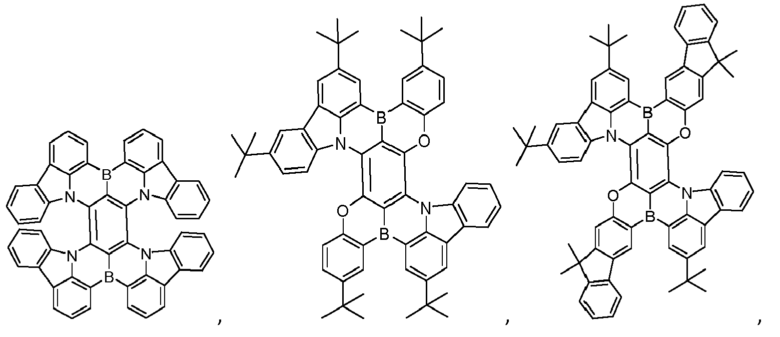 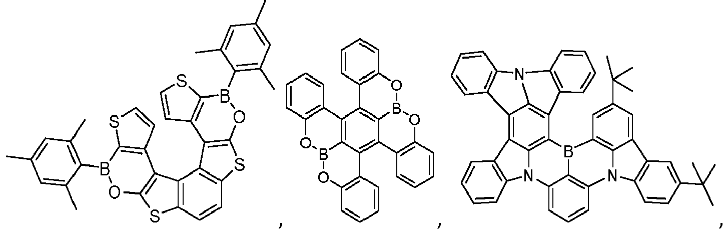 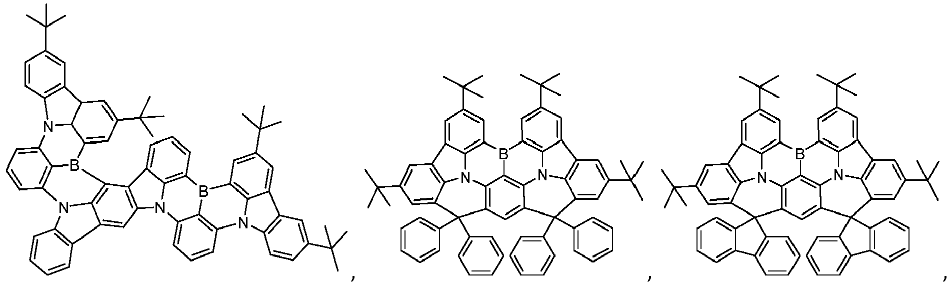 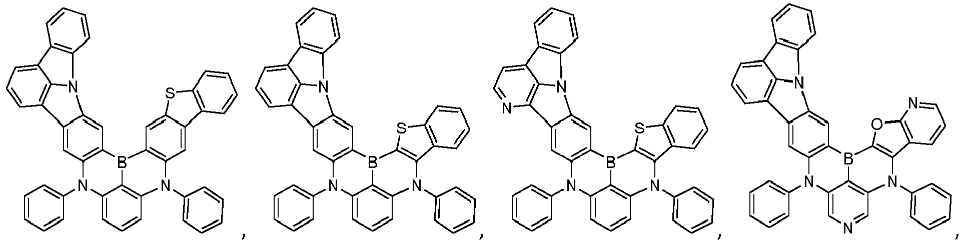 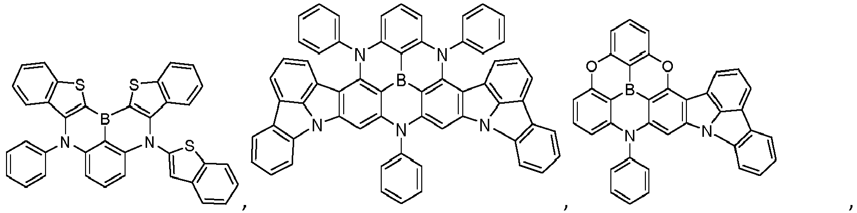 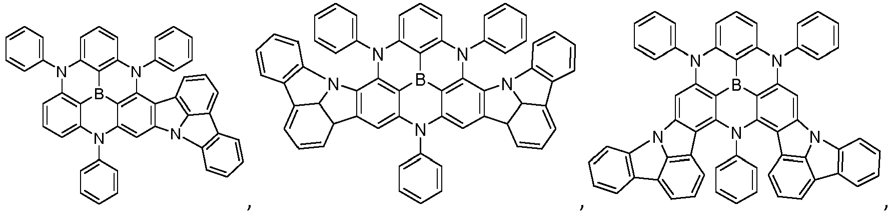 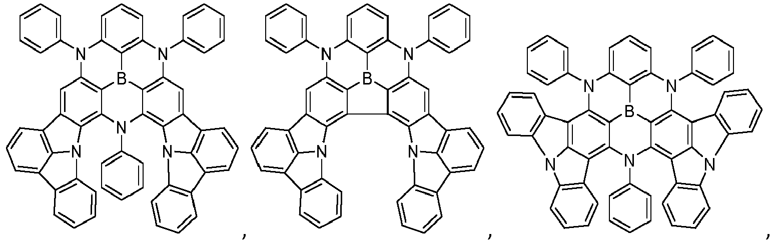 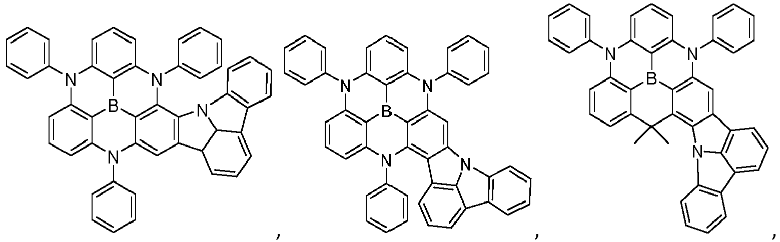 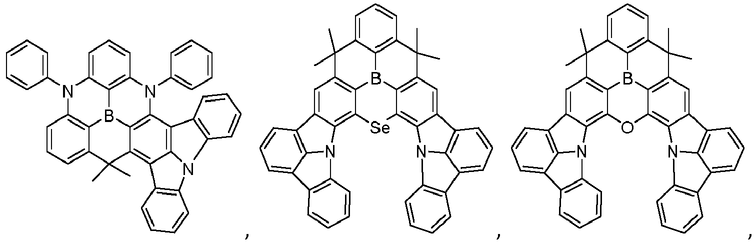 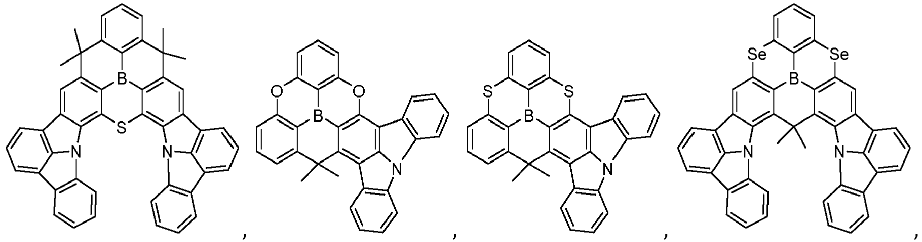 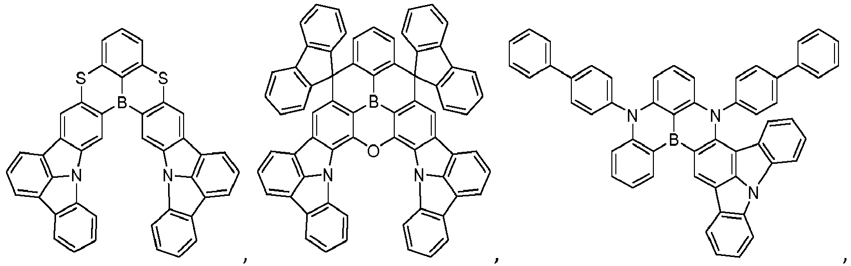 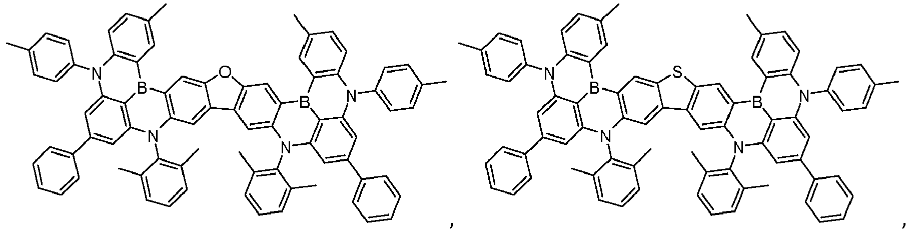 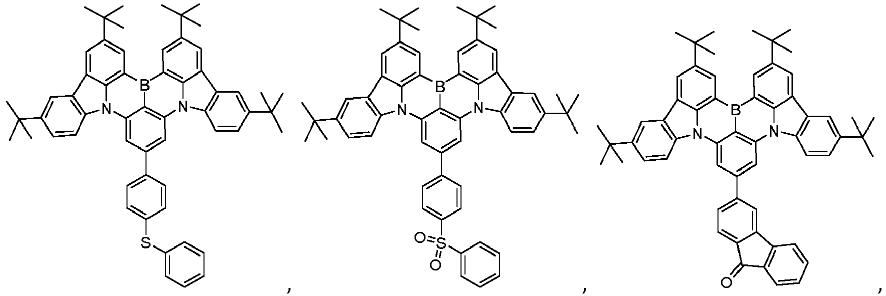 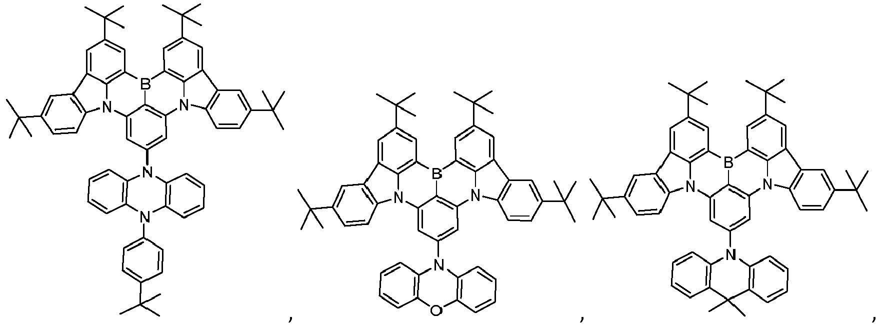 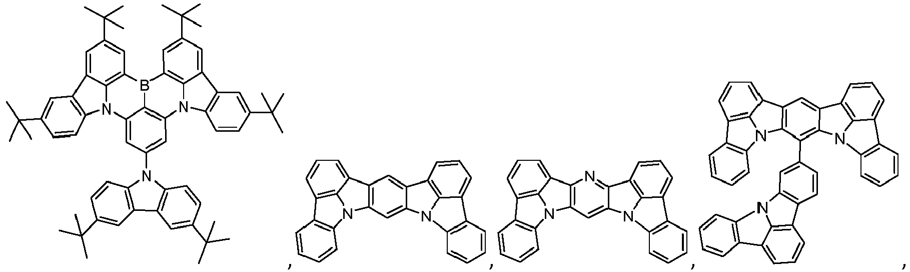 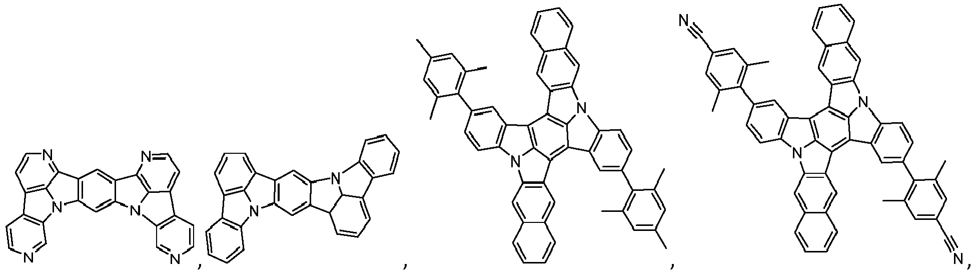 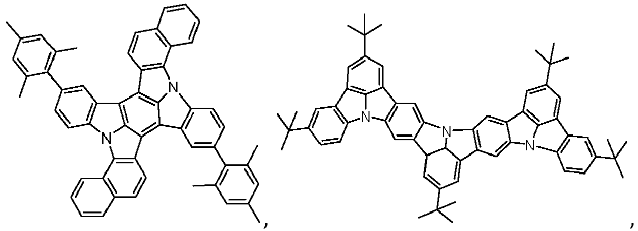 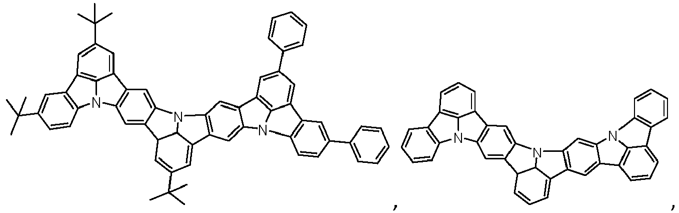 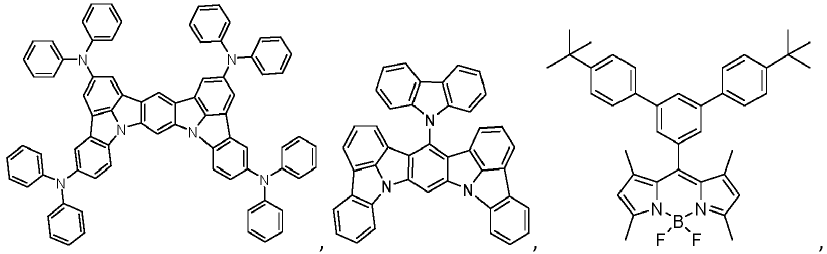 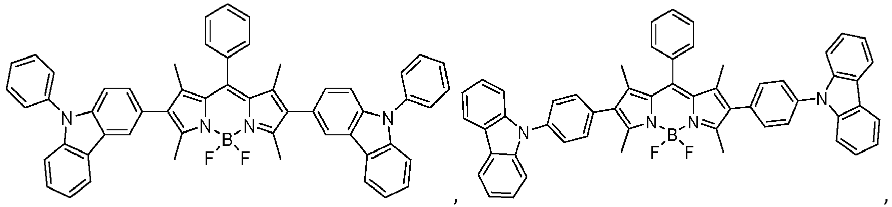 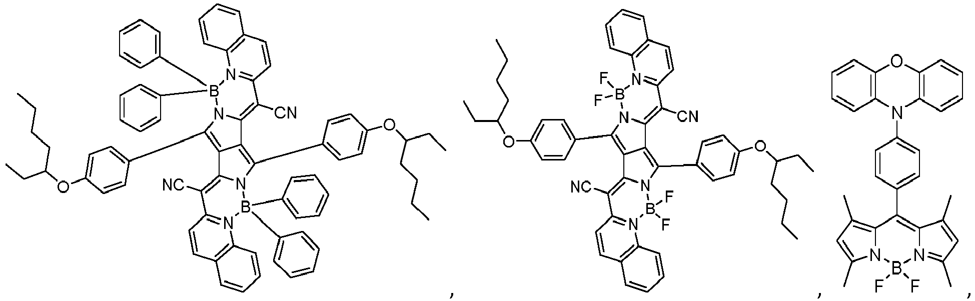 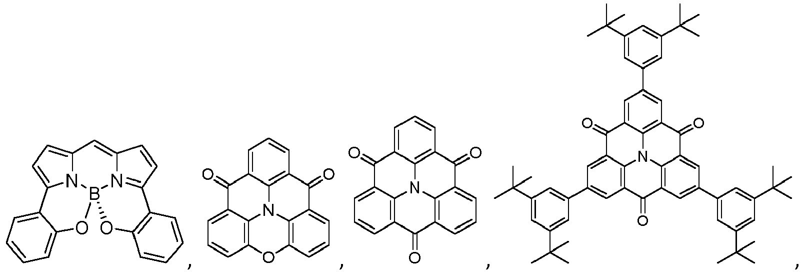 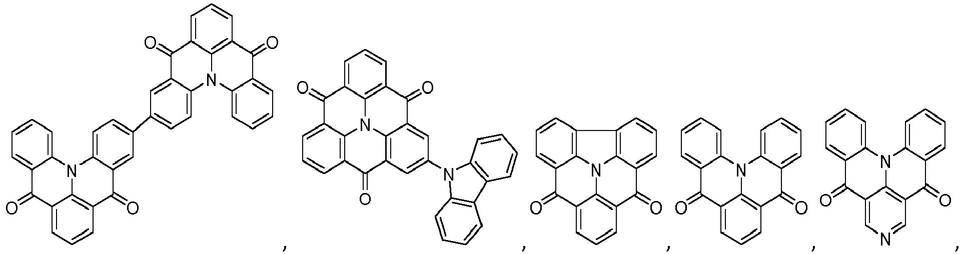 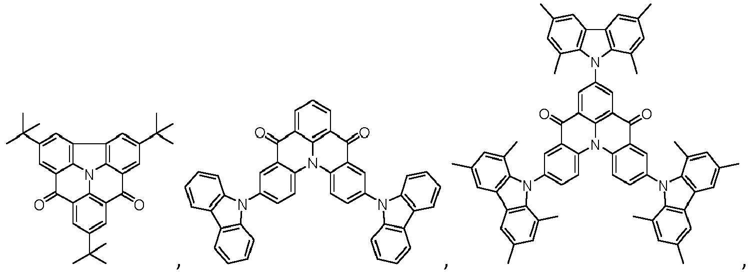 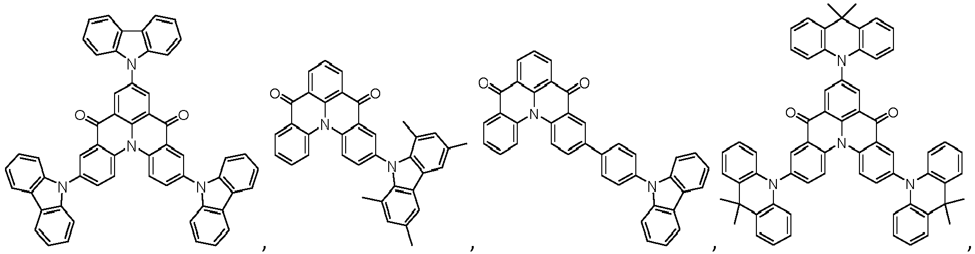 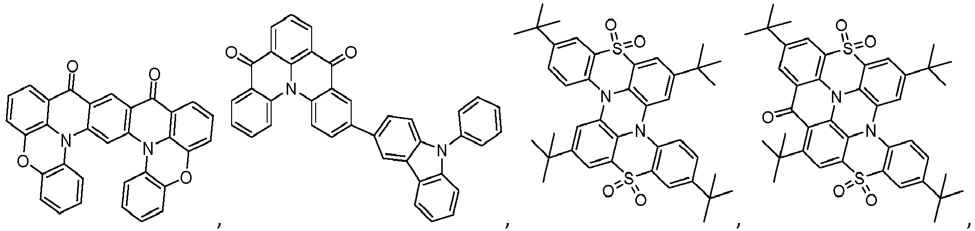 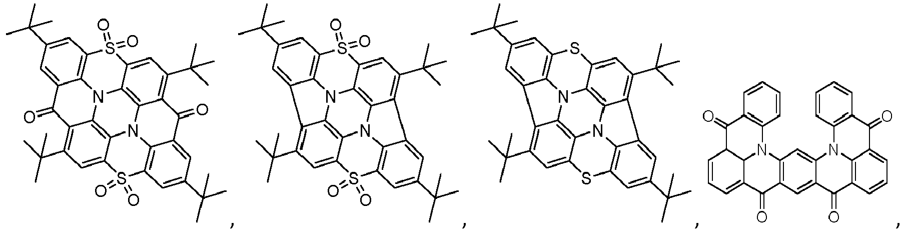 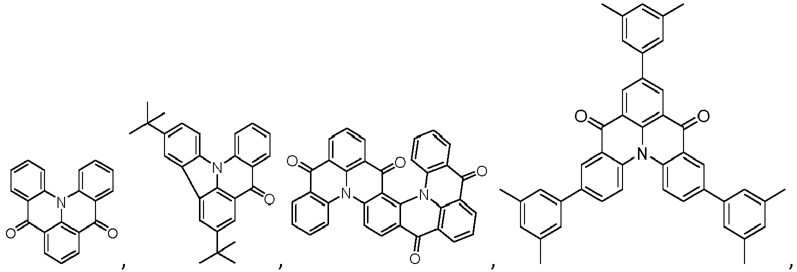 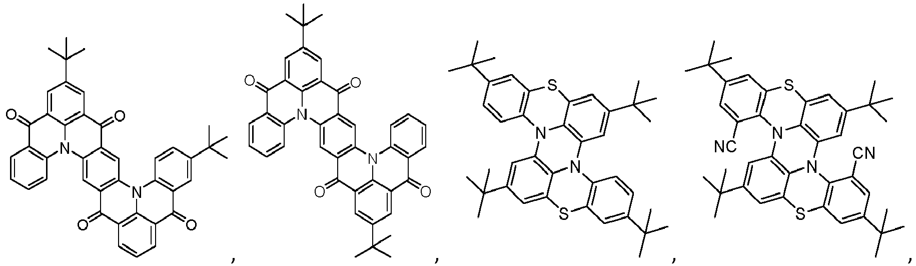 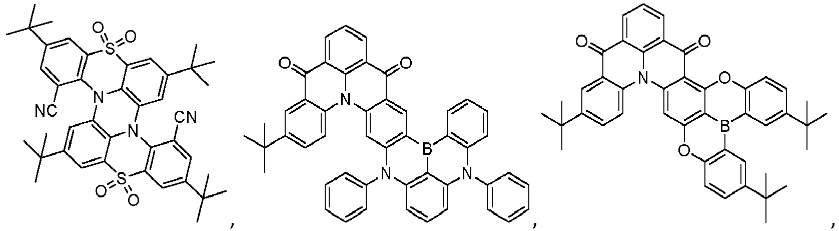 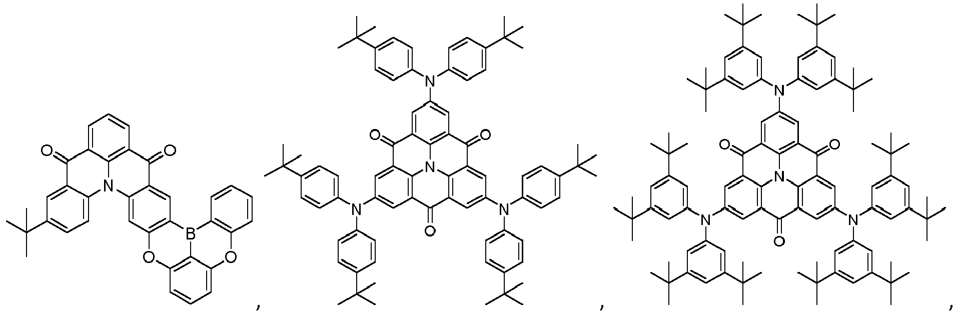 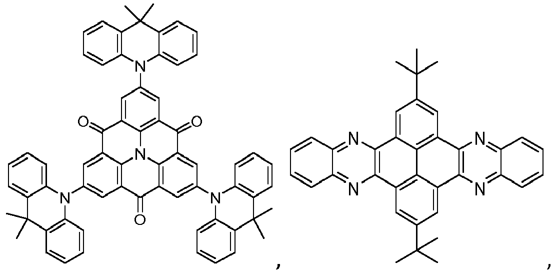 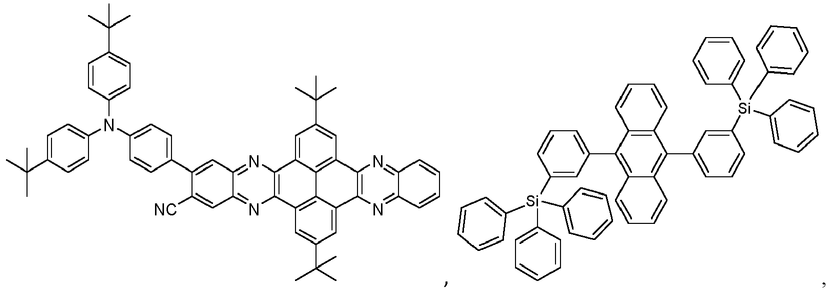 aza-substituted variants thereof, fully or partially deuterated variants thereof, and combinations thereof.

11. The OLED of any one of the previous claims, wherein the HOMO level of the second compound is deeper than at least one selected from the first compound and the third compound.

12. The OLED of any one of the previous claims, wherein the emissive region further comprises a second host; and/or wherein the third compound; and/or the second host comprises at least one chemical group selected from the group consisting of triphenylene, carbazole, indolocarbazole, dibenzothiophene, dibenzofuran, dibenzoselenophene, 5λ²-benzo[d]benzo[4,5]imidazo[3,2-a]imidazole, 5,9-dioxa-13b-boranaphtho[3,2,1-de]anthracene, triazine, boryl, silyl, aza-triphenylene, aza-carbazole, aza-indolocarbazole, aza-dibenzothiophene, aza-dibenzofuran, aza-dibenzoselenophene, aza-5λ²-benzo[d]benzo[4,5]imidazo[3,2-a]imidazole, and aza-(5,9-dioxa-13b-boranaphtho[3,2,1-de]anthracene).

13. The OLED of any one of the previous claims, wherein the third compound, and/or the second host is selected from the group consisting of 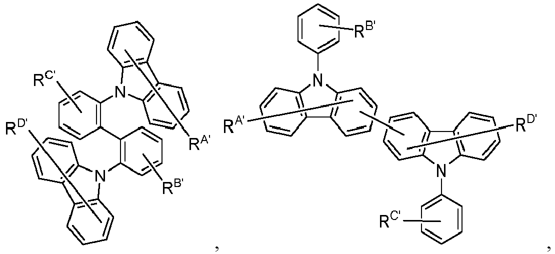 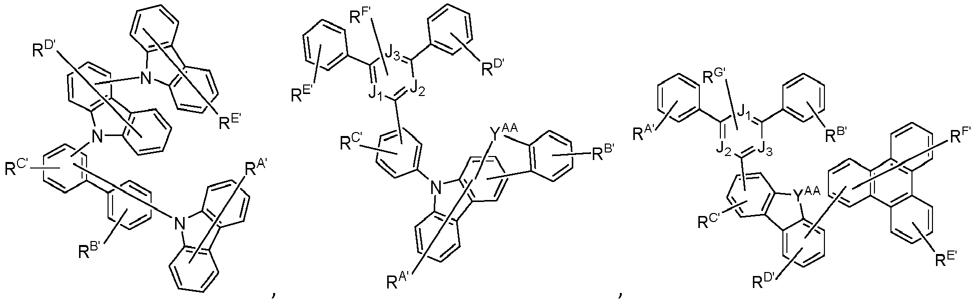 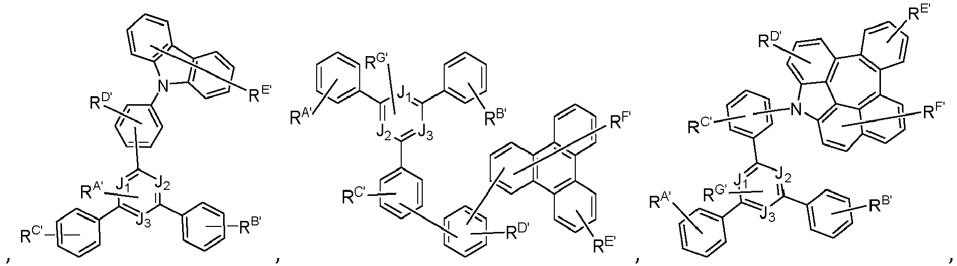 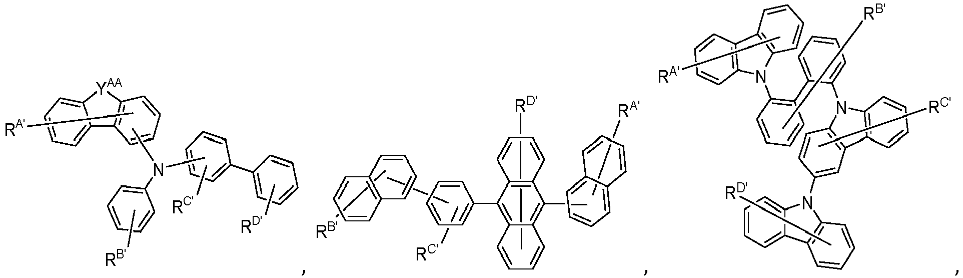 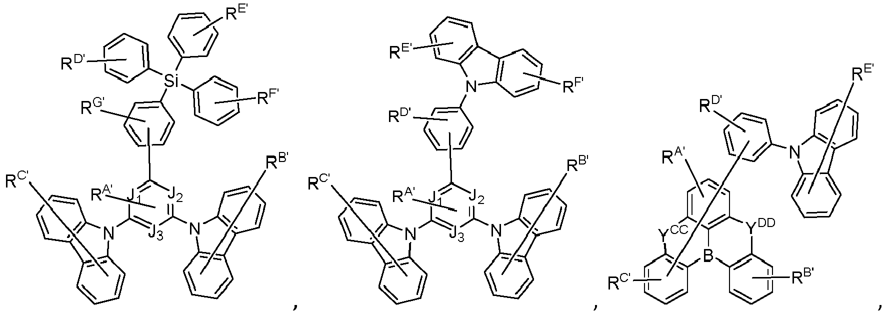 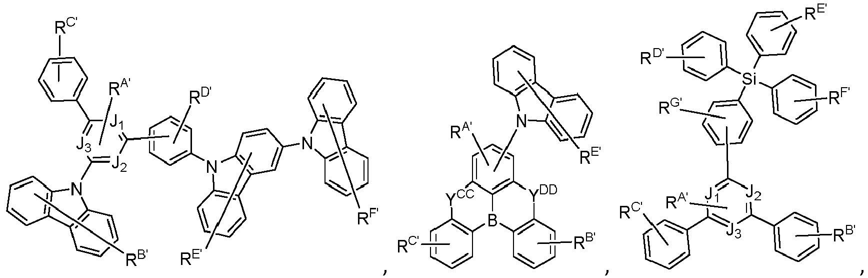 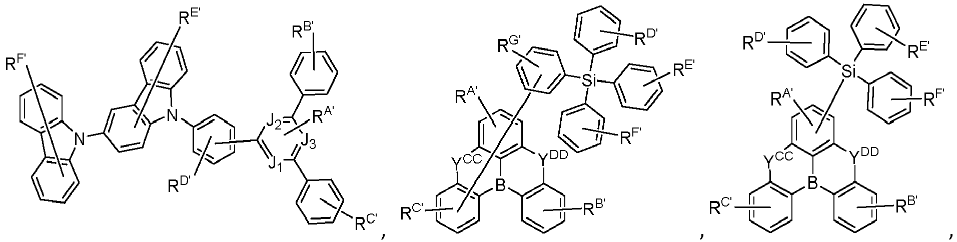 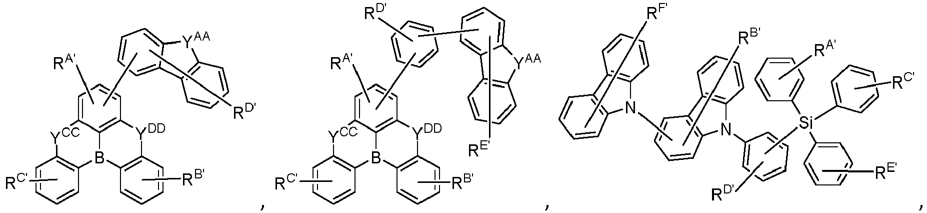 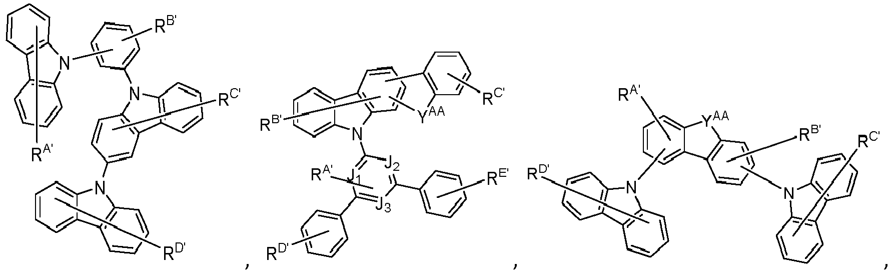 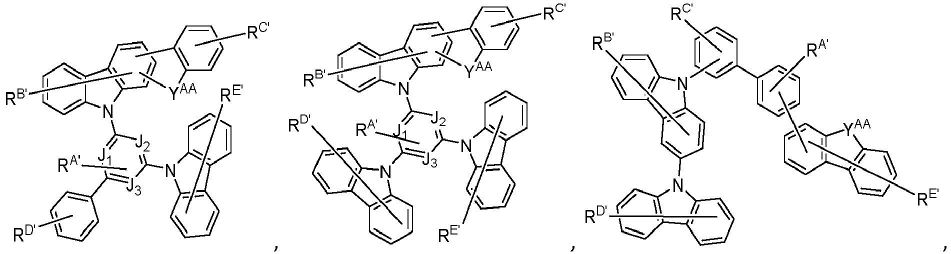 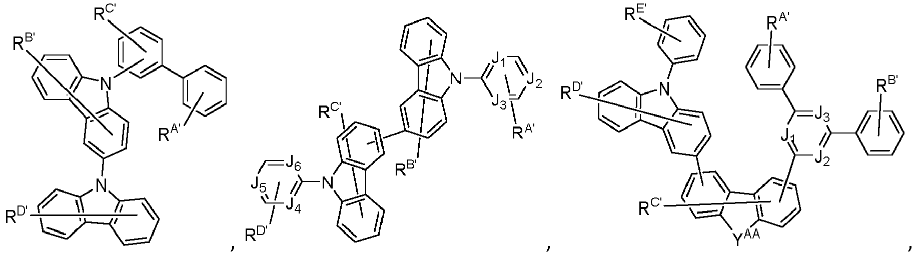 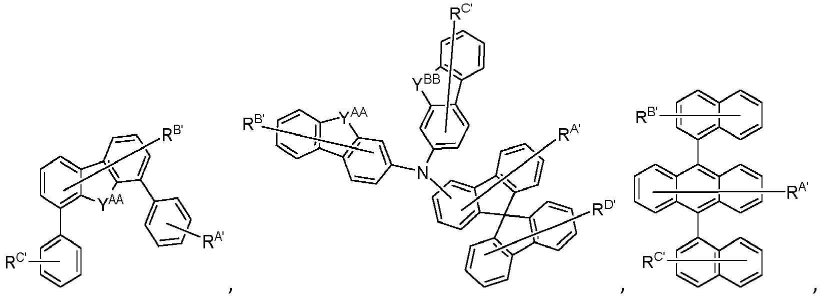 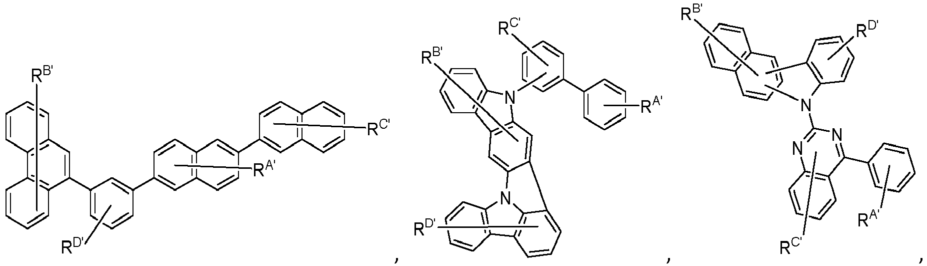 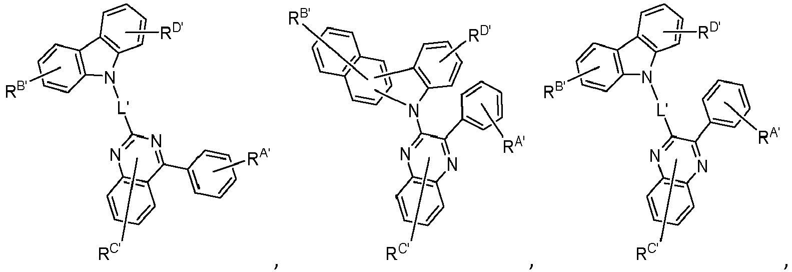 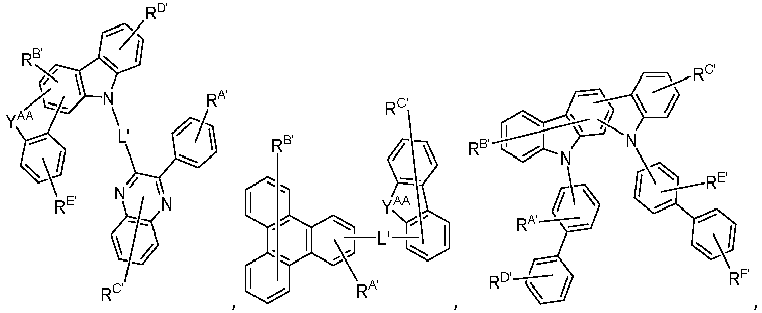 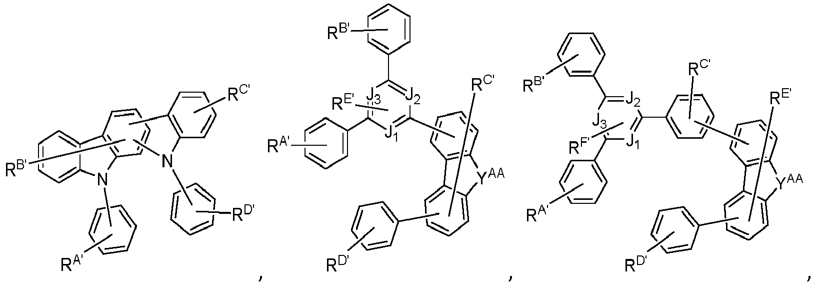 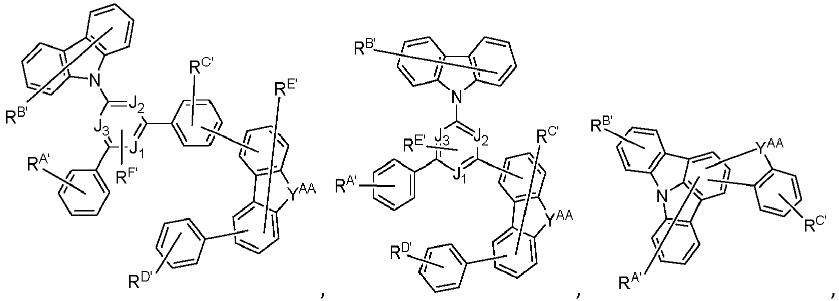 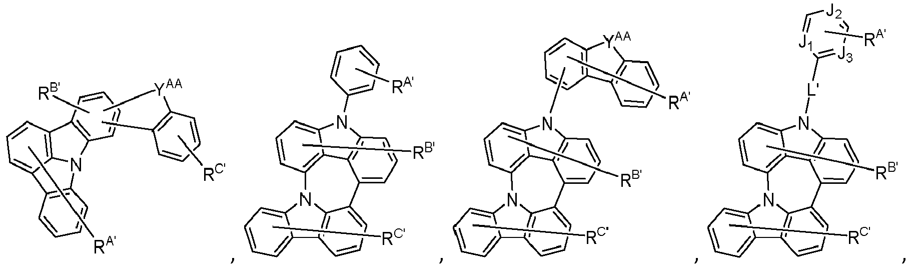 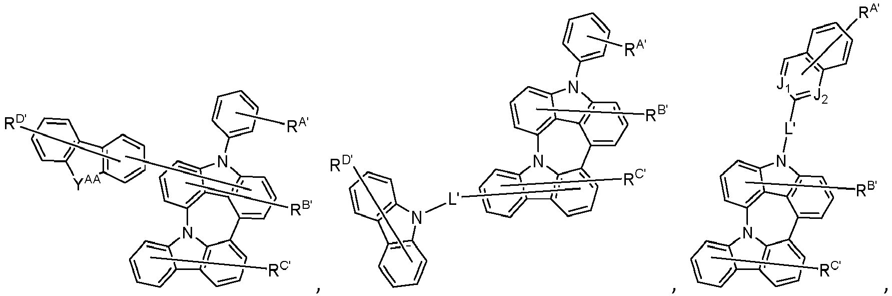 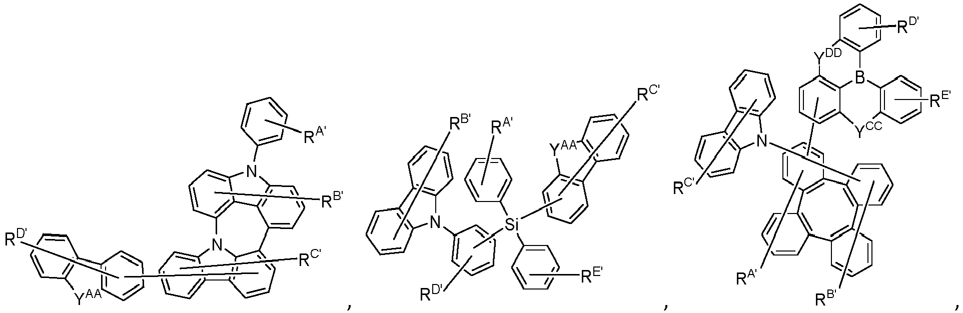 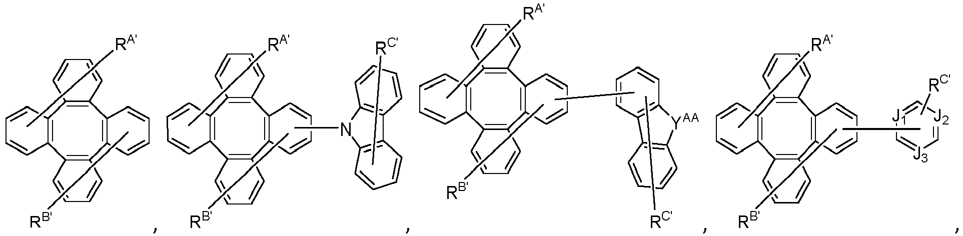 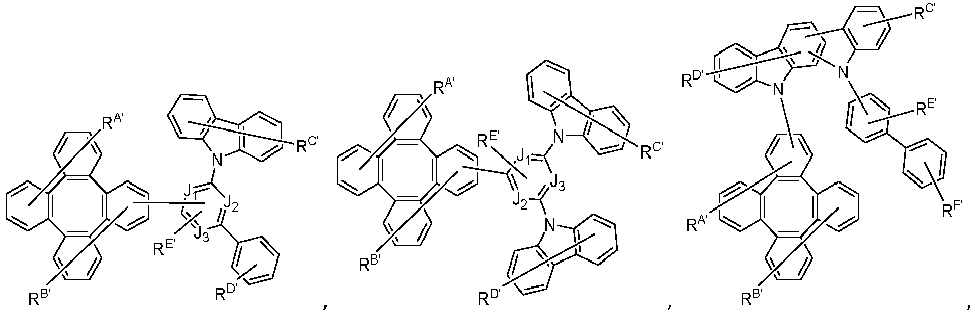 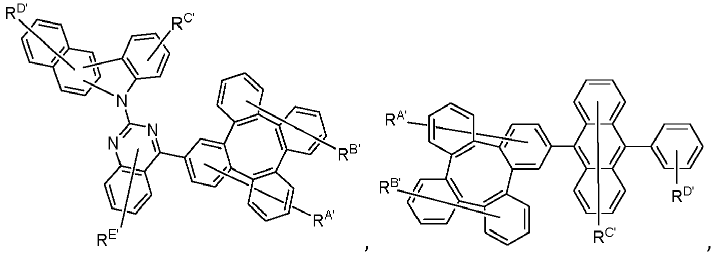 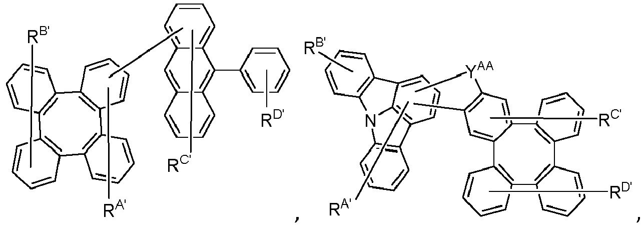 and 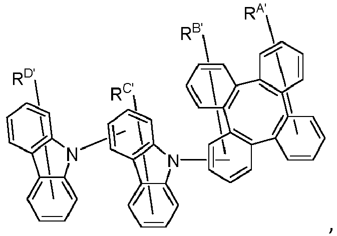 wherein:
each of J¹ to J⁶ is independently C or N;
L' is a direct bond or an organic linker;
each Y^{AA}, Y^{BB}, Y^{CC}, and Y^{DD} is independently selected from the group consisting of absent a bond, direct bond, O, S, Se, CRR', SiRR', GeRR', NR, BR, BRR';
each of R^{A'}, R^{B'}, R^{C'}, R^{D'}, R^{E'}, R^{F'}, and R^{G'} independently represents mono, up to the maximum substitutions, or no substitutions;
each R, R', R^{A'}, R^{B'}, R^{C'}, R^{D'}, R^{E'}, R^{F'}, and R^{G'} is independently a hydrogen or a substituent selected from the group consisting of the general substituents as defined herein; any two substituents can be joined or fused to form a ring;
and where possible, each unsubstituted aromatic carbon atom is optionally replaced with N to form an aza-substituted ring.

14. The OLED of any one of the previous claims, wherein the third compound, and/or the second host is selected from the group consisting of:

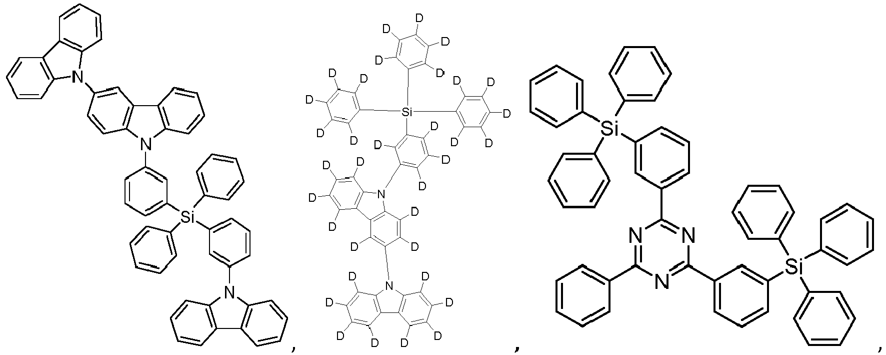

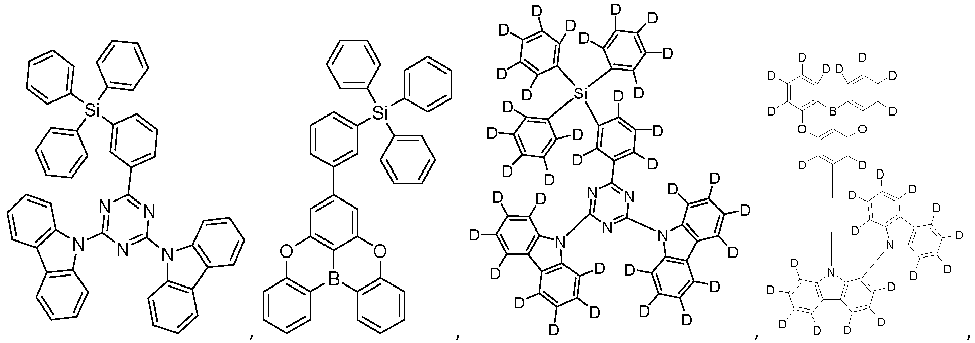

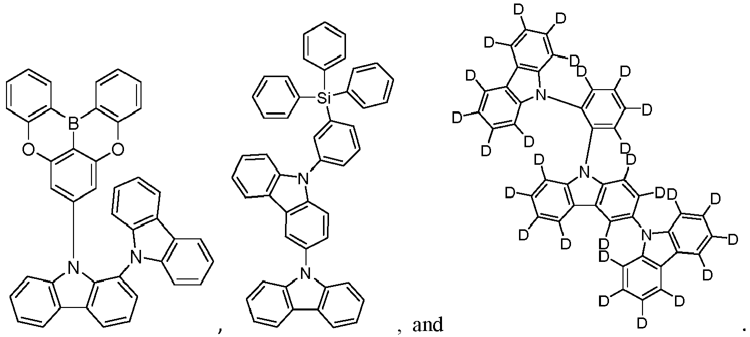

15. The OLED of any one of the previous claims, wherein the OLED emits a luminescent radiation at room temperature when a voltage is applied across the device; wherein the luminescent radiation comprises a first radiation component contributed from the second compound with an emission λₘₐₓ of 340 to 900 nm; and/or wherein the OLED emits a luminescent radiation at room temperature when a voltage is applied across the device; wherein the luminescent radiation comprises a first radiation component contributed from the second compound with a FWHM of 50 nm or less; and/or wherein the OLED emits a luminescent radiation at room temperature when a voltage is applied across the device; wherein the luminescent radiation comprises a first radiation component contributed from the second compound with a 10% onset of the emission peak is less than 465 nm.
